# EUROPEAN PATENT SPECIFICATION

(11) **EP 4 060 758 B1**
(45) Date of publication and mention of the grant of the patent: **14.10.2026**
(21) Application number: 22158225.7
(22) Date of filing: 23.02.2022
(51) Int. Cl.: H10K 85/30, H10K 50/11, H10K 101/20, H10K 101/10, H10K 85/60

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ET DISPOSITIFS ÉLECTROLUMINESCENTS ORGANIQUES

(30) Priority: 26.02.2021 US 202163154320 P; 09.07.2021 US 202163220429 P; 05.08.2021 US 202163229748 P; 16.02.2022 US 202217672934
(43) Date of publication of application: 21.09.2022
(73) Proprietor: Universal Display Corporation, Ewing, NJ 08618 (US)
(72) Inventor: FLEETHAM, Tyler, Ewing, NJ, 08618 (US); THOMPSON, Nicholas J., Ewing, NJ, 08618 (US); BROOKS, Jason, Ewing, NJ, 08618 (US); MILAS, Ivan, Ewing, NJ, 08618 (US); FELDMAN, Jerald, Ewing, NJ, 08618 (US); TALLURI, Siva Kumar, Ewing, NJ, 08618 (US); PAUDYAL, Mahesh, Ewing, NJ, 08618 (US); WILLIAMS, Douglas, Ewing, NJ, 08618 (US); MARGULIES, Eric A., Ewing, NJ, 08618 (US); LIN, Chun, Ewing, NJ, 08618 (US); MA, Bin, Ewing, NJ, NJ 08618 (US)
(74) Representative: Maiwald GmbH

(56) References cited:
- EP-A1- 2 031 037
- EP-A1- 3 508 491
- WO-A1-2020/080417
- JP-A- 2013 145 811
- US-A1- 2016 268 514
- US-A1- 2018 134 954
- US-A1- 2020 199 164
- US-B2- 6 670 645

## Description

### FIELD

The present disclosure generally relates to organometallic compounds and formulations and their various uses including as emitters in devices such as organic light emitting diodes and related electronic devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as flat panel displays, illumination, and backlighting.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

EP 2 031037 A1 relates to an organic electroluminescent device including a pair of electrodes; and an organic layer between the pair of electrodes, which includes a light-emitting layer and contains an indole-containing compound. JP 2013 145811 relates to an organic electroluminescent element having at least one light-emitting layer between an anode and a cathode that is characterized in that: it contains a hexadentate coordination type ortho-metal iridium complex represented by a specific formula; and at least one hydrogen atom in the complex molecule is substituted by deuterium. WO 2020/080417 A1 relates to an organic electroluminescent element which is provided with a positive electrode, a negative electrode and a light emitting region that is arranged between the positive electrode and the negative electrode. This organic electroluminescent element is configured such that: the light emitting region comprises a first light emitting layer and a second light emitting layer; the first light emitting layer and the second light emitting layer are directly adjacent to each other; the first light emitting layer is positioned between the positive electrode and the second light emitting layer; and one of the first light emitting layer and the second light emitting layer contains a compound that has at least one deuterium atom. US 2018/134954 A1 relates to iridium complexes having three different bidentate ligands useful for phosphorescent emitters in OLEDs. At least one of the three different bidentate ligands is a carbene ligand. US 2015/048340 A1 relates to homoleptic iridium compounds having specific carbazole-substituted phenyl-pyridine ligands. US 2010/084967 A1 relates to an organic electroluminescent device that includes: a pair of electrodes; and at least one organic layer between the pair of electrodes, the at least one organic layer including a light-emitting layer. The at least one organic layer contains a compound represented by a specific formula, and the light-emitting layer contains a phosphorescent material of a platinum complex having a tetradentate ligand. WO 2010/075421 A2 relates to an organic light-emitting diode having an anode, a cathode, and an organic active layer therebetween. The organic active layer includes a deuterated compound and the device has a calculated half-life at 1000nits of at least 5000 hours. US 2020/199164 A1 relates to certain organometallic compounds containing certain tetradentate ligands. US 2016/268514 A1 relates to certain electroactive materials having certain specified formulas. US 6 670 645 B2 relates to electroluminescent complexes of iridium (III) with fluorinated phynelpyridines, phenylpyrimidines, and phenylquinolines.

### SUMMARY

In one aspect, the present disclosure provides an organic electroluminescent device (OLED) comprising: an anode; a cathode; and an emissive layer, disposed between the anode and the cathode; wherein the emissive layer comprises a first phosphorescent emitter and a first host; wherein the first phosphorescent emitter is a metal complex; and wherein the first host is partially or fully deuterated, characterized in that the metal complex is a Pt complex and at least two of the following conditions are true: (1) the metal complex comprises a metal-carbene bond; (2) the metal complex comprises a pendant group comprising at least three-6-membered aromatic rings, each of which is not directly fused to another of the at least three 6-membered aromatic rings; and (3) the emissive layer further comprises a second host, wherein the second host is partially of full deuterated

In a second aspect, an OLED is disclosed that comprises, an anode; a cathode; and an emissive layer, disposed between the anode and the cathode; wherein the emissive layer comprises a first phosphorescent emitter, a first host and a second host; wherein the first host is partially or fully deuterated; wherein the second host is partially or fully deuterated; and characterized in that the first phosphorescent emitter is a metal complex that comprises at least one feature selected from the group consisting of: a fused-ring structure having at least four rings fused in a linear fashion; a carbazole moiety which is directly bonded to the metal; or a ring structure comprising 7 or more atoms.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:
As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical (C(O)-Rₛ).

The term "ester" refers to a substituted oxycarbonyl (-O-C(O)-Rₛ or -C(O)-O-Rₛ) radical.

The term "ether" refers to an -ORₛ radical.

The terms "sulfanyl" or "thio-ether" are used interchangeably and refer to a -SRₛ radical.

The term "selenyl" refers to a -SeRₛ radical.

The term "sulfinyl" refers to a -S(O)-Rₛ radical.

The term "sulfonyl" refers to a -SO₂-Rₛ radical.

The term "phosphino" refers to a -P(Rₛ)₃ radical, wherein each Rₛ can be same or different.

The term "silyl" refers to a -Si(Rₛ)₃ radical, wherein each Rₛ can be same or different.

The term "germyl" refers to a -Ge(Rₛ)₃ radical, wherein each Rₛ can be same or different.

The term "boryl" refers to a -B(Rₛ)₂ radical or its Lewis adduct -B(Rₛ)₃ radical, wherein Rₛ can be same or different.

In each of the above, Rₛ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. Preferred Rₛ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group may be optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more general substituents.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, selenyl, and combinations thereof.

In some instances, the preferred general substituents are selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, boryl, and combinations thereof.

In some instances, the more preferred general substituents are selected from the group consisting of deuterium, fluorine, alkyl, cycloalkyl, alkoxy, aryloxy, amino, silyl, aryl, heteroaryl, sulfanyl, and combinations thereof.

In yet other instances, the most preferred general substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f*,*h*]quinoxaline and dibenzo[*f*,*h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057 describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65 describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

### B. The OLEDs and the Devices of the Present Disclosure

Blue OLEDs exhibit low device operational lifetimes due in part to intramolecular or intermolecular chemical reactions that occur amongst excited species in the device. This process is particularly pronounced in reactions between metal carbene complexes and other ligands.

The devices disclosed herein are designed to specifically address the possibility to greatly enhance device lifetimes by pairing metal complexes with deuterated hosts to slow the decomposition mechanism that plague carbene complexes. Additionally, in some embodiments the OLEDs are designed to form an exciplex with one of the components being deuterated to slow down the decomposition process that occurs over this bimolecular species. Additionally, Pt complexes with deuterated host components, such as those disclosed, may be important as the three-dimensional structure of Pt complexes may make them more susceptible to reactions with hosts. Similarly, Ir complexes which have pendant groups that protrude further out from the molecule maybe be reactive sites and may achieve enhancements in stability from using one or more hosts that are partially or fully deuterated.

In some embodiments the metal complexes can be metal carbene complexes.

In one aspect, the present disclosure provides an OLED that includes an anode, a cathode, and an emissive layer, disposed between the anode and the cathode. In such embodiments, the emissive layer comprises a metal carbene complex and a first host, where the first host is partially or fully deuterated. As used herein, "partially deuterated" has its ordinary meaning and for a given compound includes at least one hydrogen being replaced by deuterium, or at least two hydrogens being replaced by deuterium, or at least three hydrogens being replaced by deuterium, as well as, at least 5% of the hydrogens of the compound being replaced by deuterium, or at least 10%, or at least 15%, or at least 25%, or at least 35%, or at least 50%, or at least 60%, or at lest 70%, or at lest 75%, or at least 80%, or at least 90% of the hydrogens in the compound being replaced by deuterium. However, partially deuterated does not include fully deuterated.

In a first aspect, the present disclosure provides an OLED comprising: an anode; a cathode; and an emissive layer, disposed between the anode and the cathode; wherein the emissive layer comprises a first phosphorescent emitter and a first host; wherein the first phosphorescent emitter is a metal complex; wherein the first host is partially or fully deuterated, characterized in that the metal complex is a Pt complex and at least two of the following conditions are true:
(1) the metal complex comprises a metal-carbene bond;
(2) the metal complex comprises a pendant group comprising at least three 6-membered aromatic rings, each of which is not directly fused to another of the at least three 6-membered aromatic rings;
(3) the emissive layer further comprises a second host, wherein the second host is partially or fully deuterated.

In a second aspect, the present disclosure provides an OLED comprising: an anode; a cathode; and an emissive layer, disposed between the anode and the cathode; wherein the emissive layer comprises a first phosphorescent emitter, a first host and a second host; wherein the first phosphorescent emitter is a metal complex; wherein the first host is partially or fully deuterated; wherein the second host is partially or fully deuterated; characterized in that the first phosphorescent emitter is a metal complex that comprises at least one feature selected from the group consisting of: a fused-ring structure having at least four rings fused in a linear fashion; a carbazole moiety which is directly bonded to the metal; or a ring structure comprising 7 or more atoms.

As used herein, "pendant group" refers to a moiety or substituent directly bonded to a moiety that is bonded to a metal, where the pendant group itself is not bonded to the metal. For instance, a methyl group bonded to the phenyl group of a phenylpyridine ligand is a pendant group.

As used herein, examples of "a pendant group comprising at least three 6-membered aromatic rings, each of which is not directly fused to another of the at least three 6-membered aromatic rings" include the following:

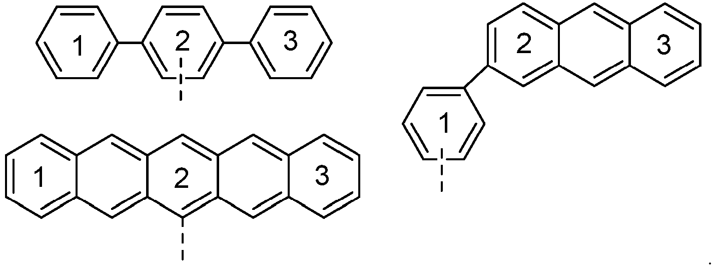

In an individual emitter compound, light emission occurs perpendicular to the triplet to ground state transition dipole moment (TDM). As such, increasing the number of emitter compound molecules whose TDM vector is horizontally aligned with respect to the OLED's substrate results in a higher light extraction efficiency, and thus higher device efficiency (external quantum efficiency - EQE). This orientation factor can be described statistically in an ensemble of emitter molecules by the ratio θ of the vertical component of the TDM vector to the sum of the vertical and horizontal components: θ = TDM^{⊥}/(TDM^{⊥} + TDM || ), hereinafter the vertical dipole ratio ("VDR").

The vertical dipole ratio (θ) may be measured by angle dependent photoluminescence measurements. By comparing the measured emission pattern of a photoexcited thin film sample, as a function of polarization, to the computationally modeled pattern, one can determine the TDM vector's orientation for a given sample.

In some embodiments of both aspects, the metal complex comprises at least one polydentate ligand that forms a 5-membered chelate ring with the Pt.

In some embodiments of both aspects, the at least one polydentate ligand is a tetradentate ligand.

In some embodiments of both aspects, the 5-membered chelate ring includes carbene bond. In some such embodiments, the carbene is derived from imidazole or benzimidazole. In some such embodiments, the carbene is substituted by a substituent R, which can be selected from the group consisting of the General Substituents defined herein. In some such embodiments, the substituent R is partially or fully deuterated.

In some embodiments of both aspects, the 5-membered chelate ring does not include a carbene bond.

In some embodiments of the second aspect, the metal complex is a Pt complex.

In some embodiments of the second aspect, the metal complex is an Ir complex.

In some embodiments, the metal complex comprises an imidazole, which can be further substituted and fused. In some embodiments, the imidazole is a benzimidazole, which can be further substituted and fused.

In some embodiments of both aspects, the metal complex comprises a fused or unfused heteroaryl moiety comprising at least two N atoms.

In some embodiments of both aspects, the metal complex comprises a fused or unfused heteroaryl moiety comprising at least one N and at least one O or S.

In some embodiments of both aspects, the metal complex comprises a fused or unfused heteroaryl moiety comprising at least two heteroatoms on one ring.

In some embodiments of both aspects, the metal complex comprises a fused or unfused heteroaryl moiety comprising at least one heteroatom on two different rings.

In some embodiments of both aspects, the metal complex comprises a fused or unfused heteroaryl moiety comprising at least three heteroatoms.

In some embodiments of both aspects, the fused or unfused heteroaryl moiety comprises one or more 5- or 6-membered rings.

In some embodiments of both aspects, the metal complex comprises a fused-ring structure comprising at least three rings, including at least one 6-membered heteroaryl ring. In some embodiments the fused-ring structure is selected from the group consisting of aza-dibenzofuran, aza-dibenzothiophene, aza-dibenzoselephene, aza-dibenzofluorene, and aza-carbazole.

In some embodiments of both aspects, the metal complex comprises a fused-ring structure comprising at least four rings. In some embodiments, such four rings are fused together in a linear fashion. In some embodiments, such four rings are fused together in a nonlinear fashion.

In some embodiments of both aspects, the metal complex comprises a fused-ring structure comprising at least five rings.

In some embodiments of both aspects, the metal complex comprises a fused-ring structure comprising at least six rings.

In some embodiments of both aspects that include a fused-ring structure, the fused-ring structure comprises a moiety selected from the group consisting of dibenzofuran, dibenzothiophene, dibenzoselenophene, carbazole, and aza-variants thereof.

In some embodiments of both aspects that include a fused-ring structure, the fused-ring structure comprises a carbene moiety.

In some embodiments of both aspects that include a fused-ring structure, each of the rings in the fused ring structure is independently a 5-membered heteroaryl ring or a 6-membered aryl or heteroaryl ring.

In some such embodiment of both aspects s, the metal complex includes a pendant group comprising at least three 6-membered aromatic rings, each of which is not directly fused to another of the at least three 6-membered aromatic rings. In some such embodiments, the metal complex includes a pendant group comprising at least four 6-membered aromatic rings, each of which is not directly fused to another of the at least four 6-membered aromatic rings. In some such embodiments, the metal complex includes a pendant group comprising at least five 6-membered aromatic rings, each of which is not directly fused to another of the at least five 6-membered aromatic rings. In some such embodiments, the metal complex includes a pendant group comprising at least six 6-membered aromatic rings, each of which is not directly fused to another of the at least six 6-membered aromatic rings.

In some embodiments of both aspects, the metal complex comprises a partially or fully deuterated 5- or 6-member carbocyclic or heterocyclic ring directly bonded to the metal. In some embodiments, the metal complex comprises a partially deuterated 5- or 6-member carbocyclic or heterocyclic ring directly bonded to the metal. In some embodiments, the metal complex comprises a fully deuterated 5- or 6-member carbocyclic or heterocyclic ring directly bonded to the metal. In some embodiments, the metal complex comprises a partially or fully deuterated 5-member heteroaryl ring directly bonded to the metal.. In some embodiments, the metal complex comprises a partially or fully deuterated 6-member aryl or heteroaryl ring directly bonded to the metal.

In some embodiments of both aspects, the metal complex comprises a total of at least seven 6-membered aromatic rings. In some embodiments, the metal complex comprises a total of at least eight 6-membered aromatic rings. In some embodiments, the metal complex comprises a total of at least nine 6-membered aromatic rings. In some embodiments, the metal complex comprises a total of at least ten 6-membered aromatic rings. In some embodiments, the metal complex comprises a total of at least eleven 6-membered aromatic rings. In some embodiments, the metal complex comprises a total of at least twelve 6-membered aromatic rings.

In some embodiments of both aspects, the metal of the metal complex is bonded to a carbazole at the 1-position.

In some embodiments of both aspects, the metal complex comprises at least one boron atom. In some embodiments, the boron atom is a three-valence boron atom. In some embodiments, the boron atom is a four-valence boron atom. In some embodiments, the boron atom is in the backbone of one ring. In some embodiments, the boron atom is in the backbone of two rings. In some embodiments, the boron atom is in the backbone of three rings.

In some embodiments of both aspects, the metal complex comprises at least one fluorine atom directly bonded to a ring carbon of an aromatic or non-aromatic ring.

In some embodiments of both aspects, the metal complex comprises at least one fluorine atom directly bonded to a carbon that is not part of a ring.

In some embodiments of both aspects, the metal complex comprises a moiety comprising at least two benzene rings fused together that is directly bonded to the metal. In some embodiments, the metal complex comprises a moiety comprising at least three benzene rings fused together that is directly bonded to the metal. In some embodiments, the metal complex comprises a moiety comprising at least four benzene rings fused together that is directly bonded to the metal.

In some embodiments of both aspects, the metal complex comprises a naphthalene moiety, that is substituted at the 4-position and coordinated to the metal at the 1-position.

In some embodiments of both aspects, the metal complex comprises an acetylacetonate ligand where at least one methyl of the acetylacetonate ligand is substituted by one substituent R selected from the group consisting of the General Substituents defined herein.

In some embodiments of both aspects, the metal complex comprises an acetylacetonate ligand where at least one methyl of the acetylacetonate ligand is substituted by two substituents R, wherein each R is independently selected from the group consisting of the General Substituents defined herein.

In some embodiments of both aspects, the metal complex comprises an acetylacetonate ligand where each of the methyl moieties of the acetylacetonate ligand is substituted by one substituent R, wherein each R is independently selected from the group consisting of the General Substituents defined herein.

In some embodiments of both aspects, the metal complex comprises an acetylacetonate ligand where each of the methyl moieties of the acetylacetonate ligand is substituted by two substituents R, wherein each R is independently selected from the group consisting of the General Substituents defined herein.

In some embodiments of both aspects, the metal complex comprises a silicon atom, in some embodiments of option (2), the metal complex comprises a tetra aryl silane.

In some embodiments of both aspects, the metal complex comprises a ring structure comprising 7 or more atoms, in some embodiments, the metal complex comprises s ring structure comprising 8 or more atoms, in some embodiments, the metal complex comprises s ring structure comprising 9 or more atoms.

In some embodiments of both aspects, the Pt and the tetradentate ligand form at least one 5-membered chelate ring and at least one 6-membered chelate ring.

In some embodiments of both aspects, the Pt and the tetradentate ligand form a 5-membered chelate ring and two 6-membered chelate rings.

In some embodiments of both aspects, the Pt and the tetradentate ligand form two 5-membered chelate rings and one 6-membered chelate ring.

In some embodiments of both aspects, the tetradentate ligand is a macrocyclic ligand and forms two adjacent 5-membered chelate rings and two adjacent 6-membered chelate rings.

In some embodiments of both aspects, the tetradentate ligand is a macrocyclic ligand and forms three adjacent 5-membered chelate rings and one 6-membered chelate ring.

In some embodiments of both aspects, the tetradentate ligand is a macrocyclic ligand and forms one 5-membered chelate rings and three adjacent 6-membered chelate rings.

In some embodiment of both aspects s, the tetradentate ligand comprises at least one coordinating oxygen atom trans to a coordinating carbon atom.

In some embodiments of both aspects, the other two coordinating atoms are N.

In some embodiments of both aspects, the coordinating carbon atom trans to the oxygen or sulfur atom is part of a phenyl ring.

In some embodiments of both aspects, the metal complex is at least 10% deuterated.

In some embodiments of both aspects, the metal complex is at least 30% deuterated, or at least 50% deuterated, or at least 70% deuterated, or at least 85% deuterated, or at least 90% deuterated, or at least 95% deuterated, or at least 99% deuterated, or at least 100% deuterated.

In some embodiments of the second aspect, the metal complex is an Os complex. In some embodiments, the metal complex is an Ag complex. In some embodiments, the metal complex is an Au complex. In some embodiments, the metal complex is an Cu complex. In some embodiments, the metal complex is an Pd complex.

In some embodiments of the second aspect, the Ir(III) complex has a VDR value of equal to or less than 0.15. In some embodiments, all three bidentate ligands are C^N ligands. As used herein, the X^Y nomenclature represents a ligand where an X atom and a Y atom are coordinated to the metal, Ir in this case. For example, a phenylpryidine ligand would be represented C^N, while an acetylacetonate ligand would be represented O^O.

In some embodiments of the second aspect, two of the bidentate ligands are C^N ligands and the remaining one is a O^O ligand.

In some embodiments of the second aspect, the bidentate ligands includes one C^N, one C^C, and one O^O.

In some embodiments of the second aspect, all three of the bidentate ligands are C^C ligands.

In some embodiments of the second aspect, two of the bidentate ligands are C^C ligands and the remaining one is a C^N ligand.

In some embodiments of the second aspect, two of the bidentate ligands are C^N ligands and the remaining one is a C^C ligand.

In some embodiments of both aspects, the metal complex has a λₘₐₓ in the range of 400-500 nm and a VDR value of equal or less than 0.12. In some embodiments, the metal complex has a λₘₐₓ in the range of 400-500 nm and a VDR value of equal or less than 0.10. In some embodiments, the metal complex has a λₘₐₓ in the range of 400-500 nm and a VDR value of equal or less than 0.08. In some embodiments, the metal complex has a λₘₐₓ in the range of 400-500 nm and a VDR value of equal or less than 0.05.

In some embodiments of both aspects, the metal complex has a λₘₐₓ in the range of 500-590 nm and a VDR value of equal or less than 0.12. In some embodiments, the metal complex has a λₘₐₓ in the range of 500-590 nm and a VDR value of equal or less than 0.10. In some embodiments, the metal complex has a λₘₐₓ in the range of 500-590 nm and a VDR value of equal or less than 0.08. In some embodiments, the metal complex has a λₘₐₓ in the range of 500-590 nm and a VDR value of equal or less than 0.05.

In some embodiments of both aspects, the metal complex has a λₘₐₓ in the range of 590-700 nm and a VDR value of equal or less than 0.08. In some embodiments, the metal complex has a λₘₐₓ in the range of 590-700 nm and a VDR value of equal or less than 0.05.

In some embodiments of both aspects, the difference between S1ₑₘ-T1ₑₘ is equal or less than 0.25 eV. In some embodiments, the difference between S1ₑₘ-T1ₑₘ is equal or less than 0.20 eV, or equal or less than 0.18 eV, or equal or less than 0.16 eV, or equal or less than 0.14 eV, or equal or less than 0.12 eV, or equal or less than 0.10 eV, or equal or less than 0.08 eV, or equal or less than 0.06 eV, or equal or less than 0.05 eV.

In some embodiments of both aspects, the first host comprises two partially or fully deuterated moieties selected from the group consisting of triphenylene, carbazole, indolocarbazole, dibenzothiophene, dibenzofuran, dibenzoselenophene, 502-benzo[d]benzo[4,5]imidazo[3,2-a]imidazole, and 5,9-dioxa-13b-boranaphtho[3,2,1-de]anthracene.

In some embodiments of both aspects, the first host comprises two partially or fully deuterated moieties selected from the group consisting of aza-triphenylene, aza-carbazole, aza-indolocarbazole, aza-dibenzothiophene, aza-dibenzofuran, aza-dibenzoselenophene, aza-5 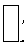 2-benzo[d]benzo[4,5]imidazo[3,2-a]imidazole, and aza-(5,9-dioxa-13b-boranaphtho[3,2,1-de]anthracene).

In some embodiments of both aspects, the first host comprises at least one partially or fully deuterated moiety selected from the group consisting of triphenylene, carbazole, indolocarbazole, dibenzothiophene, dibenzofuran, dibenzoselenophene, 502-benzo[d]benzo[4,5]imidazo[3,2-a]imidazole, and 5,9-dioxa-13b-boranaphtho[3,2,1-de]anthracene; and
at least one partially or fully deuterated moiety selected from the group consisting of aza-triphenylene, aza-carbazole, aza-indolocarbazole, aza-dibenzothiophene, aza-dibenzofuran, aza-dibenzoselenophene, aza-5 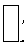 2-benzo[d]benzo[4,5]imidazo[3,2-a]imidazole, and aza-(5,9-dioxa-13b-boranaphtho[3,2,1-de]anthracene).

In some embodiments, the first host does not comprise an indole or carbazole moiety.

In some embodiments of both aspects, the boryl moiety is a three-valence boron atom.

In some embodiments of both aspects, the boryl moiety is a four-valence boron atom.

In some embodiments of both aspects, the boron atom is in the backbone of one ring.

In some embodiments of both aspects, the boron atom is in the backbone of two rings.

In some embodiments of both aspects, the boron atom is in the backbone of three rings.

In some embodiments of both aspects, the difference between S1ₕₒₛₜ -T1ₕₒₛₜ is equal or greater than 0.30 eV, and equal or less than 1.25 eV.

In some embodiments of both aspects, the difference between S1ₕₒₛₜ -T1ₕₒₛₜ is equal or greater than 0.35 eV, or equal or greater than 0.40 eV, or equal or greater than 0.45 eV, or equal or greater than 0.50 eV.

In some embodiments of both aspects, the difference between S1ₕₒₛₜ -T1ₕₒₛₜ is equal or less than 1.15 eV, or equal or less than 1.10 eV, or equal or less than 1.00 eV, or equal or less than 0.90 eV, or equal or less than 0.80 eV, or equal or less than 0.70 eV.

In some embodiments of both aspects, the difference between S1ₕₒₛₜ -T1ₕₒₛₜ is equal or less than 0.25 eV, or equal or less than 0.20 eV, or equal or less than 0.15 eV, or equal or less than 0.10 eV.

In some embodiments of the second aspect, the metal complex is a Pt complex.

In some embodiments of both aspects, the first host comprises a heteroaryl group comprising at least two nitrogen atoms selected from the group consisting of pyrimidine, pyrazine, pyridazine, triazine, cinnoline, quinazoline, quinoxaline, phthalazine, pyridopyrazine, pyridopyridazine, naphthyridine, and naphthyridine.

In some embodiments of both aspects, the metal complex emits light upon photoexcitation at room temperature; wherein the emitted light has an emission spectrum characterized by a peak emission wavelength λₘₐₓ when measured at a mass concentration of 1% in a PMMA film; and wherein the full width at half maximum of the emission at λₘₐₓ is equal to or less than 35 nm, or equal to or less than 30 nm, or equal to or less than 25 nm, or equal to or less than 20 nm, or equal to or less than 15 nm, or equal to or less than 10 nm.

In some embodiments of both aspects, the metal complex emits light upon photoexcitation at room temperature; wherein the emitted light has an emission spectrum characterized by a peak emission wavelength λₘₐₓ when measured at a mass concentration of 1% in a PMMA film; wherein the λₘₐₓ is in the range of 700-1000 nm with a PLQY value of at least 30%. In some such embodiments, the λₘₐₓ is in the range of 700-900 nm, or 700-800 nm. In some such embodiments, the PLQY value is at least 40%, or the PLQY value is at least 50%, or the PLQY value is at least 60%, or the PLQY value is at least 70%, or the PLQY value is at least 80%, or the PLQY value is at least 90%, or the PLQY value is at least 99.9%.

In some embodiments of both aspects, the emissive layer contains two or more materials, which form an exciplex.

In some embodiments of both aspects, the emissive layer contains two or more host materials, which form an exciplex.

In some embodiments of both aspects, the emissive layer contains at least one host material and at least one phosphorescent emitter, which form an exciplex.

In some embodiments of both aspects, two or more materials form an exciplex with the same additional material. For example, the first host and second host form an exciplex and the first metal complex and second host form an exciplex.

In some embodiments of both aspects, two or more materials form an exciplex and an additional material is added to the emissive layer which reduces the extent of formation of the exciplex. For example, films of the first host and second host form an exciplex as seen by a red-shift photoluminescence spectrum or a photoluminescence spectrum containing a new peak at longer wavelengths or lower energy compared to the emission of thin films of each of the components individually. However, after adding a third host, the amount of emission from the exciplex is greatly reduced, indicating a reduction of the exciplex formation rate.

In some embodiments of both aspects, the blue edge of the exciplex is higher in energy than the peak wavelength of the first metal complex where the blue edge of the exciplex is the highest energy wavelength at which the PL spectrum has a value of 0.1 when the maximum of the PL spectrum is normalized to a value of one.

In some embodiments of both aspects, the blue edge of the exciplex is lower in energy than the peak wavelength of the first metal complex where the blue edge of the exciplex is the highest energy wavelength at which the PL spectrum has a value of 0.1 when the maximum of the PL spectrum is normalized to a value of one.

In some embodiments of both aspects, the exciplex formed by two or more materials is weakly emissive with a photoluminescence quantum yield (PLQY) less than 30%. Where the PLQY are measured on a calibrated Hamamatsu Quantaurus-QY Plus UV-NIR absolute PL quantum yield spectrometer with an excitation wavelength of 340nm.PLQY values are taken from thin films prepared from solutions of 1% dopant by weight with PMMA in toluene which are filtered and dropcast onto Quartz substrates.

In some embodiments of both aspects, the exciplex formed by two or more materials is strongly emissive with a PLQY over 50%, more preferably with a PLQY over 75%.

In some embodiments of both aspects, none of the materials form an exciplex.

In some embodiments of both aspects, the at least one additional layer is selected from the group consisting of a hole injection layer, a hole transport layer, an electron blocking layer, a hole blocking layer, an electron transport layer, and an electron injection layer.

In some embodiments of both aspects, the at least one additional layer is adjacent the emissive layer.

In some embodiments of both aspects, all materials in the at least one additional layer are partially or fully deuterated.

In some embodiments of both aspects, the OLED has a first device lifetime LT95 which is measured at 10 mA/cm², wherein the first device lifetime is at least 1.5 times greater than a second device lifetime obtained under the exact condition as the first device lifetime except the first host is non-deuterated. In some embodiments, the first device lifetime is at least 2.0 times greater than a second device lifetime obtained under the exact condition as the first device lifetime except the first host is non-deuterated. In some embodiments, the first device lifetime is at least 2.5 times greater than a second device lifetime obtained under the exact condition as the first device lifetime except the first host is non-deuterated. In some embodiments, the first device lifetime is at least 3.0 times greater than a second device lifetime obtained under the exact condition as the first device lifetime except the first host is non-deuterated. In some embodiments, the first device lifetime is at least 4.5 times greater than a second device lifetime obtained under the exact condition as the first device lifetime except the first host is non-deuterated.

As used herein "LT95" is defined as the time to reach 95% of the initial device luminance when driven at a constant current density of 10mA/cm². It should be understood that the device lifetime comparison made above could be applied to emissive layers with more than one host. In such materials, the 1.5 times, or 2.0 times, or 2.5 times, or 3.0 times, or 4.0 times, or 5.0 times greater improvement could be the result of deuteration of one of the host compounds or more than one of the host compounds. It should be understood that the device lifetime comparisons made above could be applied to emissive layers with more than one host. In such materials, the 1.5 times greater improvement could be the result of deuteration of one of the host compounds or more than one of the host compounds.

In some embodiments of both aspects, at least one of the anode, the cathode, or an additional layer disposed over the emissive layer functions as an enhancement layer; wherein the enhancement layer comprises a plasmonic material exhibiting surface plasmon resonance that non-radiatively couples to the first phosphorescent emitter and transfers excited state energy from the emitter material to non-radiative mode of surface plasmon polariton; wherein the enhancement layer is provided no more than a threshold distance away from the emissive layer; and wherein the first phosphorescent emitter has a total non-radiative decay rate constant and a total radiative decay rate constant due to the presence of the enhancement layer and the threshold distance is a distance where the total non-radiative decay rate constant is equal to the total radiative decay rate constant.

In some embodiments of both aspects, the concentration level of the metal complex in the emissive layer along a direction extending perpendicular to the anode toward the cathode, follows a predefined non-constant gradient profile.

The following embodiments apply to any of the foregoing embodiments that they are otherwise consistent with.

In some embodiments of the second aspect, the metal complex comprises a metal selected from the group consisting of Os, Ir, Pd, Pt, Cu, Ag, and Au. In some embodiments, the metal complex comprises a metal selected from the group consisting of Ir, Pt, and Au. In some embodiments, the metal complex is an Ir or Pt complex. In some embodiments, the metal complex is a Pt complex. In some embodiments, the Pt complex comprises a tetradentate ligand. In some embodiments, the metal complex is a Pt(II) tetradentate complex.

In some embodiments of both aspects, the metal complex and the host form an exciplex.

In some embodiments of both aspects, the first host is at least 10% deuterated. In some embodiments, the first host is at least 30% deuterated, or at least 50% deuterated, or at least 70% deuterated, or at least 85% deuterated, or at least 90% deuterated, or at least 95% deuterated, or at least 99% deuterated, or 100% deuterated.

In some embodiments of the first aspect, the OLED comprises a second host. In some embodiments, the second host is not deuterated. In some embodiments, the second host is partially or fully deuterated. In some embodiments, the second host is at least 50% deuterated, or at least 75% deuterated, or at least 90% deuterated.

In some embodiments of both aspects, the metal complex is a platinum complex and the first host comprises a moiety selected from the group consisting of triazine, pyridine, pyrimidine, pyrazine, pyridazine, dibenzofuran, dibenzothiophene, aza-dibenzofuran, aza-dibenzothiophene, triphenylene, aza-triphenylene, carbazole, indolocarbazole, aza-carbazole, aza-indolocarbazole, silyl, and boryl.

In some embodiments of both aspects, the metal complex is a platinum complex and the first host comprises a triazine moiety.

In some embodiments of both aspects, the metal complex comprises at least one cyano substituent.

In some embodiments of both aspects, the metal complex is partially fluorinated.

In some embodiments of both aspects, the metal complex comprises at least one partially deuterated alkyl groups.

In some embodiments of both aspects, the metal complex comprises a carbazole moiety.

In some embodiments of both aspects, the metal complex is a platinum complex comprising a tetradentate ligand, and the tetradentate ligand and the platinum atom form 5-6-6 chelating rings.

In some embodiments of both aspects, the emissive layer has a peak emission equal to or less than 500 nm. In some embodiments, the emissive layer comprises an emitter with a peak emission equal to or less than 500 nm.

In some embodiments of both aspects, a LUMO of the first host is less than -2.3 eV. In some embodiments, the HOMO of the first host is greater than -5.8 eV.

In some embodiments of both aspects, the emissive layer further comprises a second host, wherein the first host has a HOMO level greater than -5.8 eV and the second host has a LUMO level less than -2.3 eV.

In some embodiments of both aspects, the metal complex comprises at least one tri-aryl amine.

In some embodiments of both aspects, the metal complex comprises an O-linker *(i.e.,* an ether) that is part of a chelating ring that includes the metal. In some embodiments, the O-linker is directly bonded to the metal. In some embodiments, the O-linker is not directly bonded to the metal.

In some embodiments of both aspects, the metal complex comprises at least one moiety selected from the group consisting of a partially deuterated alkyl group, partially deuterated cycloalkyl group, a partially deuterated aryl or heteroaryl group, a fully deuterated alkyl group, and fully deuterated aryl or heteroaryl group.

In some embodiments of both aspects, the metal complex comprises at least one 5-membered chelating ring between a ligand and the metal.

In some embodiments of both aspects, the metal complex has a HOMO level less than -5.2 eV.

In some embodiments of both aspects, the first host is selected from the group consisting of the structures in the following LIST 1: 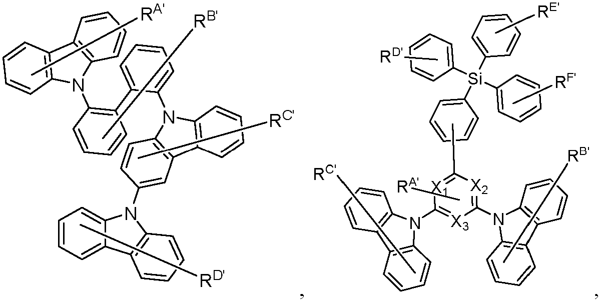 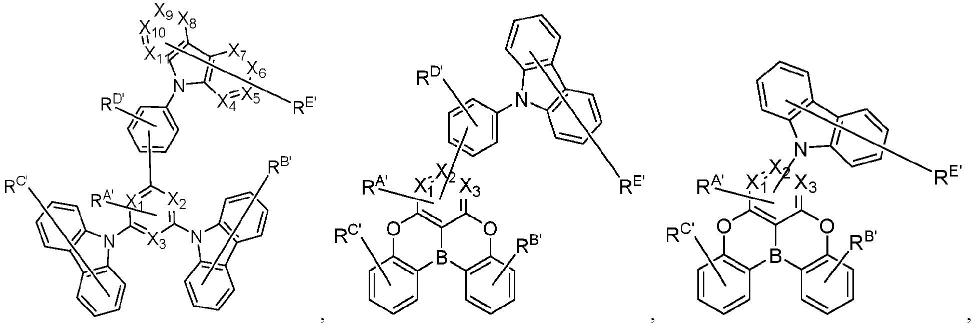 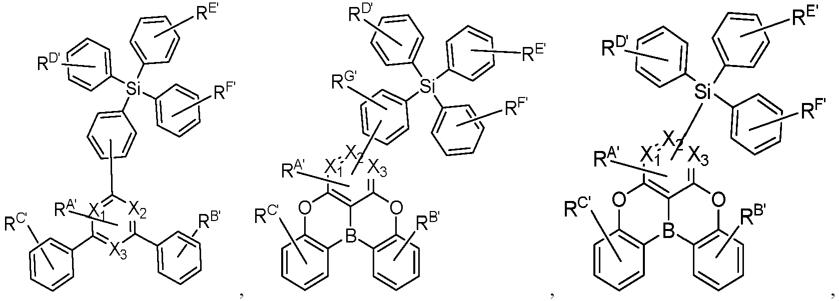 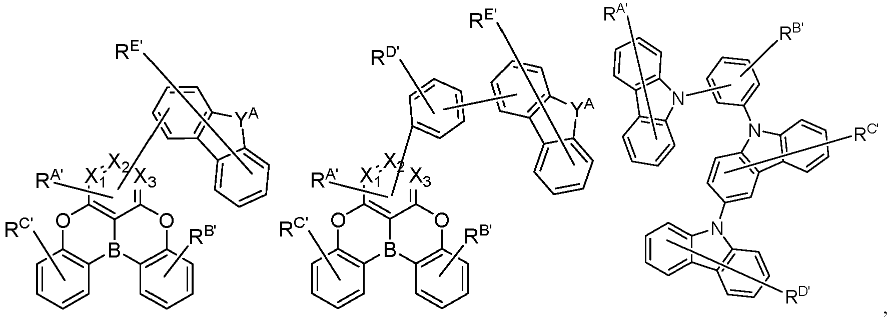 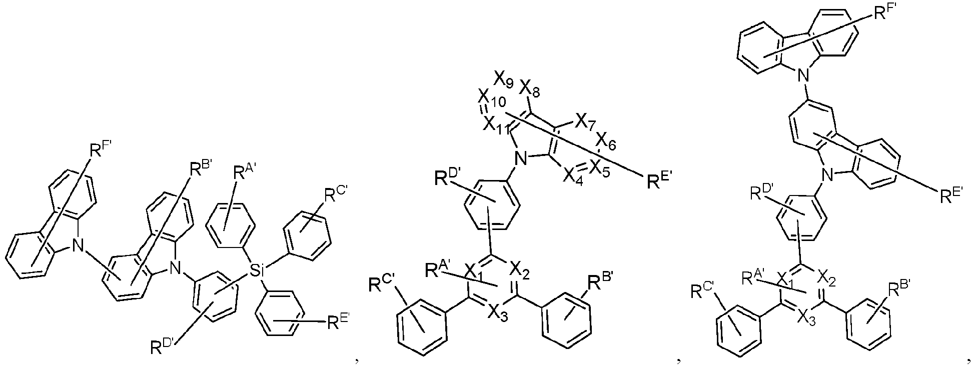 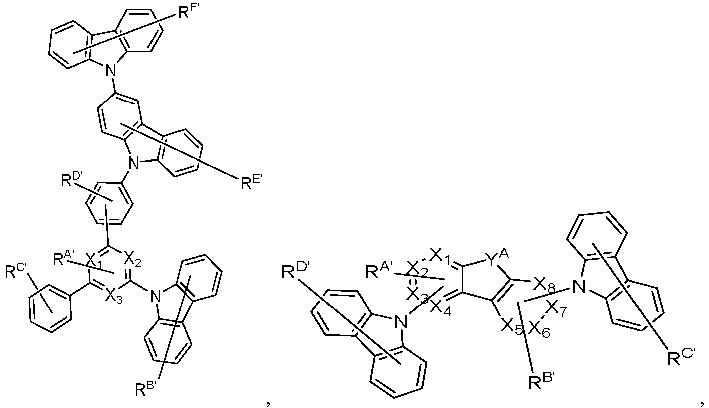 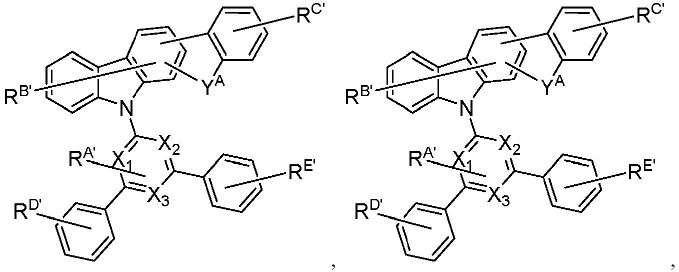 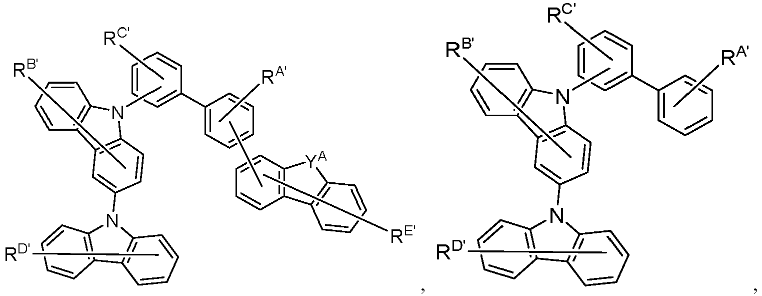 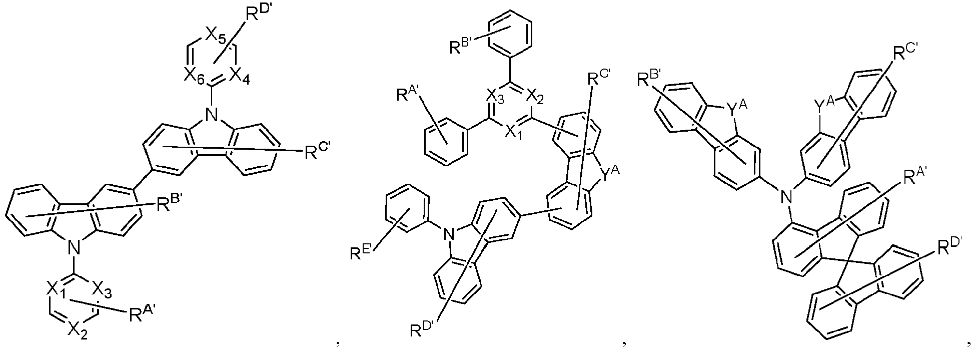 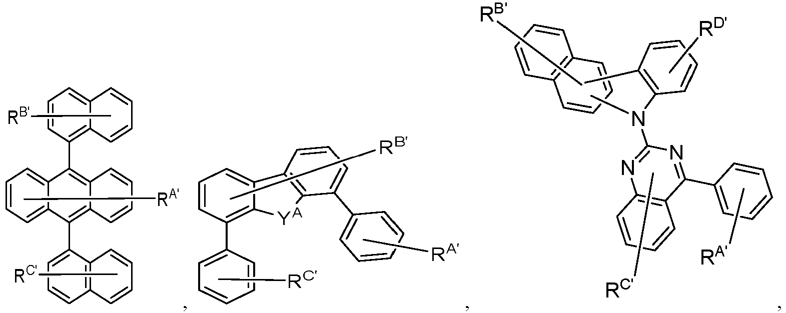 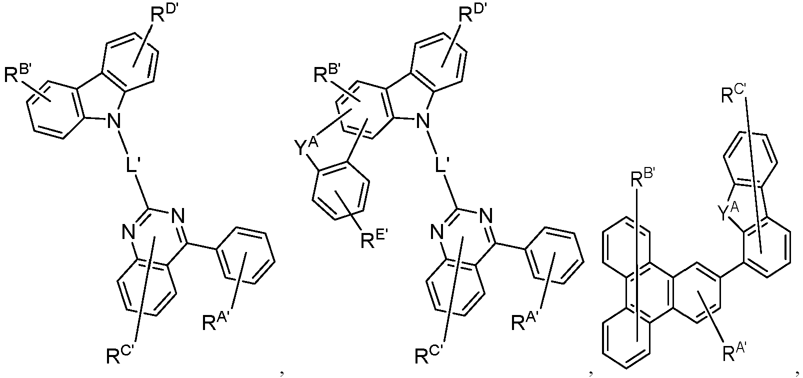 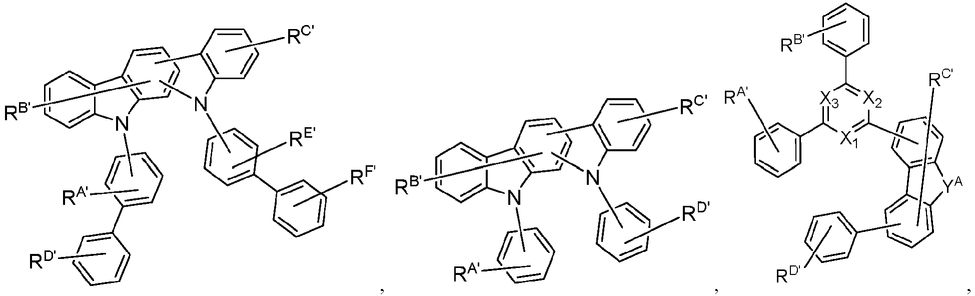 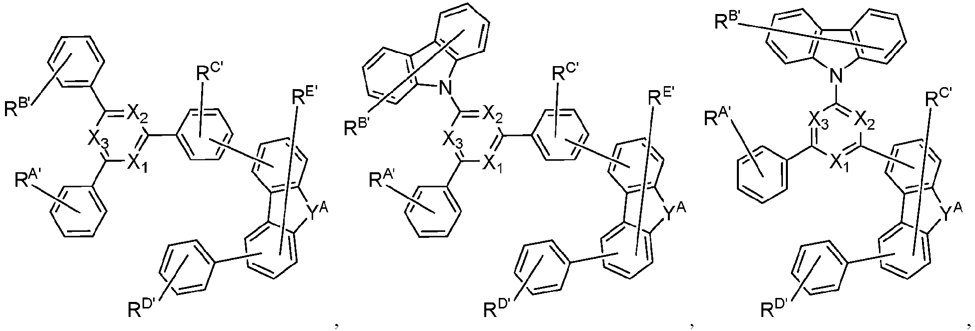 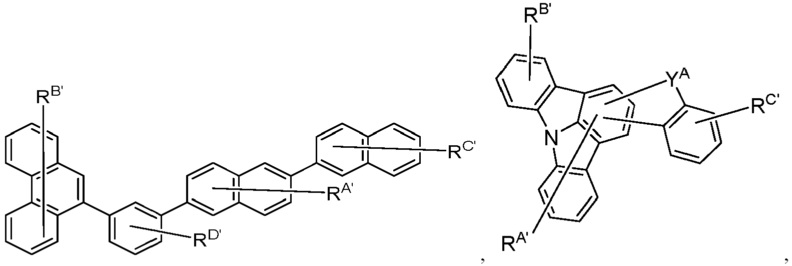 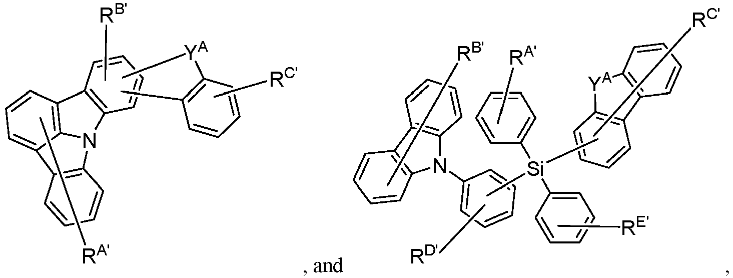 wherein:
each of X₁ to X₁₁ is independently C or N;
L' is a direct bond or is an organic linker;
each Y^{A} is independently absent or, when present, is selected from the group consisting of O, S, Se, CRR', SiRR', NR, BR, BRR';
each of R^{A'}, R^{B'}, R^{C'}, R^{D'}, R^{E'}, R^{F'}, and R^{G'} independently represents mono-, up to the maximum substitutions, or no substitutions;
each of R, R', R^{A'}, R^{B'}, R^{C'}, R^{D'}, R^{E'}, R^{F'}, and R^{G'} is independently a hydrogen or a substituent selected from the group consisting of the General Substituents defined herein; and
at least one R, R', R^{A'}, R^{B'}, R^{C'}, R^{D'}, R^{E'}, R^{F'}, or R^{G'} comprises deuterium.

As shown in the structures of LIST 1, when present, Y^{A} is part of a five-membered ring between two phenyl rings. Thus, in instances where Y^{A} is absent, the two six-membered rings are bonded together by the existing single bond. In some embodiments of both aspects, the first host is selected from the group consisting of the structures in the following **LIST** 2:

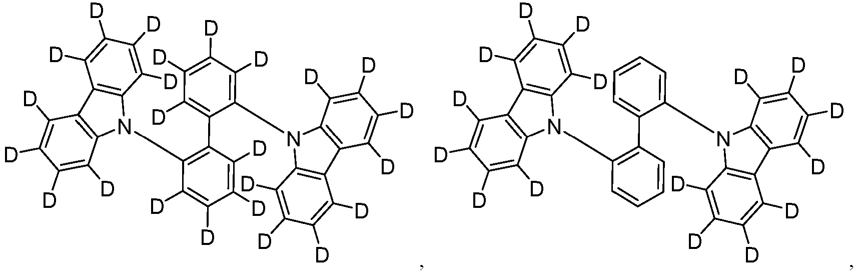

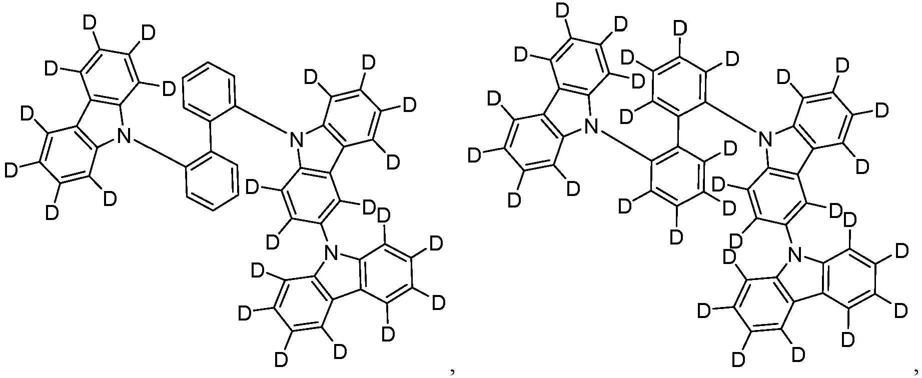

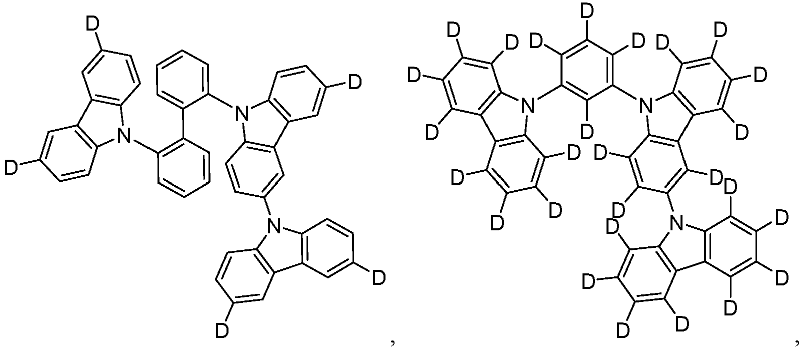

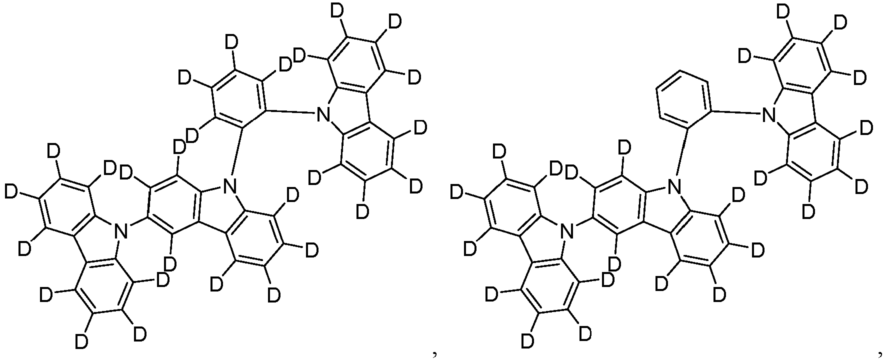

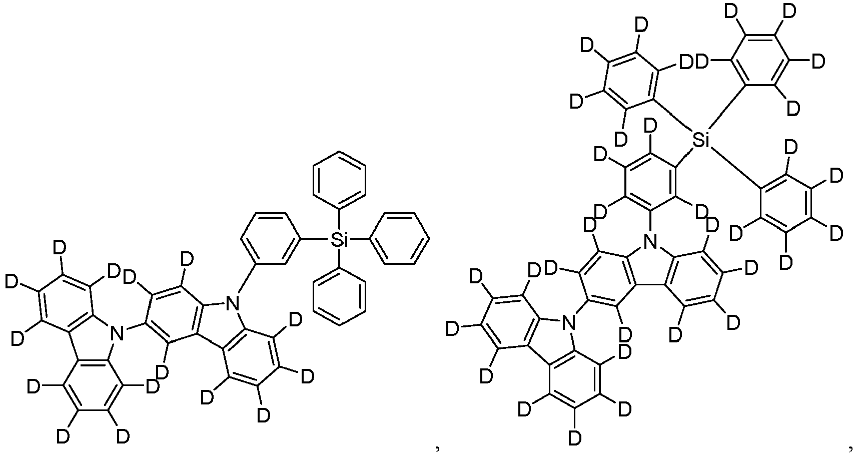

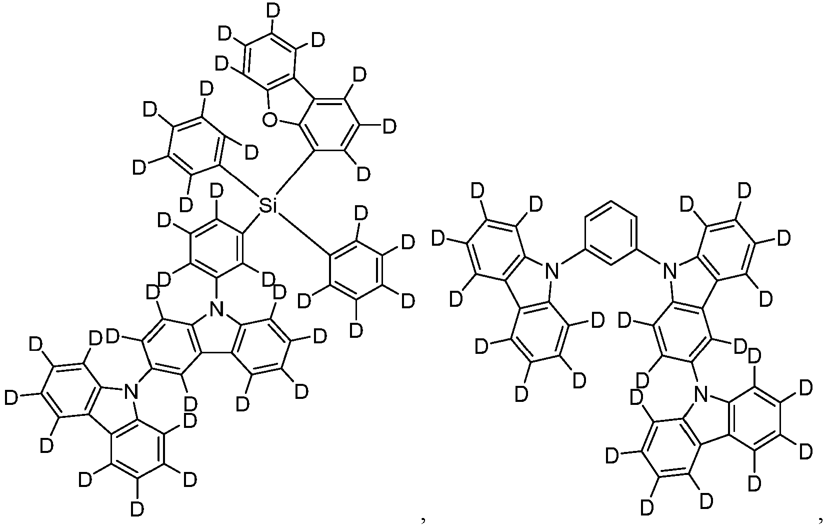

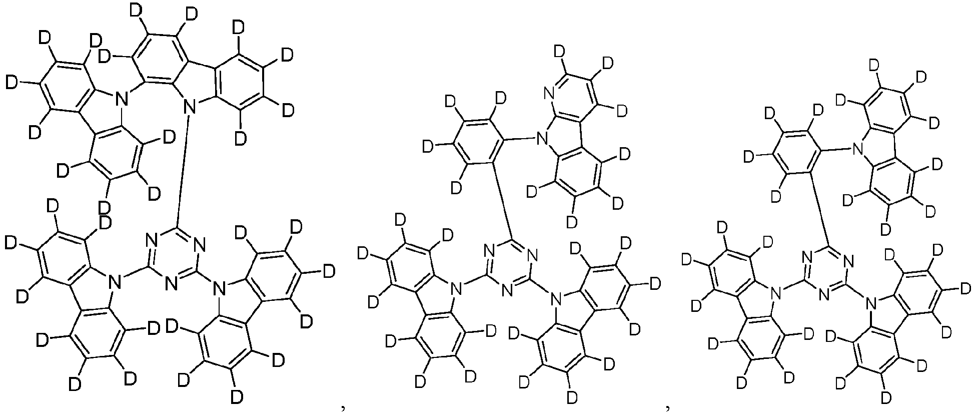

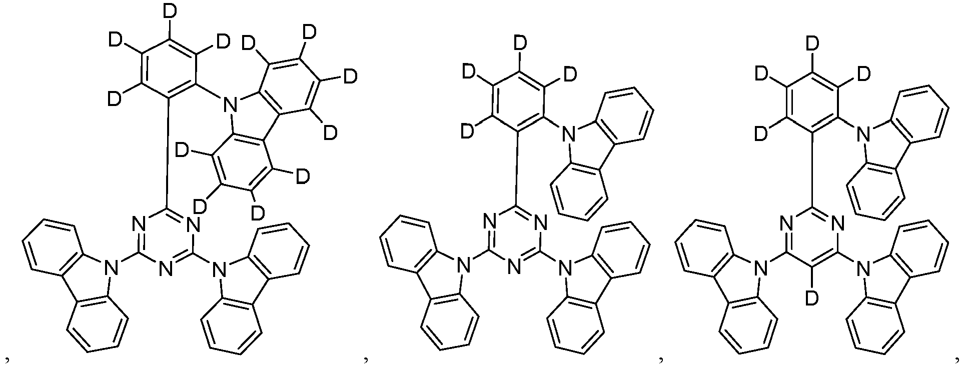

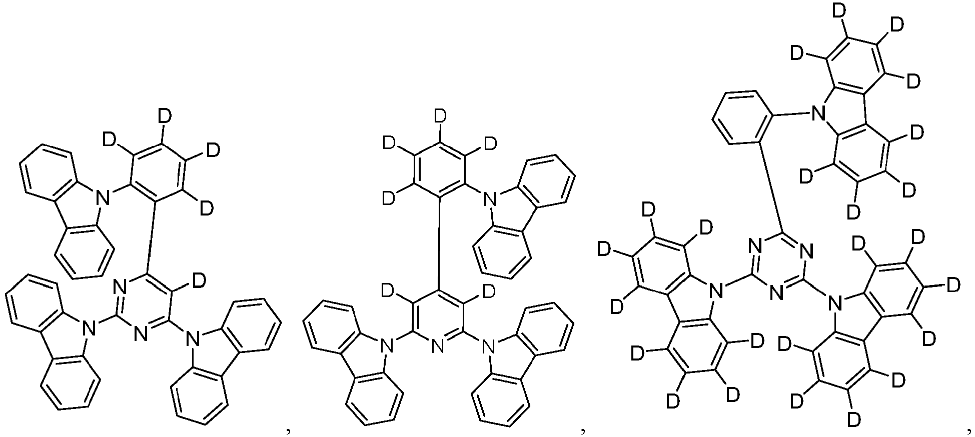

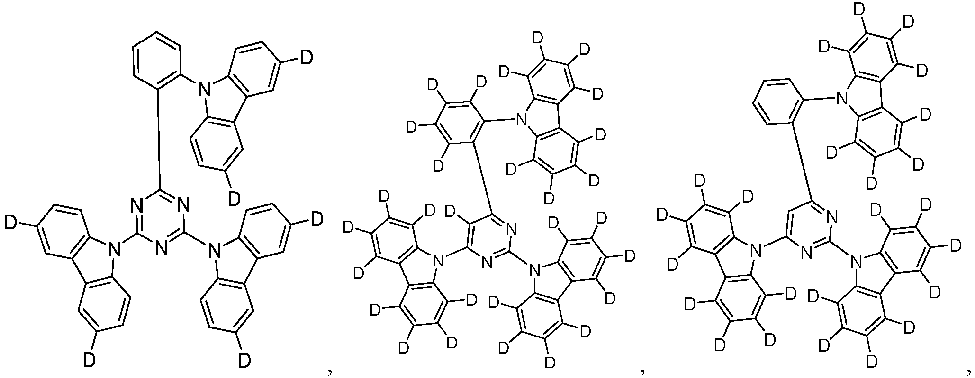

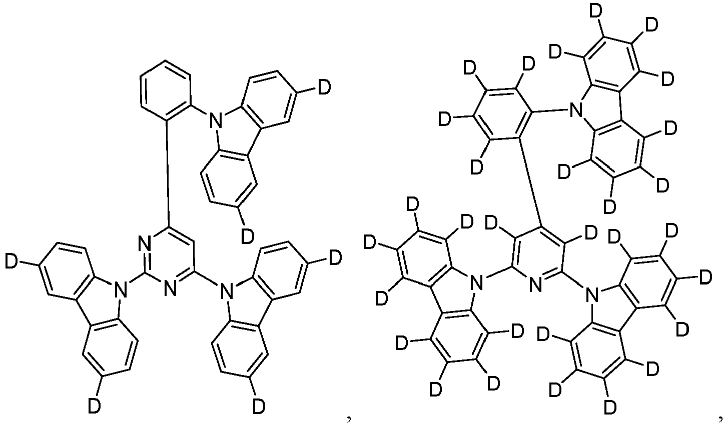

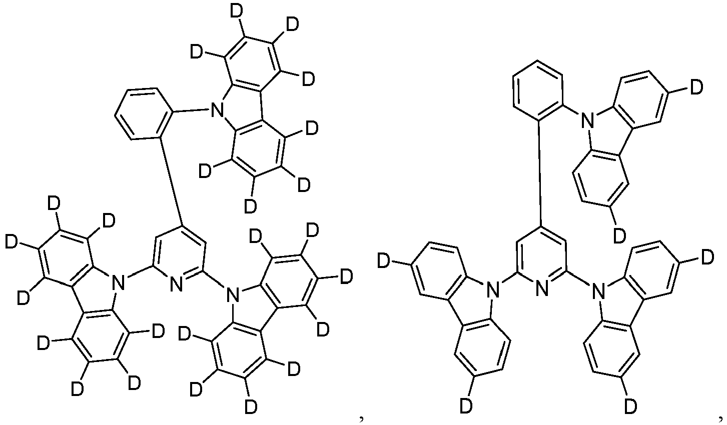

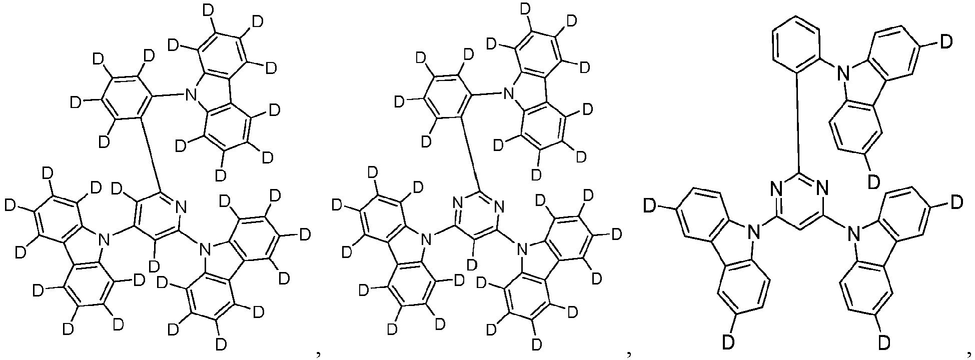

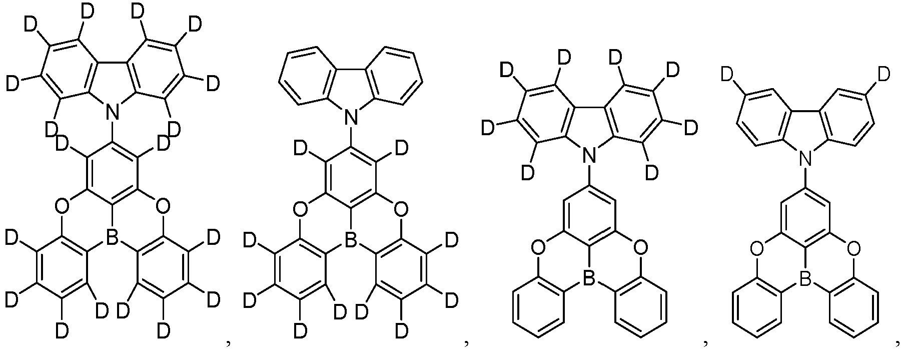

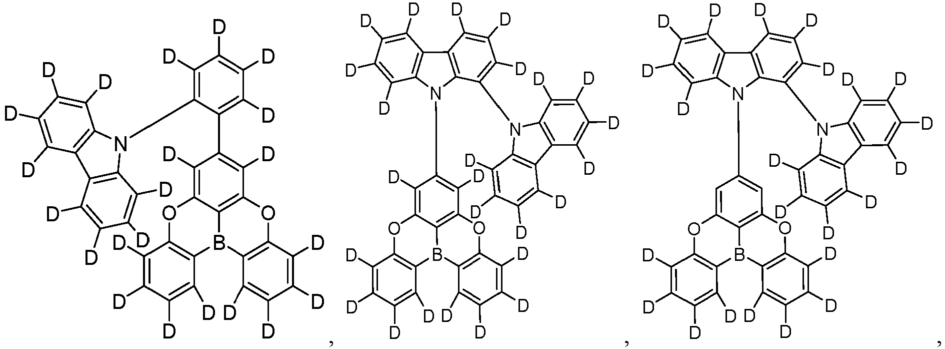

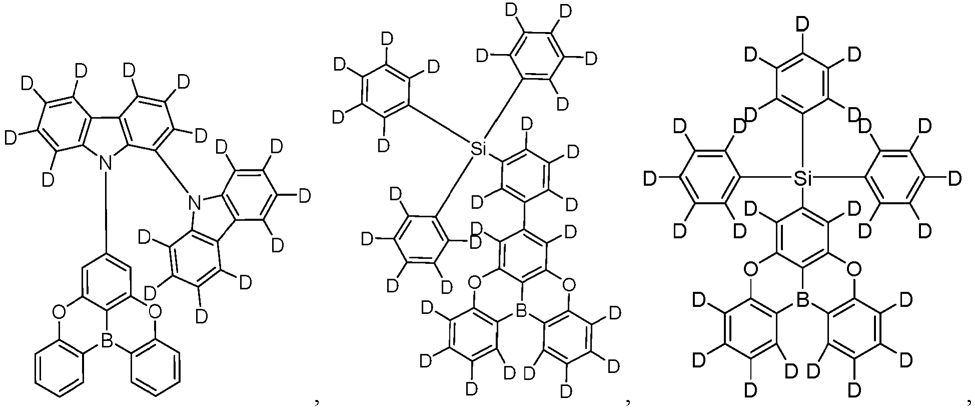

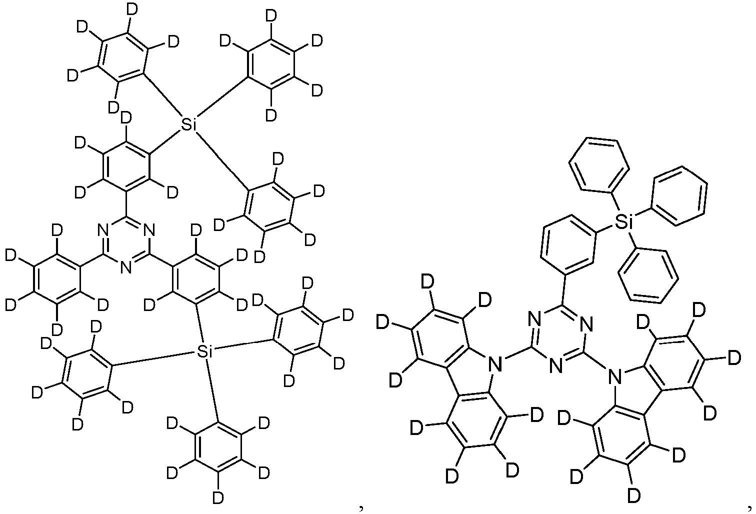

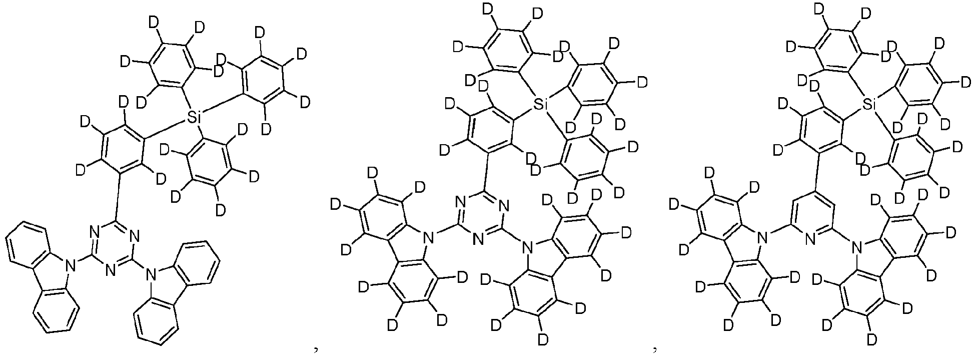

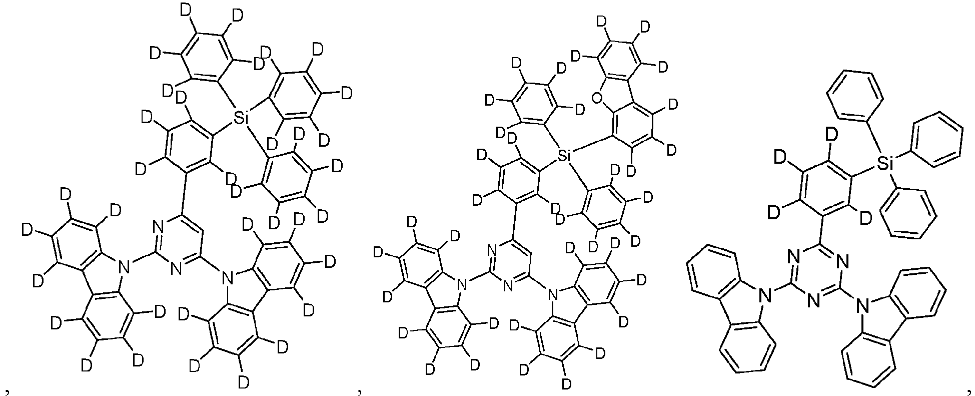

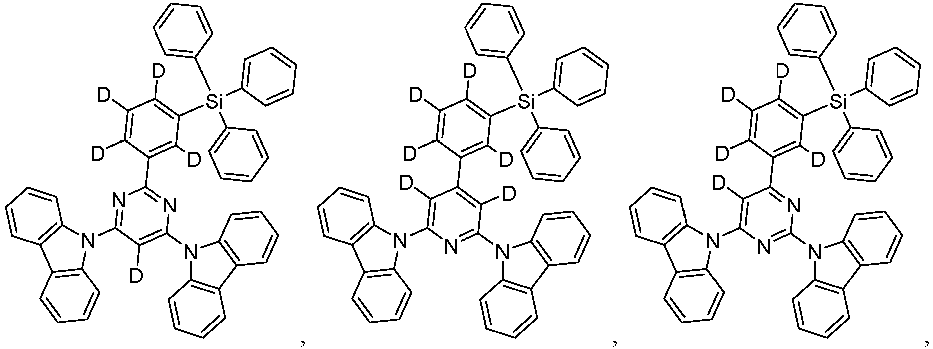

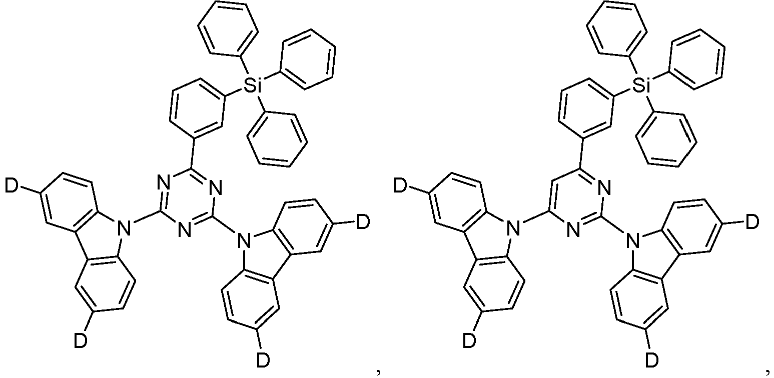

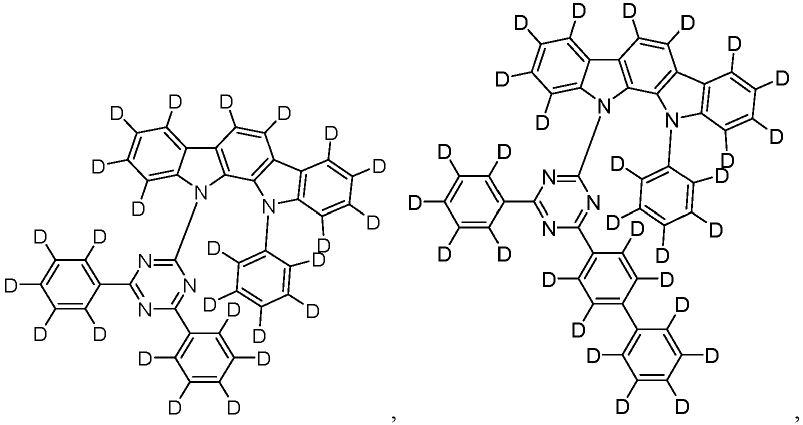

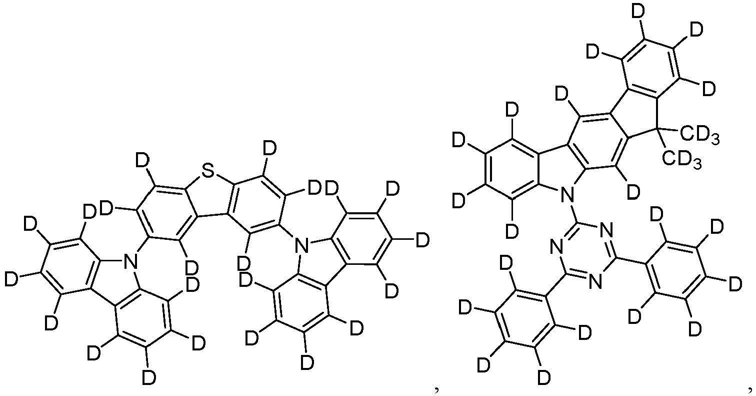

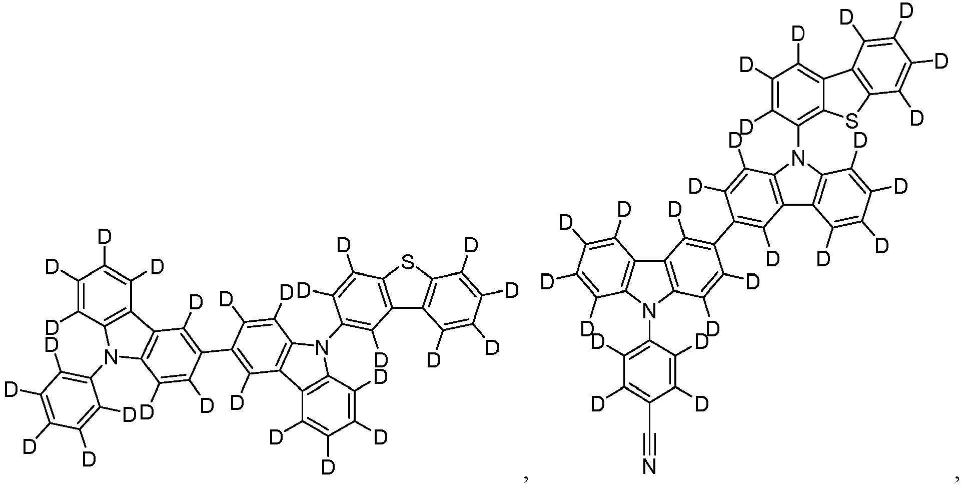

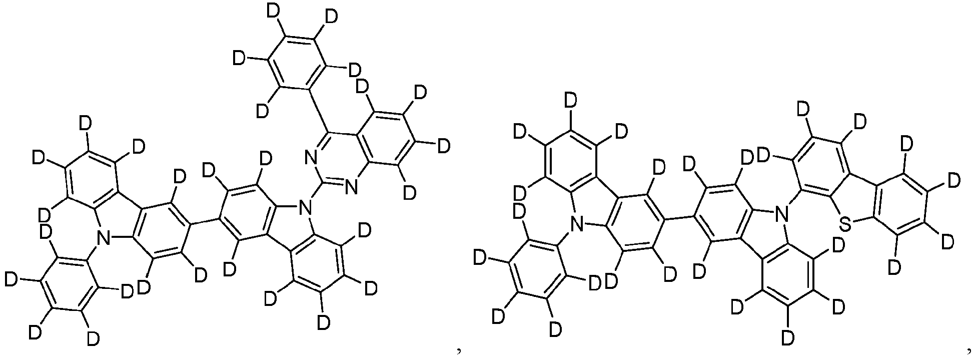

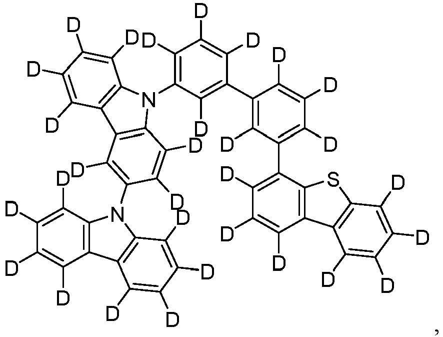

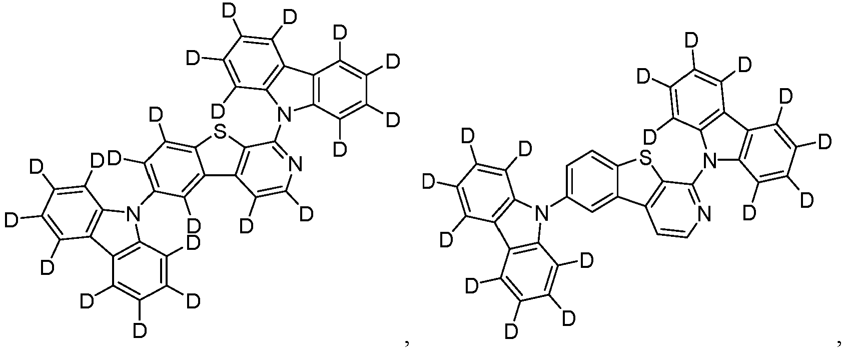

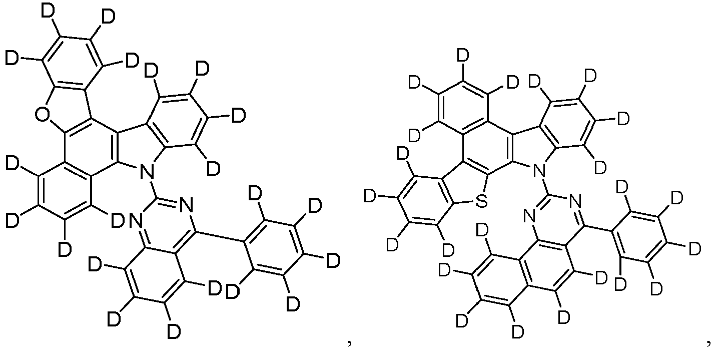

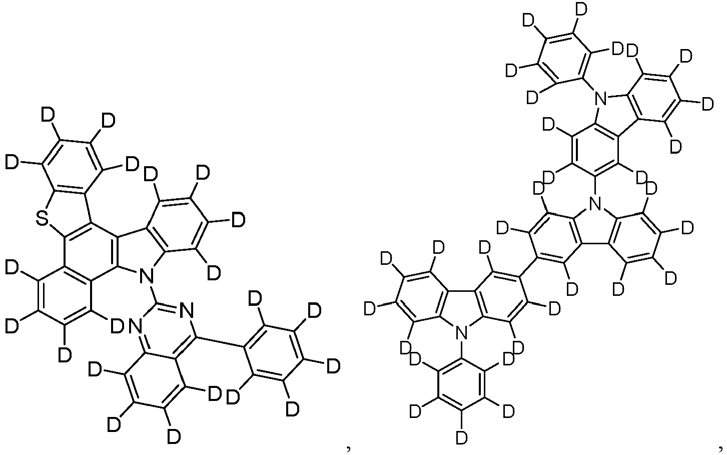

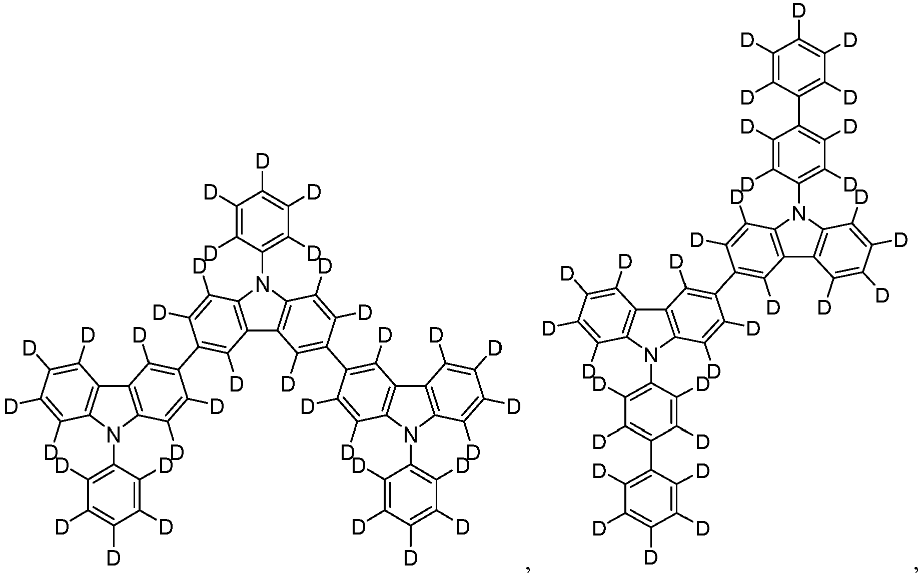

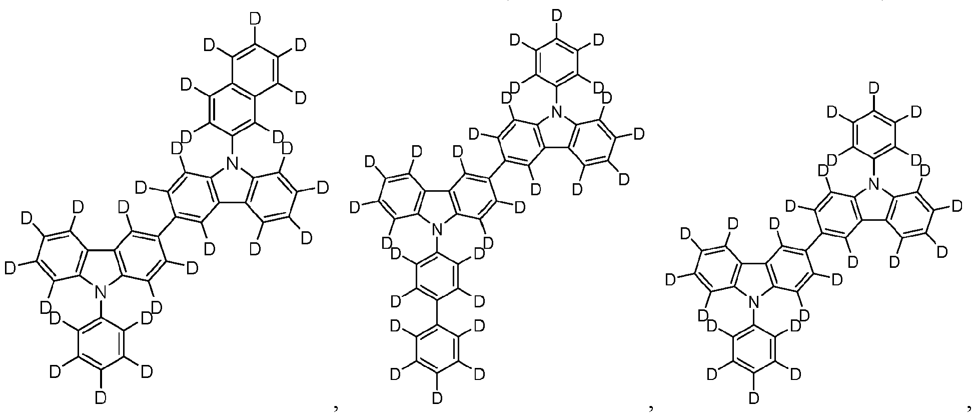

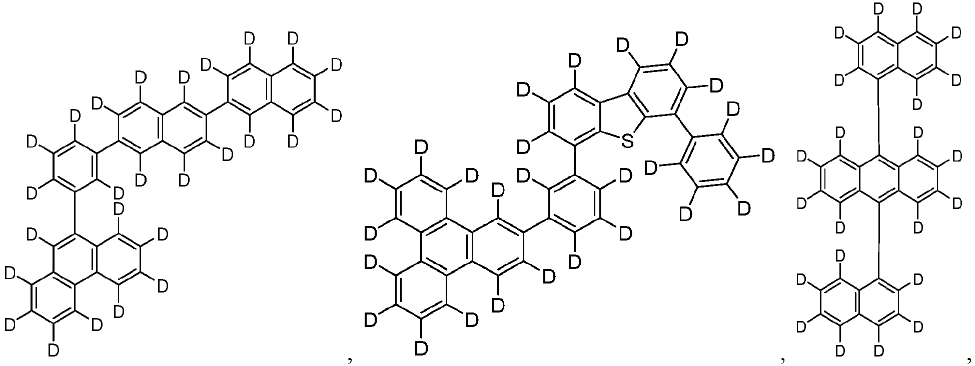

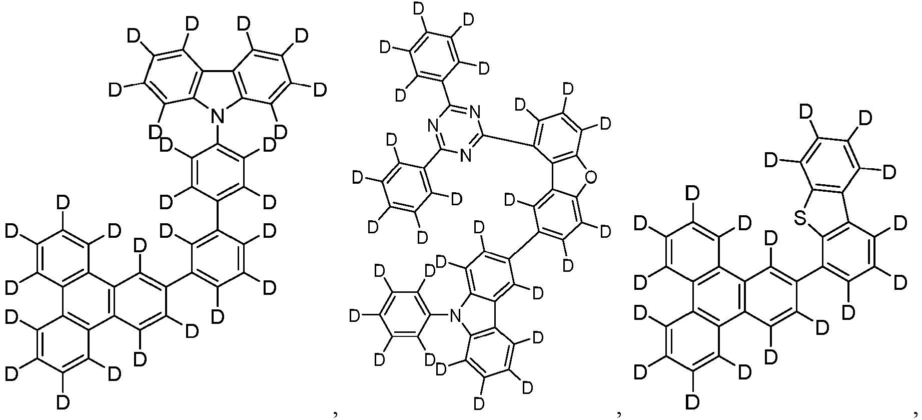

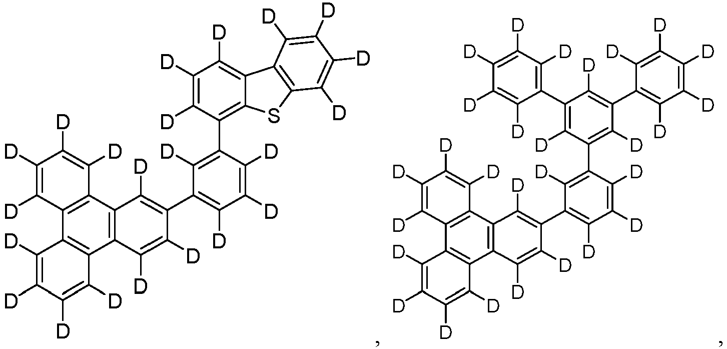

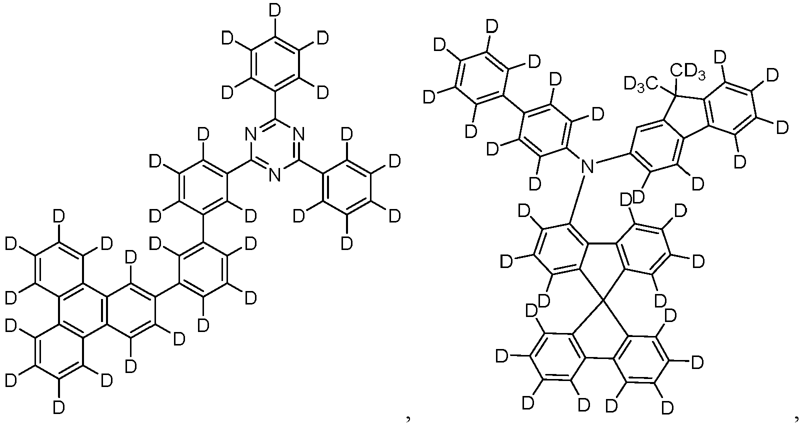

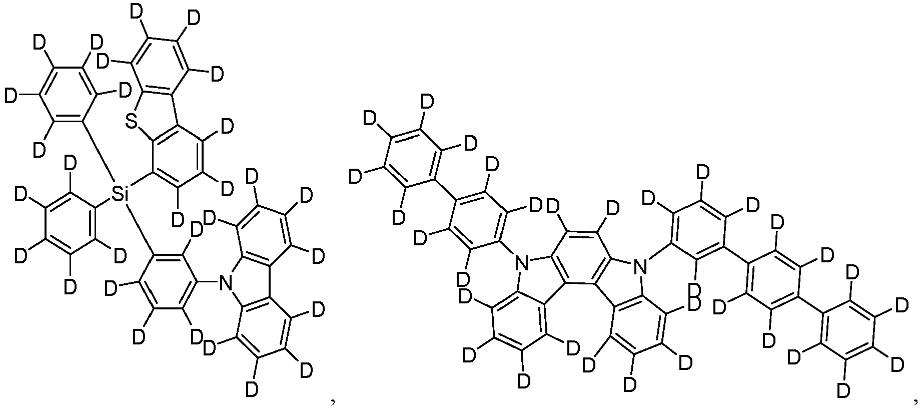

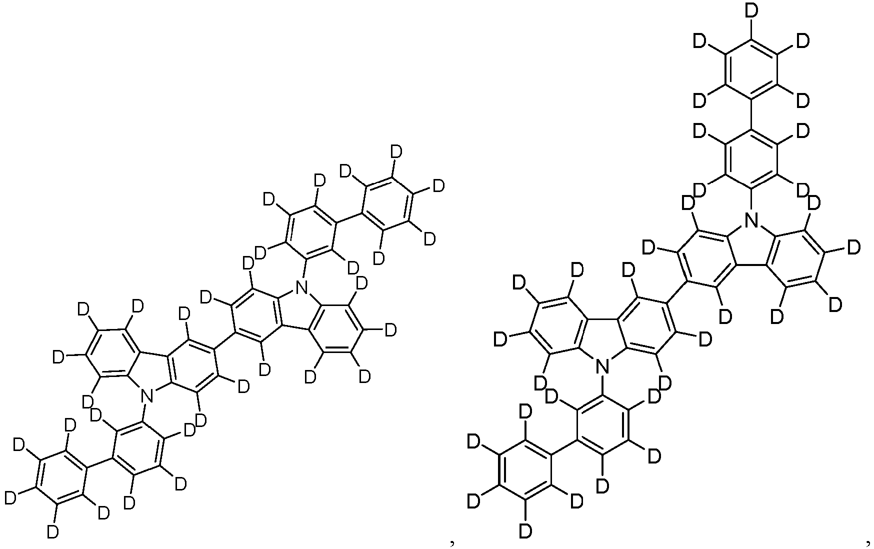

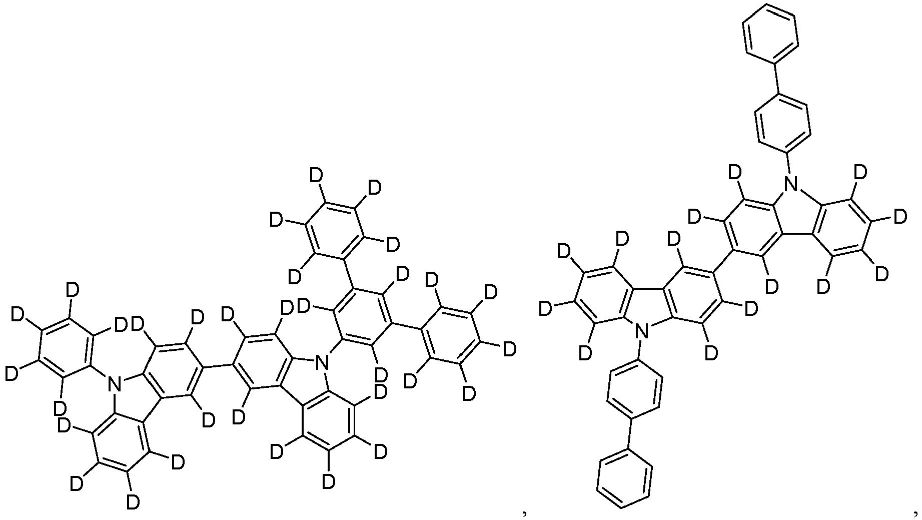

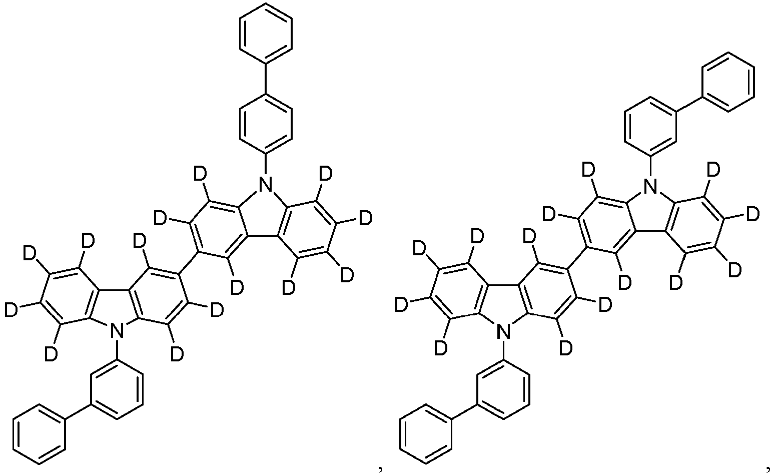

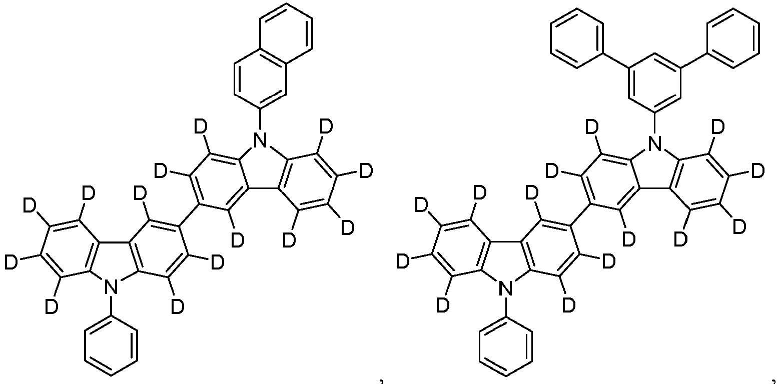

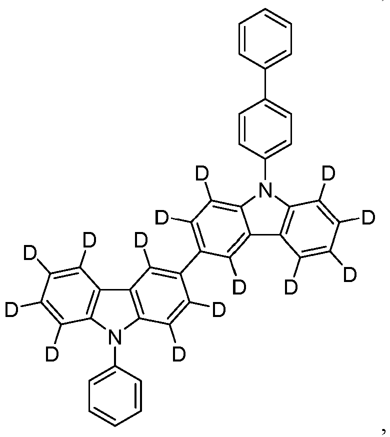

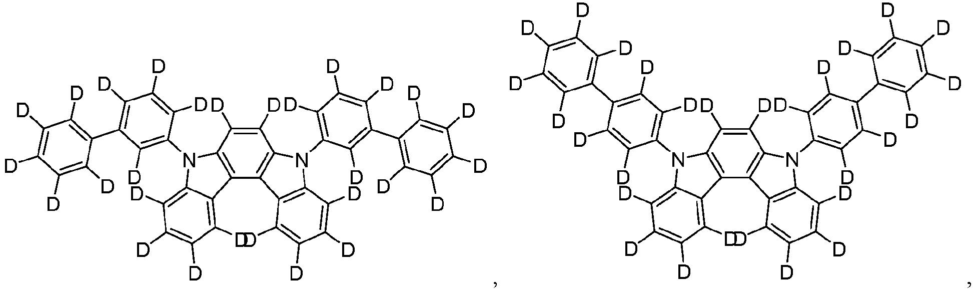

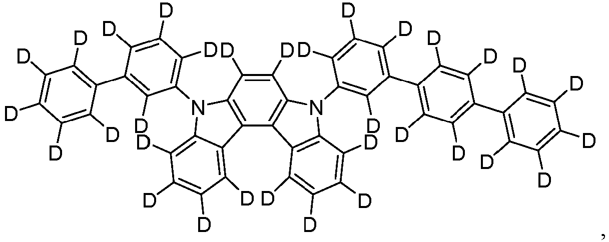

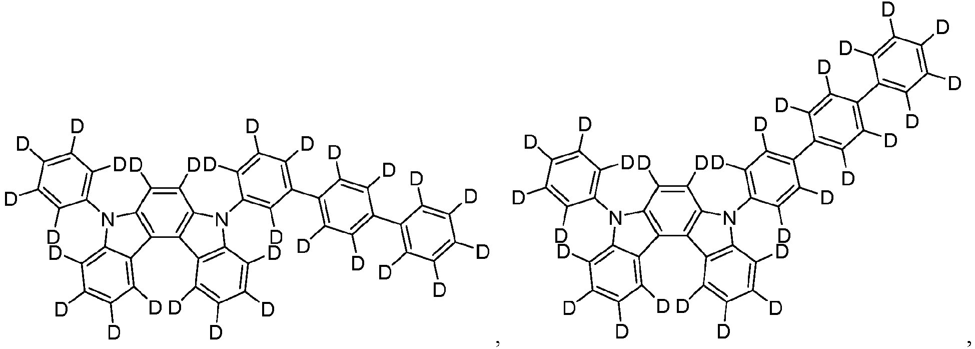

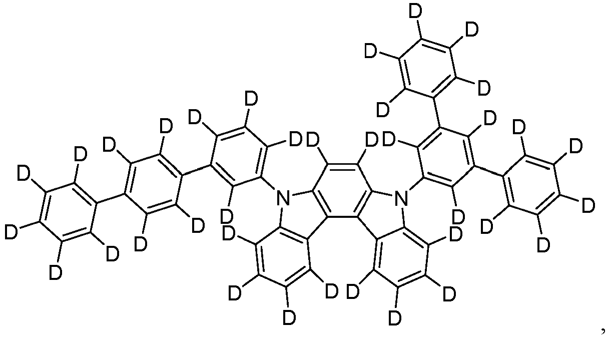

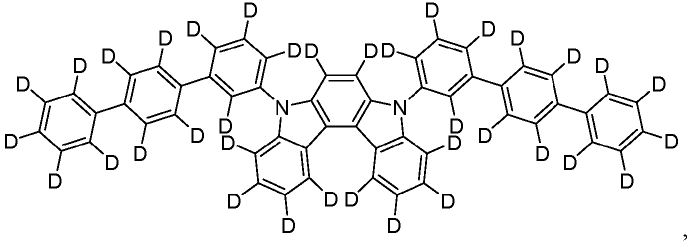

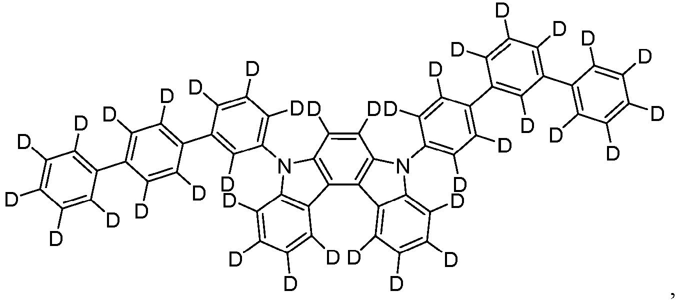

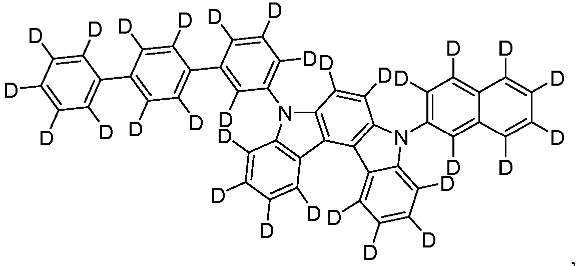

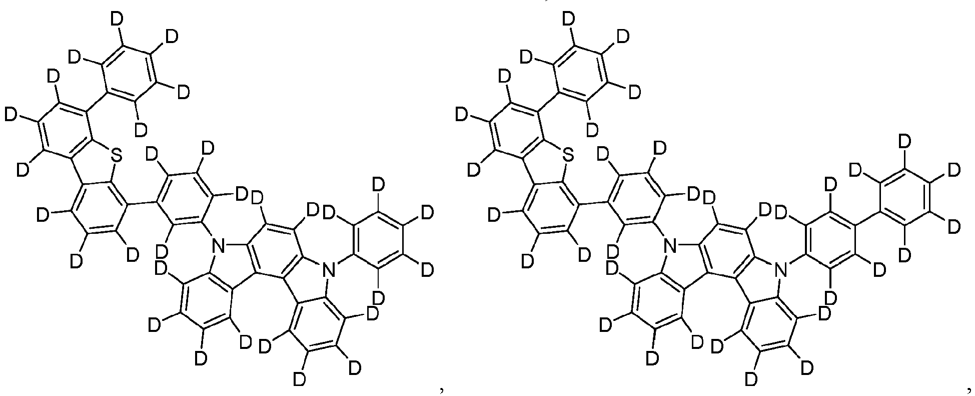

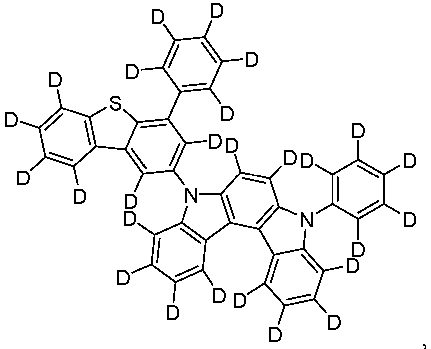

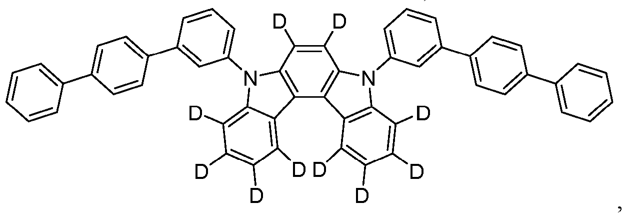

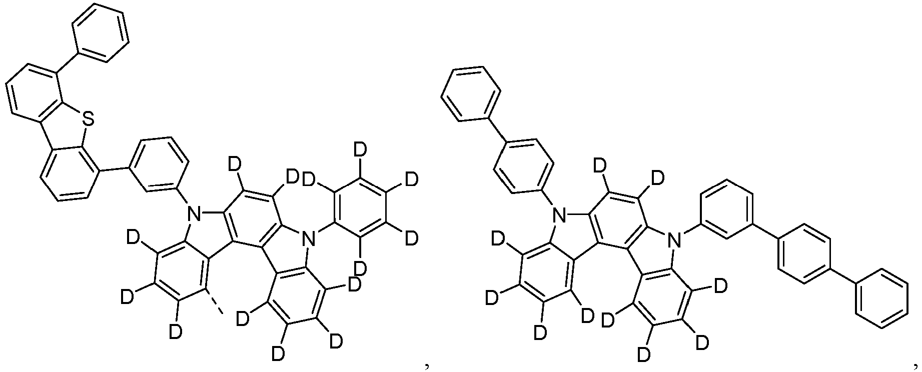

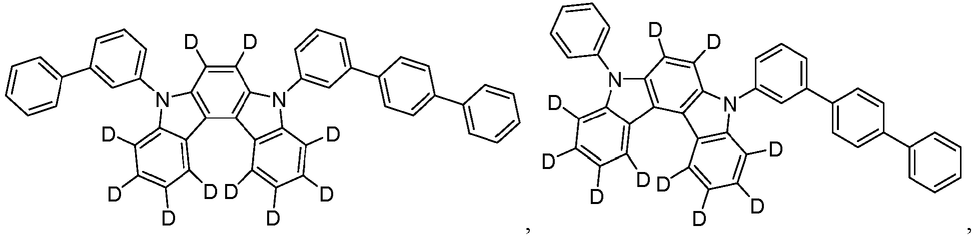

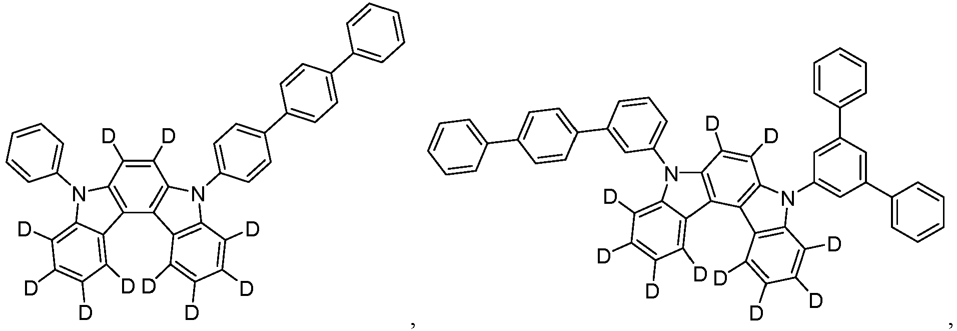

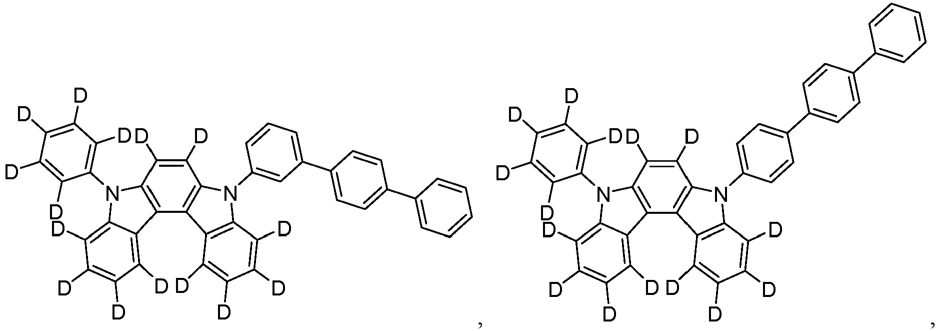

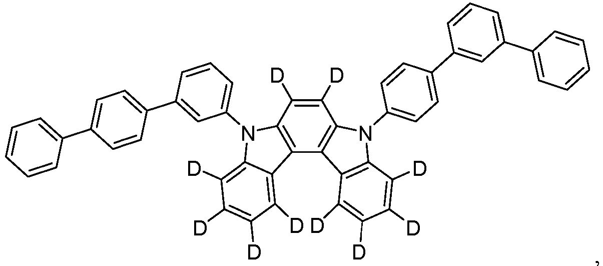

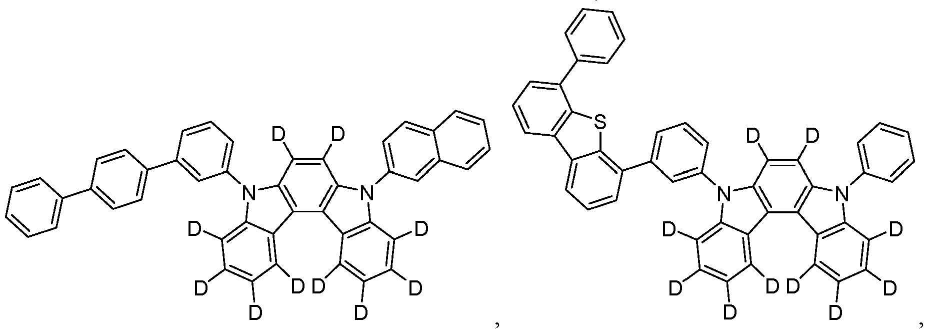

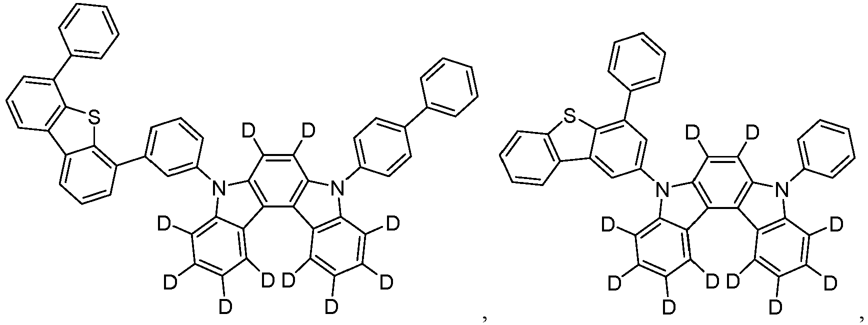

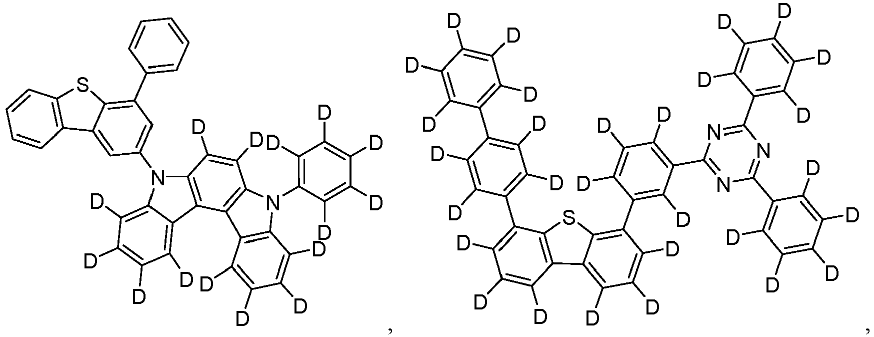

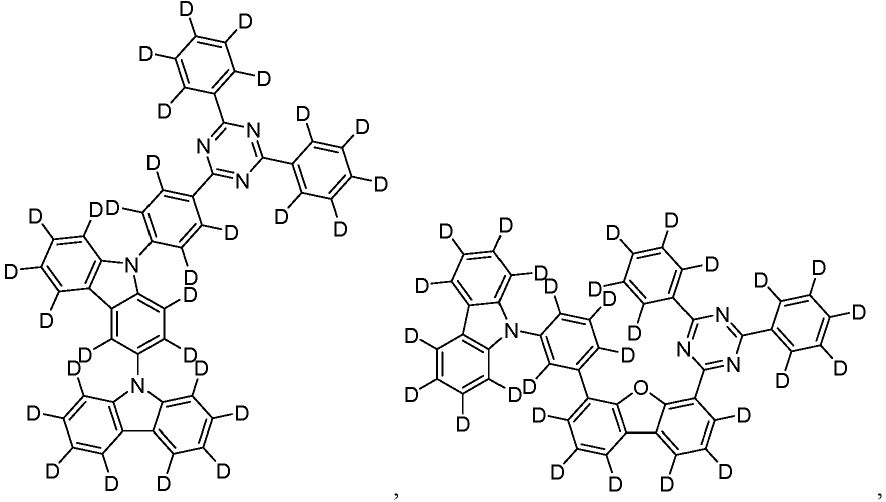

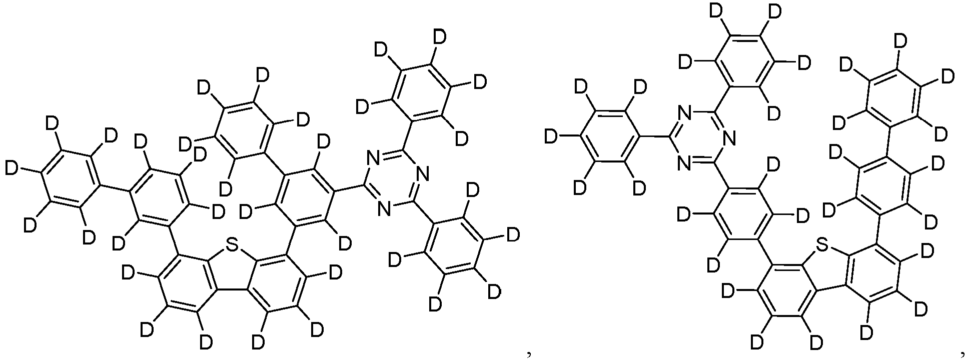

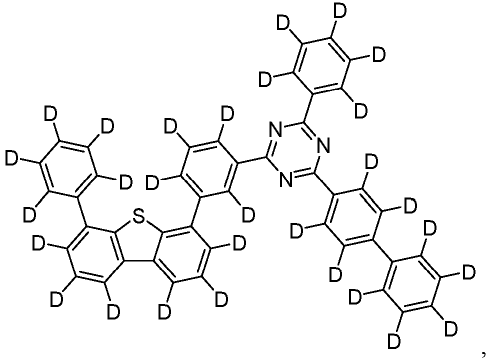

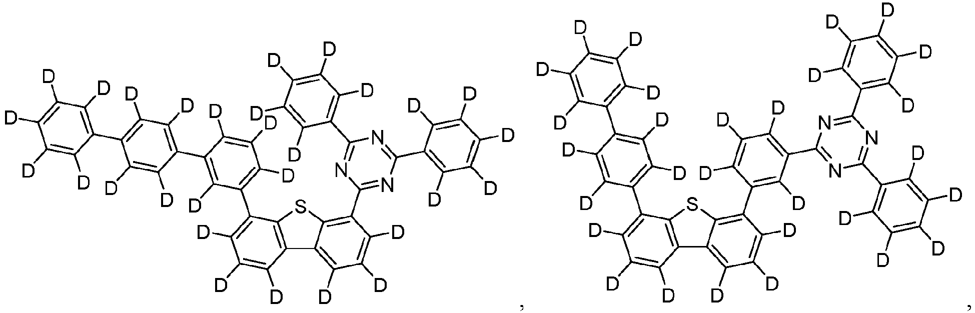

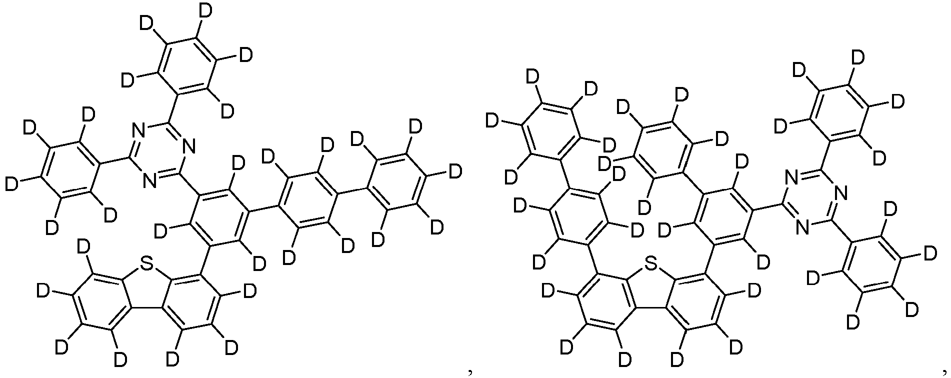

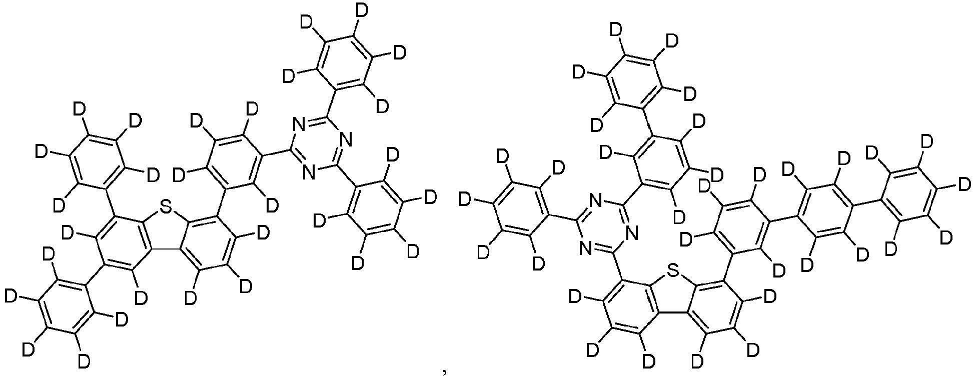

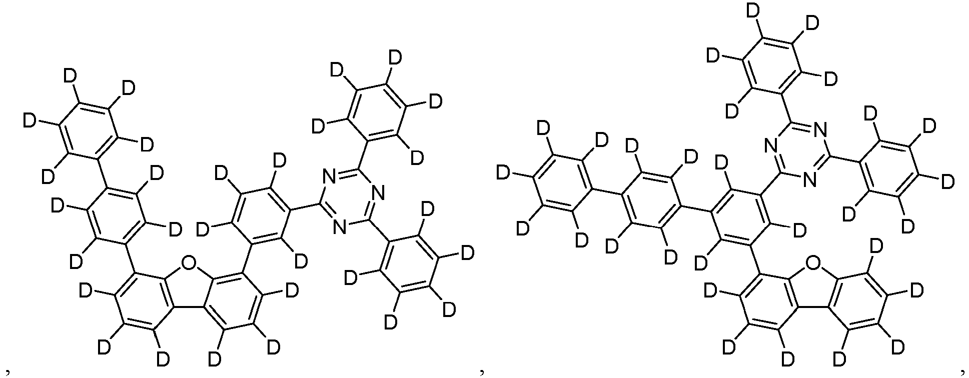

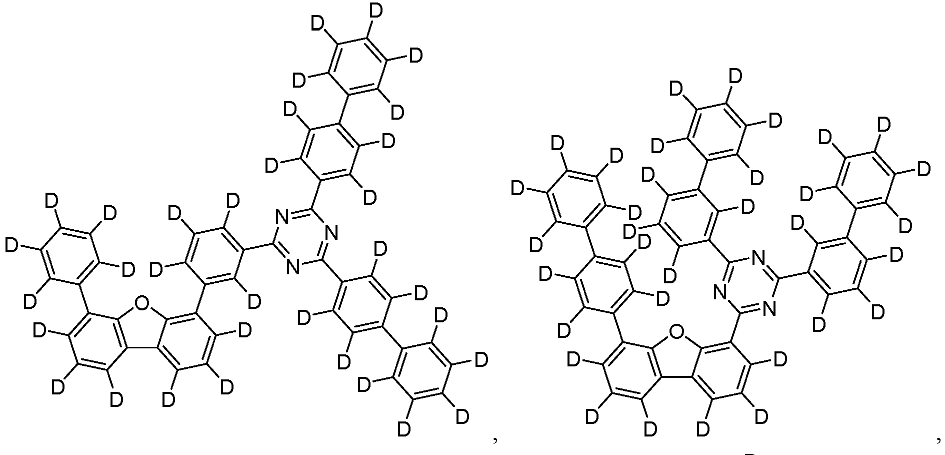

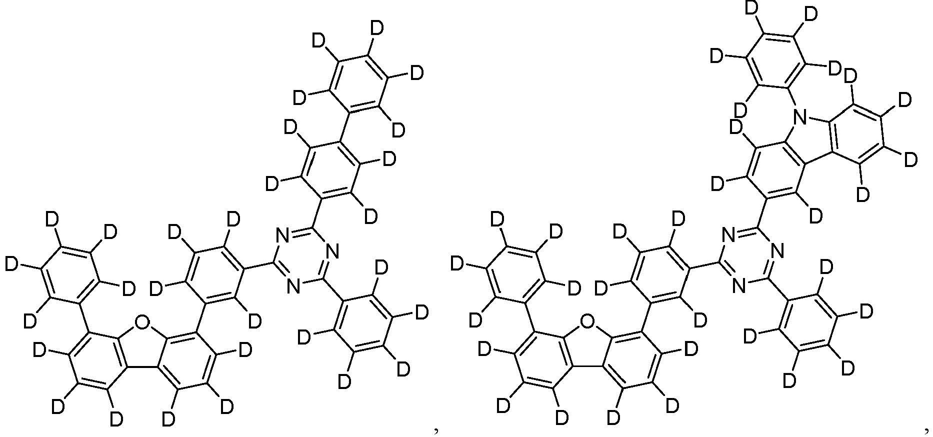

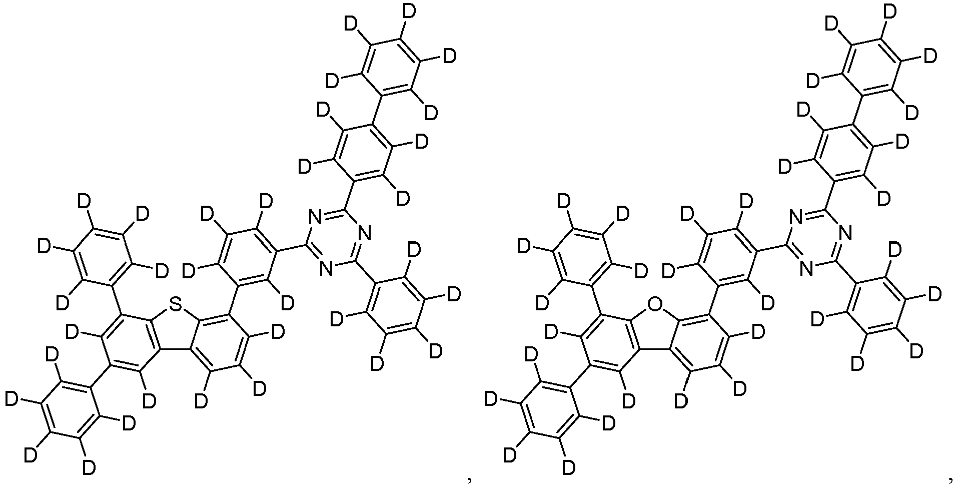

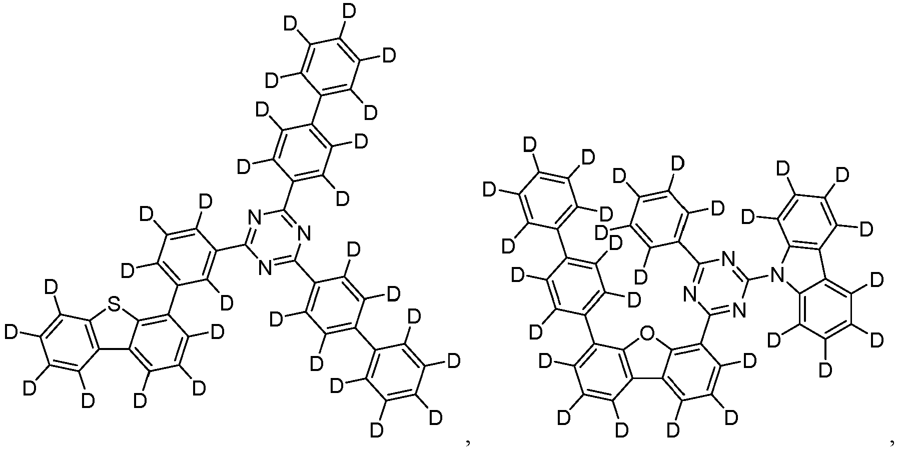

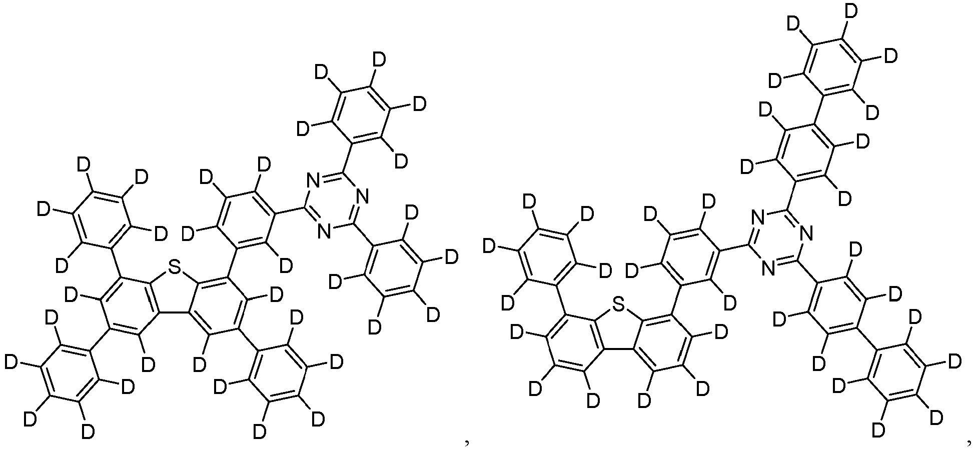

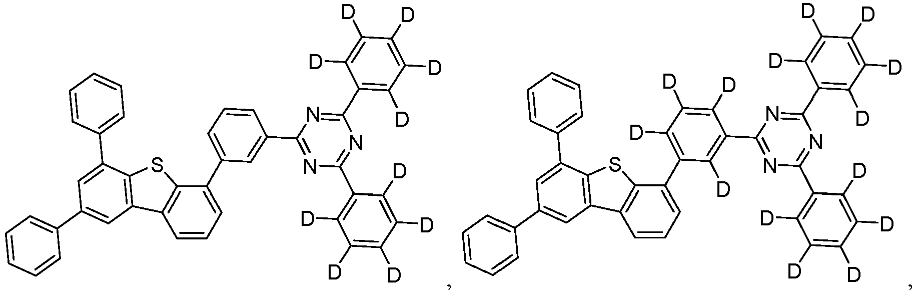

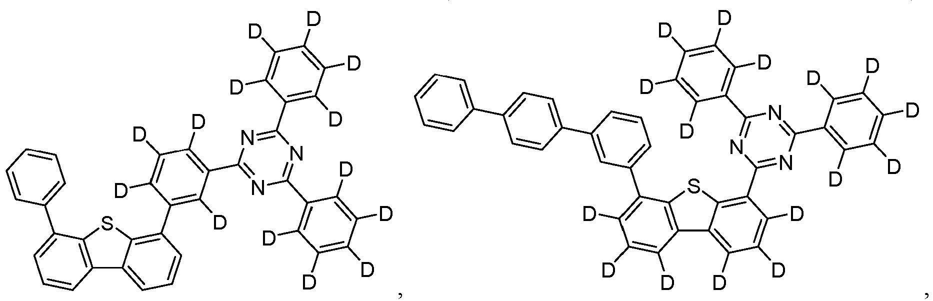

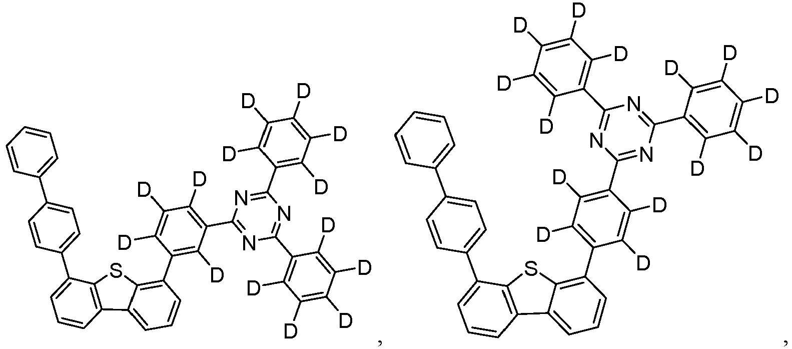

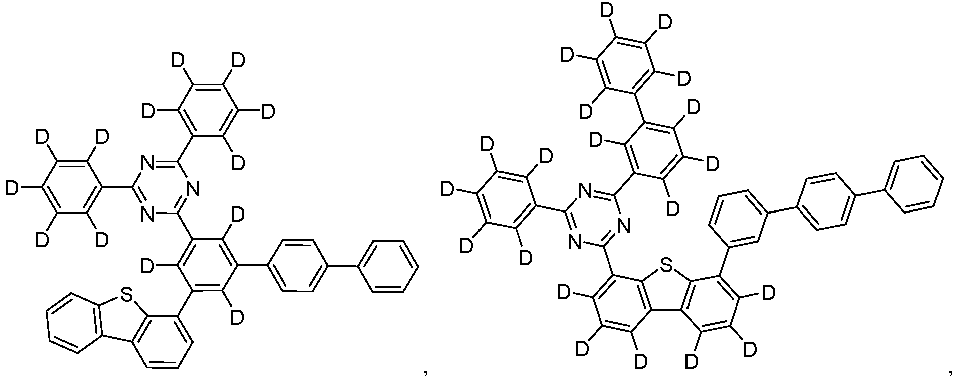

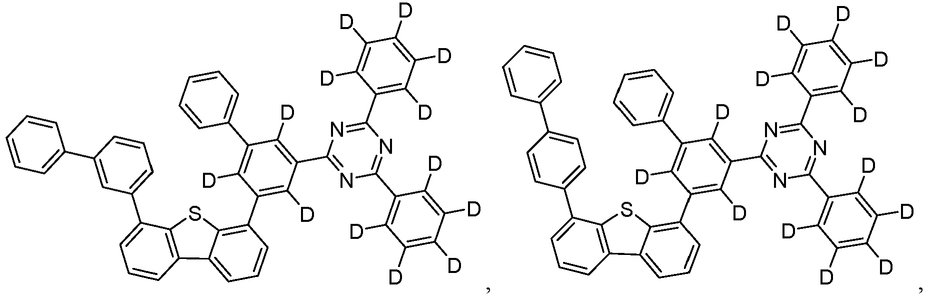

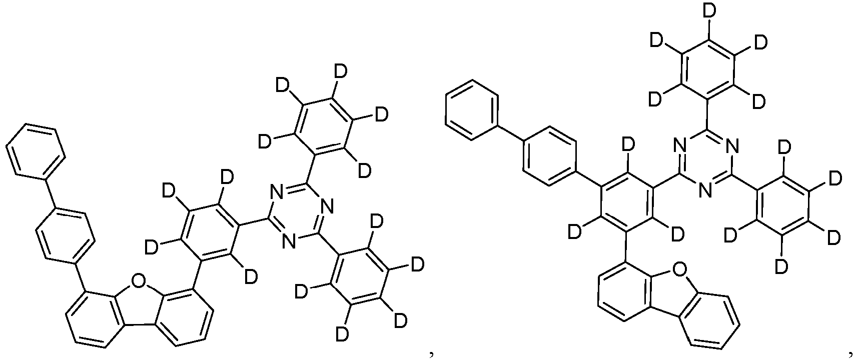

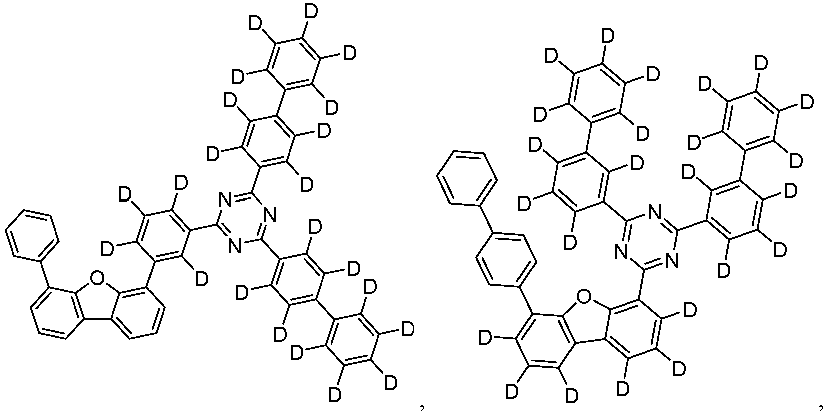

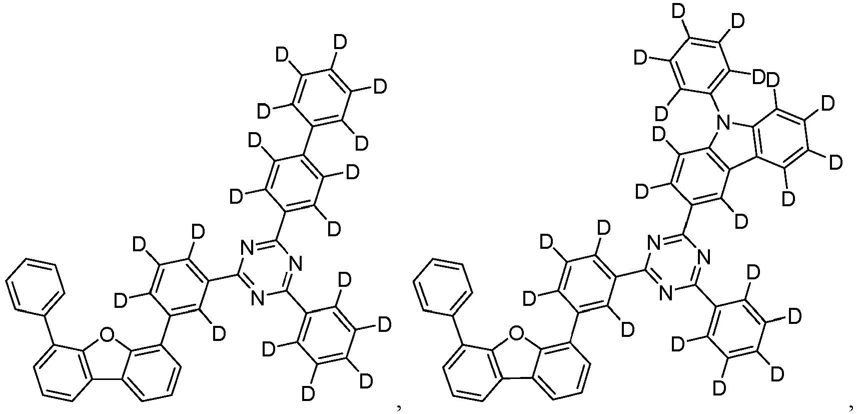

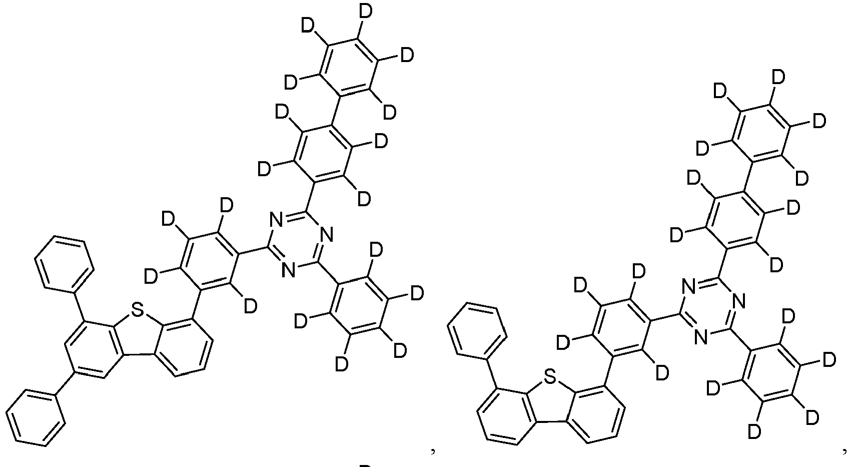

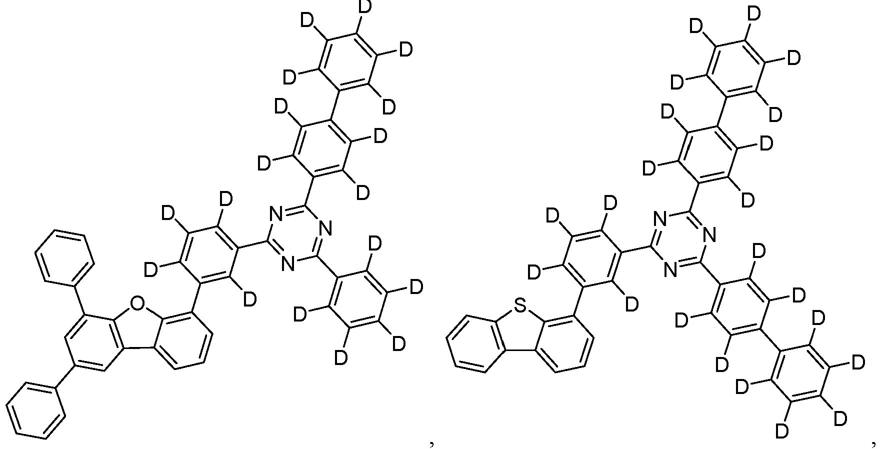

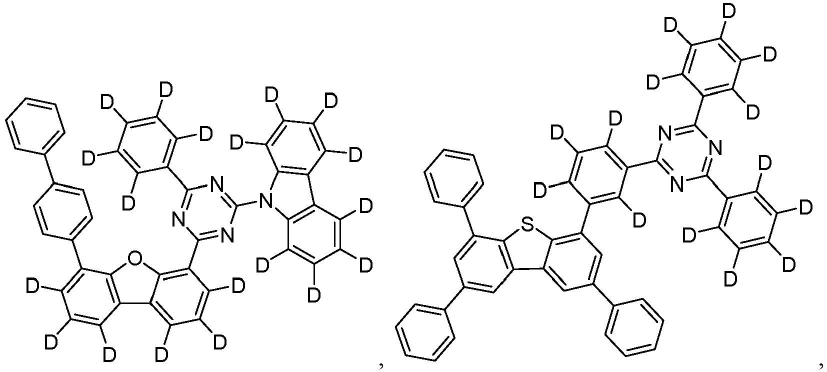

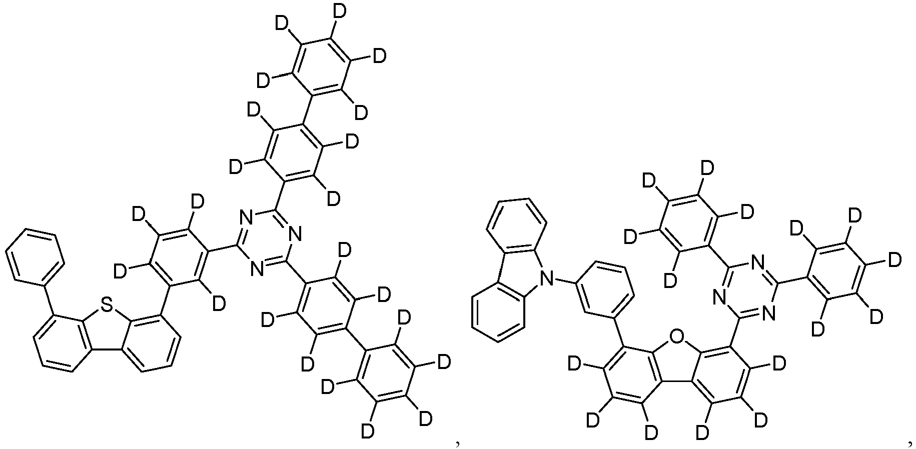

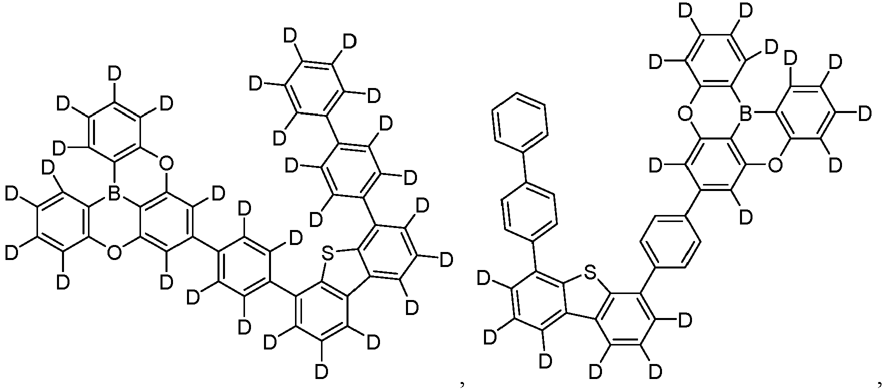

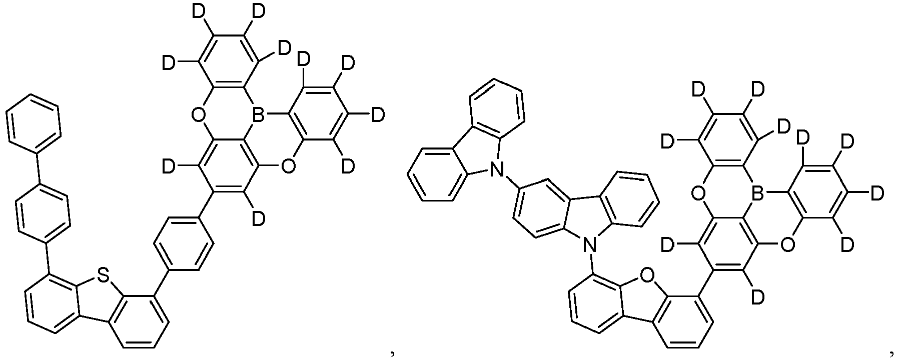

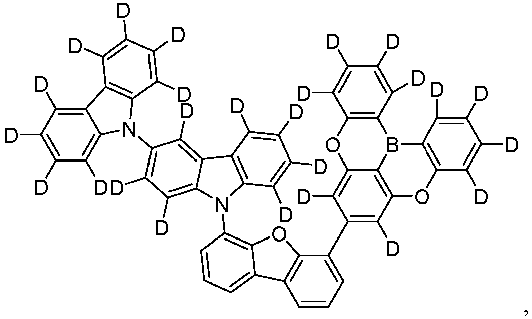

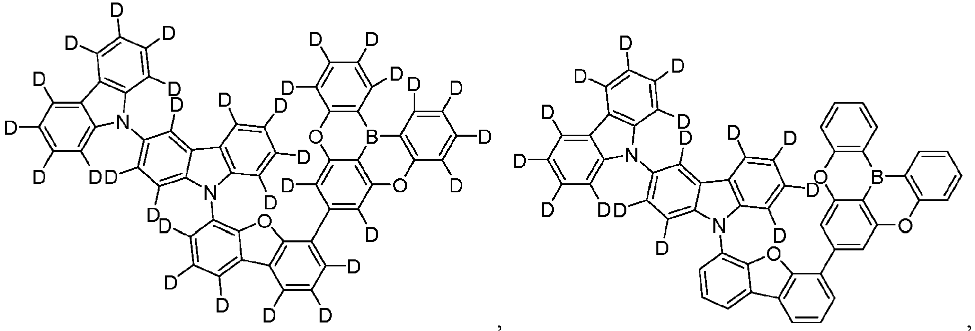

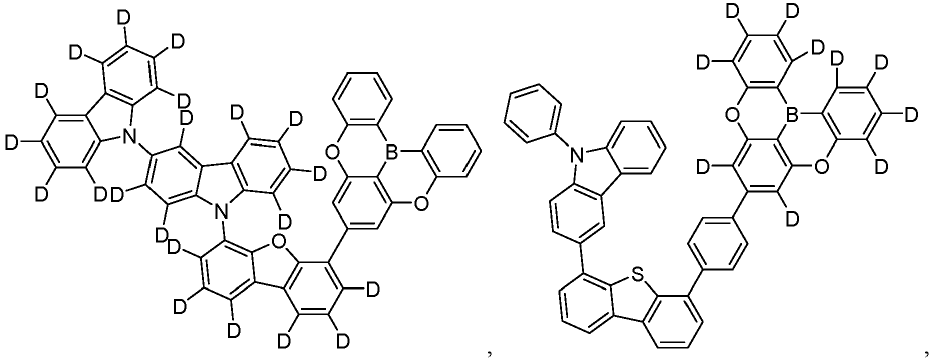

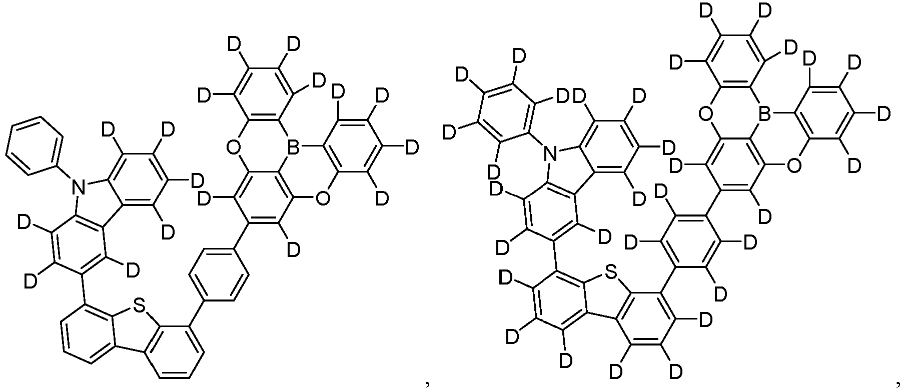

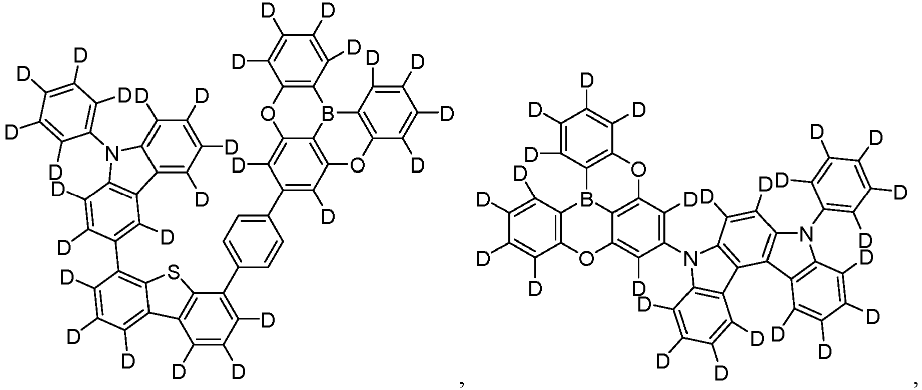

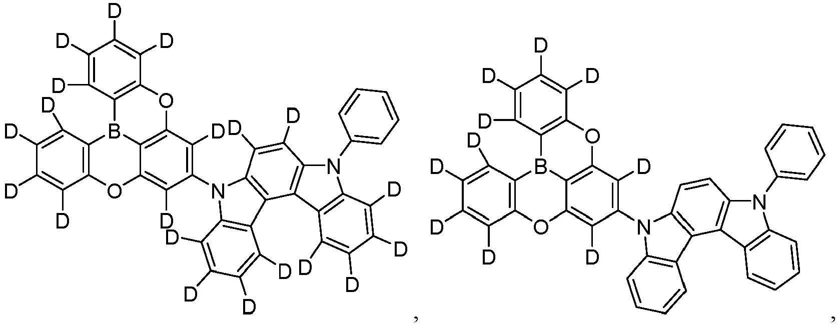

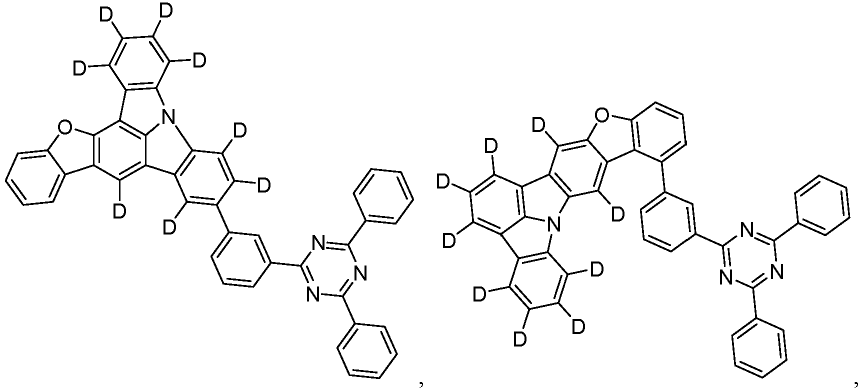

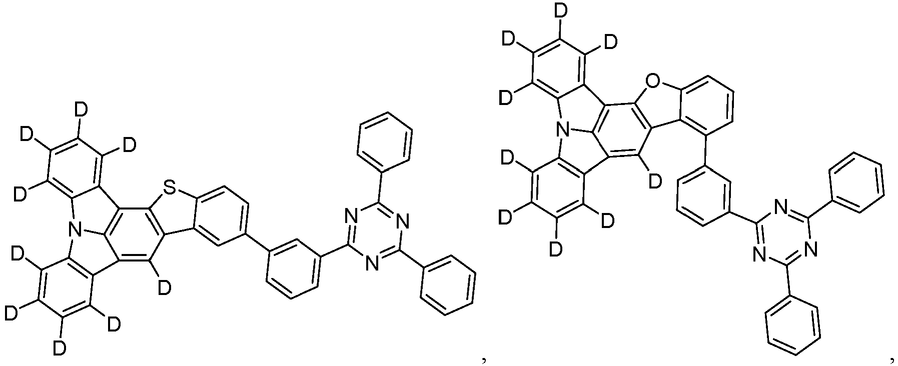

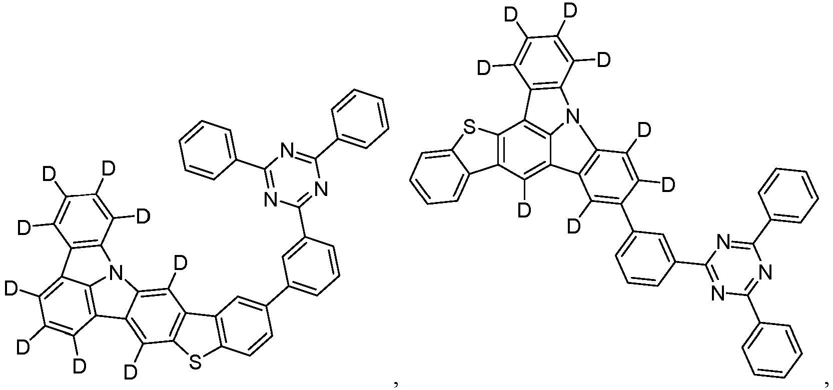

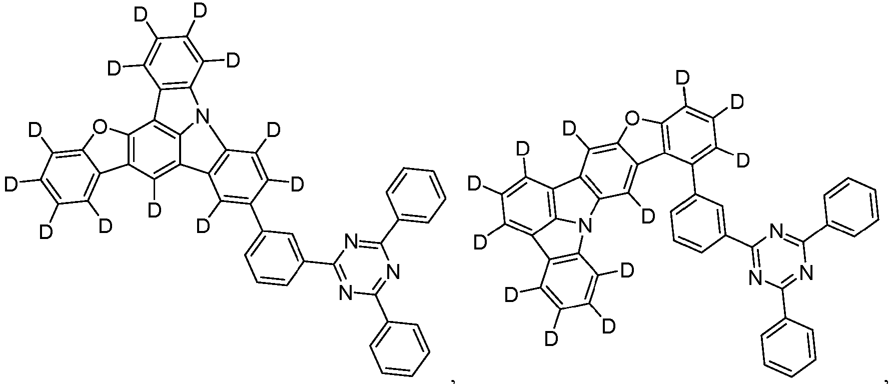

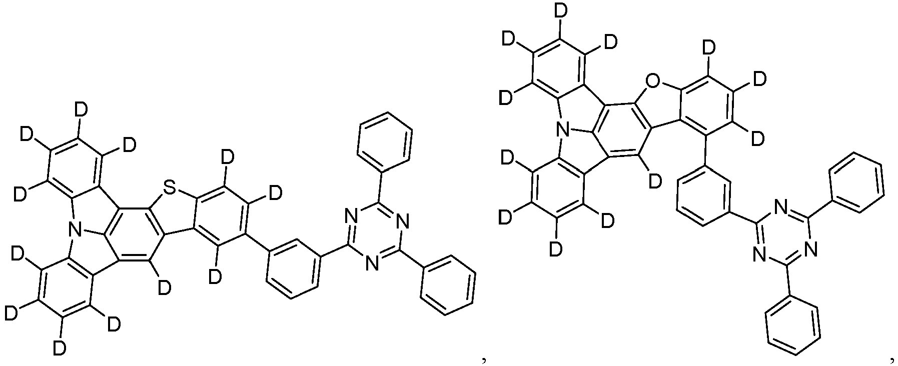

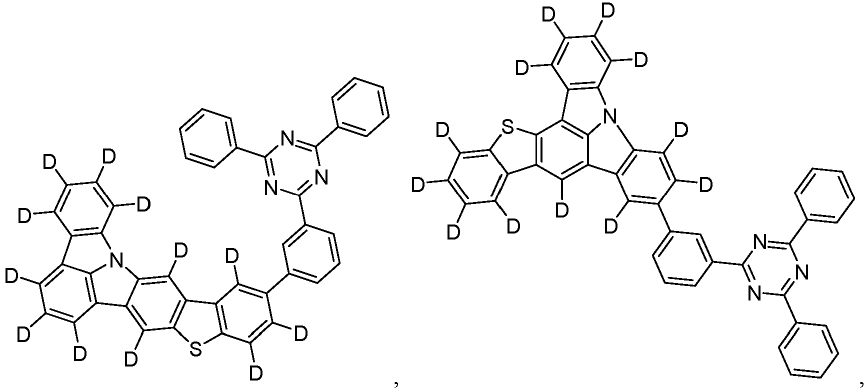

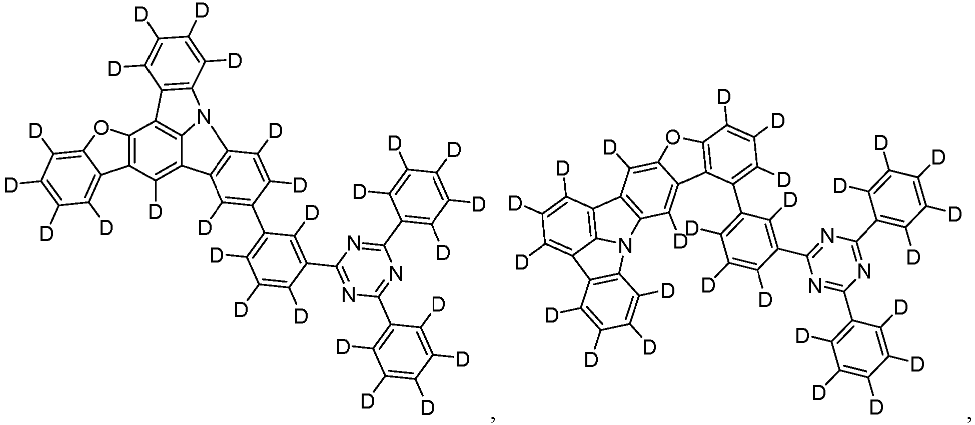

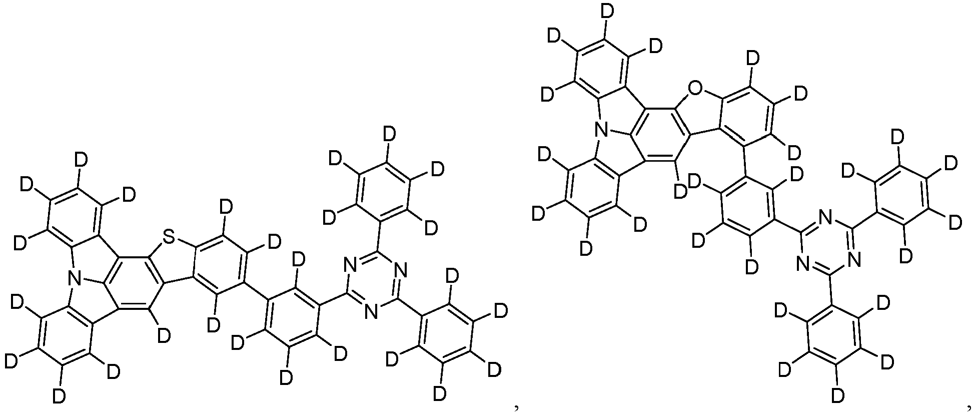

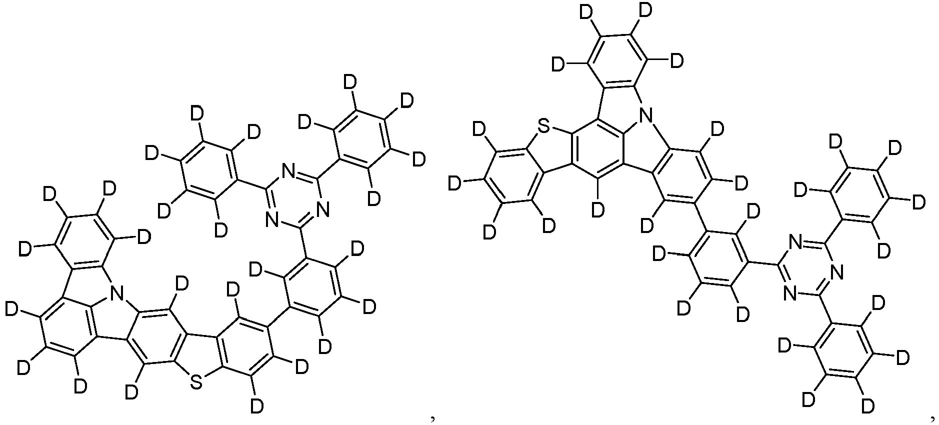

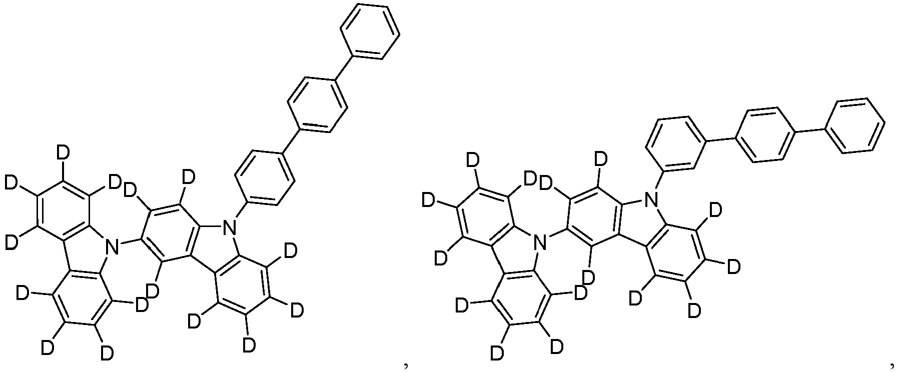

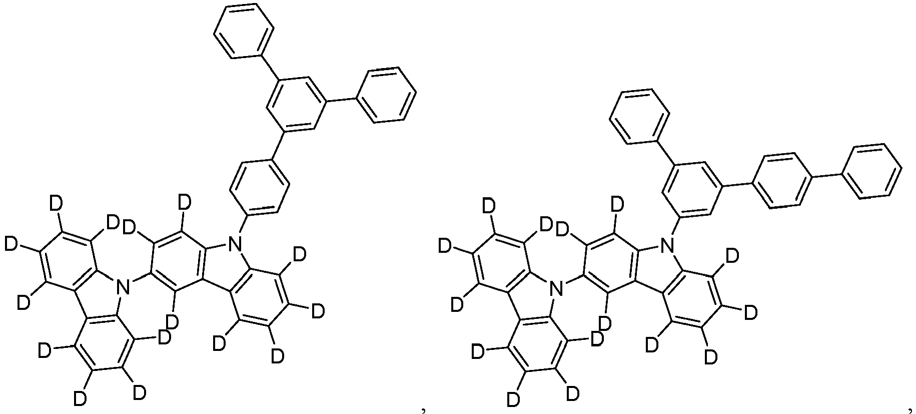

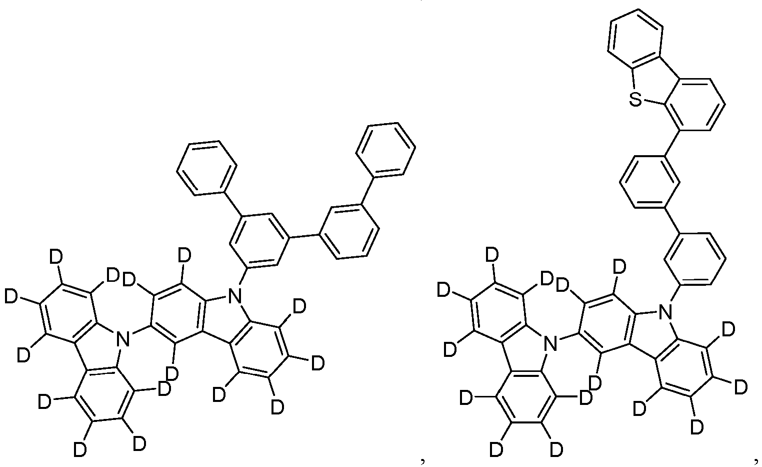

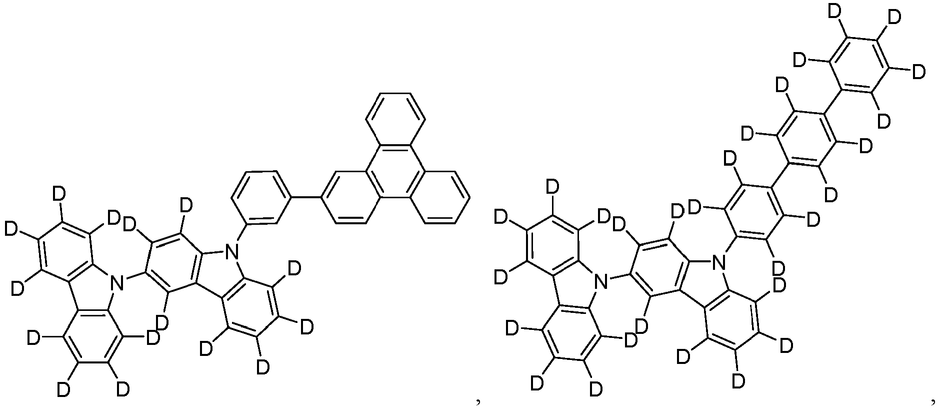

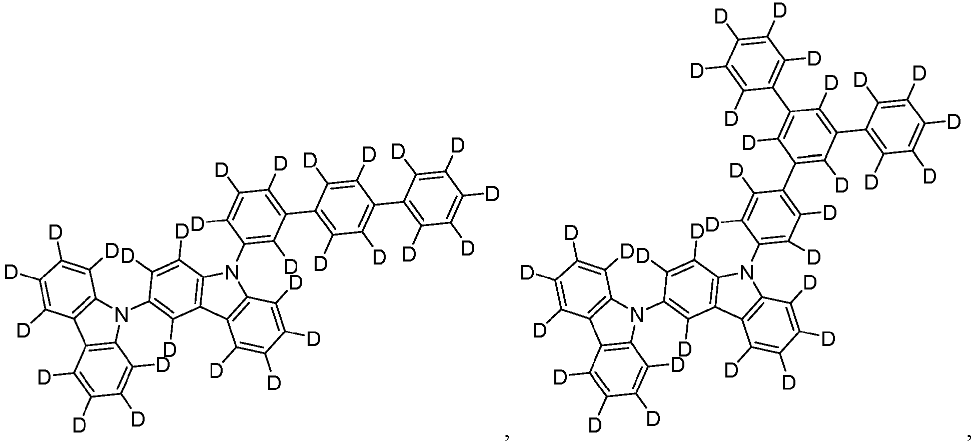

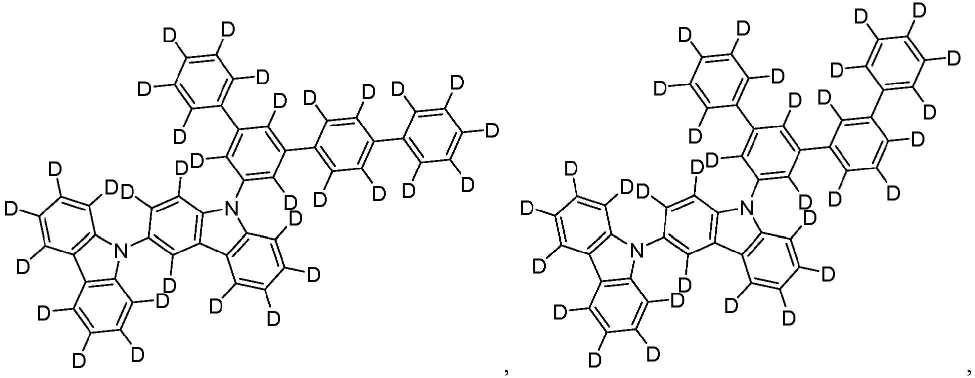

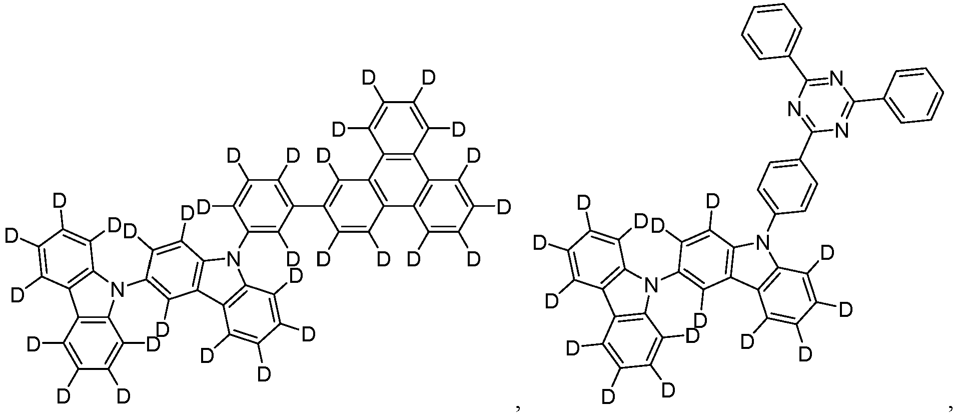

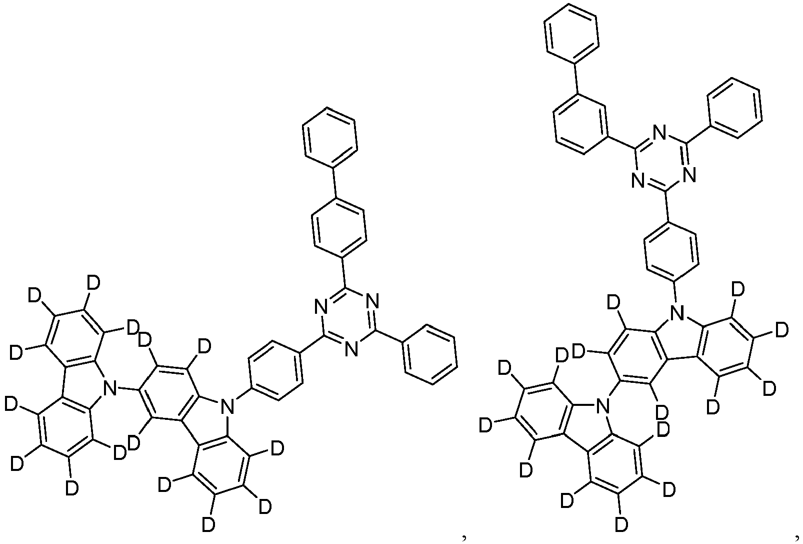

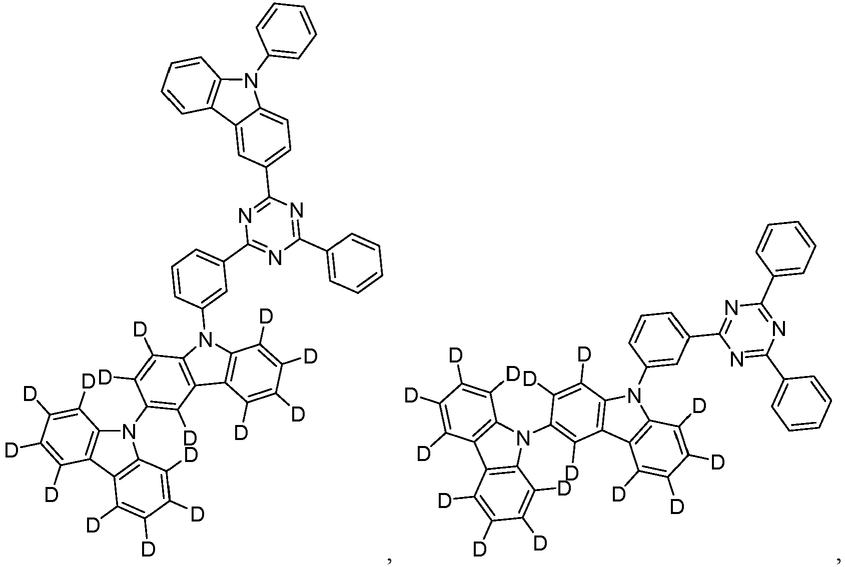

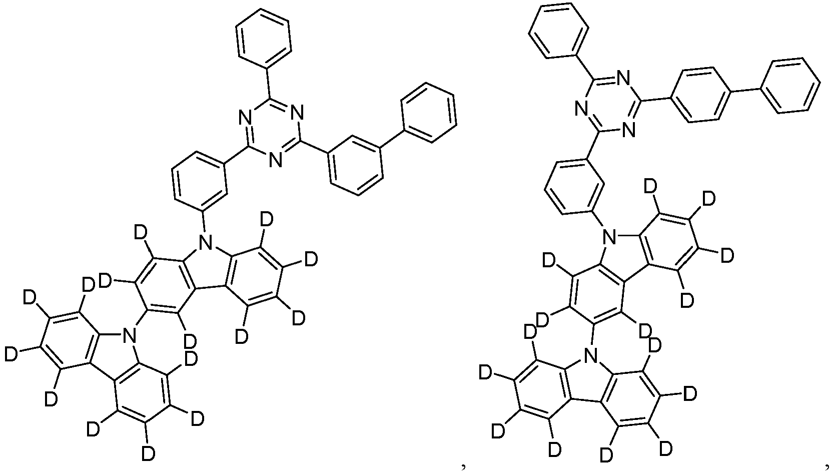

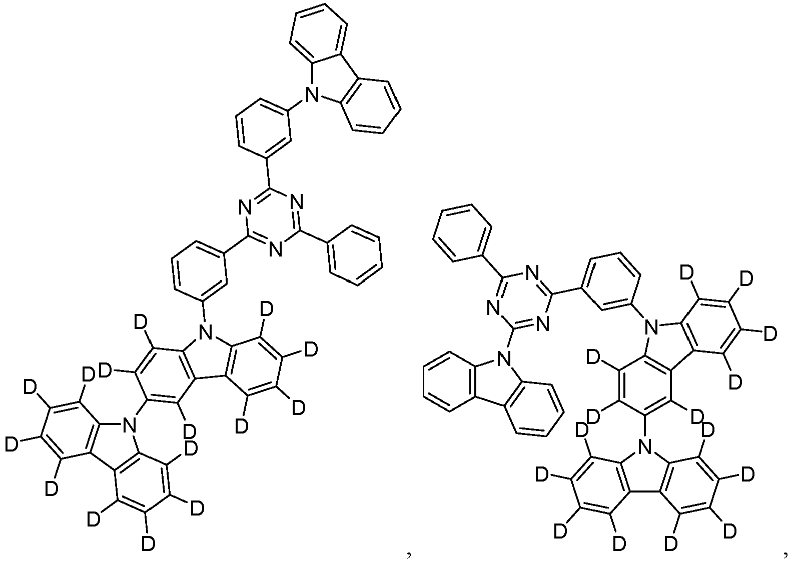

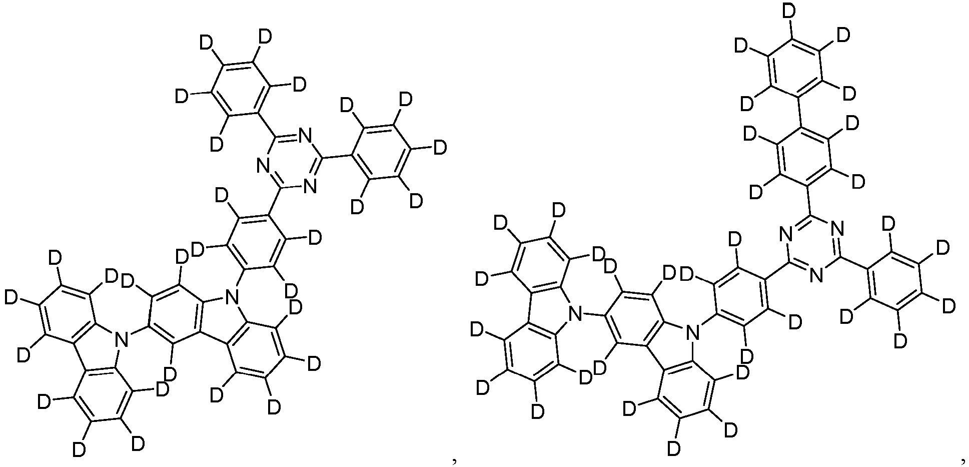

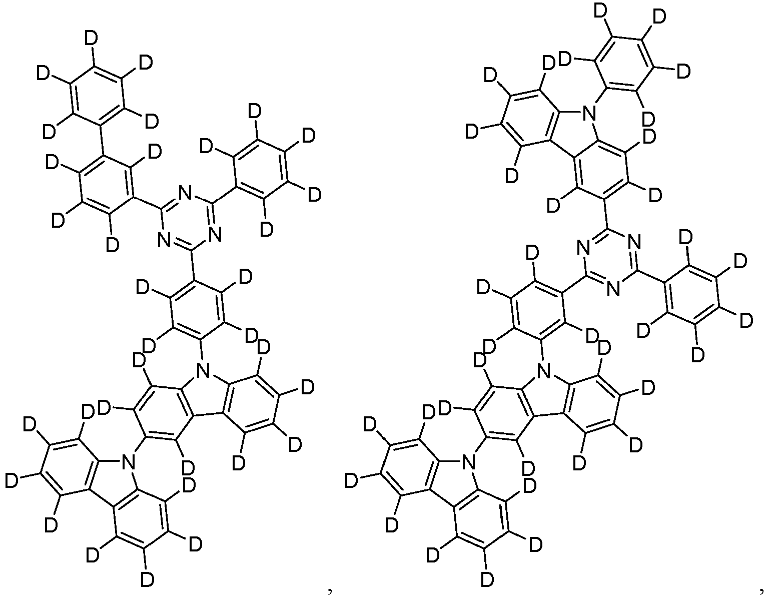

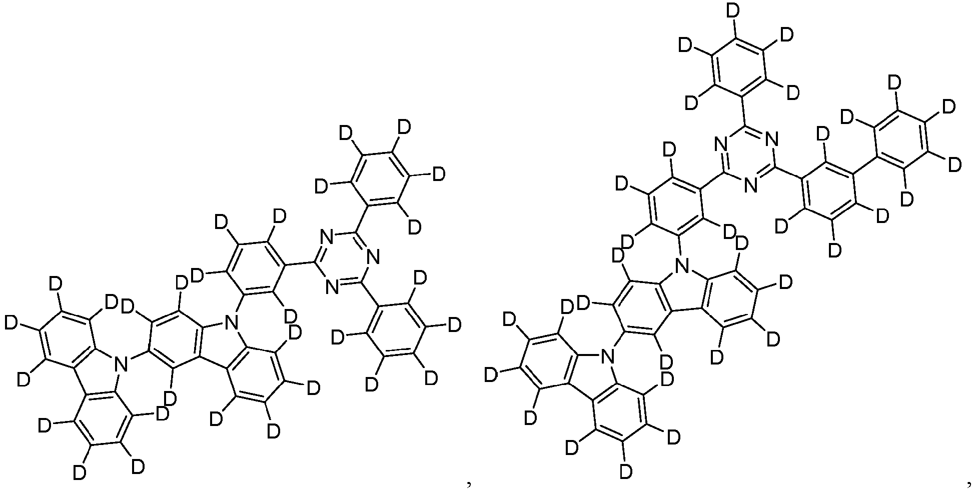

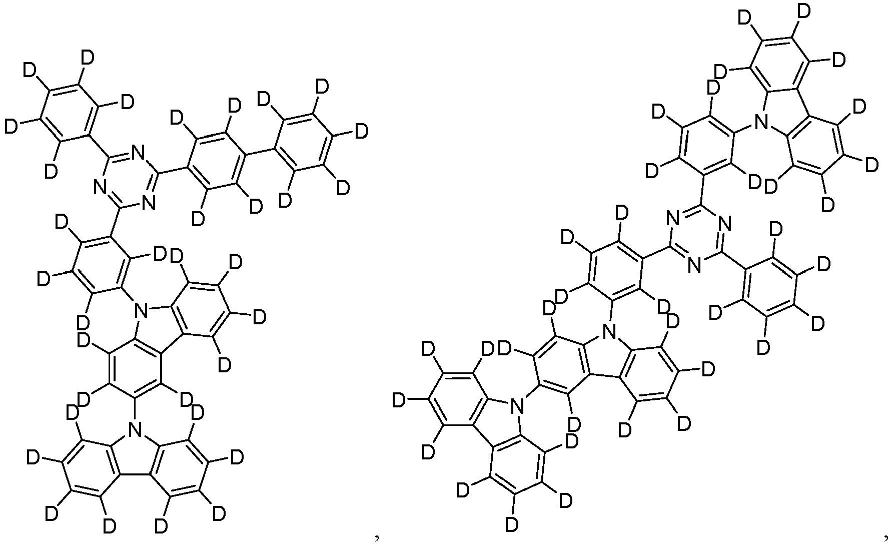

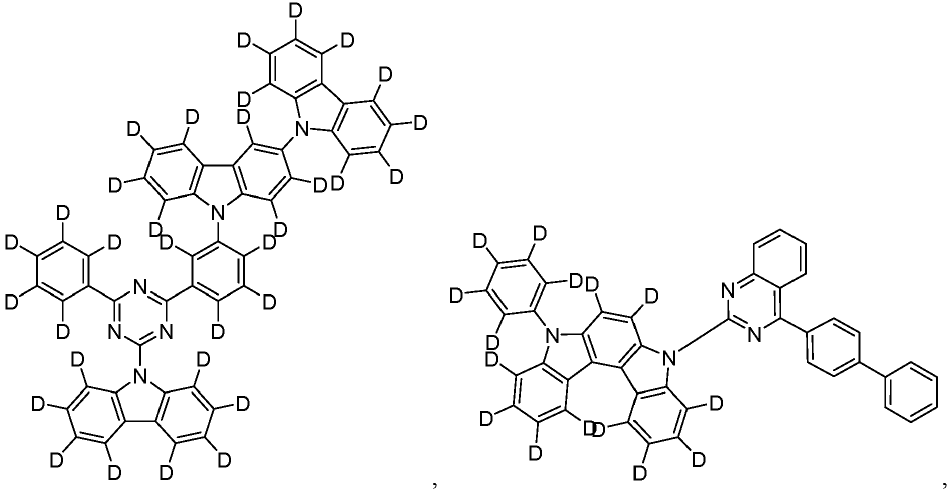

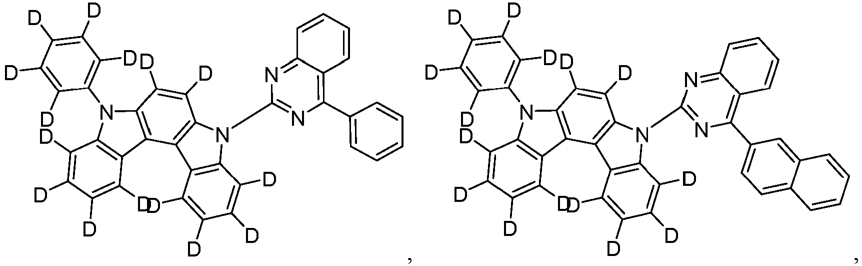

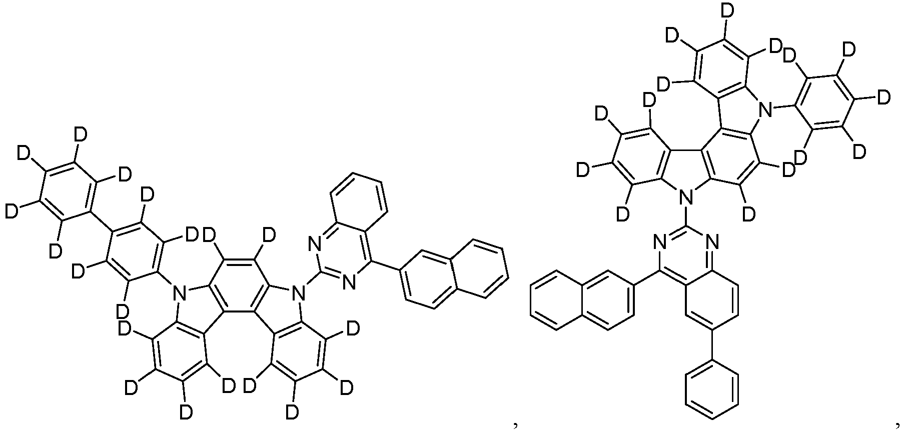

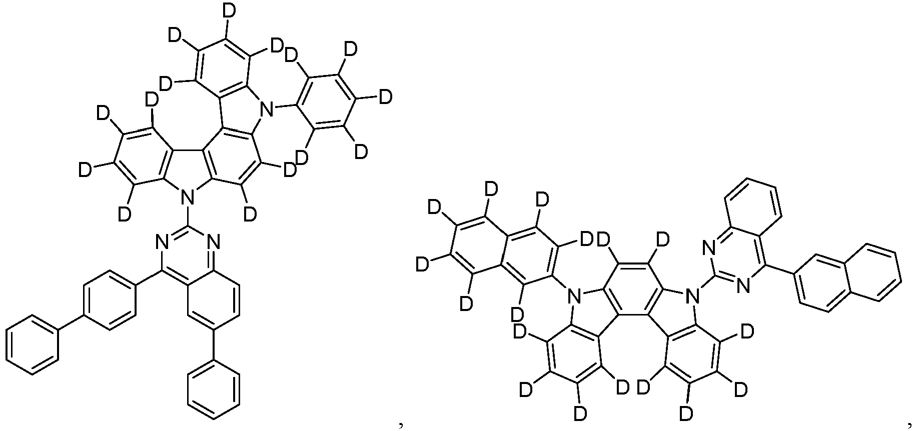

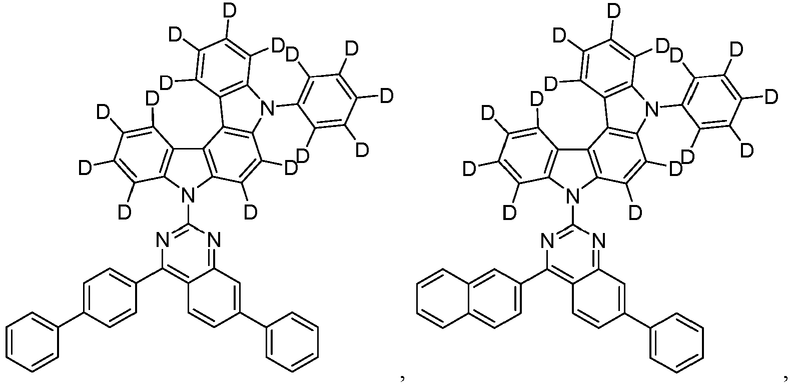

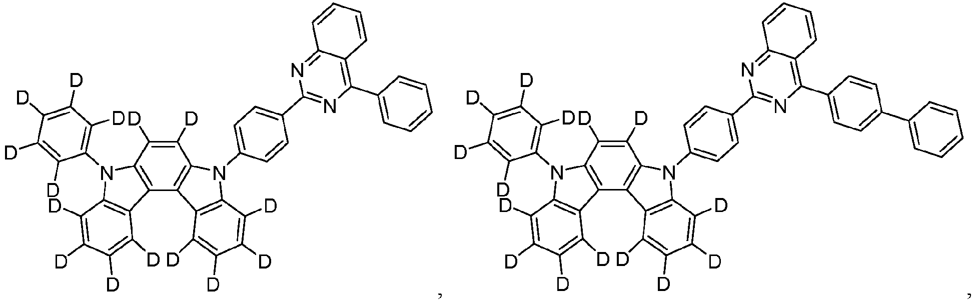

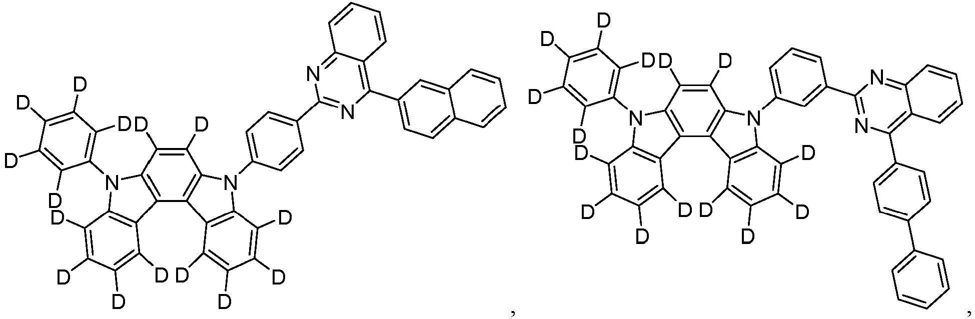

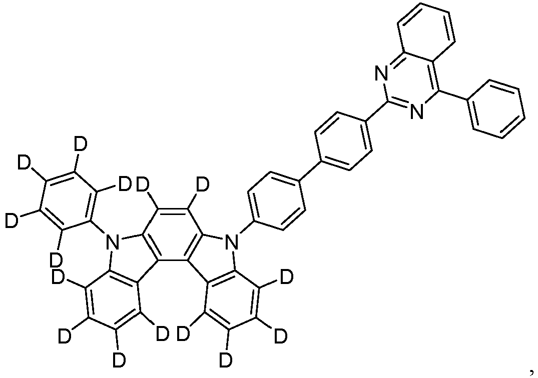

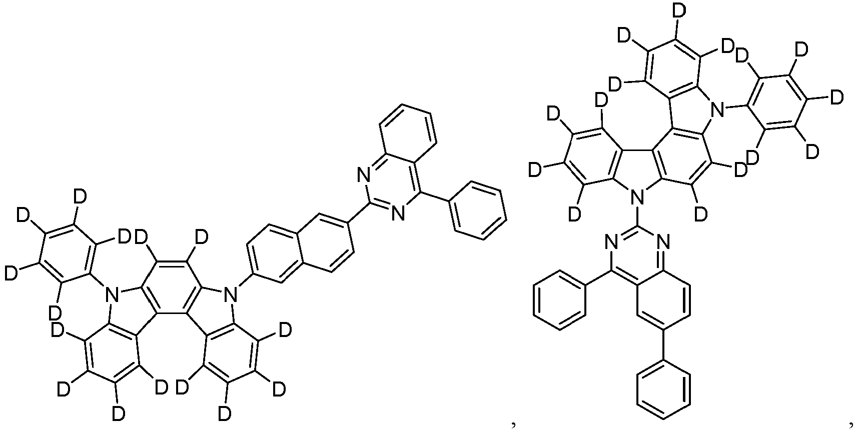

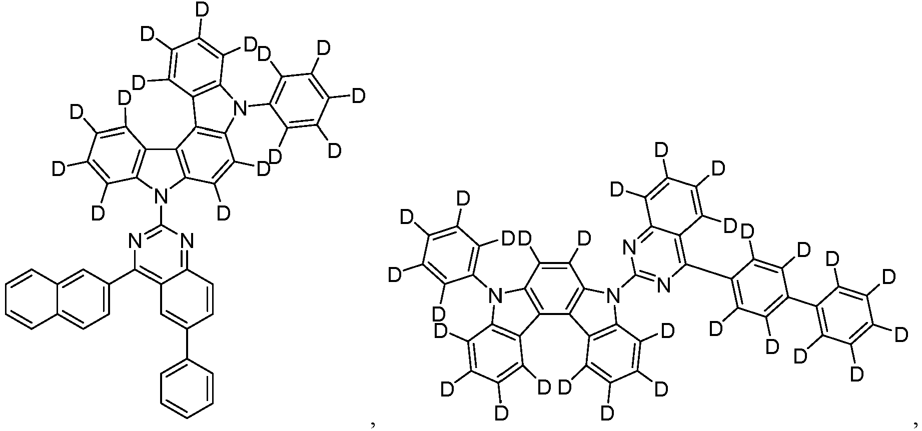

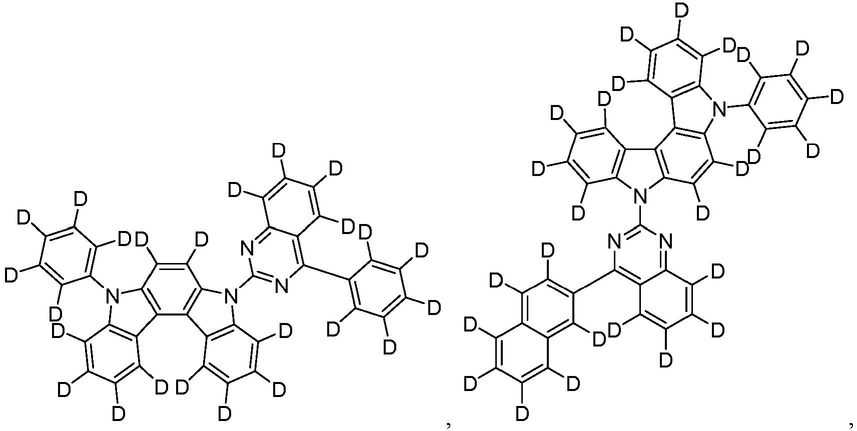

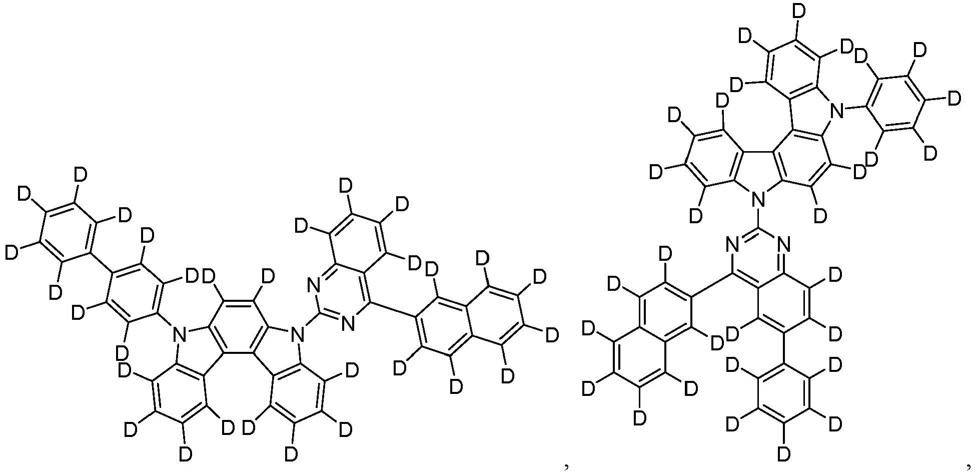

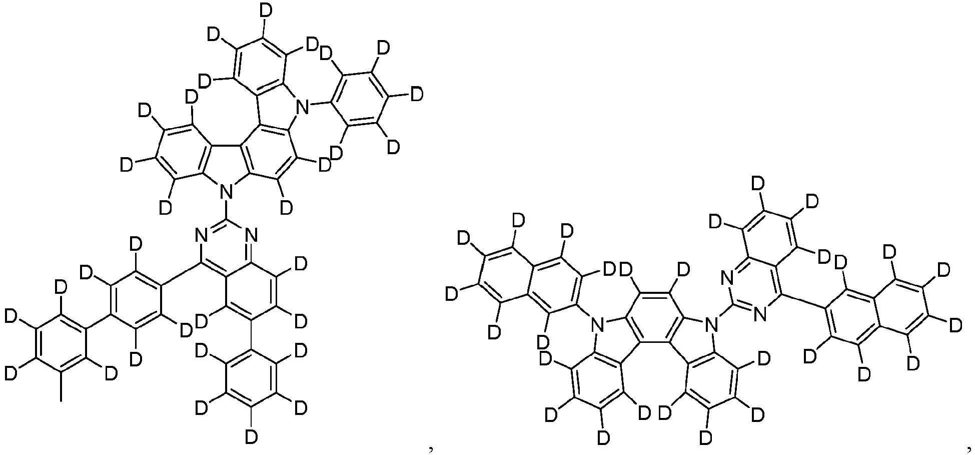

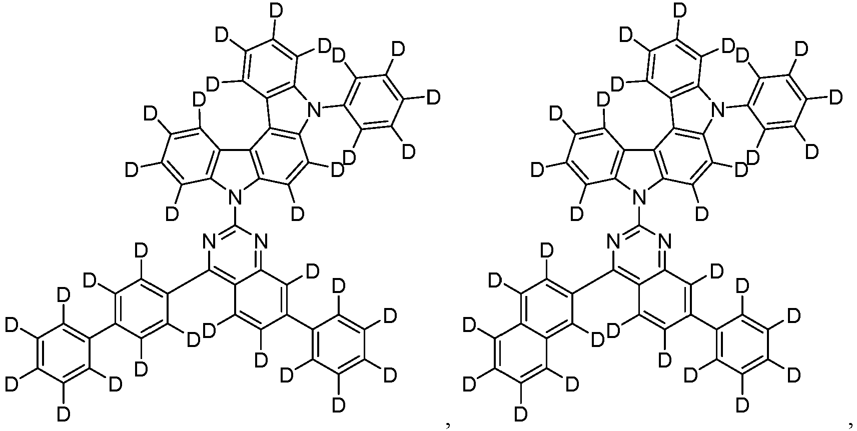

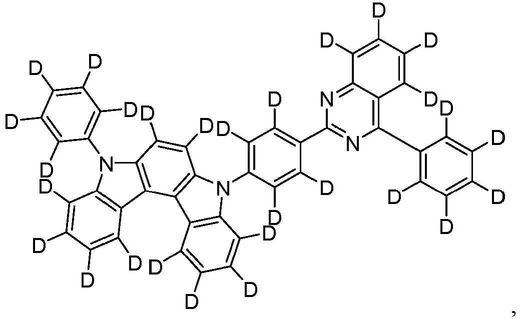

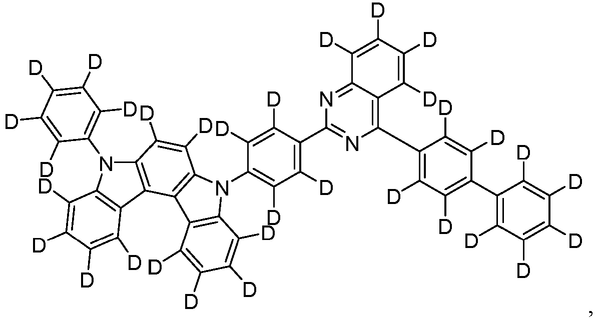

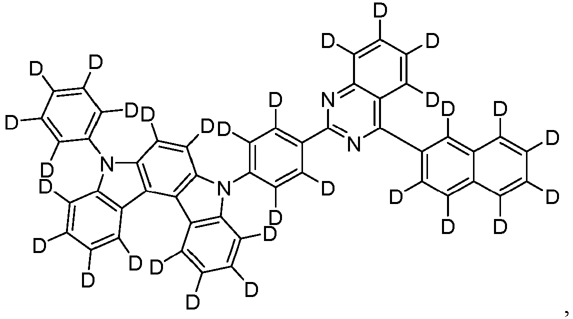

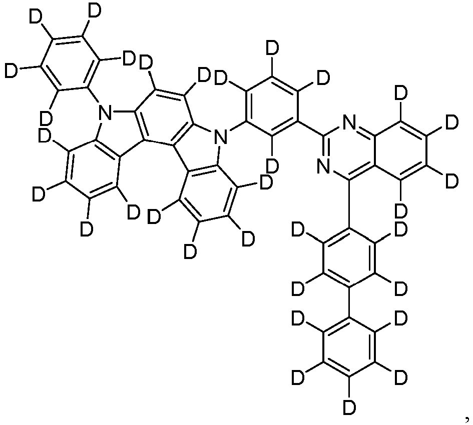

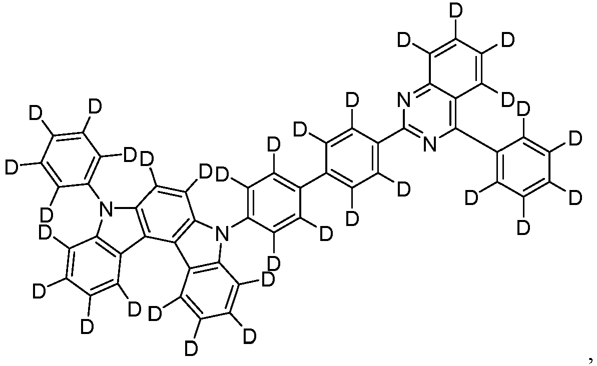

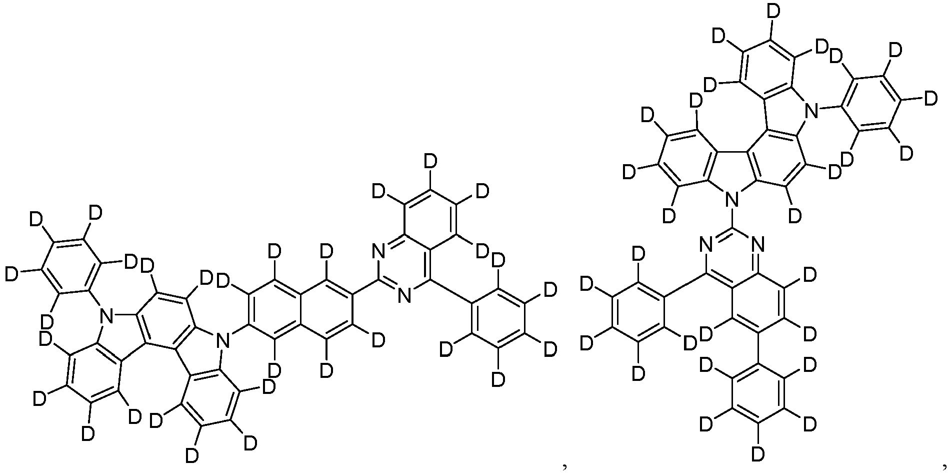

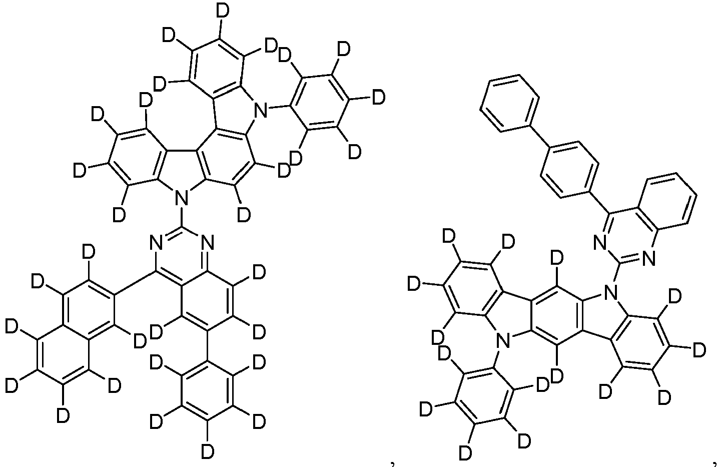

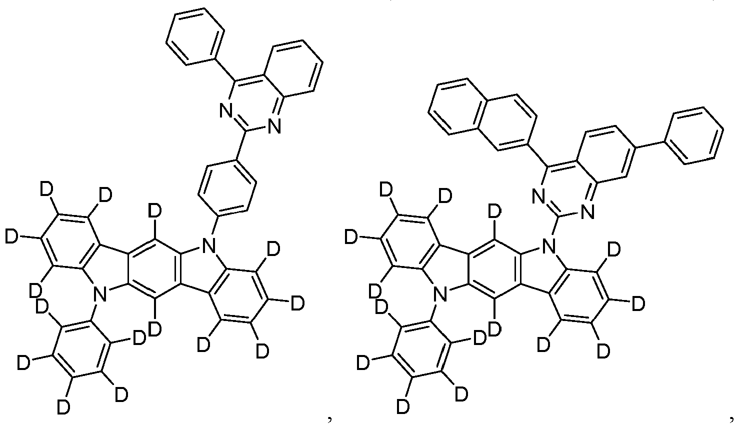

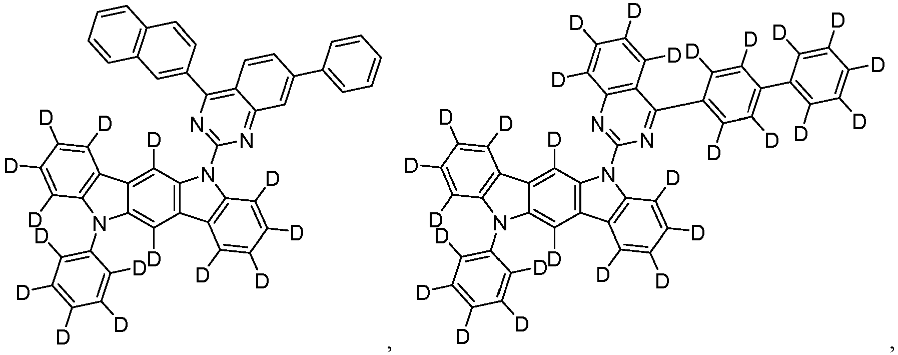

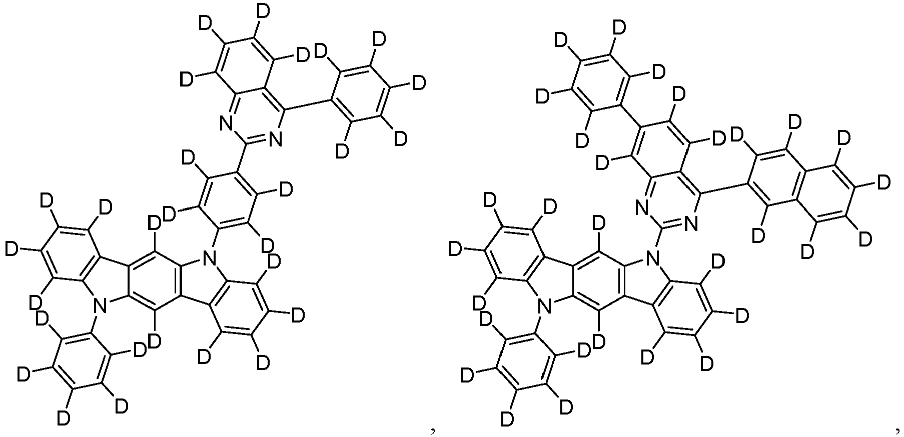

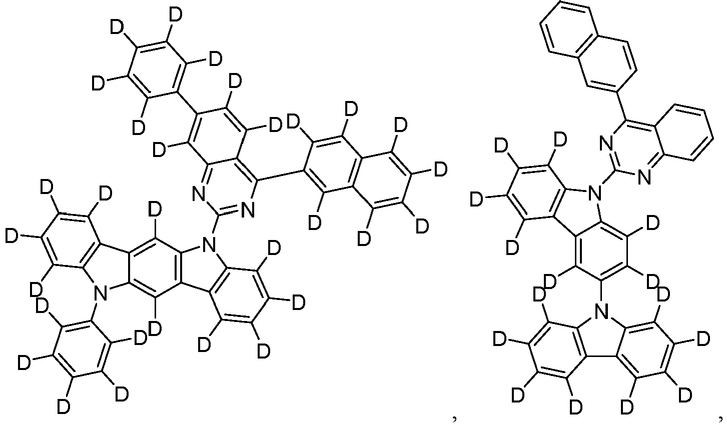

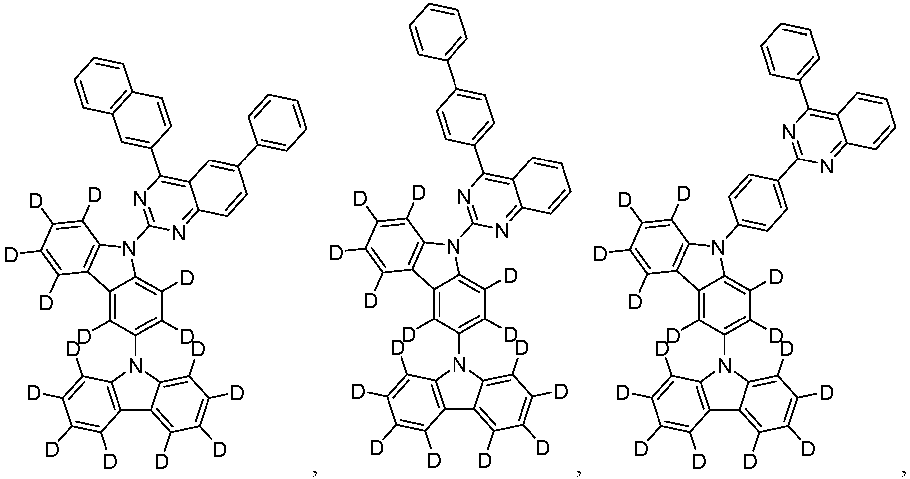

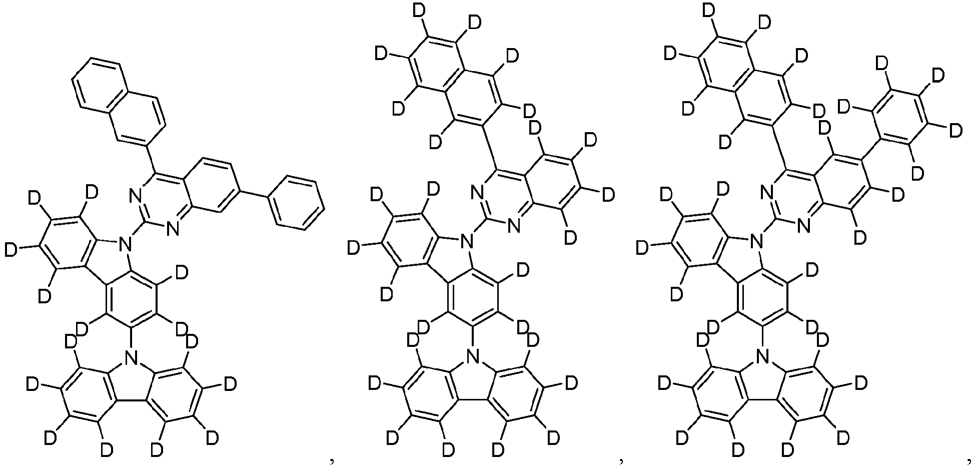

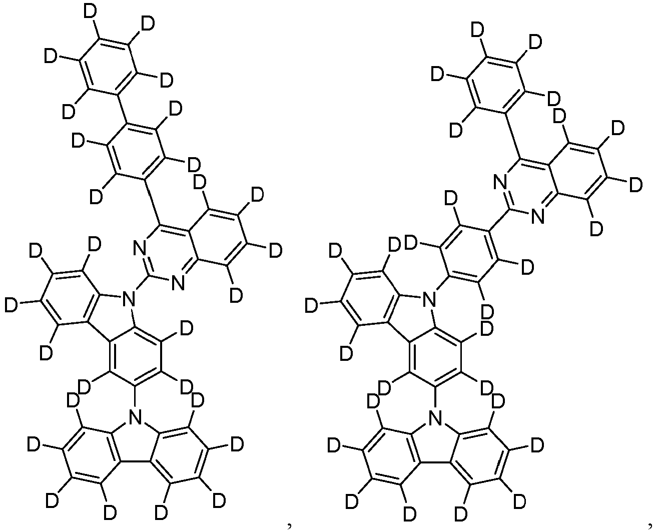

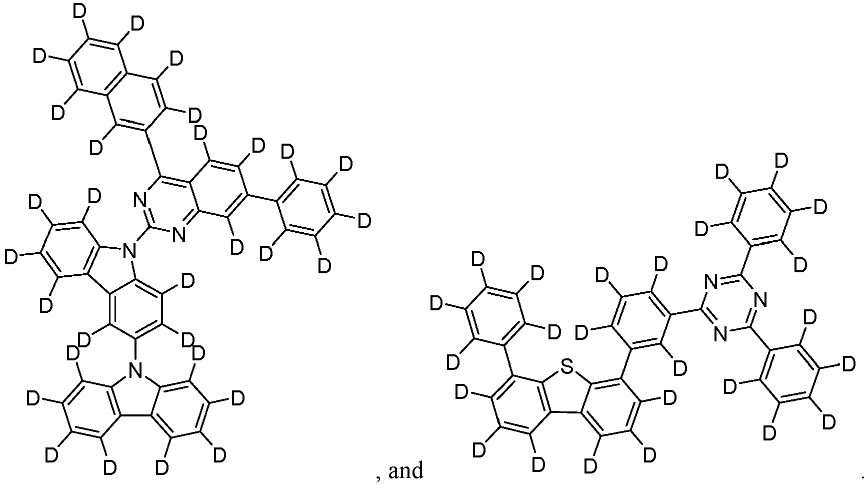

In some embodiments of both aspects, the metal complex has a ligand L_{A} comprising a moiety selected from the group consisting of: 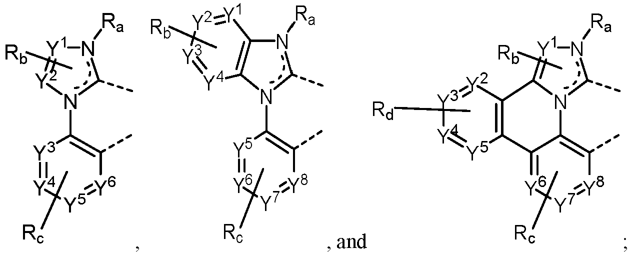 wherein:
each of Y¹ to Y⁸ is independently C or N;
each of R^{b}, R^{c}, and R^{d} independently represents mono-, up to the maximum substitutions, or no substitutions;
each R^{a}, R^{b}, R^{c}, and R^{d} is independently a hydrogen or a substituent selected from the group consisting of the General Substituents defined herein.

In some embodiments of both aspects, at least one R^{a}, R^{b}, R^{c}, and R^{d} comprises deuterium.

In some embodiments of both aspects, the metal complex has a structure M(L_{A})ₚ(L_{B})_{q}(L_{C})ᵣ, wherein p is 1, 2, or 3; q is 0, 1, or 2; r is 0, 1, or 2; and p+q+r is the oxidation state of the metal M; and each of ligand L_{B} and ligand L_{C} is independently selected from the group consisting of the structures in the following LIST 3: 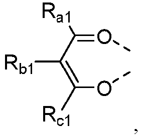 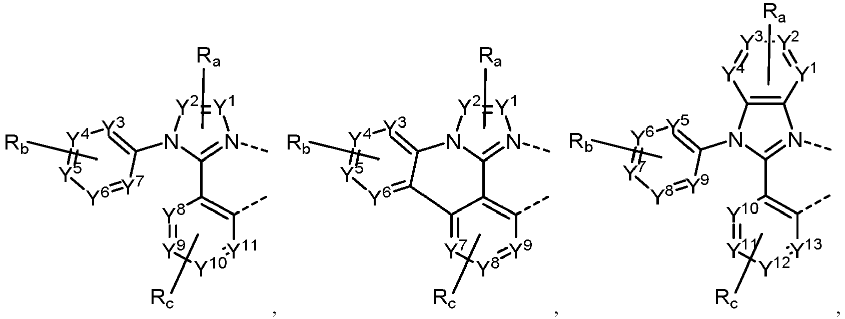 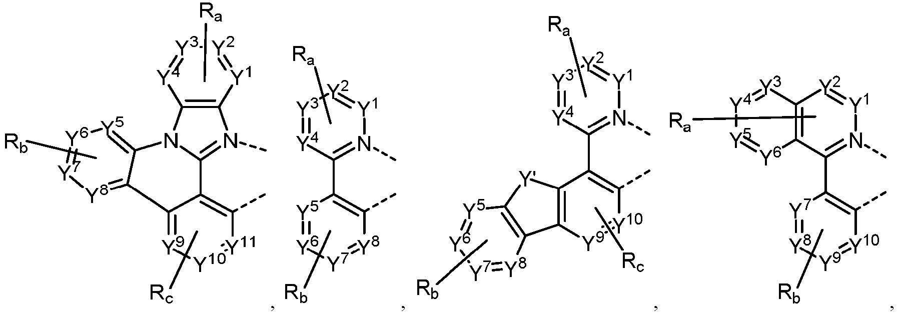 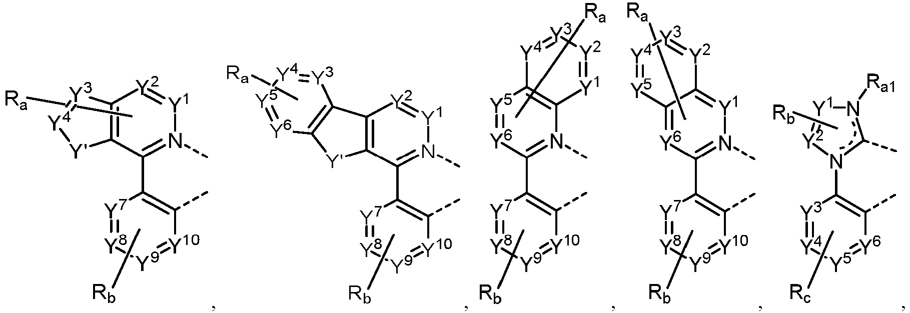 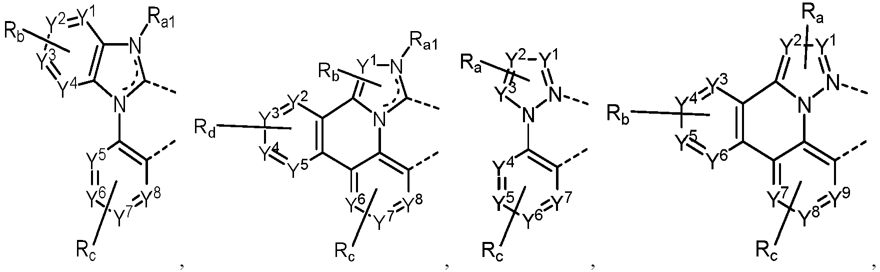 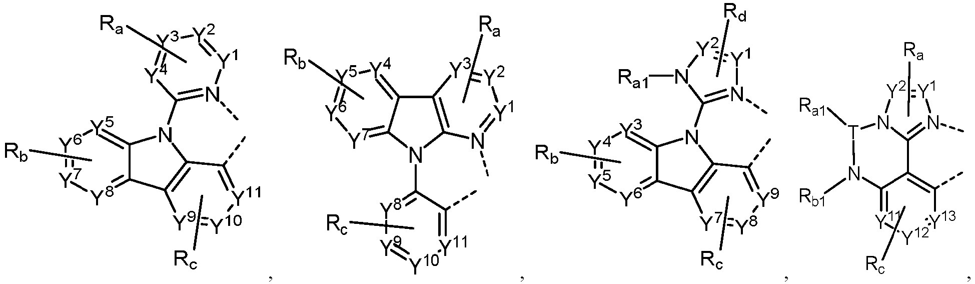 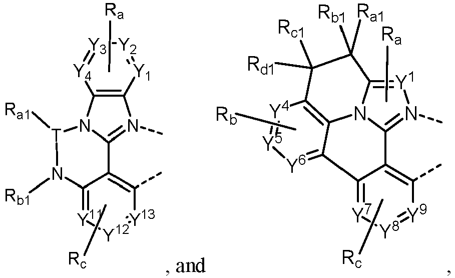 wherein:
T is selected from the group consisting of B, Al, Ga, and In;
each of Y¹ to Y¹³ is independently selected from the group consisting of carbon and nitrogen;
Y' is selected from the group consisting of BRₑ, NRₑ, PRₑ, O, S, Se, C=O, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents zero, mono, or up to a maximum allowed number of substitutions to its associated ring;
each of Rₐ₁, R_{b1}, R_{c1}, R_{d1}, Rₐ, R_{b}, R_{c}, R_{d}, Rₑ and R_{f} is independently a hydrogen or a substituent selected from the group consisting of the General Substituents defined herein; and
any two adjacent Rₐ, R_{b}, R_{c}, R_{d}, Rₑ and R_{f} can be fused or joined to form a ring or form a multidentate ligand.

In some embodiments of the second aspect, M is selected from the group consisting of Ir, Pt, Os, Pd, Ag, Au, and Cu.

In some embodiments of both aspects, each of ligand L_{B} and ligand L_{C} is independently selected from the group consisting of the structures in the following LIST 4: 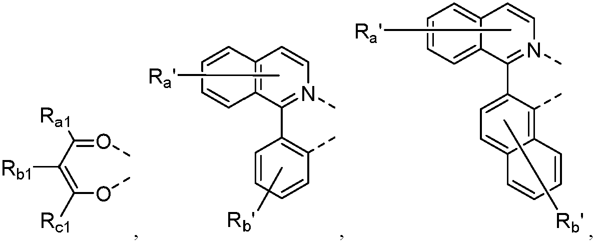 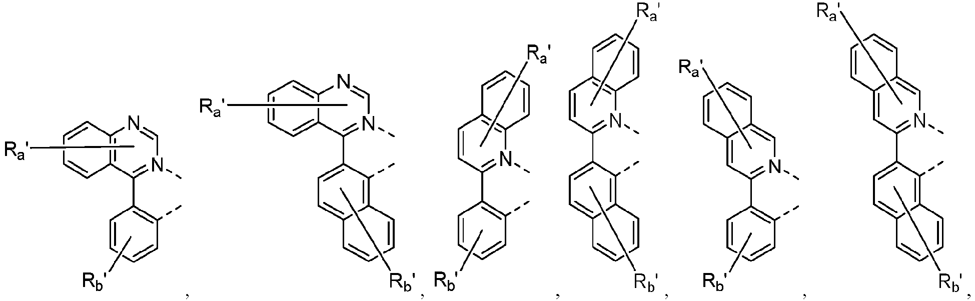 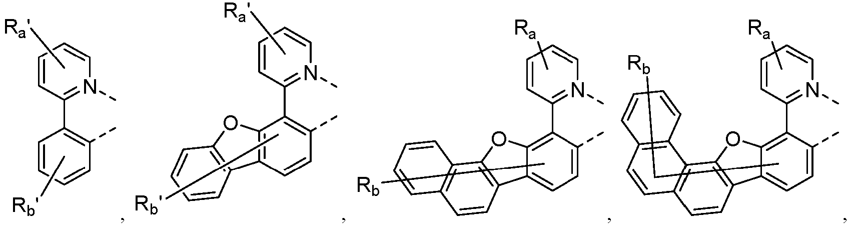 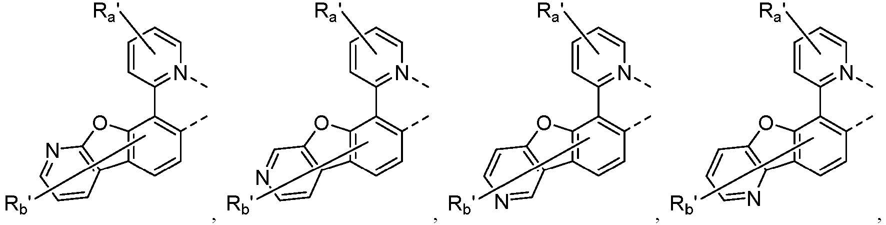 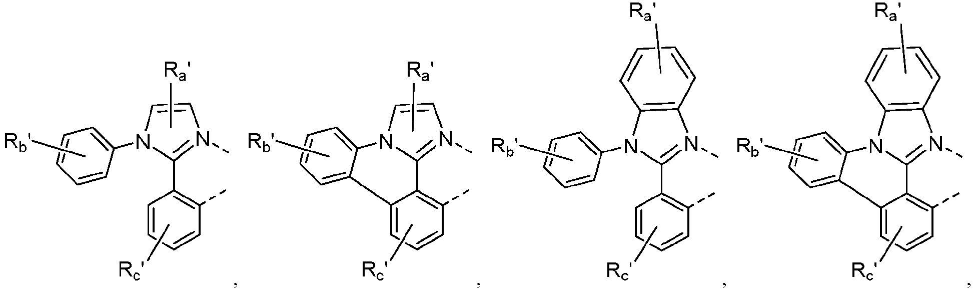 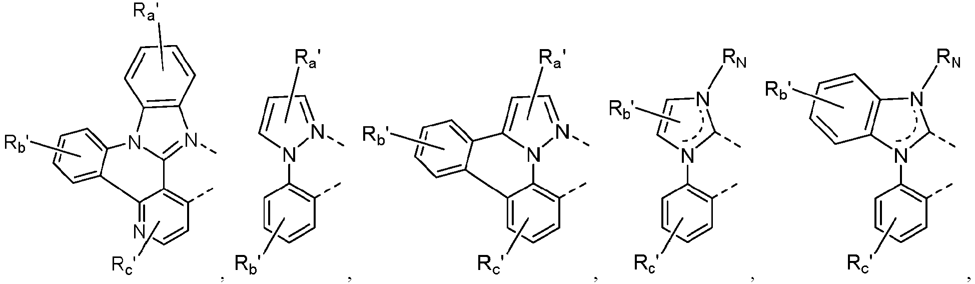 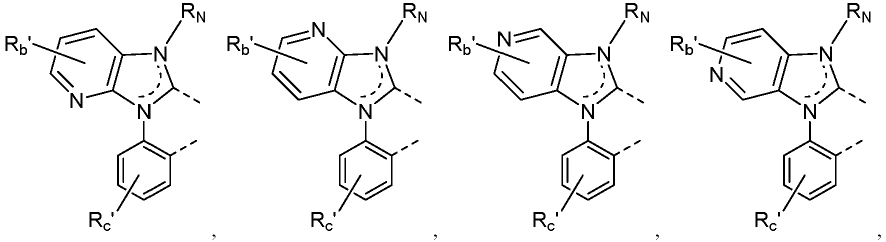 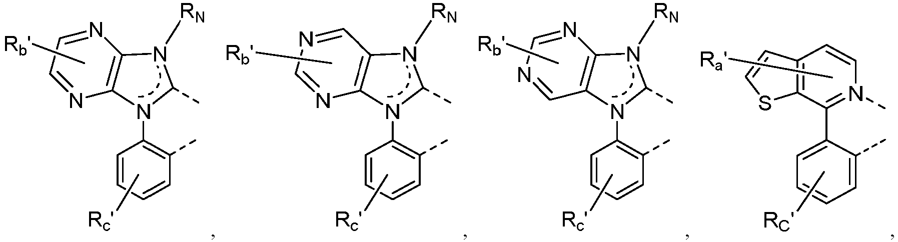 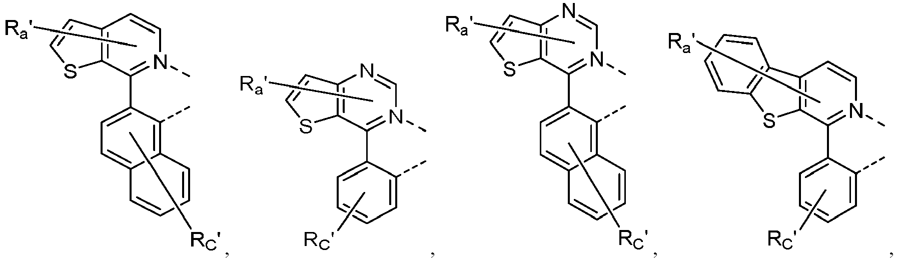 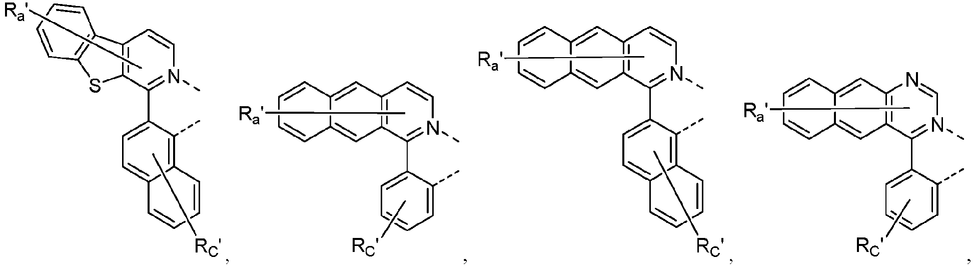 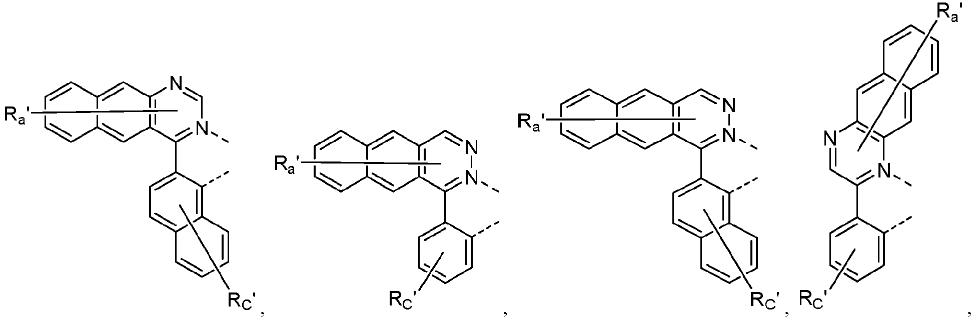 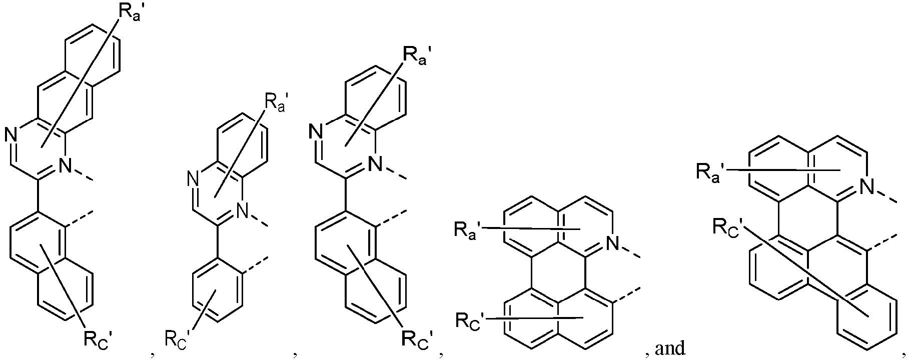 wherein:
Rₐ', R_{b}', and R_{c}' each independently represent zero, mono, or up to a maximum allowed number of substitutions to its associated ring;
each of Rₐ₁, R_{b1}, R_{c1}, Rₐ, R_{b}, R_{c}, R_{N}, Rₐ', R_{b}', and R_{c}' is independently hydrogen or a substituent selected from the group consisting of the General Substituents defined herein; and
two adjacent Rₐ', R_{b}', and R_{c}' can be fused or joined to form a ring or form a multidentate ligand.

In some embodiments of both aspects (any iridium complexes only apply to the second aspect), the metal complex is selected from the group consisting of the structures in the following LIST 5: 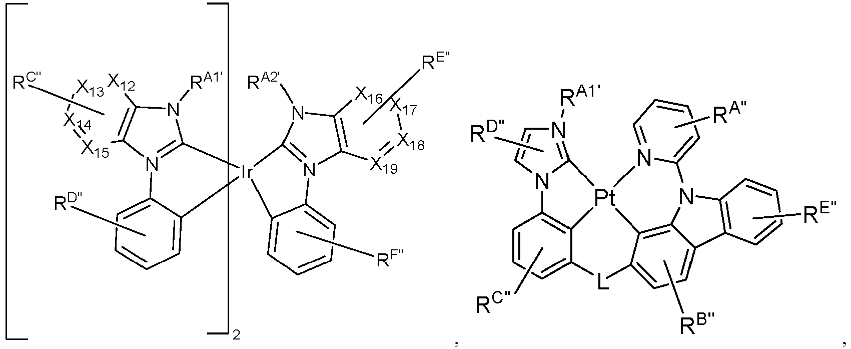 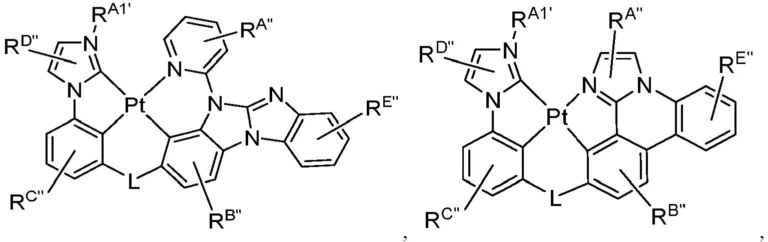 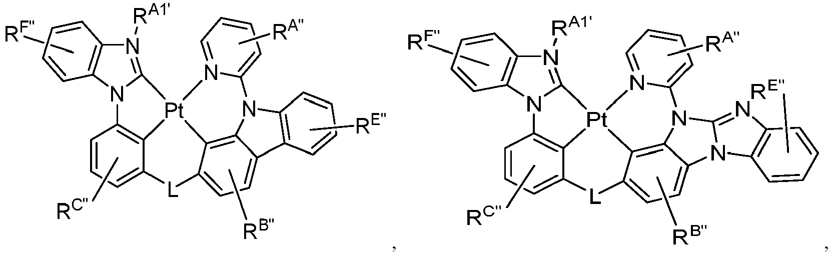 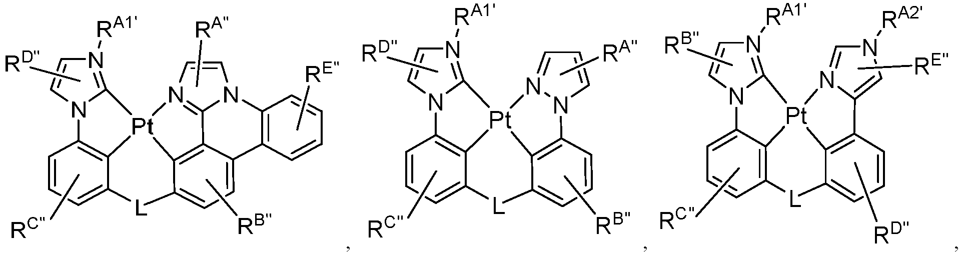 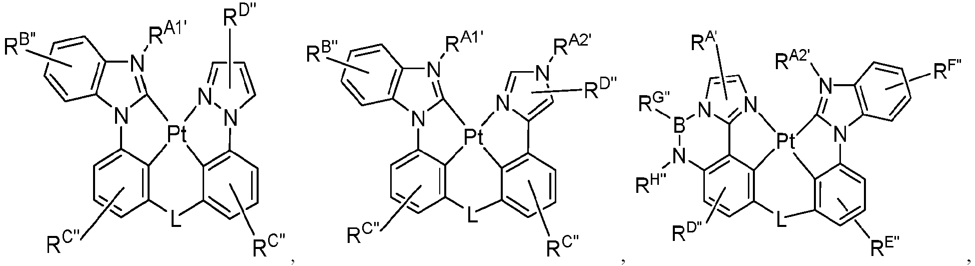 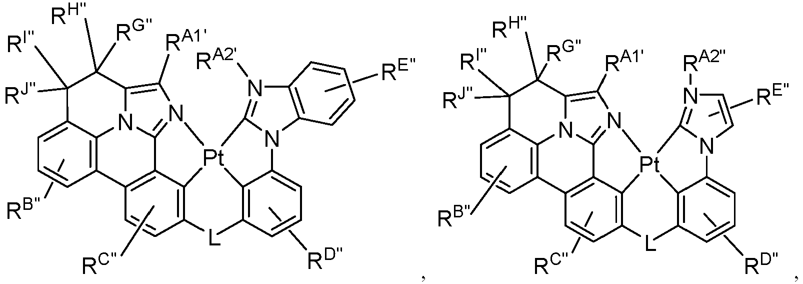 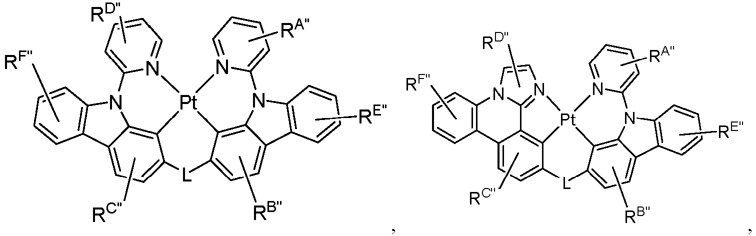 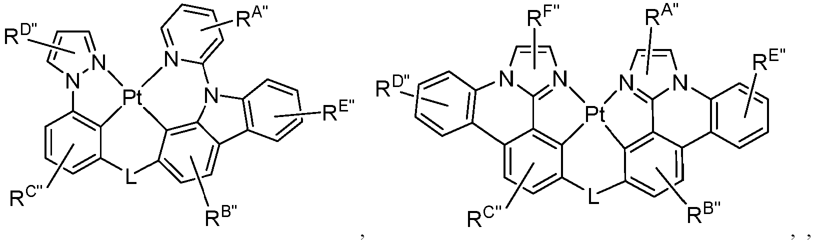 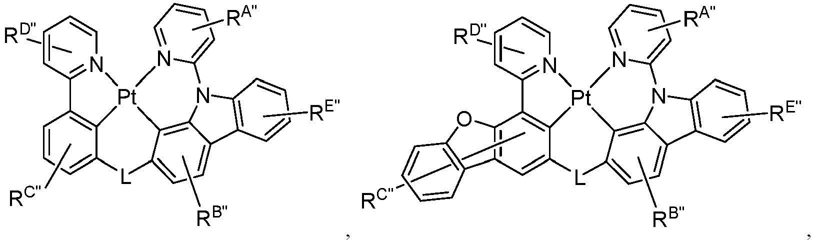 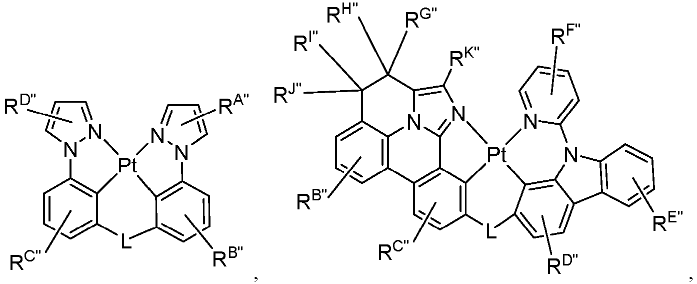 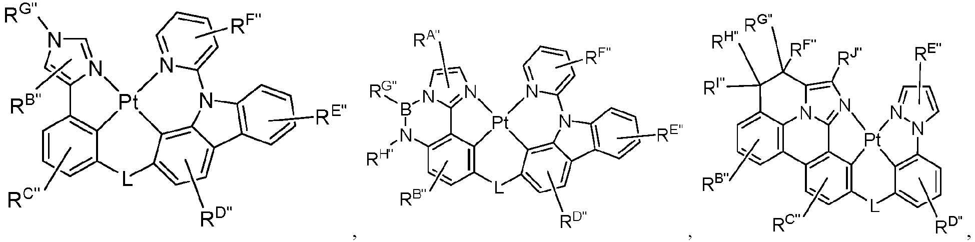 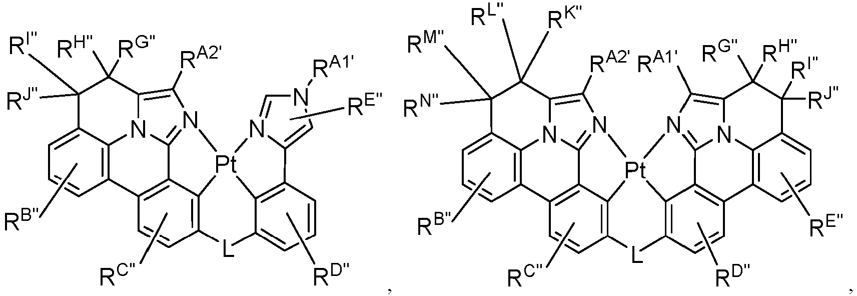 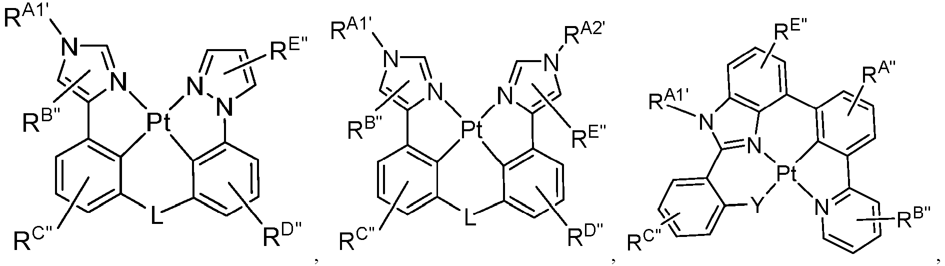 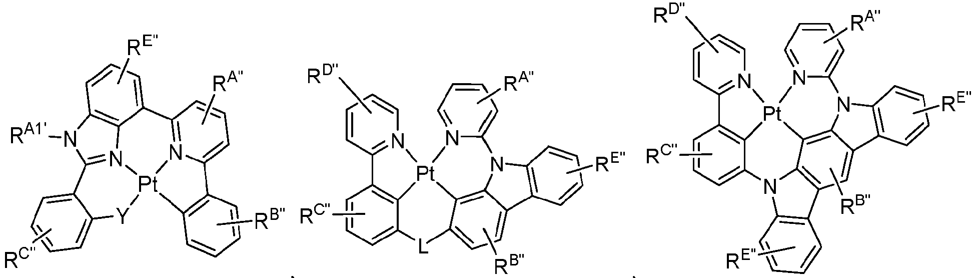 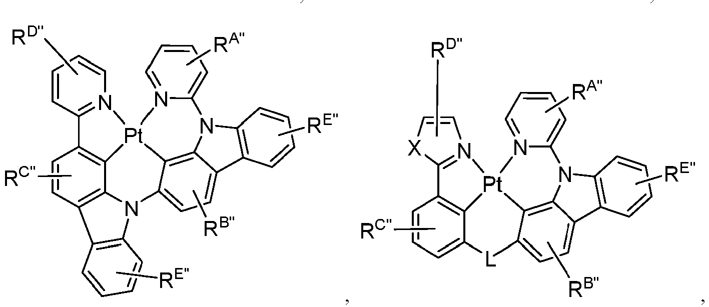 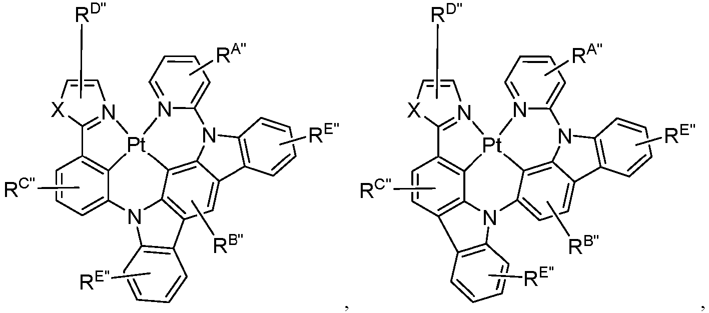 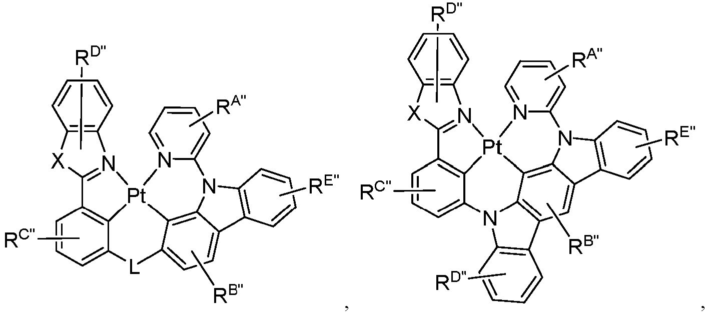 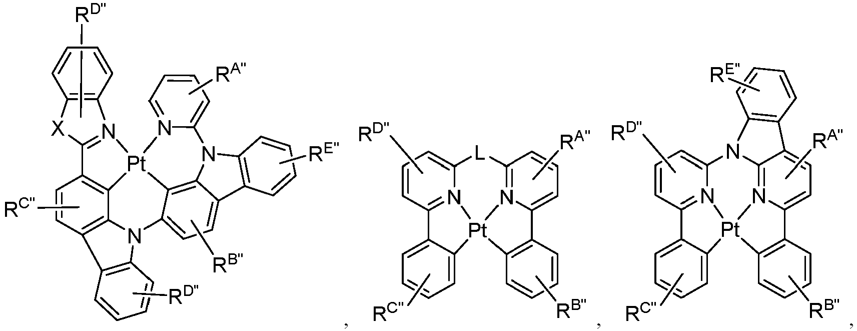 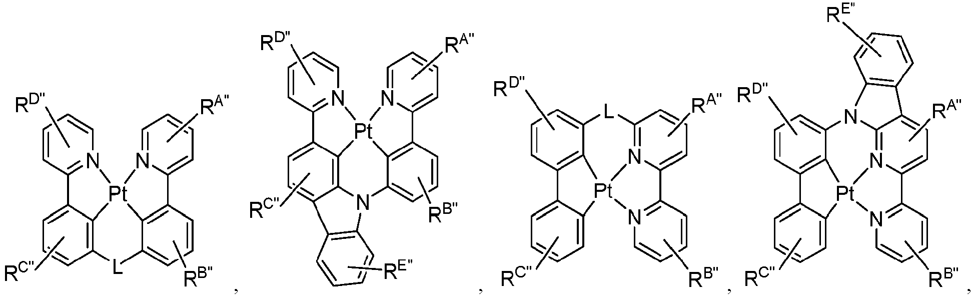 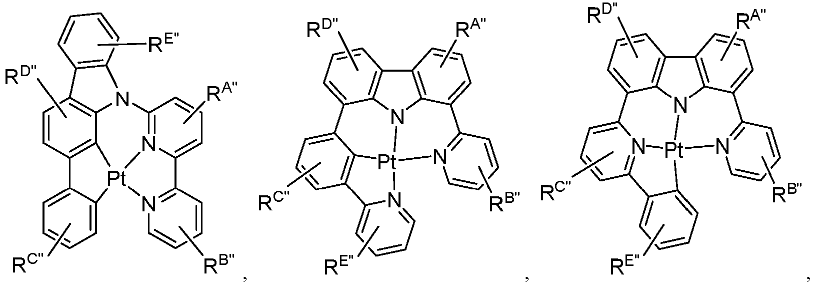 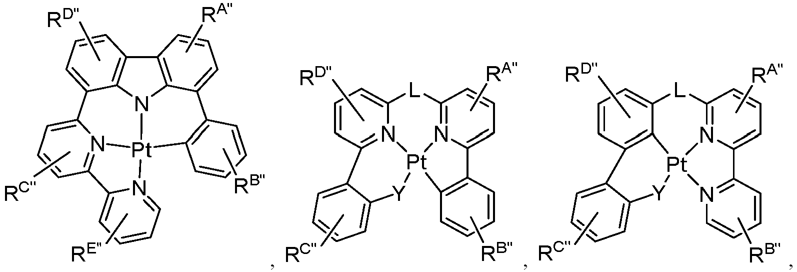 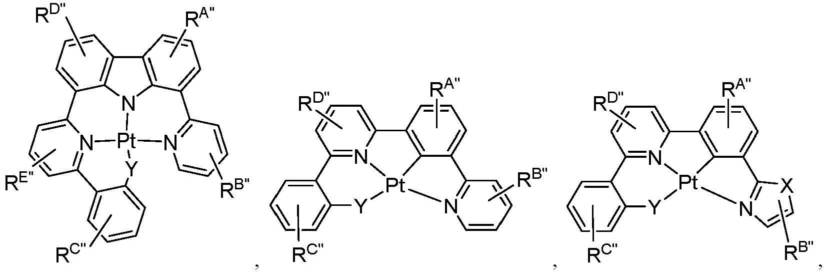 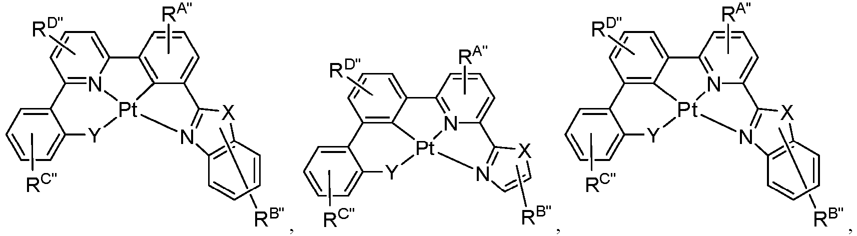 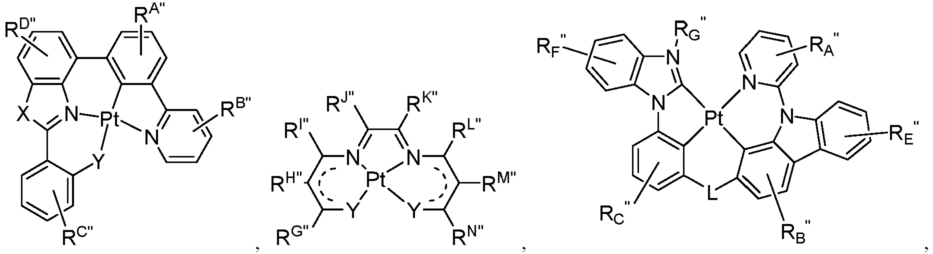 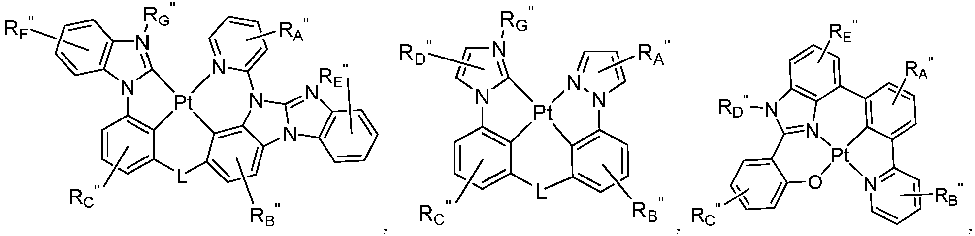 and 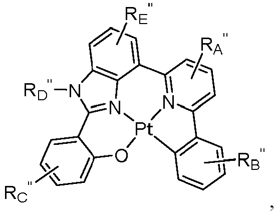 wherein:
each of X₁₂ to X₁₉ is independently C or N;
each Y is independently selected from the group consisting of a NR, O, S, and Se;
each L is independently selected from the group consisting of a direct bond, BR, BRR', NR, PR, O, S, Se, C=X', S=O, SO₂, CR, CRR', SiRR', GeRR', alkyl, cycloalkyl, aryl, heteroaryl, and combinations thereof;
each X and X' is independently selected from the group consisting of O, S, Se, NR", and CR"R"';
each of R, R', R", R‴, R^{A"}, R^{B"}, R^{C"}, R^{D"}, R^{E"}, and R^{F"} independently represents mono-, up to the maximum substitutions, or no substitutions;
each of R, R', R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the General Substituents defined herein.

In some embodiments of the first aspect, the metal carbene complex is selected from the group consisting of the structures in the following LIST 6:

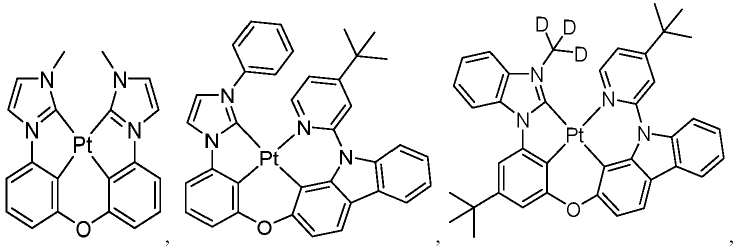

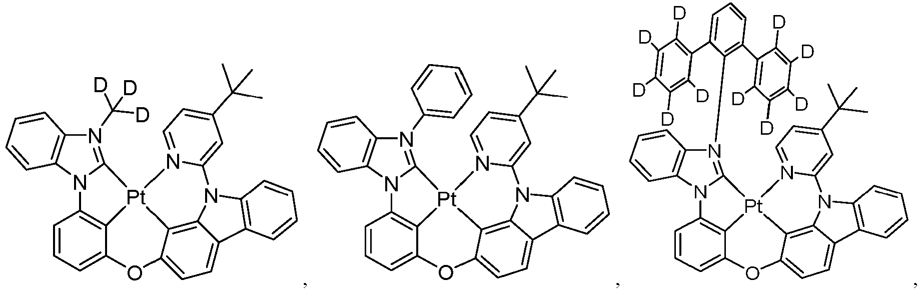

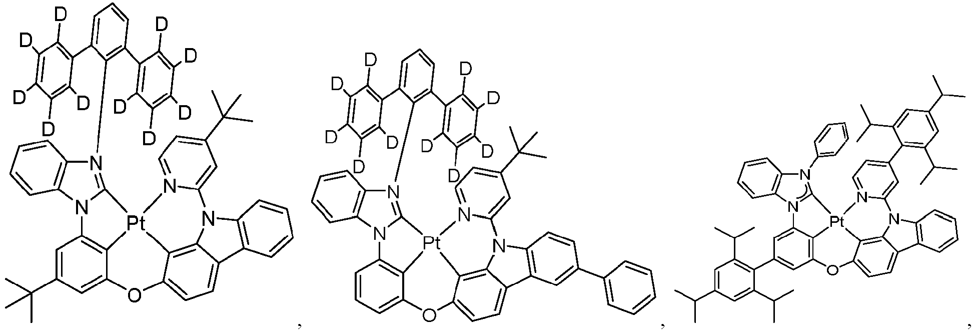

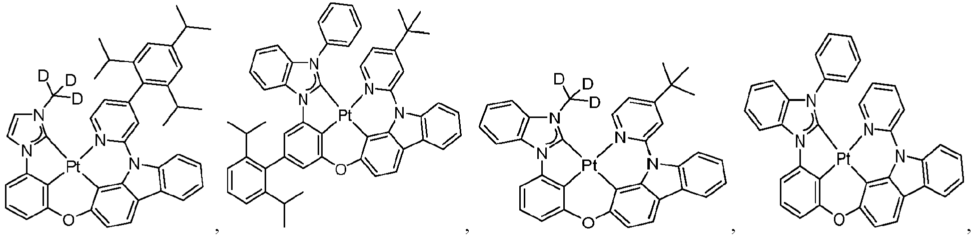

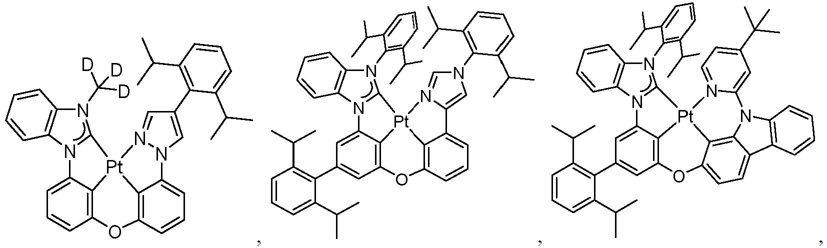

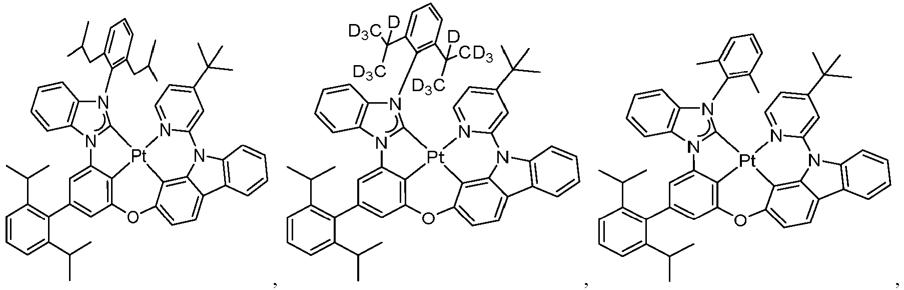

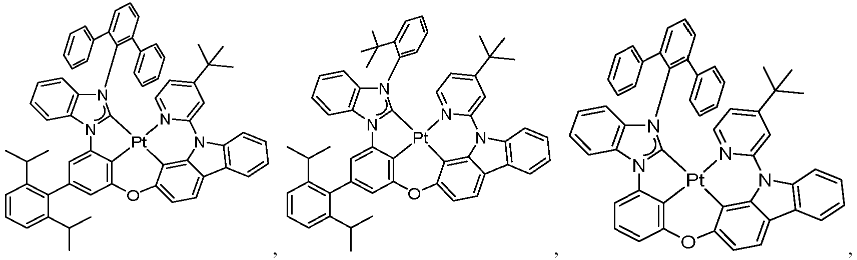

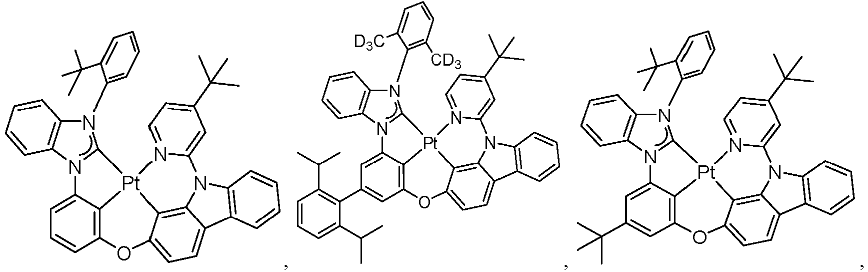

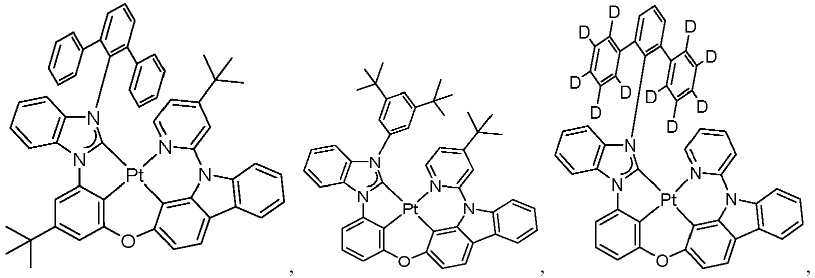

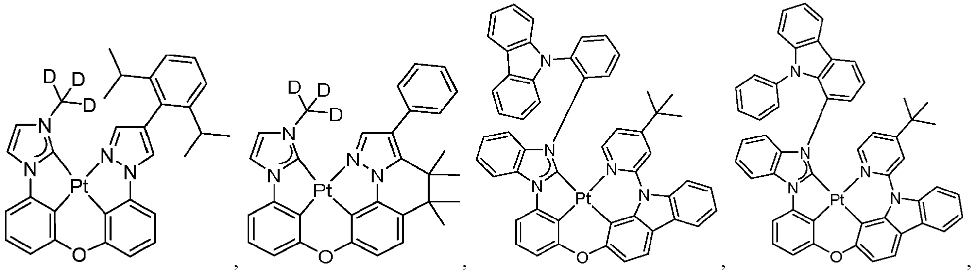

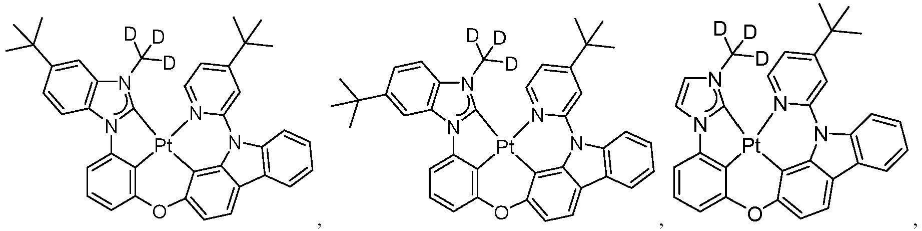

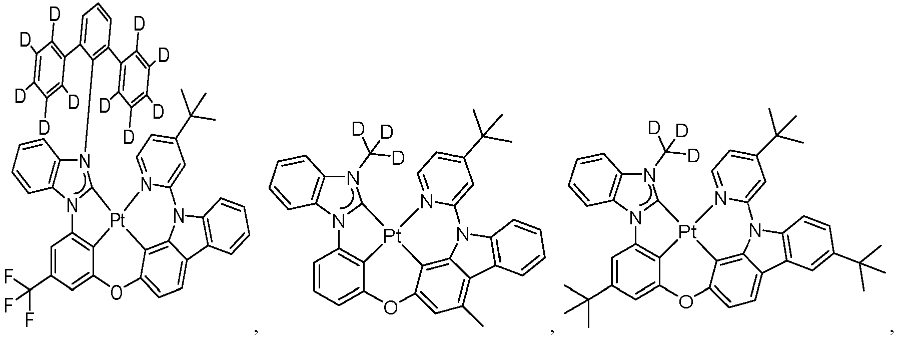

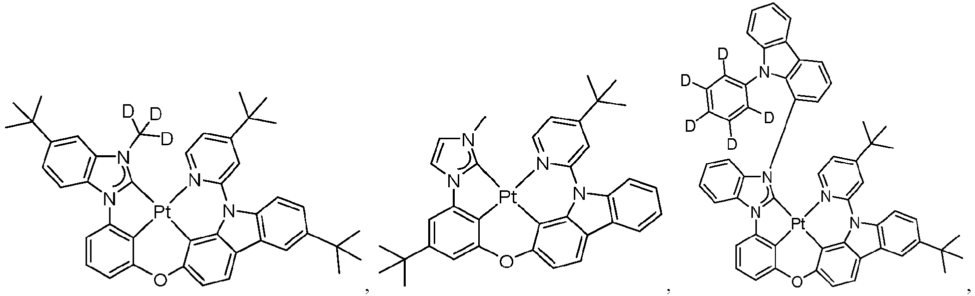

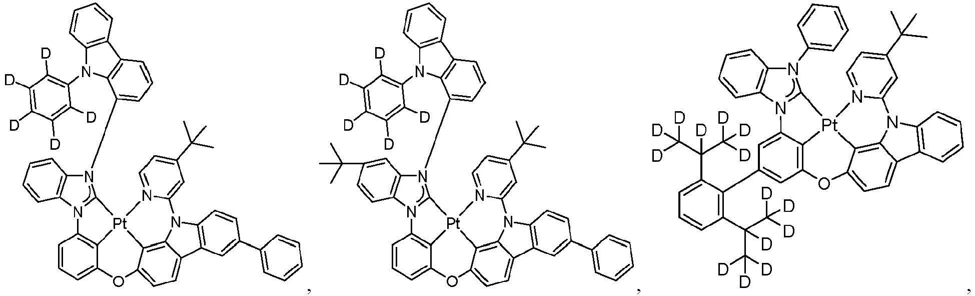

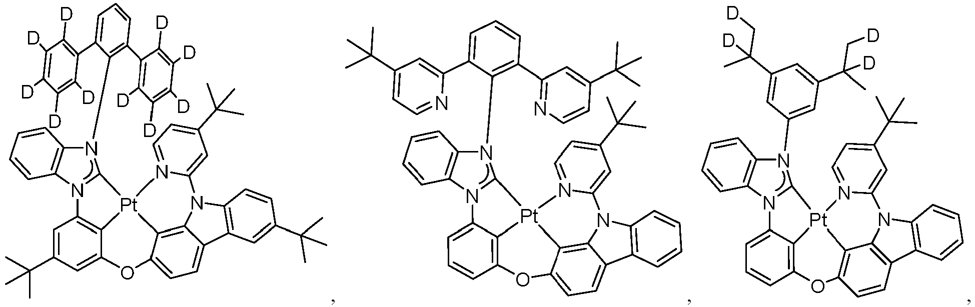

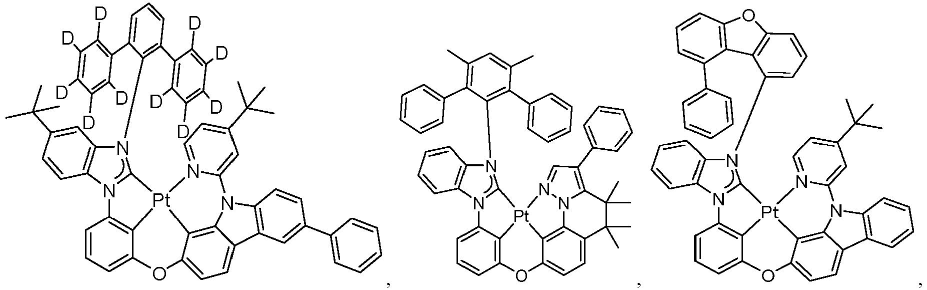

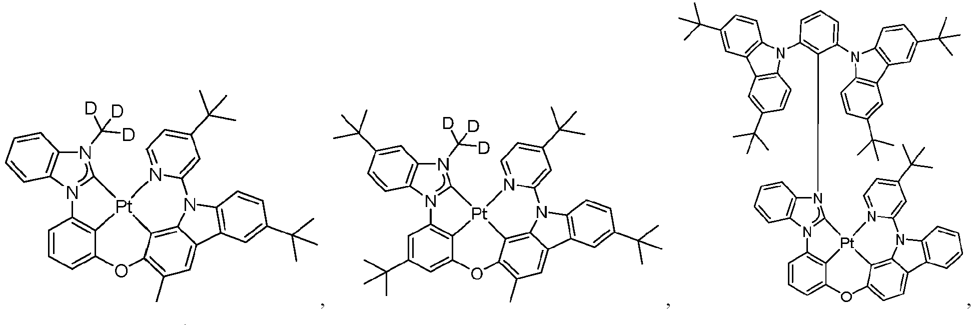

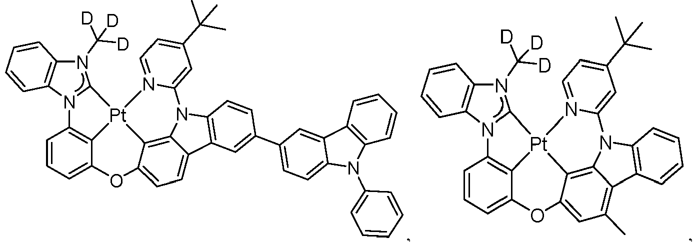

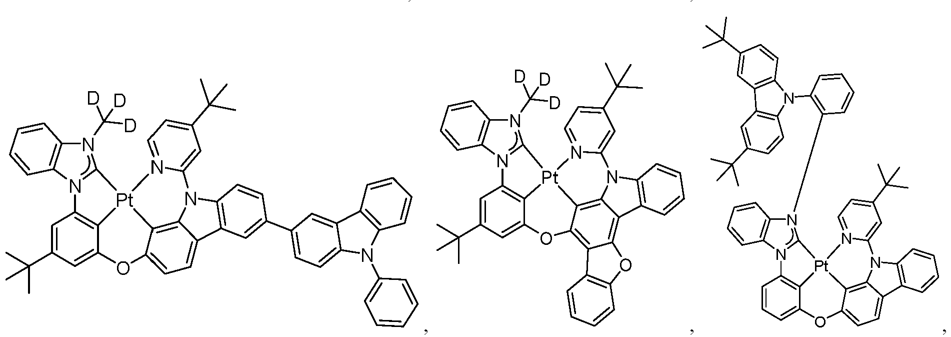

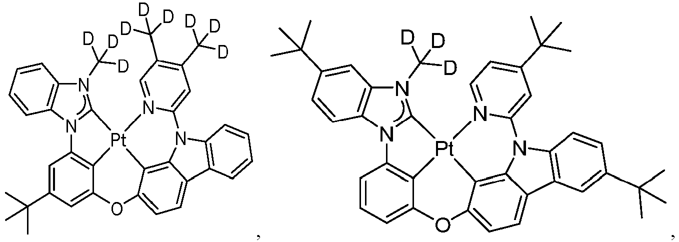

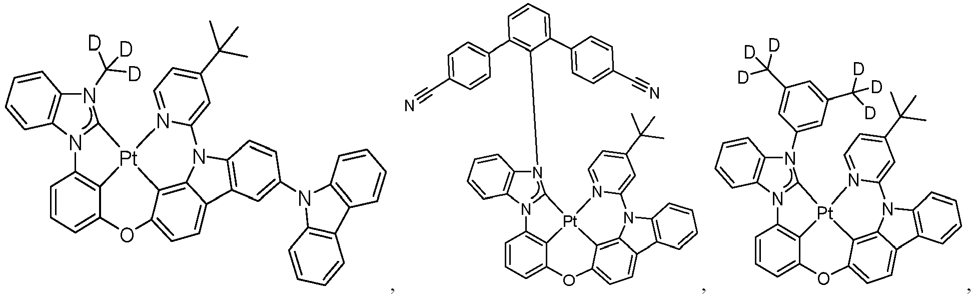

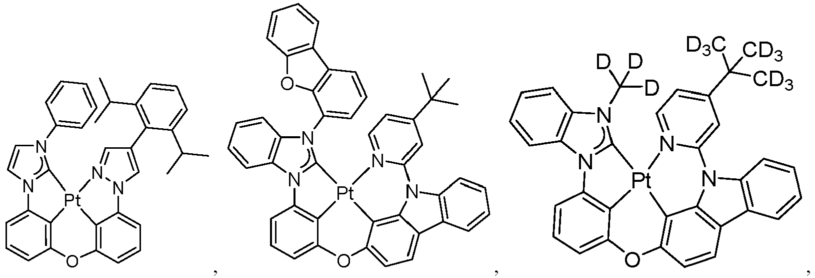

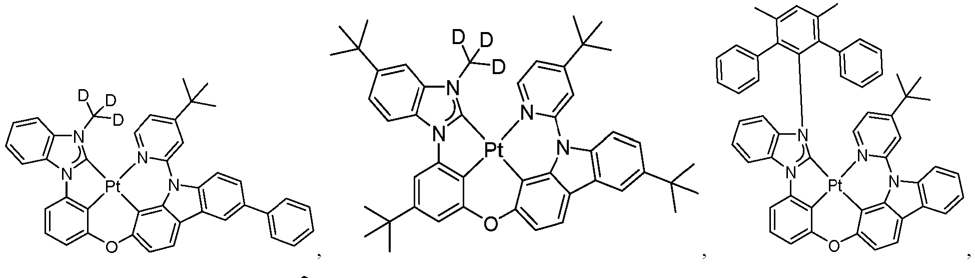

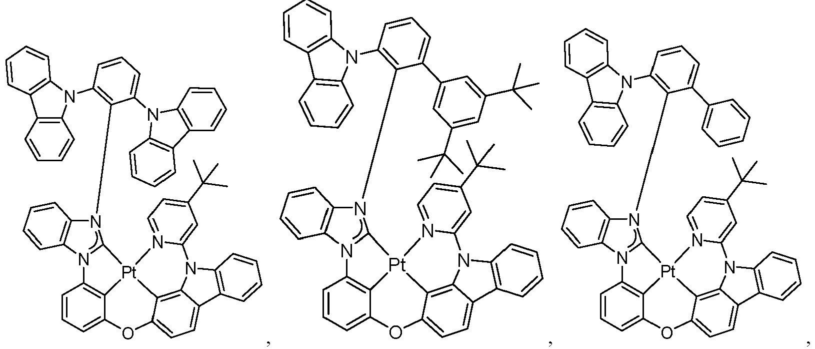

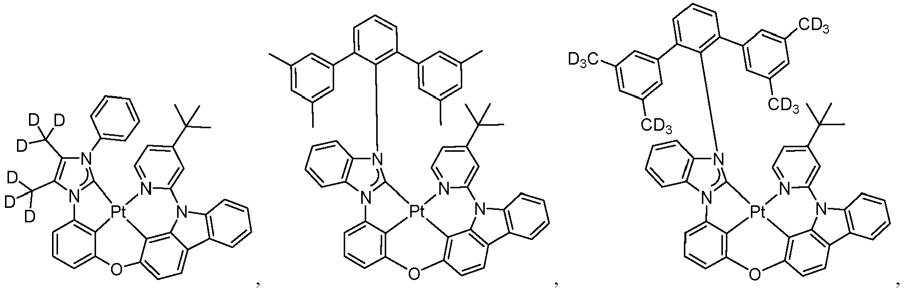

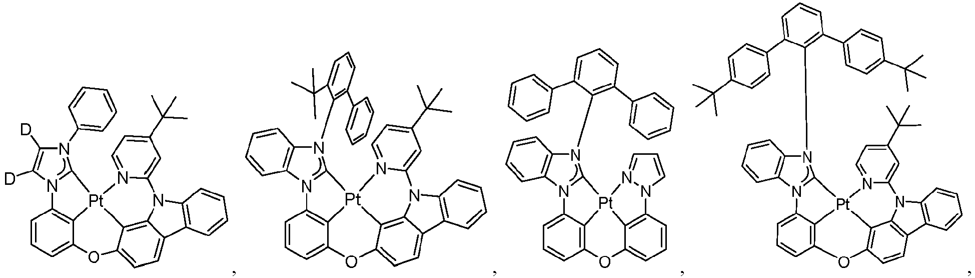

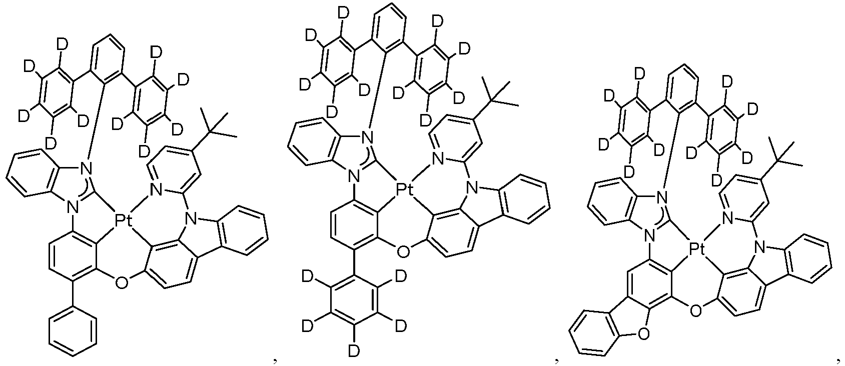

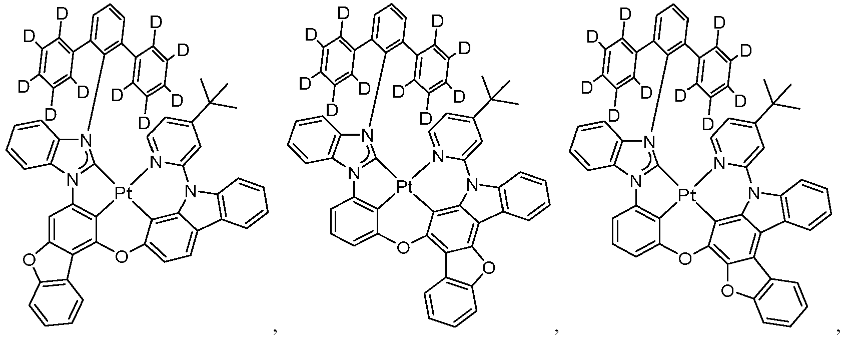

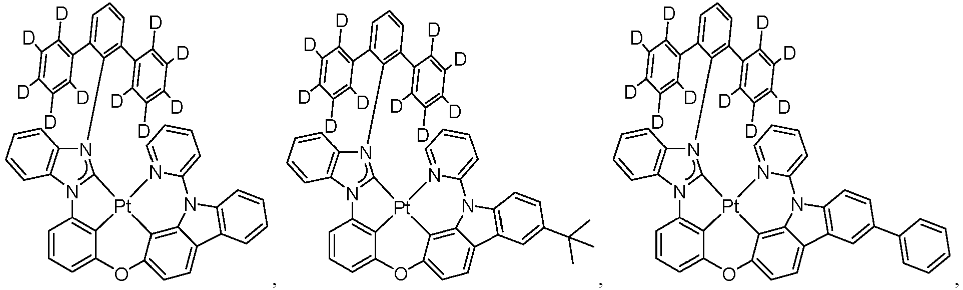

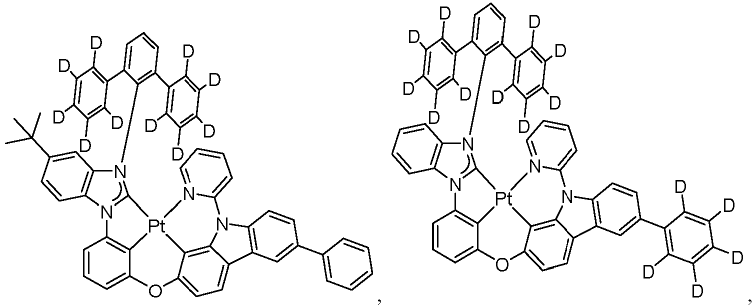

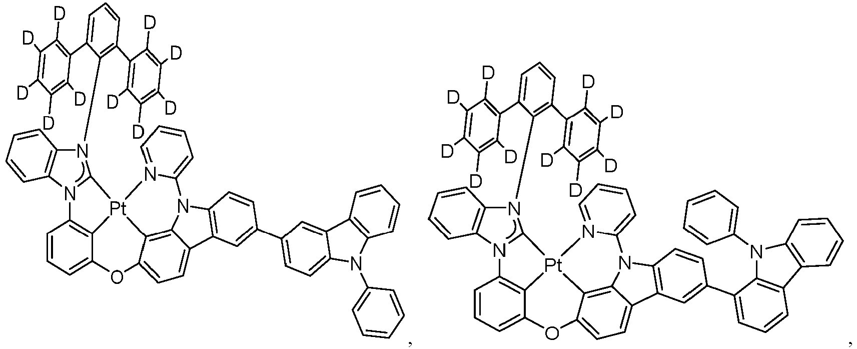

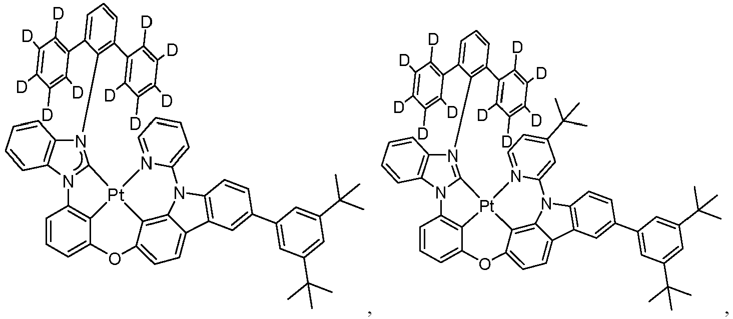

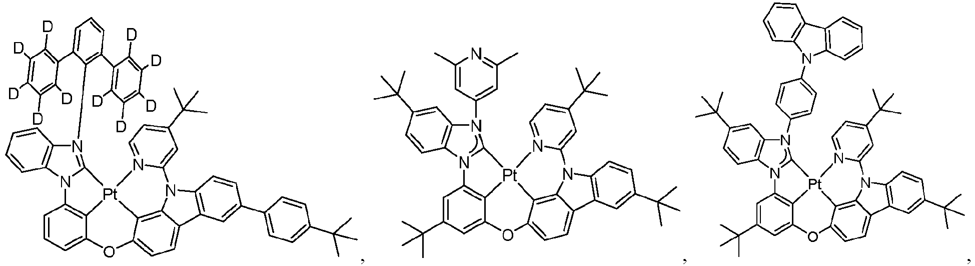

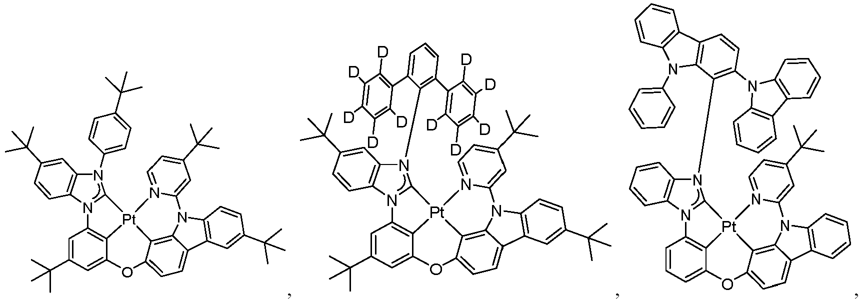

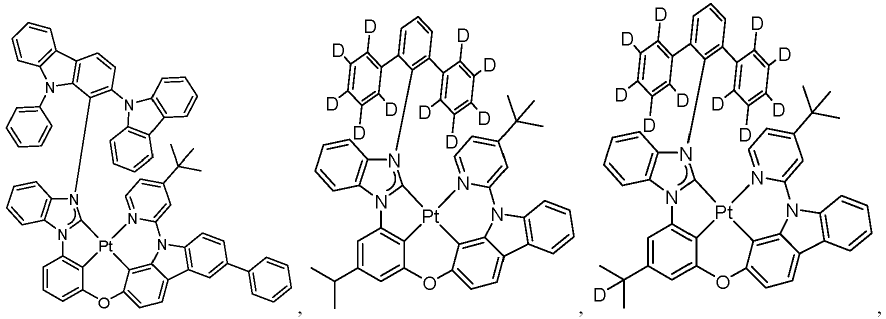

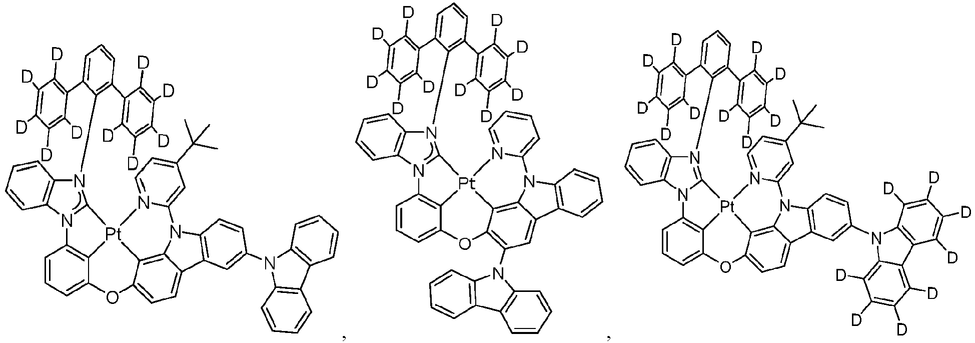

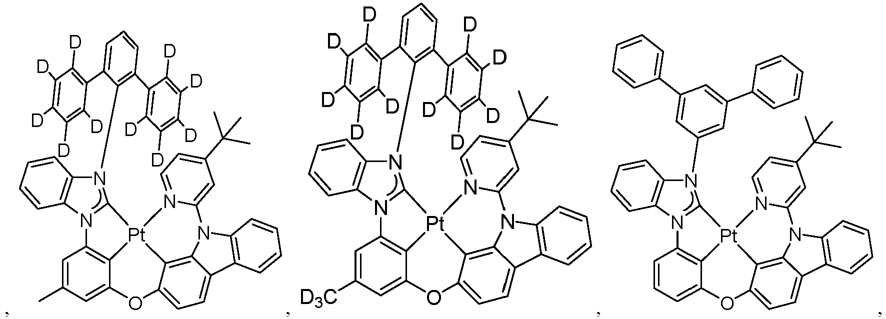

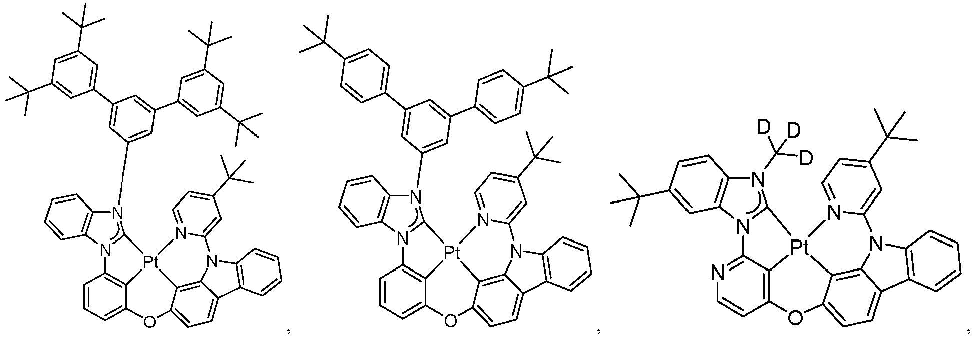

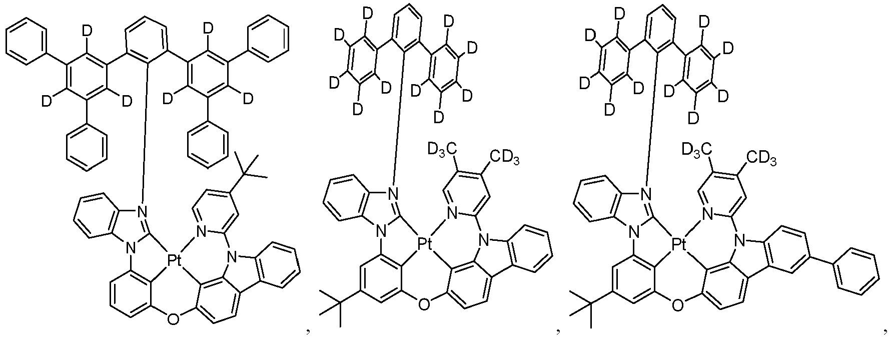

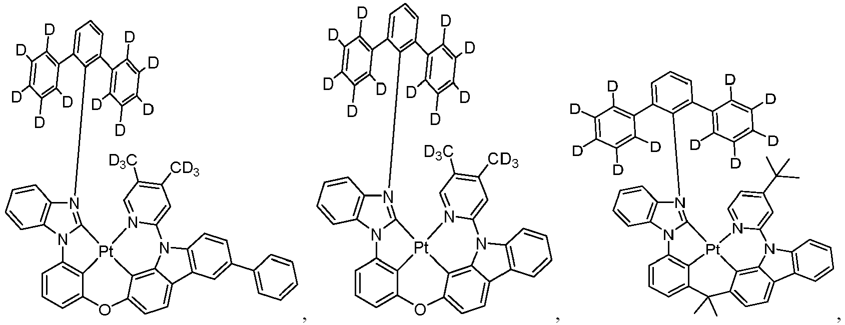

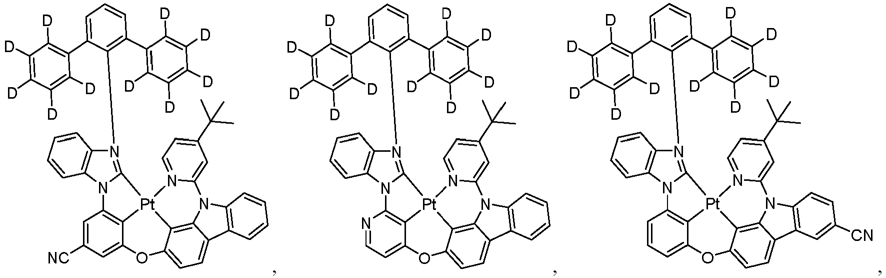

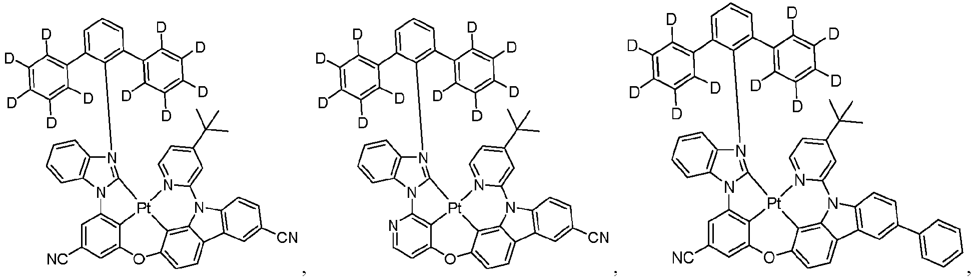

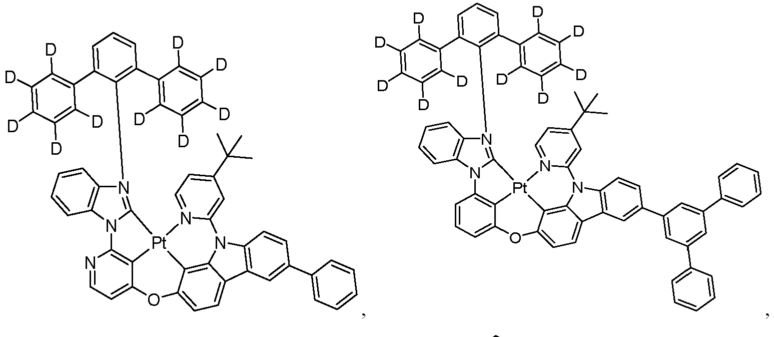

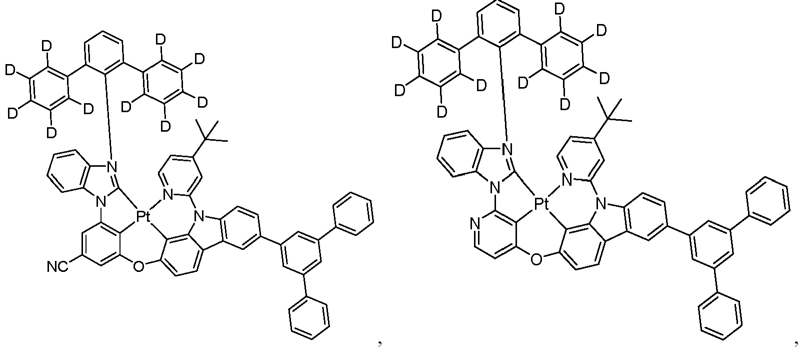

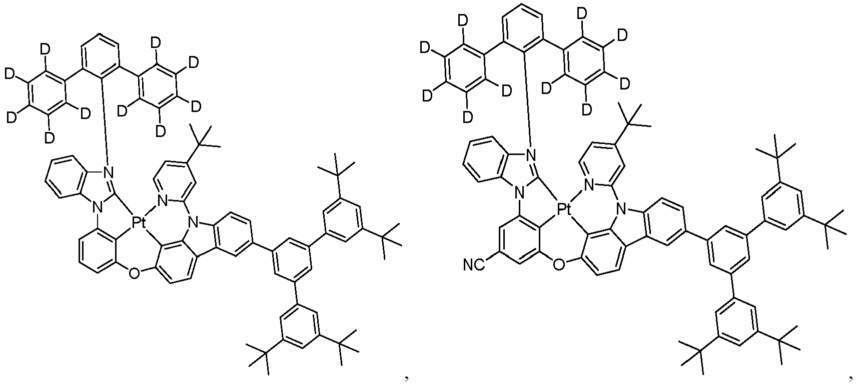

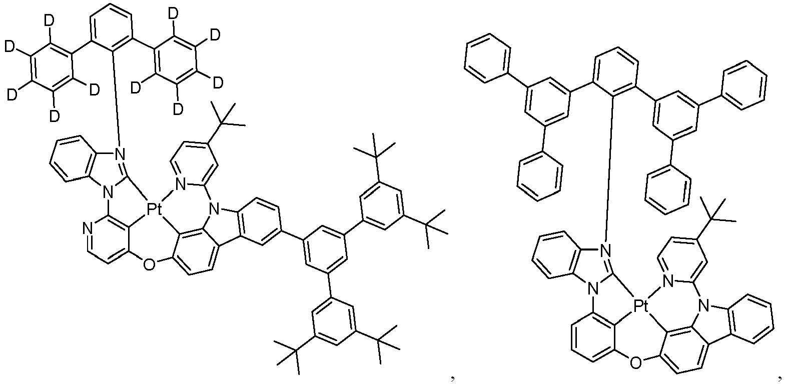

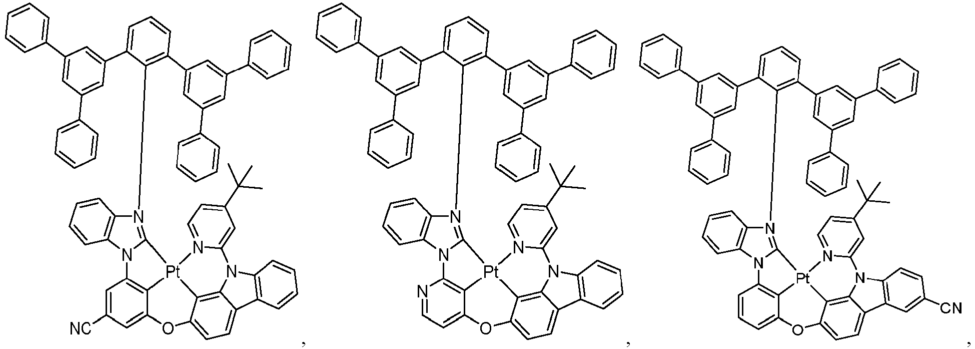

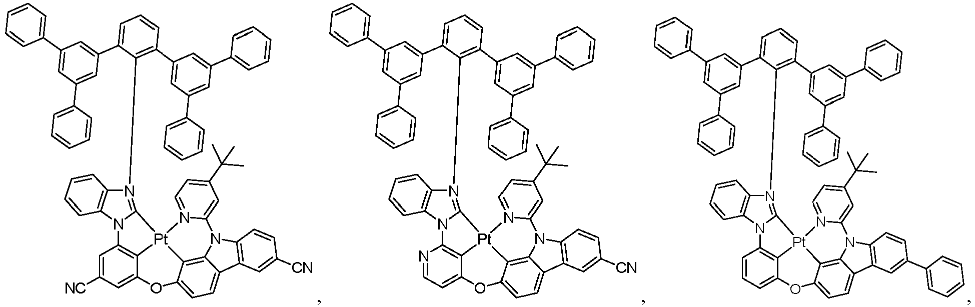

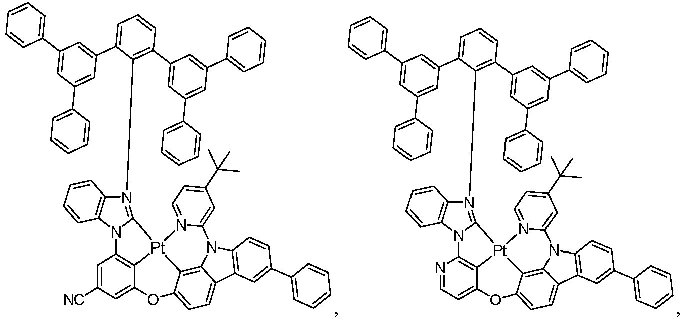

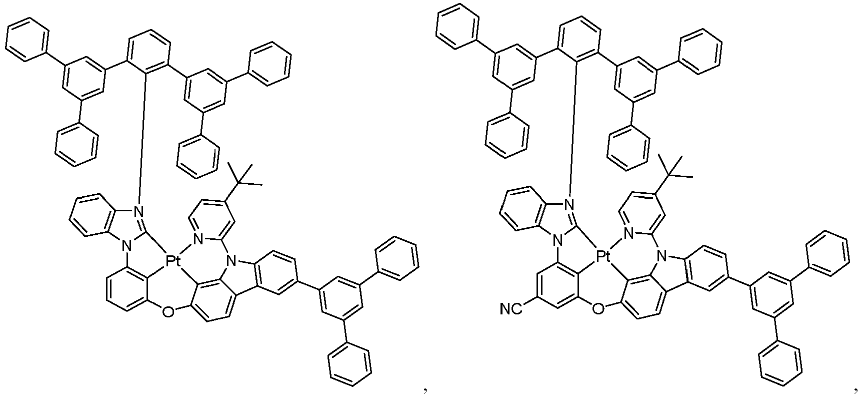

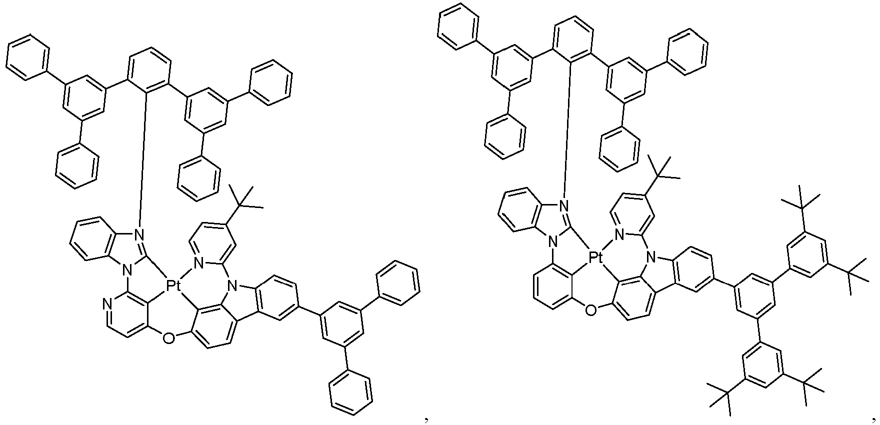

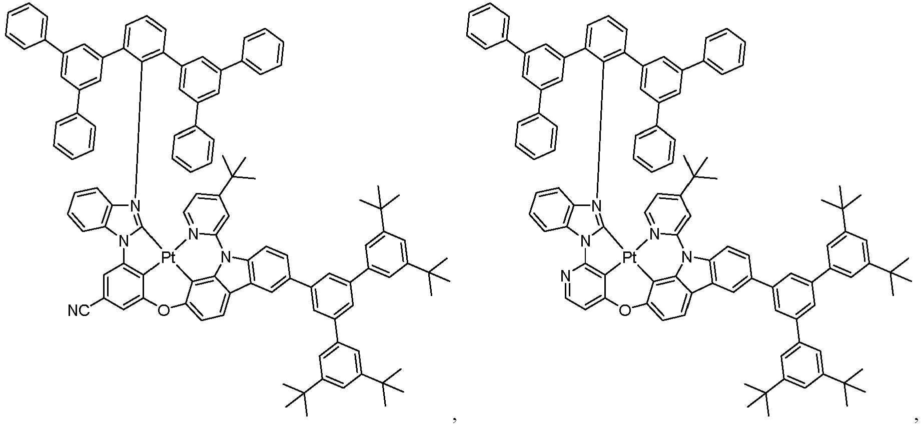

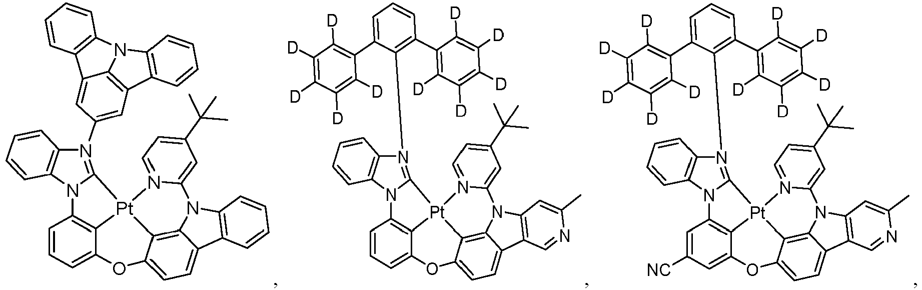

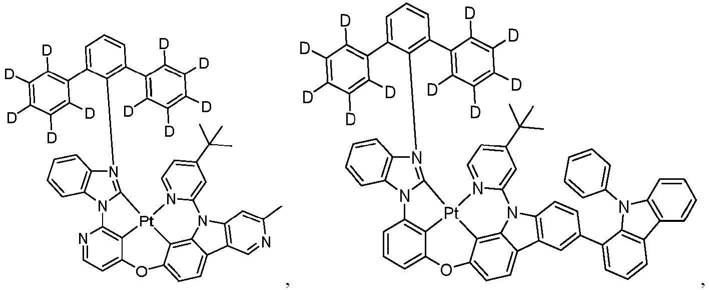

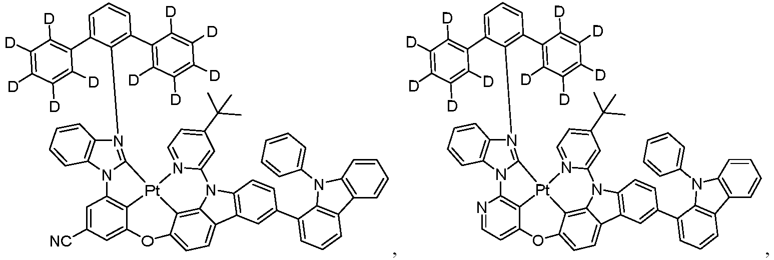

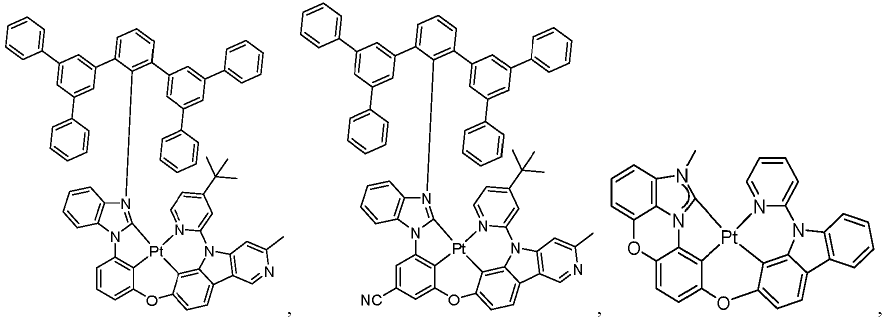

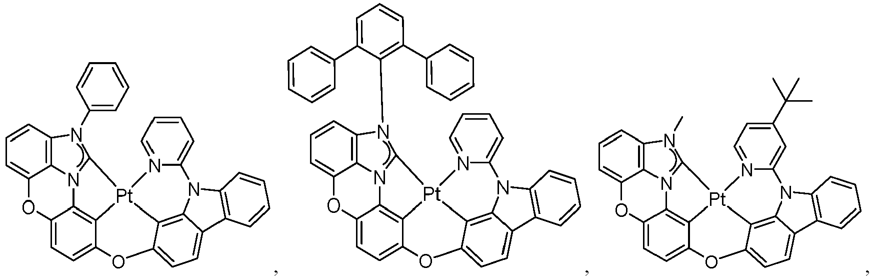

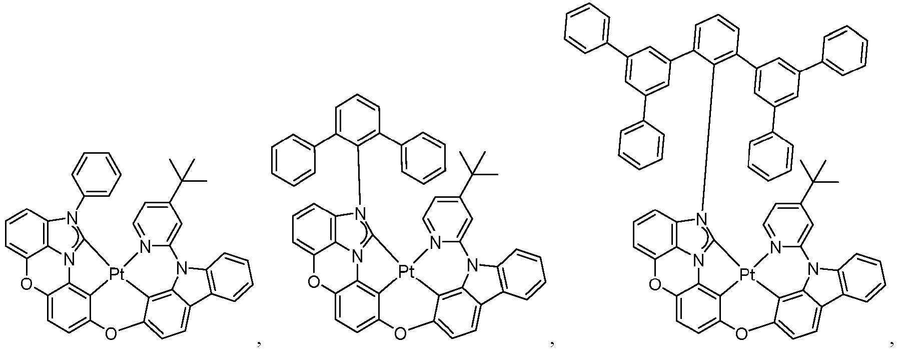

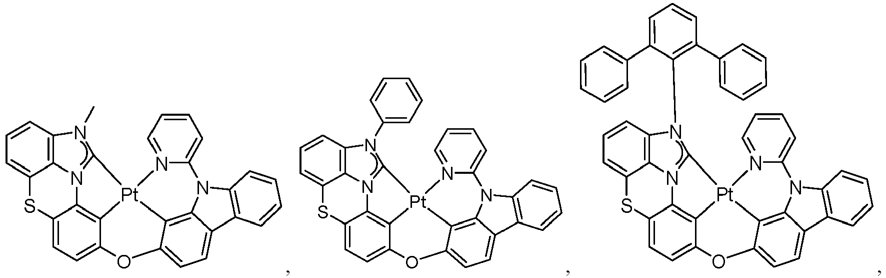

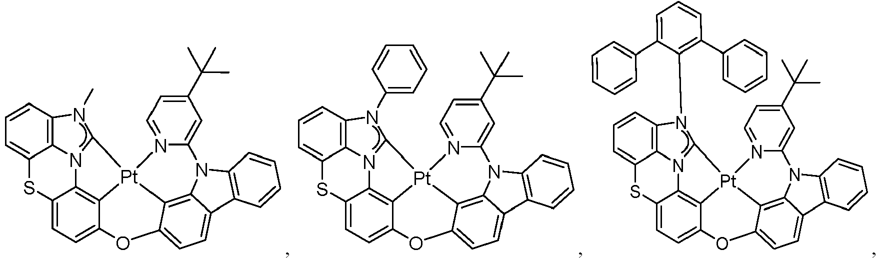

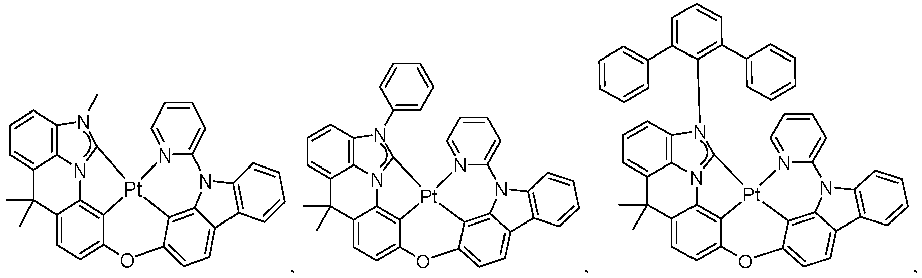

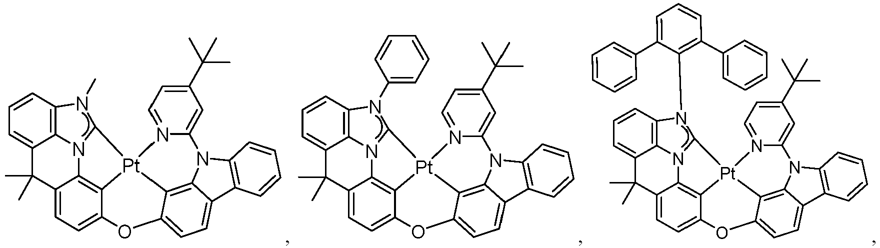

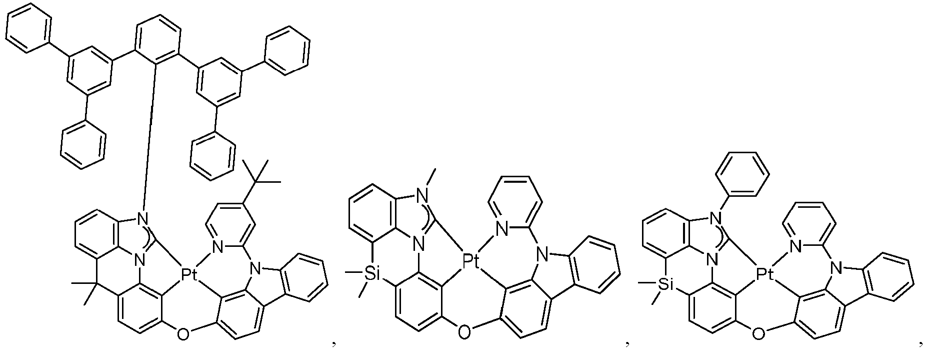

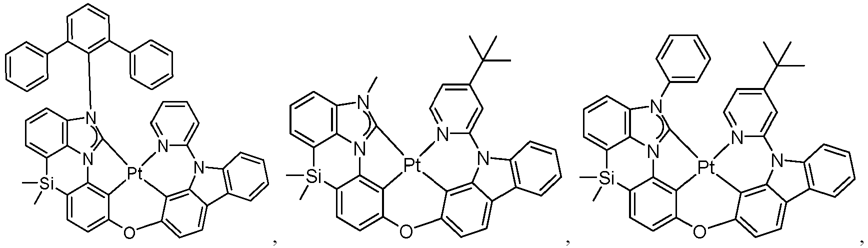

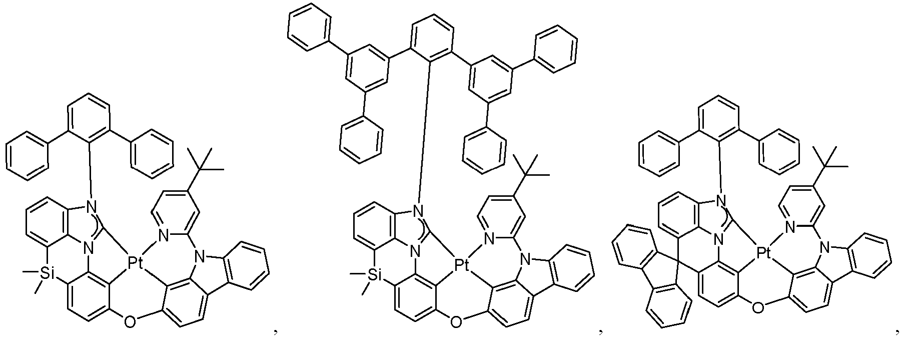

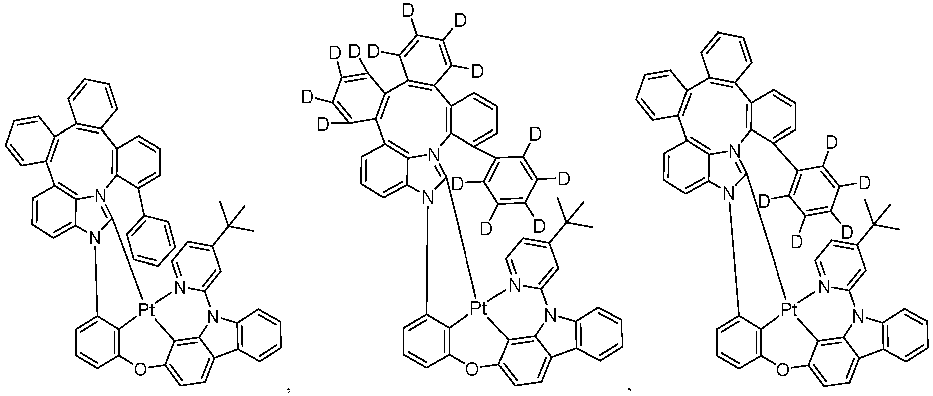

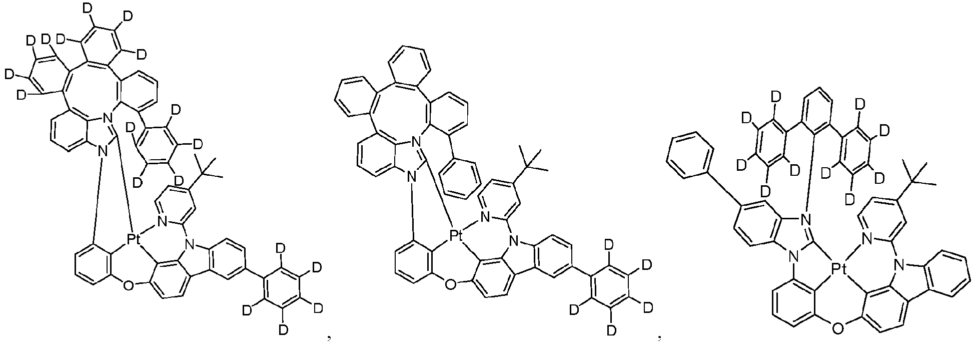

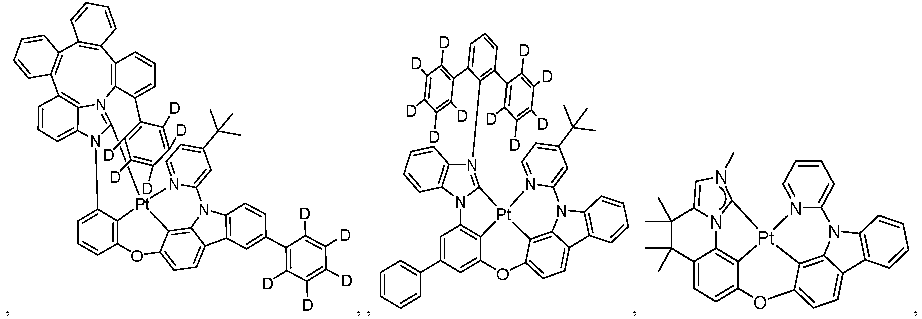

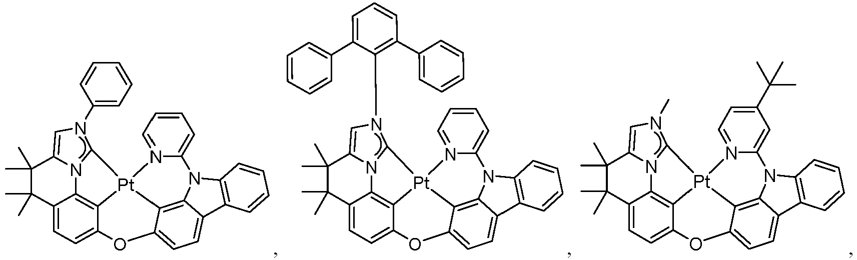

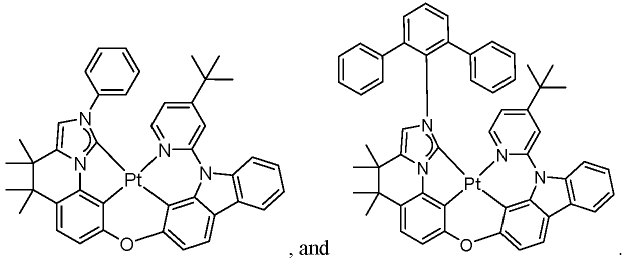

In some embodiments, the second host is selected from the group consisting of the structures in LIST 1 and LIST 2 as defined herein.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in U.S. Pat. No. 7,279,704 at cols. 5-6.

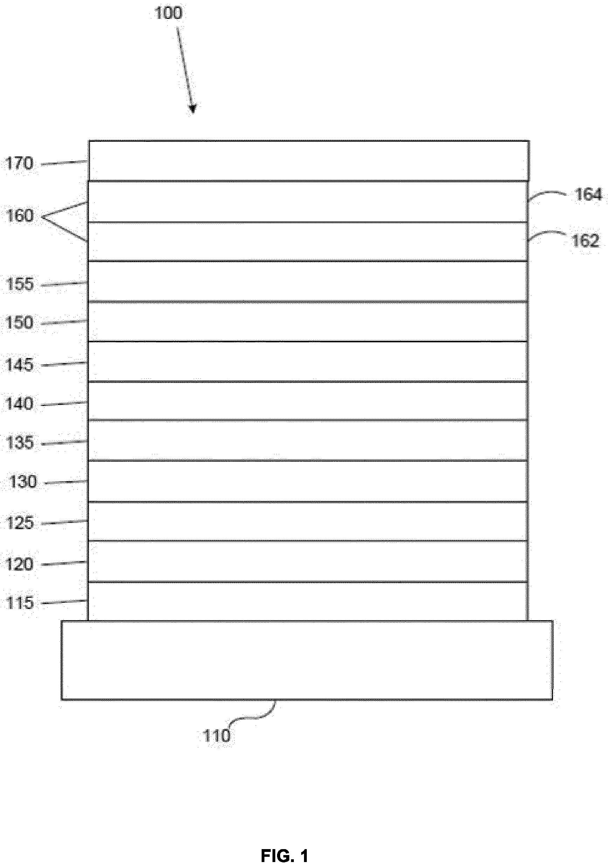

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50: 1, as disclosed in U.S. Patent Application Publication No. 2003/0230980. Examples of emissive and host materials are disclosed in U.S. Pat. No. 6,303,238 to Thompson et al.. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

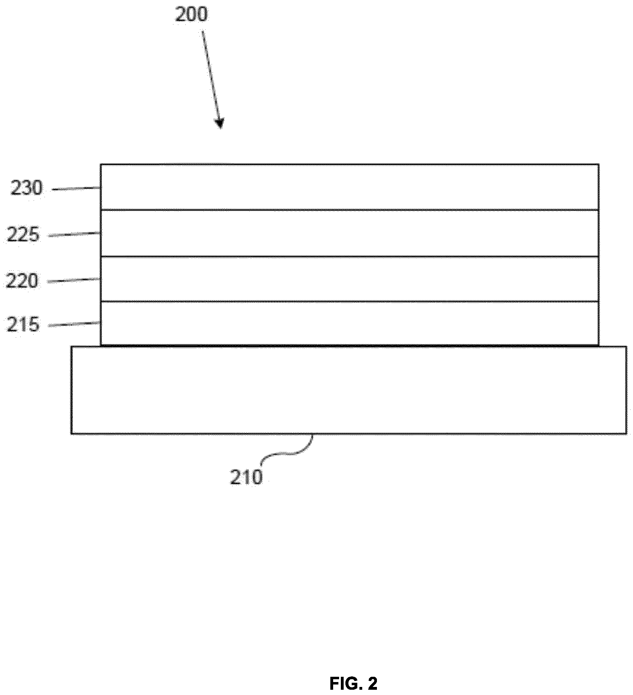

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al.. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al..

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., wand deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

### C. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

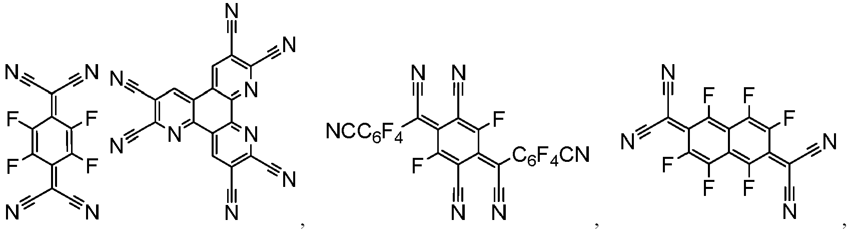

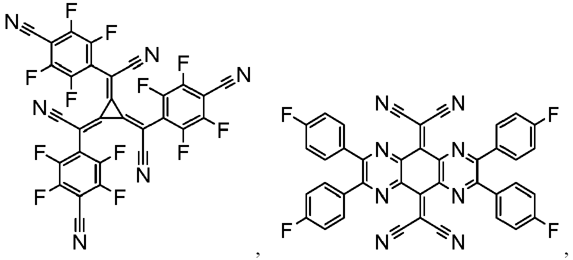

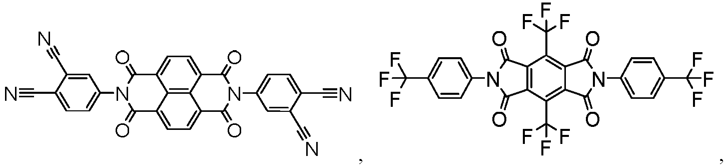

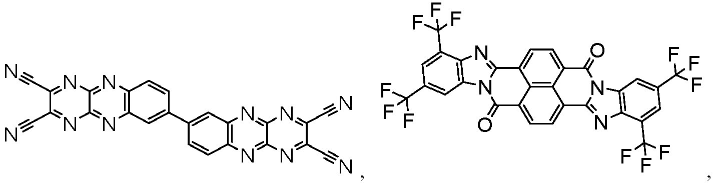

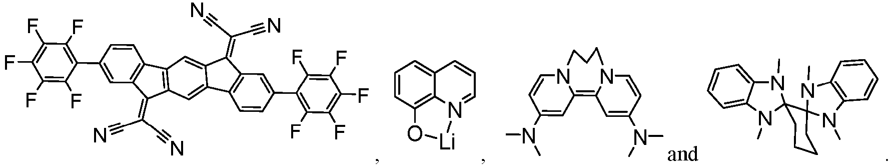

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

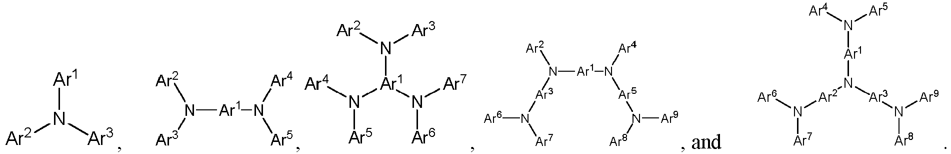

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 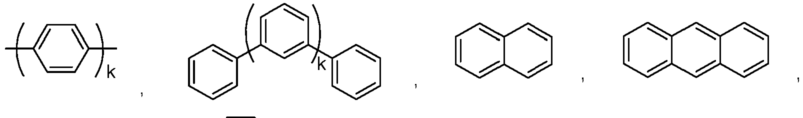 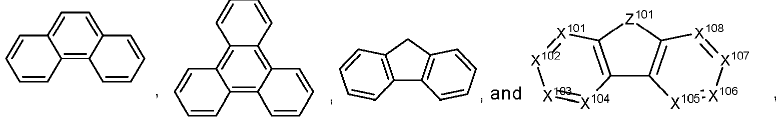 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 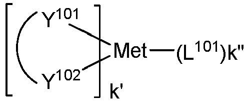 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

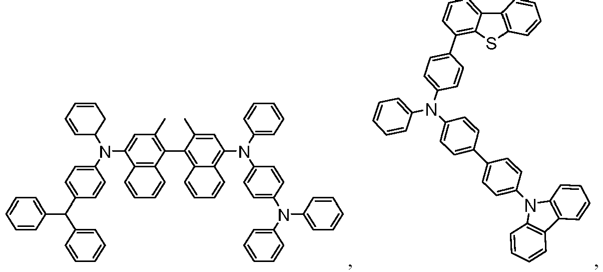

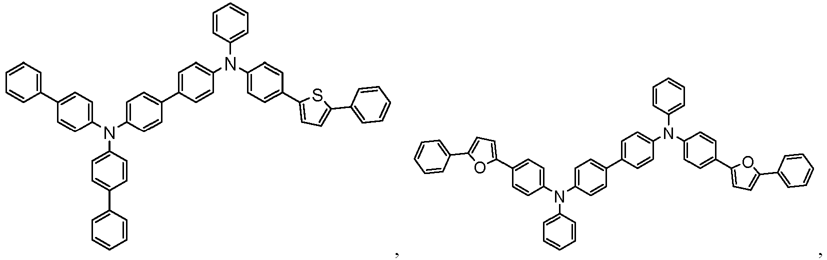

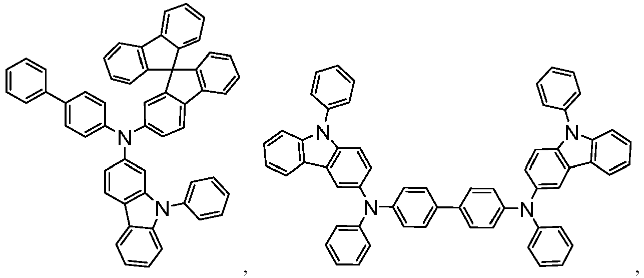

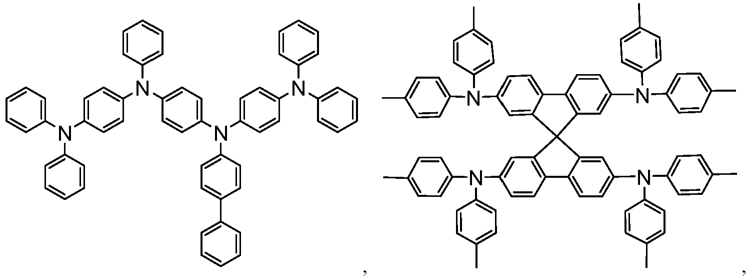

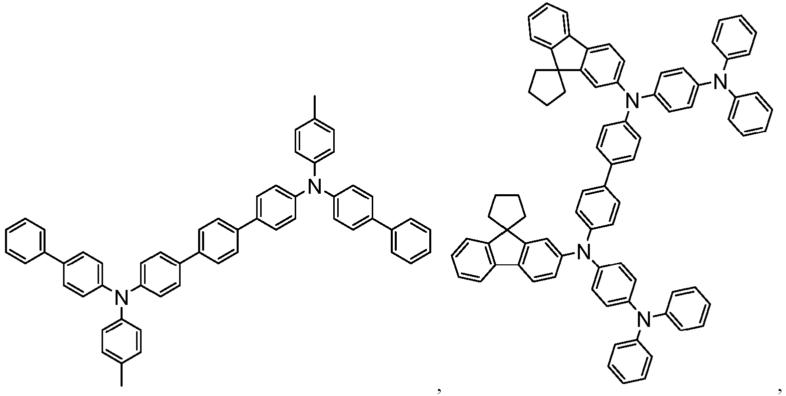

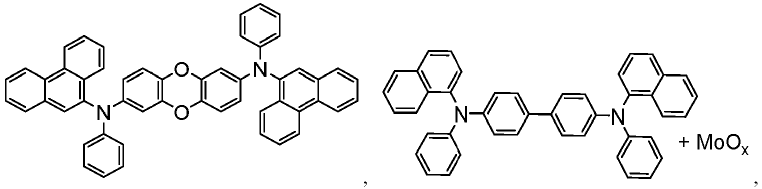

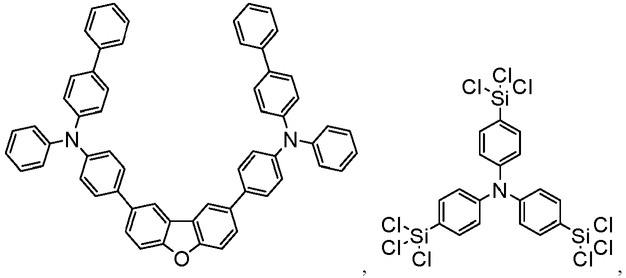

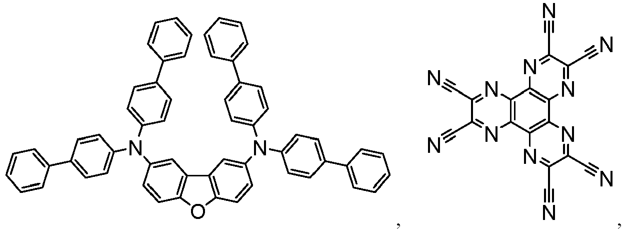

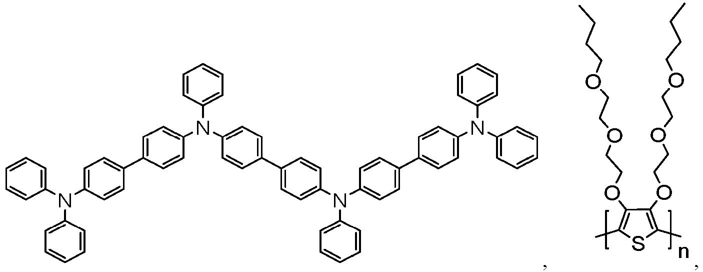

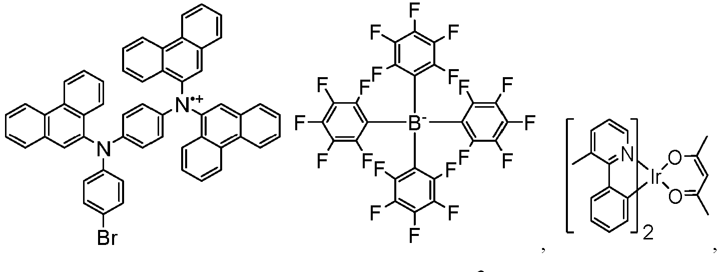

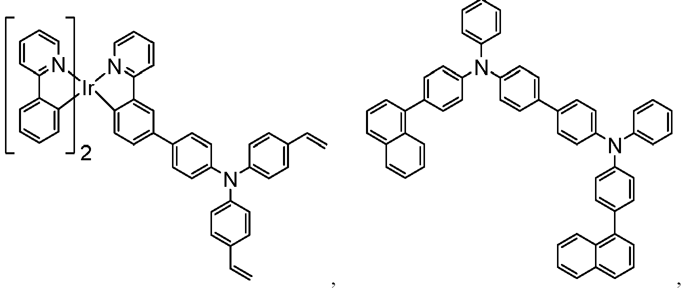

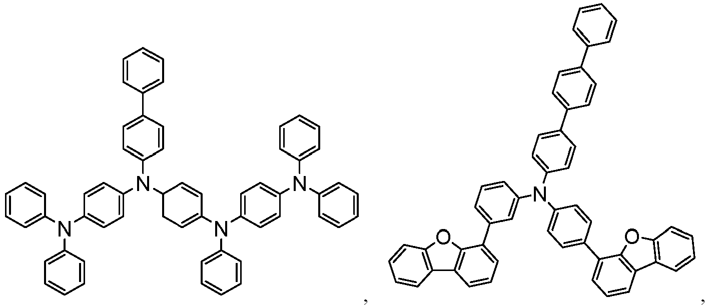

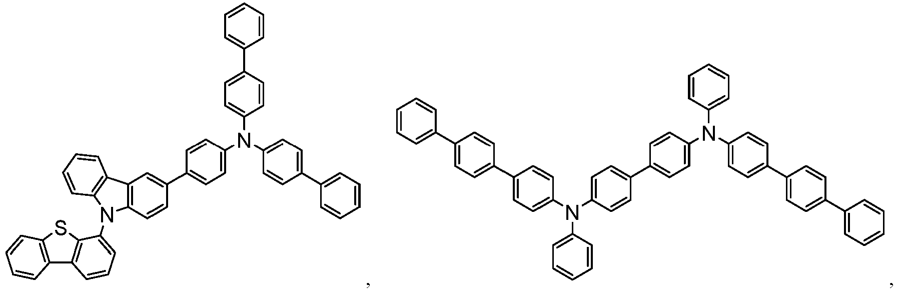

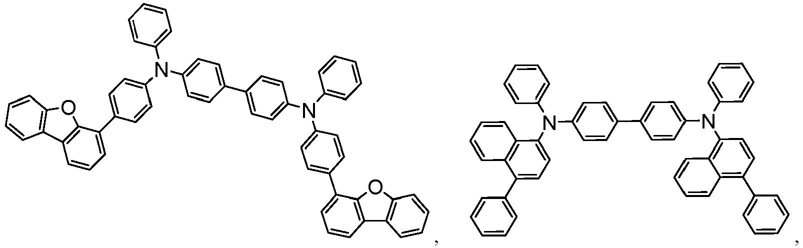

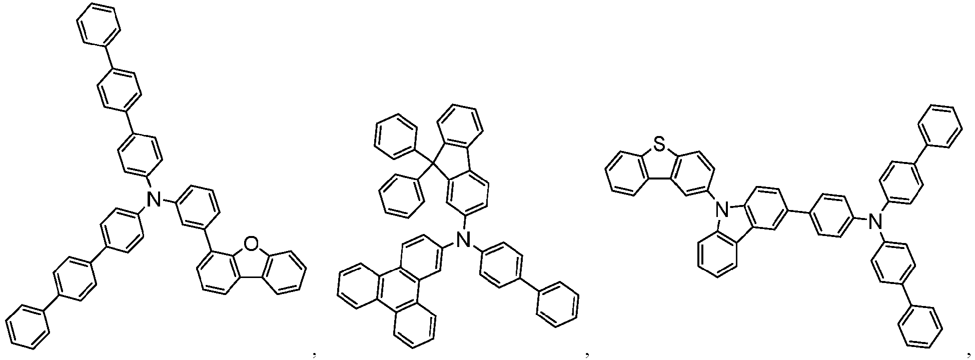

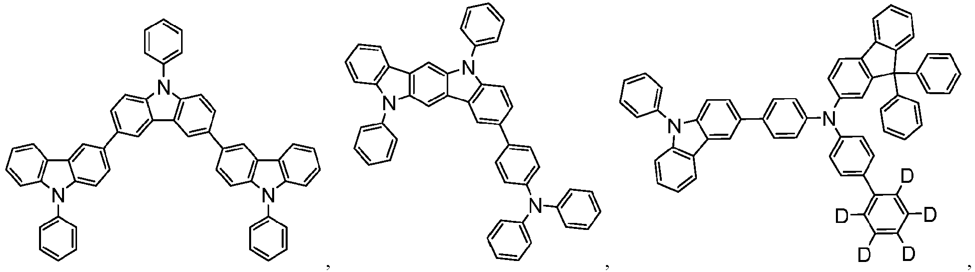

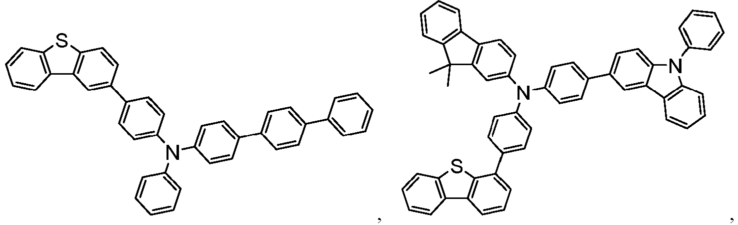

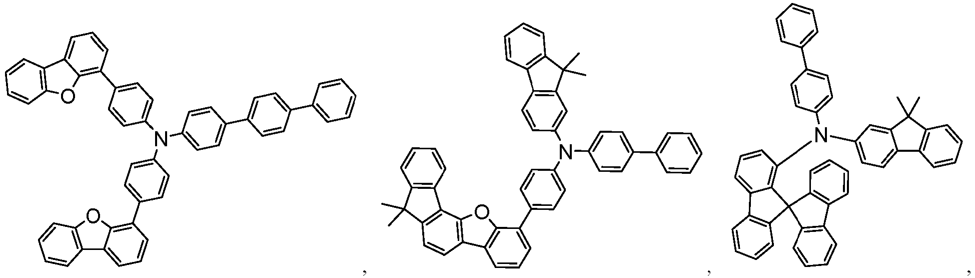

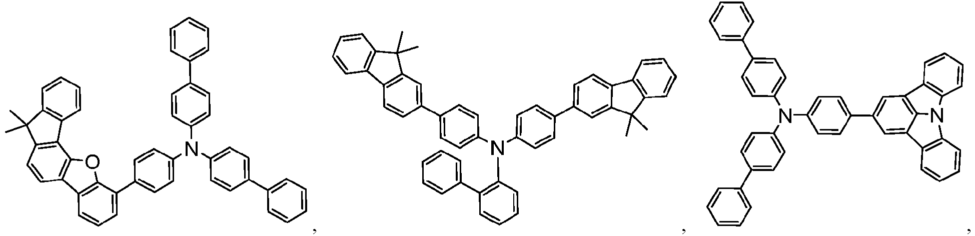

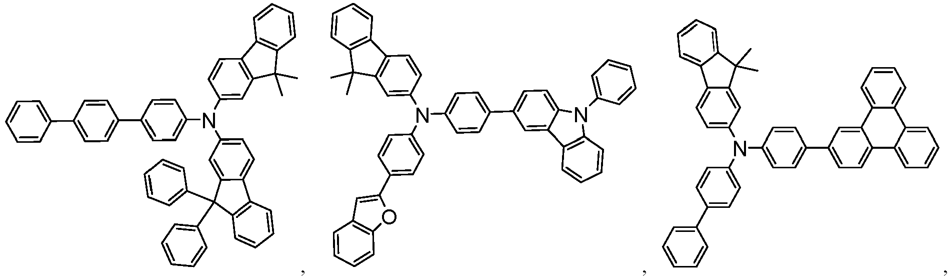

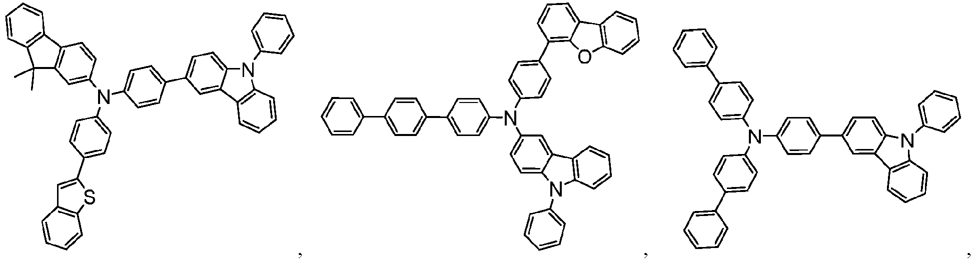

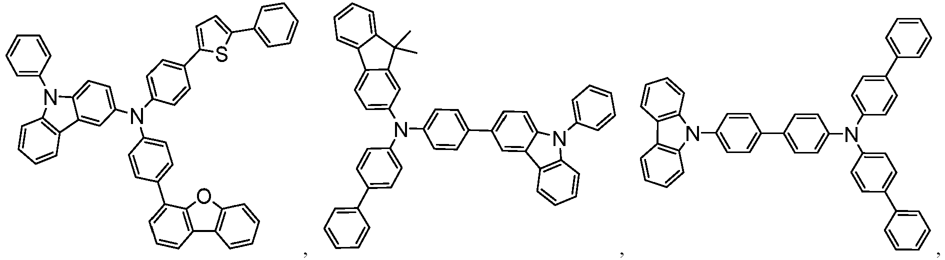

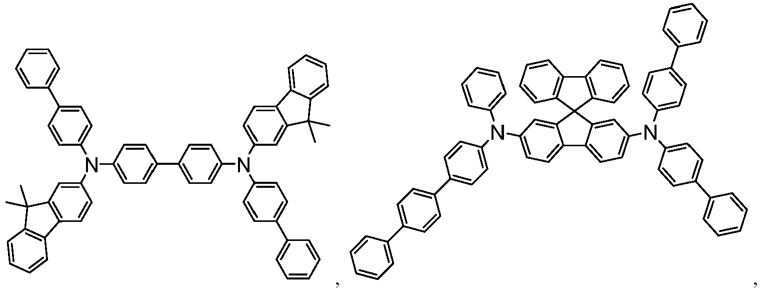

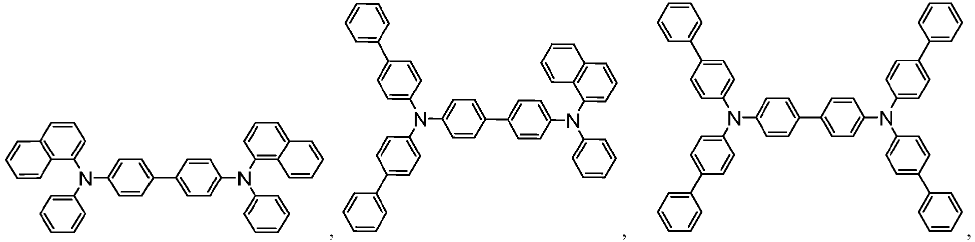

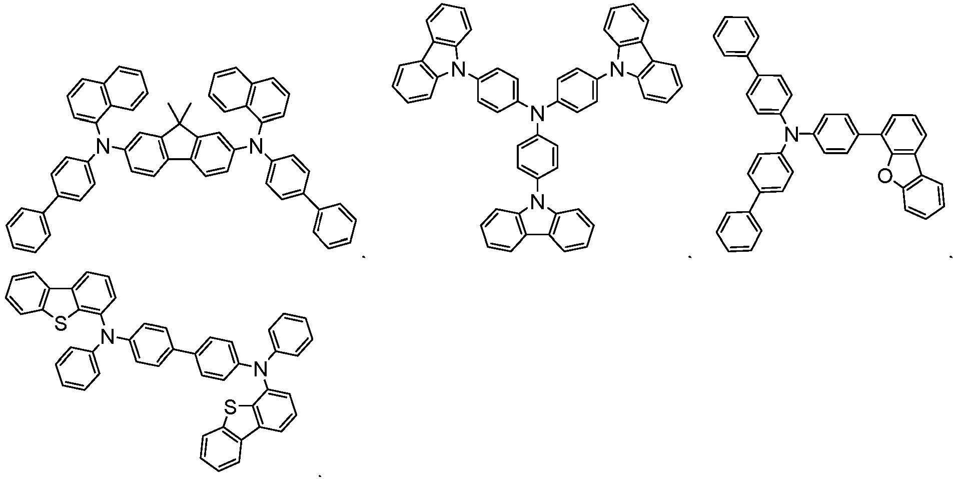

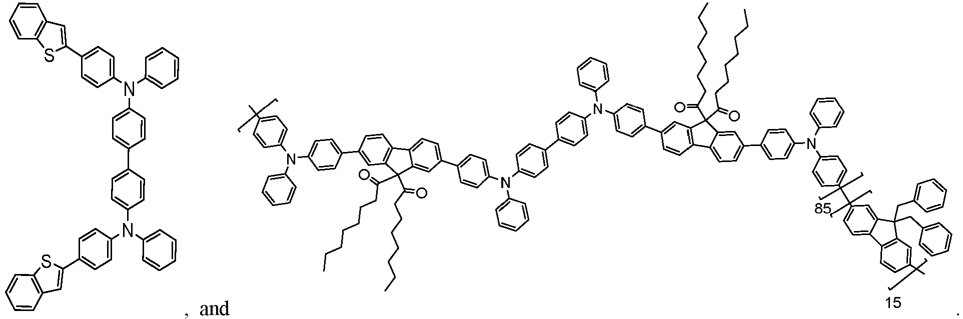

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present invention contains at least a metal complex as light emitting material, and a host material using the metal complex as a dopant material. **The** triplet energy of the host is larger than that of the dopant.

Examples of metal complexes used as host are preferred to have the following general formula: 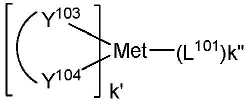 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 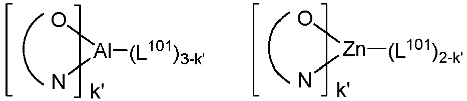 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 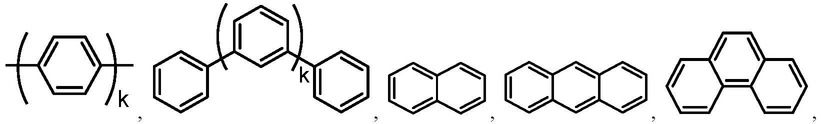 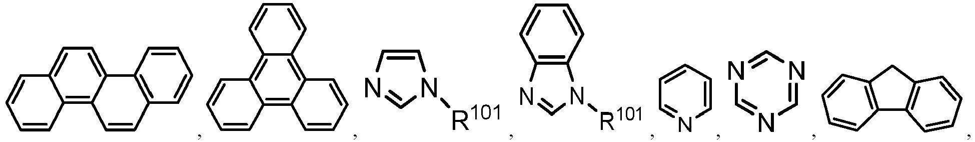 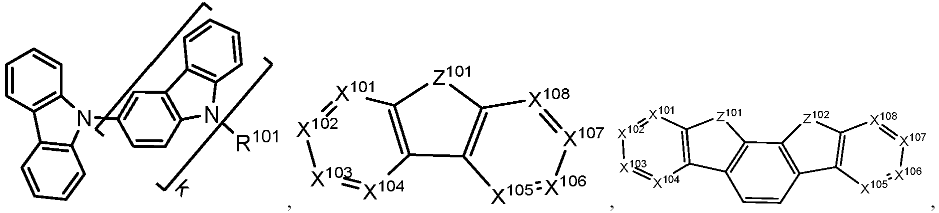 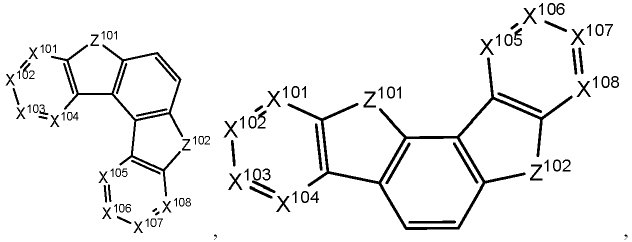 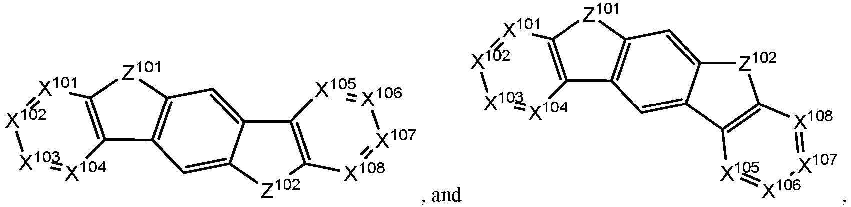 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803, 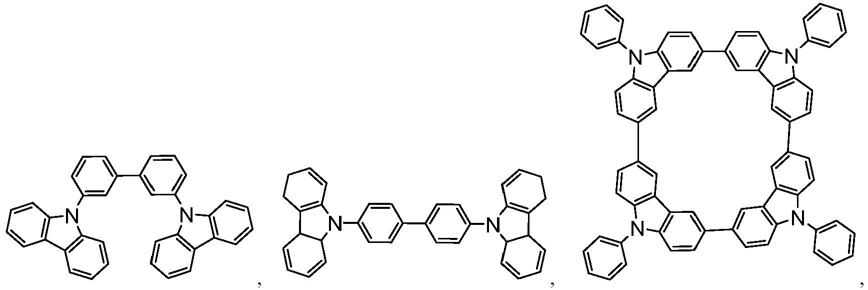 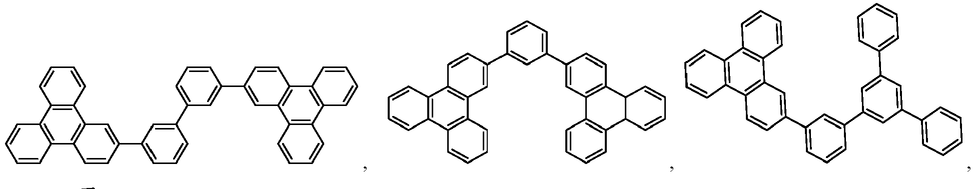 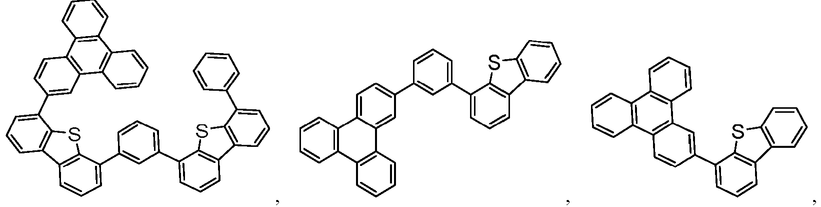 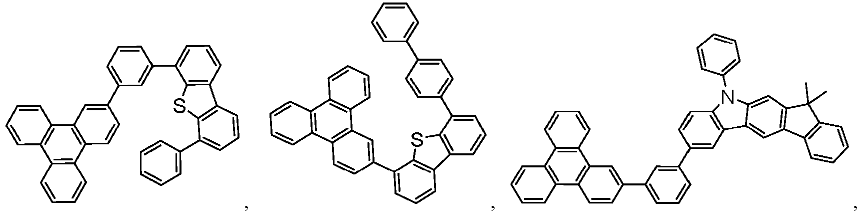 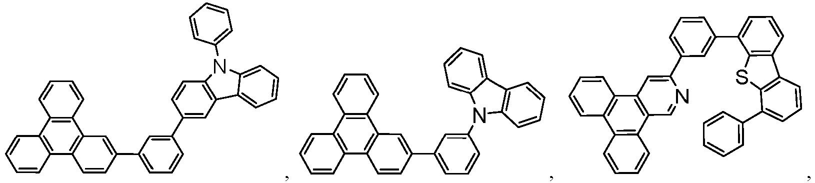 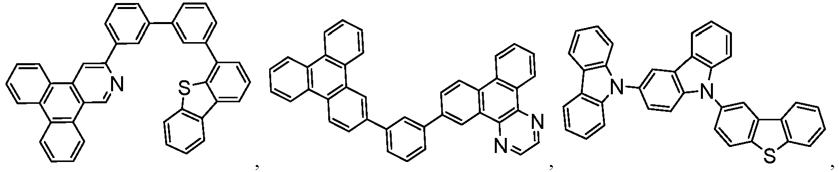 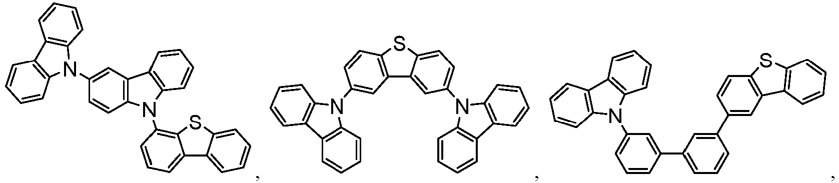 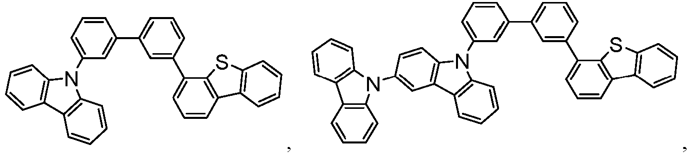 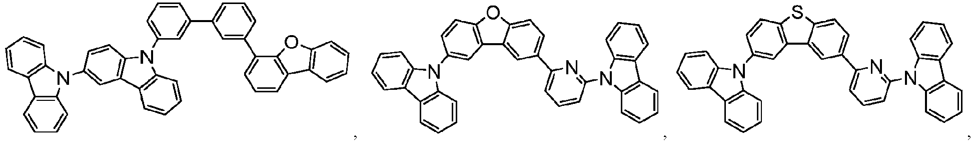 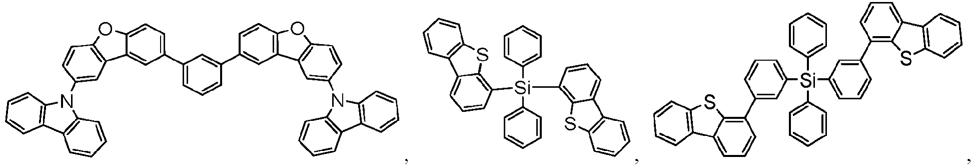 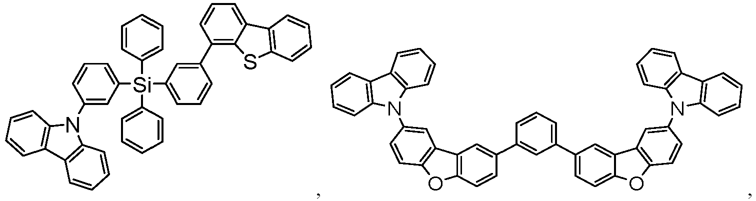 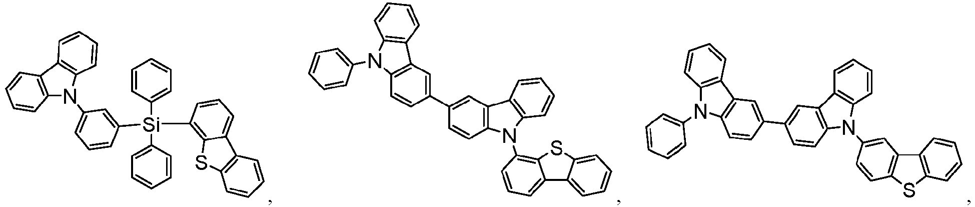 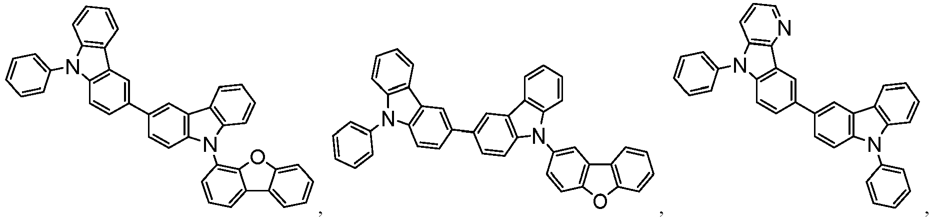 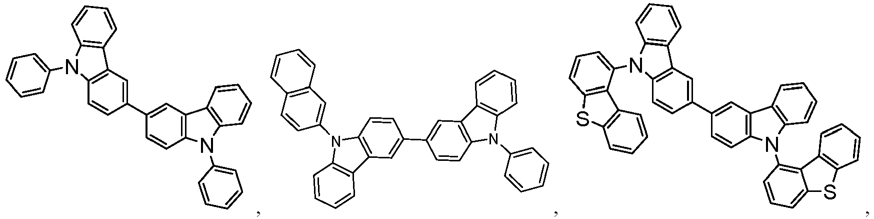 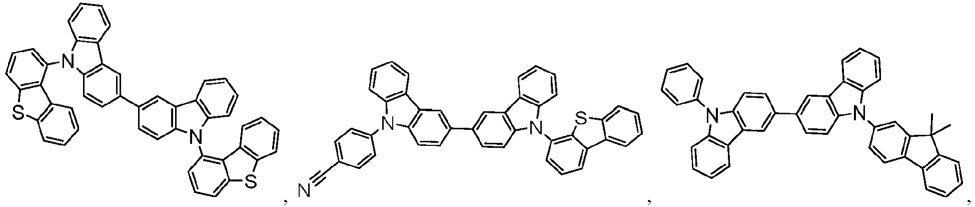 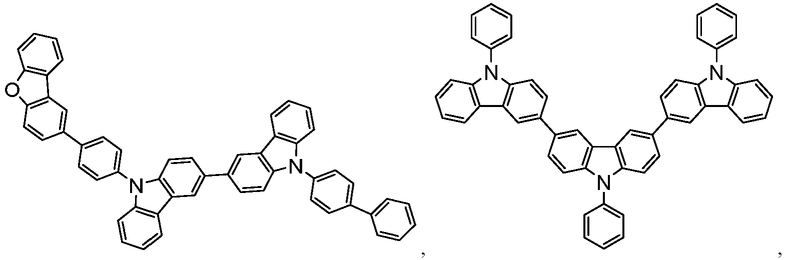 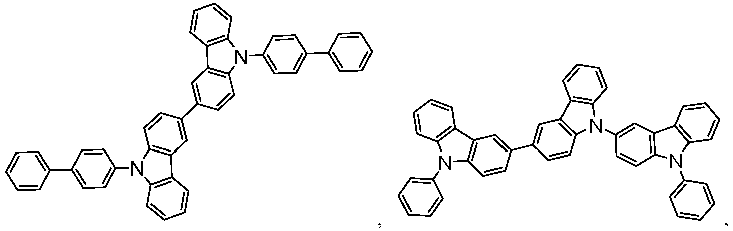 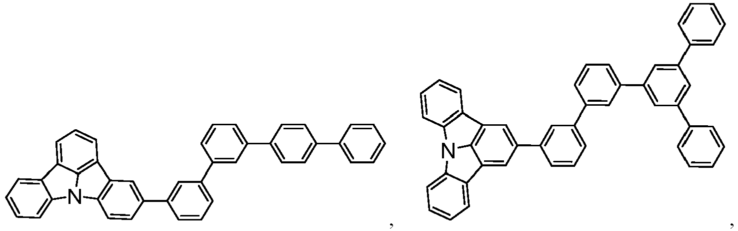 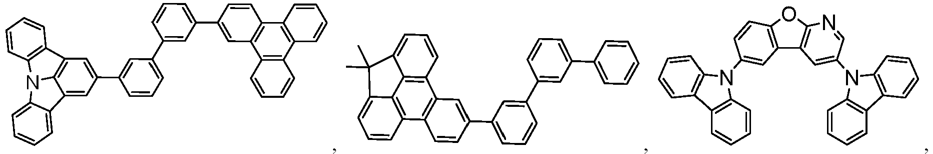 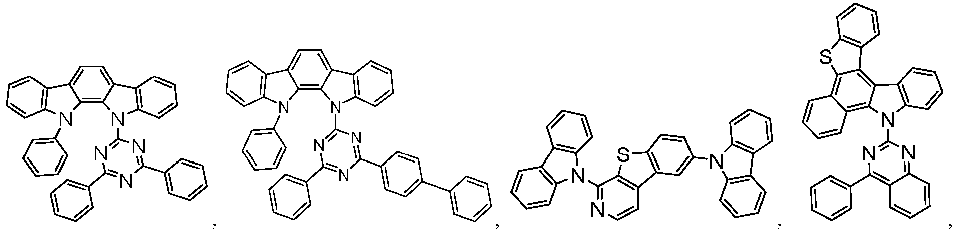 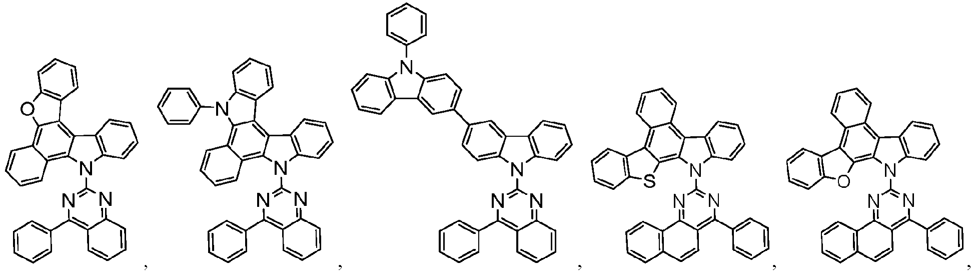 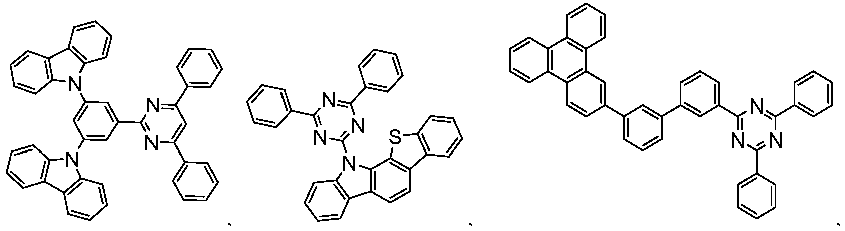 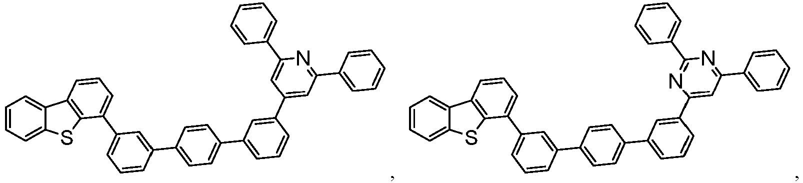 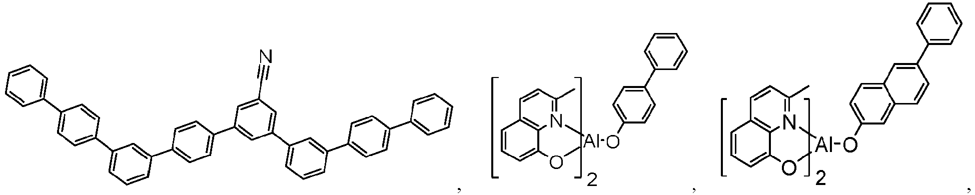 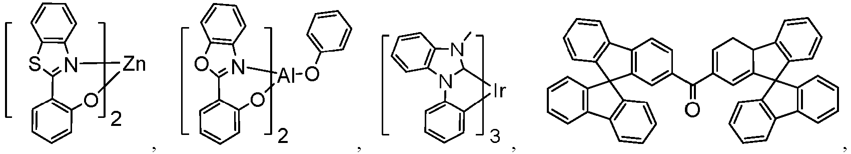 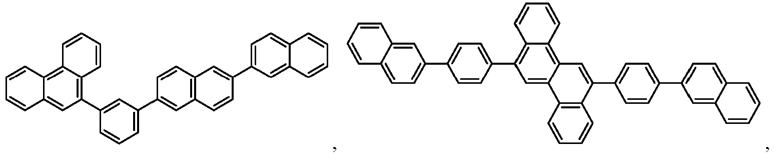 and

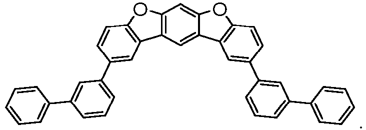

### e) Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

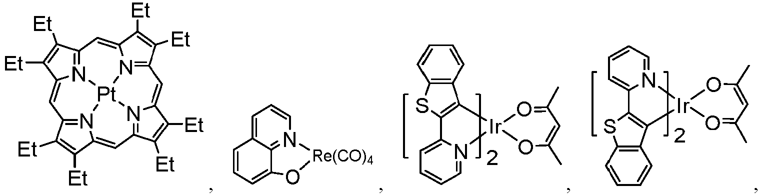

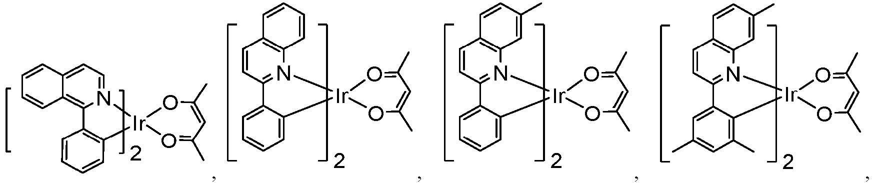

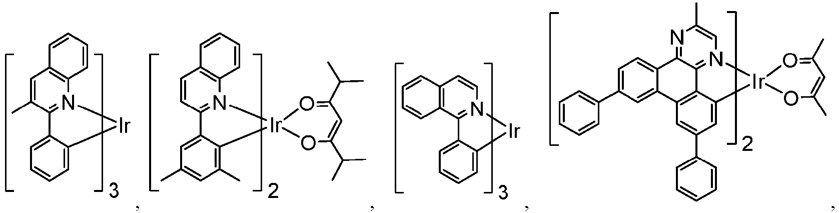

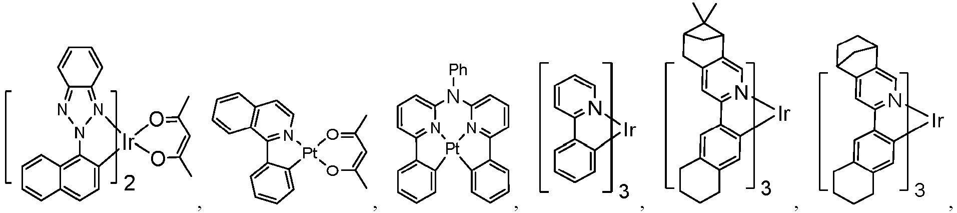

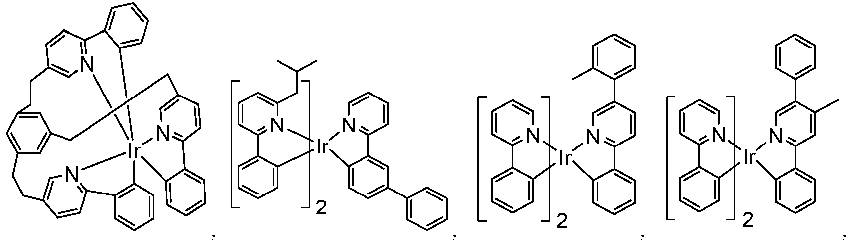

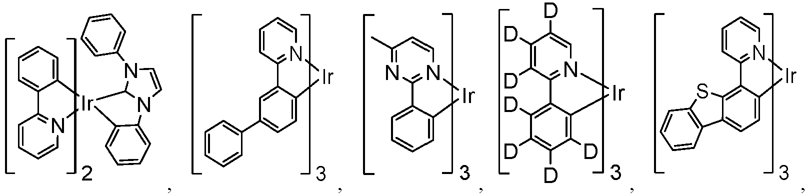

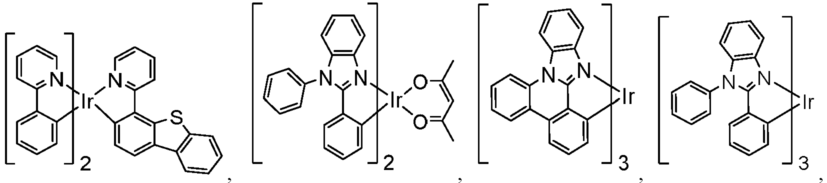

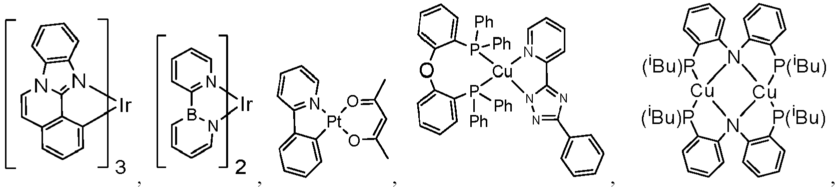

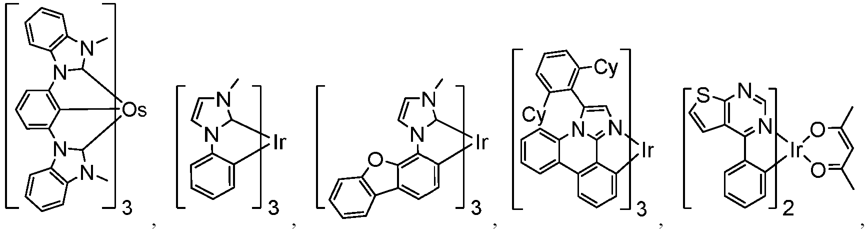

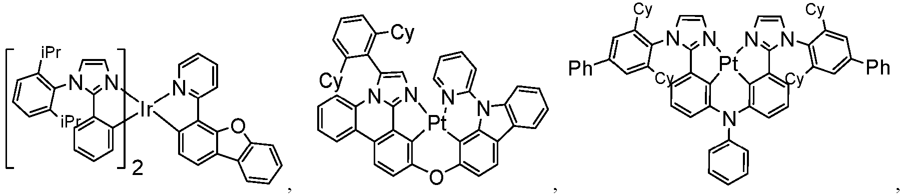

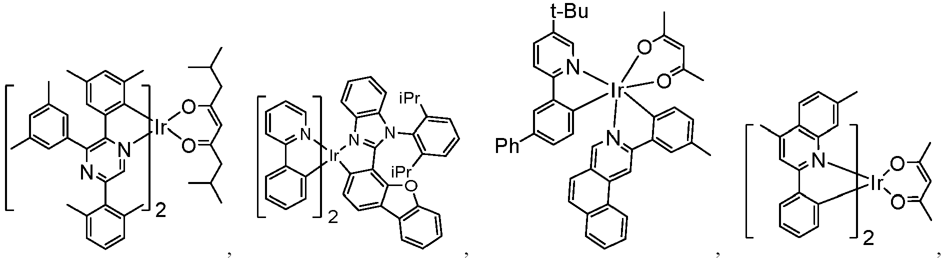

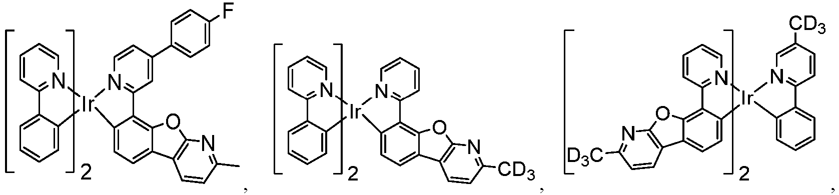

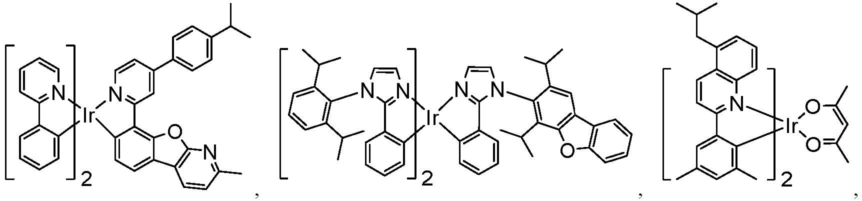

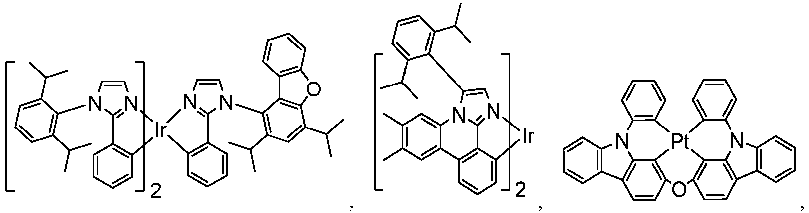

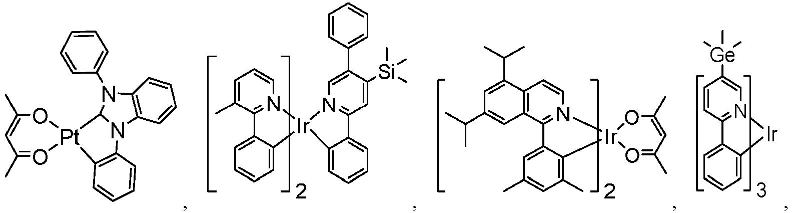

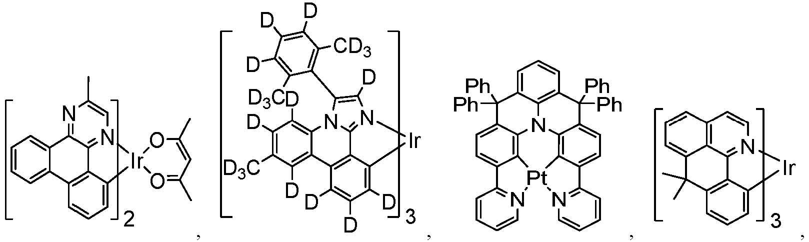

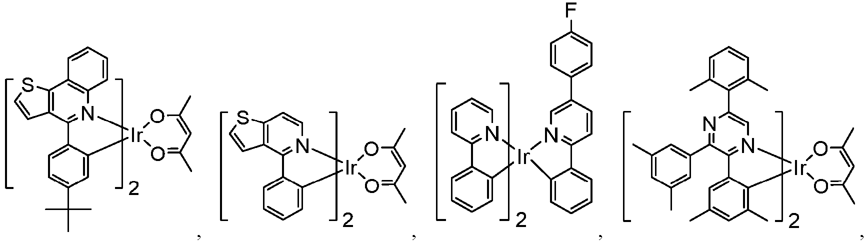

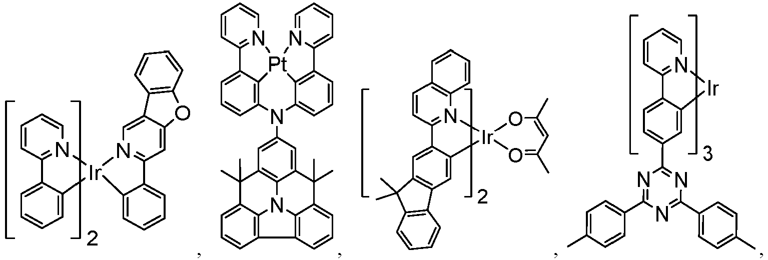

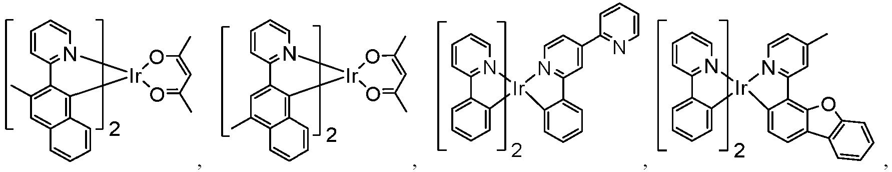

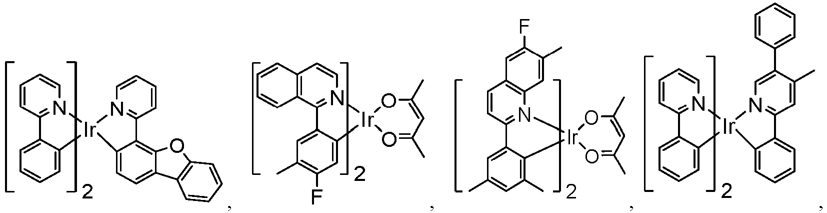

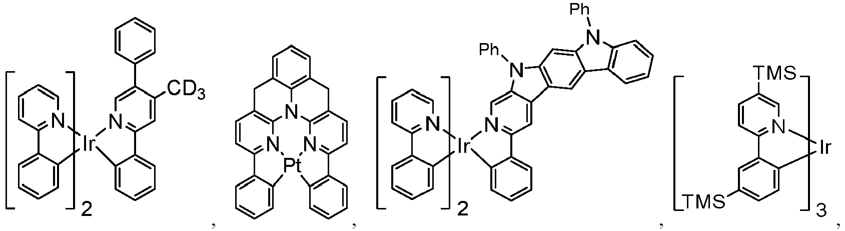

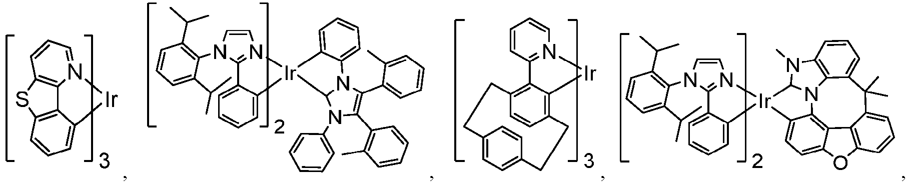

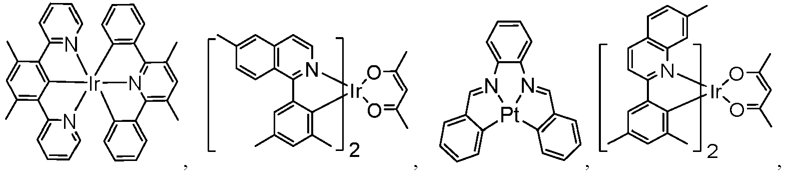

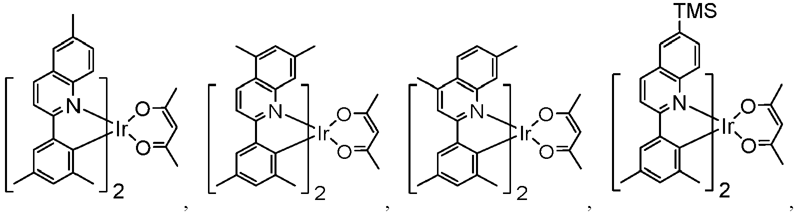

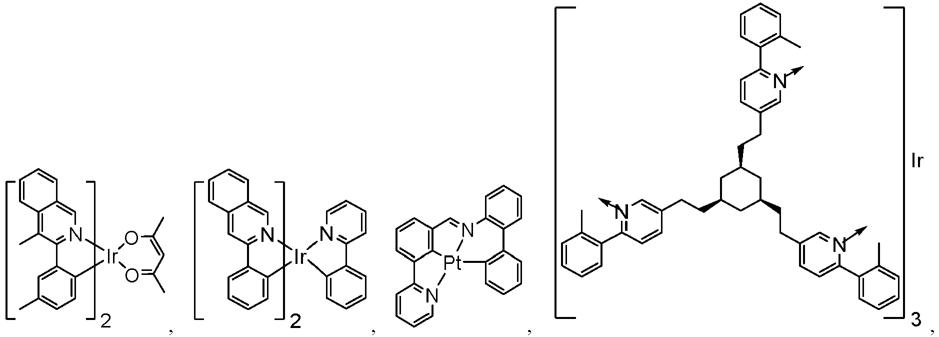

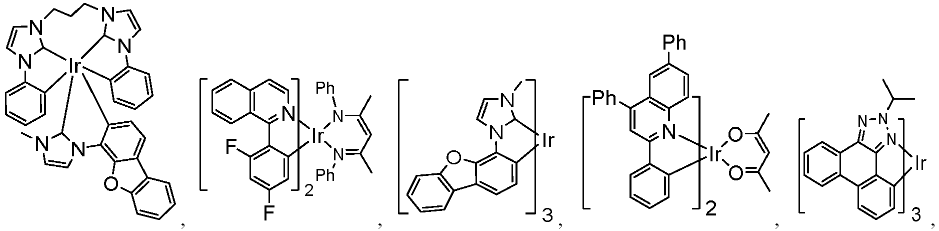

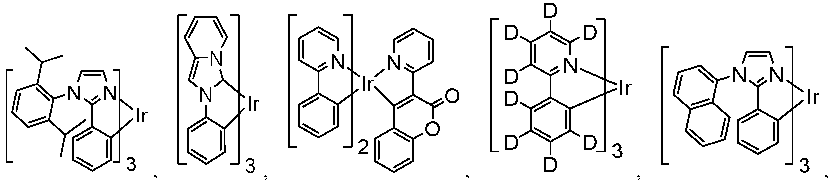

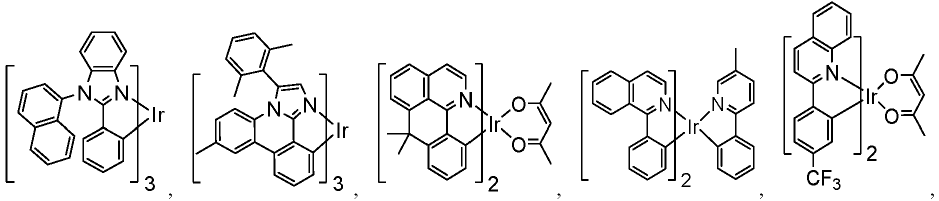

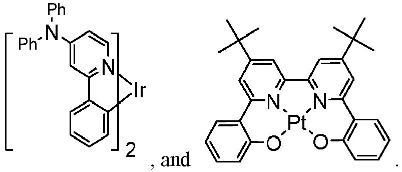

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 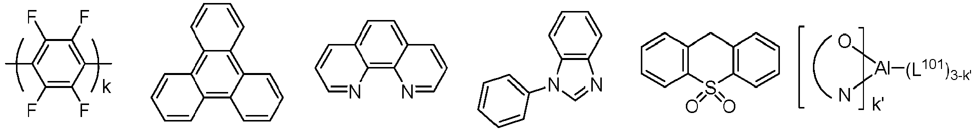 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 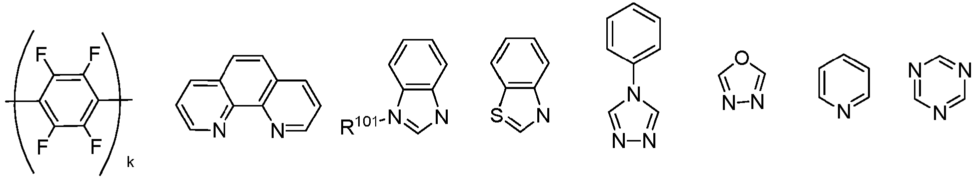 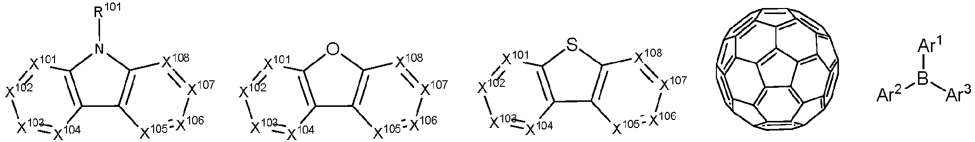 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 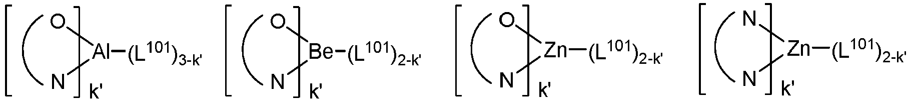 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

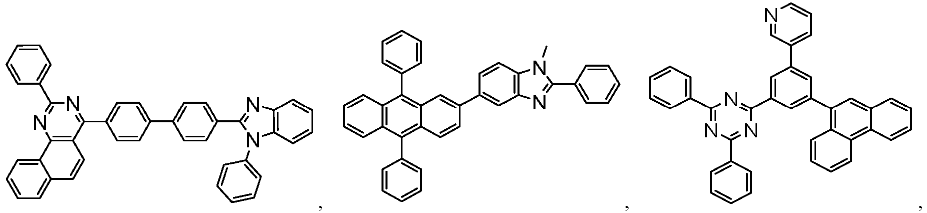

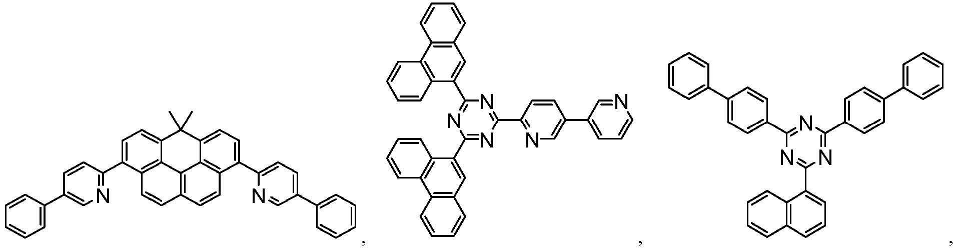

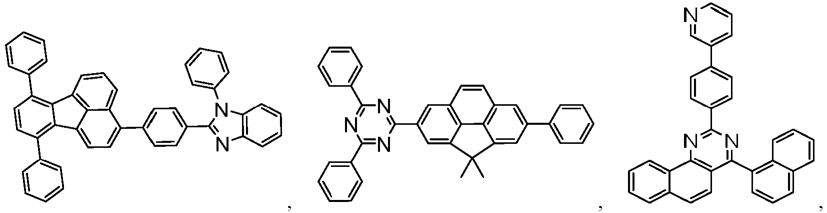

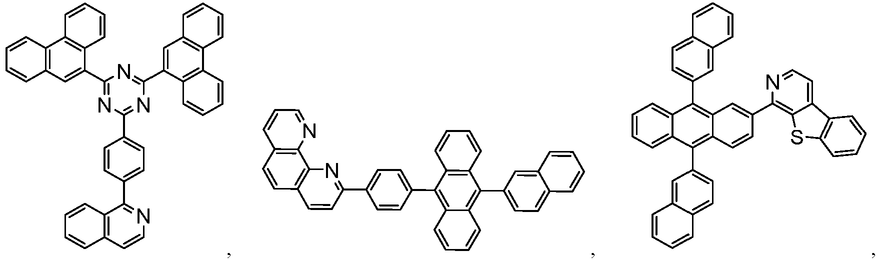

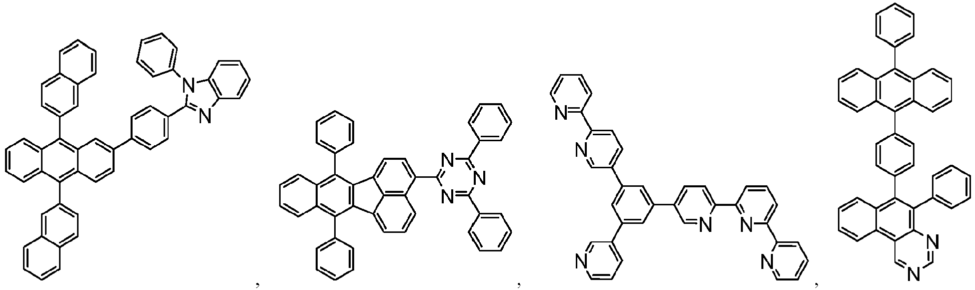

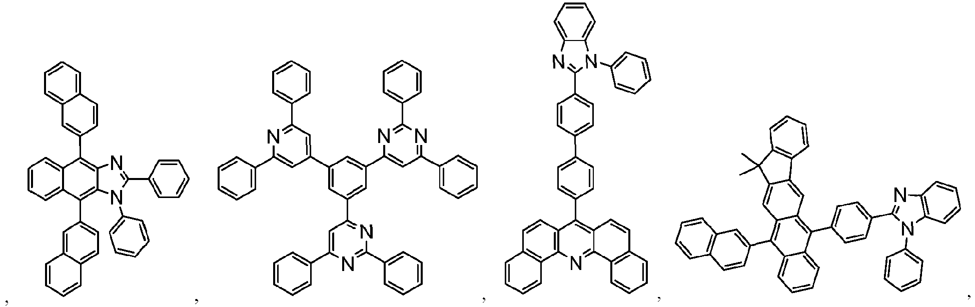

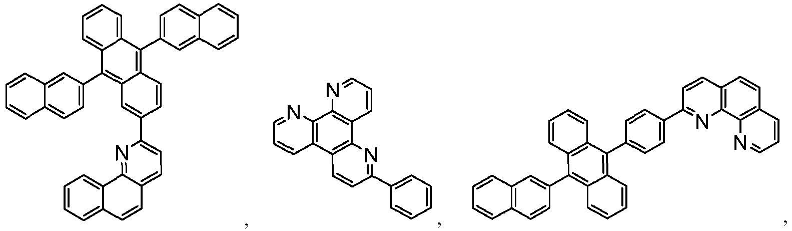

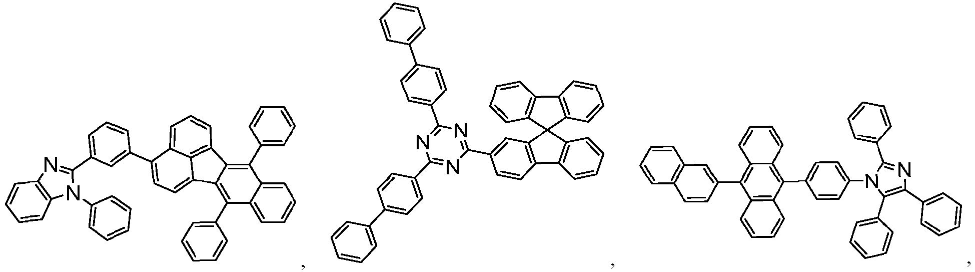

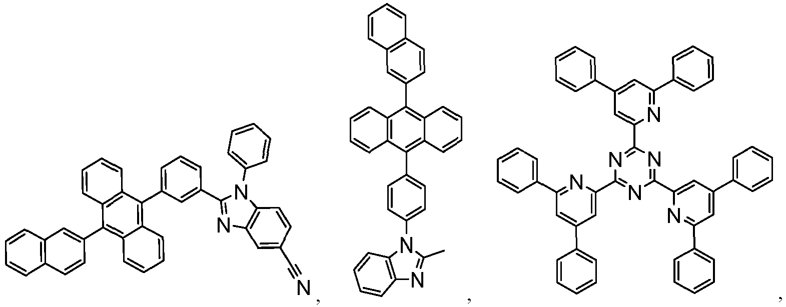

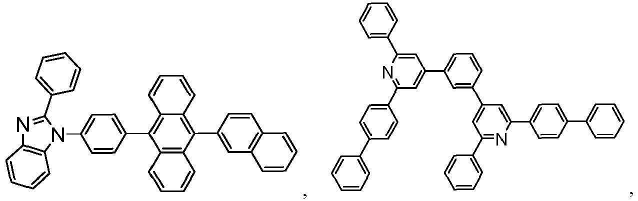

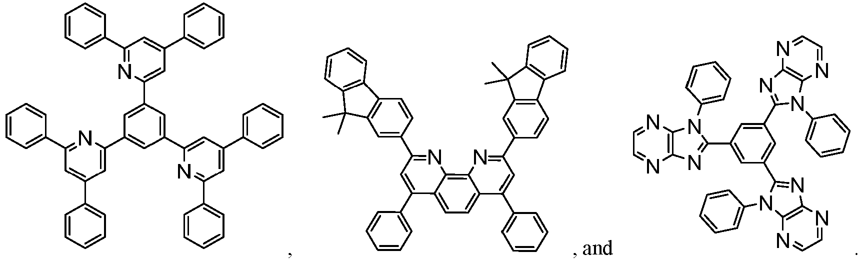

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

### EXPERIMENTAL DATA

OLEDs were grown on a glass substrate pre-coated with an indium-tin-oxide (ITO) layer having a sheet resistance of 15-Ω/sq. Prior to any organic layer deposition or coating, the substrate was degreased with solvents and then treated with an oxygen plasma for 1.5 minutes with 50W at 100 mTorr and with UV ozone for 5 minutes. The devices were fabricated in high vacuum (< 10⁻⁶ Torr) by thermal evaporation. The anode electrode was 750 Å of indium tin oxide (ITO). All devices were encapsulated with a glass lid sealed with an epoxy resin in a nitrogen glove box (<1ppm of H₂O and O₂,) immediately after fabrication with a moisture getter incorporated inside the package. Doping percentages are in volume percent. The devices were grown in several different device structures using the following materials:

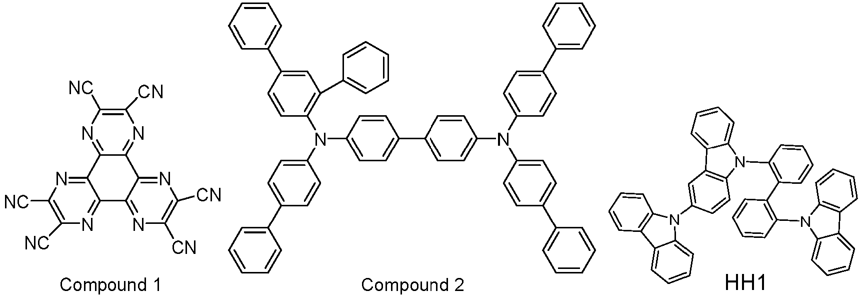

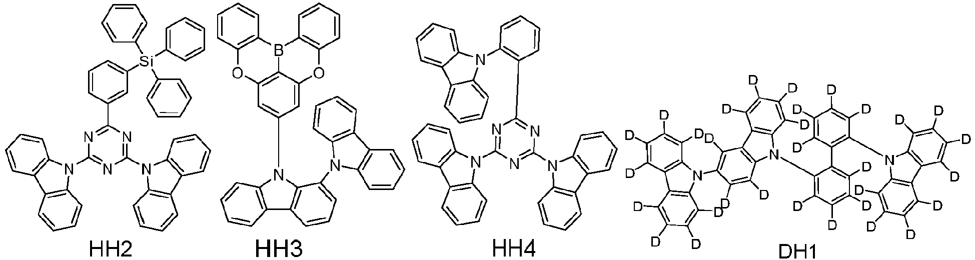

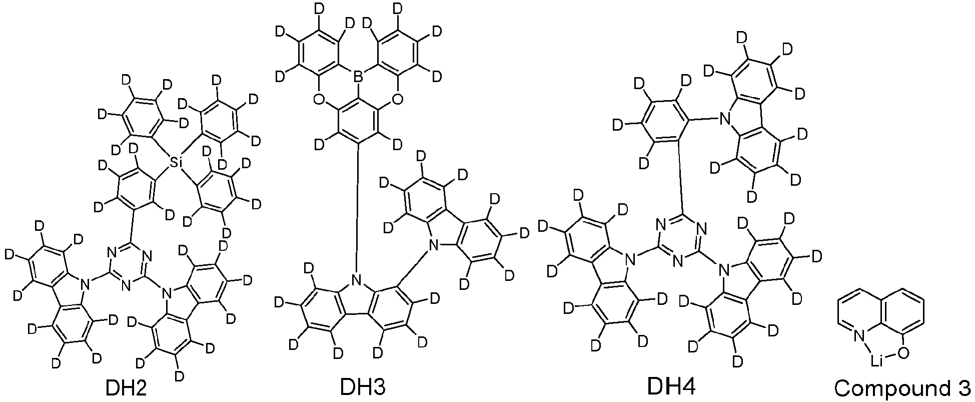

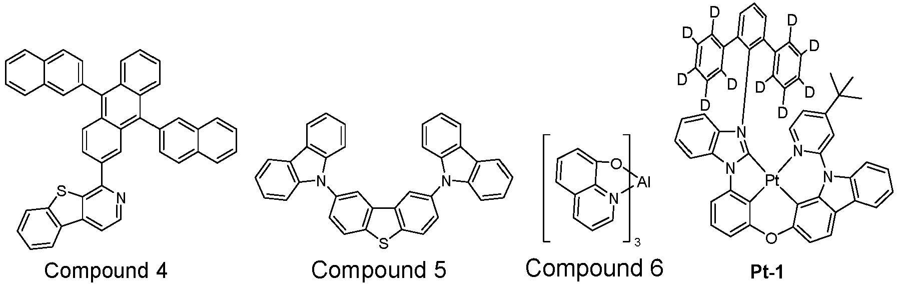

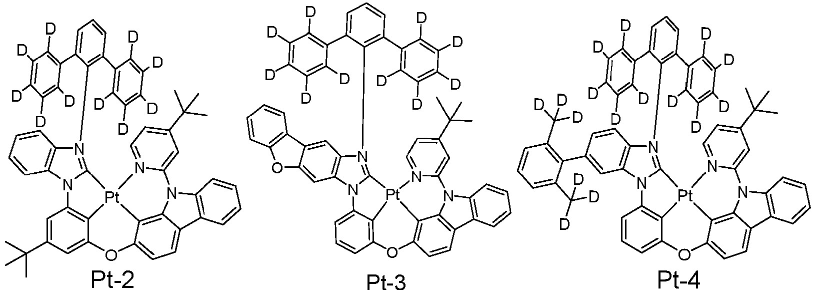

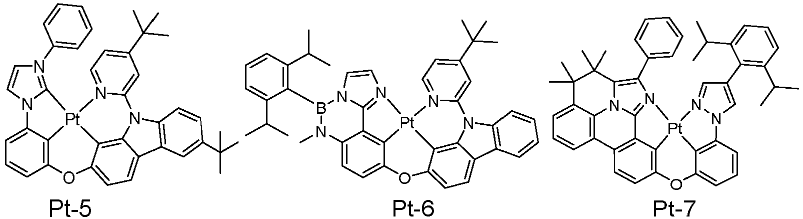

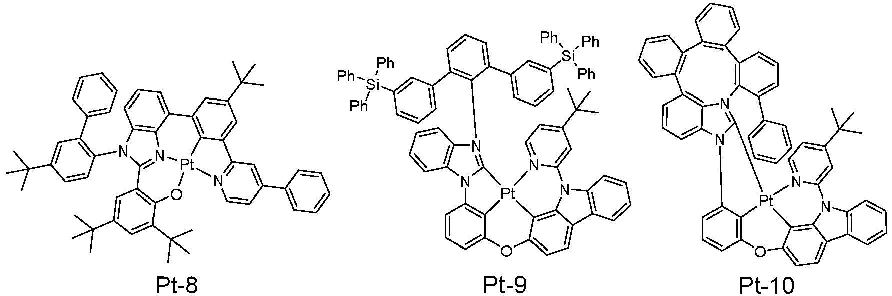

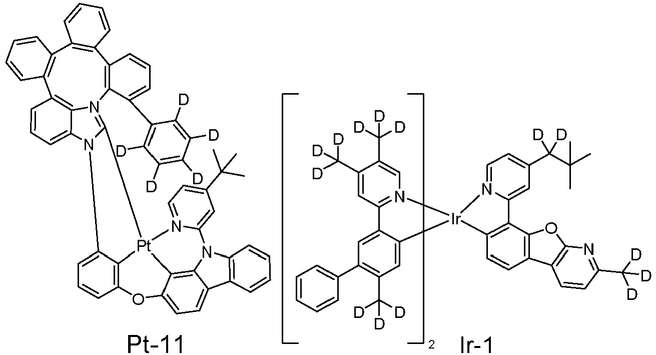

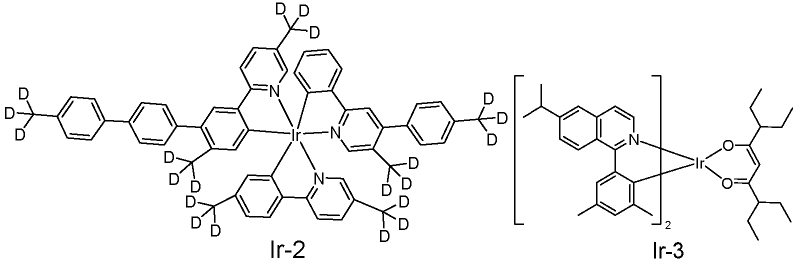

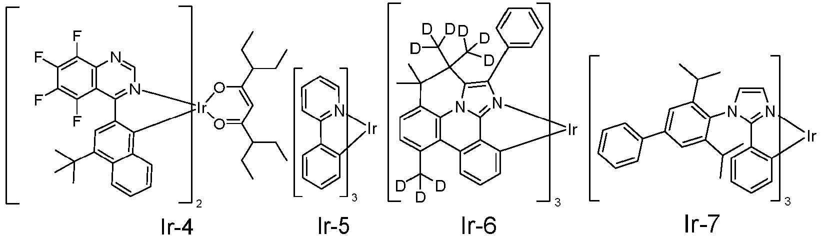

Table 1 shows calculated singlet and triplet energies for DH1 to DH4. Geometry optimization calculations were performed within the Gaussian 09 software package using the B3LYP hybrid functional and CEP-31G basis set which includes effective core potentials. It should be understood that these calculations obtained with the DFT functional set and basis set as identified herein are theoretical. Computational composite protocols, such as Gaussian with the CEP-31G basis set used herein, rely on the assumption that electronic effects are additive and, therefore, larger basis sets can be used to extrapolate to the complete basis set (CBS) limit. However, when the goal of a study is to understand variations in HOMO, LUMO, S₁, T₁, bond dissociation energies, etc. over a series of structurally-related compounds, the additive effects are expected to be similar. Accordingly, while absolute errors from using the B3LYP may be significant compared to other computational methods, the relative differences between the HOMO, LUMO, S₁, T₁, and bond dissociation energy values calculated with B3LYP protocol are expected to reproduce experiment quite well. *See, e.g.,* Hong et al., Chem. Mater. 2016, 28, 5791-98, 5792-93 and Supplemental Information (discussing the reliability of DFT calculations in the context of OLED materials). Moreover, with respect to iridium or platinum complexes that are useful in the OLED art, the data obtained from DFT calculations correlates very well to actual experimental data. *See* Tavasli et al., J. Mater. Chem. 2012, 22, 6419-29, 6422 (Table 3) (showing DFT calculations closely correlating with actual data for a variety of emissive complexes); Morello, G.R., J. Mol. Model. 2017, 23:174 (studying of a variety of DFT functional sets and basis sets and concluding the combination of B3LYP and CEP-31G is particularly accurate for emissive complexes).

**Table 1: Calculated singlet and triplet energies and the corresponding singlet-triplet gaps.**

| Dopant | S1ₕₒₛₜ | T1ₕₒₛₜ | S1ₕₒₛₜ -T1ₕₒₛₜ |
|---|---|---|---|
| DH1 | 3.70 | 3.16 | 0.54 |
| DH2 | 3.50 | 3.13 | 0.37 |
| DH3 | 3.17 | 2.88 | 0.29 |
| DH4 | 3.02 | 2.90 | 0.12 |

The photoluminescent emission spectra of doped PMMA films at room temperature was measured for Pt-1, Pt-2, Pt-3, Pt-4, Pt-5, and Pt-7. The emission spectra of the films were measured on a calibrated Hamamatsu Quantaurus-QY Plus UV-NIR absolute PL quantum yield spectrometer with an excitation wavelength of 340nm. The films were prepared from solutions of 1% emitter by weight with PMMA in toluene which were filtered and dropcast onto Quartz substrates. The corresponding peak emission wavelength (λₘₐₓ) and full width at half maximum (FWHM) are shown in Table 2.

**Table 2: Photoluminescent emission spectral data of 1% doped PMMA films**

| Dopant | λmax (nm) | FWHM |
|---|---|---|
| Pt-1 | 455 | 18 |
| Pt-2 | 460 | 24 |
| Pt-3 | 461 | 19 |
| Pt-4 | 456 | 20 |
| Pt-5 | 448 | 18 |
| Pt-7 | 464 | 47 |

For Examples 1-10 and Comparison 1-2, devices were grown in two different device structures. Device Structure 1 had organic layers consisting of, sequentially, from the ITO surface, 100 Å of Compound 1 (HIL), 250 Å of Compound 2 (HTL), 50 Å of HH1 (EBL), 300 Å of HH1 doped with a fixed percentage of HH2, X% of Dopant (EML), 50A of HH2 (BL), 300 Å of Compound 3 doped with 35% of Compound 4 (ETL), 10 Å of Compound 3 (EIL) followed by 1,000 Å of Al (Cathode). Device Structure 2 had organic layers consisting of, sequentially, from the ITO surface, 100 Å of Compound 1 (HIL), 250 Å of Compound 2 (HTL), 50 Å of HH1 (EBL), 300 Å of DH1 doped with a fixed percentage of DH2, X% of Dopant (EML), 50Å of HH2 (BL), 300 Å of Compound 3 doped with 35% of Compound 4 (ETL), 10 Å of Compound 3 (EIL) followed by 1,000 Å of Al (Cathode). For examples 1-7, examples 10-11, and comparison 1 the doping percentage of HH2 or DH2 was 50%. For examples 8-9 and comparison 2 the doping percentage of HH2 or DH2 was 40%. The dopant and doping concentration for each device are given in Table 4 and Table 5.

For Examples 1-6 and Comparison 1, the measured lifetime (LT90) is the time to reduction of brightness to 90% of the initial luminance at a constant current density of 20mA/cm². The Enhancement Factor reported in Table 3 is the ratio of the LT90 for Device Structure 2 to the LT90 for Device Structure 1.

**Table 3: Enhancement Factors of blue emitting platinum complexes in deuterated hosts**

| | Dopant | Conc. | λmax (nm) | CIE | Enhancement Factor |
|---|---|---|---|---|---|
| Example 1 | Pt-1 | 12% | 462 | (0.138, 0.177) | 1.8 |
| Example 2 | Pt-2 | 12% | 468 | (0.139, 0.230) | 1.9 |
| Example 3 | Pt-3 | 12% | 470 | (0.128, 0.215) | 1.8 |
| Example 4 | Pt-4 | 12% | 463 | (0.135, 0.171) | 1.9 |
| Example 5 | Pt-5 | 12% | 488 | (0.225, 0.373) | 1.6 |
| Example 6 | Pt-6 | 12% | 464 | (0.208, 0.364) | 1.7 |
| Example 7 | Pt-9 | 12% | 461 | (0.135, 0.141) | 2.0 |
| Comparison 1 | Pt-7 | 12% | 467 | (0.140, 0.253) | 1.1 |

The above data shows that device Examples 1-7 each exhibited a larger enhancement from deuteration than Comparison 1. The 60%-100% lifetime enhancement is beyond any value that could be attributed to experimental error and the observed improvement is significant. Based on the fact that the devices have the same structure with the only difference being the selection of phosphorescent dopant, the significant performance improvement observed in the above data was unexpected. Without being bound by any theories, this improvement may be attributed to the suppression of intermolecular decomposition reactions between deuterated hosts and dopants with particular molecular structural motifs or particular emission properties. In Examples 1-5 and Example 7, the phosphors are Pt-complexes comprising metal-carbene bonds and show a larger enhancement from deuteration of the host than the comparison compound in Comparison 1 which does not comprise a carbene. In Example 3, the phosphor comprises a fused-ring structure having four rings fused in a linear fashion and shows a larger enhancement from deuteration of the host than the comparison compound in Comparison 1. In Examples 1-4, the terphenyl substituted carbene phosphors comprise a pendant group comprising at least three 6-membered aromatic rings, each of which is not directly fused to another of the at least three 6-membered aromatic rings, and they each shows a larger enhancement from deuteration of the host than the comparison compound in Comparison 1 which does not comprise a terphenyl substitution. In Examples 1-7, each of the phosphors comprise a carbazole moiety which is directly bonded to the metal and show larger enhancements from deuteration of the host than the comparison compound in Comparison 1 which does not comprise a carbazole moiety. In Example 6, the phosphor comprises a boron atom and shows a larger enhancement from deuteration of the host than the comparison compound in Comparison 1 which does not comprise a boron atom. In Examples 1-7 each phosphor comprises a tetradentate ligand that forms at least three adjacent 5-membered or 6-membered chelate rings with at least two neighboring chelate rings being the same size with one 5-membered chelate and two adjacent 6-membered chelates and each show a larger enhancement from deuteration of the host than the comparison compound in Comparison 1 which does not comprise any two neighboring chelate rings of the same size. In Example 7, the phosphor comprises a silicon atom and shows a larger enhancement from deuteration of the host than the comparison compound in Comparison 1 which does not comprise a silicon atom. In Examples 1-4, the phosphors each comprise deuterated phenyl rings and show larger enhancements from deuteration of the host than the comparison compound in Comparison 1 which does not comprise any deuteration. In Example 5, the phosphor forms an exciplex with the host material and shows a larger enhancement from deuteration of the host than the comparison compound in Comparison 1 which does not form an exciplex with the host. In Examples 1-5, the phosphors each exhibit a full width at half maximum of the emission at λₘₐₓ that is less than 40 nm in a comprise a 1% doped a PMMA film, as shown in Table 2, and they each show a larger enhancement from deuteration of the host than the comparison compound in Comparison 1 which exhibits a full width at half maximum of the emission at λₘₐₓ that is greater than 40 nm.

For Reference Examples 8-11 (each of which fall outside the scope of the present claims) and Comparison 2, the measured lifetime (LT95) is the time to reduction of brightness to 95% of the initial luminance at a constant current density of 60mA/cm². The enhancement factor reported in Table 4 and Table 5 is the ratio of the LT95 for Device Structure 2 to the LT95 for Device Structure 1. The enhancement factors of devices with Ir-1 to Ir-3 and Ir-5 are shown in Table 5.

**Table 4: Enhancement Factors of green and red emitting iridium complexes in deuterated hosts**

| | Dopant | Conc. | λmax (nm) | CIE | Enhancement Factor |
|---|---|---|---|---|---|
| Reference Example 8 | Ir-1 | 12% | 525 | (0.321, 0.644) | 2.1 |
| Reference Example 9 | Ir-2 | 12% | 528 | (0.341, 0.617) | 2.1 |
| Reference Example 10 | Ir-3 | 5% | 625 | (0.685, 0.313) | 2.0 |
| Comparison 2 | Ir-5 | 12% | 515 | (0.292, 0.638) | 1.2 |

The above data shows that the device Reference Example 8-10 all exhibited a large enhancement from deuteration and have enhancement factors 80% larger than Comparison 2. The 20%-110% lifetime enhancement is beyond any value that could be attributed to experimental error and the observed improvement is significant. Based on the fact that the devices Reference Examples 8-10 have the same structure as Comparison 2 with the only difference being the selection of phosphor, the significant performance improvement observed in the above data was unexpected. Without being bound by any theories, this improvement may be attributed to the suppression of intermolecular decomposition reactions between deuterated hosts and dopants with particular molecular structural motifs or particular emission properties. In Reference Example 8, the phosphor comprises a fused-ring structure comprising at least three rings, including at least one 6-membered heteroaryl ring or a fused ring structure comprising a benzene ring directly bonded to the metal and shows a larger enhancement from deuteration of the host than the comparison compound in Comparison 2 which does not contain any fuse ring structure. In Reference Example 9, the phosphor is an Ir(III) complex comprising three different bidentate ligands and shows a larger enhancement upon deuteration of the host than the comparison compound in Comparison 2 which is a homoleptic Ir(III) complex. In Reference Example 10, the phosphor comprises an acetylacetonate ligands and shows a larger enhancement than the comparison compound in Comparison 2 which does not comprise an acetylacetonate ligand.

**Table 5: Enhancement Factor of infrared emitting complex in deuterated hosts**

| | Dopant | Conc. | λmax (nm) | CIE | Enhancement Factor |
|---|---|---|---|---|---|
| Reference Example 11 | Ir-4 | 5% | 738 | (0.354, 0.247) | 1.2 |

The photoluminescent quantum yield (PLQY) of a doped PMMA film at room temperature was measured for Ir-4. The PLQY were measured on a calibrated Hamamatsu Quantaurus-QY Plus UV-NIR absolute PL quantum yield spectrometer with an excitation wavelength of 340nm. The film was prepared from solutions of 1% Ir-4 by weight with PMMA in toluene which was filtered and dropcast onto Quartz substrates. The corresponding peak emission wavelength (λₘₐₓ) and PLQY are shown in Table 6.

**Table 6: λₘₐₓ and PLQY of Ir-4**

| Dopant | λmax (nm) | PLQY |
|---|---|---|
| Ir-4 | 729 | 60% |

In Reference Example 11, the phosphor which has a λₘₐₓ is in the range of 700-1000 nm with a PLQY value of at least 30% in a 1% doped PMMA film, as shown in Table 6, and contains a fluorinated quinazoline which comprises heteroaryl moiety comprising at least two heteroatoms as well as at least one fluorine atom and shows a significant lifetime enhancement when the host is deuterated.

For Reference Example 12 (which falls outside the scope of the claims), devices were grown in two different device structures. Device Structure 3 had organic layers consisting of, sequentially, from the ITO surface, 100 Å of Compound 1 (HIL), 400 Å of Compound 2 (HTL), 50 Å of DH1 (EBL), 400 Å of HH1 doped with 30% HH2, 12% of Pt-8 (EML), 300 Å of Compound 3 doped with 35% of Compound 4 (ETL), 10 Å of Compound 3 (EIL) followed by 1,000 Å of Al (Cathode). Device Structure 4 had organic layers consisting of, sequentially, from the ITO surface, 100 Å of Compound 1 (HIL), 400 Å of Compound 2 (HTL), 50 Å of DH1 (EBL), 400 Å of DH1 doped with 30% DH2, 12% of Pt-8 (EML), 300 Å of Compound 3 doped with 35% of Compound 4 (ETL), 10 Å of Compound 3 (EIL) followed by 1,000 Å of Al (Cathode). The measured lifetime (LT95) is the time to reduction of brightness to 95% of the initial luminance at a constant current density of 80mA/cm². The Enhancement Factor reported in Table 7 is the ratio of the LT95 for Device Structure 4 to the LT95 for Device Structure 3.

**Table 7: Enhancement Factor of Pt-8**

| | Dopant | λmax (nm) | CIE | Enhancement Factor |
|---|---|---|---|---|
| Reference Example 12 | Pt-8 | 528 | (0.328, 0.635) | 1.8 |

The above data shows that the device Reference Example 12 exhibited a larger lifetime enhancement than Comparison 2. The 80% lifetime enhancement is beyond any value that could be attributed to experimental error and the observed improvement is significant. Based on the fact that Reference Example 12 uses the same host materials as Comparison 2 with the major difference between the devices being the selection of phosphor, the significant performance improvement observed in the above data was unexpected. Without being bound by any theories, this improvement may be attributed to the suppressed reactivity of deuterated hosts with Pt-8 which has a tetradentate ligand comprising a coordinating oxygen atom trans to a coordinating carbon atom. Furthermore, the vertical dipole ratio (VDR) for Pt-8 is less than 0.15 which shows that this phosphor with a λmax at 528nm and a VDR less than 0.15 shows a larger enhancement in lifetime from deuteration of the hosts than Comparison 2 which has a VDR greater than 0.15.

For Examples 13 devices were grown in two different device structures. Device Structure 5 had organic layers consisting of, sequentially, from the ITO surface, 100 Å of Compound 1 (HIL), 250 Å of Compound 2 (HTL), 50 Å of HH1 (EBL), 300 Å of HH1 doped with 30% HH3, 12% of Pt-2 (EML), 50Å of HH3 (BL), 300 Å of Compound 3 doped with 35% of Compound 4 (ETL), 10 Å of Compound 3 (EIL) followed by 1,000 Å of Al (Cathode). Device Structure 6 had organic layers consisting of, sequentially, from the ITO surface, 100 Å of Compound 1 (HIL), 250 Å of Compound 2 (HTL), 50 Å of HH1 (EBL), 300 Å of HH1 doped with 30% DH3, 12% of Pt-2 (EML), 50Å of HH3 (BL), 300 Å of Compound 3 doped with 35% of Compound 4 (ETL), 10 Å of Compound 3 (EIL) followed by 1,000 Å of Al (Cathode). The measured lifetime (LT90) is the time to reduction of brightness to 90% of the initial luminance at a constant current density of 20mA/cm2. The Enhancement Factor reported in Table 8 is the ratio of the LT90 for Device Structure 6 to the LT90 for Device Structure 5.

**Table 8: Relative lifetime of Pt-2 in deuterated boron containing host**

| | Dopant | λmax (nm) | CIE | Enhancement Factor |
|---|---|---|---|---|
| Example 13 | Pt-2 | 467 | (0.130, 0.196) | 1.3 |

The above data shows that device Example 13 exhibited an elongated lifetime compared to the device without deuteration of the host. The 30% lifetime enhancement is beyond any value that could be attributed to experimental error and the observed improvement is significant. Without being bound by any theories, this improvement may be attributed to the suppressed reactivity of deuterated boron containing host with the phosphor.

For Examples 14, devices were grown in two different device structures. Device Structure 7 had organic layers consisting of, sequentially, from the ITO surface, 100 Å of Compound 1 (HIL), 250 Å of Compound 2 (HTL), 50 Å of DH1 (EBL), 300 Å of HH1 doped with 50% HH4, 12% of Pt-2 (EML), 50Å of DH4 (BL), 300 Å of Compound 3 doped with 35% of Compound 4 (ETL), 10 Å of Compound 3 (EIL) followed by 1,000 Å of Al (Cathode). Device Structure 8 had organic layers consisting of, sequentially, from the ITO surface, 100 Å of Compound 1 (HIL), 250 Å of Compound 2 (HTL), 50 Å of DH1 (EBL), 300 Å of DH1 doped with 50% DH4, 12% of Pt-2 (EML), 50Å of DH4 (BL), 300 Å of Compound 3 doped with 35% of Compound 4 (ETL), 10 Å of Compound 3 (EIL) followed by 1,000 Å of Al (Cathode). The measured lifetime (LT90) is the time to reduction of brightness to 90% of the initial luminance at a constant current density of 20mA/cm². The Enhancement Factor reported in Table 9 is the ratio of the LT90 for Device Structure 8 to the LT90 for Device Structure 7.

**Table 9: Relative lifetime of Pt-2 in deuterated TADF host**

| | Dopant | λmax (nm) | CIE | Enhancement Factor |
|---|---|---|---|---|
| Example 14 | Pt-2 | 468 | (0.147, 0.241) | 2.8 |

The above data shows that the device Example 14 exhibited an elongated lifetime compared with deuteration of the host. The 180% lifetime enhancement is beyond any value that could be attributed to experimental error and the observed improvement is significant. The enhancement in Example 14 using DH4, which has a small S1ₕₒₛₜ -T1ₕₒₛₜ, is much larger than any of those observed in using DH2, which has a larger S1ₕₒₛₜ -T1ₕₒₛₜ. Based on the fact that DH4 and DH2 have the similar structure with the main difference being the smaller S1ₕₒₛₜ -T1ₕₒₛₜ for DH4, the significant performance improvement observed in the above data was unexpected. Without being bound by any theories, this improvement may be attributed to the suppressed reaction between the deuteration host and platinum complex being particularly impactful when the host has a difference between S1ₕₒₛₜ -T1ₕₒₛₜ that is less than 0.30 eV.

For Examples 15-16 devices were grown in two different device structures. Device Structure 9 had organic layers consisting of, sequentially, from the ITO surface, 100 Å of Compound 1 (HIL), 250 Å of Compound 2 (HTL), 50 Å of DH1 (EBL), 300 Å of HH1 doped with 52% HH2, 13% of dopant (EML), 50Å of DH2 (BL), 300 Å of Compound 3 doped with 35% of Compound 4 (ETL), 10 Å of Compound 3 (EIL) followed by 1,000 Å of Al (Cathode). Device Structure 10 had organic layers consisting of, sequentially, from the ITO surface, 100 Å of Compound 1 (HIL), 250 Å of Compound 2 (HTL), 50 Å of DH1 (EBL), 300 Å of DH1 doped with 52% DH2, 13% of dopant (EML), 50Å of DH2 (BL), 300 Å of Compound 3 doped with 35% of Compound 4 (ETL), 10 Å of Compound 3 (EIL) followed by 1,000 Å of Al (Cathode). The measured lifetime (LT90) is the time to reduction of brightness to 90% of the initial luminance at a constant current density of 20mA/cm2. The Enhancement Factor reported in Table 10 is the ratio of the LT90 for Device Structure 10 to the LT90 for Device Structure 9.

**Table 10: Enhancement Factors of blue emitting complexes in deuterated hosts**

| | Dopant | λmax (nm) | CIE | Enhancement Factor |
|---|---|---|---|---|
| Example 15 | Pt-10 | 461 | (0.142, 0.153) | 2.3 |
| Example 16 | Pt-11 | 468 | (0.142, 0.155) | 1.9 |

In Examples 15-16, each exhibited a larger enhancement from deuteration than Comparison 1. The 90%-130% lifetime enhancement is beyond any value that could be attributed to experimental error and the observed improvement is significant. Based on the fact that the devices have similar structures with the primary difference being the selection of phosphorescent dopant, the significant performance improvement observed in the above data was unexpected. Without being bound by any theories, this improvement may be attributed to the suppression of intermolecular decomposition reactions between deuterated hosts and dopants with particular molecular structural motifs or particular emission properties. Both Pt-10 and Pt-11 comprise a 9 membered ring and show larger enhancements from deuteration of the host than the comparison compound in Comparison 1 which does not have a ring comprising 7 or more atoms.

Comparing Example 15 to Example 16, the device with Pt-10 shows a larger enhancement than the device with Pt-11. Based on the fact that the phosphorescent dopants have an identical structure with the only difference being that Pt-10 contains more deuterium atoms than Pt-11, the significant performance improvement observed in the above data was unexpected. Without being bound by any theories, the larger enhancement factor for Pt-10 may originate by removal of additional hydrogen atoms from the EML. In some embodiments the preferred emitting complex has more than 20% of the protons deuterated, more preferably more than 50% of the protons deuterated, most preferably more than 75% of the proton deuterated.

For Reference Example 17 (which falls outside the scope of the claims) and Comparison 3 devices were grown in two different device structures. Device Structure 11 had organic layers consisting of, sequentially, from the ITO surface, 100 Å of Compound 1 (HIL), 250 Å of Compound 2 (HTL), 300 Å of HH1 with X% of Dopant (EML), 50Å of Compound 5 (BL), 300 Å of Compound 6 (ETL), 10 Å of Compound 3 (EIL) followed by 1,000 Å of Al (Cathode). Device Structure 12 had organic layers consisting of, sequentially, from the ITO surface, 100 Å of Compound 1 (HIL), 250 Å of Compound 2 (HTL), 300 Å of DH1 with X% of Dopant (EML), 50Å of Compound 5 (BL), 300 Å of Compound 6 (ETL), 10 Å of Compound 3 (EIL) followed by 1,000 Å of Al (Cathode). The dopant and doping concentration for each device are given in Table 11. The measured lifetime (LT90) is the time to reduction of brightness to 90% of the initial luminance at a constant current density of 20mA/cm2. The Enhancement Factor reported in Table 10 is the ratio of the LT90 for Device Structure 12 to the LT90 for Device Structure 11.

**Table 11: Enhancement Factors of blue emitting complexes in deuterated hosts**

| | Dopant | Conc. | λmax (nm) | CIE | Enhancement Factor |
|---|---|---|---|---|---|
| Reference Example 17 | Ir-6 | 18% | 472 | (0.152, 0.320) | 1.9 |
| Comparison 3 | Ir-7 | 20% | 474 | (0.173, 0.392) | 1.3 |

The above data shows that the device Reference Example 17 exhibited a large enhancement from deuteration of the host and has 60% more enhancement than Comparison 2. The 90% lifetime enhancement is beyond any value that could be attributed to experimental error and the observed improvement is significant. Based on the fact that Ir-6 has a similar structure to Ir-7 with the primary difference being the fused ring structure of Ir-6, the significant performance improvement observed in the above data was unexpected. Without being bound by any theories, this improvement may be attributed to the suppression of intermolecular decomposition reactions between deuterated hosts and dopants with a fused ring structure comprising 4 or more fused rings and Reference Example 17 shows a larger enhancement from deuteration of the host than the comparison compound in Comparison 3 which does not contain any fused ring structure.

In each of the Examples/Reference Examples 1-17 and Comparison 1-3 the devices tested contain hosts with deuterated carbazole and all showed significant enhancement in device lifetime. Without being bound by any theories, this improvement may be attributed to the suppressed reactivity of deuterated carbazole with the dopants, and particular dopant chemistry shown in Examples/Reference Examples 1-17 show significantly larger enhancements than Comparison 1-3. In Examples/Reference Examples 1-13 and Examples 15-16 the deuterated host has a difference between S1ₕₒₛₜ -T1ₕₒₛₜ which is greater than 0.25 eV and less than 1.50 eV. Reference Example 12 and Examples 14-16 further comprise a blocking layer comprising a deuterated material each of which has amongst the largest enhancement factors.

## Claims

1. An organic electroluminescent device (OLED) (100, 200) comprising:
an anode (115, 230);
a cathode (160, 215); and
an emissive layer (135, 220), disposed between the anode (115, 230) and the cathode (160, 215);
wherein the emissive layer (135, 220) comprises a first phosphorescent emitter and a first host;
wherein the first phosphorescent emitter is a metal complex;
wherein the first host is partially or fully deuterated; and
**characterized in that** the metal complex is a Pt complex and at least two of the following conditions are true:
(1) the metal complex comprises a metal-carbene bond;
(2) the metal complex comprises a pendant group comprising at least three 6-membered aromatic rings, each of which is not directly fused to another of the at least three 6-membered aromatic rings; and
(3) the emissive layer further comprises a second host, wherein the second host is partially or fully deuterated.

2. An organic electroluminescent device (OLED) (100, 200) comprising:
an anode (115, 230);
a cathode (160, 215); and
an emissive layer (135, 220), disposed between the anode (115, 230) and the cathode (160, 215);
wherein the emissive layer (135, 220) comprises a first phosphorescent emitter, a first host and a second host;
wherein the first host is partially or fully deuterated;
wherein the second host is partially or fully deuterated; and
**characterized in that** the first phosphorescent emitter is a metal complex that comprises at least one feature selected from the group consisting of: a fused-ring structure having at least four rings fused in a linear fashion; a carbazole moiety which is directly bonded to the metal; or a ring structure comprising 7 or more atoms.

3. The OLED of claim 1, wherein the carbene is substituted by a substituent R, wherein the substituent R is partially or fully deuterated, wherein the substituent R comprises at least two 6-membered aromatic rings, each of which is not directly fused to the other 6-membered aromatic ring.

4. The OLED of claim 2, wherein the metal complex comprises at least one feature selected from the group consisting of: a fused-ring structure having at least four rings fused in a linear fashion; or a carbazole moiety which is directly bonded to the metal.

5. The OLED of claim 1 or claim 2, wherein the first host comprises a boryl moiety, wherein the boryl moiety is a three-valence boron atom, wherein the boron atom is in one of the rings' backbone; the boron atom is in two of the rings' backbones; or the boron atom is in three of the rings' backbones.

6. The OLED of claim 1 or claim 2, wherein the first host is at least 10% deuterated.

7. The OLED of claim 1 or claim 2, wherein the metal complex is a platinum complex, and the first host comprises a moiety selected from the group consisting of triazine, pyridine, pyrimidine, pyrazine, pyridazine, dibenzofuran, dibenzothiophene, aza-dibenzofuran, aza-dibenzothiophene, triphenylene, aza-triphenylene, carbazole, indolocarbazole, aza-carbazole, aza-indolocarbazole, silyl, and boryl.

8. The OLED of claim 1 or claim 2, wherein the metal complex comprises at least one moiety selected from the group consisting of a partially deuterated alkyl group, partially deuterated cycloalkyl group, a partially deuterated aryl or heteroaryl group, a fully deuterated alkyl group, and fully deuterated aryl or heteroaryl group.

9. The OLED of claim 1 or claim 2, wherein the first host is selected from the group consisting of: 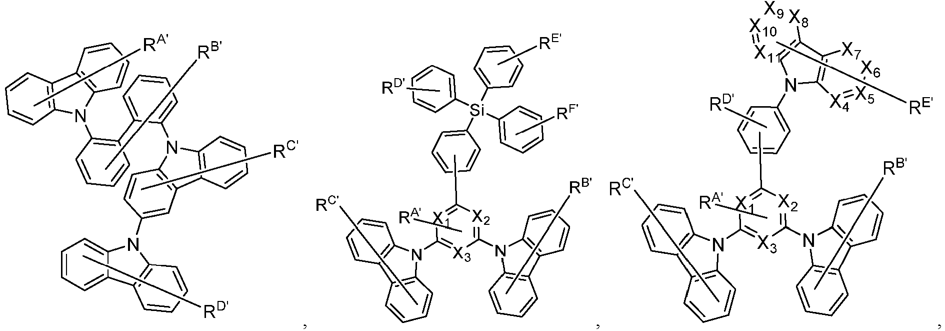 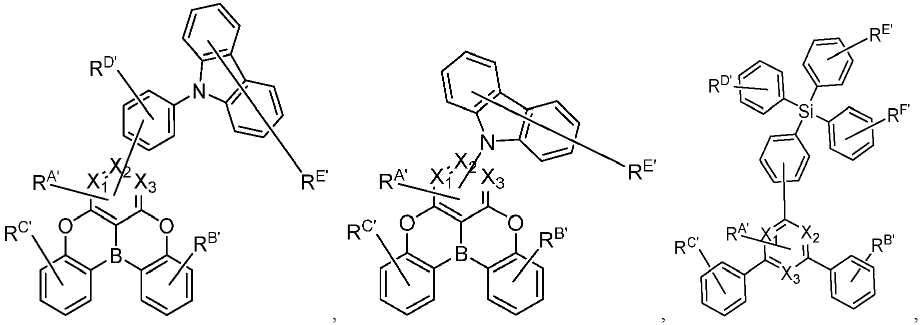 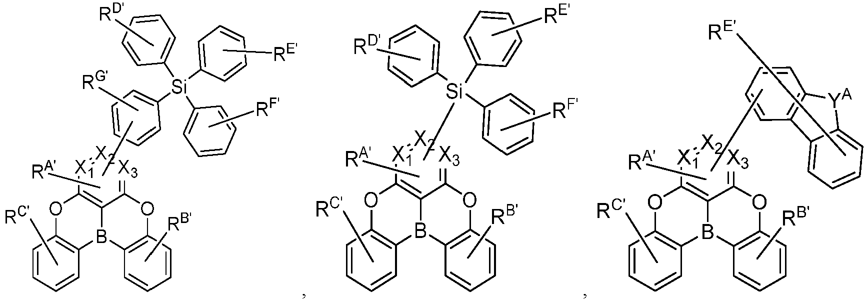 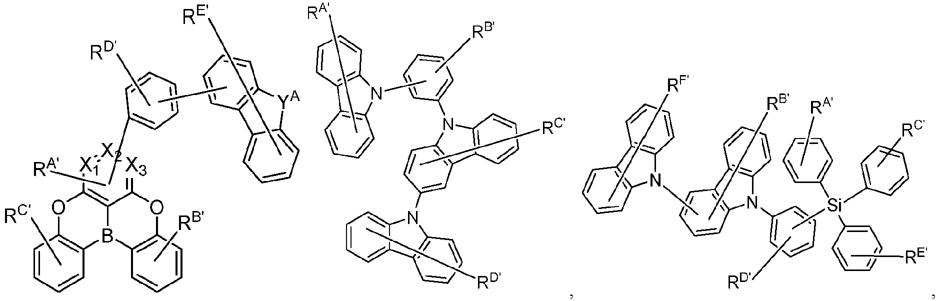 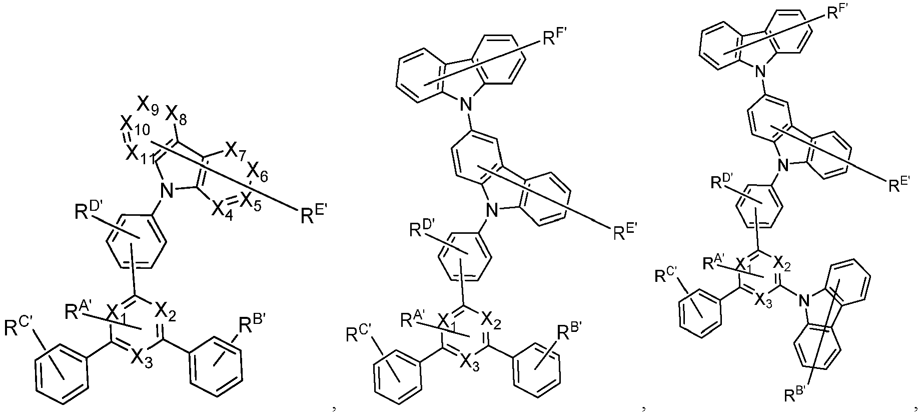 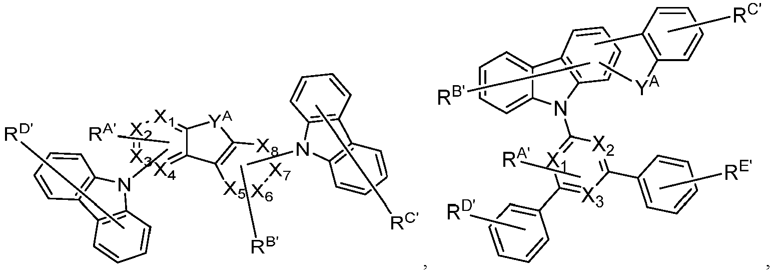 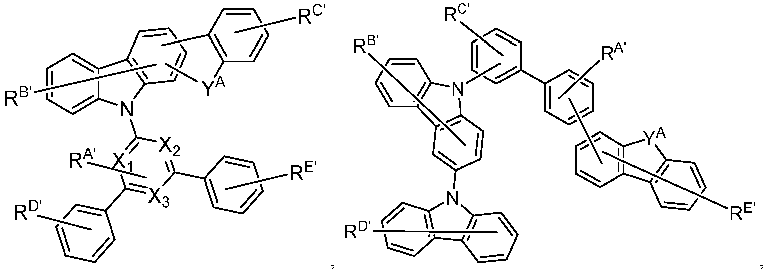 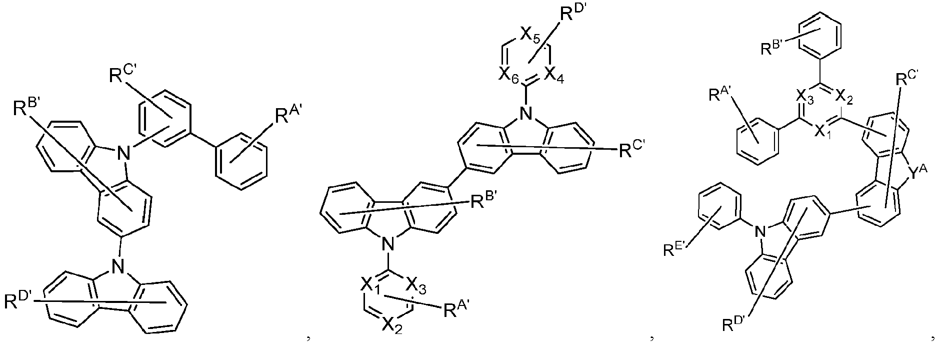 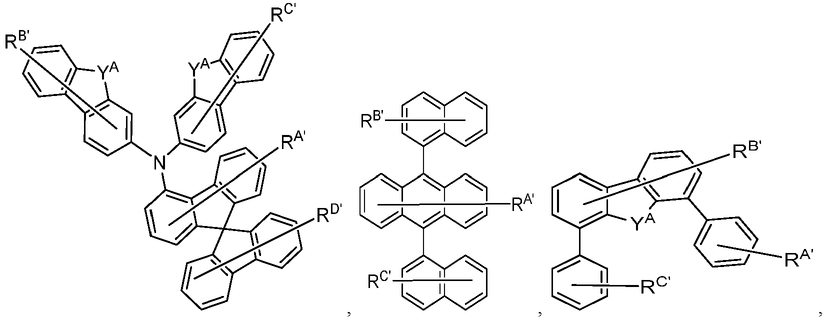 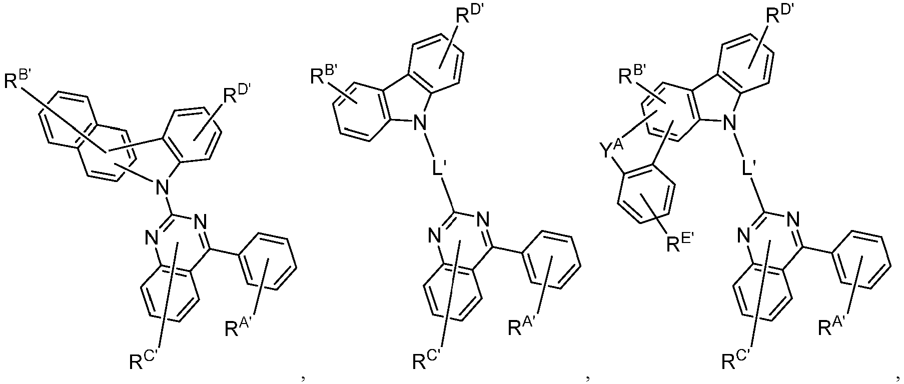 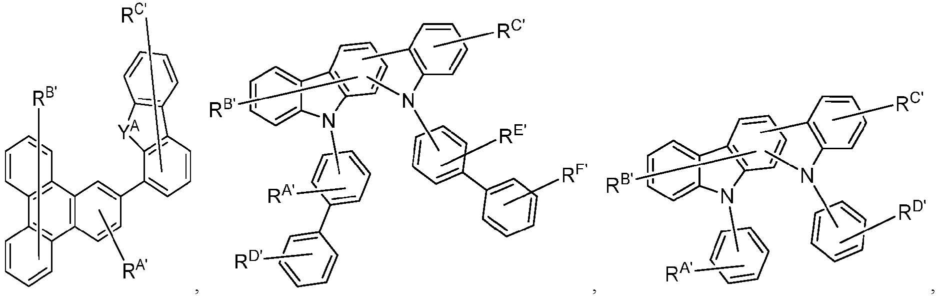 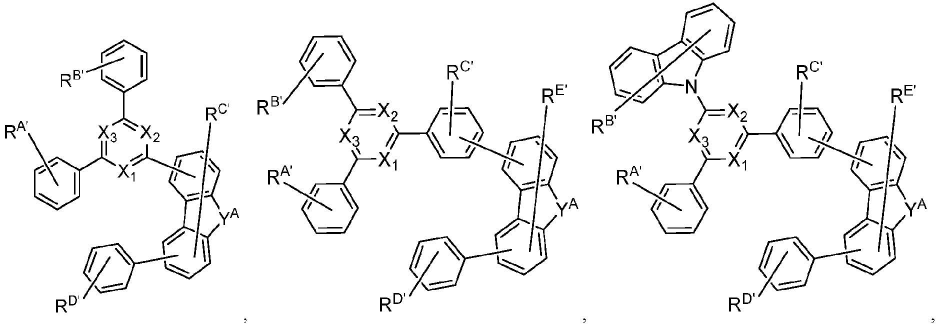 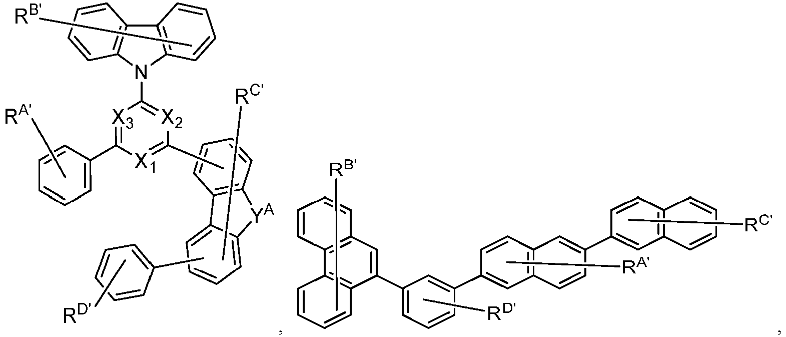 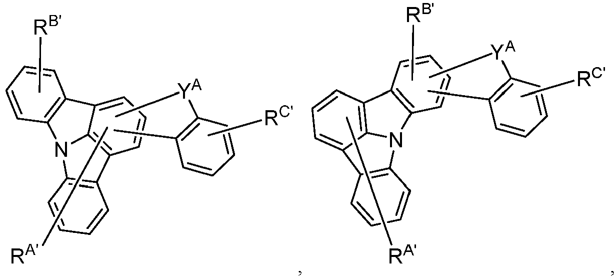 and 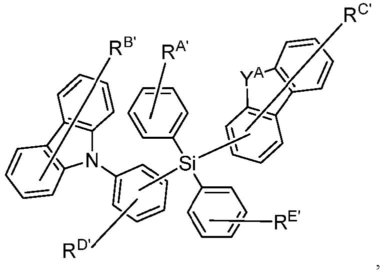 wherein:
each of X₁ to X₁₁ is independently C or N;
each Y^{A} is independently absent or, when present, is selected from the group consisting of O, S, Se, CRR', SiRR', NR, BR, BRR';
each of R^{A'}, R^{B'}, R^{C'}, R^{D'}, R^{E'}, R^{F'}, and R^{G'} independently represents mono-, up to the maximum substitutions, or no substitutions;
each of R, R', R^{A'}, R^{B'}, R^{C'}, R^{D'}, R^{E'}, R^{F'}, and R^{G'} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, boryl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
at least one R, R', R^{A'}, R^{B'}, R^{C'}, R^{D'}, R^{E'}, R^{F'}, or R^{G'} comprises deuterium.

10. The OLED of claim 1 or claim 2, wherein the metal complex has a structure M(L_{A})ₚ(L_{B})_{q}(L_{C})ᵣ, wherein p is 1, 2, or 3; q is 0, 1, or 2; r is 0, 1, or 2; and p+q+r is the oxidation state of the metal M;
Ligand L_{A} comprises a moiety selected from the group consisting of: 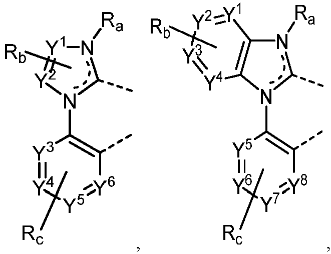 and 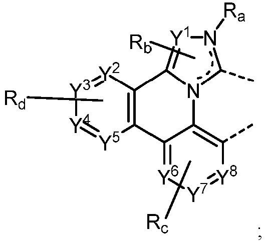 wherein:
each of Y¹ to Y⁸ is independently C or N;
each of R^{b}, R^{c}, and R^{d} independently represents mono-, up to the maximum substitutions, or no substitutions;
each R^{a}, R^{b}, R^{c}, and R^{d} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof,
and each of ligand L_{B} and ligand L_{C} is independently selected from the group consisting of: 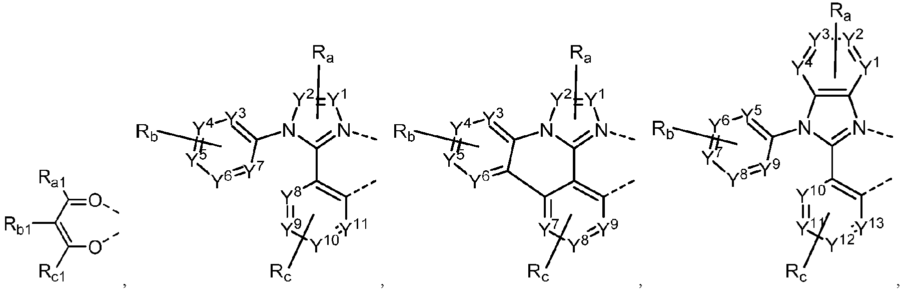 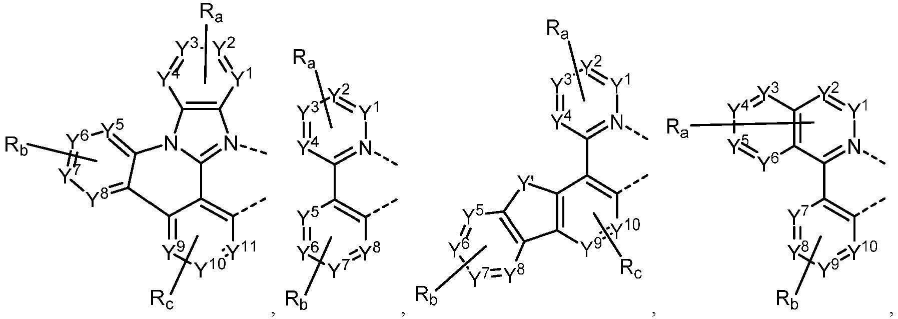 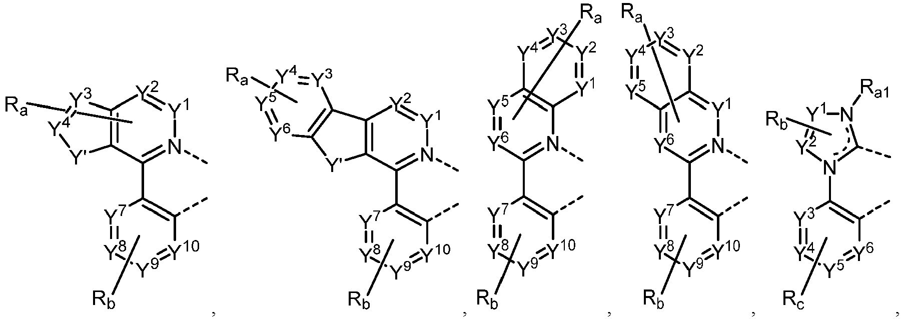 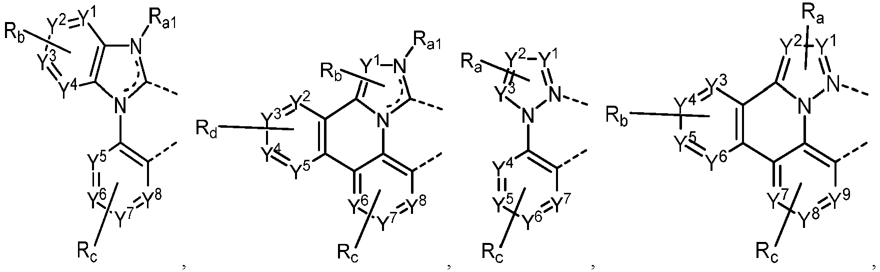 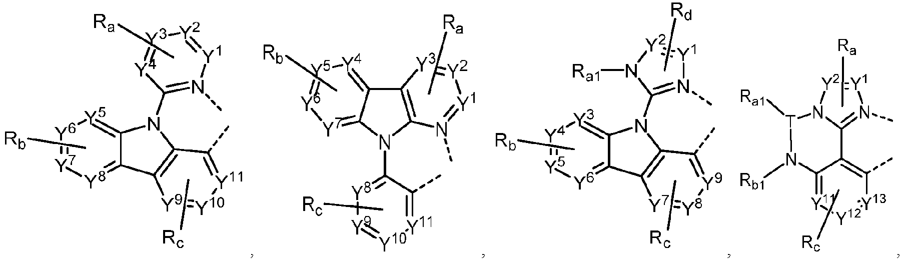 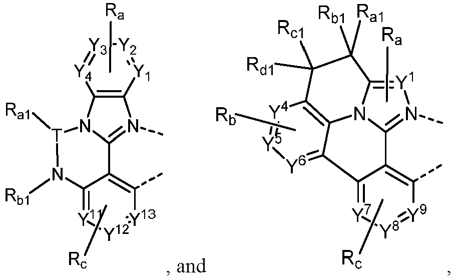
wherein:
T is selected from the group consisting of B, Al, Ga, and In;
each of Y¹ to Y¹³ is independently selected from the group consisting of carbon and nitrogen;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents zero, mono, or up to a maximum allowed number of substitutions to its associated ring;
each of Rₐ₁, R_{b1}, R_{c1}, R_{d1}, Rₐ, R_{b}, R_{c}, R_{d}, Rₑ and R_{f} is independently a hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, and combinations thereof; and
any two adjacent Rₐ, R_{b}, R_{c}, Rₐ, Rₑ and R_{f} can be fused or joined to form a ring or form a multidentate ligand.

11. The OLED of claim 1 or claim 2, wherein the second host is selected from the group consisting of: 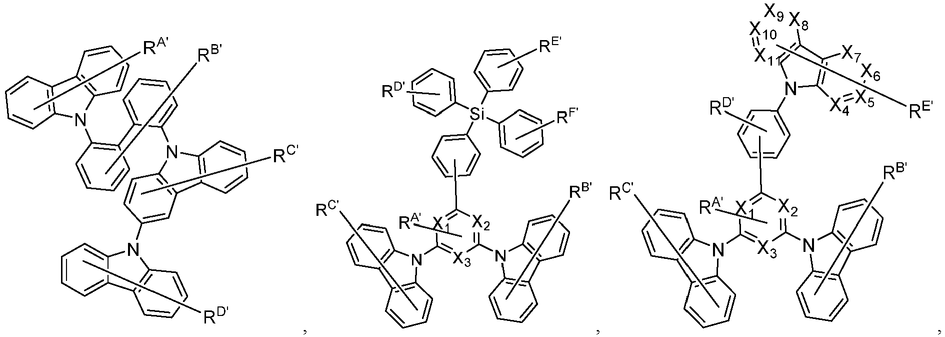 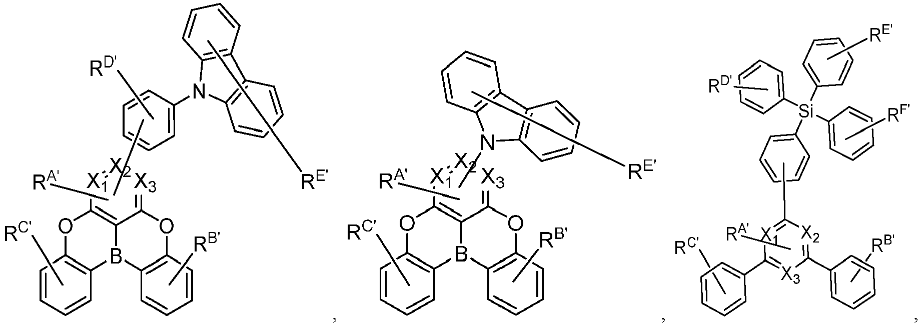 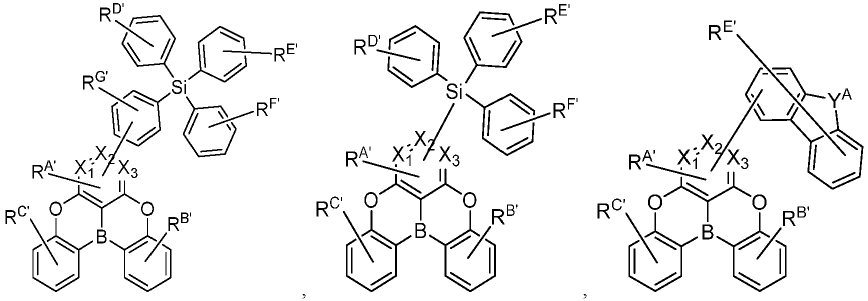 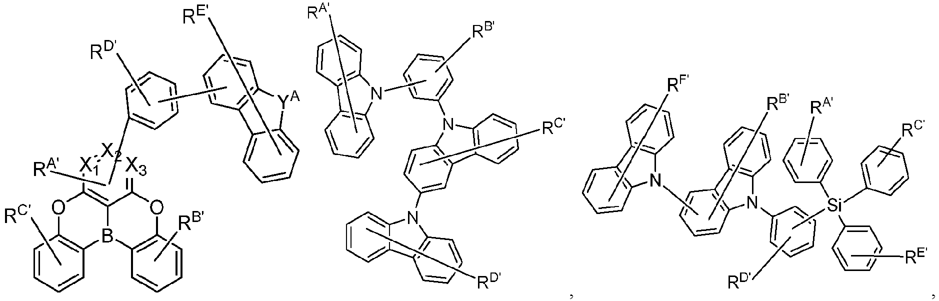 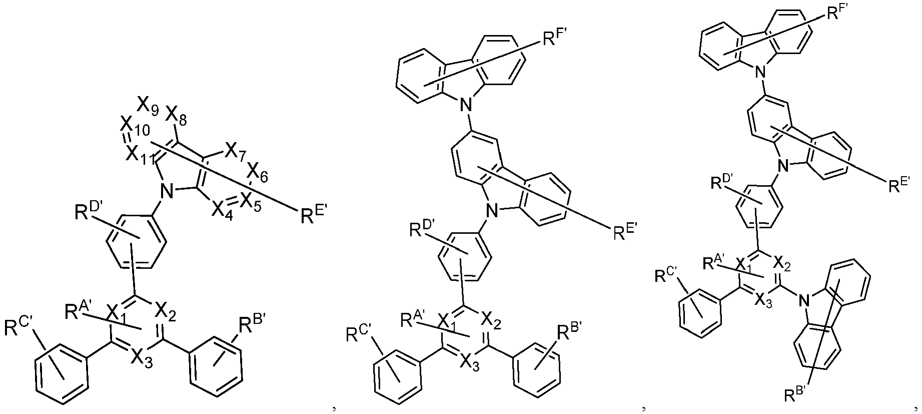 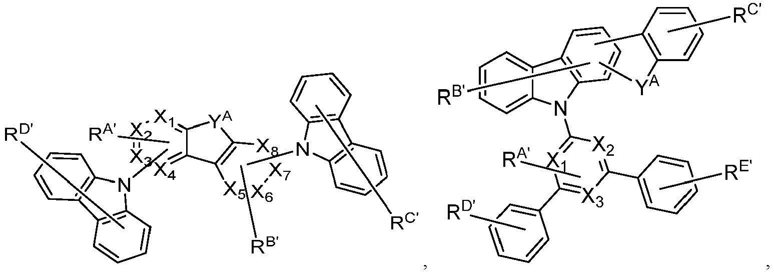 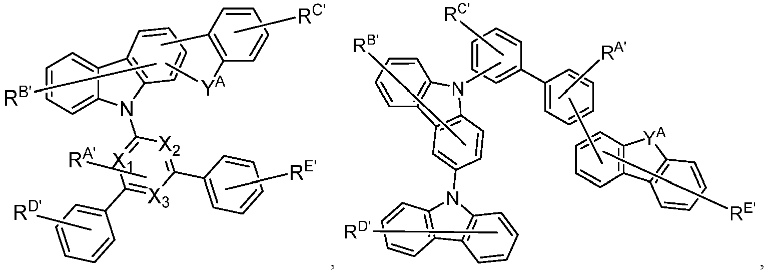 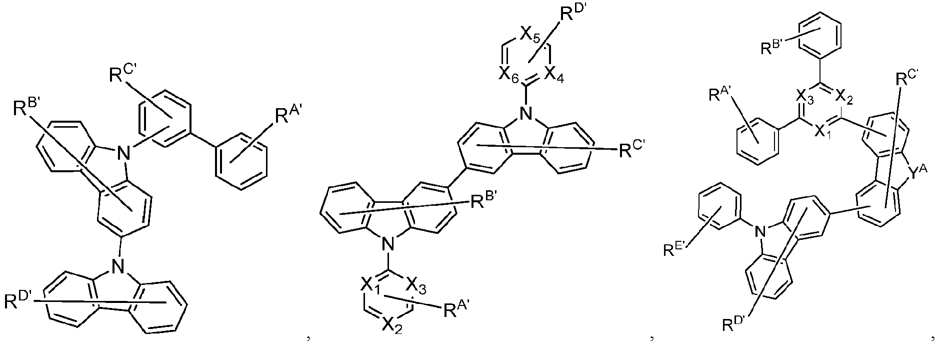 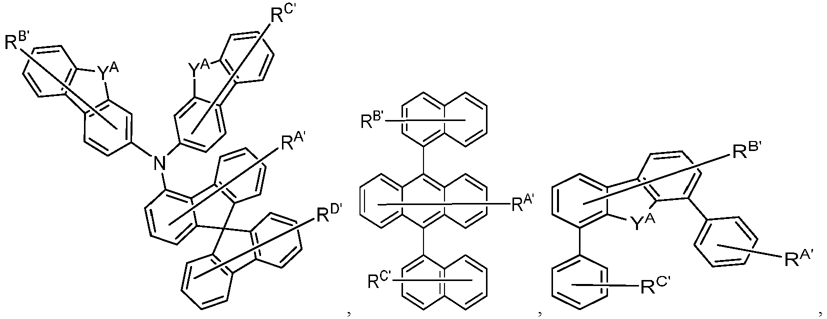 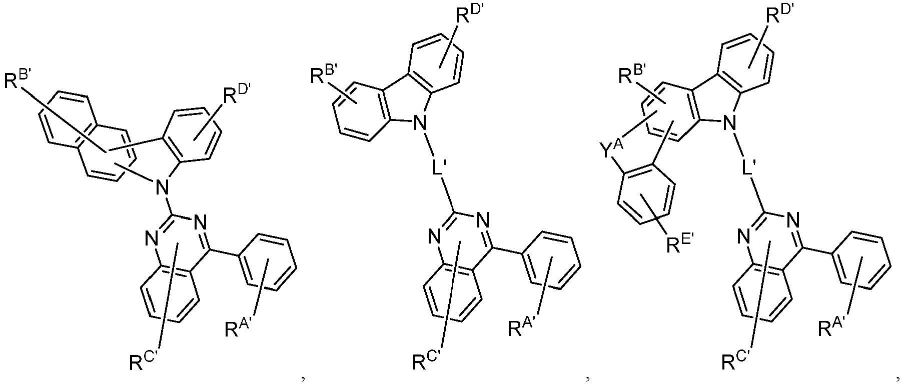 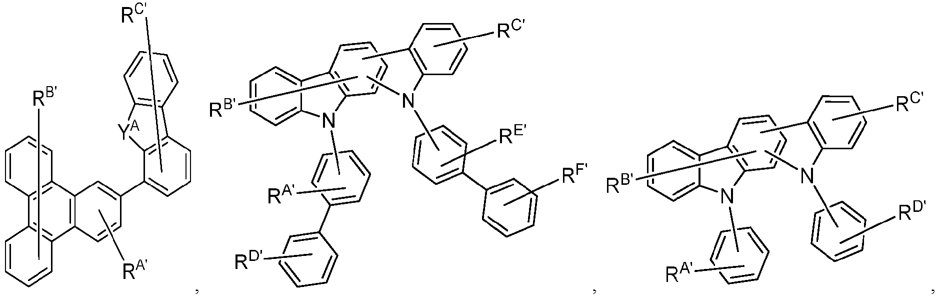 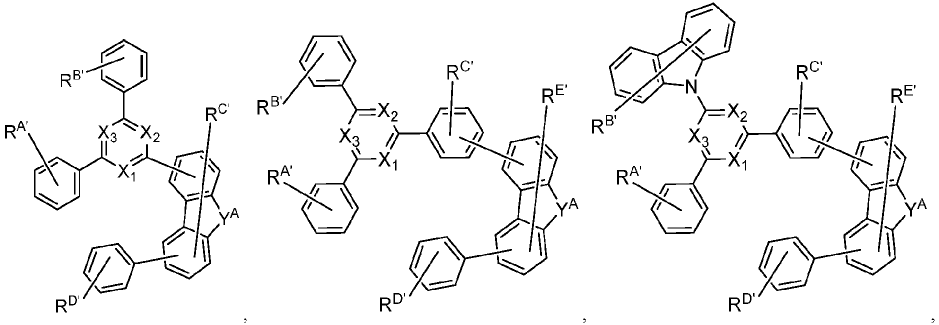 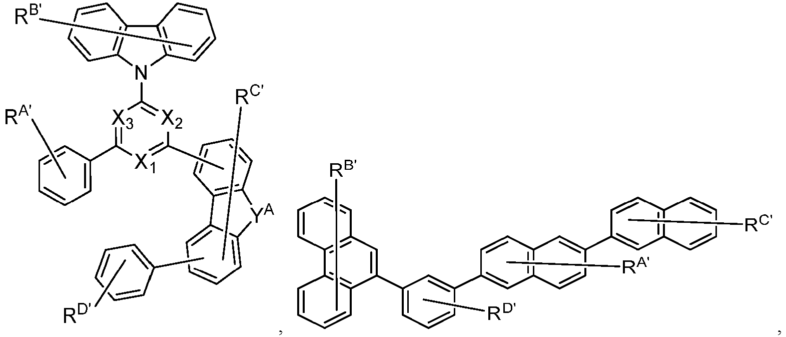 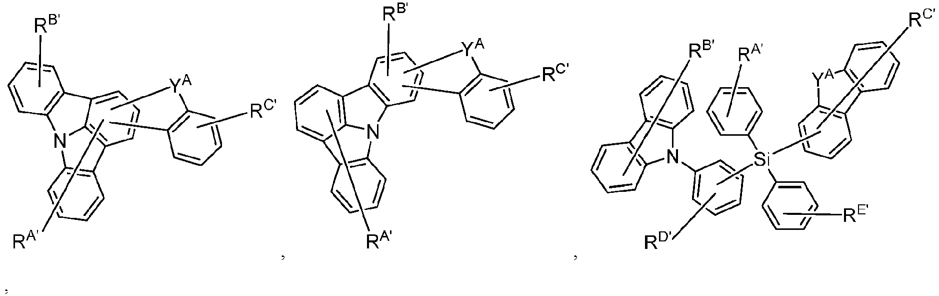 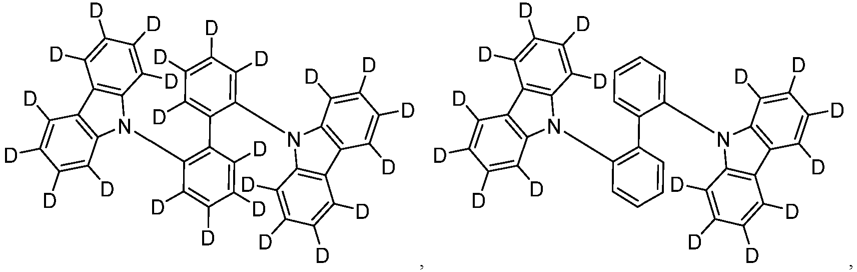 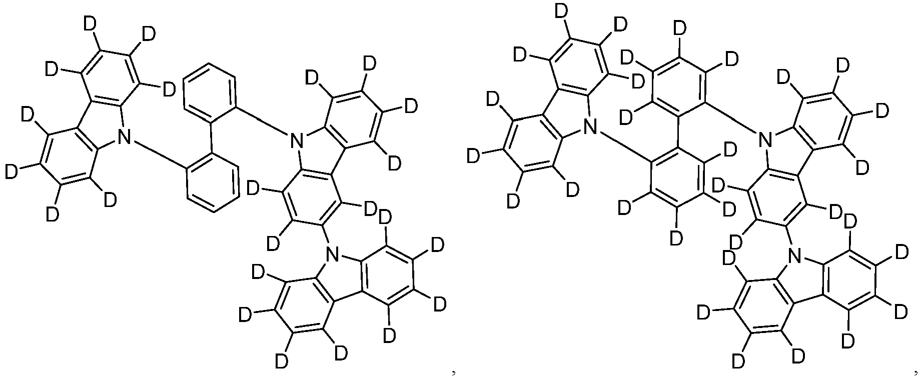 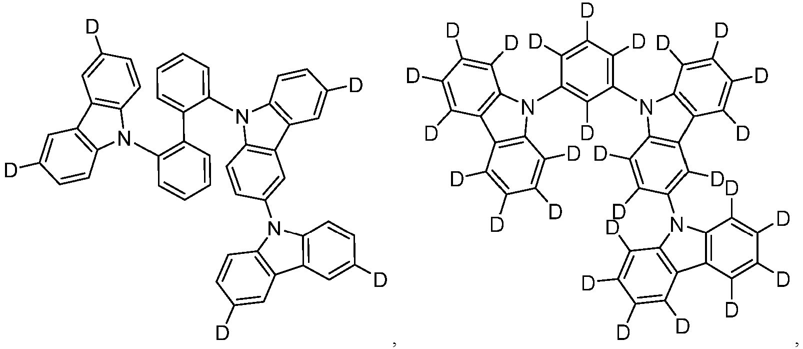 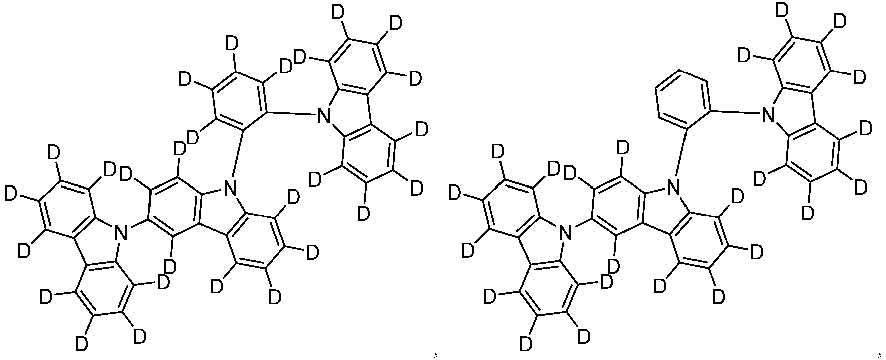 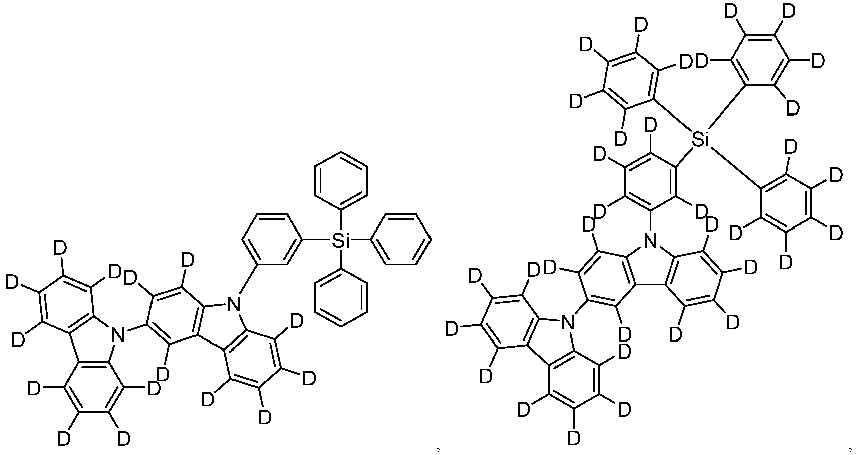 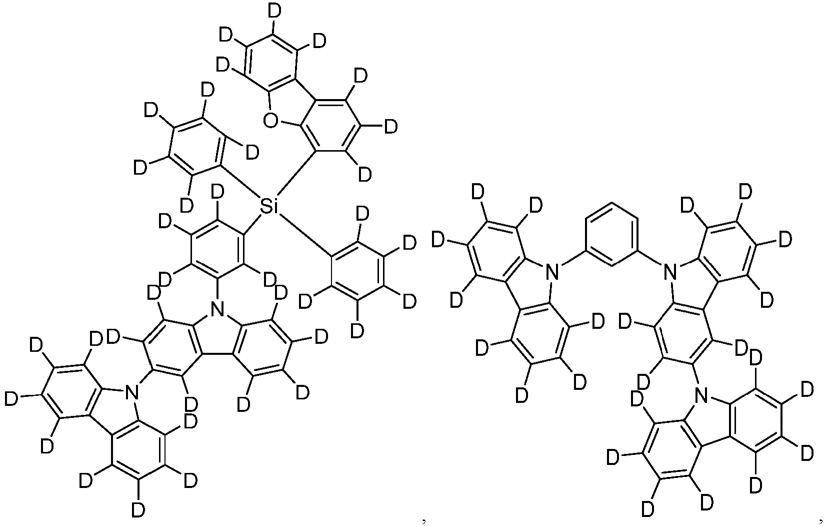 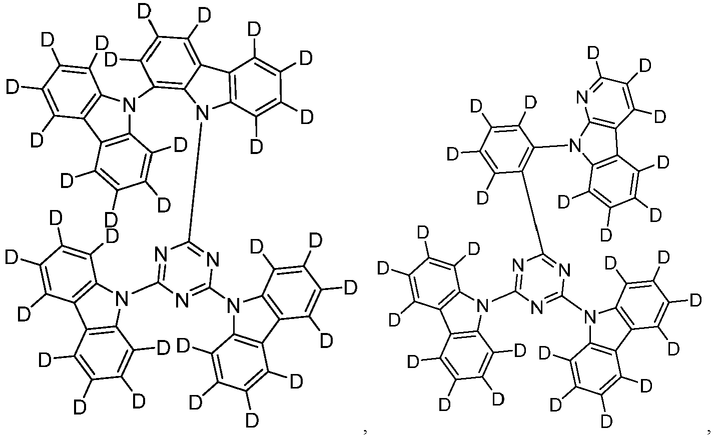 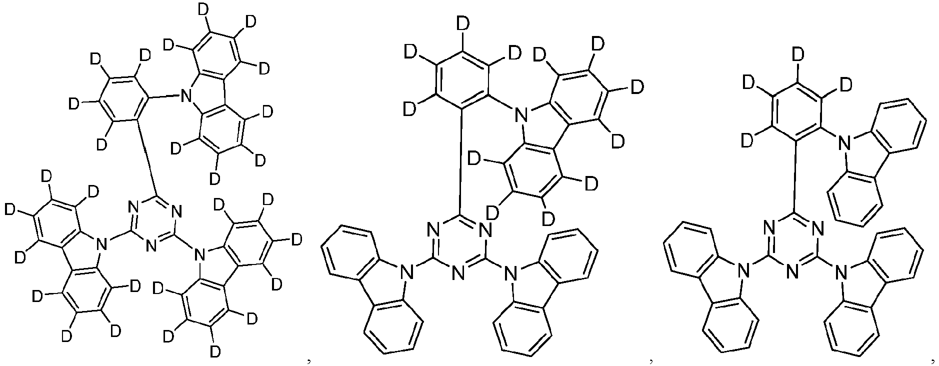 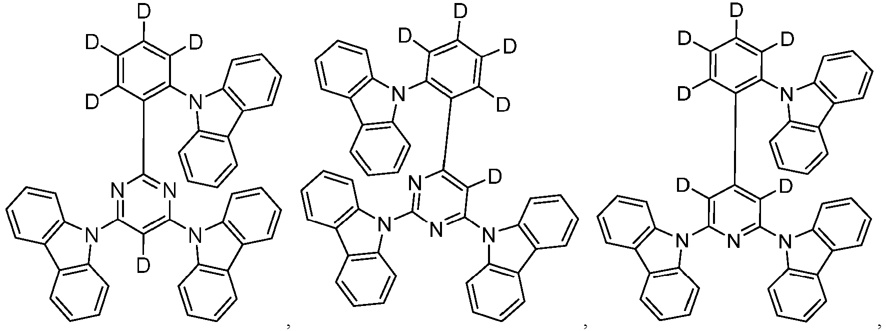 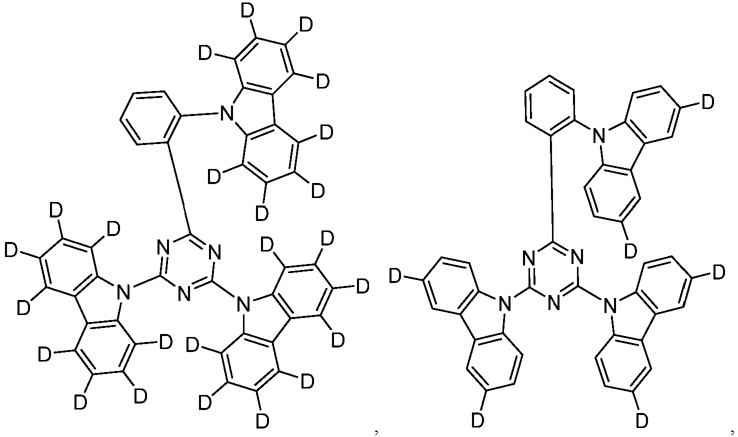 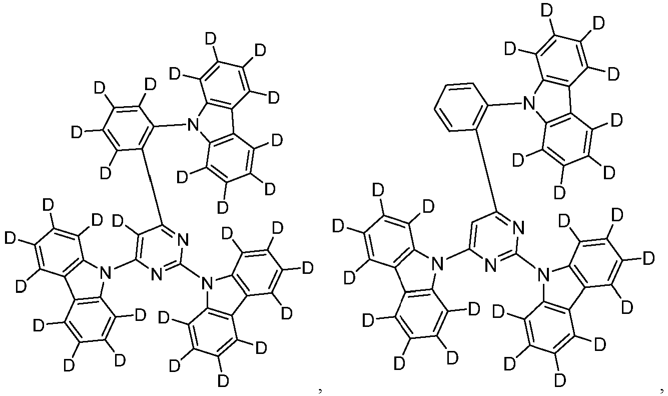 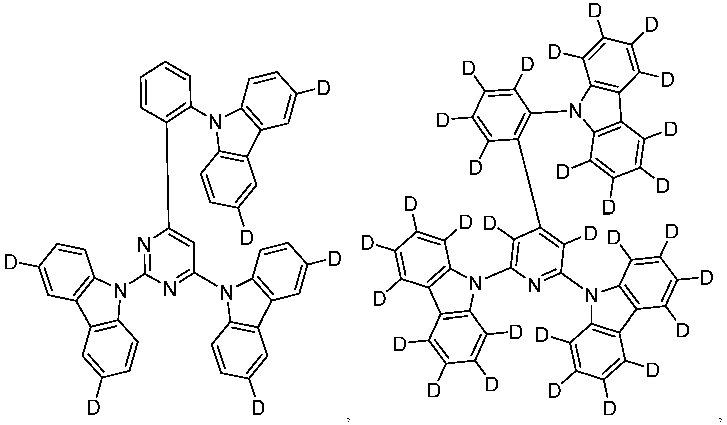 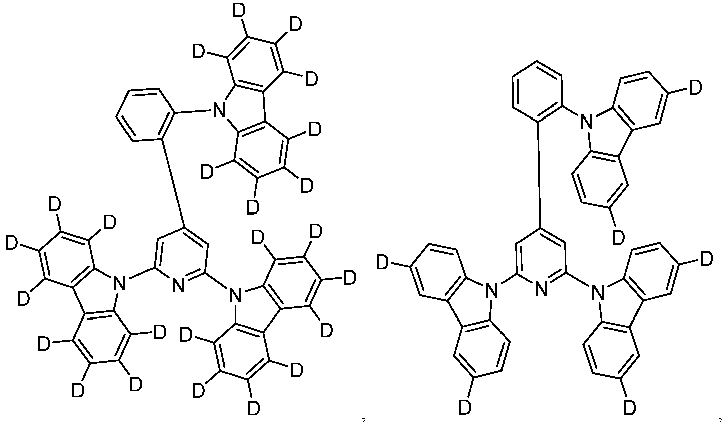 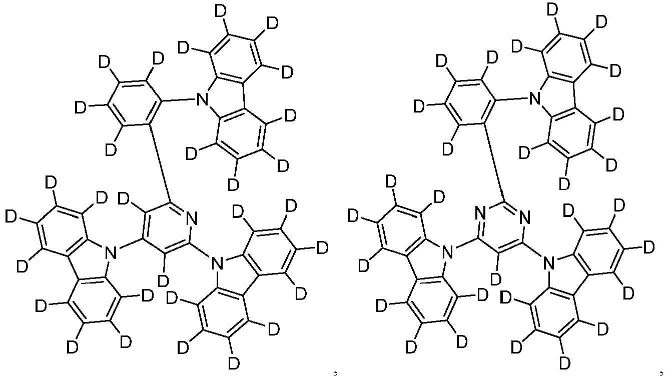 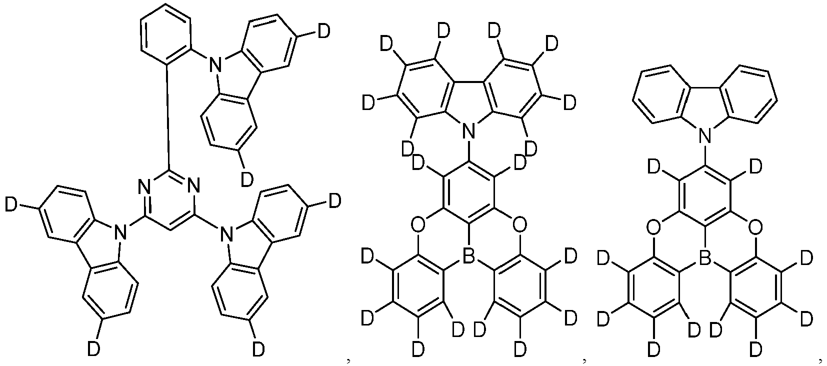 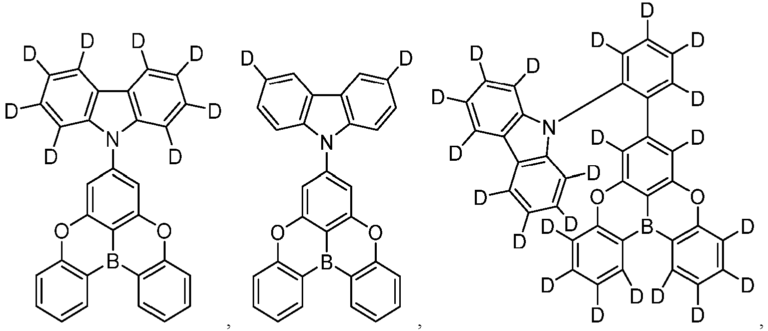 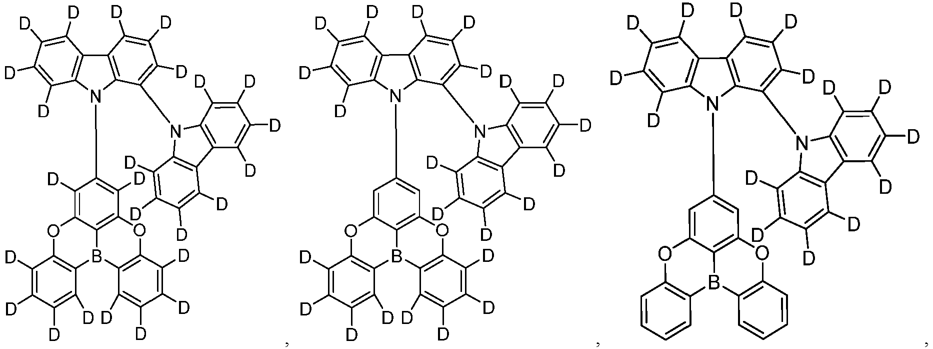 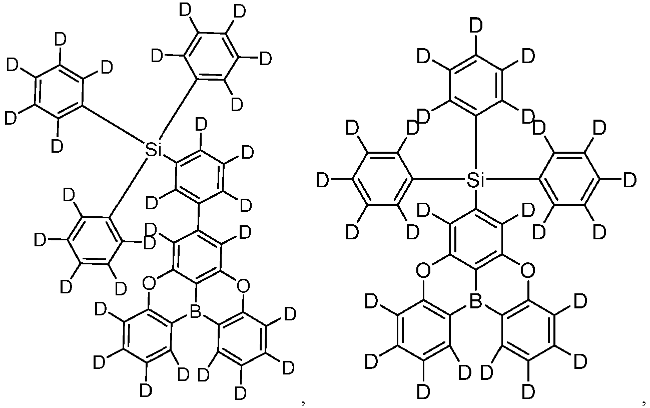 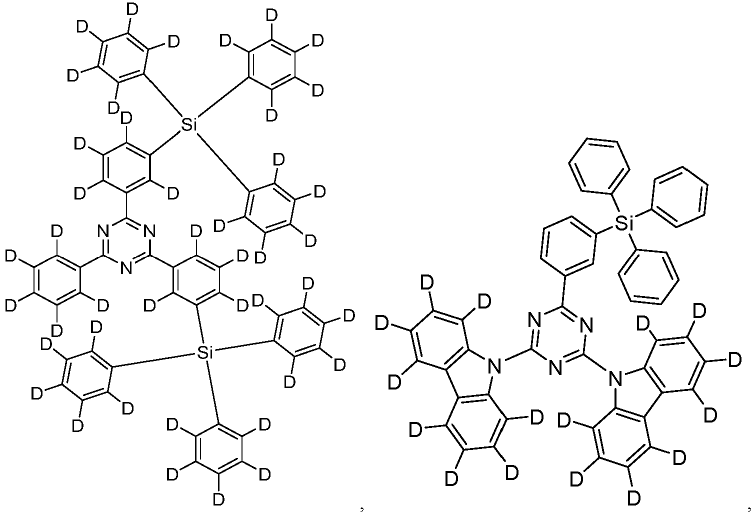 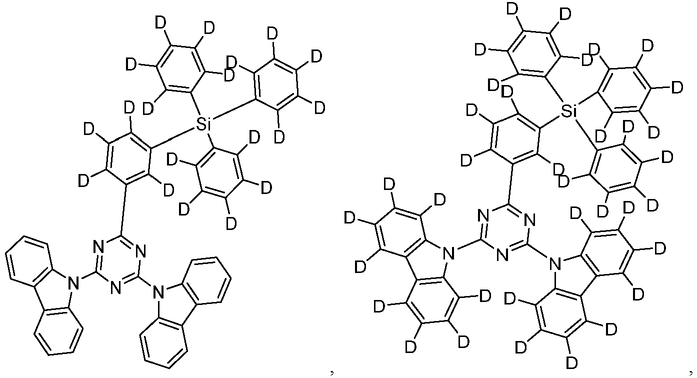 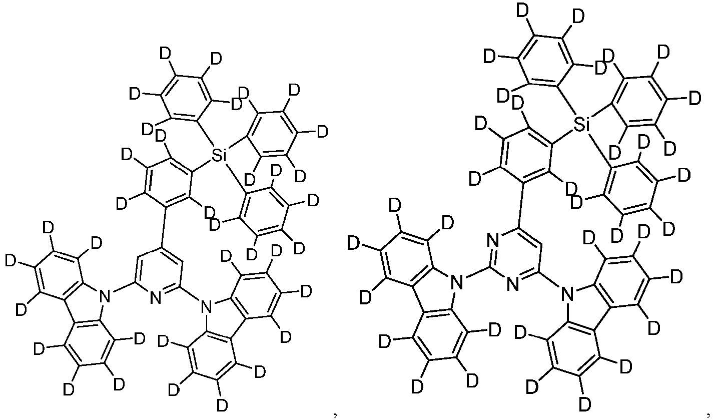 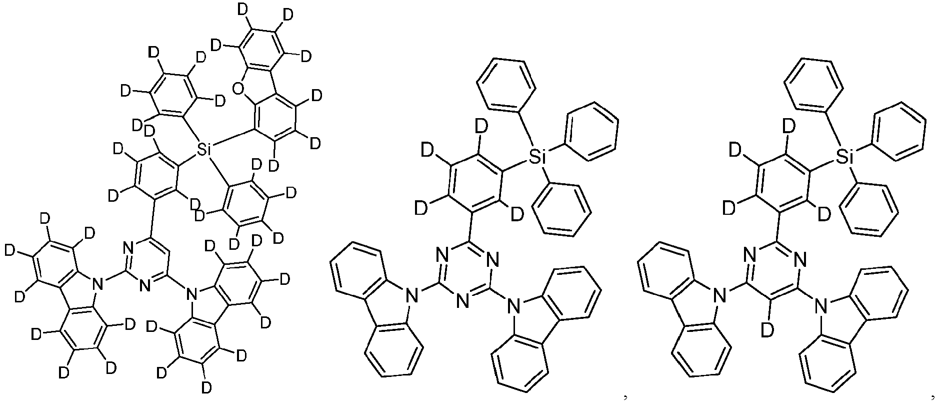 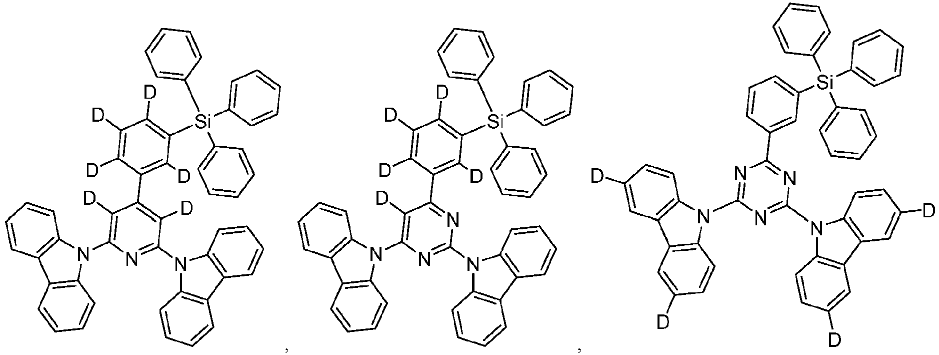 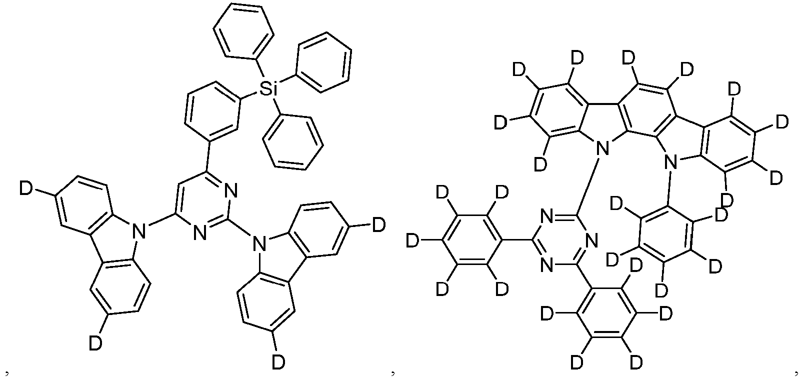 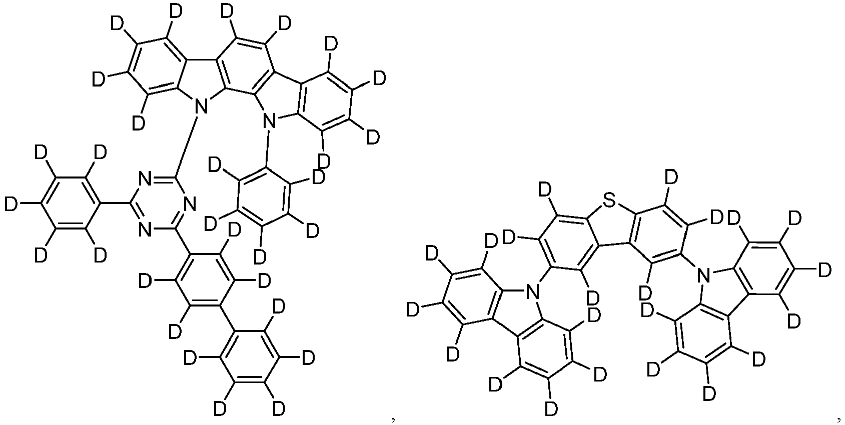 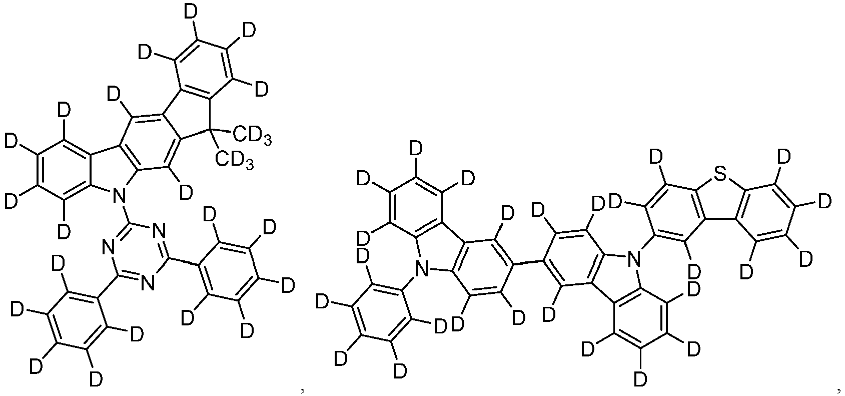 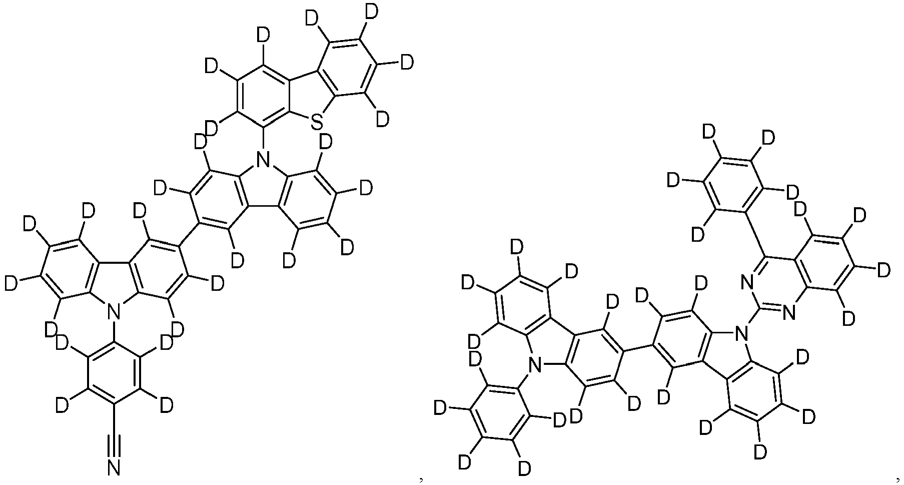 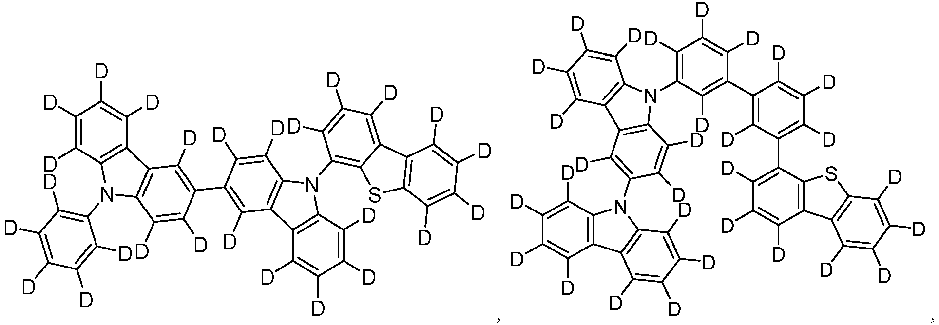 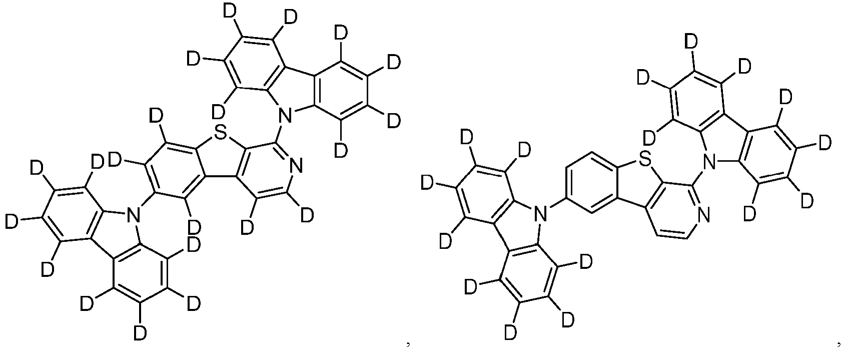 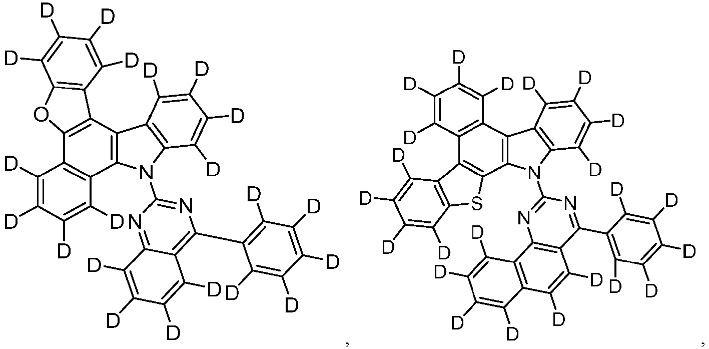 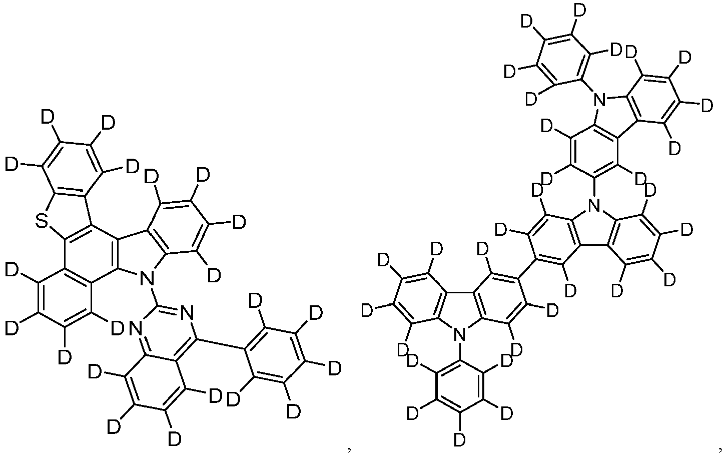 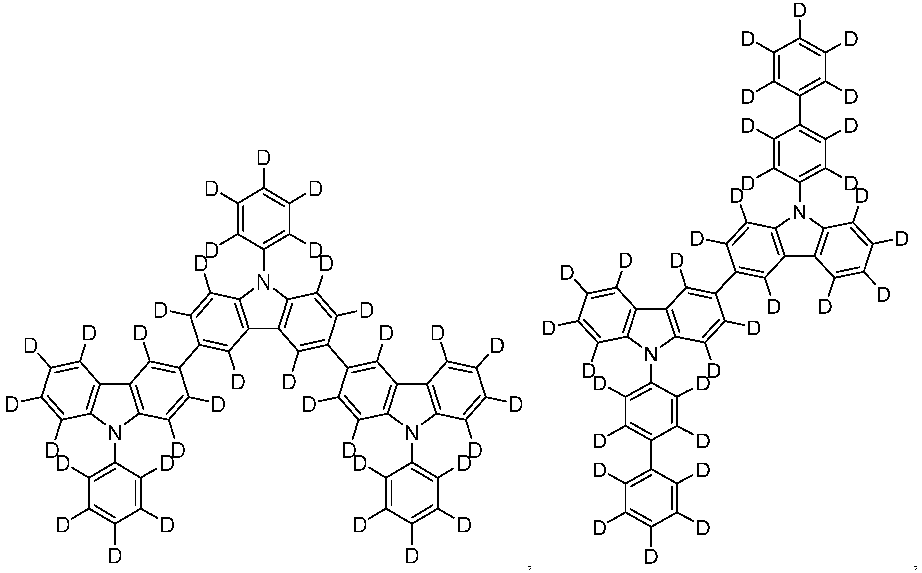 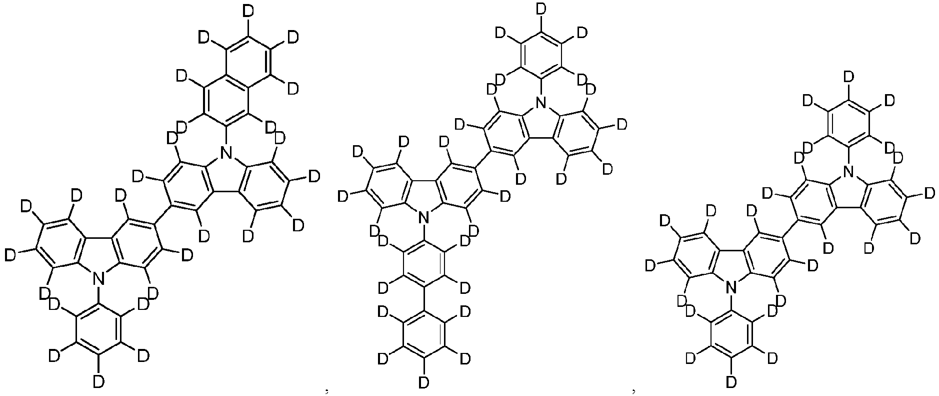 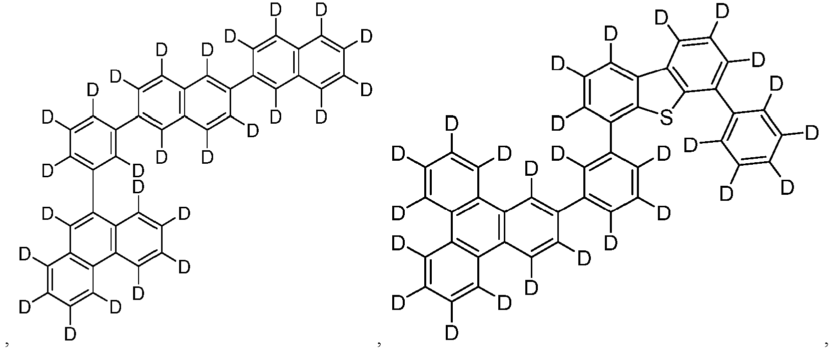 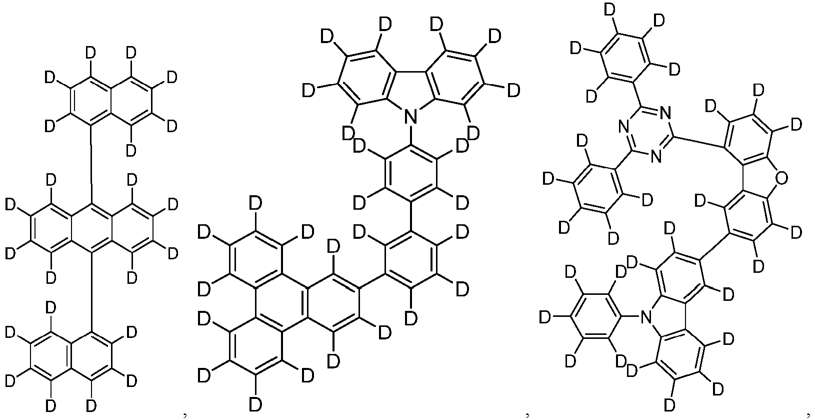 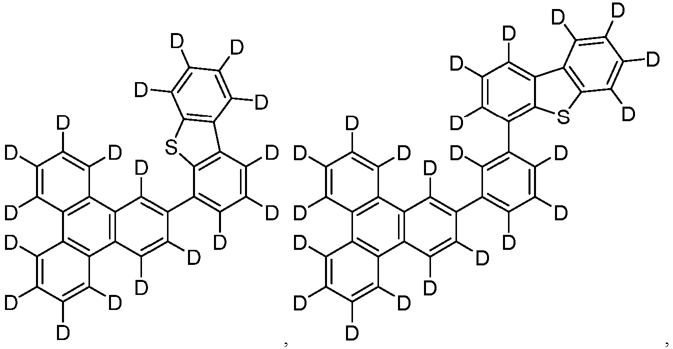 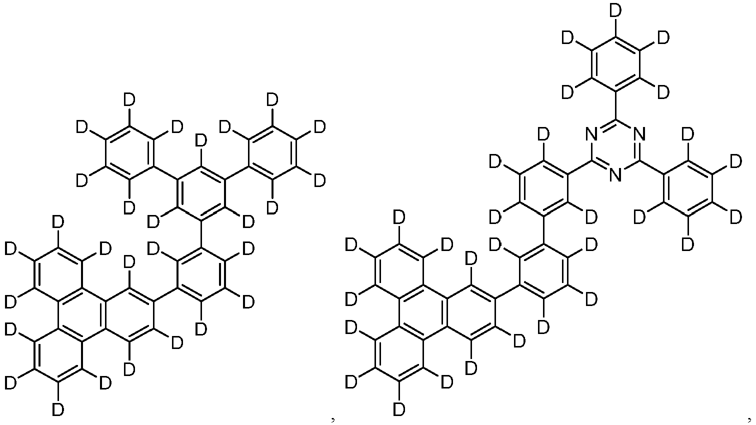 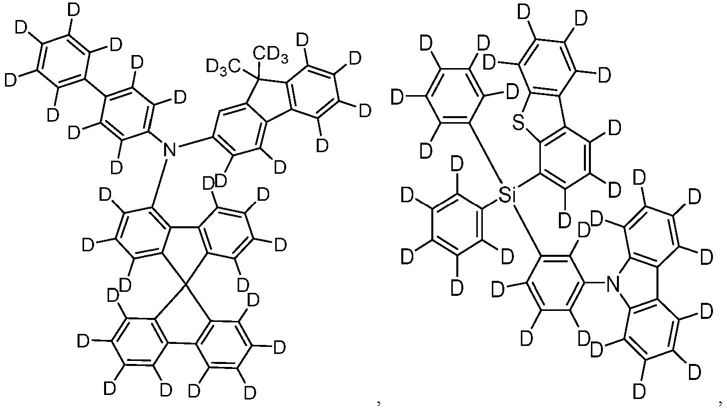 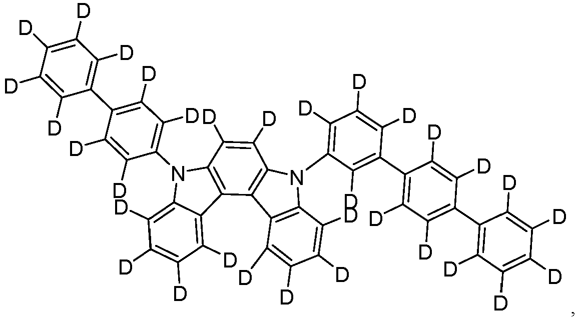 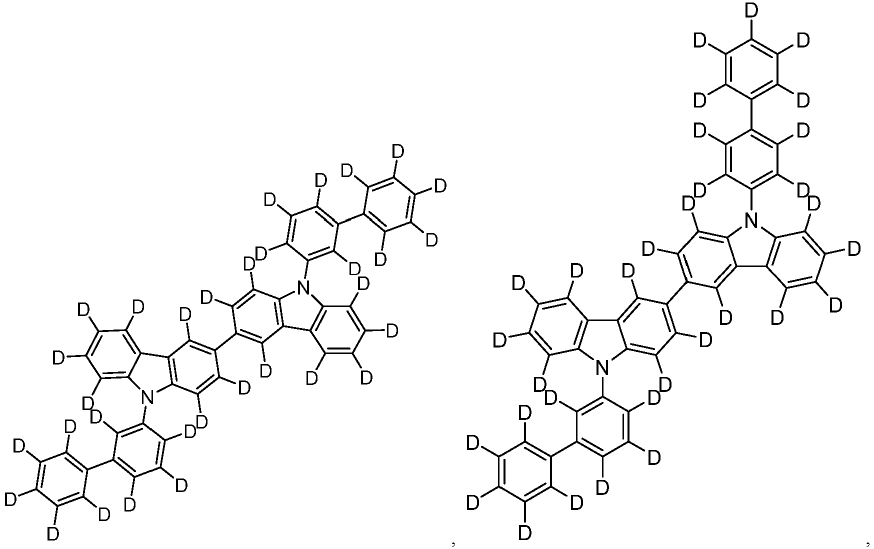 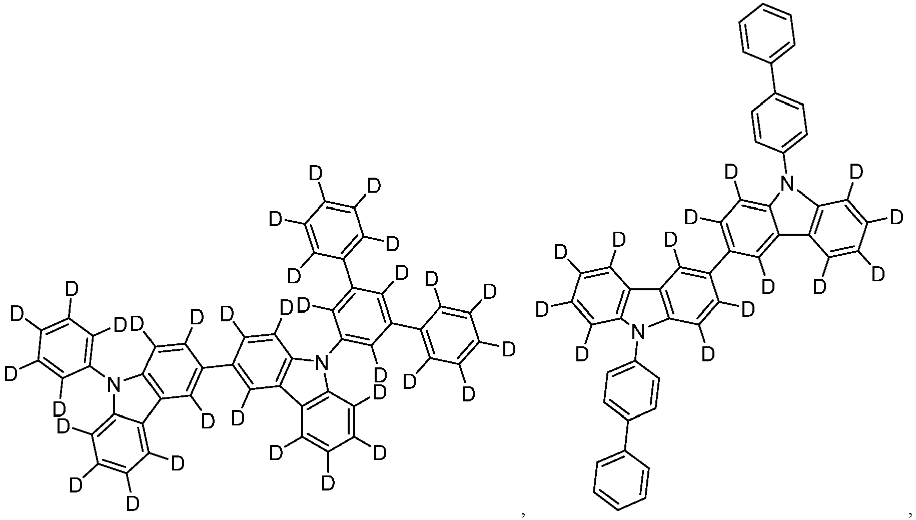 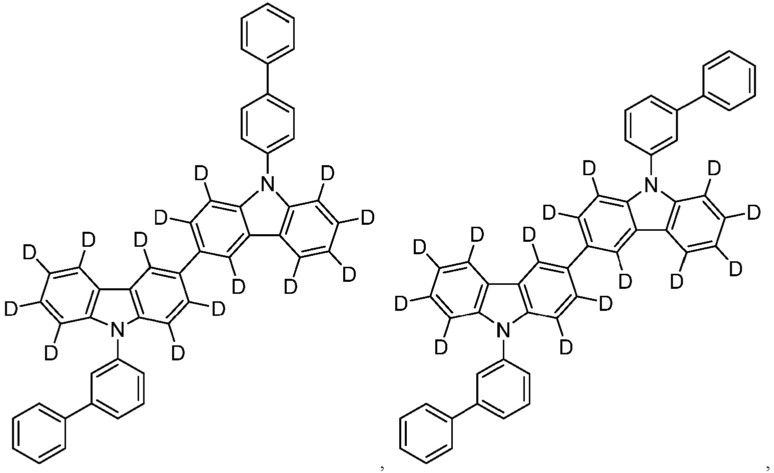 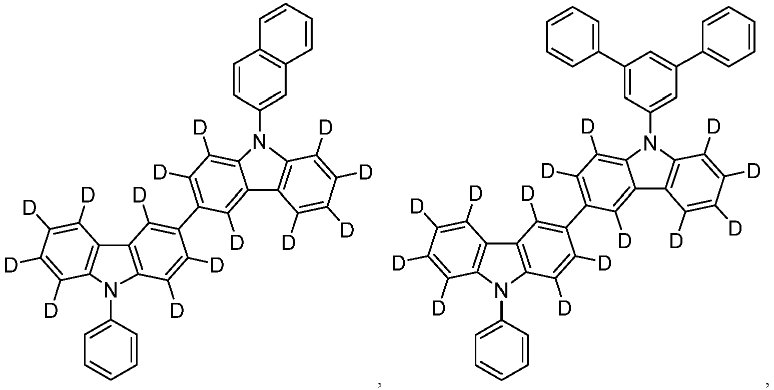 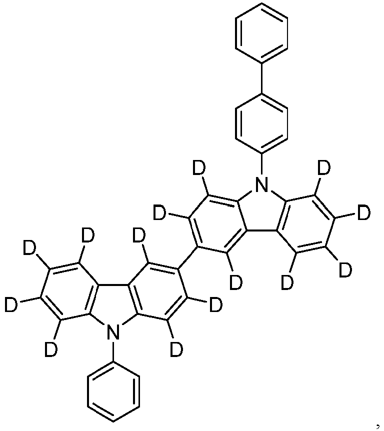 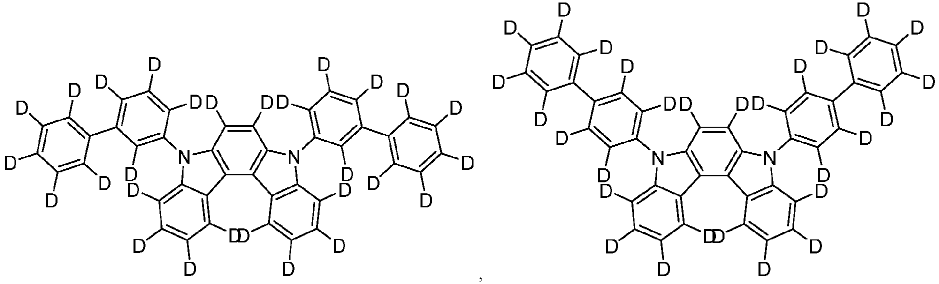 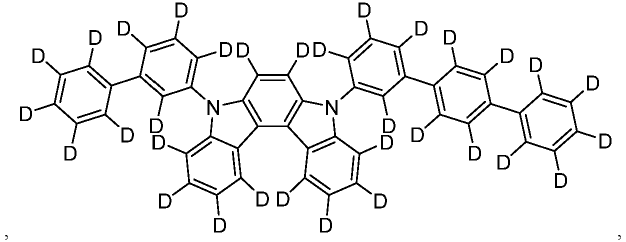 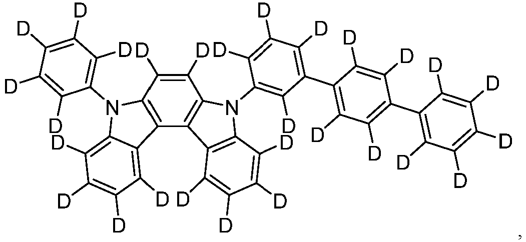 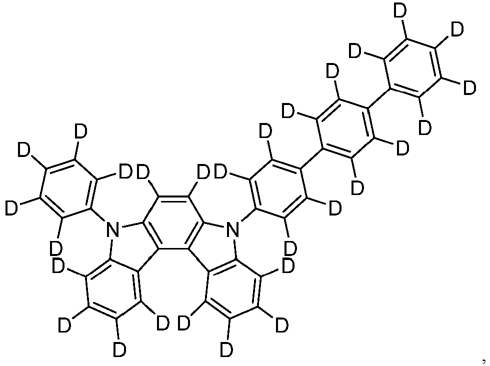 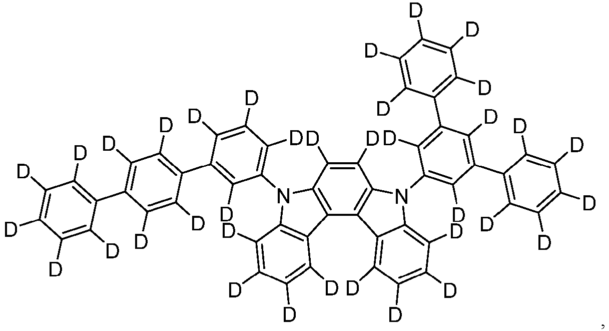 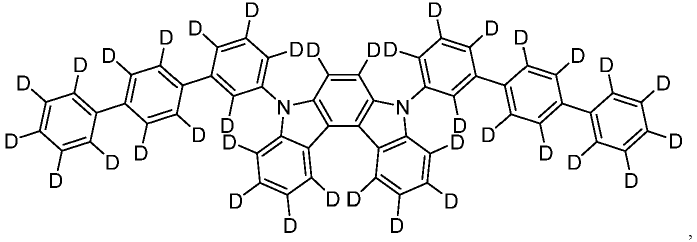 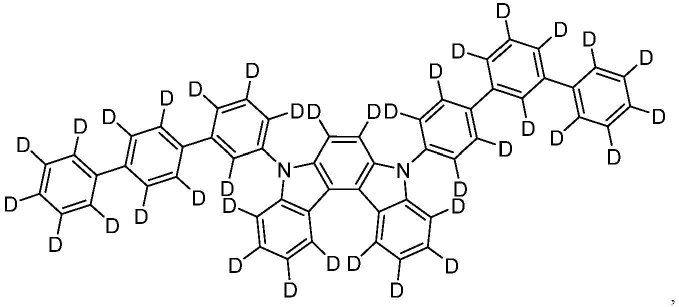 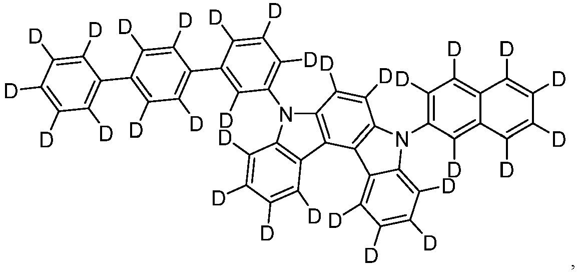 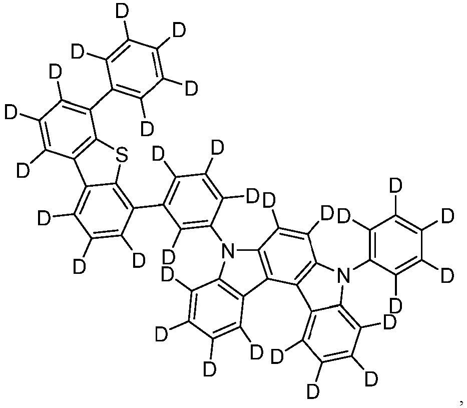 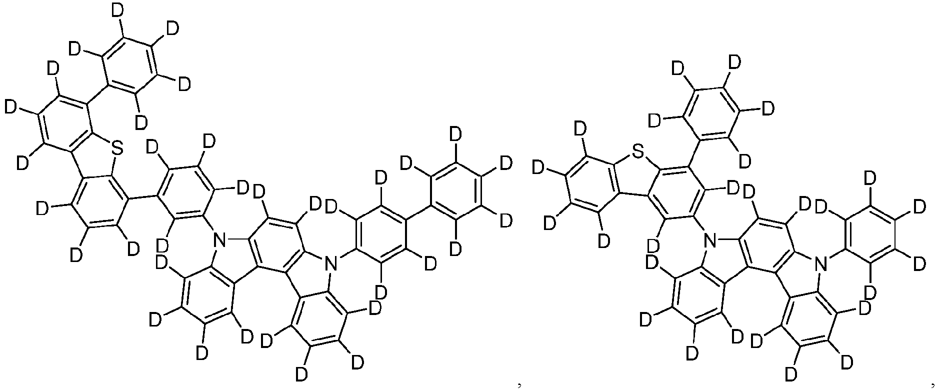 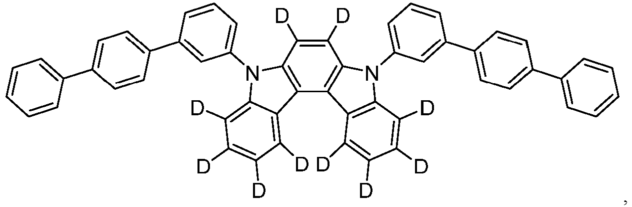 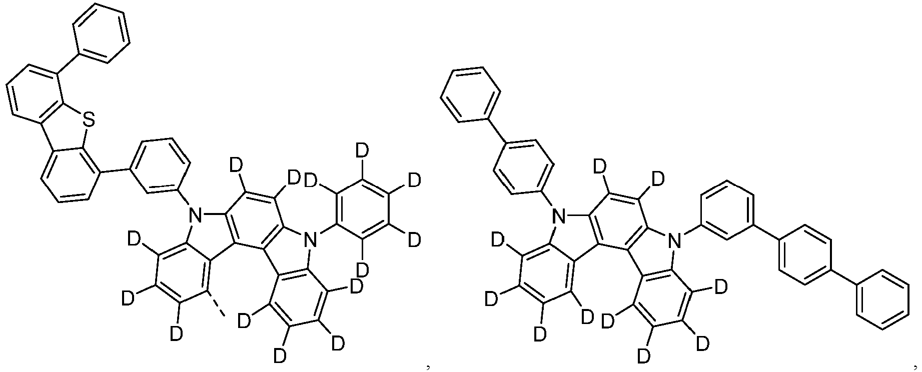 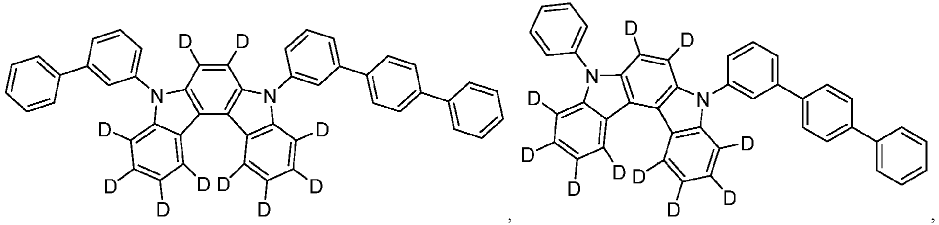 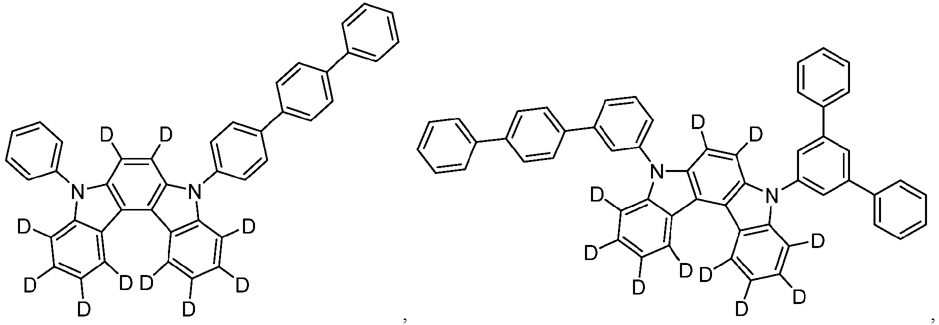 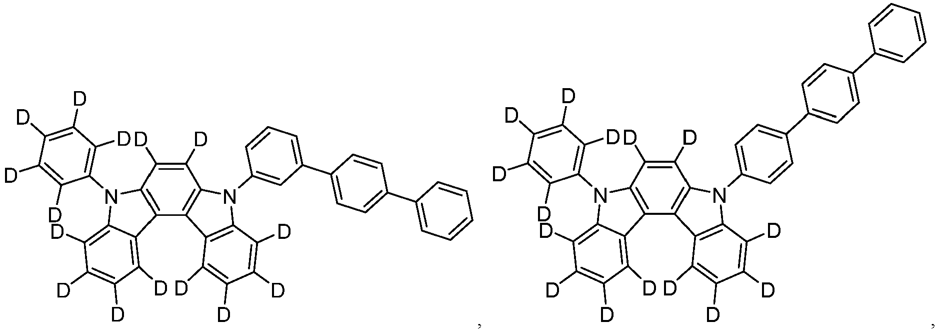 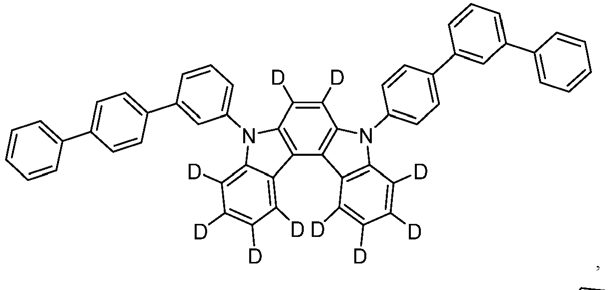 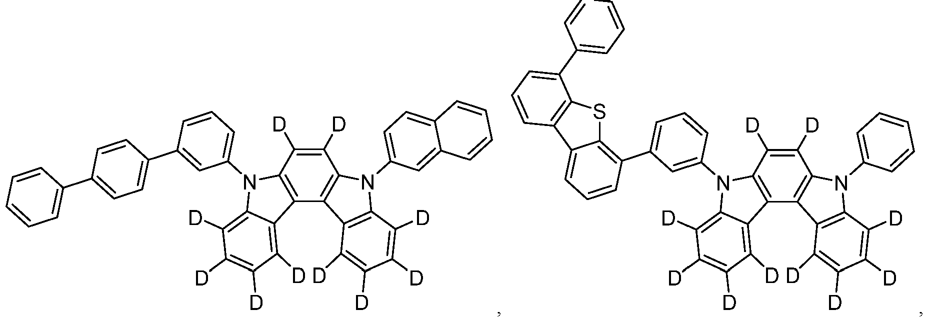 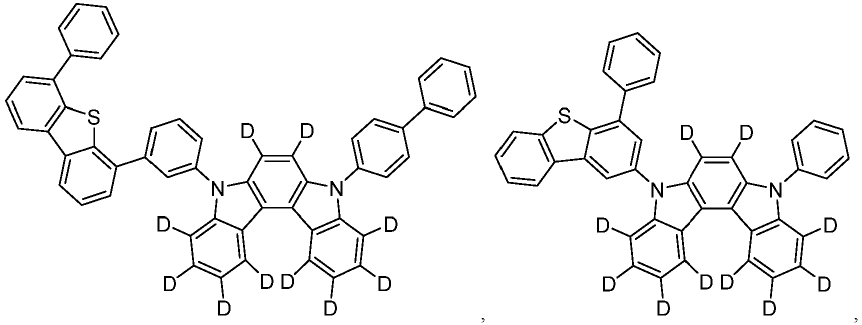 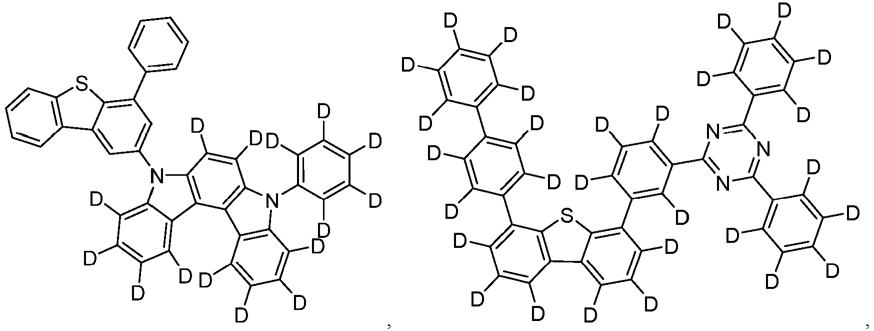 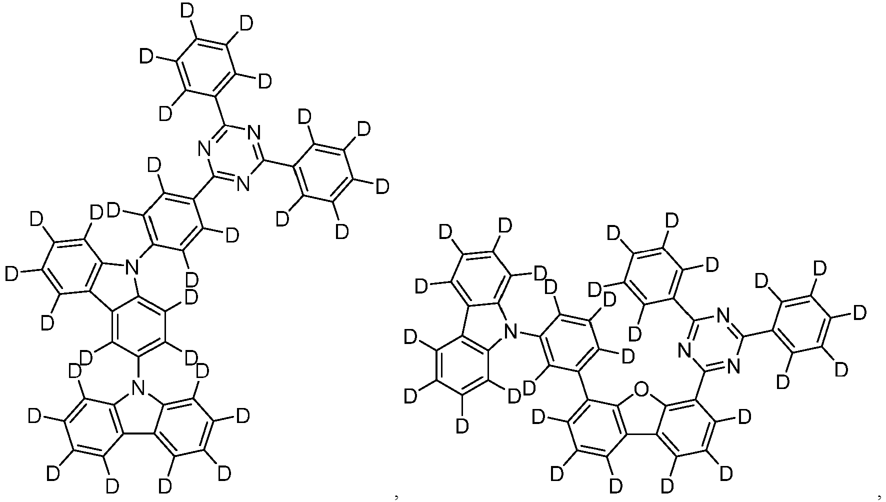 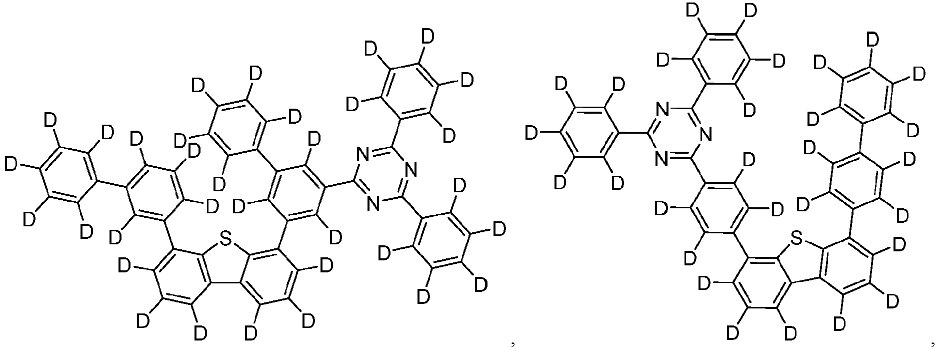 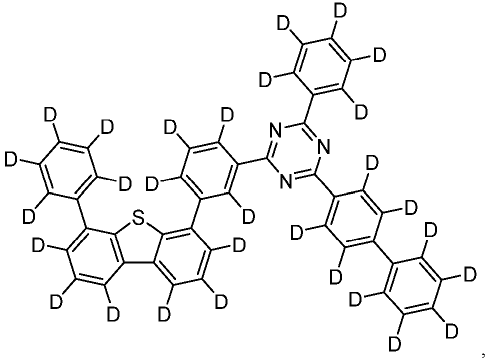 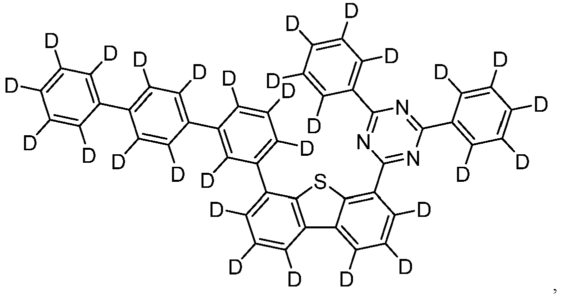 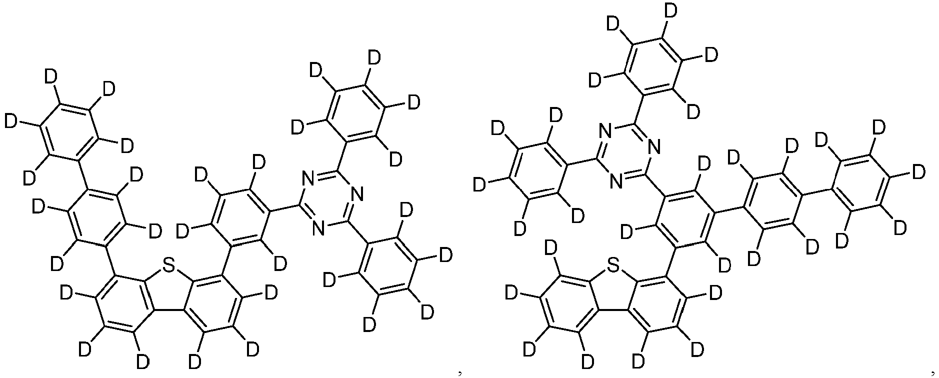 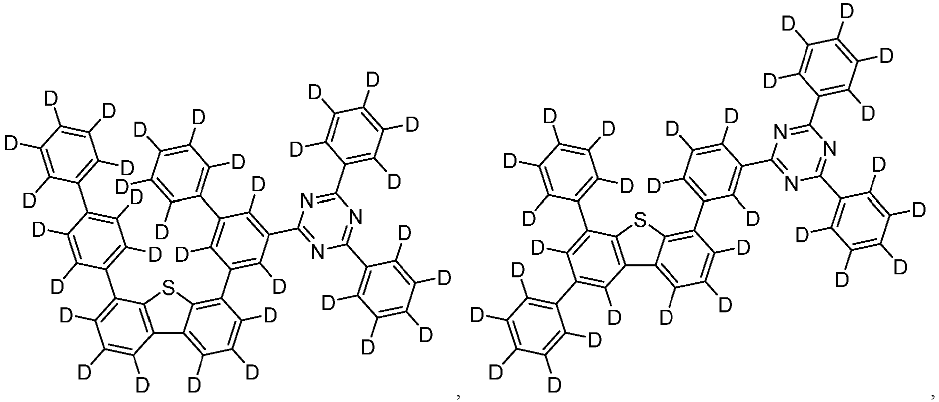 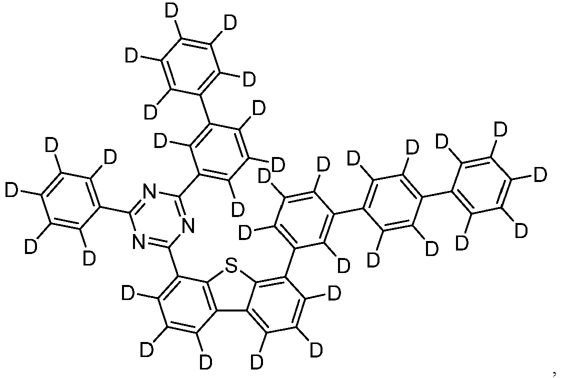 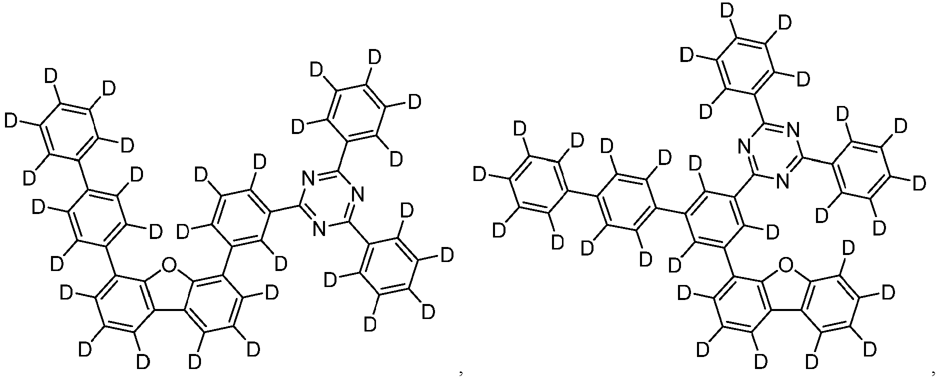 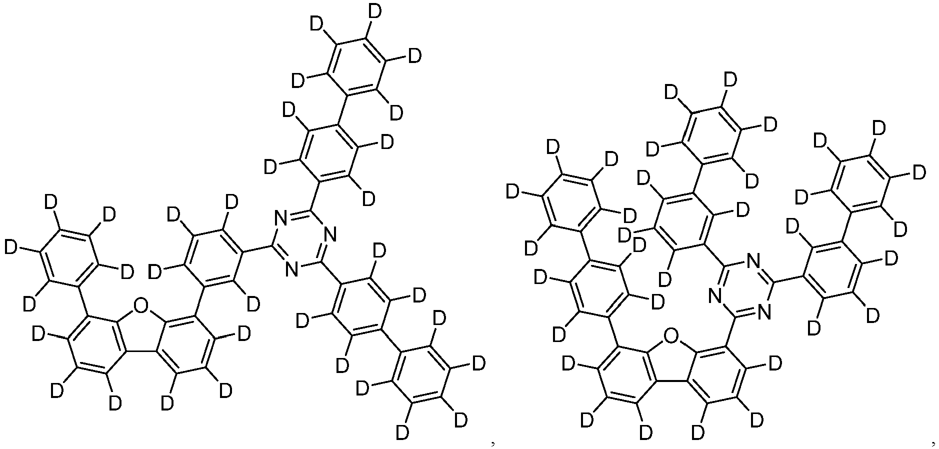 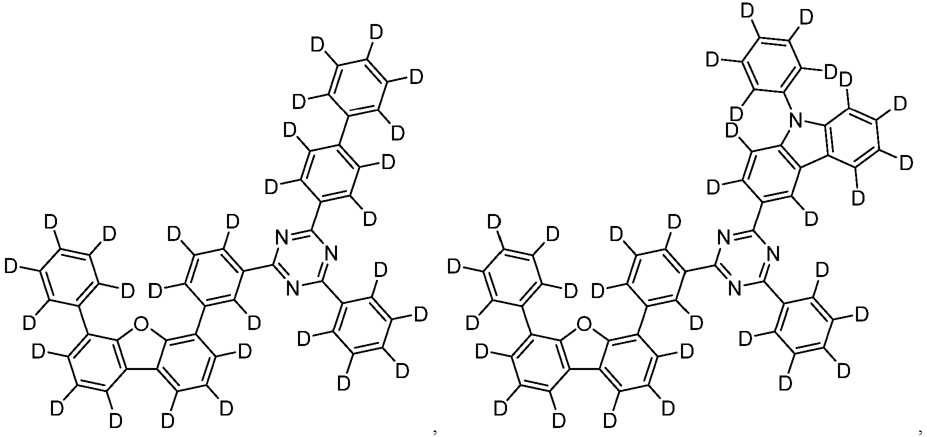 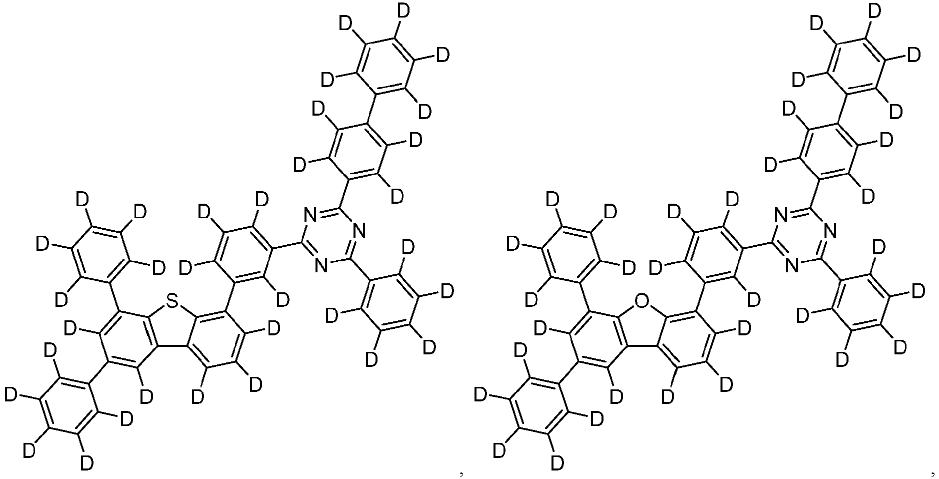 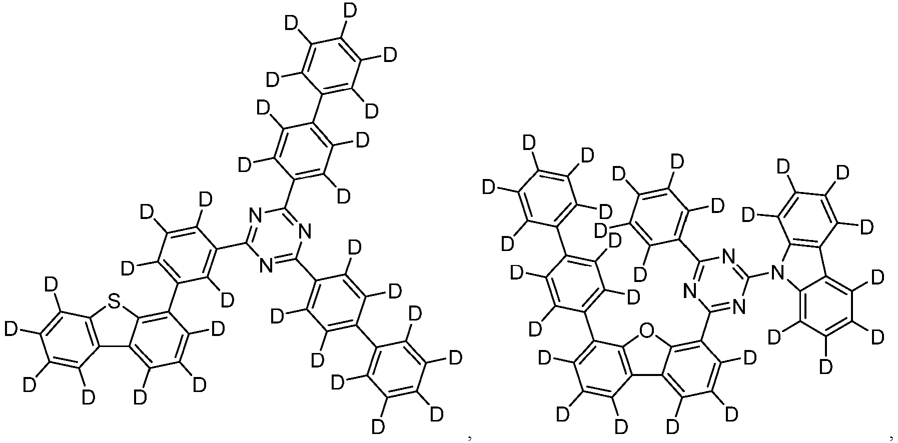 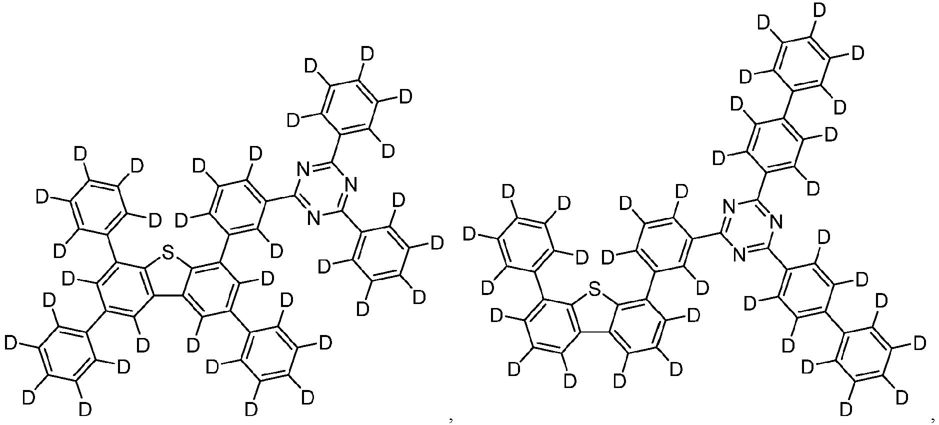 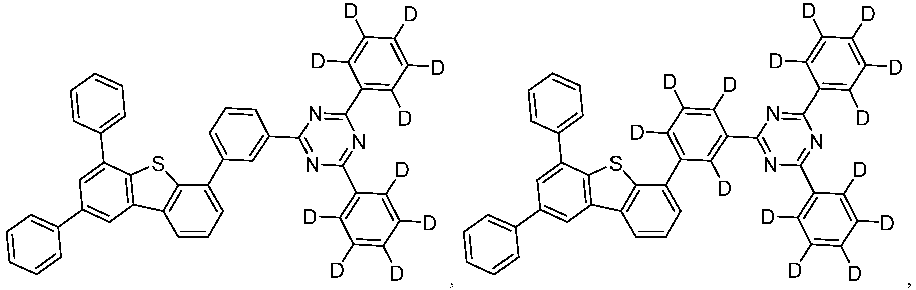 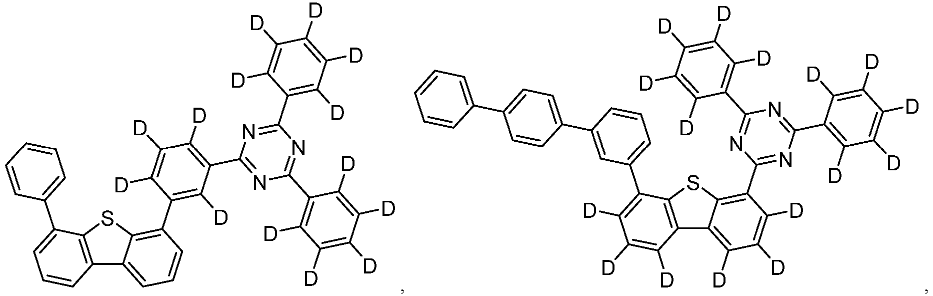 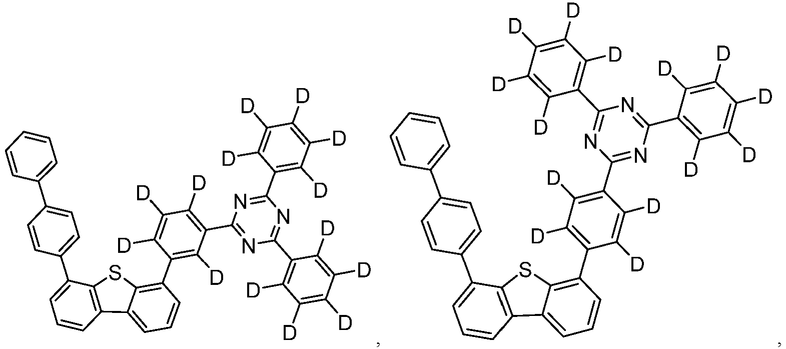 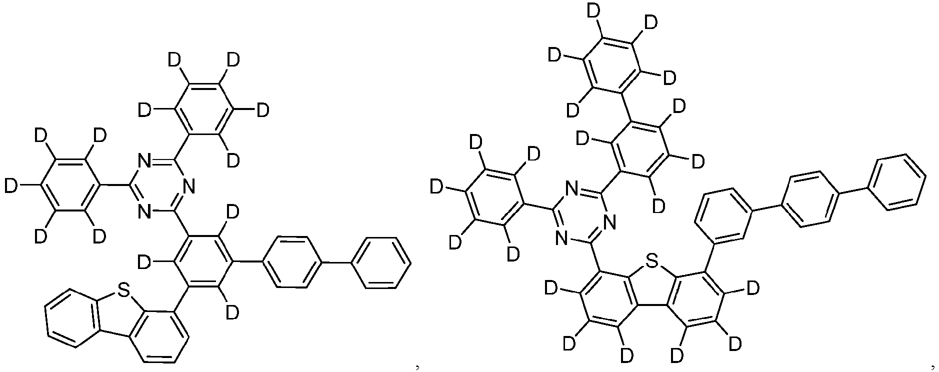 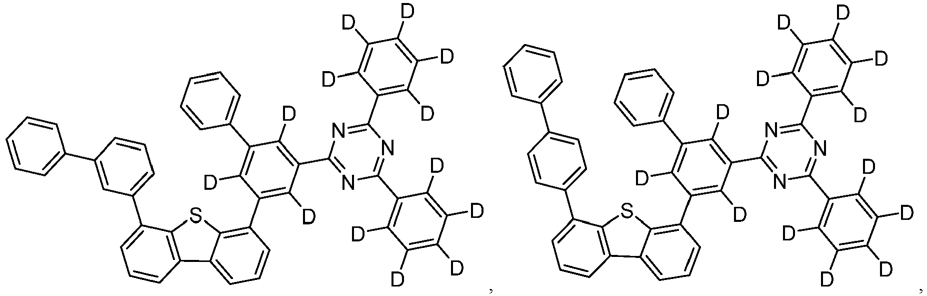 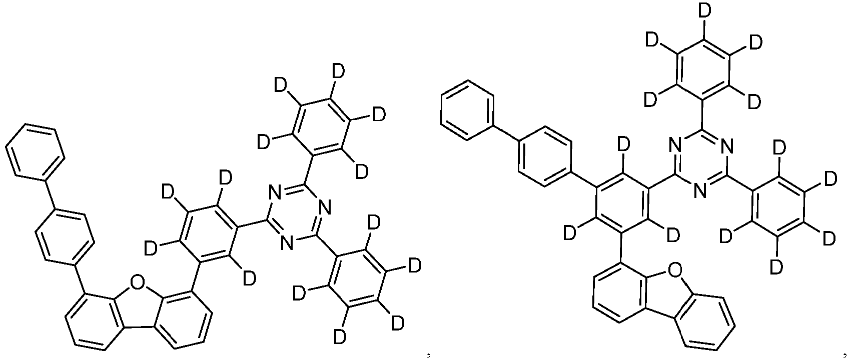 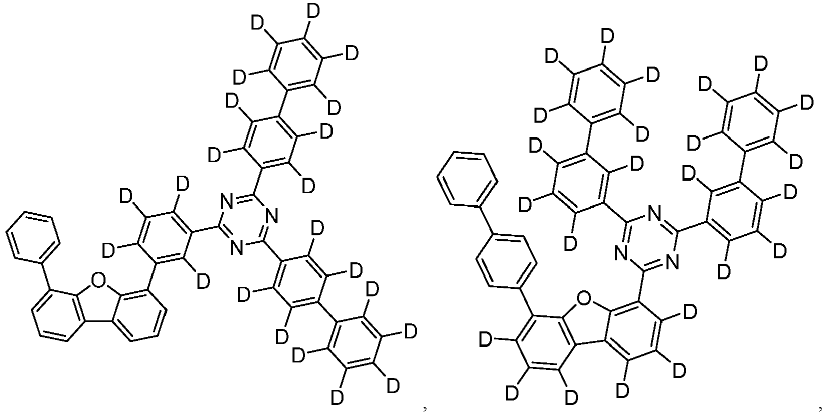 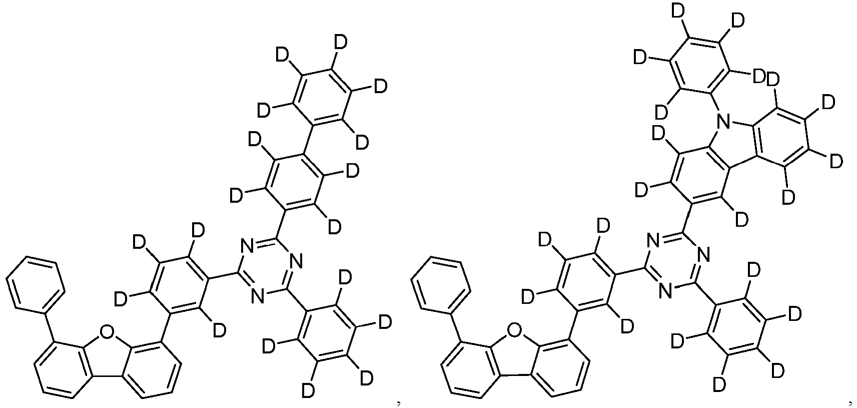 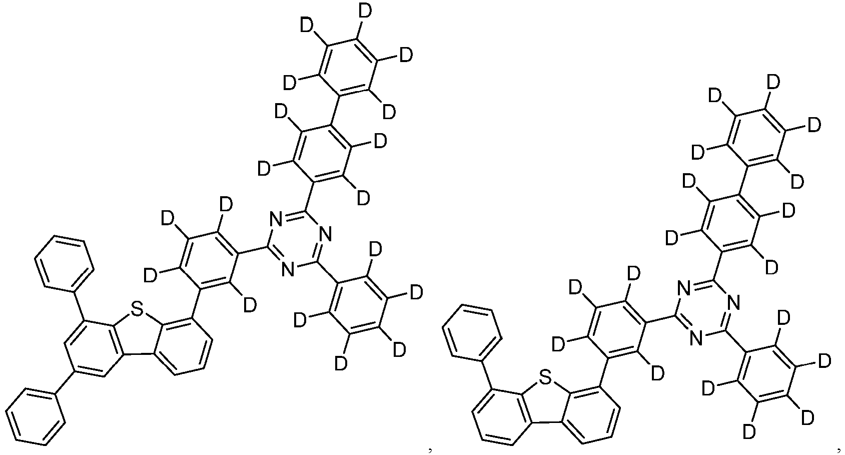 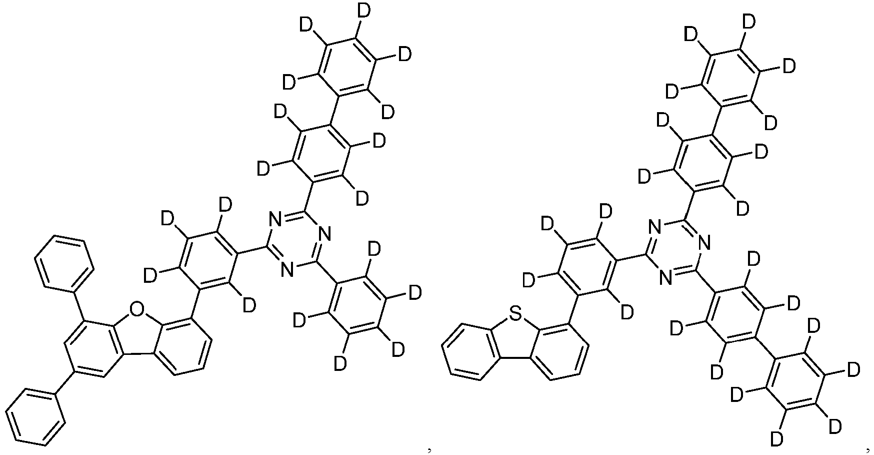 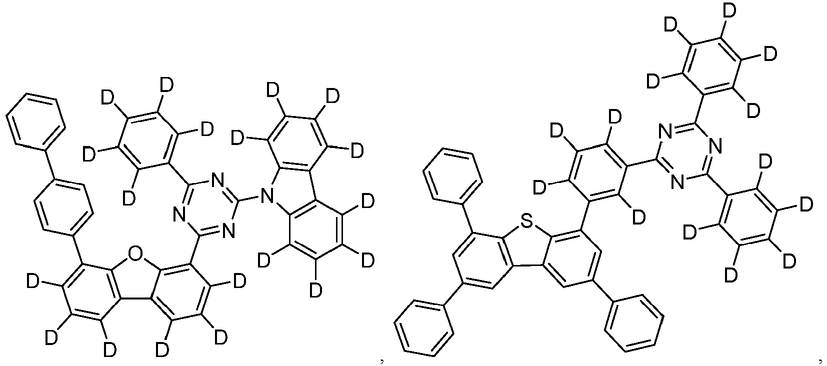 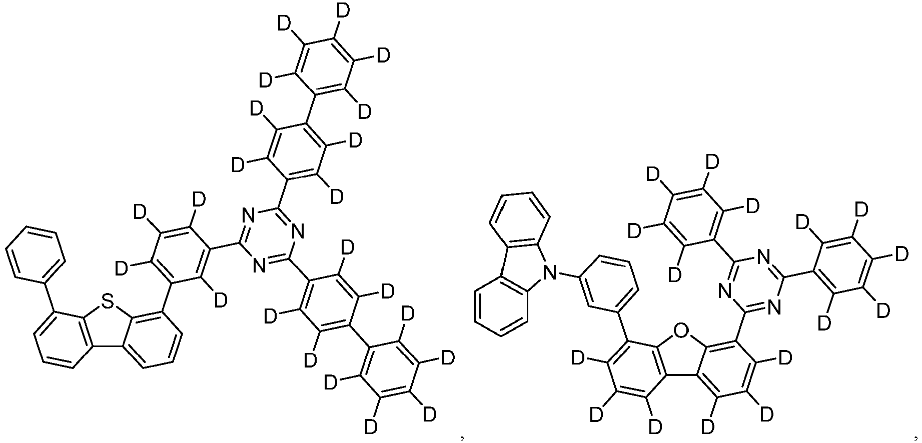 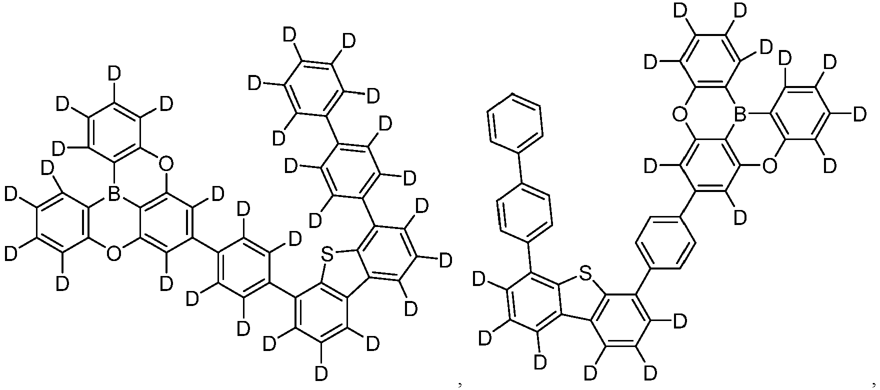 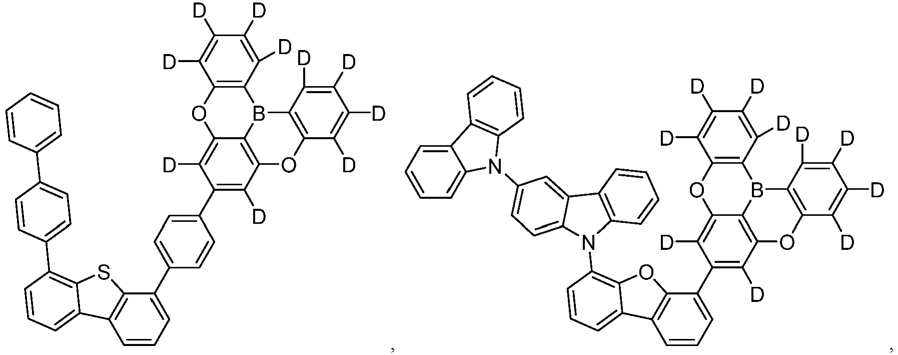 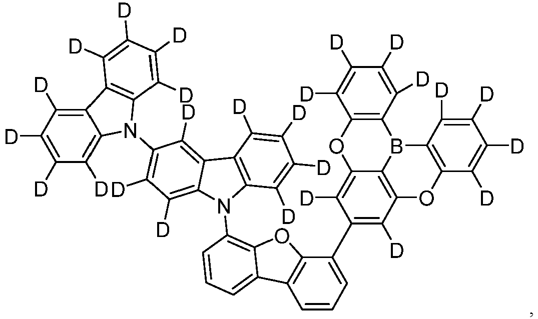 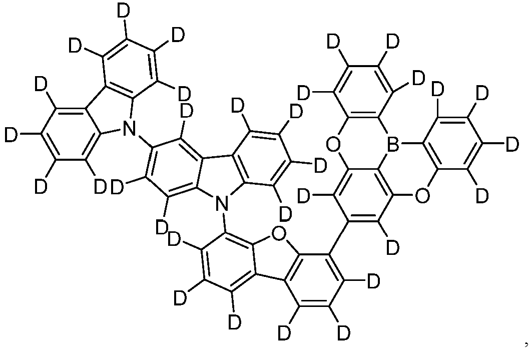 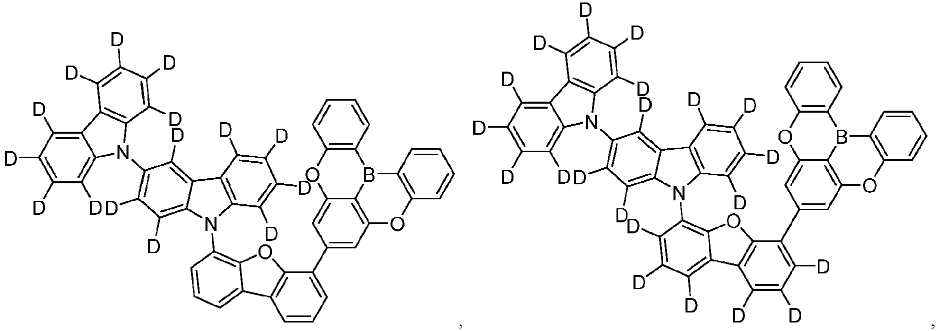 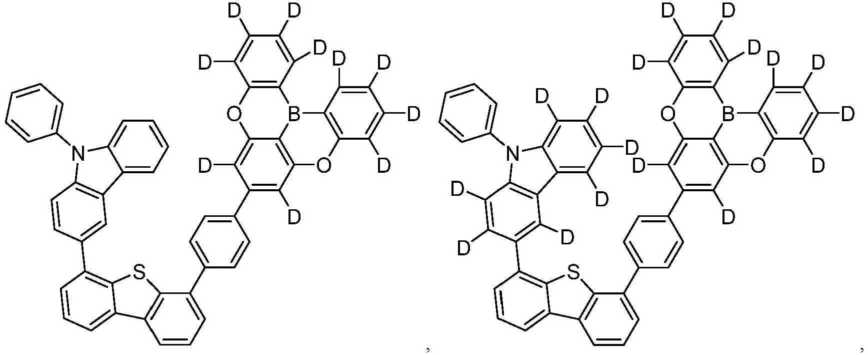 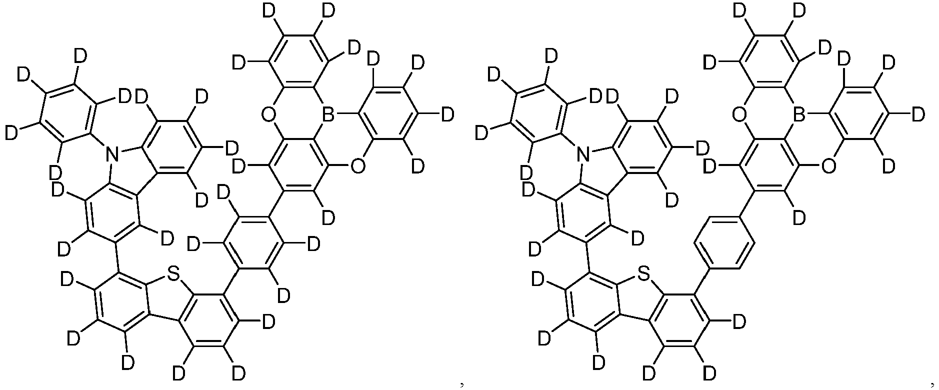 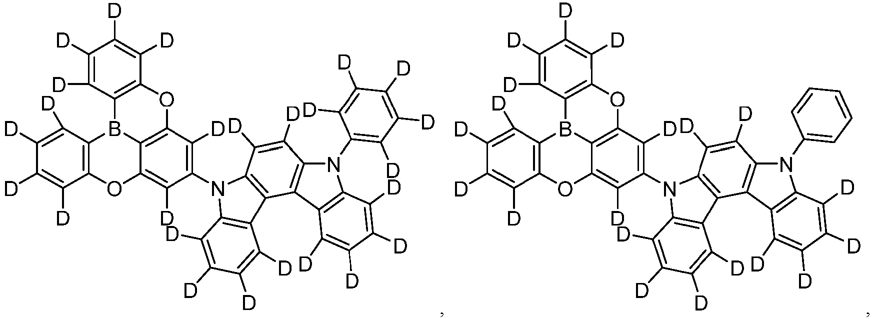 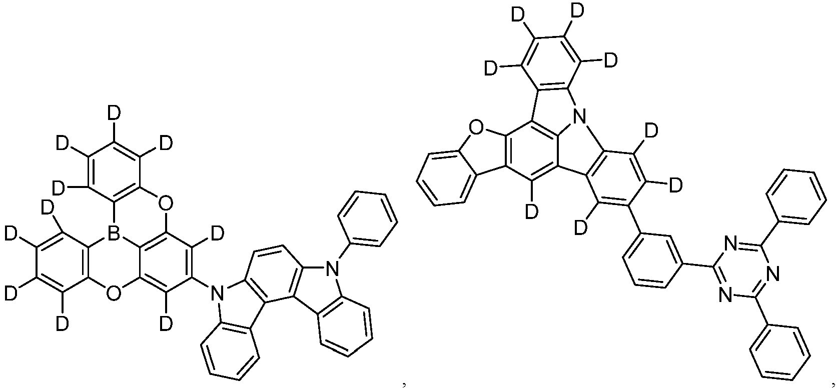 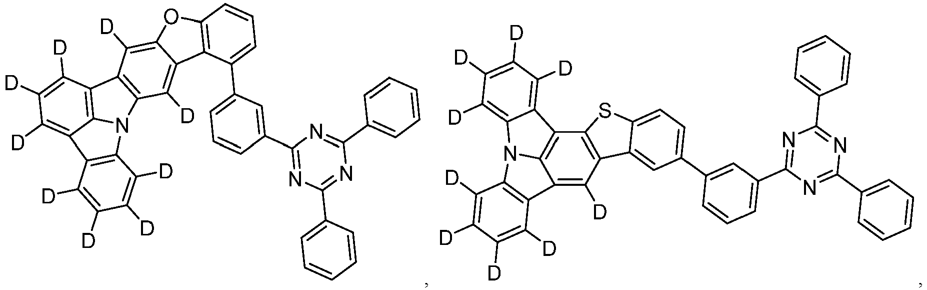 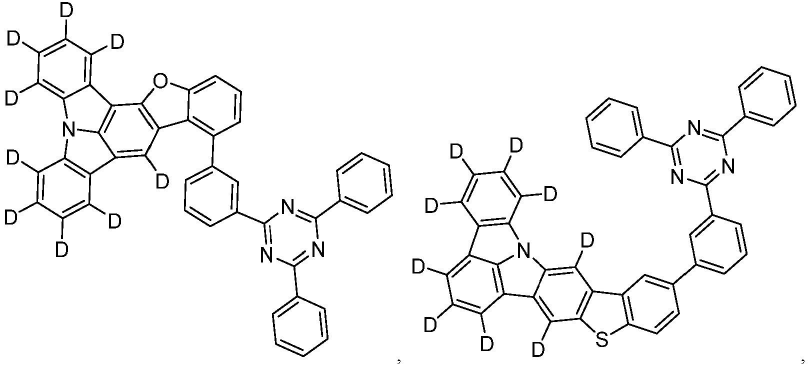 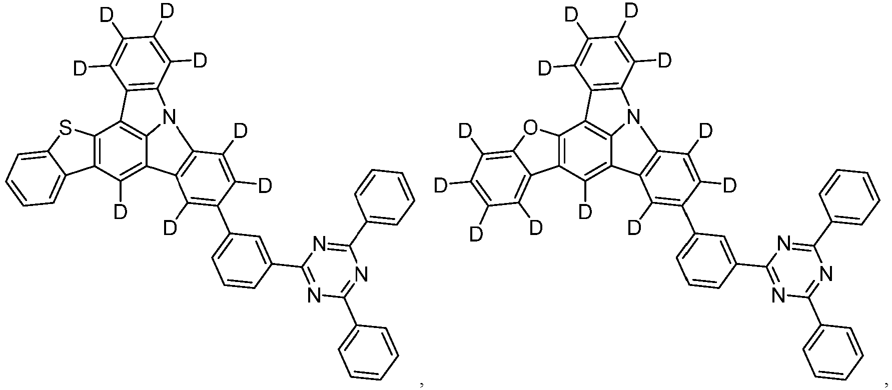 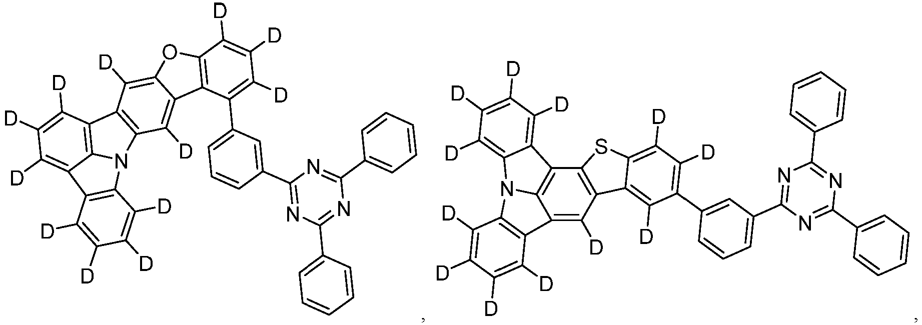 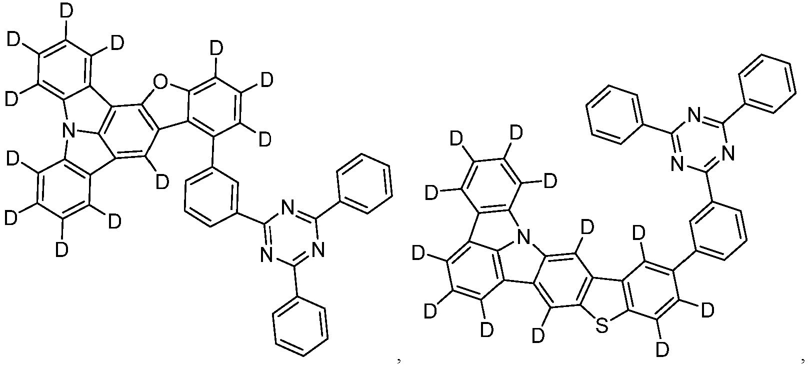 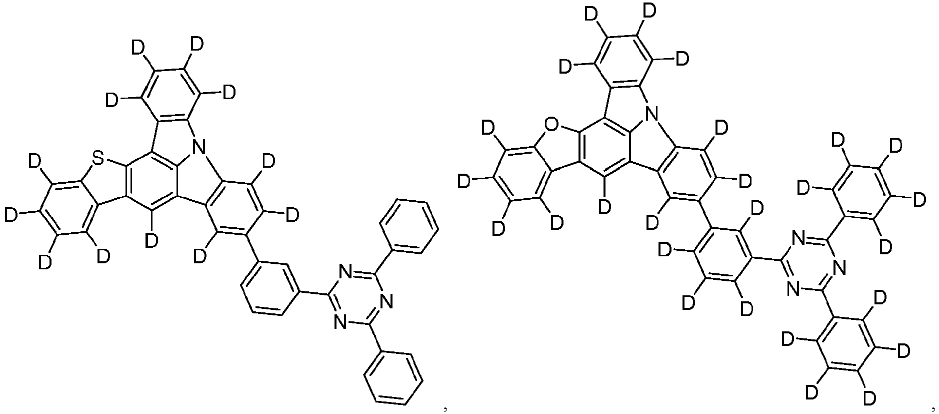 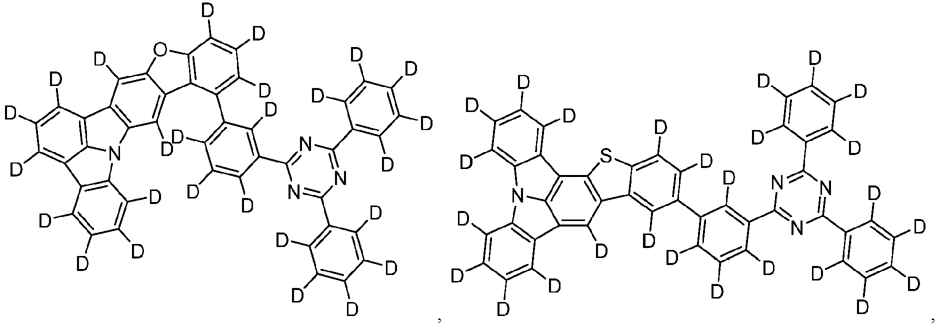 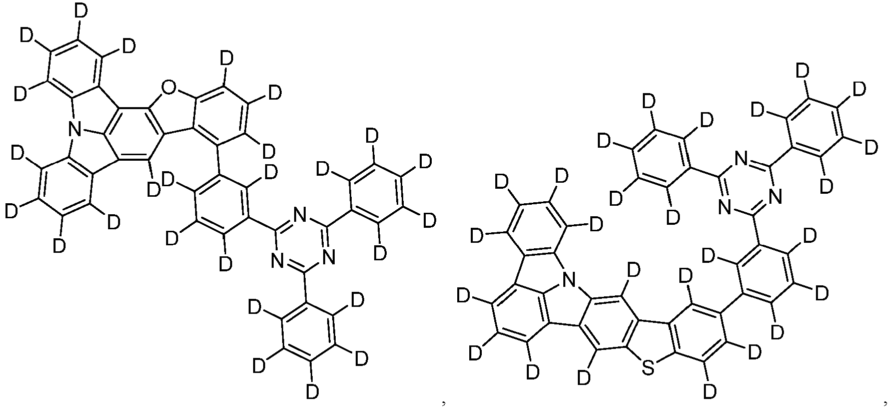 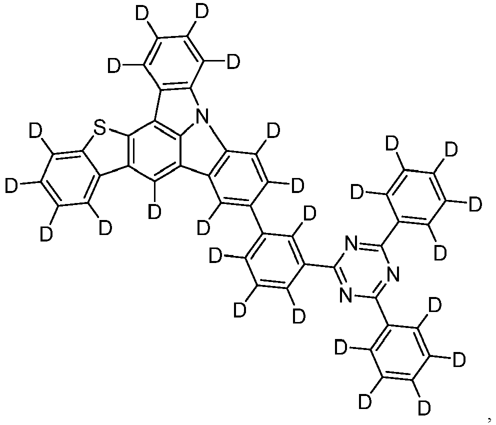 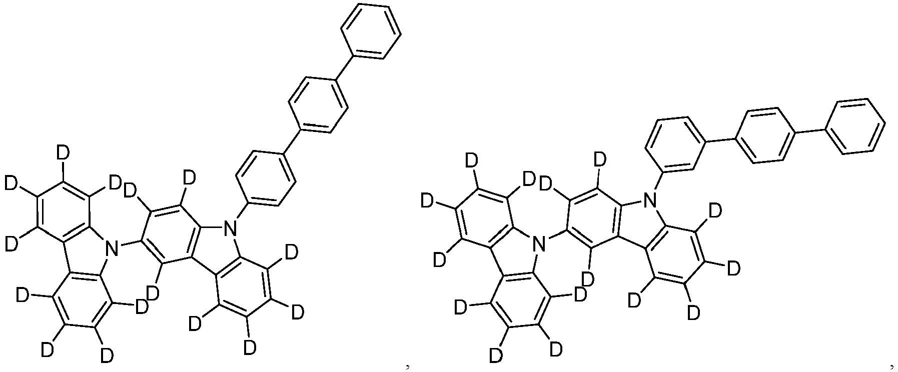 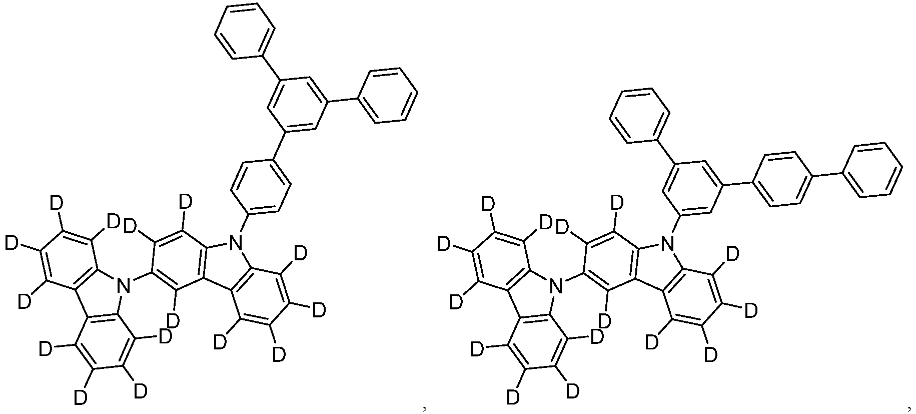 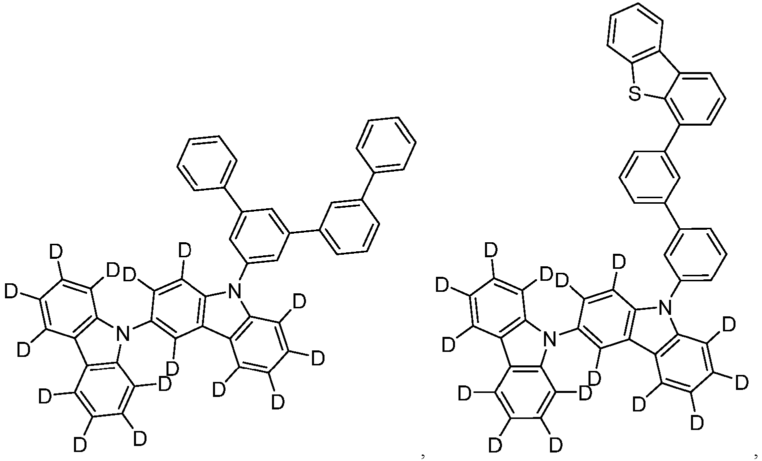 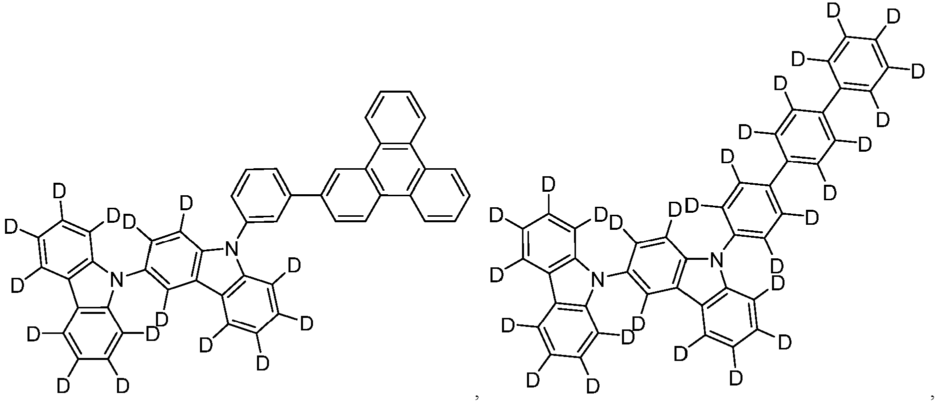 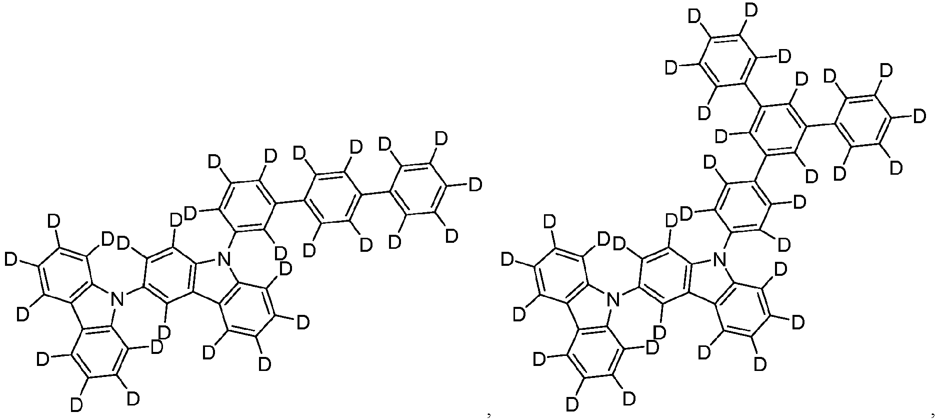 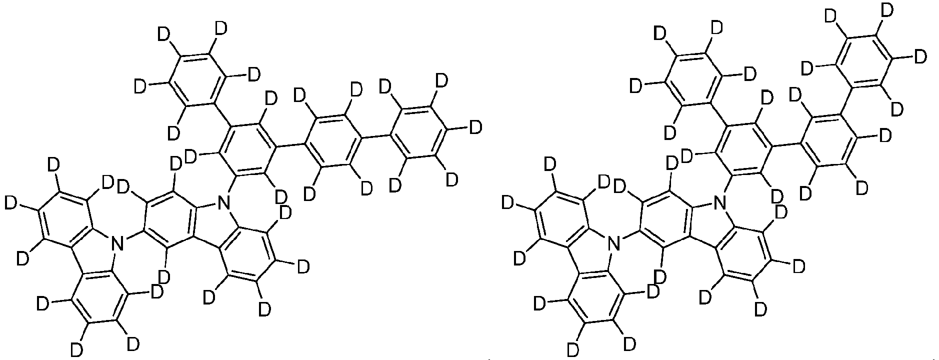 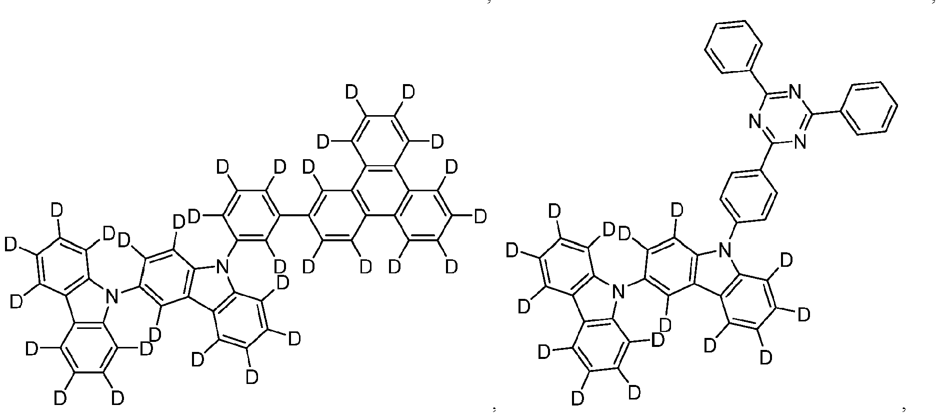 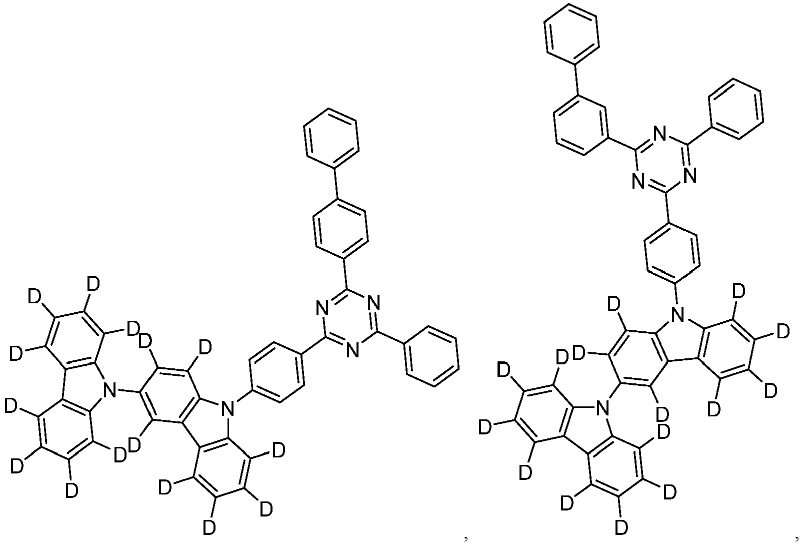 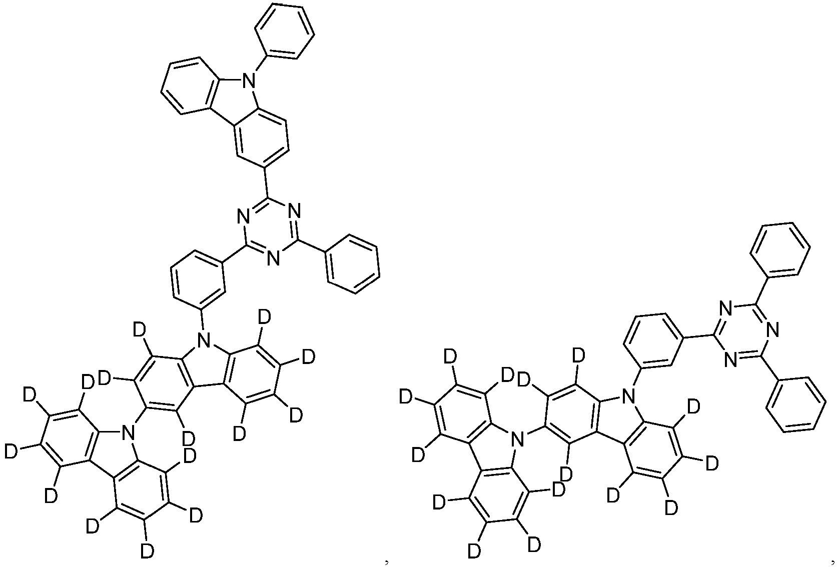 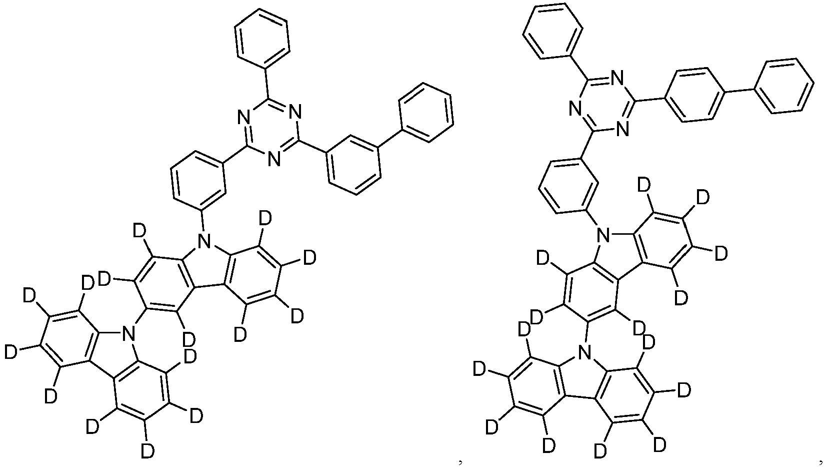 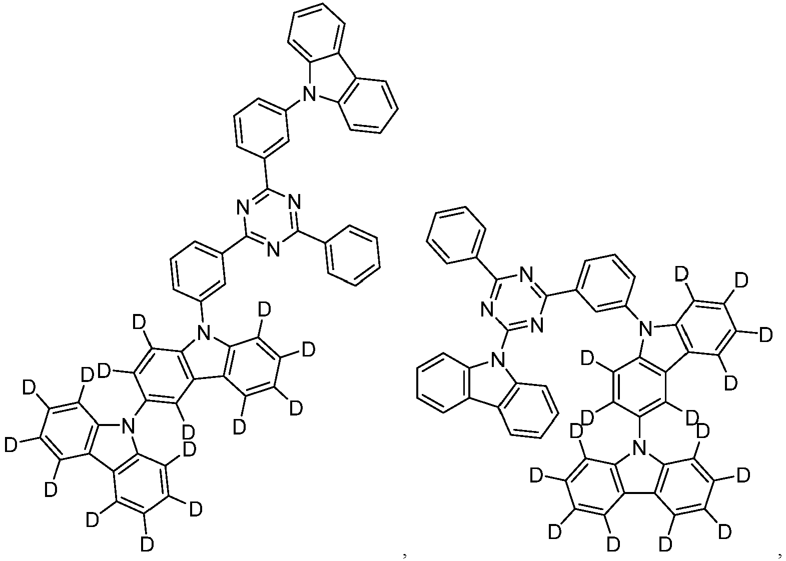 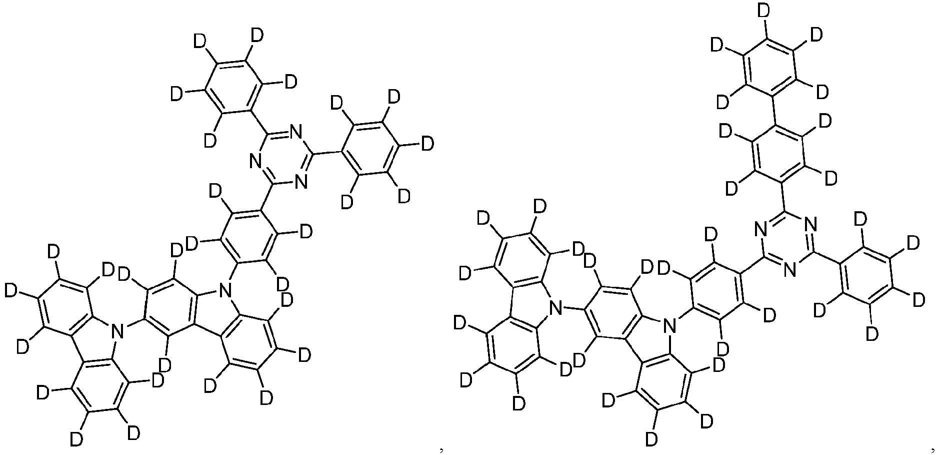 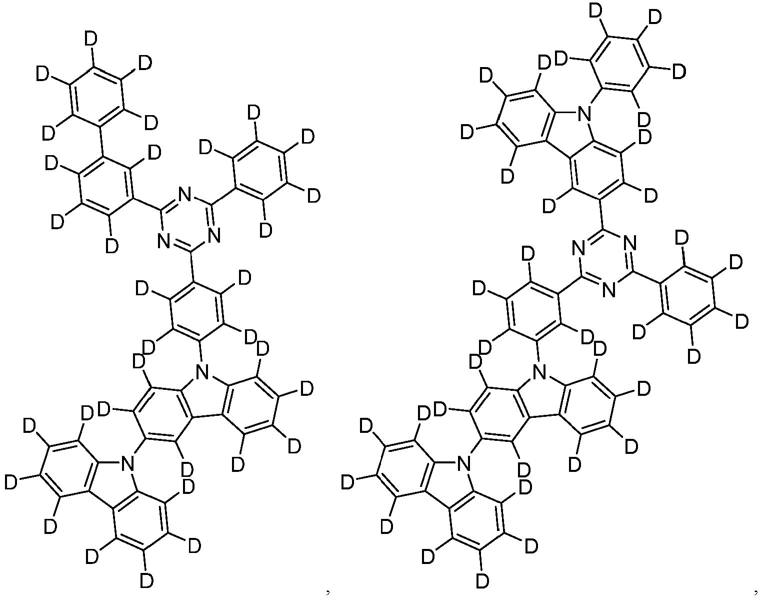 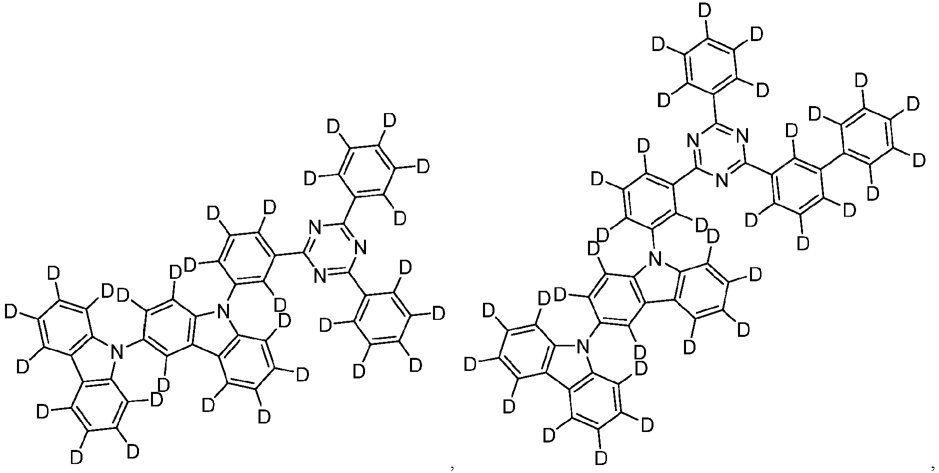 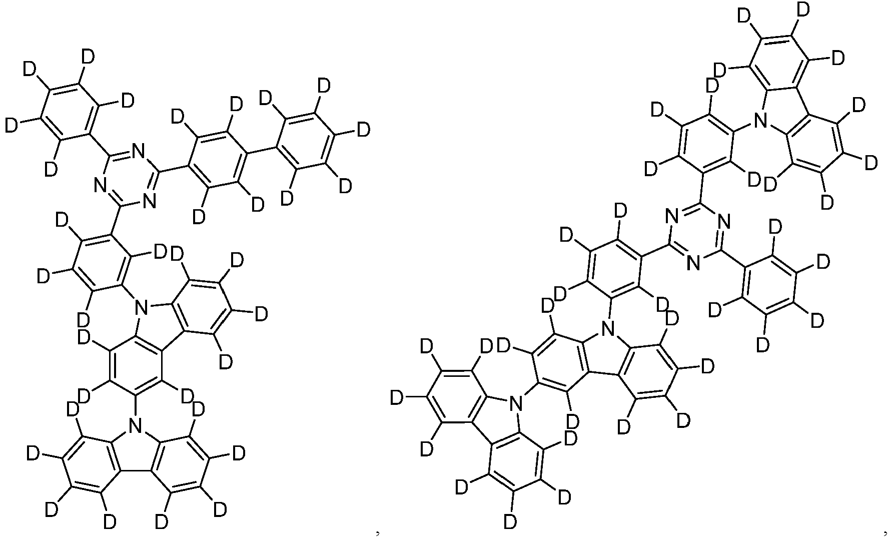 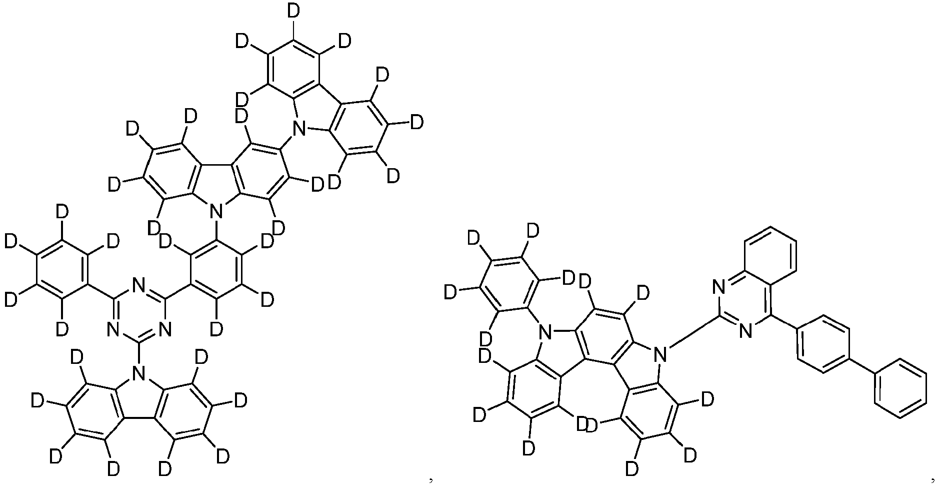 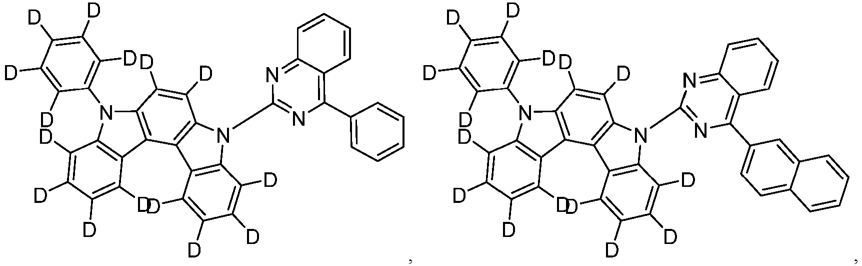 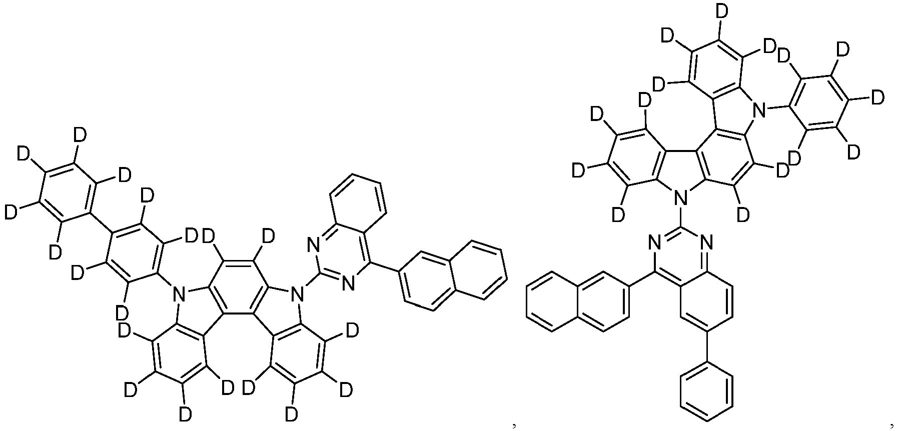 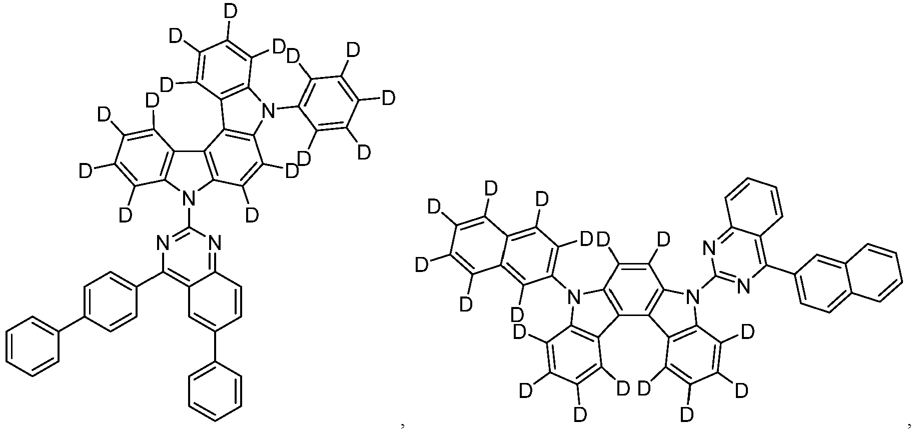 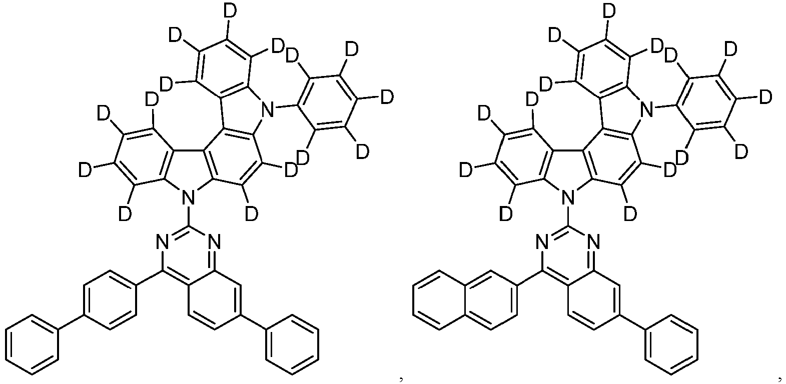 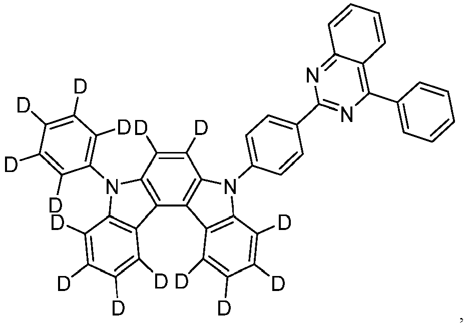 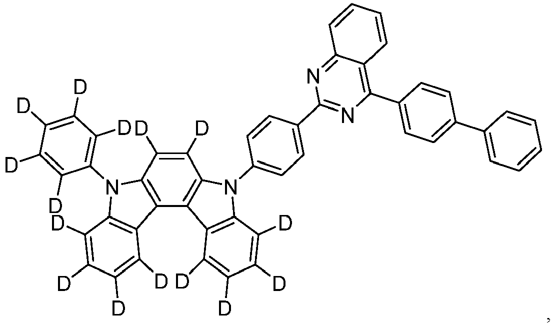 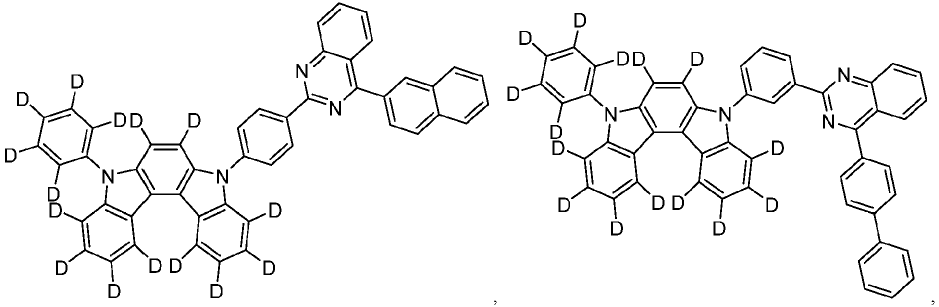 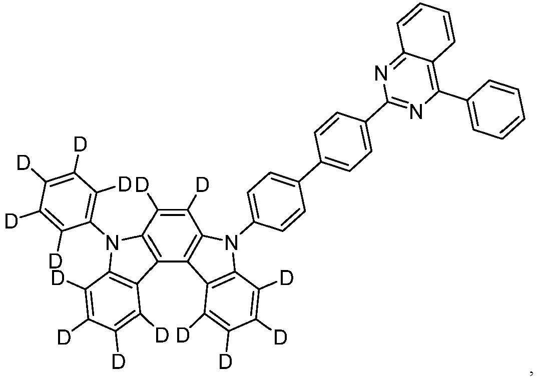 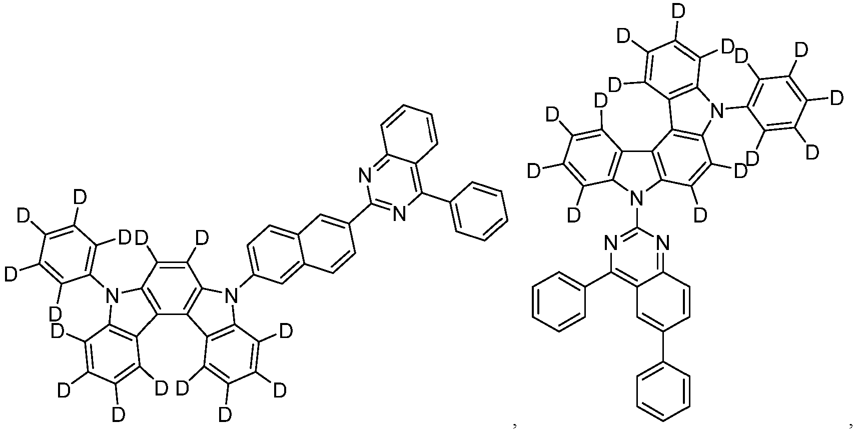 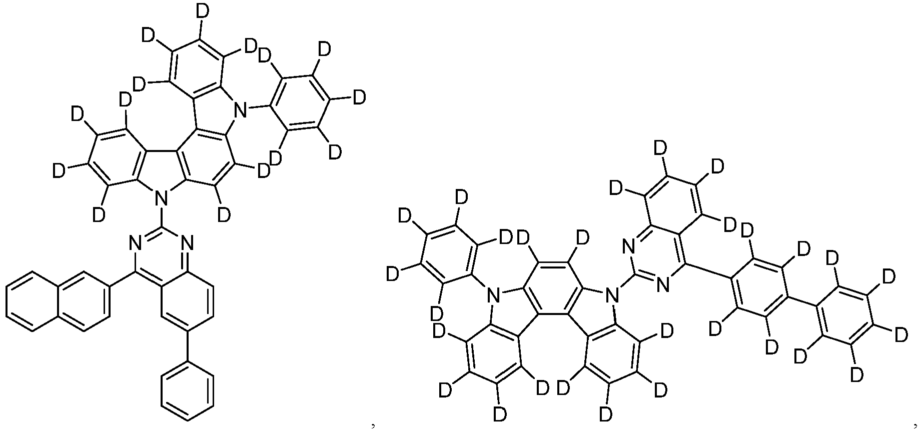 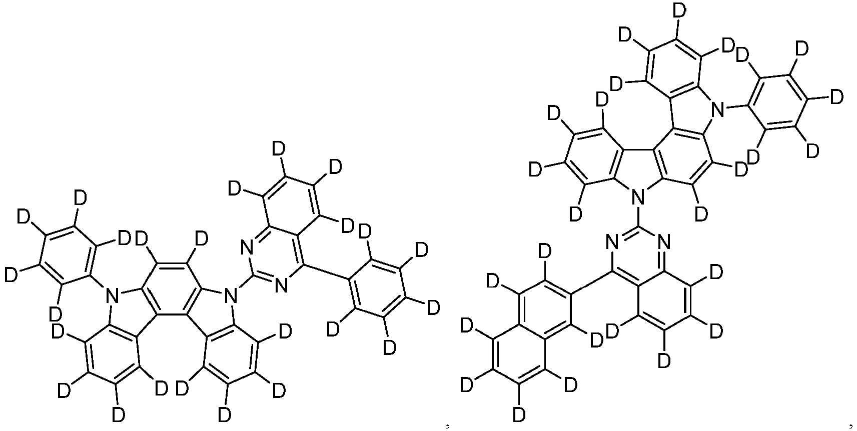 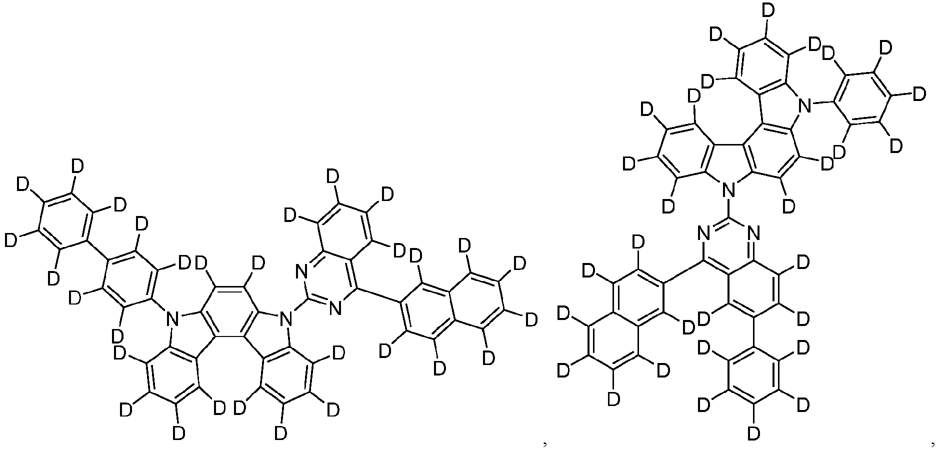 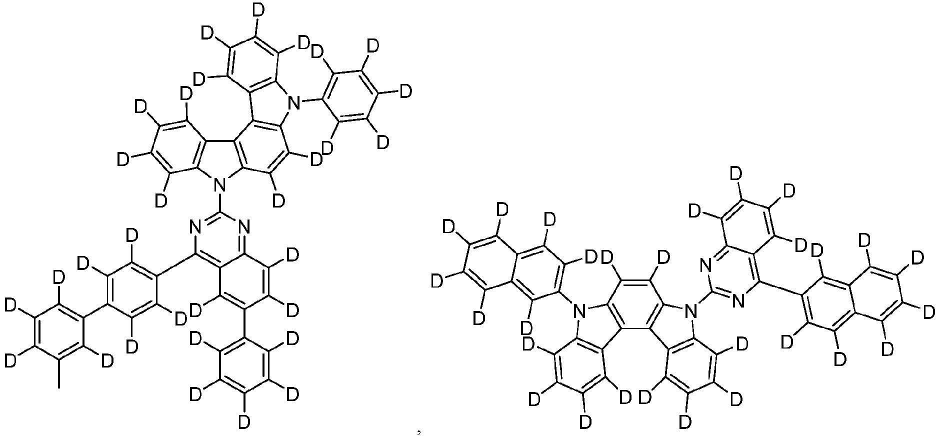 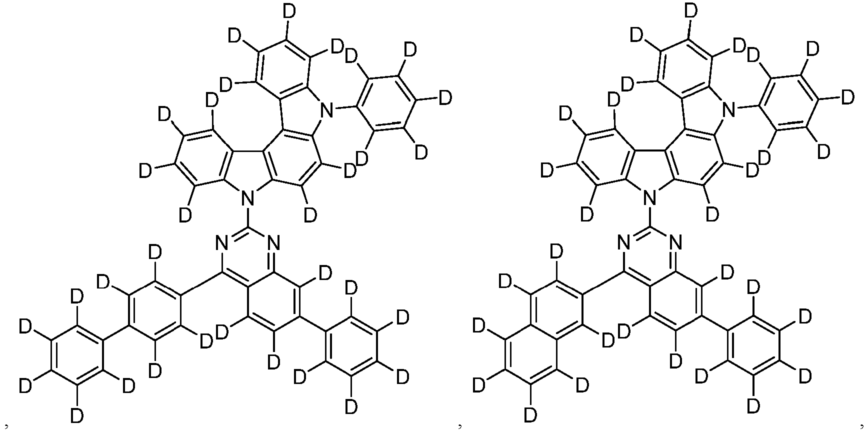 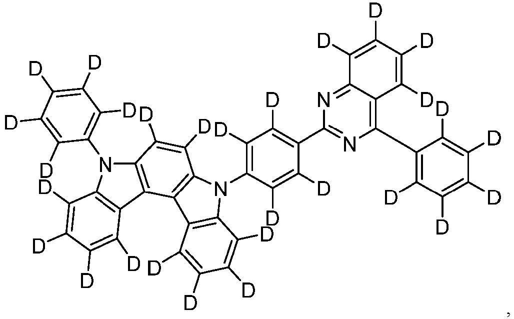 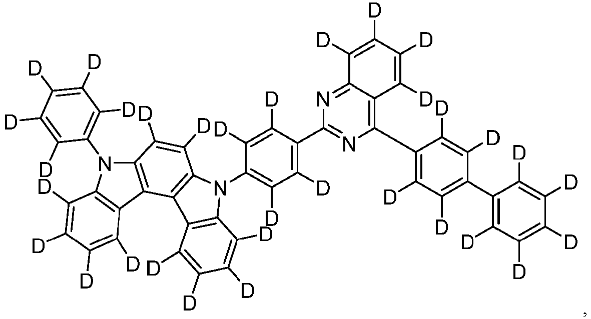 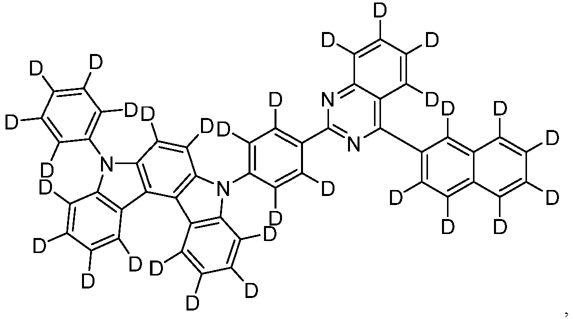 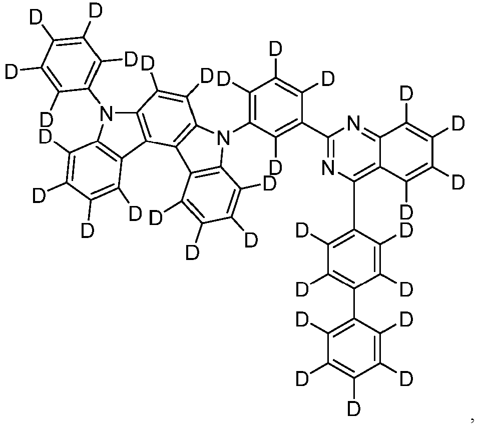 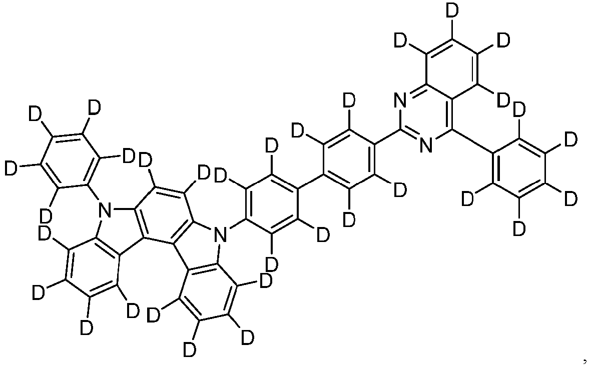 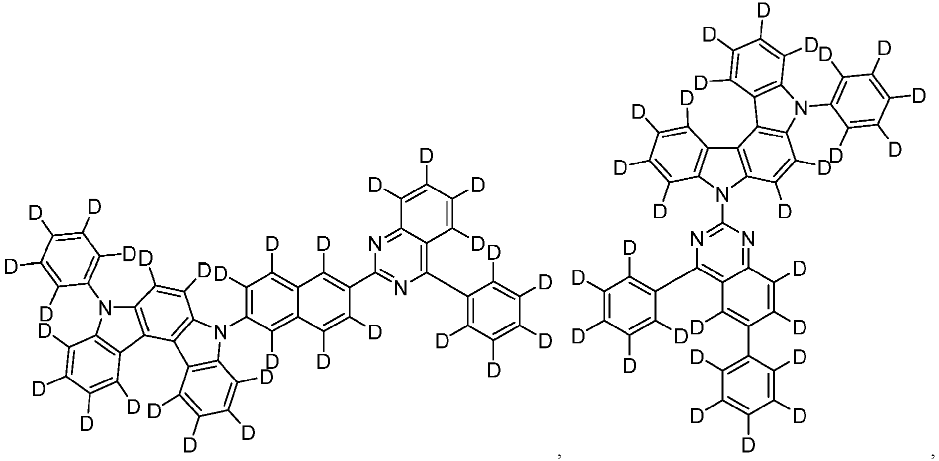 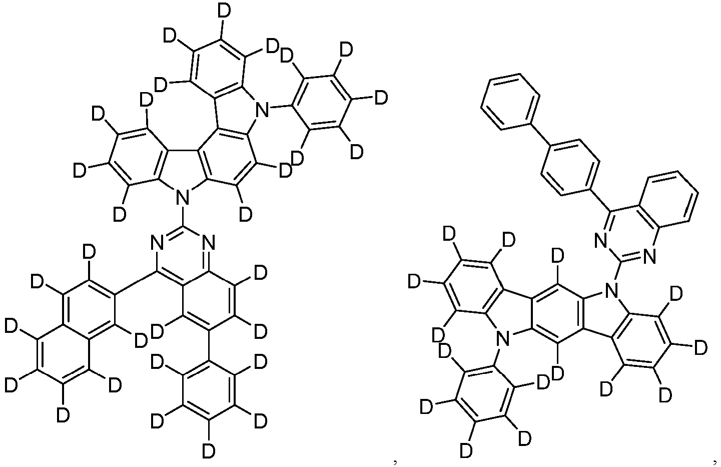 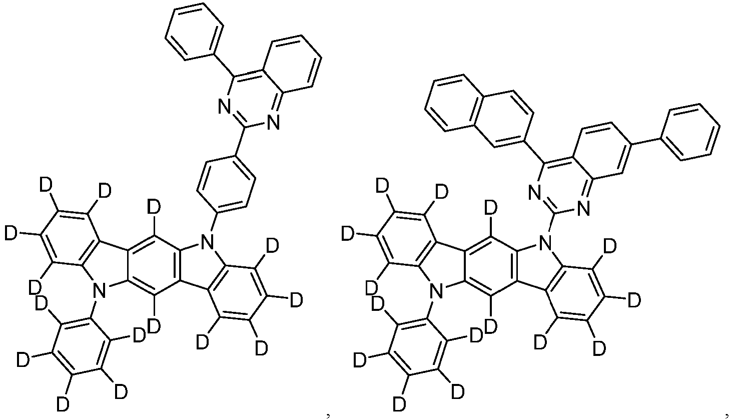 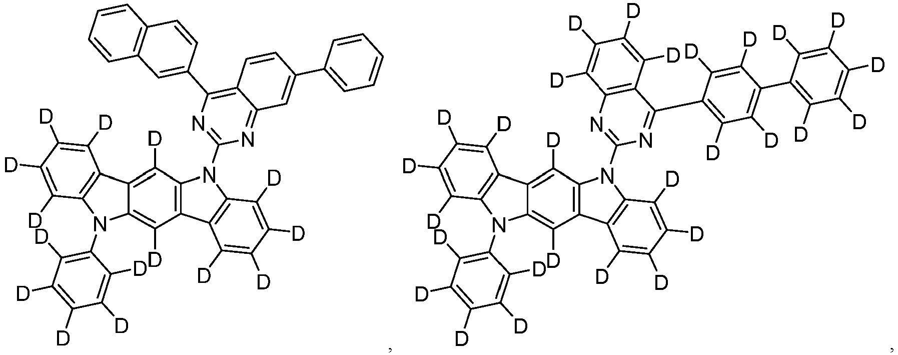 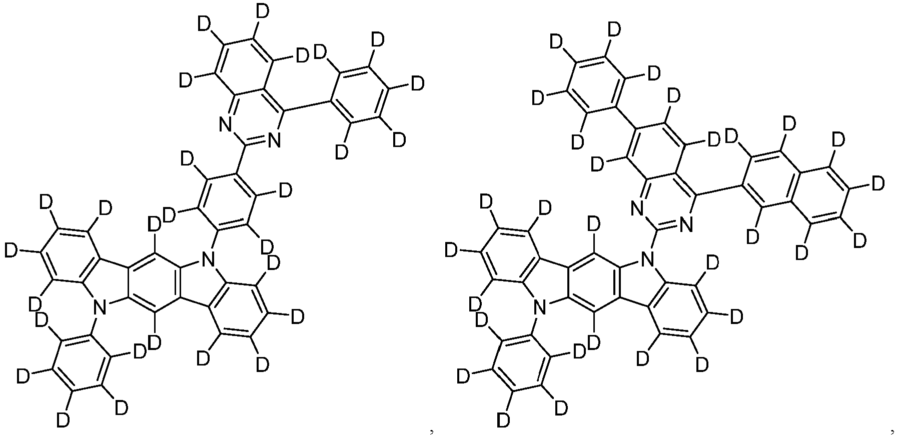 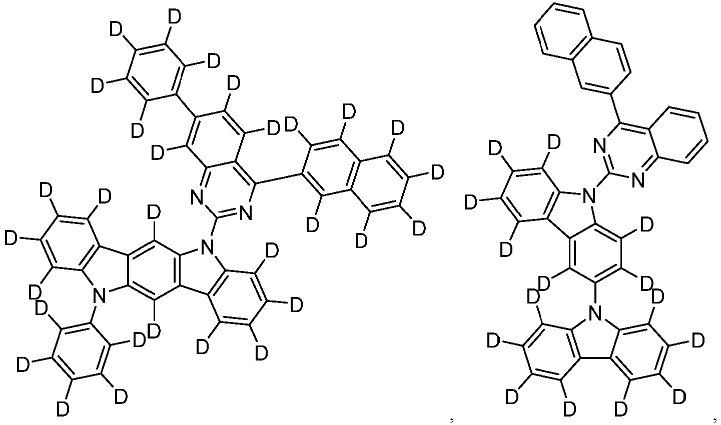 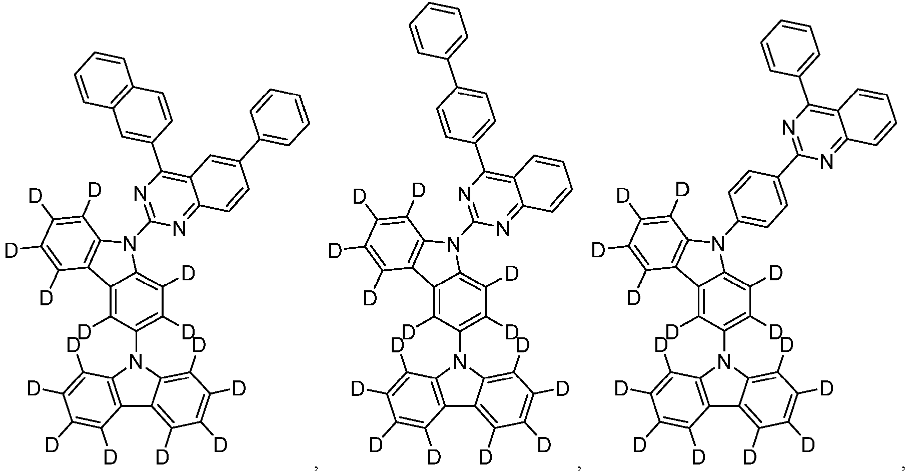 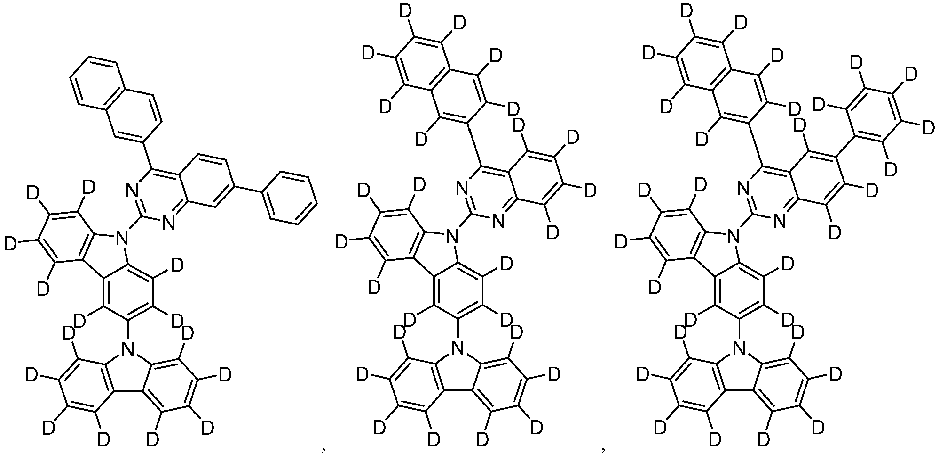 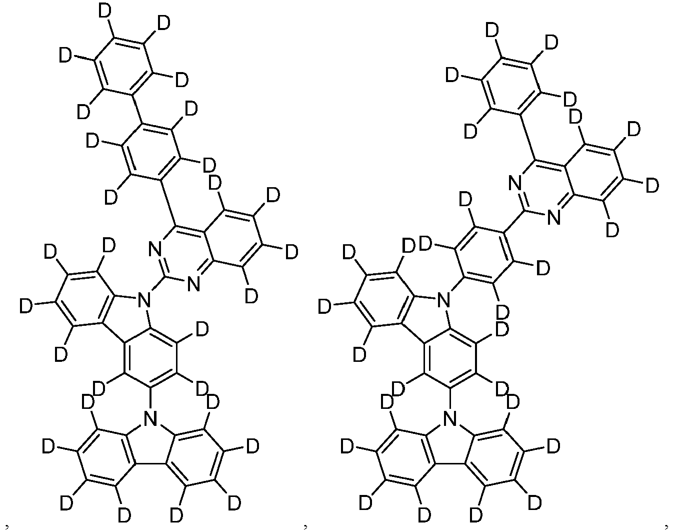 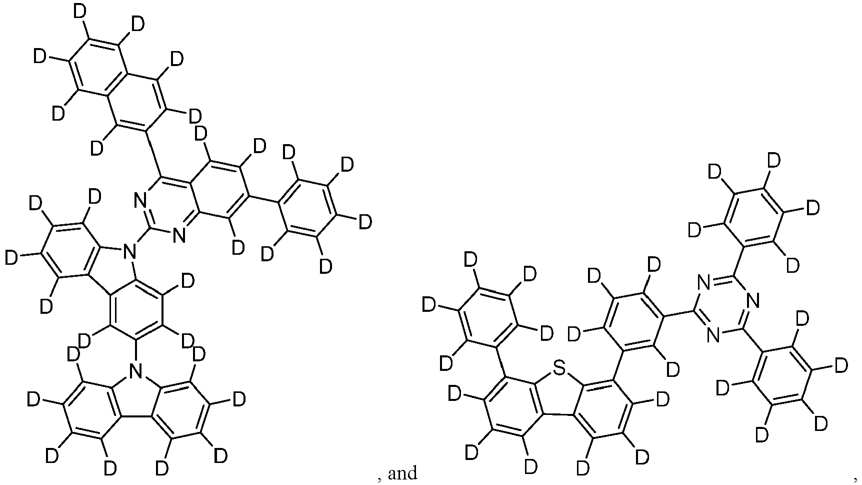 wherein:
each of X₁ to X₁₁ is independently C or N;
each Y^{A} is independently absent or, when present, is selected from the group consisting of O, S, Se, CRR', SiRR', NR, BR, BRR';
each of R^{A'}, R^{E'}, R^{C'}, R^{D'}, R^{E'}, R^{F'}, and R^{G'} independently represents mono-, up to the maximum substitutions, or no substitutions;
each of R, R', R^{A'}, R^{B'}, R^{C'}, R^{D'}, R^{E'}, R^{F'}, and R^{G'} is independently a hydrogen or a substituent selected from the group consisting of the General Substituents defined herein; and
at least one R, R', R^{A'}, R^{E'}, R^{C'}, R^{D'}, R^{E'}, R^{F'}, or R^{G'} comprises deuterium.

## Patentansprüche

1. Organische Elektrolumineszenzvorrichtung (OLED) (100, 200), umfassend:
eine Anode (115, 230);
eine Kathode (160, 215); und
eine Emissionsschicht (135, 220), die zwischen der Anode (115, 230) und der Kathode (160, 215) angeordnet ist;
wobei die Emissionsschicht (135, 220) einen ersten phosphoreszierenden Emitter und einen ersten Wirt umfasst;
wobei der erste phosphoreszierende Emitter ein Metallkomplex ist;
wobei der erste Wirt teilweise oder vollständig deuteriert ist; und
**dadurch gekennzeichnet, dass** der Metallkomplex ein Pt-Komplex ist und mindestens zwei der folgenden Bedingungen erfüllt sind:
(1) der Metallkomplex umfasst eine Metall-Carben-Bindung;
(2) der Metallkomplex umfasst eine Seitengruppe, die mindestens drei 6-gliedrige aromatische Ringe umfasst, von denen keiner direkt an einen anderen der mindestens drei 6-gliedrigen aromatischen Ringe ankondensiert ist; und
(3) die emittierende Schicht umfasst ferner einen zweiten Wirt, wobei der zweite Wirt teilweise oder vollständig deuteriert ist.

2. Organische Elektrolumineszenzvorrichtung (OLED) (100, 200), umfassend:
eine Anode (115, 230);
eine Kathode (160, 215); und
eine Emissionsschicht (135, 220), die zwischen der Anode (115, 230) und der Kathode (160, 215) angeordnet ist;
wobei die Emissionsschicht (135, 220) einen ersten phosphoreszierenden Emitter, einen ersten Wirt und einen zweiten Wirt umfasst;
wobei der erste Wirt teilweise oder vollständig deuteriert ist;
wobei der zweite Wirt teilweise oder vollständig deuteriert ist; und
**dadurch gekennzeichnet, dass** der erste phosphoreszierende Emitter ein Metallkomplex ist, der mindestens ein Merkmal umfasst, das ausgewählt ist aus der Gruppe bestehend aus einer kondensierten Ringstruktur mit mindestens vier linear kondensierten Ringen; einer Carbazol-Einheit, die direkt an das Metall gebunden ist; oder einer Ringstruktur, die 7 oder mehr Atome umfasst.

3. OLED nach Anspruch 1, wobei das Carben durch einen Substituenten R substituiert ist, wobei der Substituent R teilweise oder vollständig deuteriert ist, wobei der Substituent R mindestens zwei 6-gliedrige aromatische Ringe umfasst, von denen jeder nicht direkt an den anderen 6-gliedrigen aromatischen Ring kondensiert ist.

4. OLED nach Anspruch 2, wobei der Metallkomplex mindestens ein Merkmal umfasst, das ausgewählt ist aus der Gruppe bestehend aus einer kondensierten Ringstruktur mit mindestens vier linear kondensierten Ringen; oder einer Carbazol-Einheit, die direkt an das Metall gebunden ist.

5. OLED nach Anspruch 1 oder Anspruch 2, wobei der erste Wirt eine Borylgruppe umfasst, wobei die Borylgruppe ein dreiwertiges Boratom ist, wobei sich das Boratom in einem der Ringgerüste befindet; sich das Boratom in zwei der Ringgerüste befindet; oder sich das Boratom in drei der Ringgerüste befindet.

6. OLED nach Anspruch 1 oder Anspruch 2, wobei der erste Wirt zu mindestens 10 % deuteriert ist.

7. OLED nach Anspruch 1 oder Anspruch 2, wobei der Metallkomplex ein Platin-Komplex ist und der erste Wirt eine Einheit umfasst, die ausgewählt ist aus der Gruppe bestehend aus Triazin, Pyridin, Pyrimidin, Pyrazin, Pyridazin, Dibenzofuran, Dibenzothiophen, Aza-Dibenzofuran, Aza-Dibenzothiophen, Triphenylen, Aza-Triphenylen, Carbazol, Indolocarbazol, Aza-Carbazol, Aza-Indolocarbazol, Silyl und Boryl.

8. OLED nach Anspruch 1 oder Anspruch 2, wobei der Metallkomplex mindestens eine Einheit umfasst, die ausgewählt ist aus der Gruppe bestehend aus einer teilweise deuterierten Alkylgruppe, einer teilweise deuterierten Cycloalkylgruppe, einer teilweise deuterierten Aryl- oder Heteroarylgruppe, einer vollständig deuterierten Alkylgruppe und einer vollständig deuterierten Aryl- oder Heteroarylgruppe.

9. OLED nach Anspruch 1 oder Anspruch 2, wobei der erste Wirt ausgewählt ist aus der Gruppe bestehend aus: 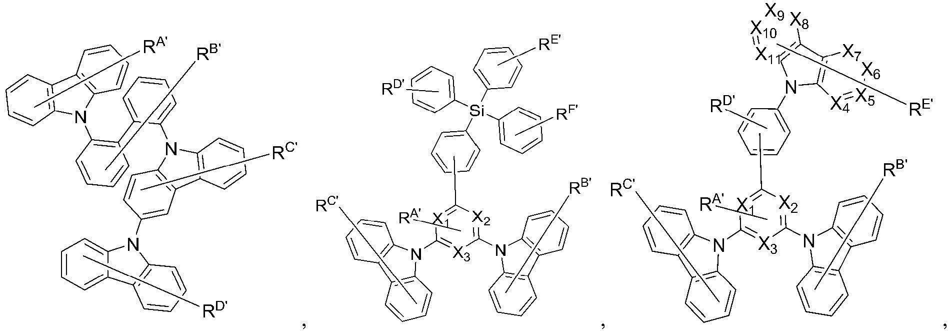 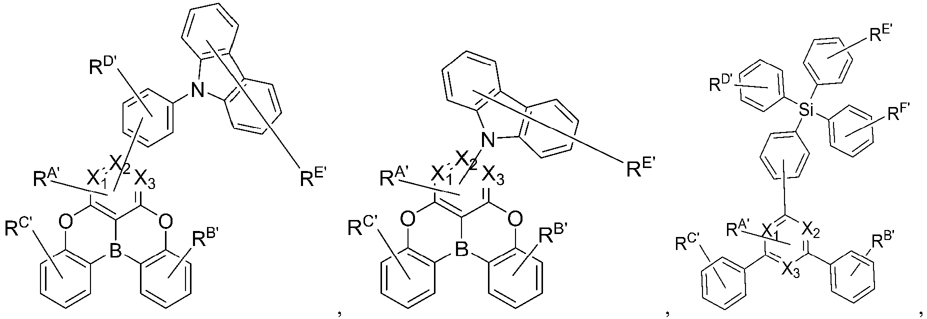 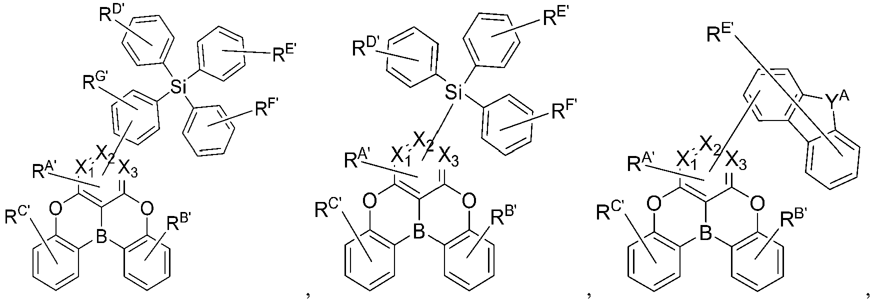 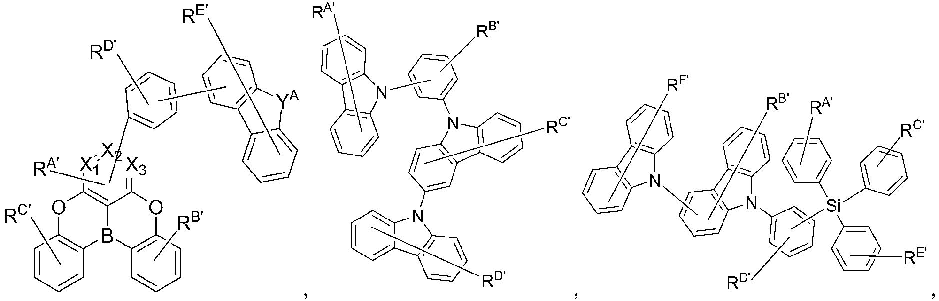 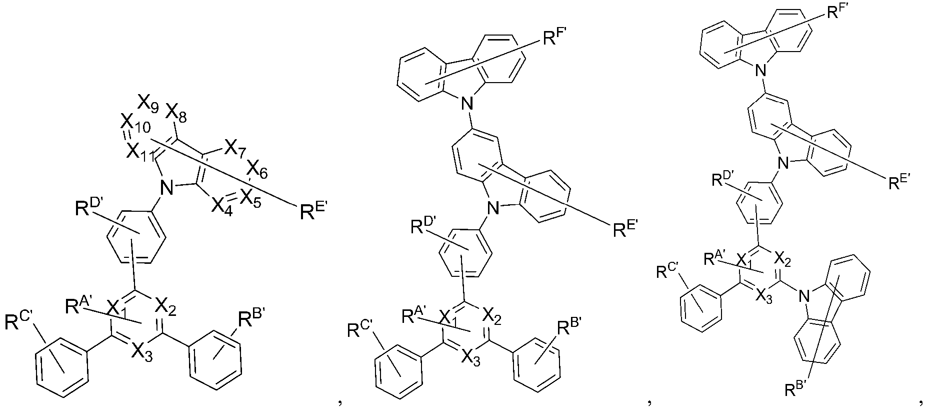 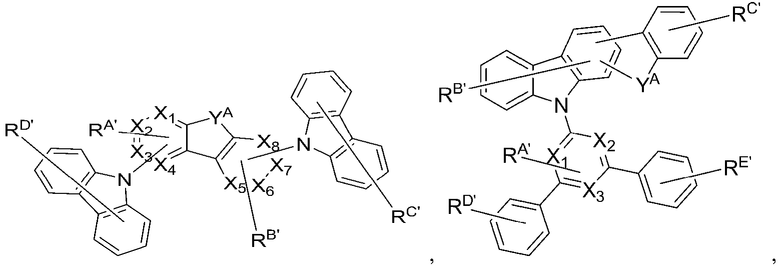 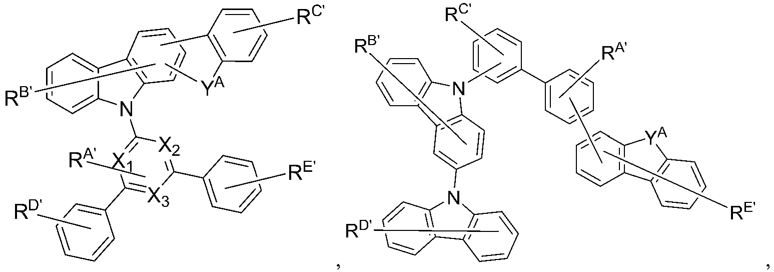 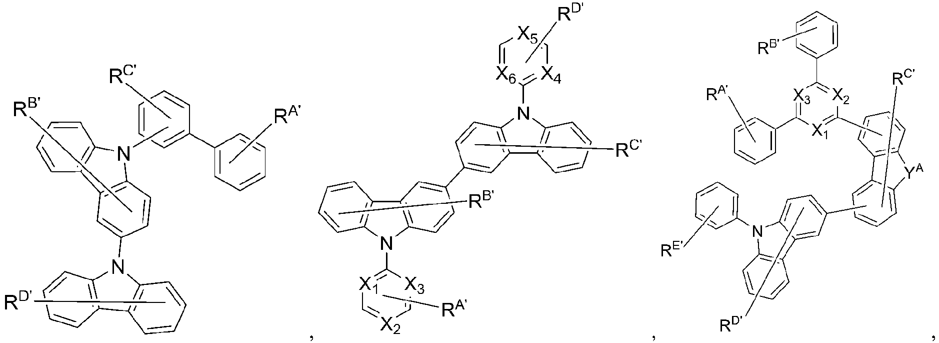 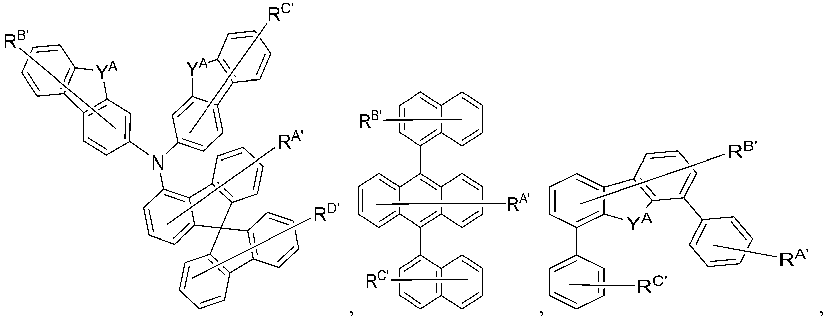 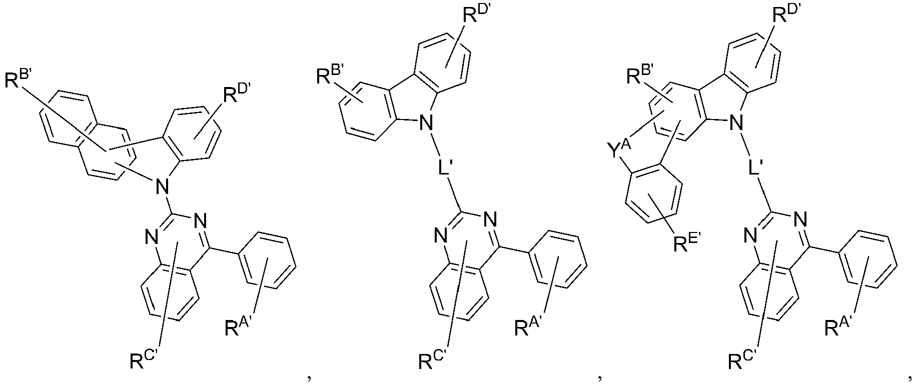 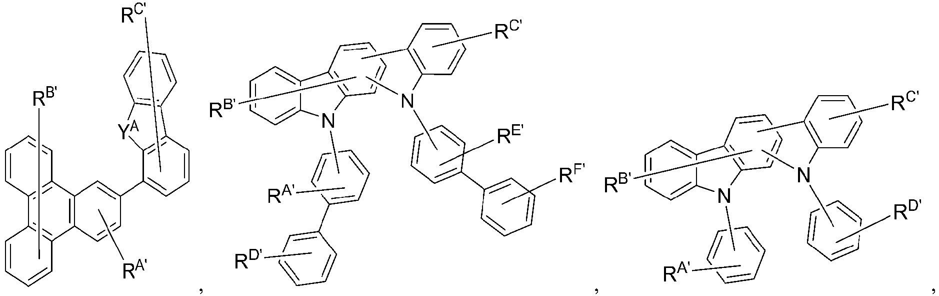 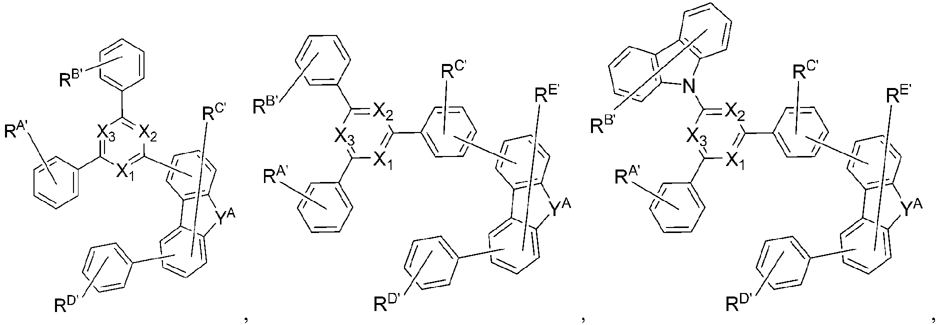 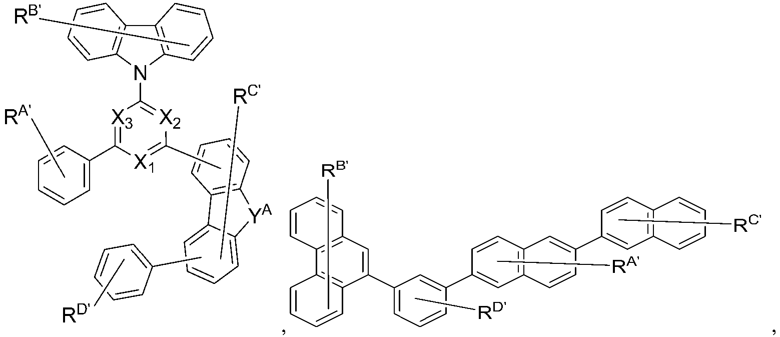 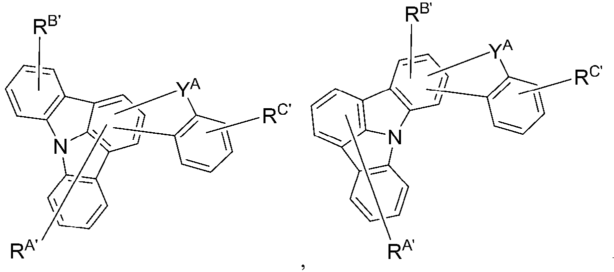 und 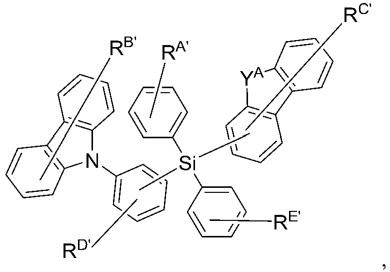 wobei:
jedes von X₁ bis X₁₁ unabhängig C oder N ist;
jedes Y^{A} unabhängig entweder fehlt oder, falls vorhanden, ausgewählt ist aus der Gruppe bestehend aus O, S, Se, CRR', SiRR', NR, BR, BRR';
jedes von R^{A'}, R^{B'}, R^{C'}, R^{D'}, R^{E'}, R^{F'} und R^{G'} steht unabhängig für eine, bis zur maximalen Anzahl an Substitutionen oder keine Substitutionen;
jedes von R, R', R^{A'}, R^{B'}, R^{C'}, R^{D'}, R^{E'}, R^{F'} und R^{G'} ist unabhängig voneinander ein Wasserstoffatom oder ein Substituent, ausgewählt aus der Gruppe bestehend aus Deuterium, Halogen, Alkyl, Cycloalkyl, Heteroalkyl, Heterocycloalkyl, Arylalkyl, Alkoxy, Aryloxy, Amino, Silyl, Boryl, Germyl, Alkenyl, Cycloalkenyl, Heteroalkenyl, Alkinyl, Aryl, Heteroaryl, Acyl, Carbonsäure, Ether, Ester, Nitril, Isonitril, Sulfanyl, Sulfinyl, Sulfonyl, Phosphino, Selenyl und Kombinationen davon; und
mindestens eines der Symbole R, R', R^{A'}, R^{B'}, R^{C'}, R^{D'}, R^{E'}, R^{F'} oder R^{G'} enthält Deuterium.

10. OLED nach Anspruch 1 oder Anspruch 2, wobei der Metallkomplex die Struktur M(L_{A})ₚ(L_{B})_{q}(L_{C})ᵣ aufweist, wobei p 1, 2 oder 3 ist; q 0, 1 oder 2 ist; r 0, 1 oder 2 ist; und p+q+r die Oxidationsstufe des Metalls Mist;
der Ligand L_{A} eine Einheit umfasst, die ausgewählt ist aus der Gruppe bestehend aus: 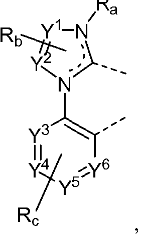 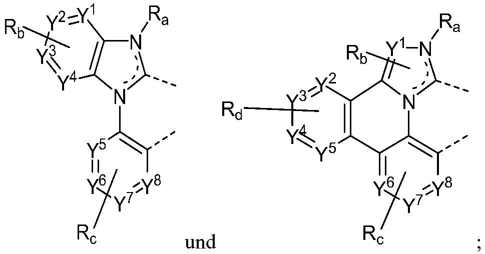
wobei:
jedes von Y¹ bis Y⁸ unabhängig C oder N ist;
jedes von R^{b}, R^{c} und R^{d} unabhängig eine Mono-, bis zur maximalen Anzahl an Substitutionen oder keine Substitutionen darstellt;
jedes R^{a}, R^{b}, R^{c} und R^{d} unabhängig voneinander Wasserstoff oder einen Substituenten darstellt, der ausgewählt ist aus der Gruppe bestehend aus Deuterium, Halogen, Alkyl, Cycloalkyl, Heteroalkyl, Heterocycloalkyl, Arylalkyl, Alkoxy, Aryloxy, Amino, Silyl, Boryl, Alkenyl, Cycloalkenyl, Heteroalkenyl, Alkinyl, Aryl, Heteroaryl, Acyl, Carbonsäure, Ether, Ester, Nitril, Isonitril, Sulfanyl, Sulfinyl, Sulfonyl, Phosphino und Kombinationen davon;
und sowohl der Ligand L_{B} als auch der Ligand L_{C} werden unabhängig voneinander ausgewählt aus der Gruppe bestehend aus: 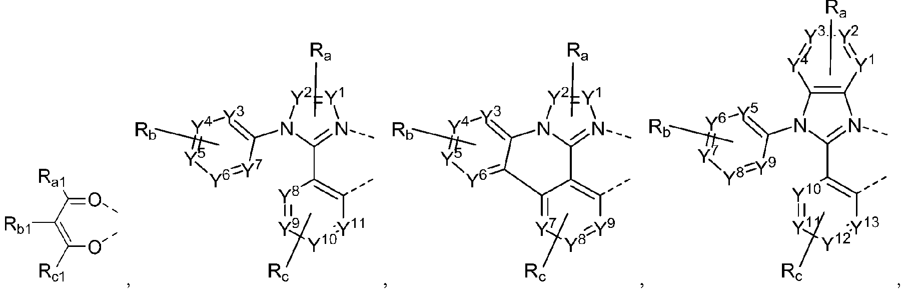 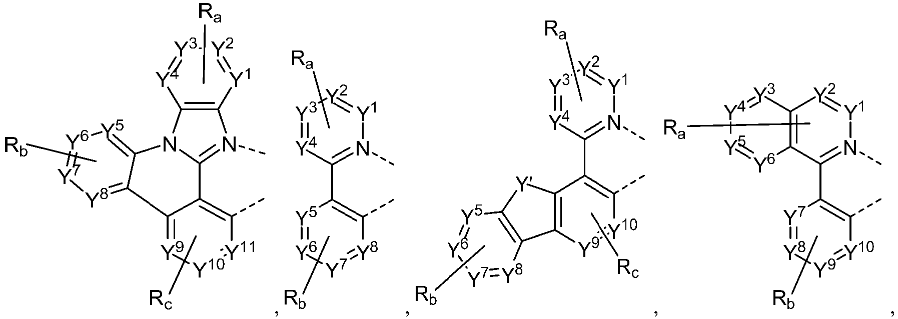 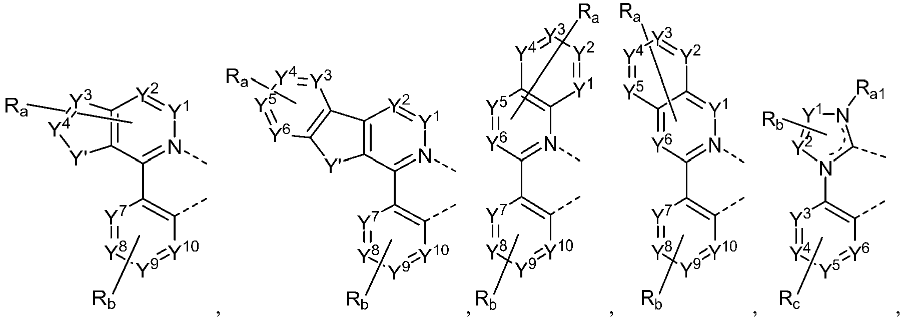 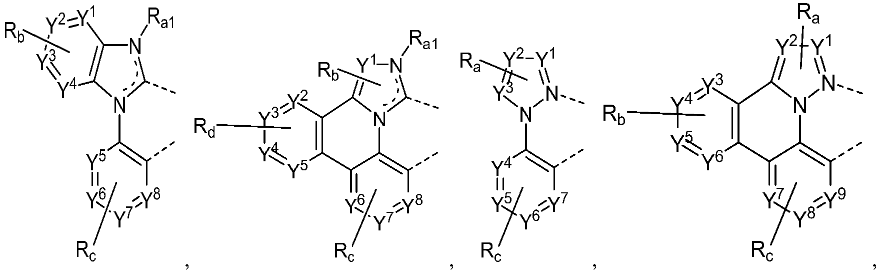 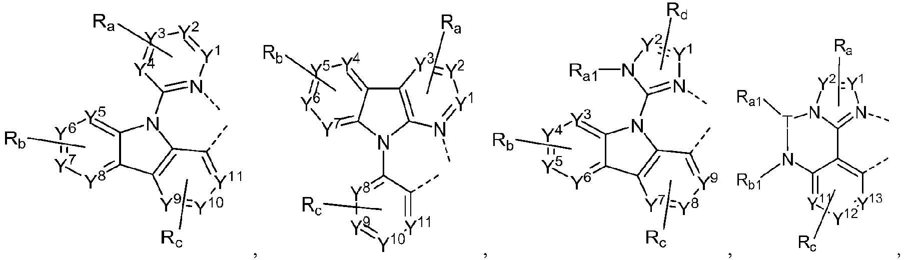 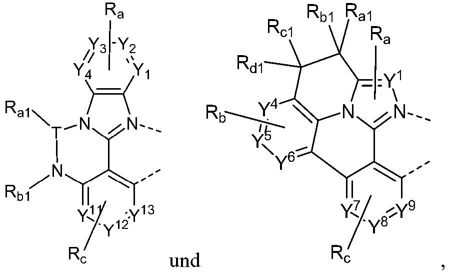
wobei:
T ausgewählt ist aus der Gruppe bestehend aus B, Al, Ga und In;
jedes von Y¹ bis Y¹³ unabhängig ausgewählt ist aus der Gruppe bestehend aus Kohlenstoff und Stickstoff;
Y' ausgewählt ist aus der Gruppe bestehend aus BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f} und GeRₑR_{f};
Rₑ und R_{f} können miteinander kondensiert oder zu einem Ring verbunden sein;
jedes R^{a}, R^{b}, R_{c} und R_{d} steht unabhängig voneinander für keine, eine oder bis zu einer maximal zulässigen Anzahl von Substitutionen an dem zugehörigen Ring;
jedes von Rₐ₁, R_{b1}, R_{c1}, Rₐ₁, Rₐ, R_{b}, R_{c}, Rₐ, Rₑ und R_{f} ist unabhängig voneinander ein Wasserstoffatom oder ein Substituent, ausgewählt aus der Gruppe bestehend aus Deuterium, Halogenid, Alkyl, Cycloalkyl, Heteroalkyl, Arylalkyl, Alkoxy, Aryloxy, Amino, Silyl, Boryl, Alkenyl, Cycloalkenyl, Heteroalkenyl, Alkinyl, Aryl, Heteroaryl, Acyl, Carbonyl, Carbonsäure, Ester, Nitril, Isonitril, Sulfanyl, Sulfinyl, Sulfonyl, Phosphino und Kombinationen davon; und
beliebige zwei benachbarte Rₐ, R_{b}, R_{c}, R_{d}, Rₑ und R_{f} können kondensiert oder miteinander verbunden sein, um einen Ring oder einen mehrzähnigen Liganden zu bilden.

11. OLED nach Anspruch 1 oder Anspruch 2, wobei der zweite Wirt ausgewählt ist aus der Gruppe bestehend aus: 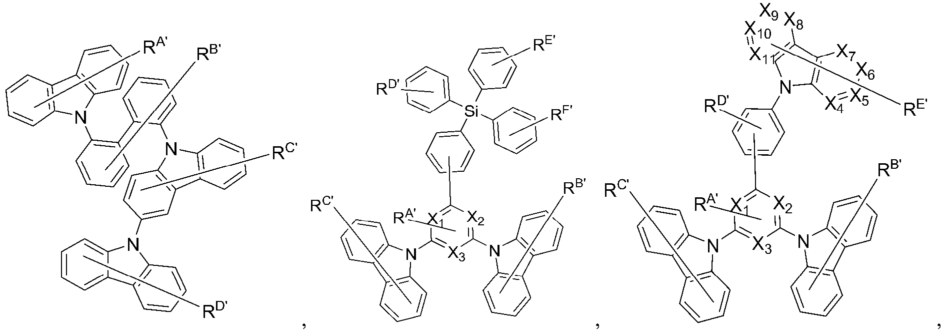 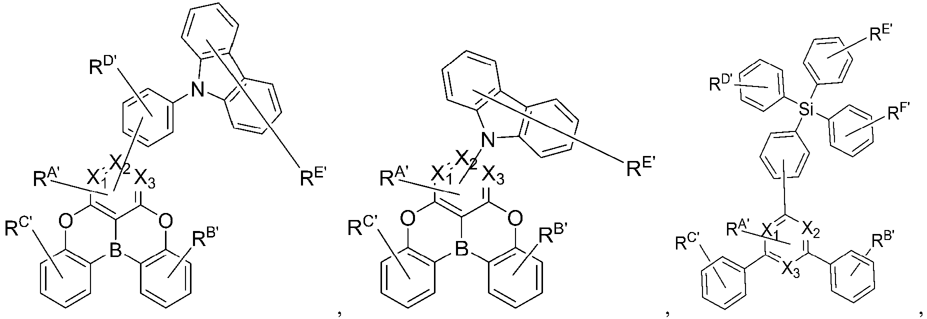 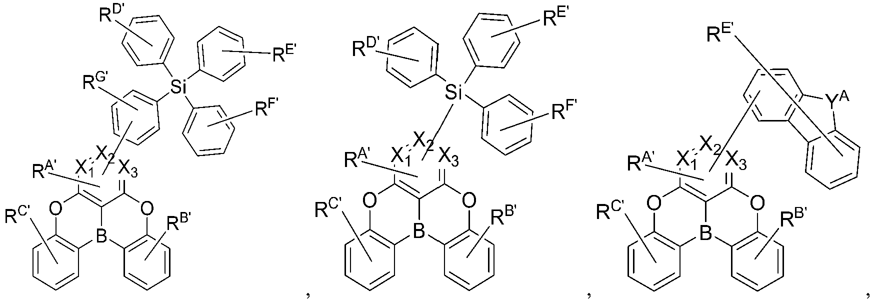 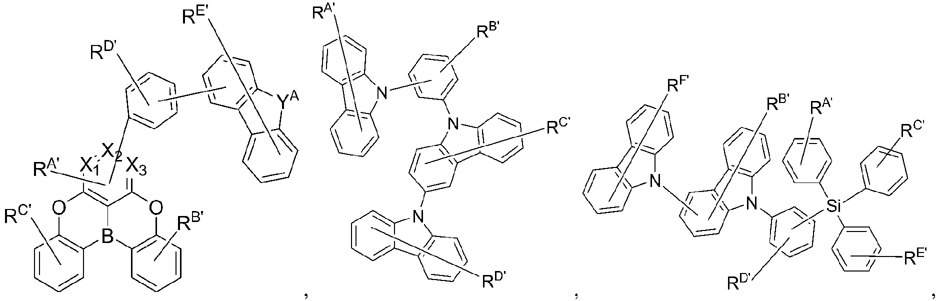 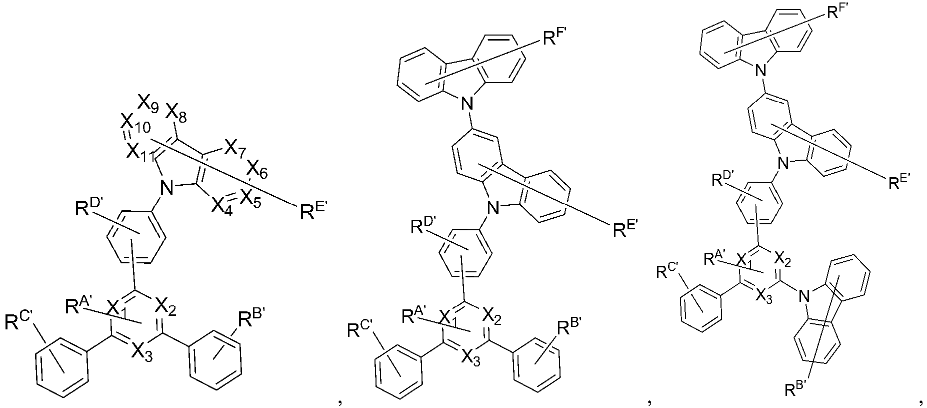 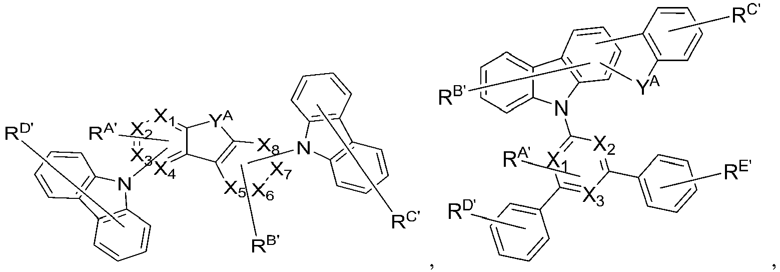 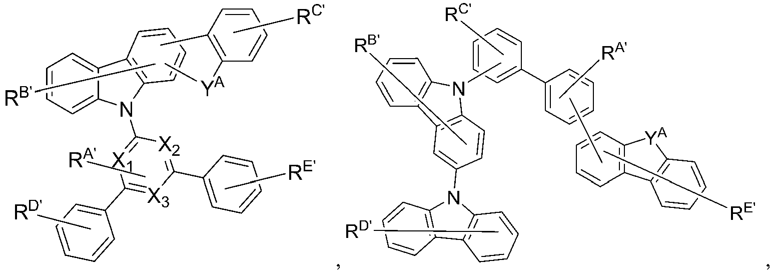 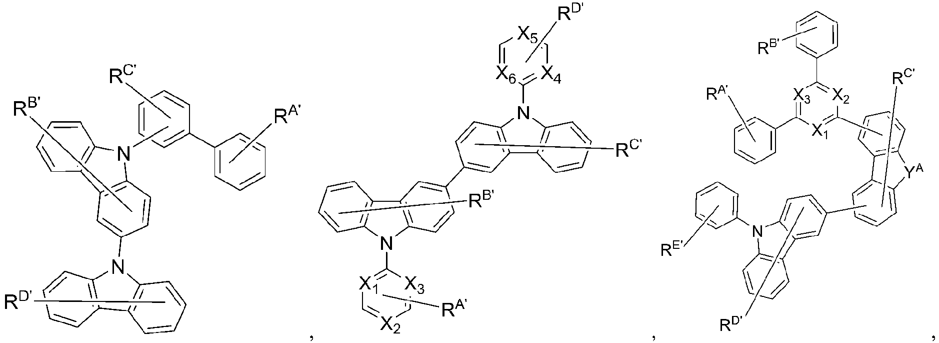 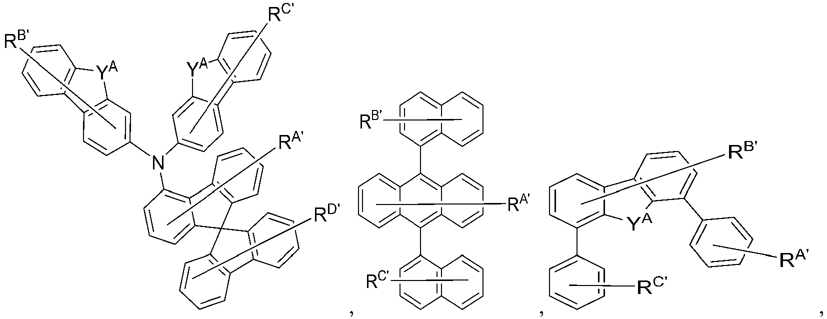 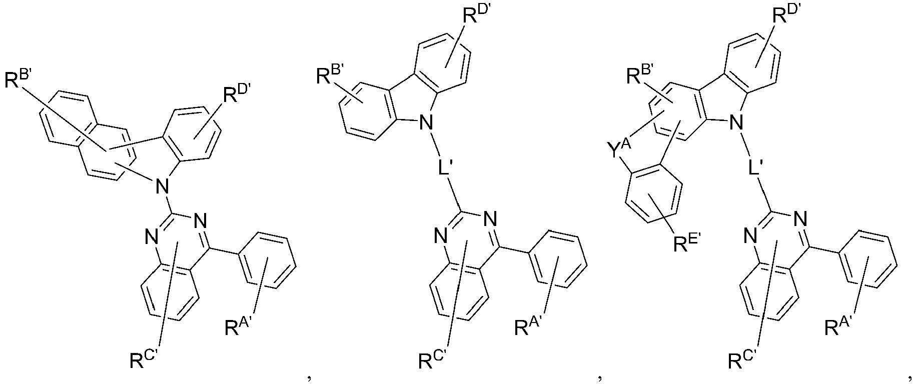 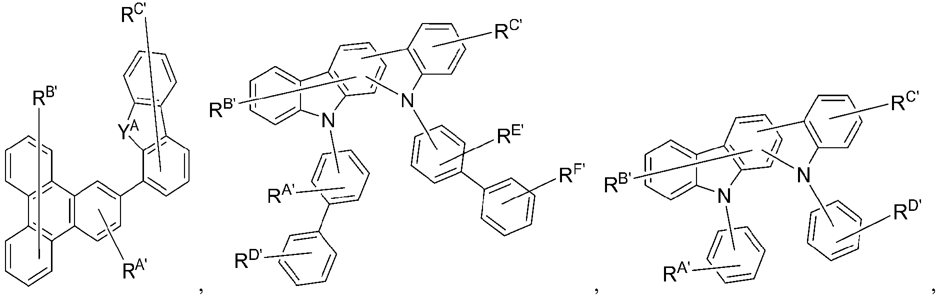 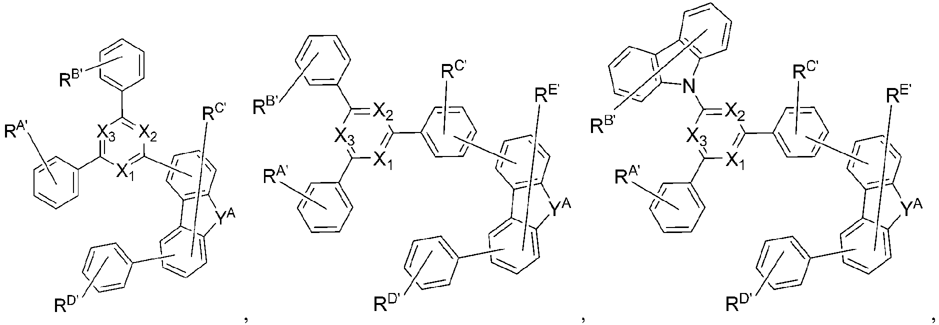 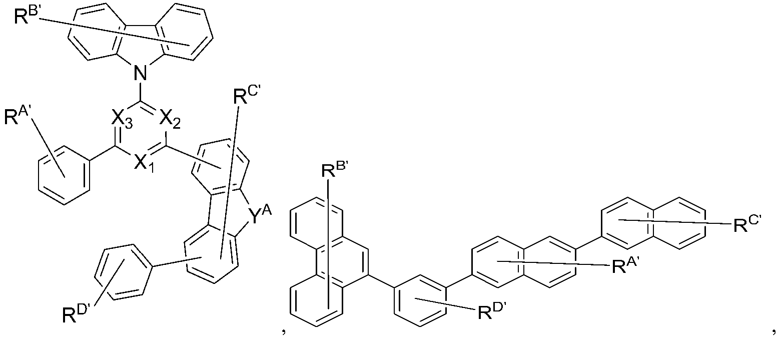 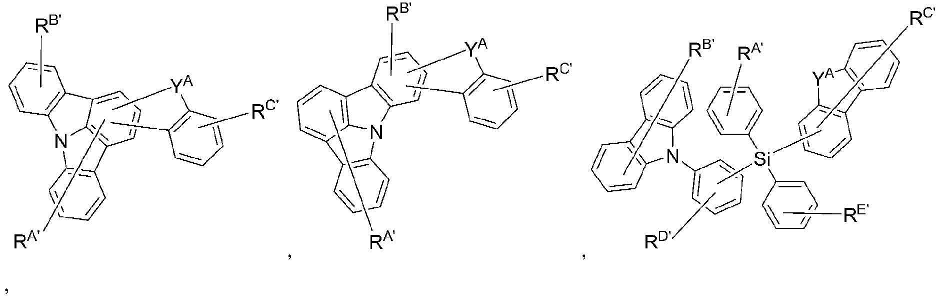 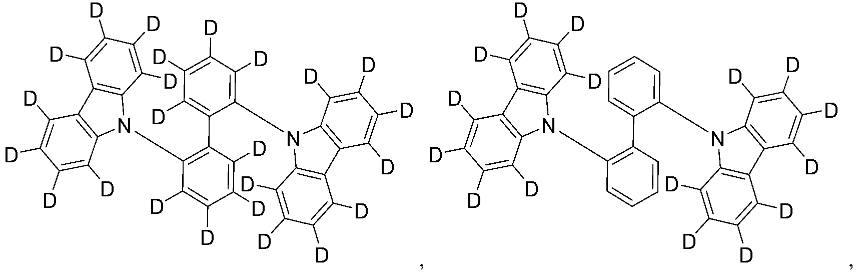 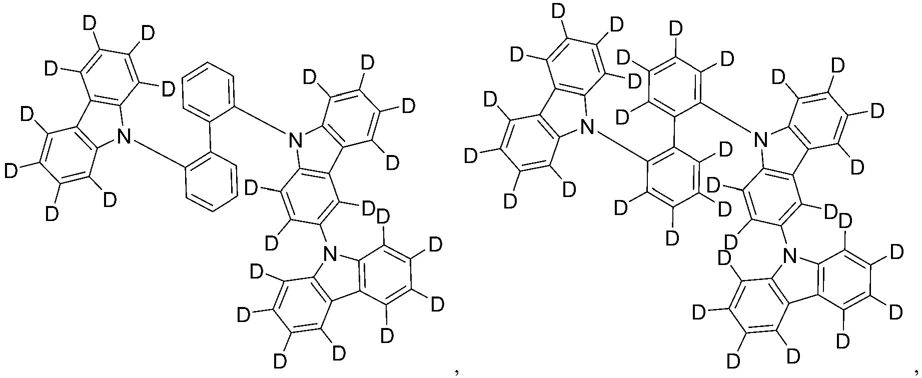 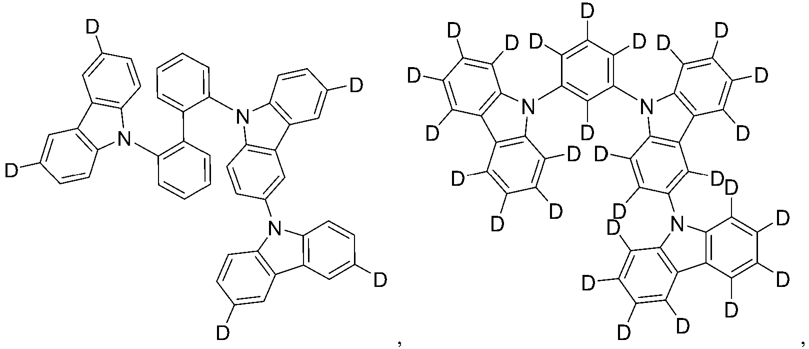 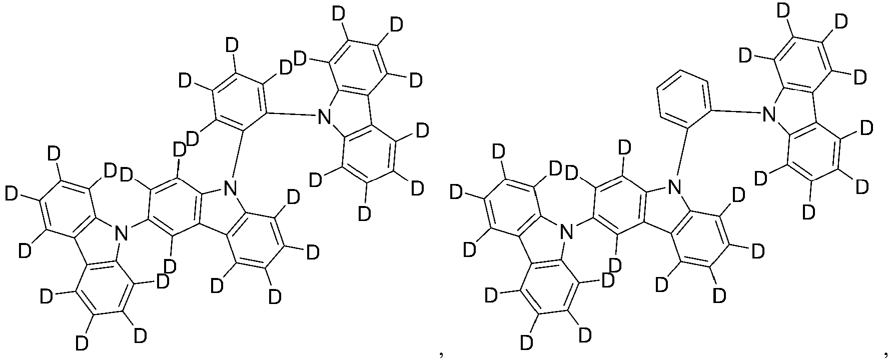 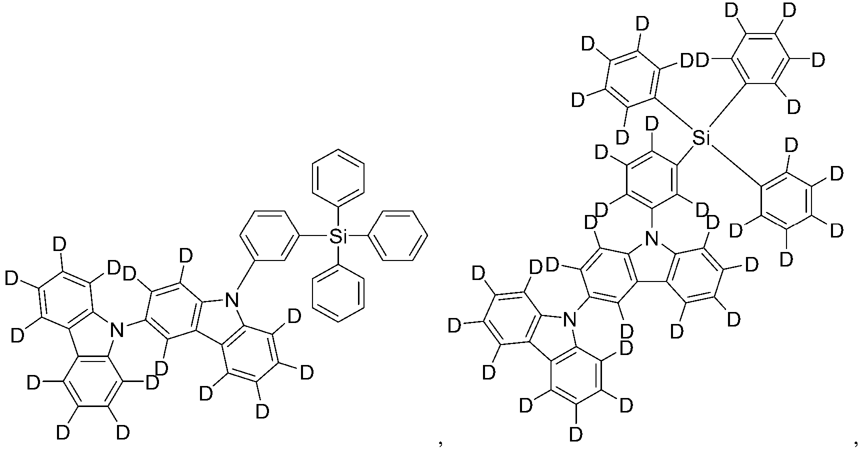 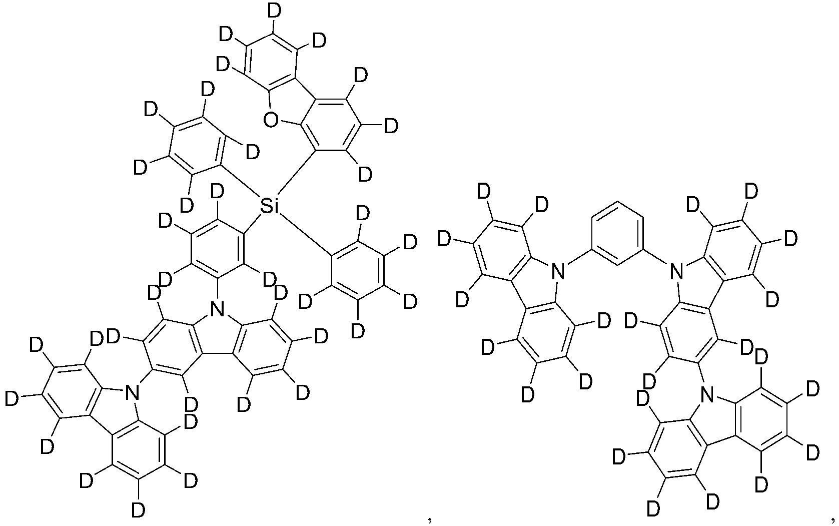 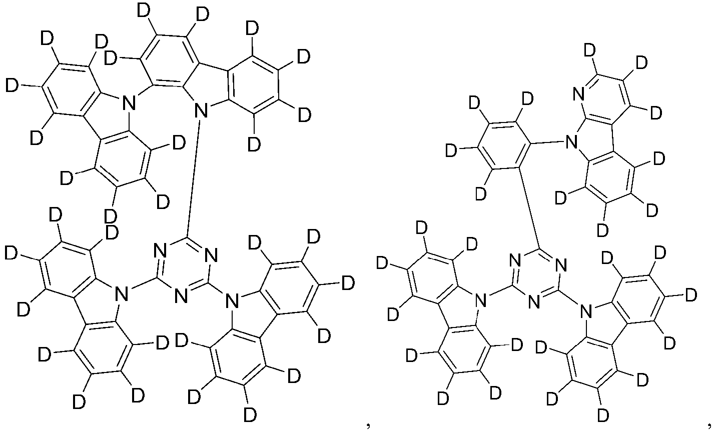 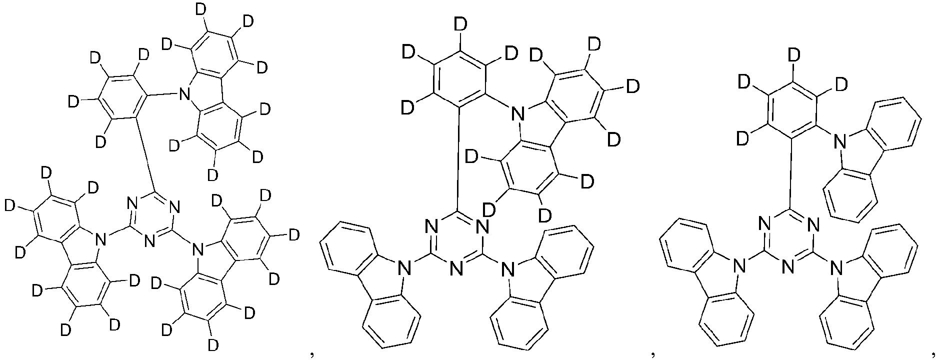 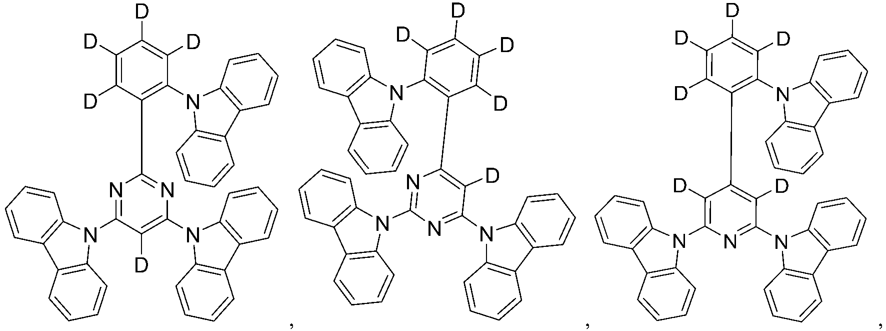 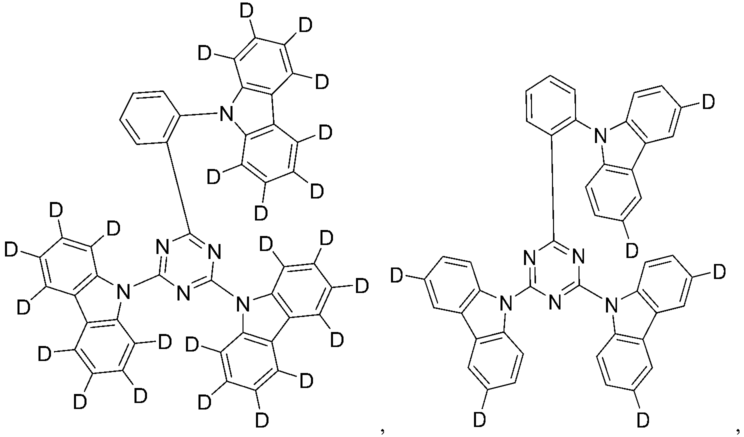 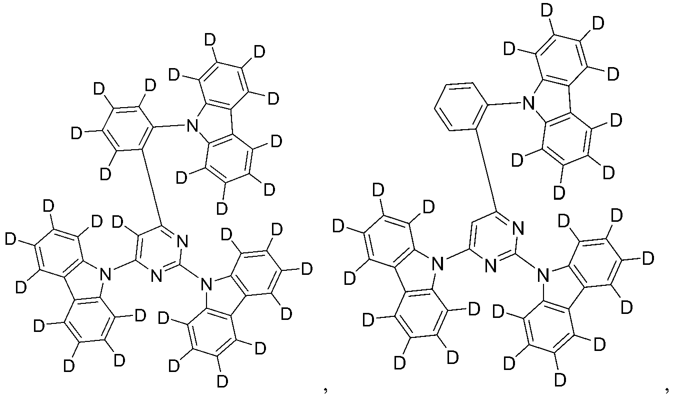 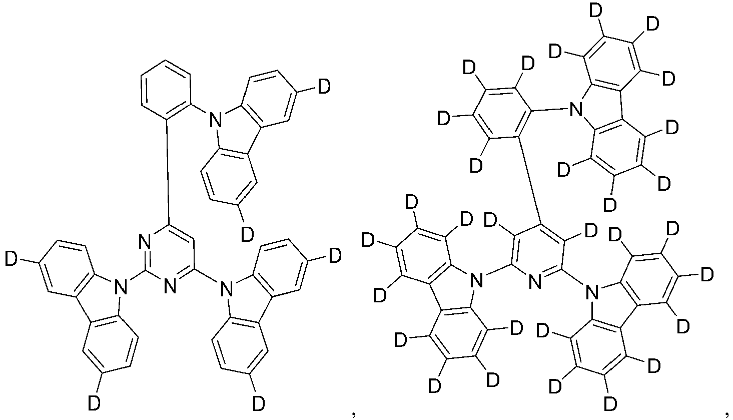 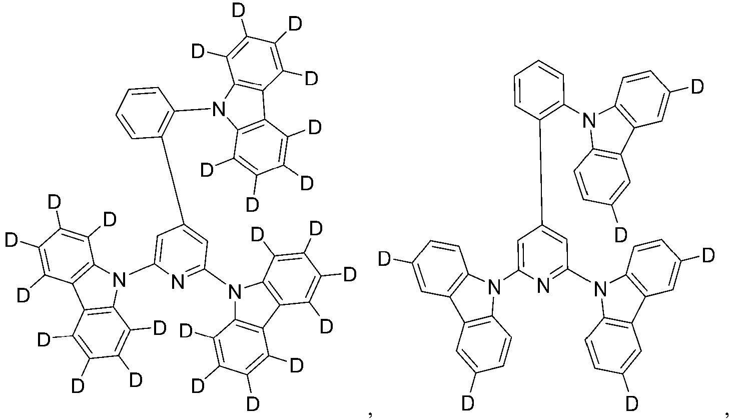 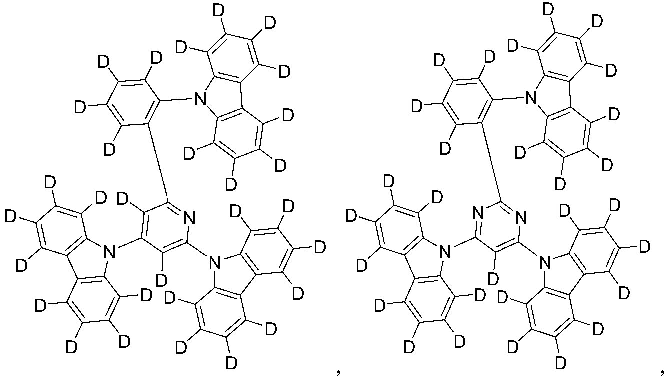 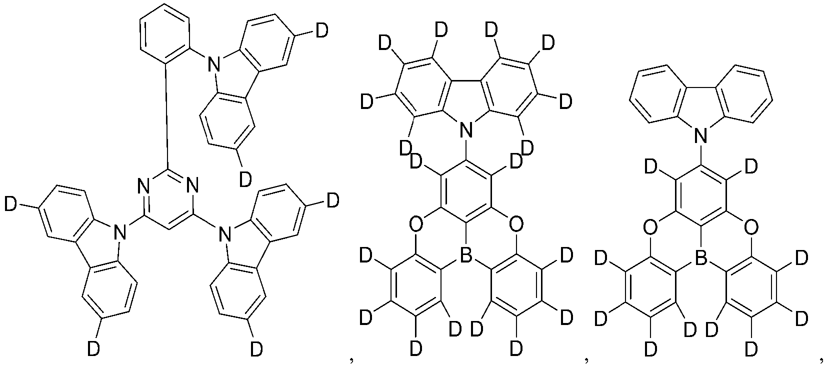 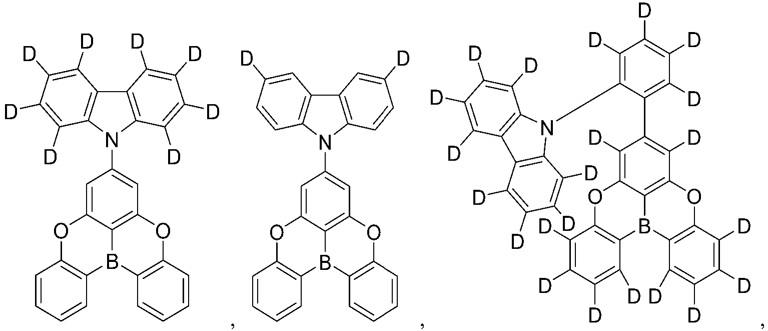 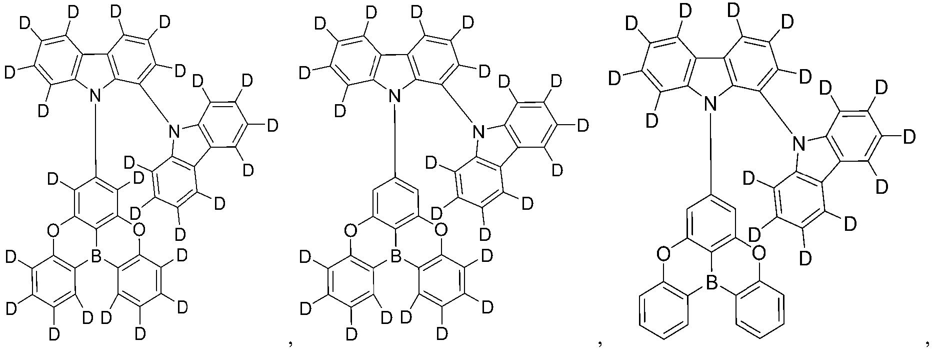 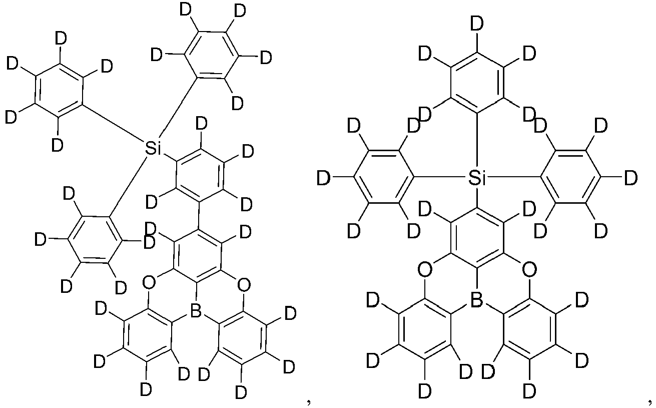 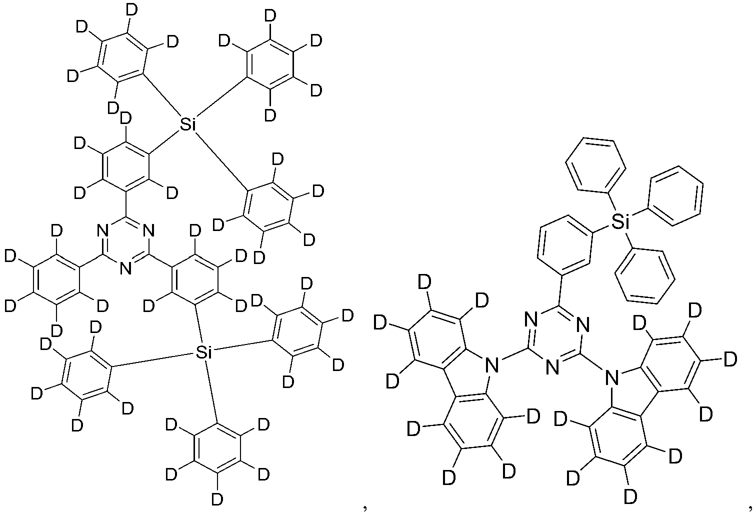 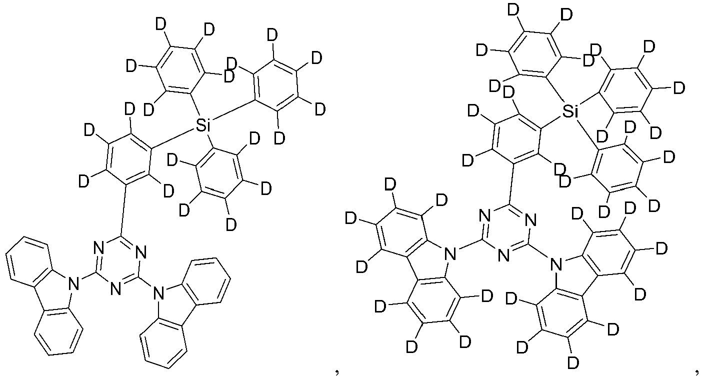 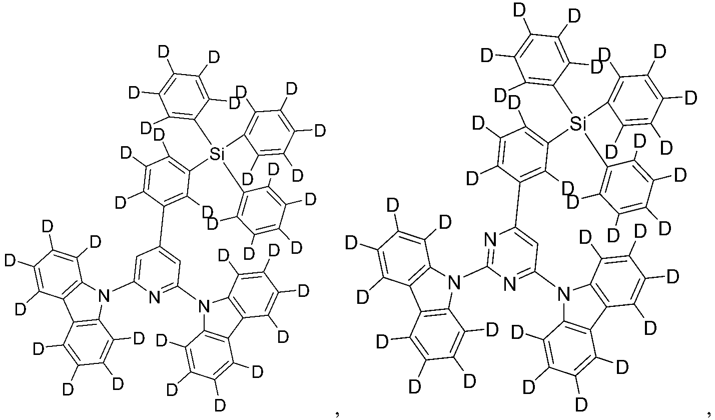 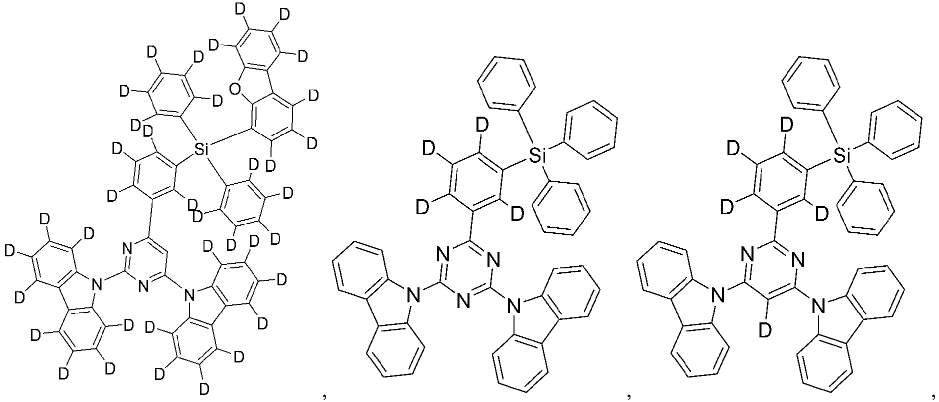 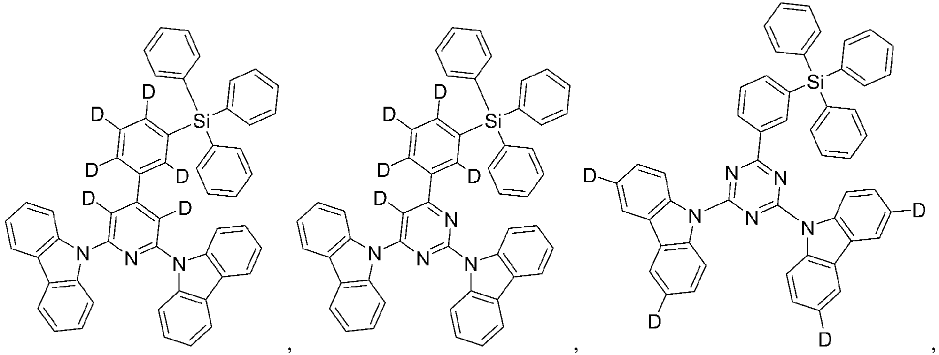 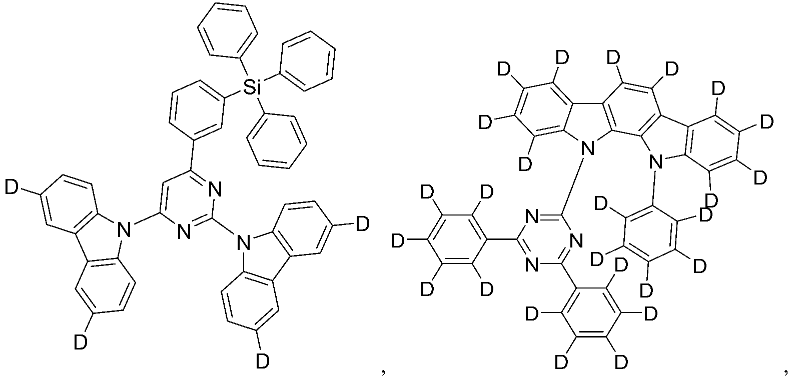 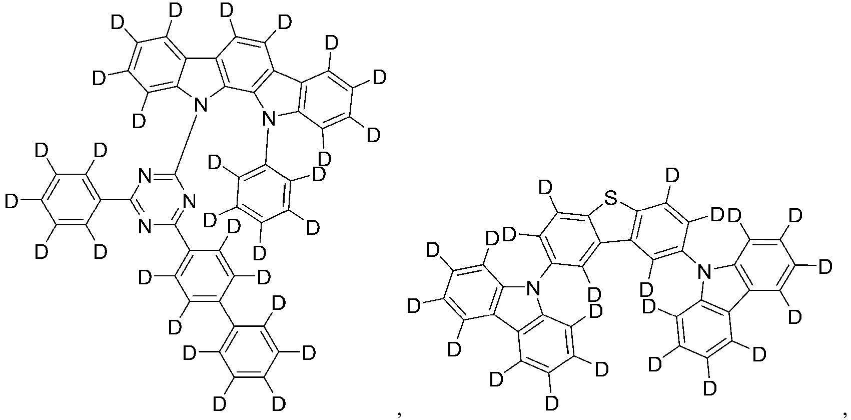 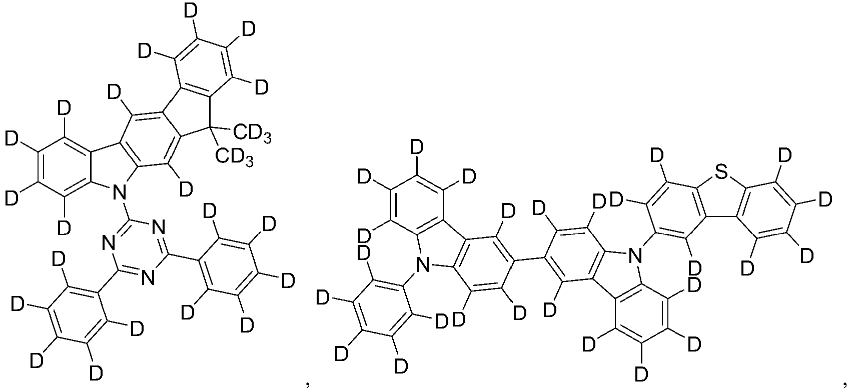 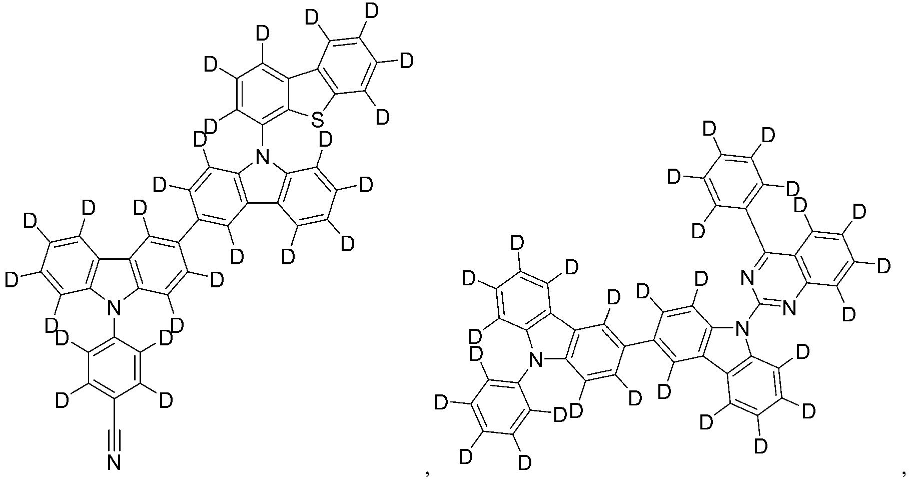 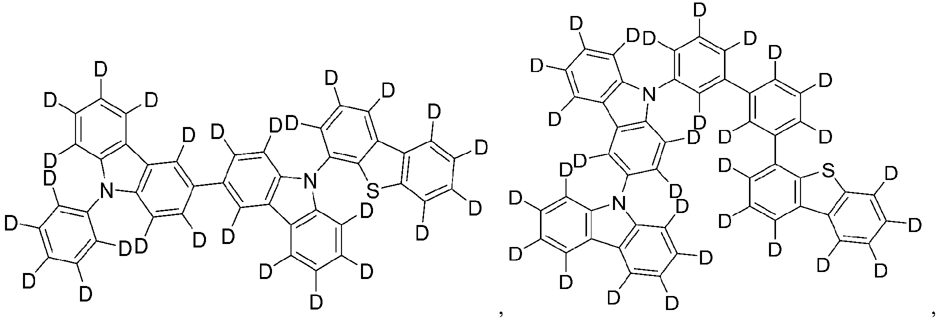 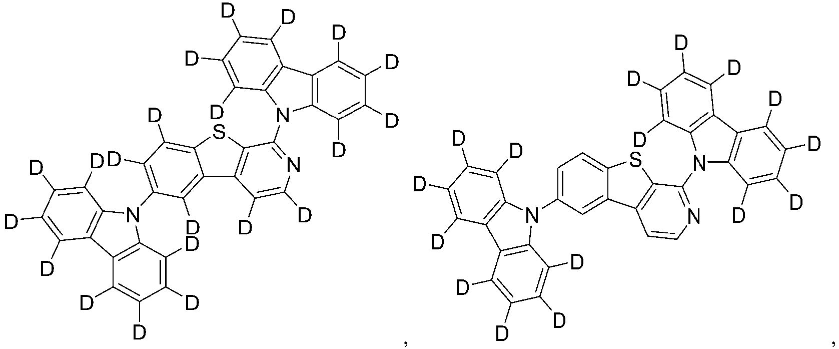 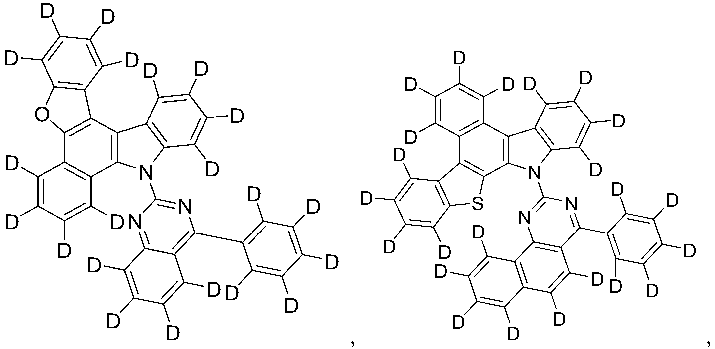 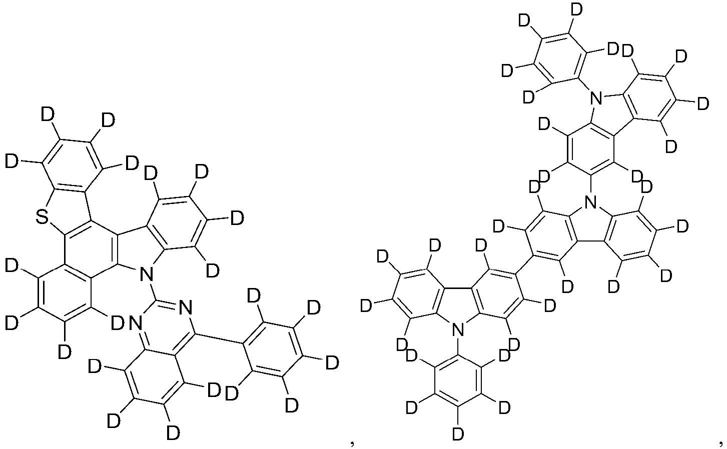 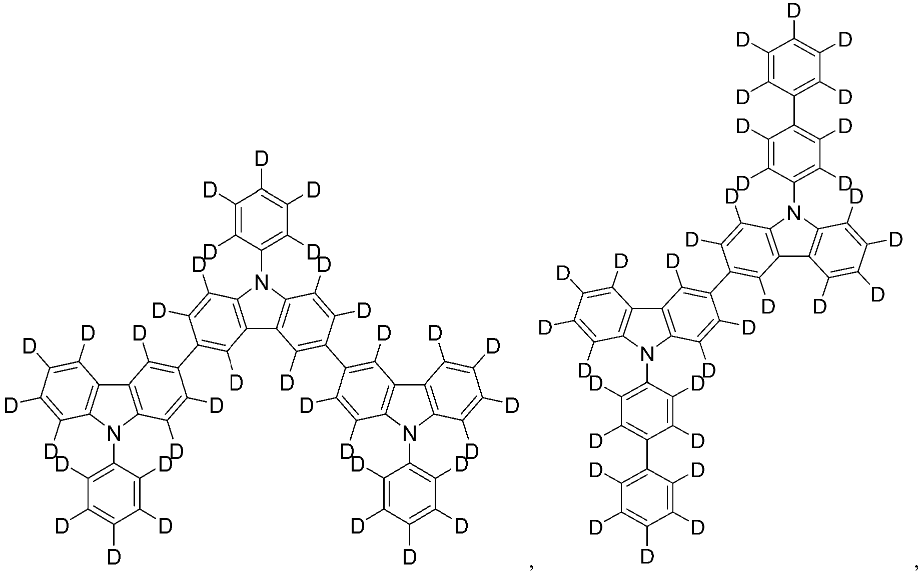 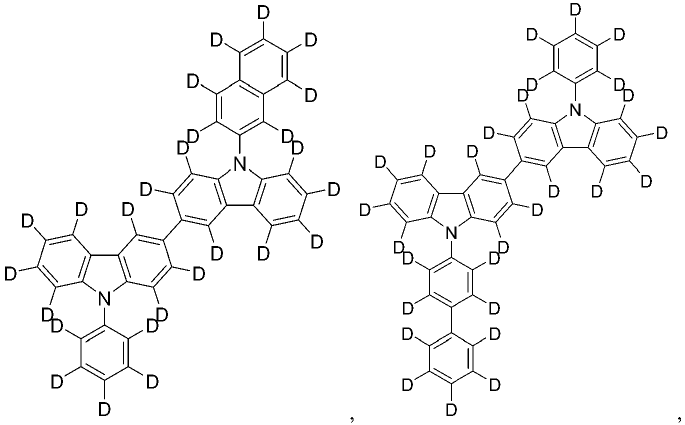 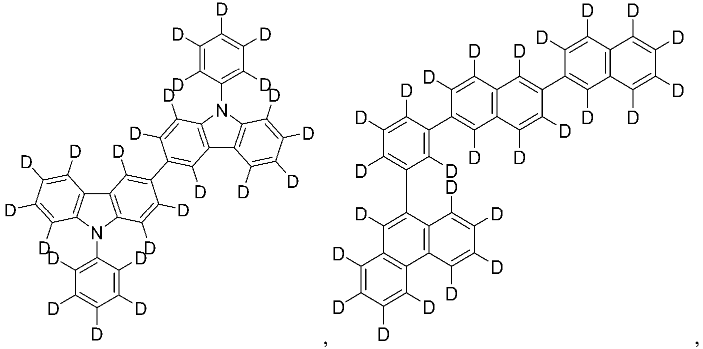 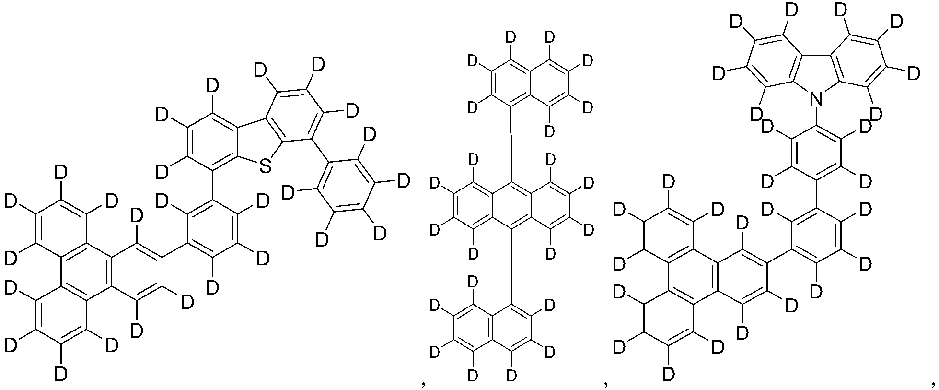 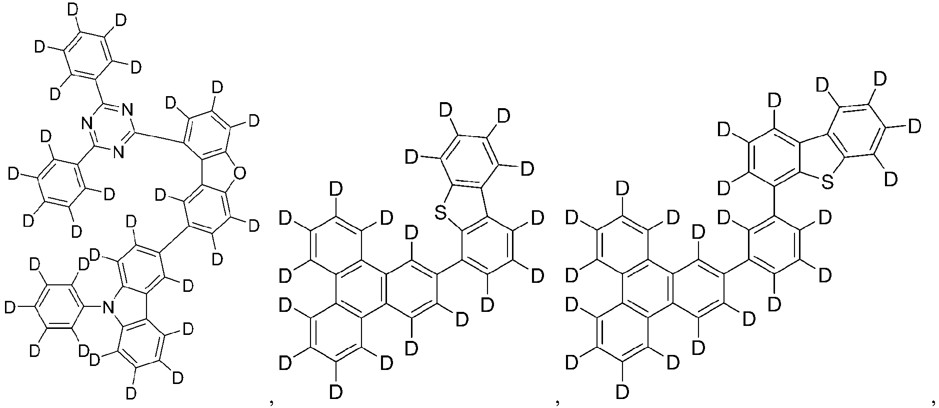 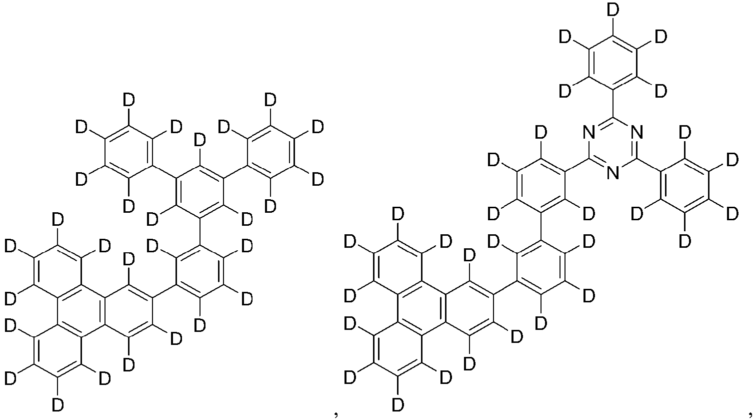 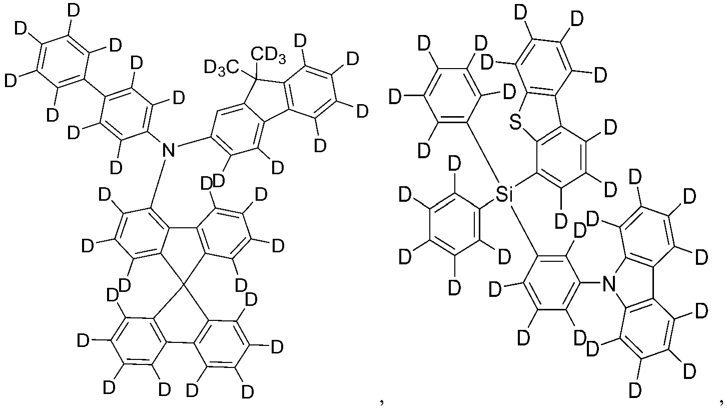 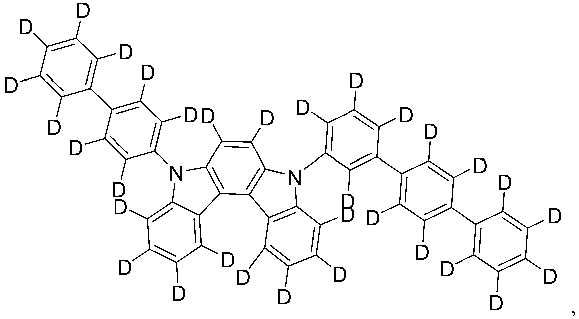 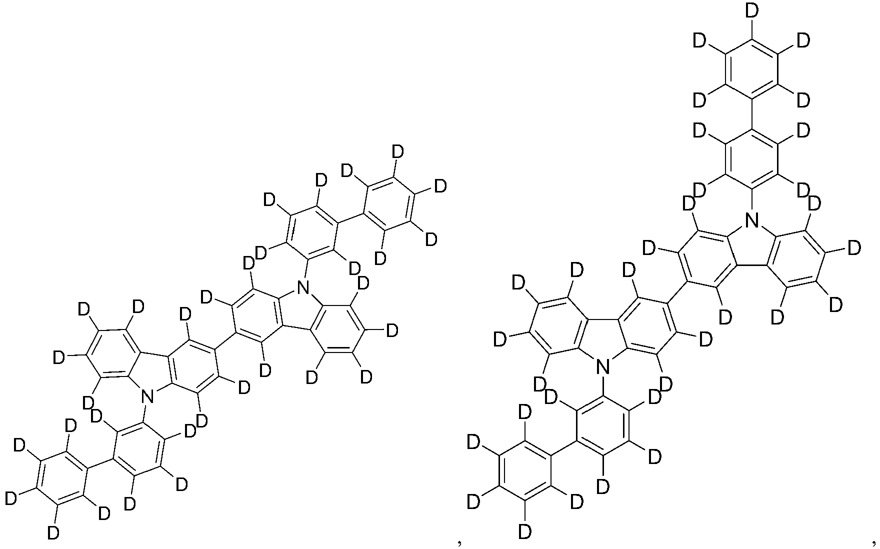 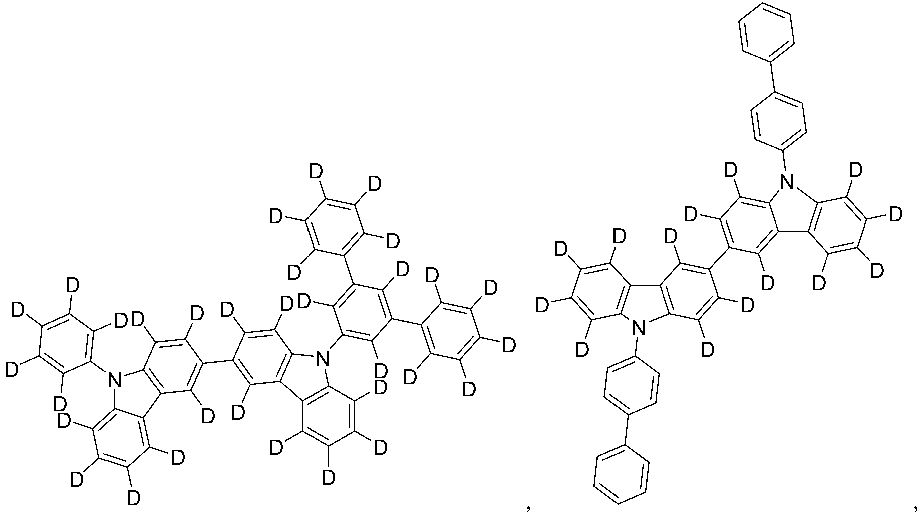 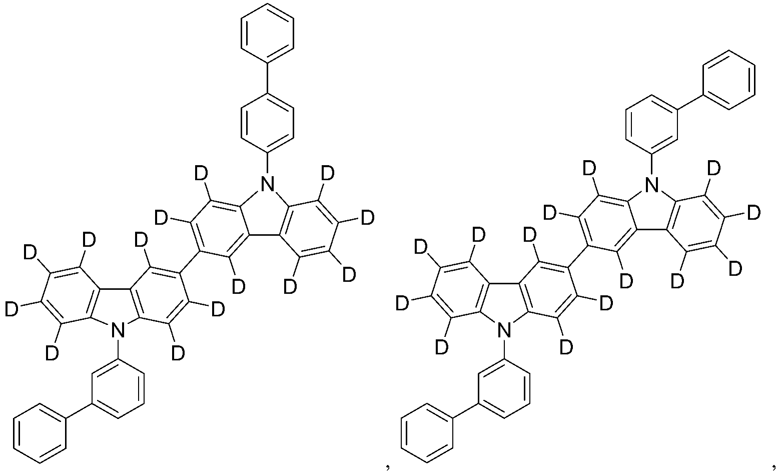 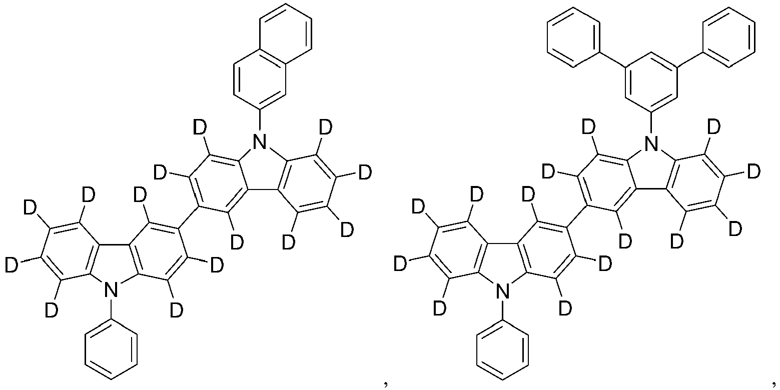 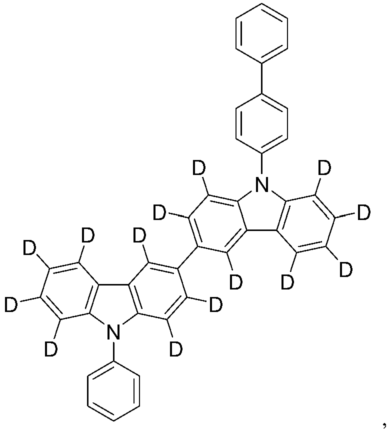 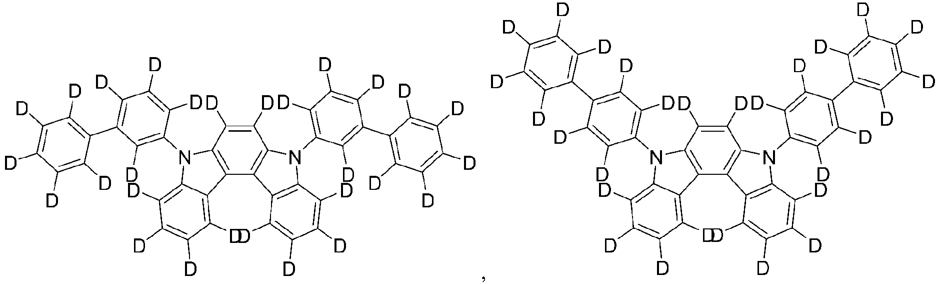 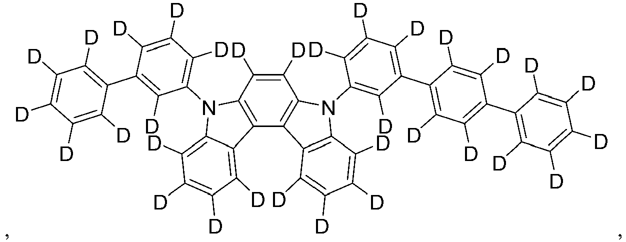 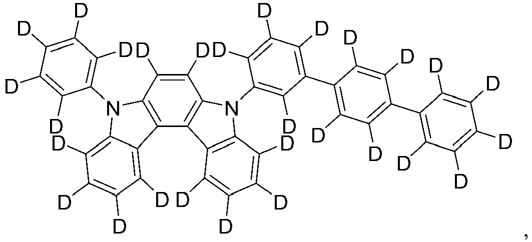 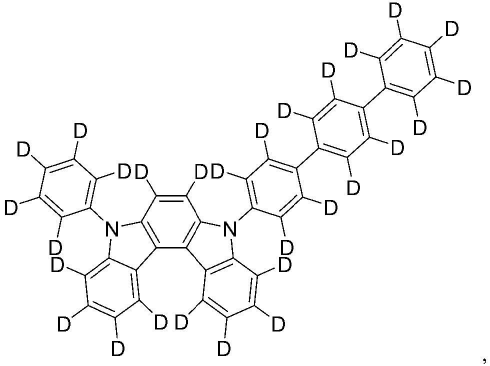 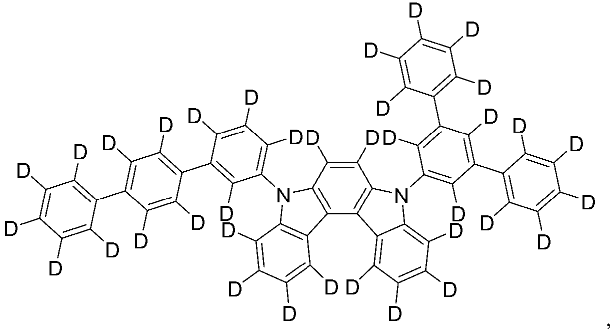 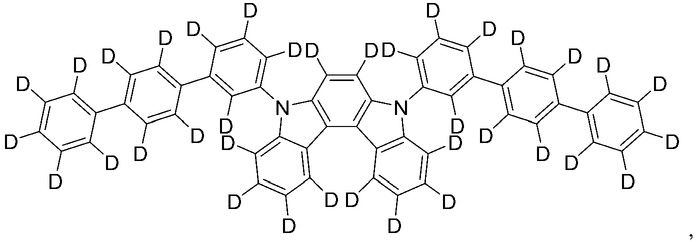 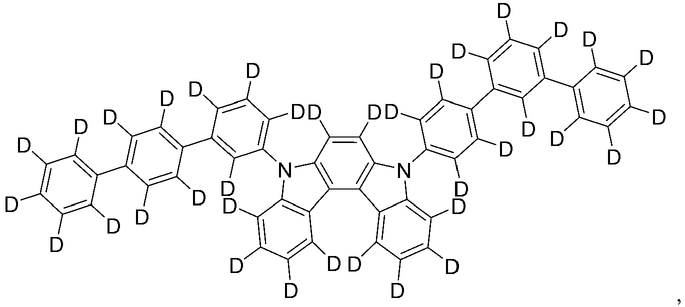 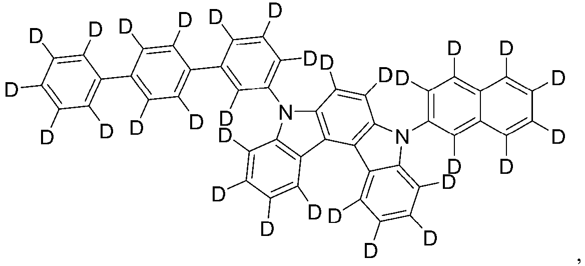 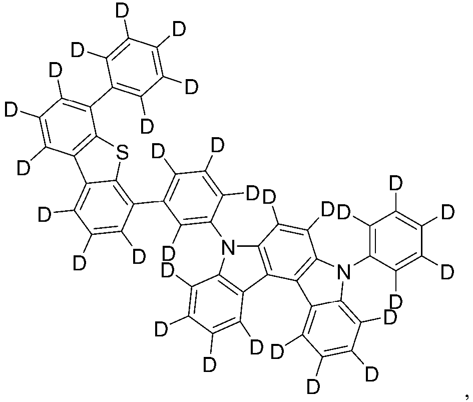 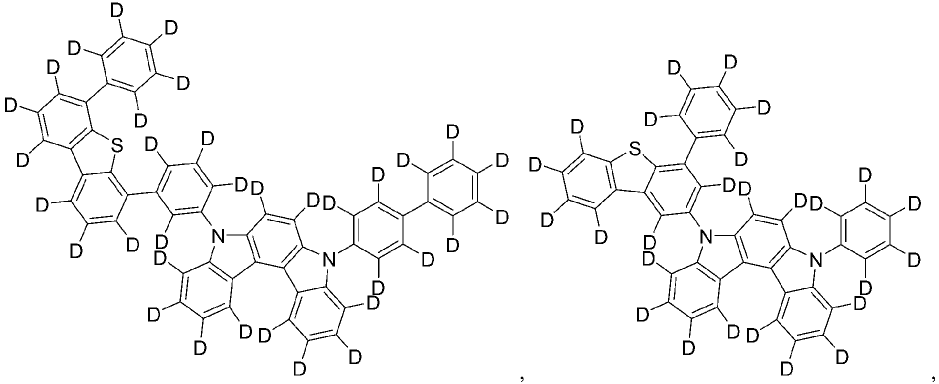 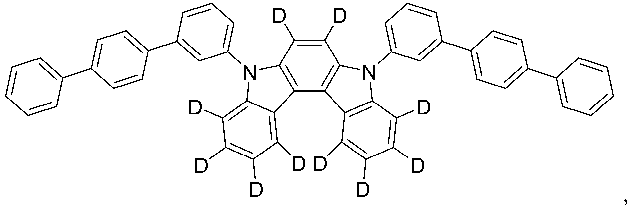 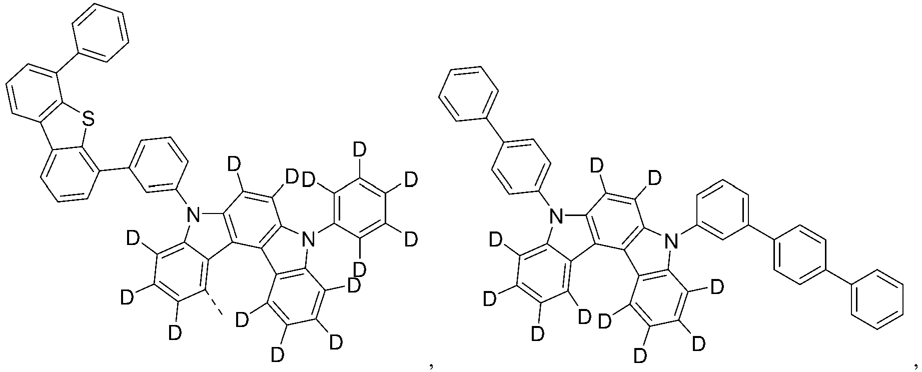 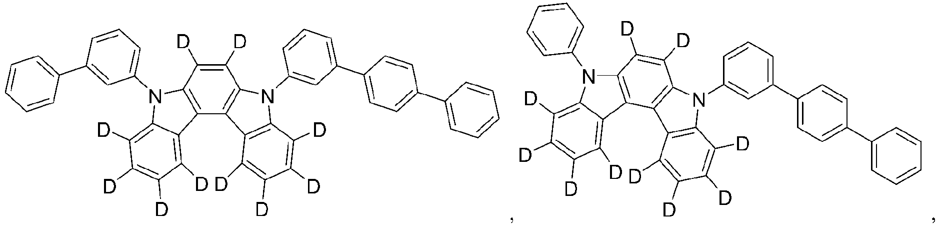 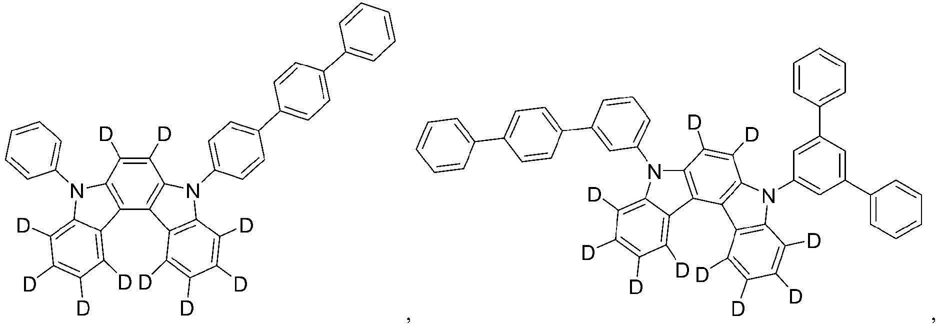 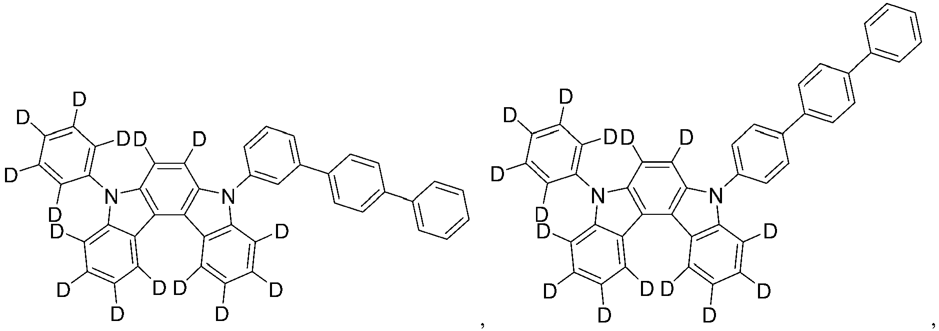 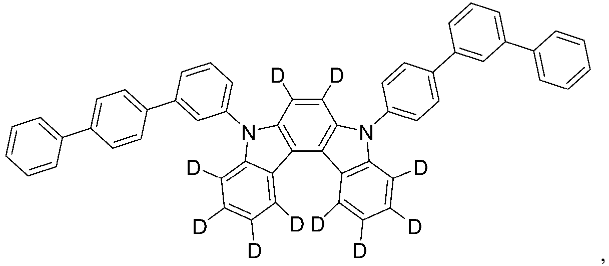 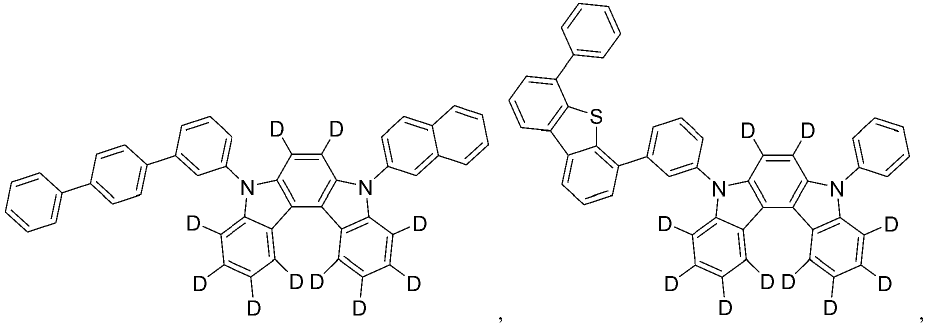 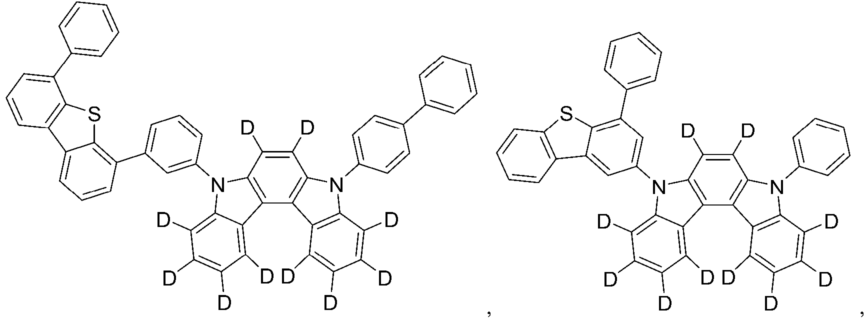 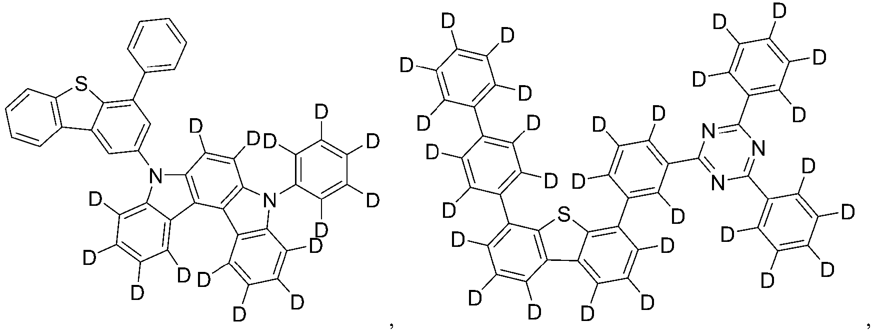 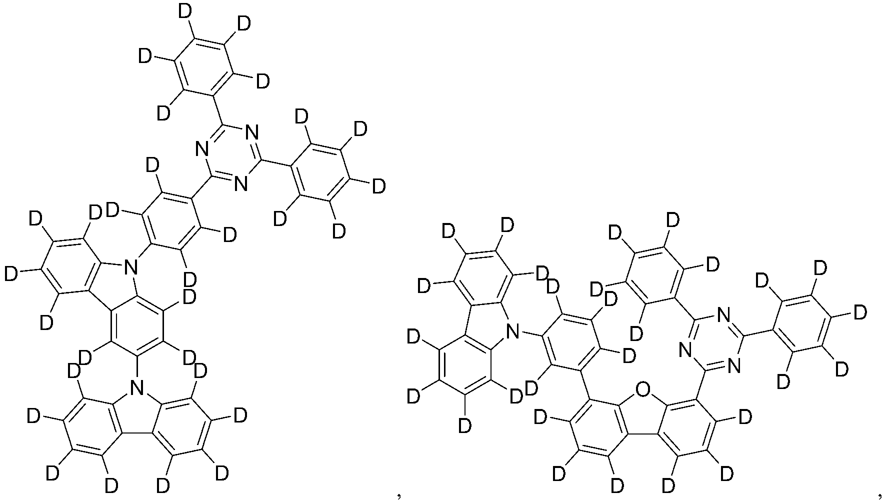 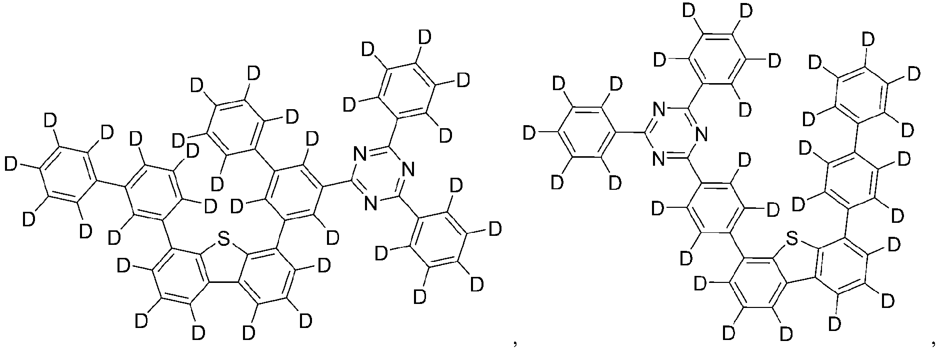 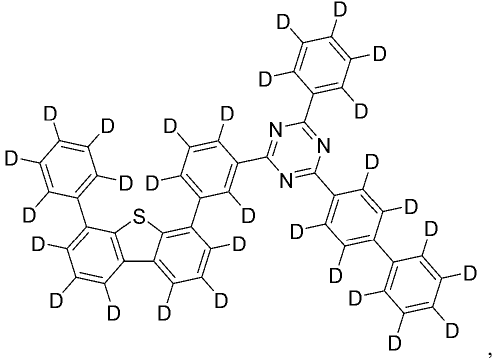 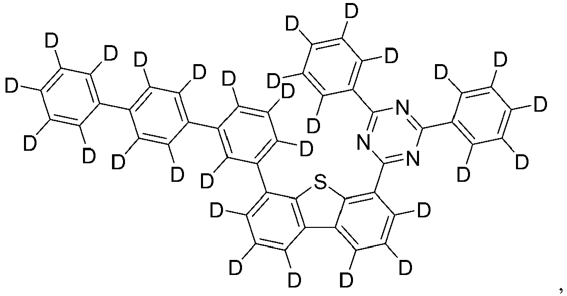 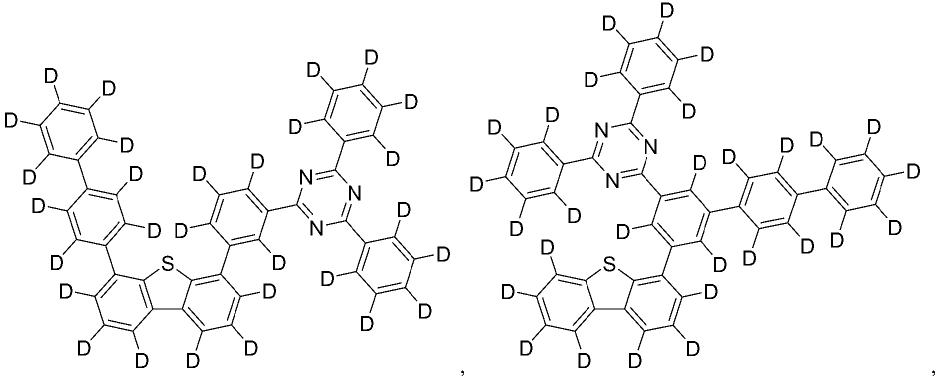 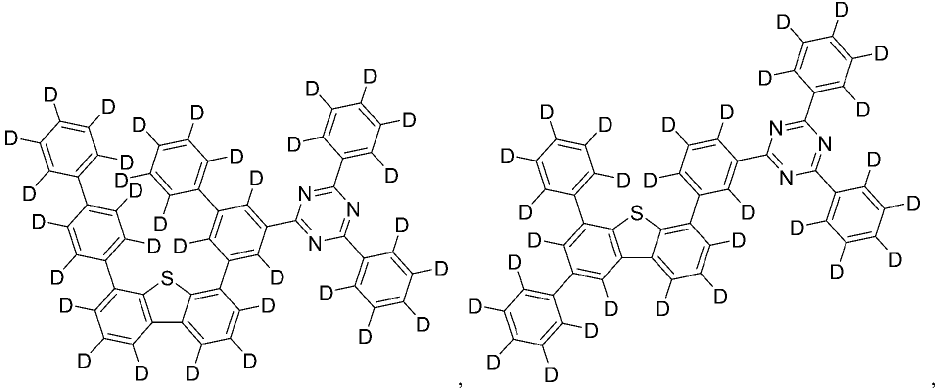 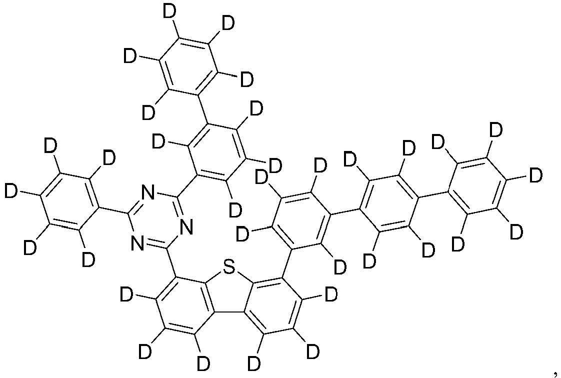 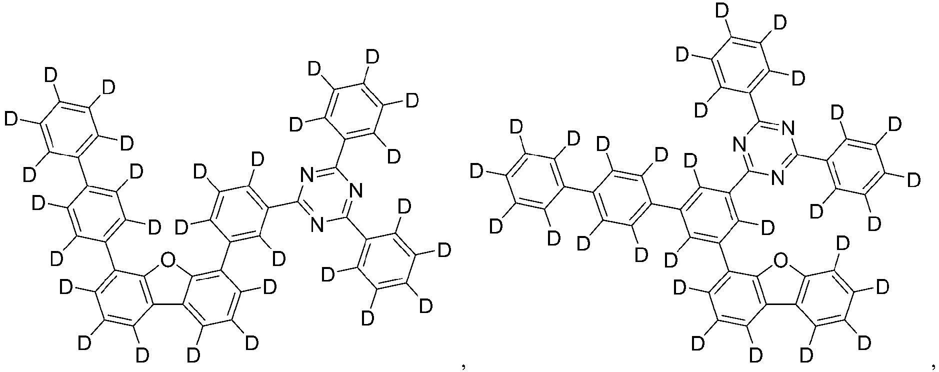 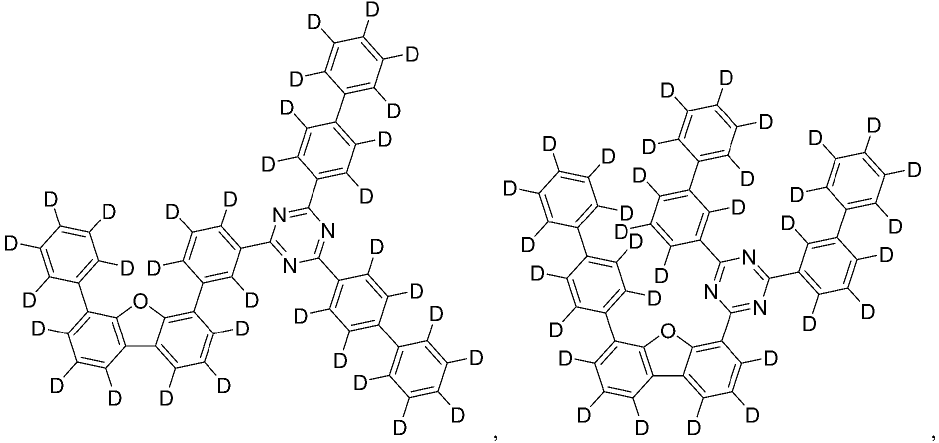 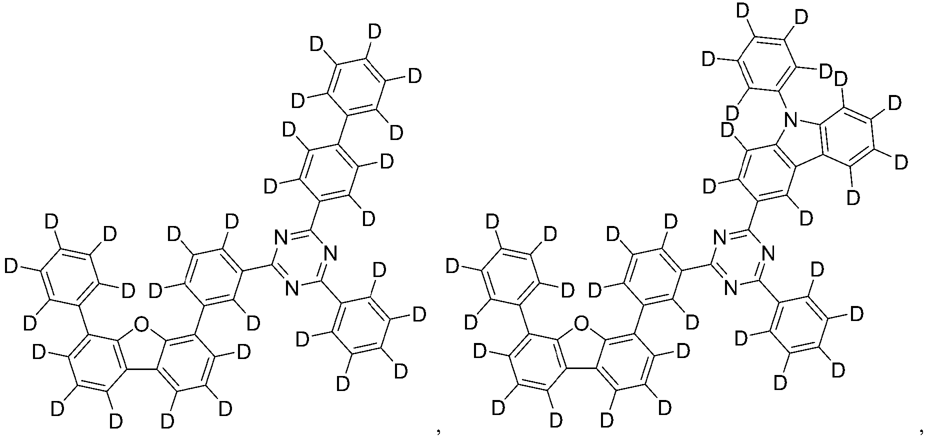 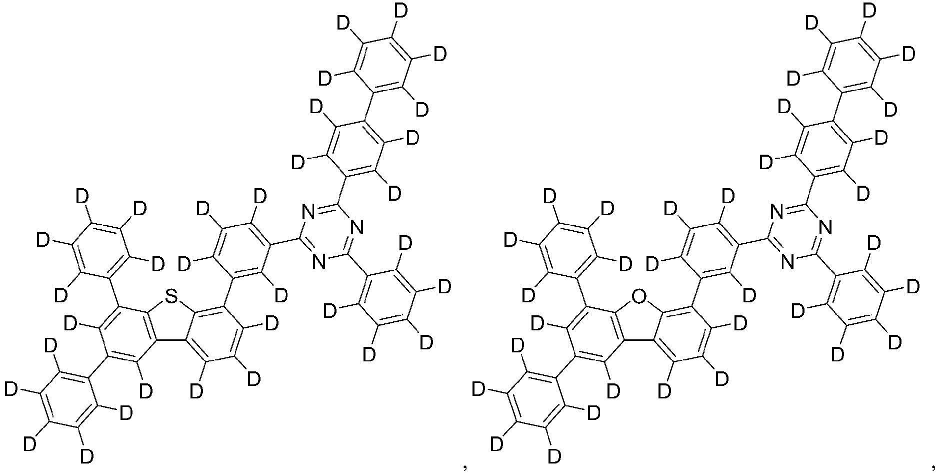 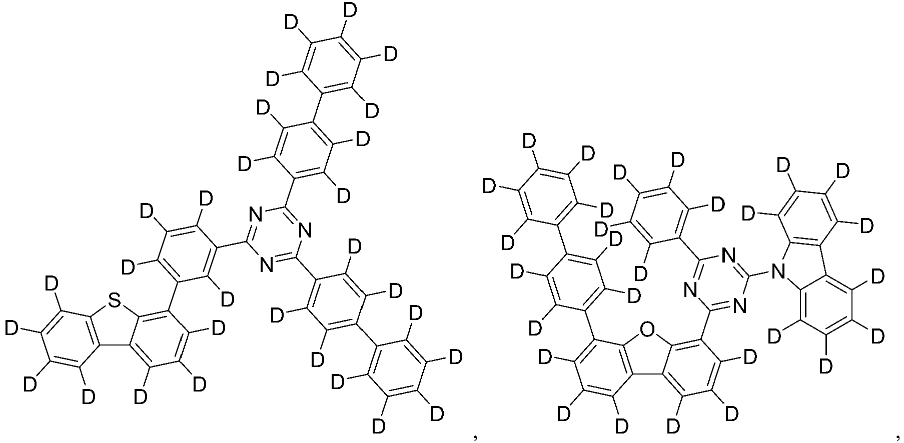 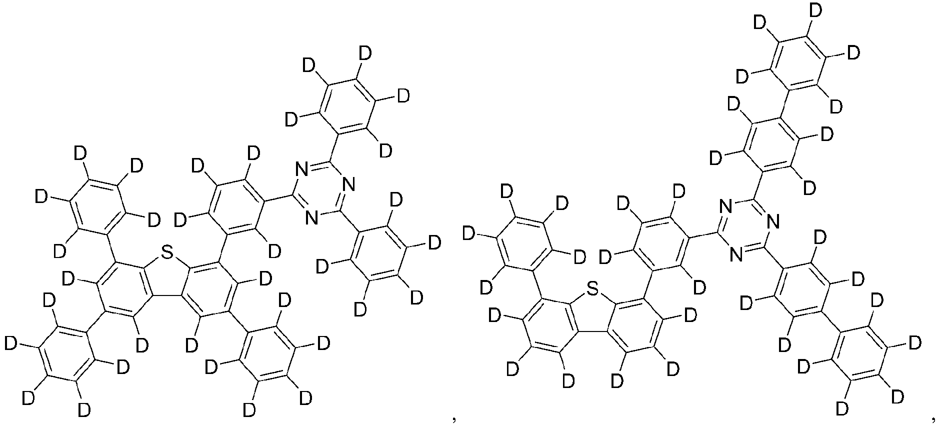 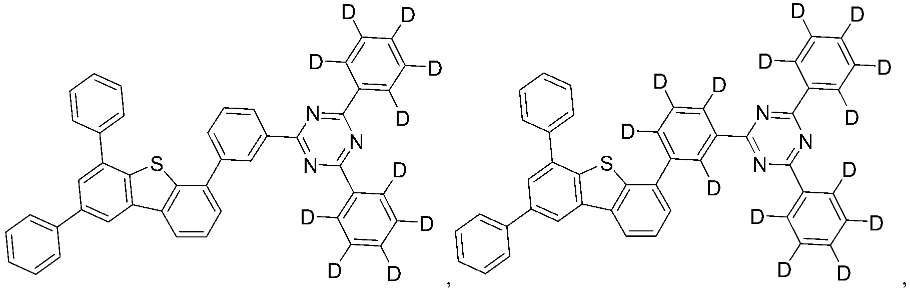 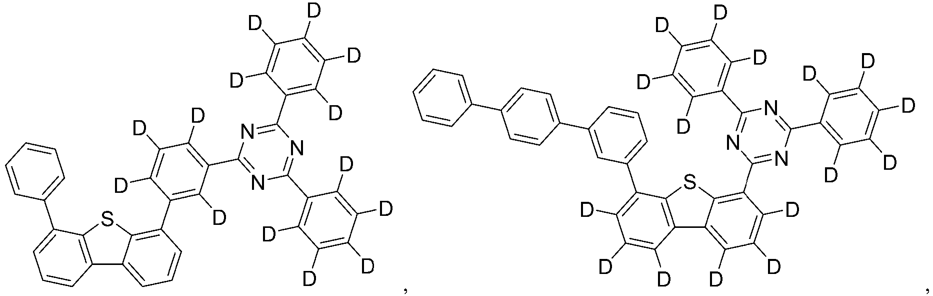 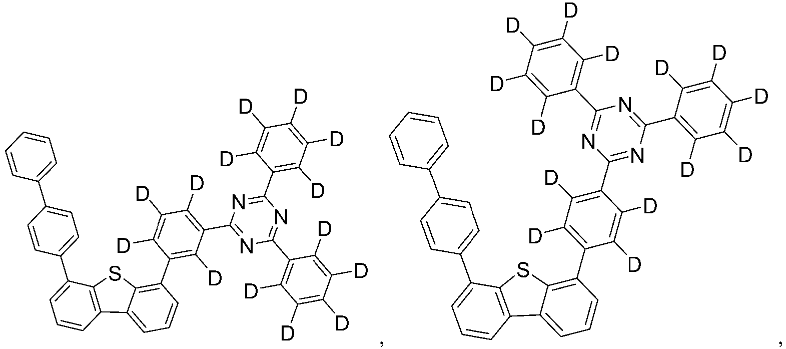 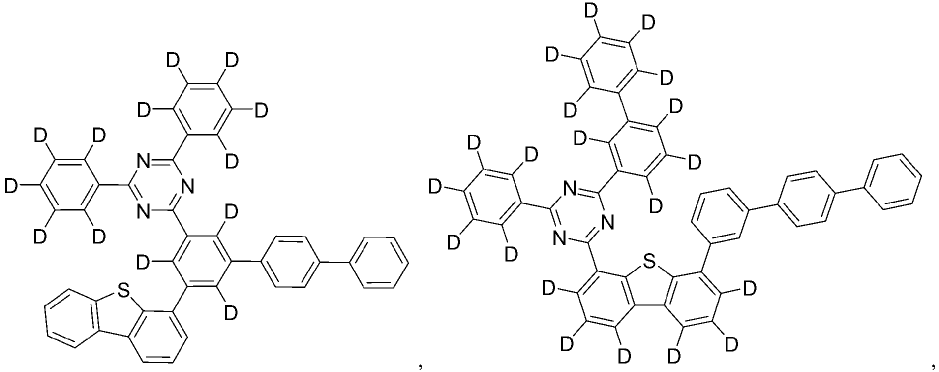 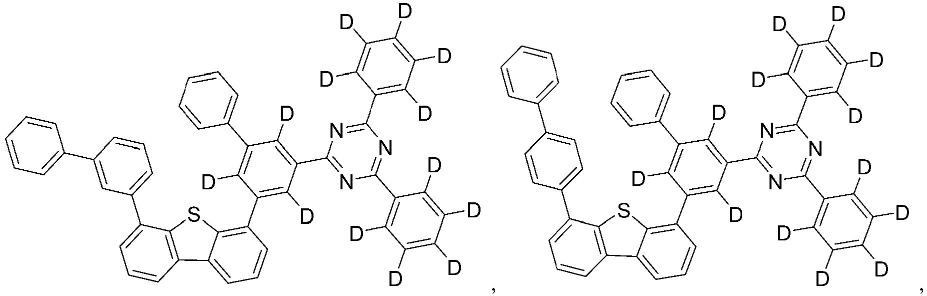 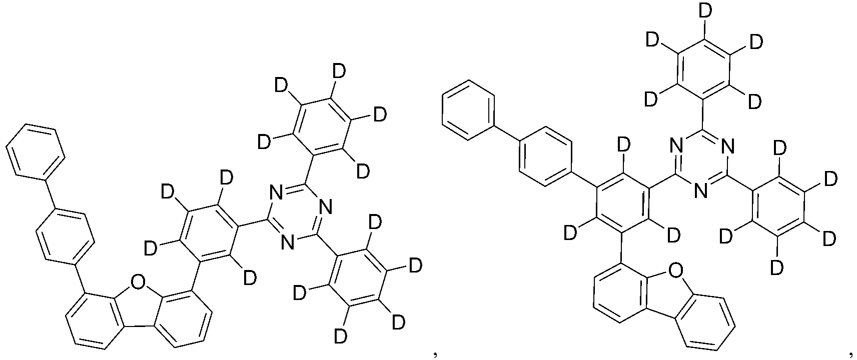 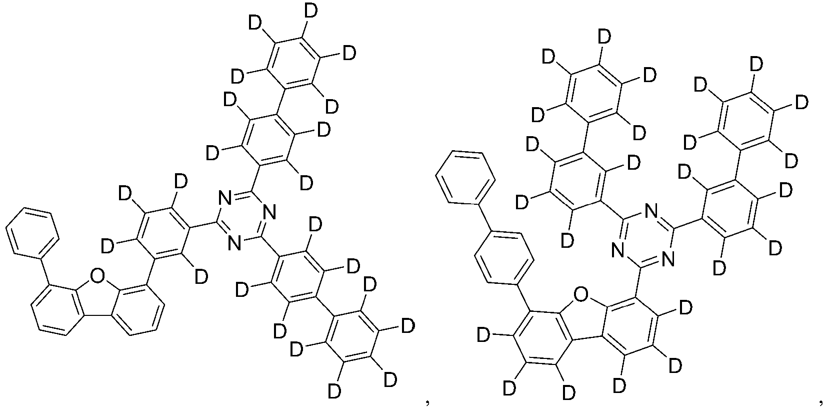 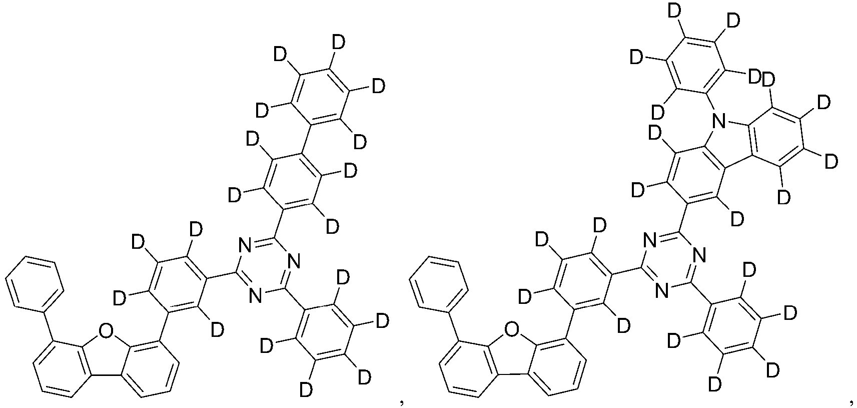 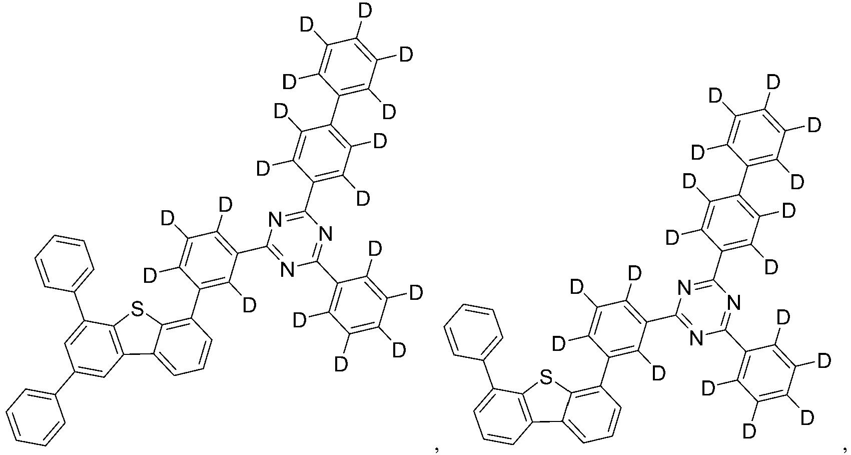 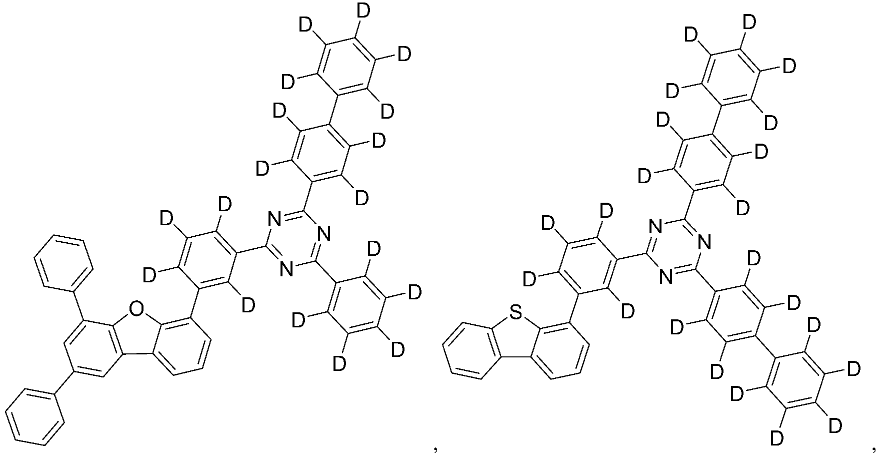 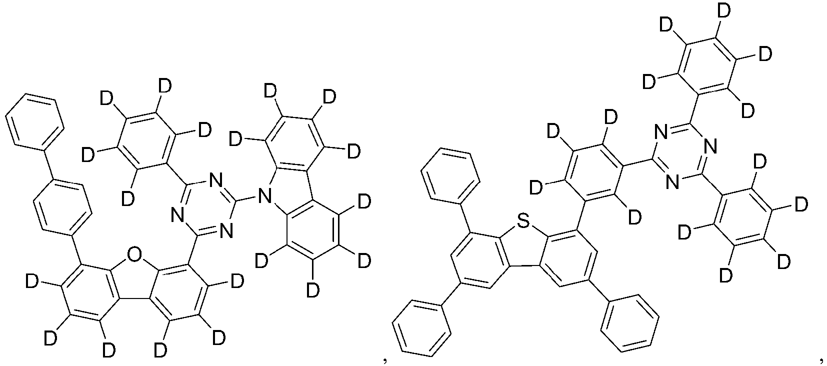 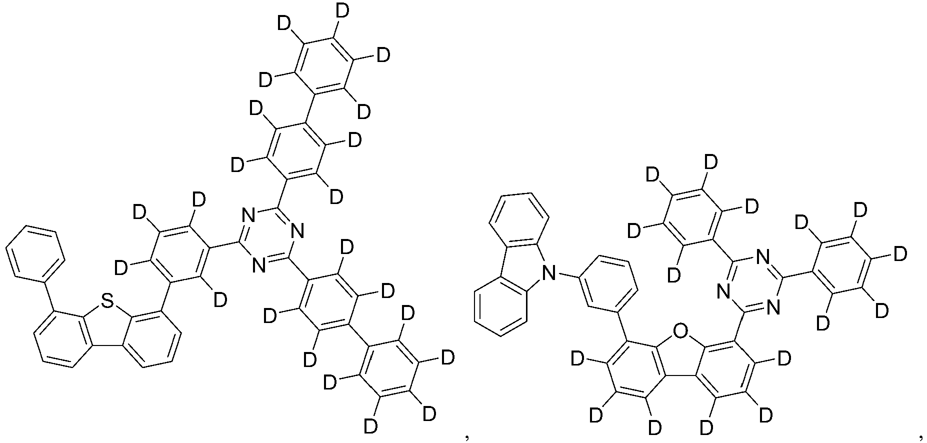 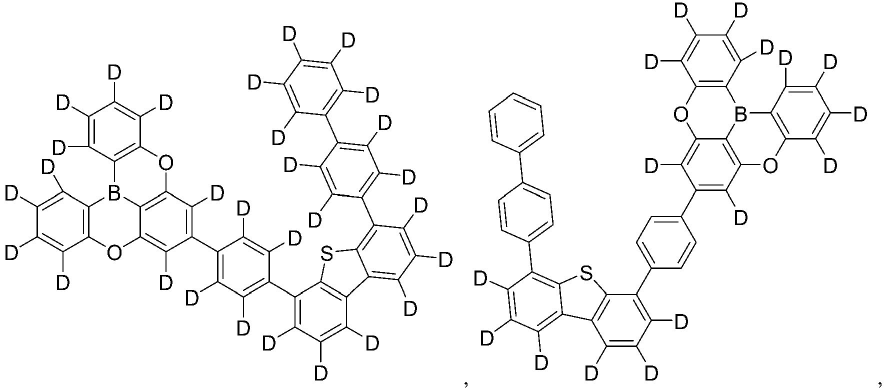 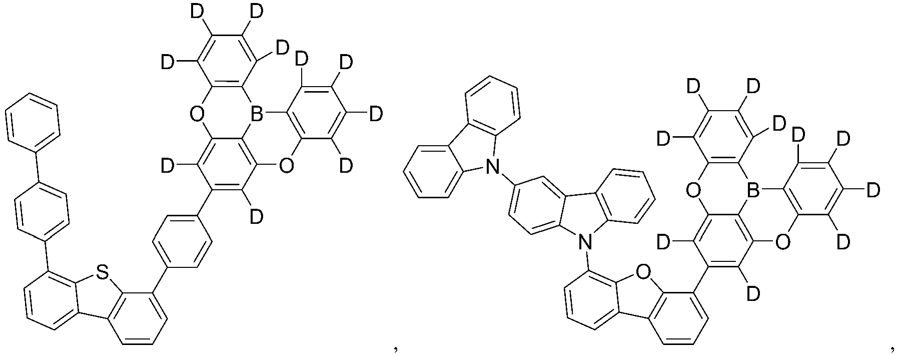 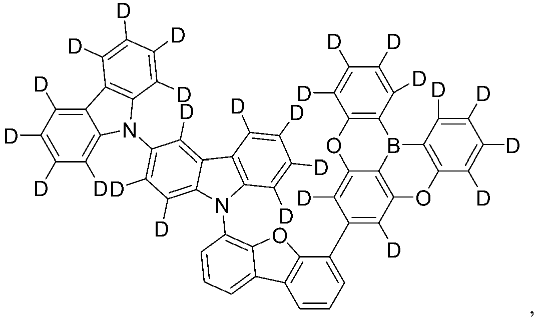 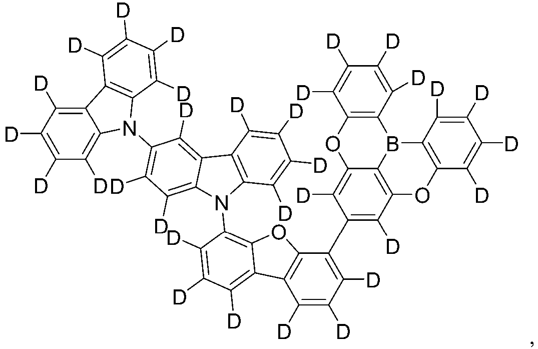 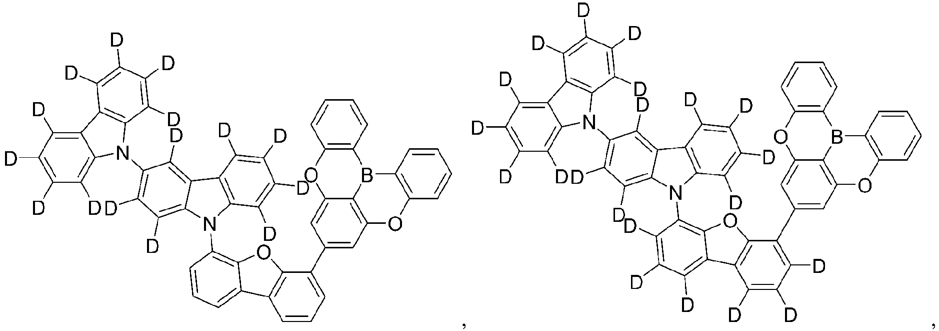 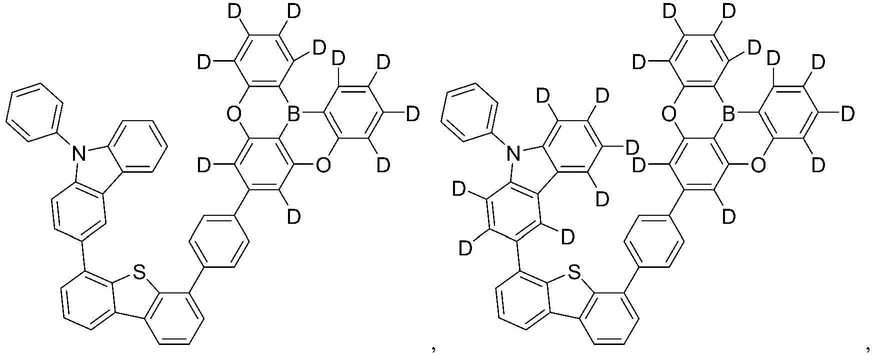 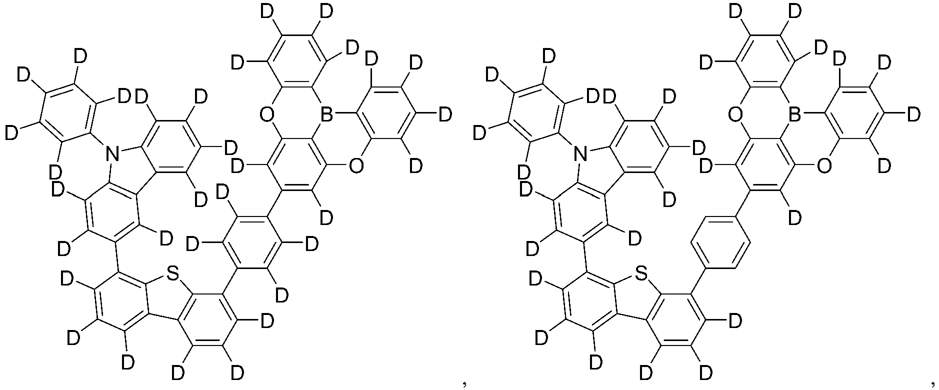 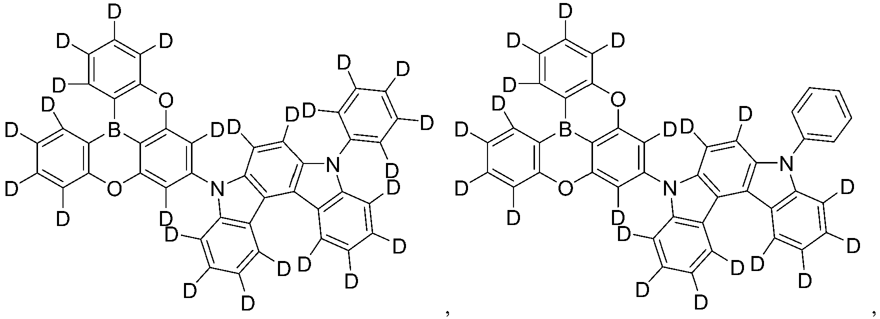 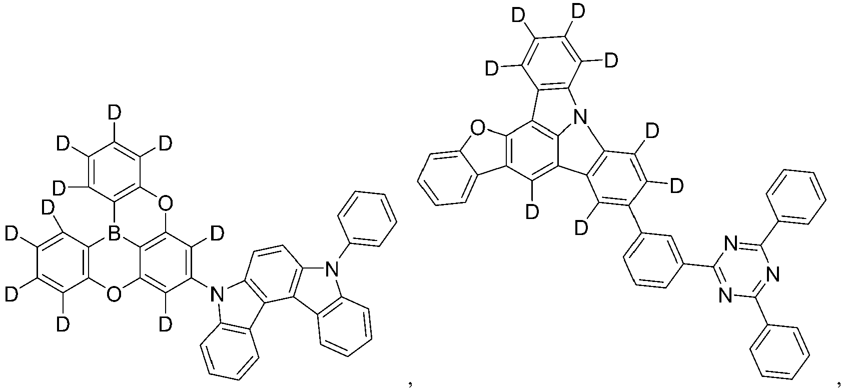 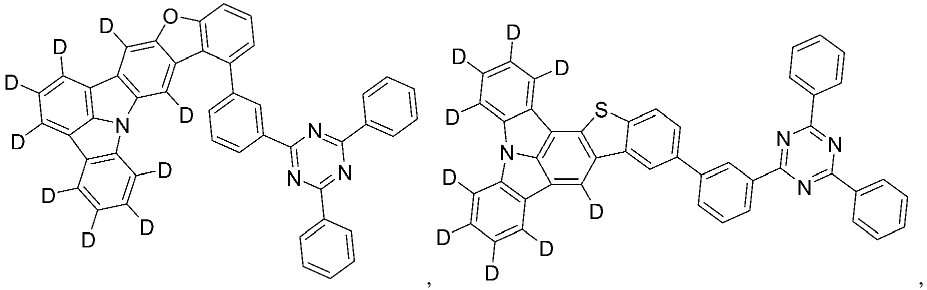 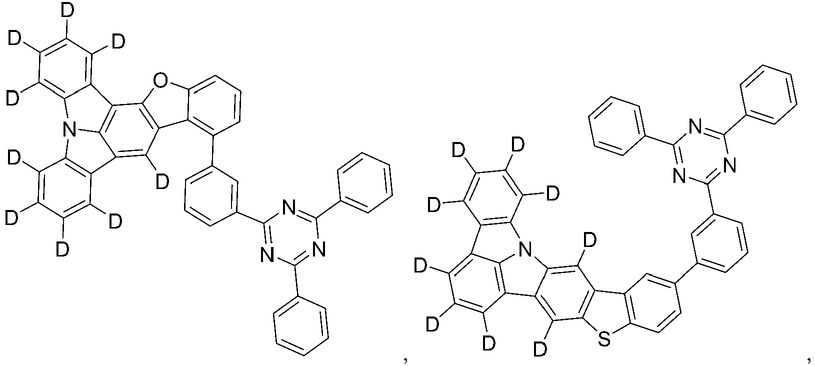 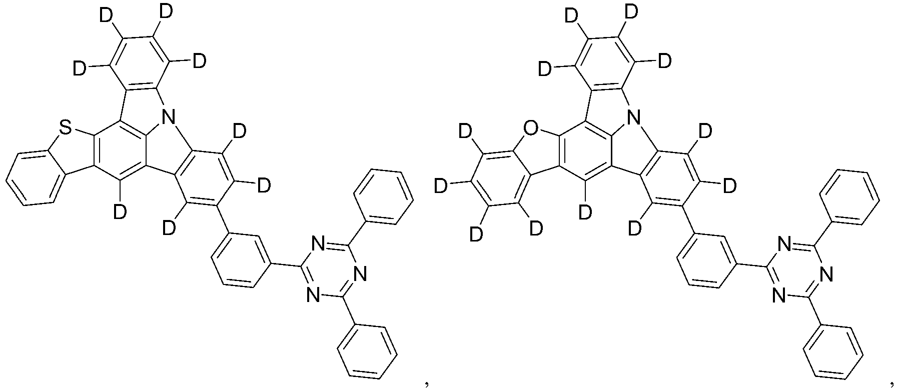 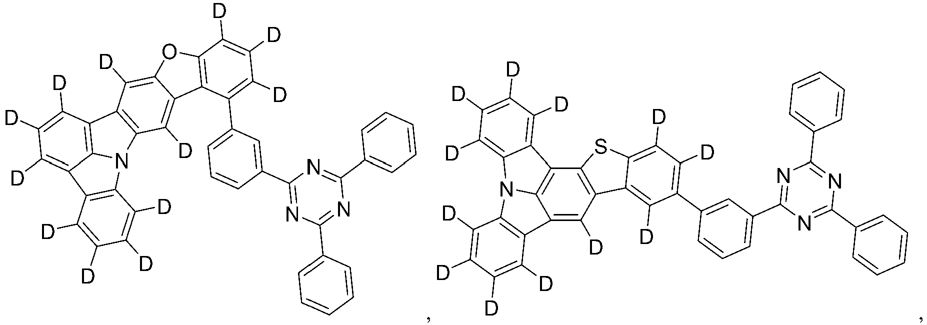 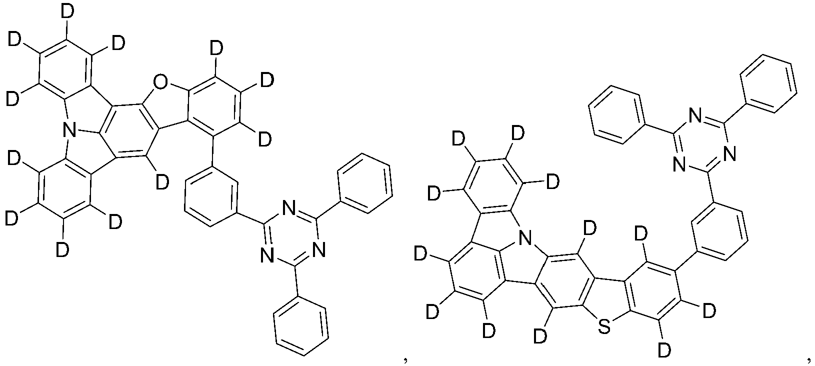 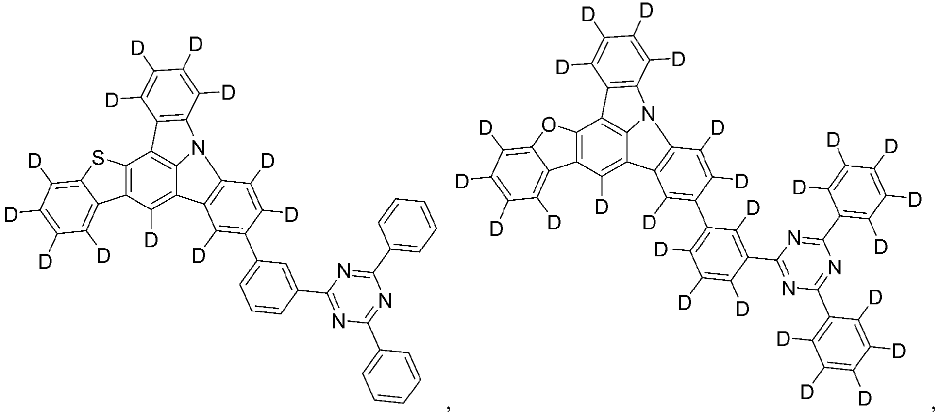 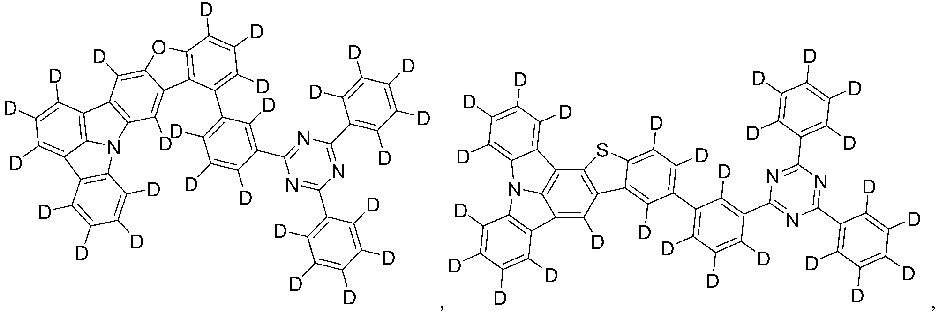 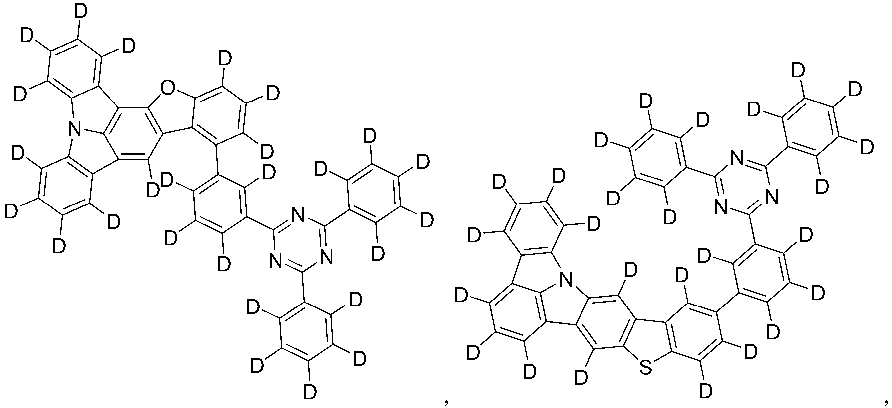 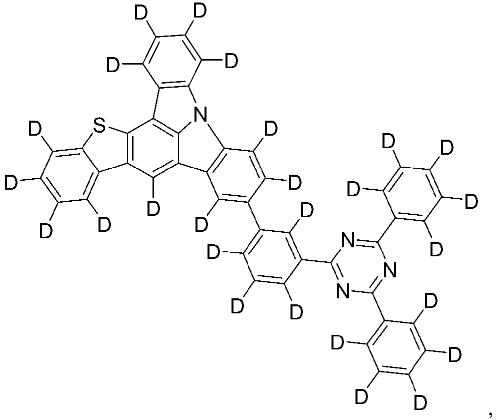 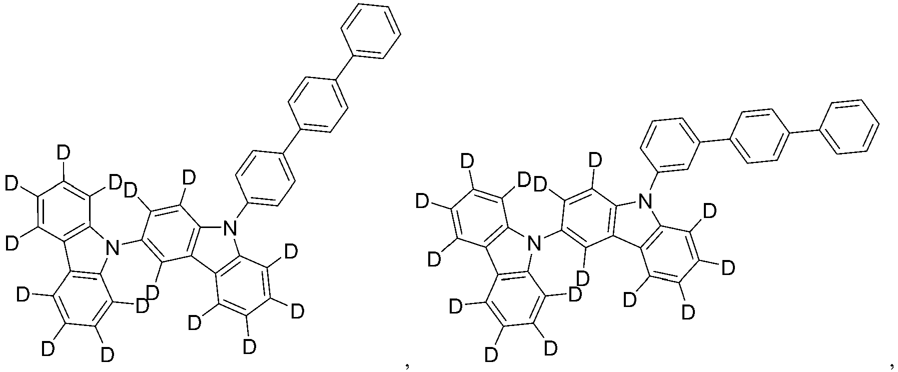 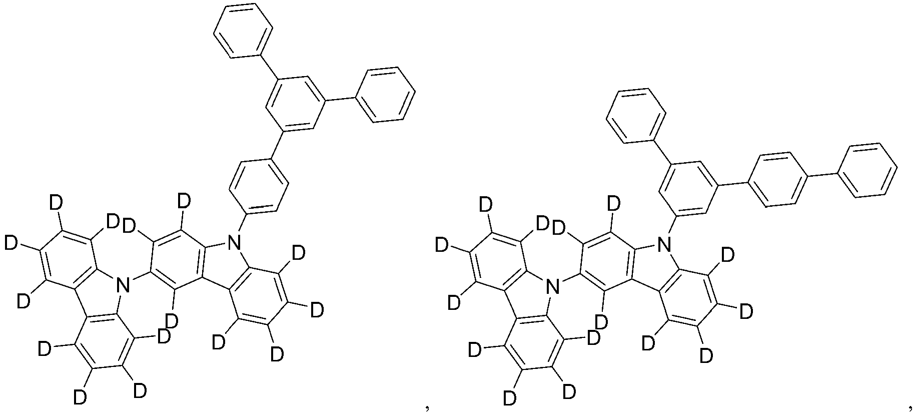 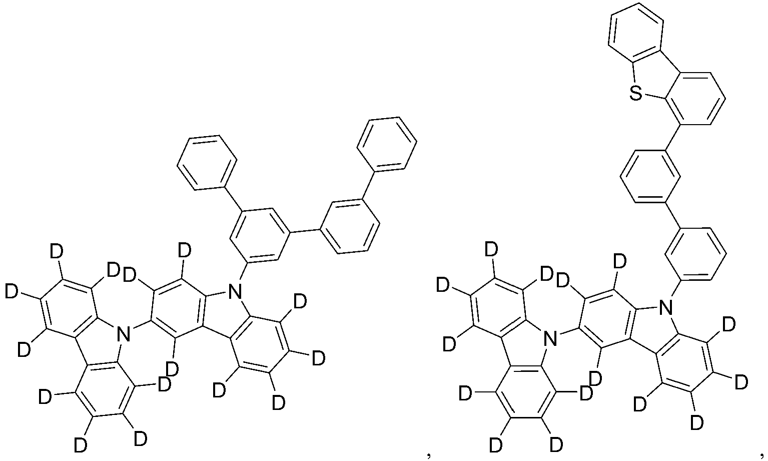 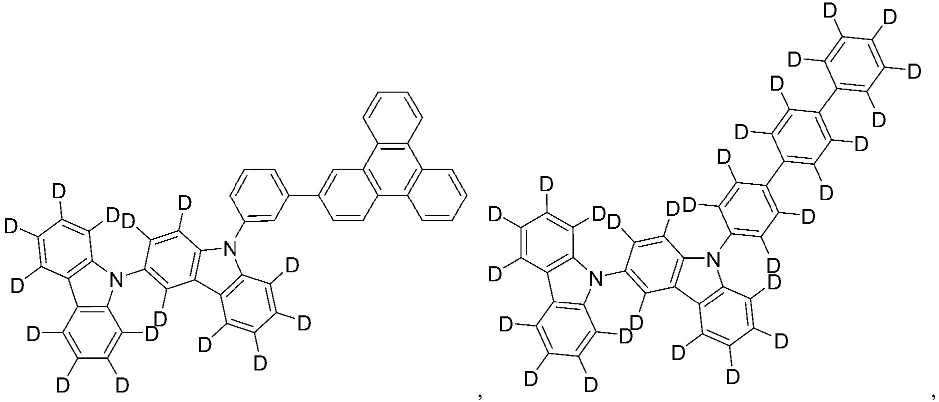 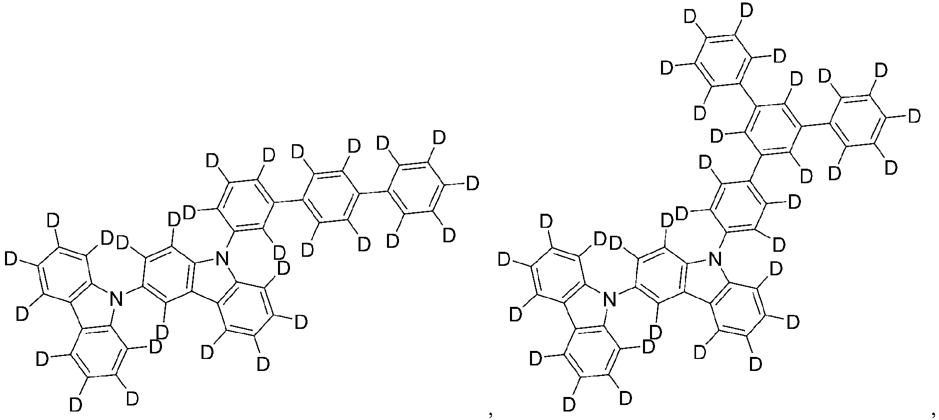 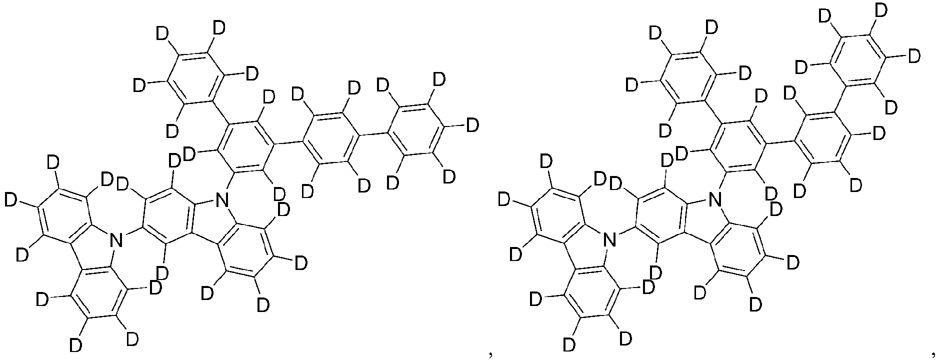 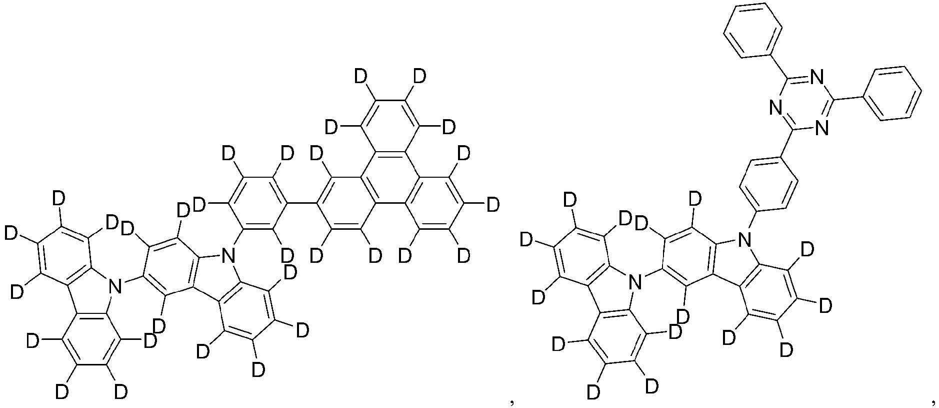 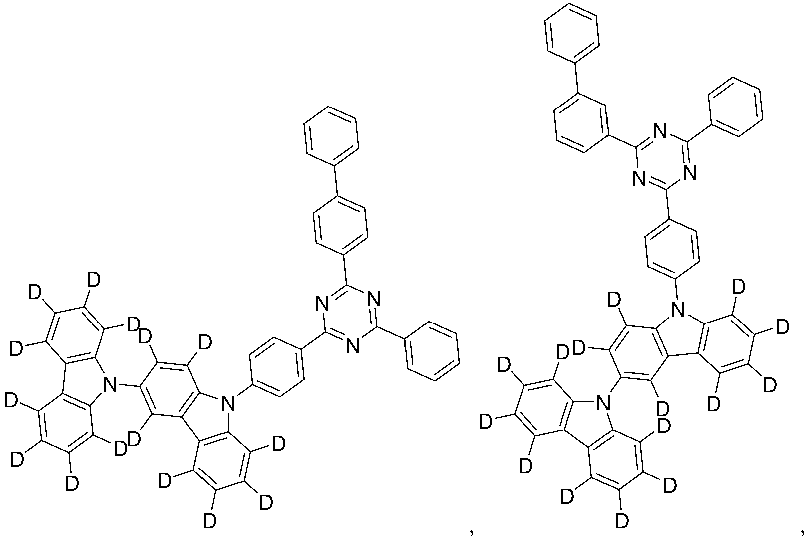 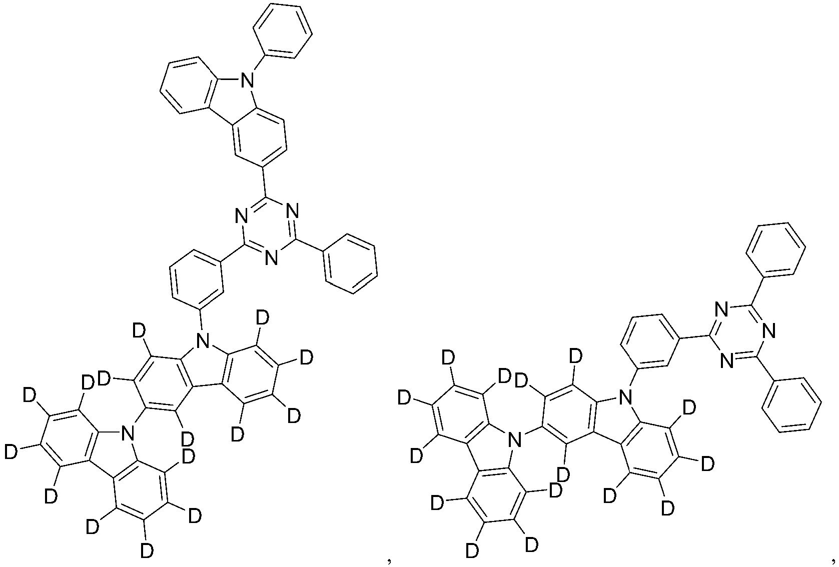 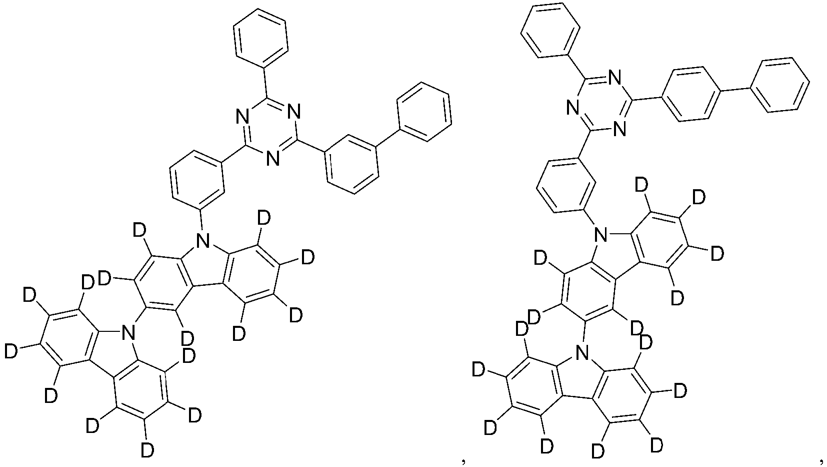 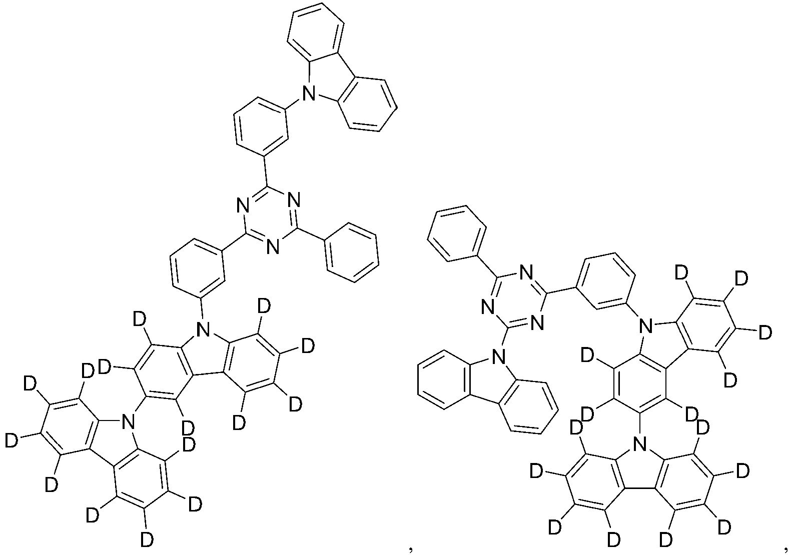 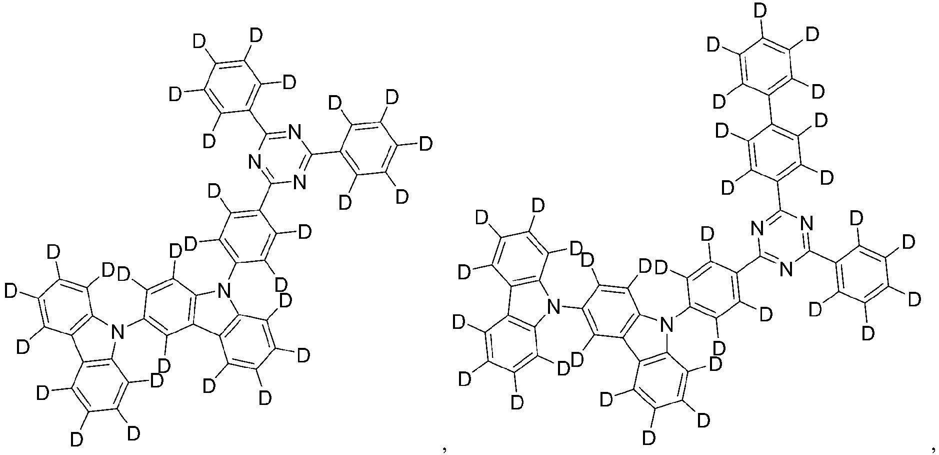 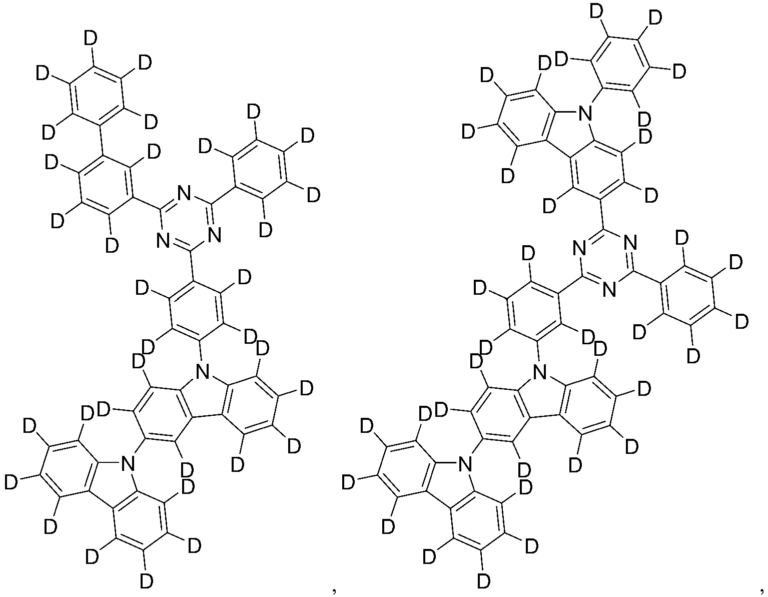 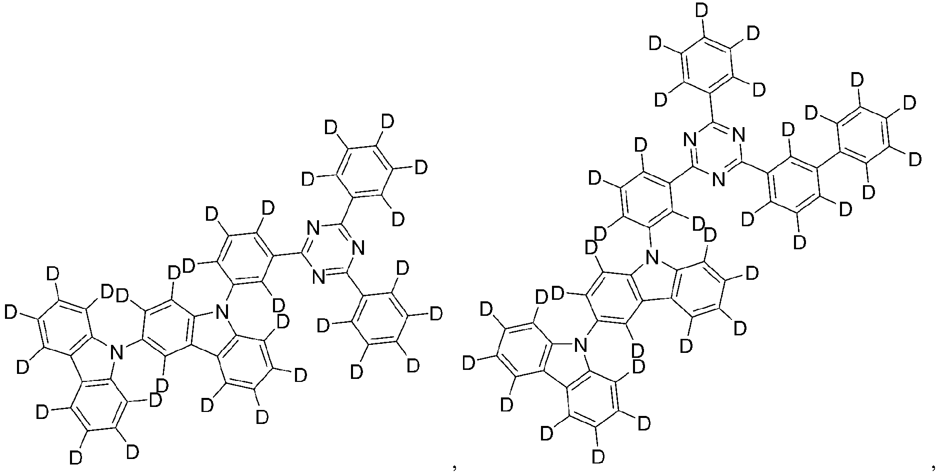 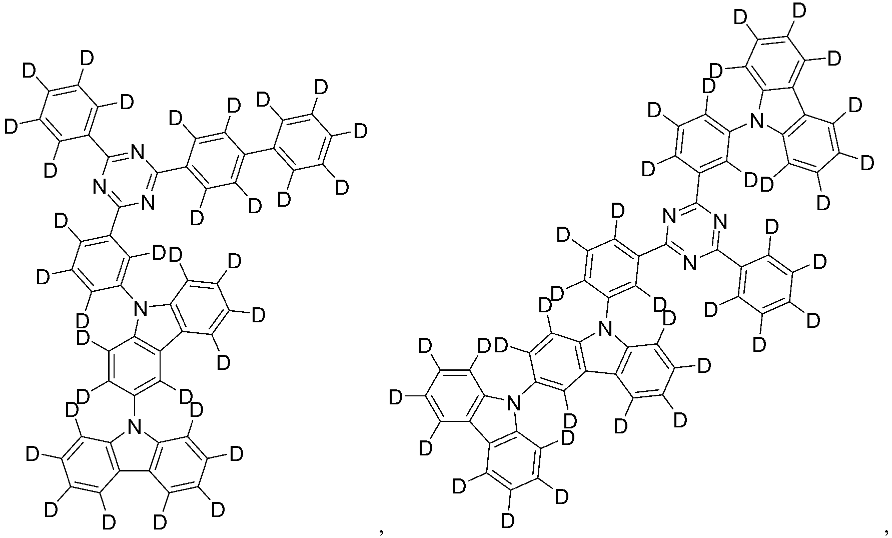 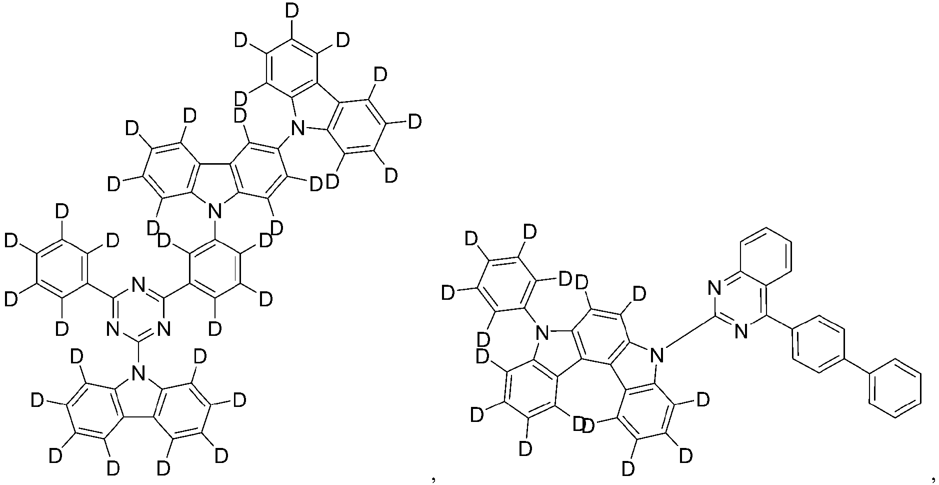 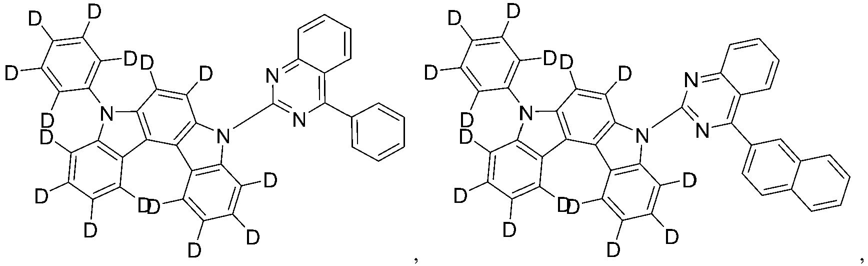 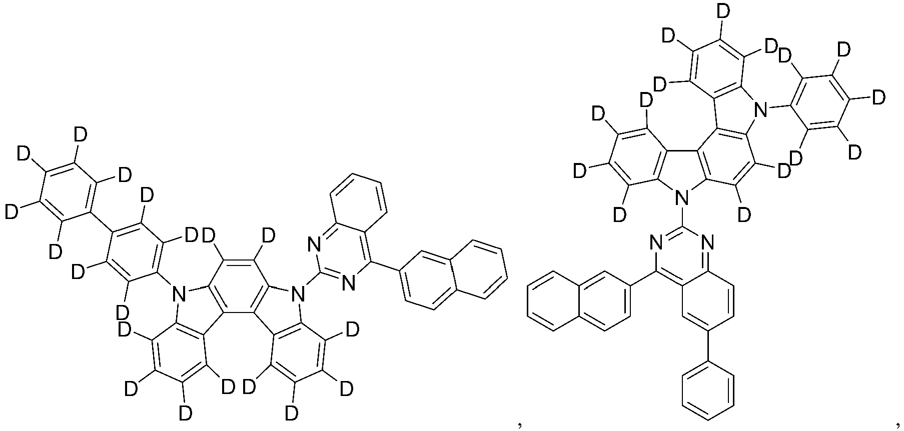 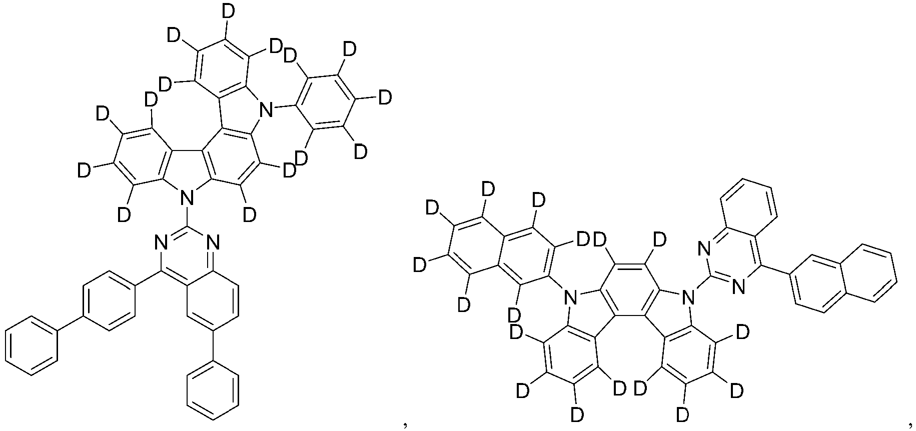 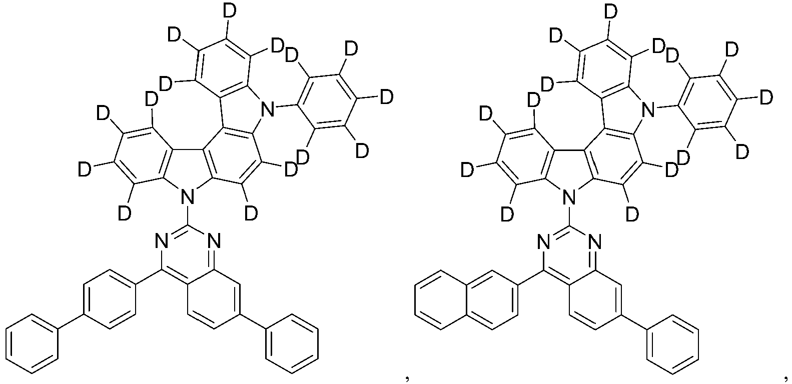 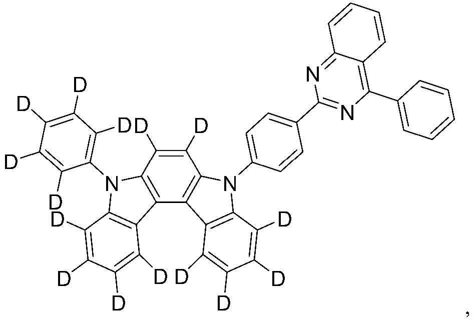 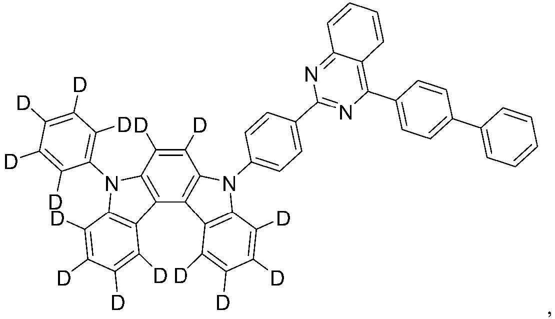 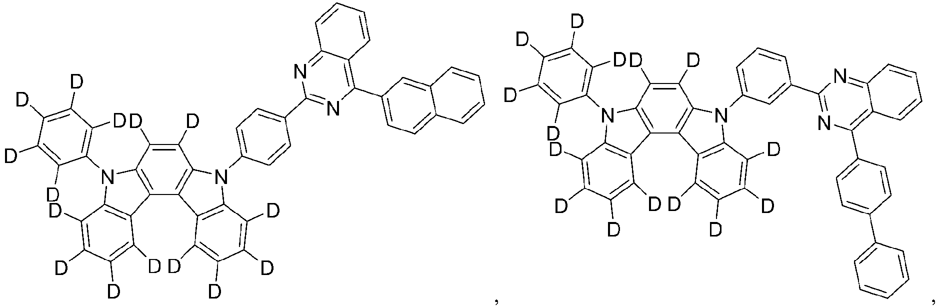 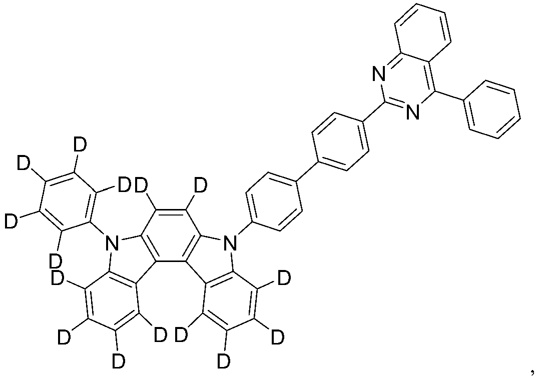 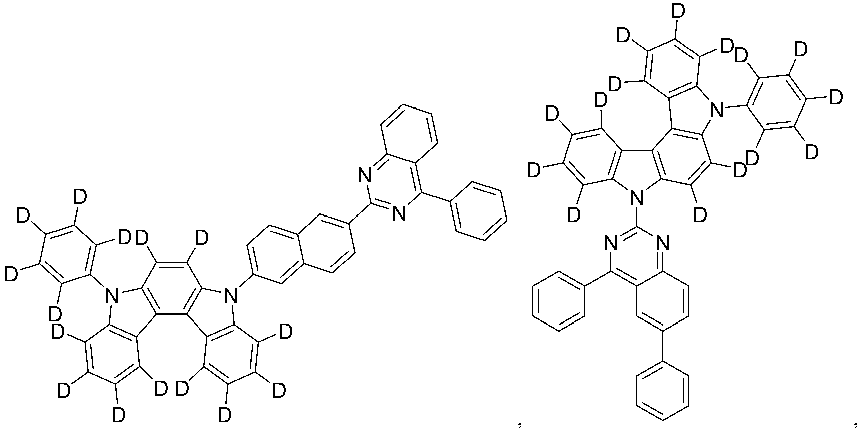 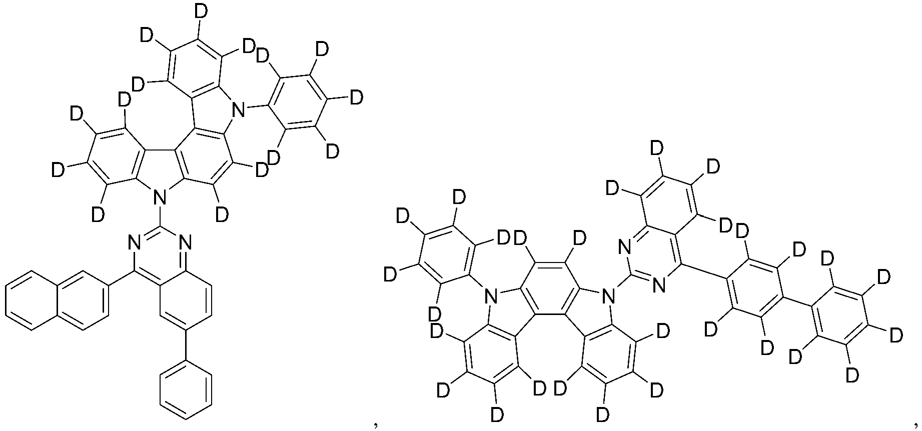 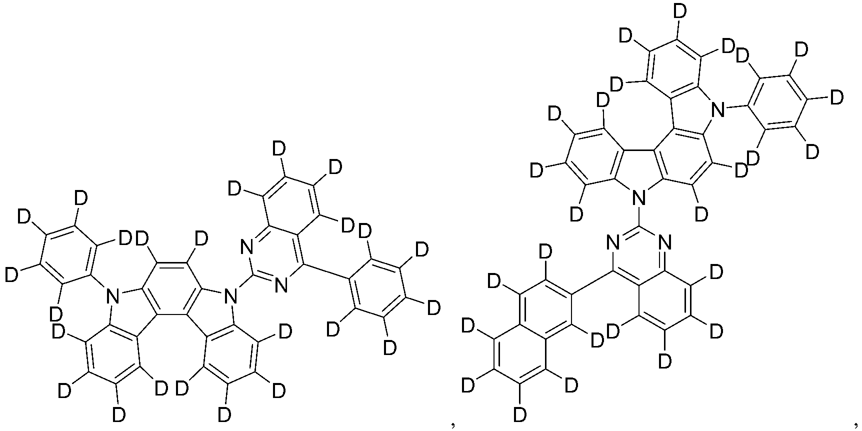 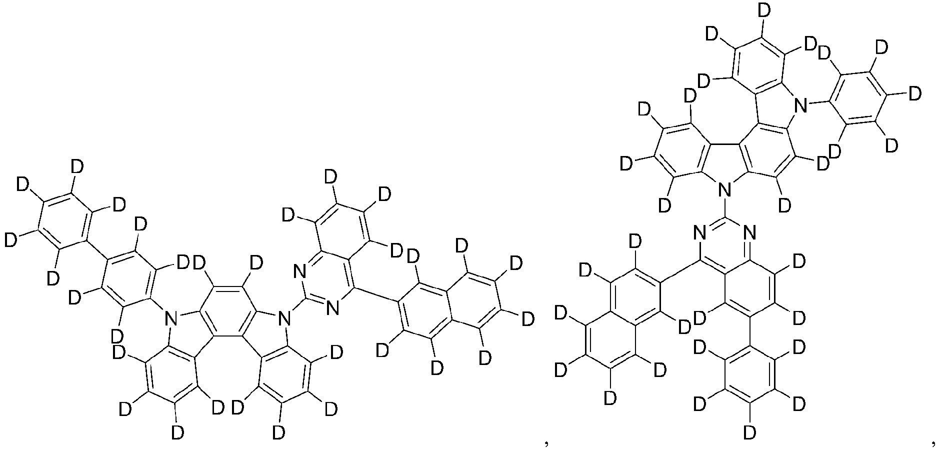 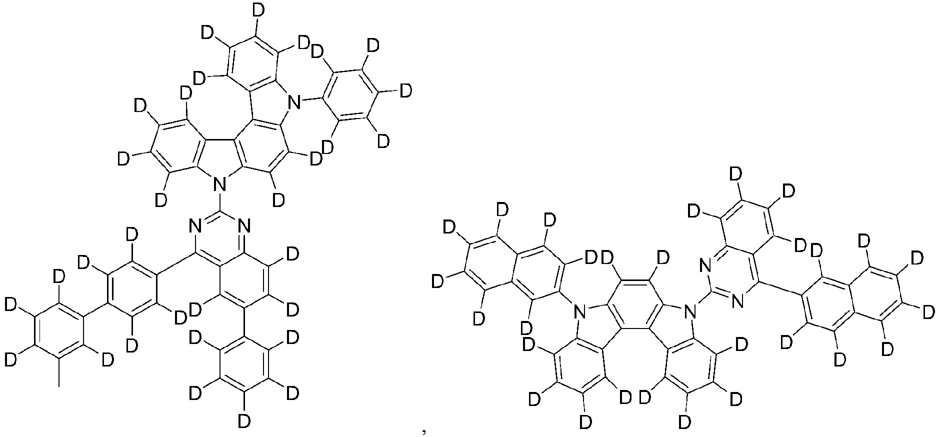 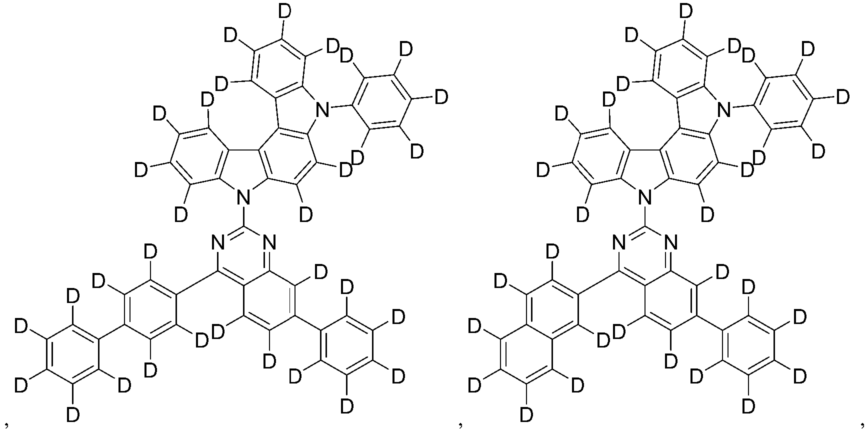 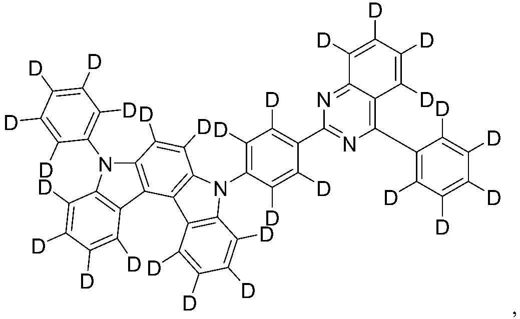 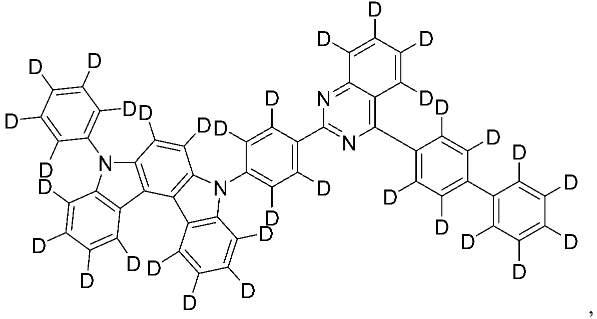 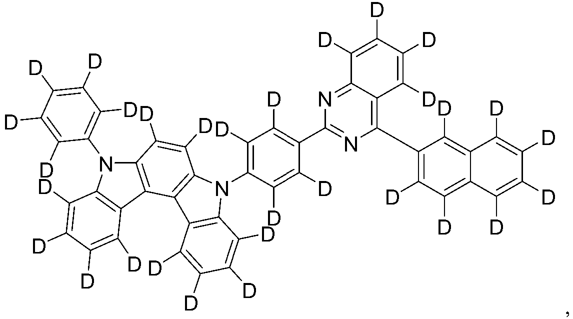 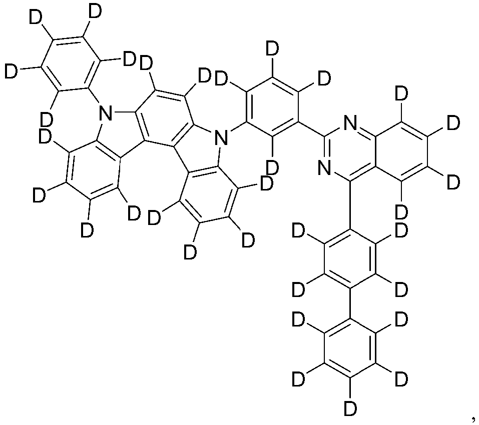 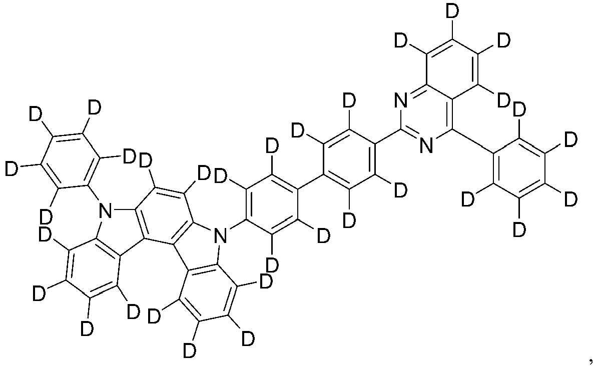 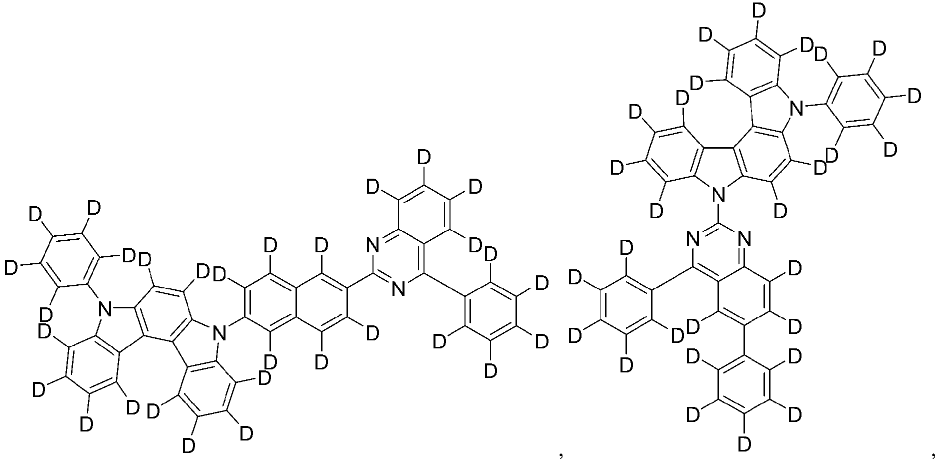 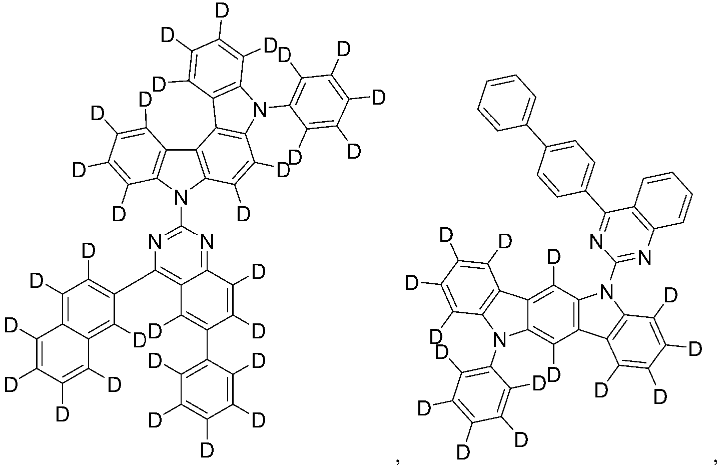 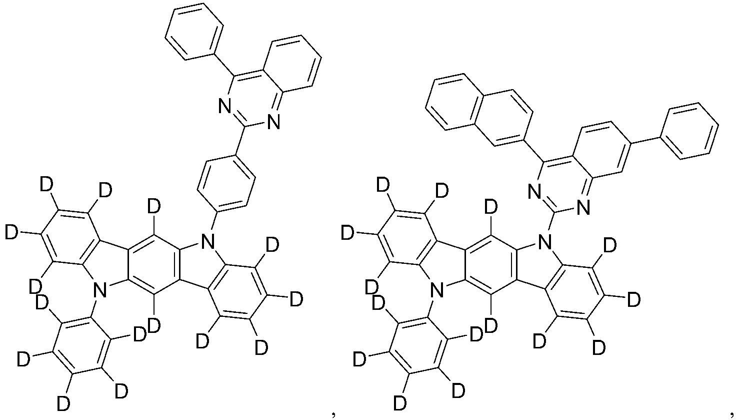 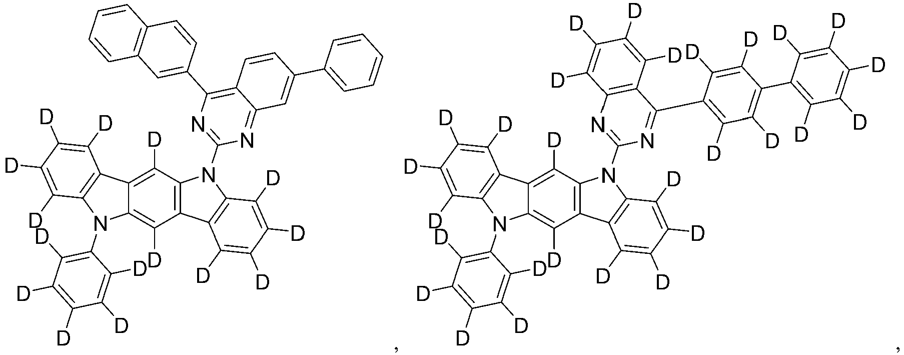 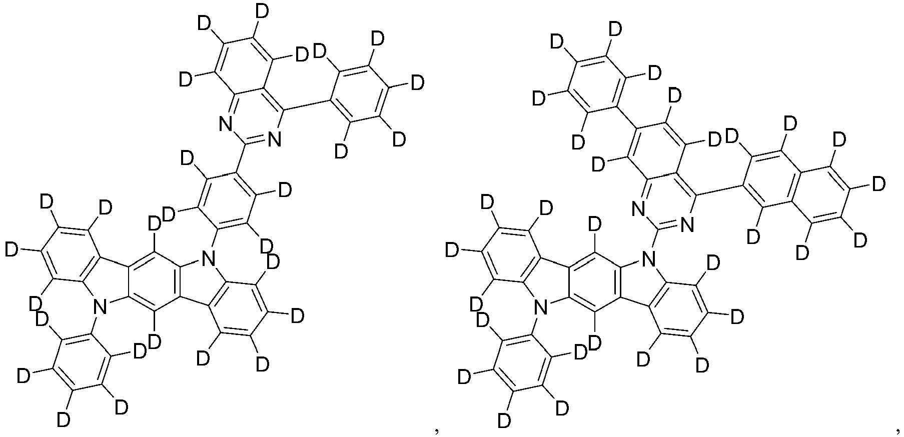 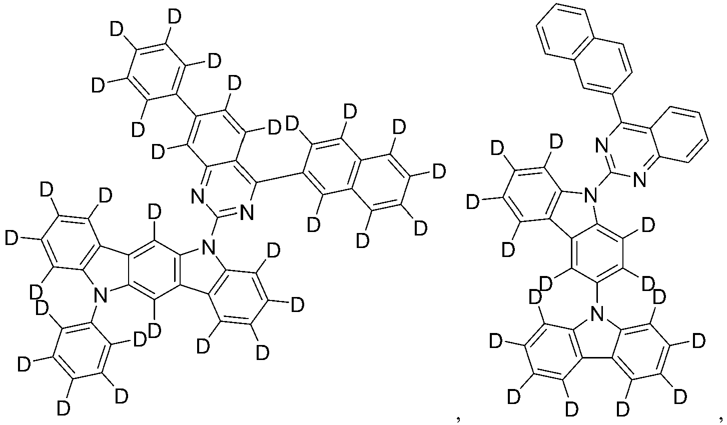 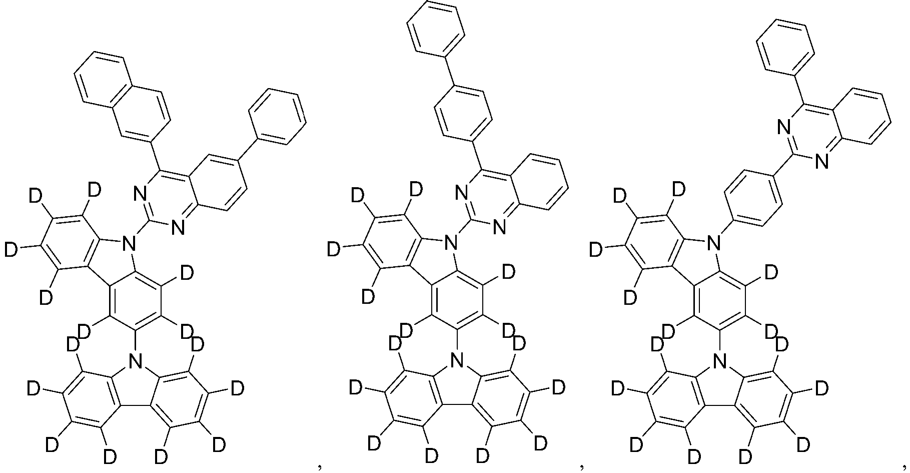 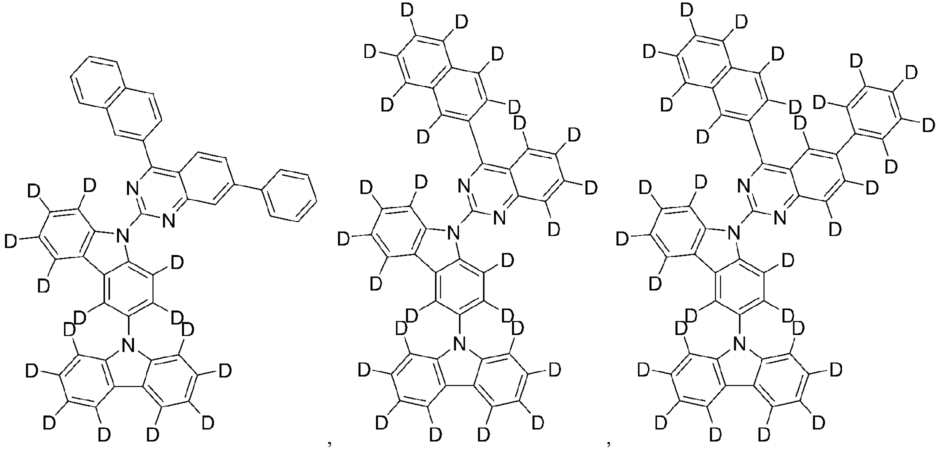 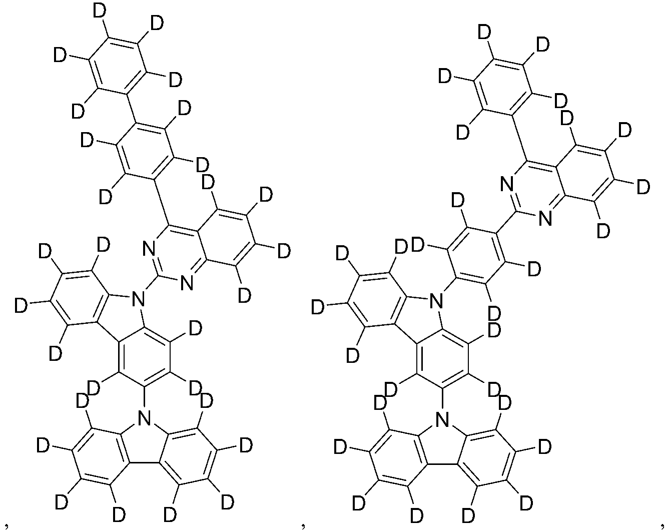 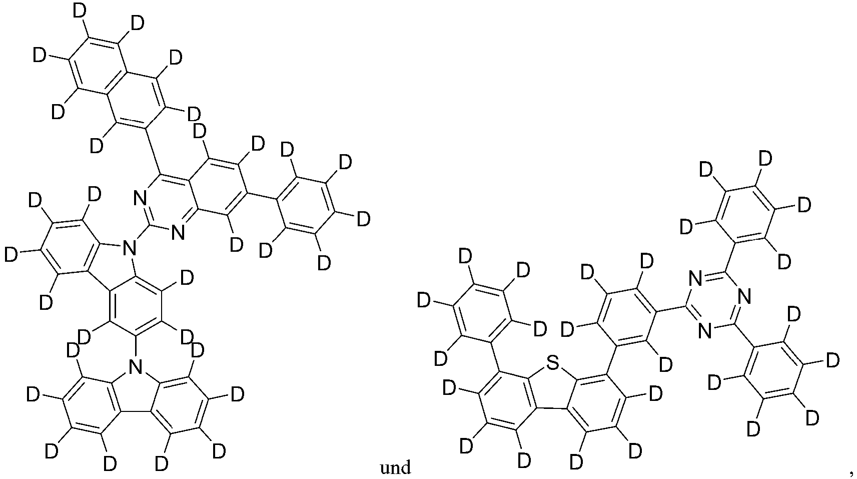 wobei:
jedes von X₁ bis X₁₁ ist unabhängig C oder N;
jedes Y^{A} ist unabhängig entweder nicht vorhanden oder, falls vorhanden, ausgewählt aus der Gruppe bestehend aus O, S, Se, CRR', SiRR', NR, BR, BRR';
jedes von R^{A'}, R^{B'}, R^{C'}, R^{D'}, R^{E'}, R^{F'} und R^{G'} steht unabhängig für eine, bis zur maximalen Anzahl an Substitutionen oder keine Substitutionen;
jedes von R, R', R^{A'}, R^{B'}, R^{C'}, R^{D'}, R^{E'}, R^{F'} und R^{G'} unabhängig voneinander ein Wasserstoffatom oder einen Substituenten darstellt, der ausgewählt ist aus der Gruppe bestehend aus den hierin definierten allgemeinen Substituenten; und
mindestens eines von R, R', R^{A'}, R^{B'}, R^{C'}, R^{D'}, R^{E'}, R^{F'} oder R^{G'} Deuterium enthält.

## Revendications

1. Un dispositif électroluminescent organique (OLED) (100, 200) comprenant :
une anode (115, 230) ;
une cathode (160, 215) ; et
une couche émissive (135, 220), disposée entre l'anode (115, 230) et la cathode (160, 215) ;
dans lequel la couche émissive (135, 220) comprend un premier émetteur phosphorescent et un premier hôte ;
dans lequel le premier émetteur phosphorescent est un complexe métallique ;
dans lequel le premier hôte est partiellement ou totalement deutéré ; et
**caractérisé en ce que** le complexe métallique est un complexe de Pt et au moins deux des conditions suivantes sont vraies :
(1) le complexe métallique comprend une liaison métal-carbène ;
(2) le complexe métallique comprend un groupe pendant comprenant au moins trois cycles aromatiques à 6 chaînons, chacun d'eux n'étant pas directement fusionné à un autre desdits au moins trois cycles aromatiques à 6 chaînons ; et
(3) la couche émissive comprend en outre un second hôte, dans lequel le second hôte est partiellement ou totalement deutéré.

2. Un dispositif électroluminescent organique (OLED) (100, 200) comprenant :
une anode (115, 230) ;
une cathode (160, 215) ; et
une couche émissive (135, 220), disposée entre l'anode (115, 230) et la cathode (160, 215) ;
dans lequel la couche émissive (135, 220) comprend un premier émetteur phosphorescent, un premier hôte et un second hôte ;
dans lequel le premier hôte est partiellement ou totalement deutéré ;
dans lequel le second hôte est partiellement ou totalement deutéré ; et
**caractérisé en ce que** le premier émetteur phosphorescent est un complexe métallique qui comprend au moins une caractéristique choisie dans le groupe constitué par : une structure à cycles fusionnés ayant au moins quatre cycles fusionnés de façon linéaire ; un groupement carbazole qui est directement lié au métal ; ou une structure cyclique comprenant 7 atomes ou plus.

3. L'OLED selon la revendication **1,** dans lequel le carbène est substitué par un substituant R, dans lequel ledit substituant R est partiellement ou entièrement deutéré, dans lequel ledit substituant R comprend au moins deux cycles aromatiques à 6 chaînons, chacun d'eux n'étant pas directement fusionné à l'autre cycle aromatique à 6 chaînons.

4. L'OLED selon la revendication 2, dans lequel le complexe métallique comprend au moins une caractéristique choisie dans le groupe constitué par : une structure à cycles fusionnés ayant au moins quatre cycles fusionnés de manière linéaire ; ou un fragment carbazole qui est directement lié au métal.

5. L'OLED selon la revendication 1 ou la revendication 2, dans lequel le premier hôte comprend un groupement boryle, dans lequel le groupement boryle est un atome de bore trivalent, dans lequel l'atome de bore se trouve dans la structure d'un des cycles ; l'atome de bore se trouve dans la structure de deux des cycles ; ou l'atome de bore se trouve dans la structure de trois des cycles.

6. L'OLED selon la revendication 1 ou la revendication 2, dans lequel le premier hôte est deutéré à au moins 10 %.

7. L'OLED selon la revendication 1 ou la revendication 2, dans lequel le complexe métallique est un complexe de platine, et le premier hôte comprend un fragment choisi dans le groupe constitué de triazine, pyridine, pyrimidine, pyrazine, pyridazine, dibenzofuranne, dibenzothiophène, aza-dibenzofuranne, azadibenzothiophène, triphénylène, aza-triphénylène, carbazole, indolocarbazole, aza-carbazole, aza-indolocarbazole, silyle et boryle.

8. L'OLED selon la revendication 1 ou la revendication 2, dans lequel le complexe métallique comprend au moins un fragment choisi dans le groupe constitué d'un groupe alkyle partiellement deutéré, d'un groupe cycloalkyle partiellement deutéré, d'un groupe aryle ou hétéroaryle partiellement deutéré, d'un groupe alkyle totalement deutéré et d'un groupe aryle ou hétéroaryle totalement deutéré.

9. L'OLED selon la revendication 1 ou la revendication 2, dans lequel le premier hôte est choisi dans le groupe consistant en : 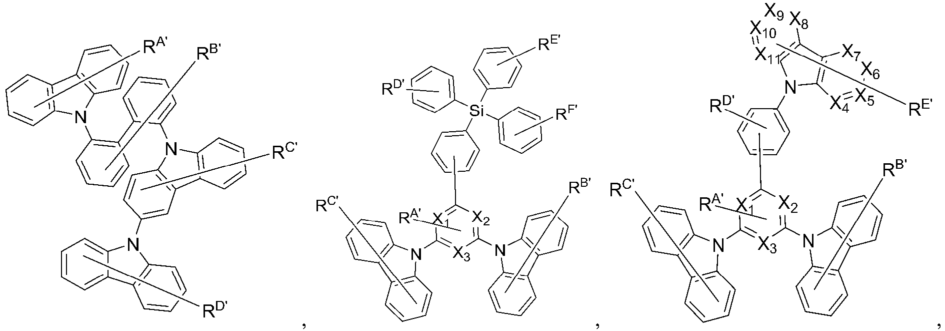 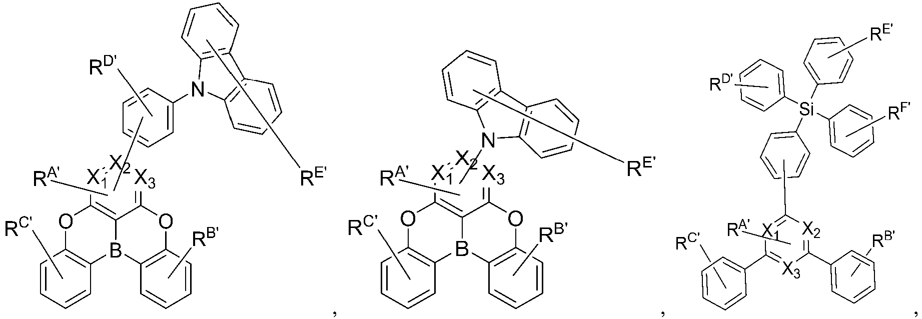 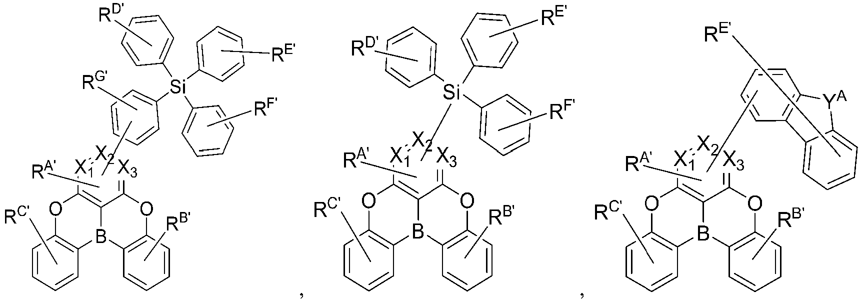 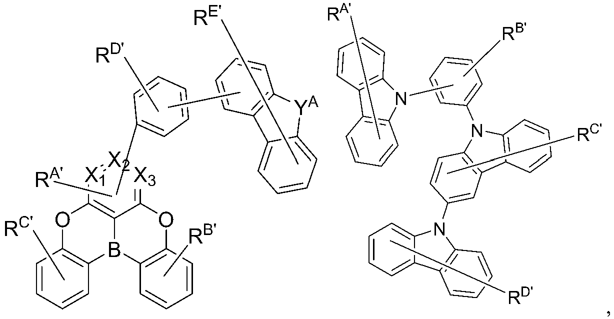 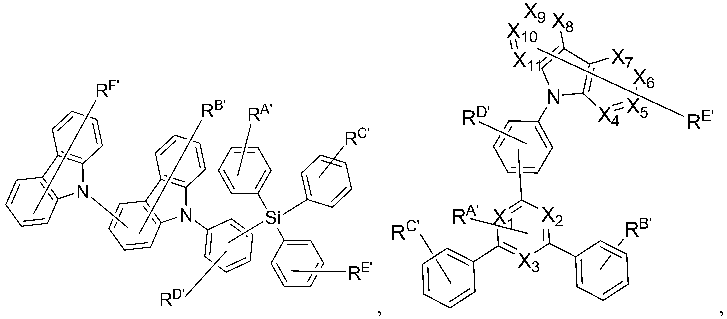 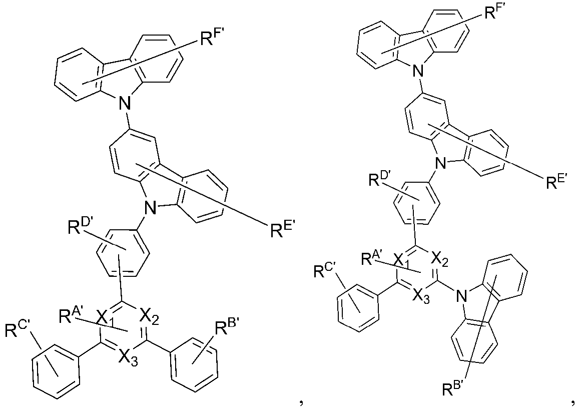 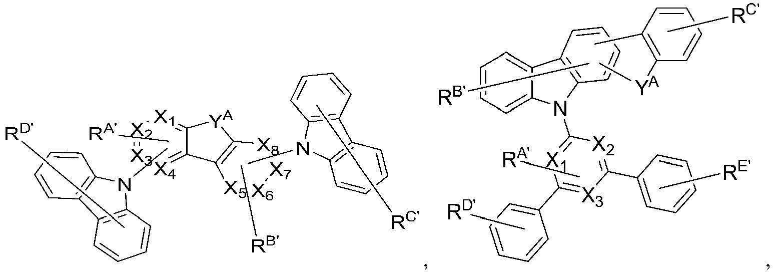 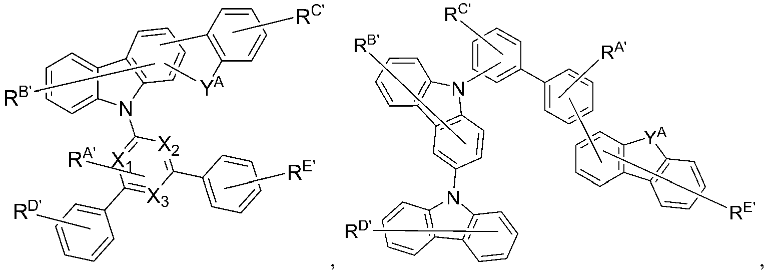 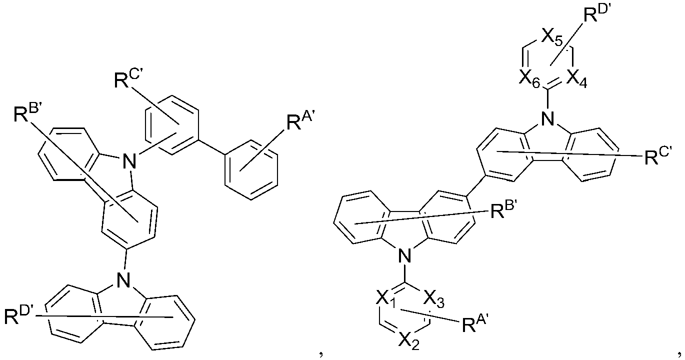 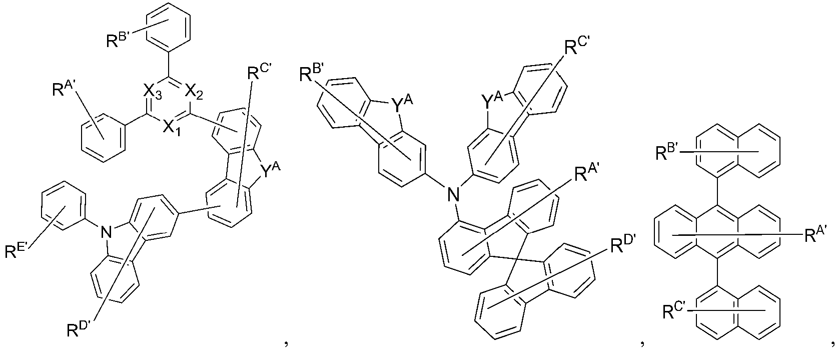 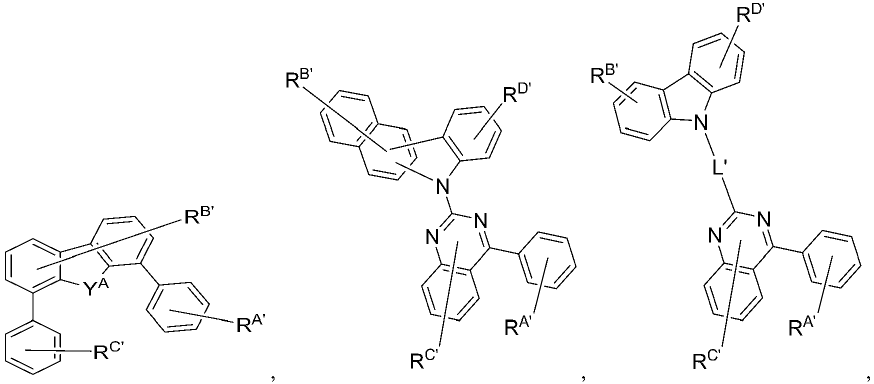 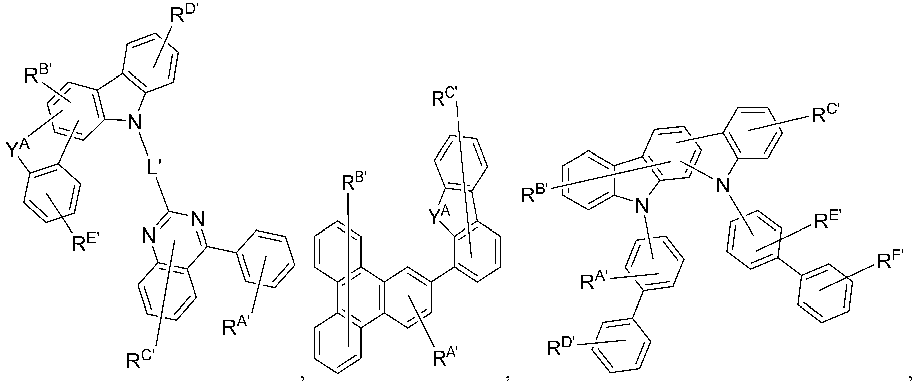 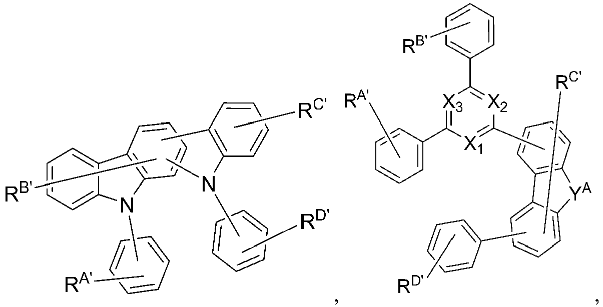 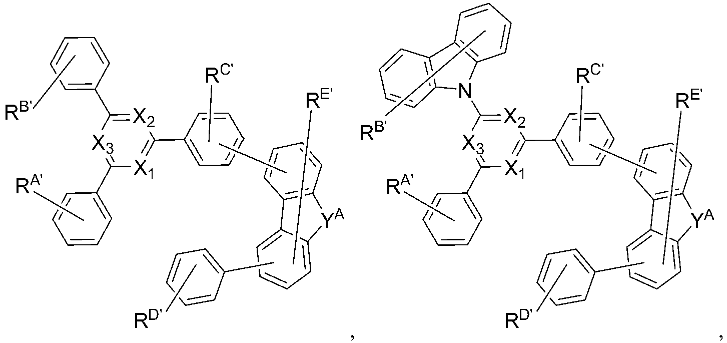 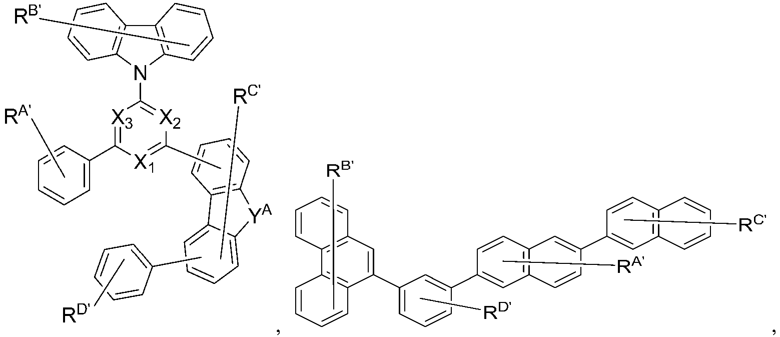 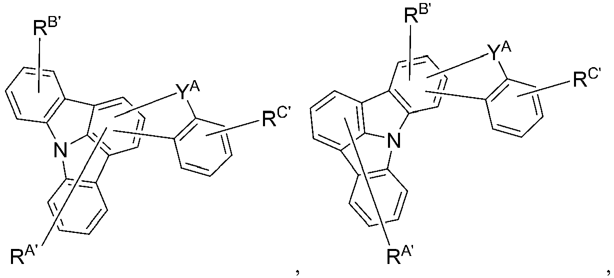 et 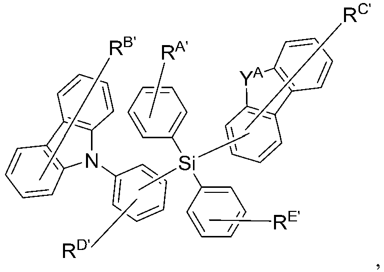 dans lequel :
chacun de X₁ à X₁₁ est indépendamment C ou N ;
chaque Y^{A} est indépendamment absent ou, lorsqu'il est présent, est choisi dans le groupe consistant en O, S, Se, CRR', SiRR', NR, BR, BRR' ;
chacun de R^{A'}, R^{B'}, R^{C'}, R^{D'}, R^{E'}, R^{F'}, et R^{G'} représente indépendamment une mono-substitution, jusqu'au nombre maximal de substitutions, ou aucune substitution ;
chacun de R, R', R^{A'}, R^{B'}, R^{C'}, R^{D'}, R^{E'}, R^{F'}, et R^{G'} est indépendamment un hydrogène ou un substituant choisi dans le groupe consistant en du deutérium, de l'halogène, un alkyle, un cycloalkyle, un hétéroalkyle, un hétérocycloalkyle, un arylalkyle, un alcoxy, un aryloxy, un amino, un silyle, un boryle, un germyle, un alcényle, un cycloalcényle, un hétéroalcényle, un alcynyle, un aryle, un hétéroaryle, un acyle, un acide carboxylique, un éther, un ester, un nitrile, un isonitrile, un sulfanyle, un sulfinyle, un sulfonyle, un phosphino, un sélényle, et leurs combinaisons ; et
au moins un R, R', R^{A'}, R^{B'}, R^{C'}, R^{D'}, R^{E'}, R^{F'}, ou R^{G'} comprend du deutérium.

10. L'OLED selon la revendication 1 ou la revendication 2, dans lequel le complexe métallique a une structure M(L_{A})ₚ(L_{B})_{q}(L_{C})ᵣ, où p est 1, 2 ou 3 ; q est 0, 1 ou 2 ; r est 0, 1 ou 2 ; et p+q+r est l'état d'oxydation du métal M;
le ligand L_{A} comprend un fragment sélectionné dans le groupe constitué de: 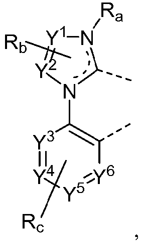 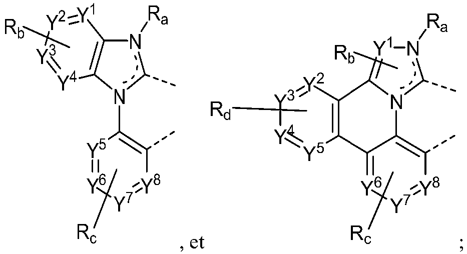
dans lesquels:
chacun de Y¹ à Y⁸ est indépendamment C ou N ;
chacun de R^{b}, R^{c} et R^{d} représente indépendamment une mono-substitution, jusqu'au nombre maximal de substitutions, ou aucune substitution ;
chacun de R^{a}, R^{b}, R^{c} et R^{d} est indépendamment un hydrogène ou un substituant choisi dans le groupe consistant en du deutérium, un halogène, un alkyle, un cycloalkyle, un hétéroalkyle, un hétérocycloalkyle, un arylalkyle, un alcoxy, un aryloxy, un amino, un silyle, un boryle, un alcényle, un cycloalcényle, un hétéroalcényle, un alcynyle, un aryle, un hétéroaryle, un acyle, un acide carboxylique, un éther, un ester, un nitrile, un isonitrile, un sulfanyle, un sulfinyle, un sulfonyle, un phosphino et leurs combinaisons ;
et chacun des ligands L_{B} et L_{C} est indépendamment sélectionné dans le groupe constitué de: 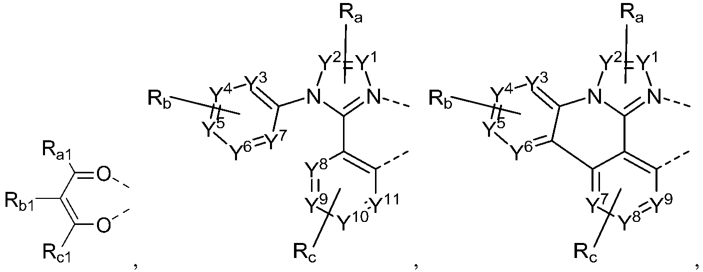 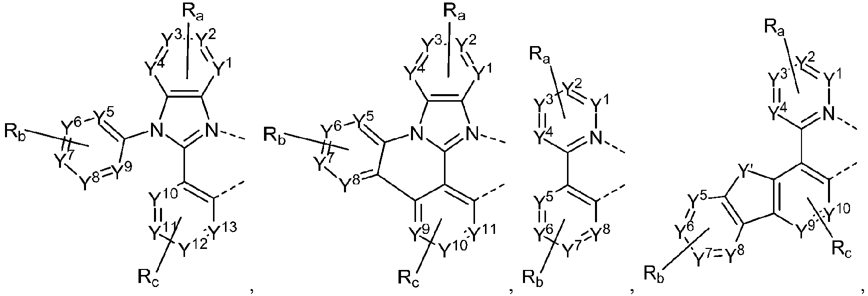 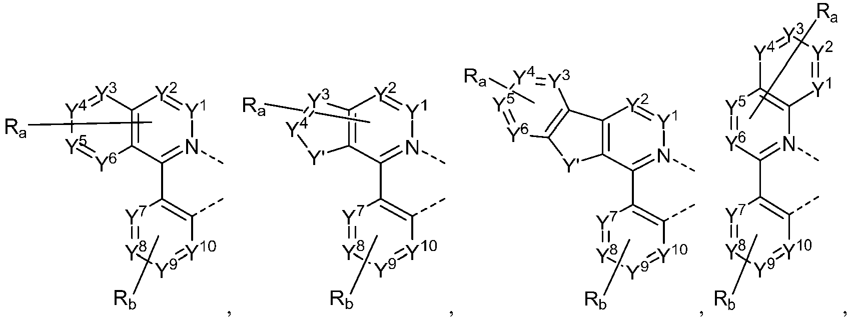 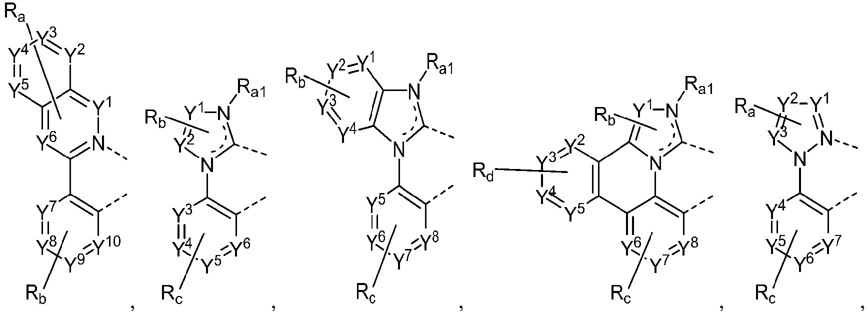 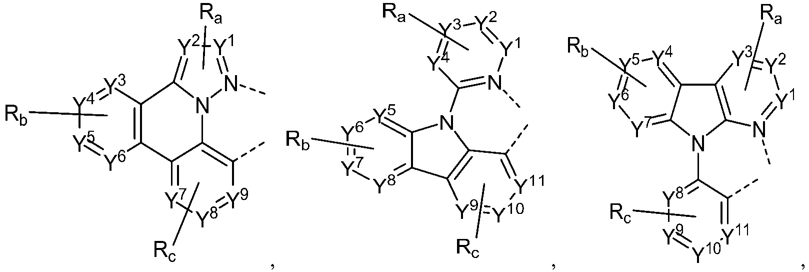 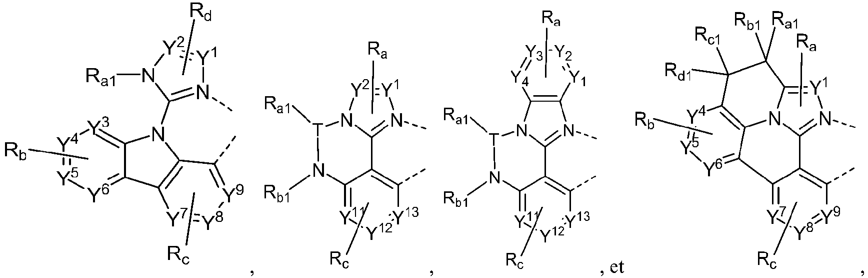
dans lesquels :
T est sélectionné dans le groupe constitué de B, Al, Ga et In ;
chacun de Y¹ à Y¹³ est indépendamment sélectionné dans le groupe constitué de carbone et d'azote ;
Y' est sélectionné dans le groupe constitué de BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f} et GeRₑR_{f};
Rₑ et R_{f} peuvent être fusionnés ou joints pour former un cycle ;
chacun de Rₐ, R_{b}, R_{c} et R_{d} représente indépendamment zéro, une mono-substitution ou jusqu'au nombre maximal permis de substitutions sur son cycle associé ;
chacun de Rₐ₁, R_{b1}, R_{c1}, R_{d1}, Rₐ, R_{b}, R_{c}, Rₐ, Rₑ et R_{f} est indépendamment un hydrogène ou un substituant sélectionné dans le groupe constitué de deutérium, halogénure, alkyle, cycloalkyle, hétéroalkyle, arylalkyle, alcoxy, aryloxy, amino, silyle, boryle, alcényle, cycloalcényle, hétéroalcényle, alcynyle, aryle, hétéroaryle, acyle, carbonyle, acide carboxylique, ester, nitrile, isonitrile, sulfanyle, sulfinyle, sulfonyle, phosphino et leurs combinaisons ; et
deux quelconques Rₐ, R_{b}, R_{c}, Rₐ, Rₑ et R_{f} adjacents peuvent être fusionnés ou joints pour former un cycle ou former un ligand multidentate.

11. L'OLED selon la revendication 1 ou la revendication 2, dans lequel le second hôte est choisi dans le groupe constitué de: 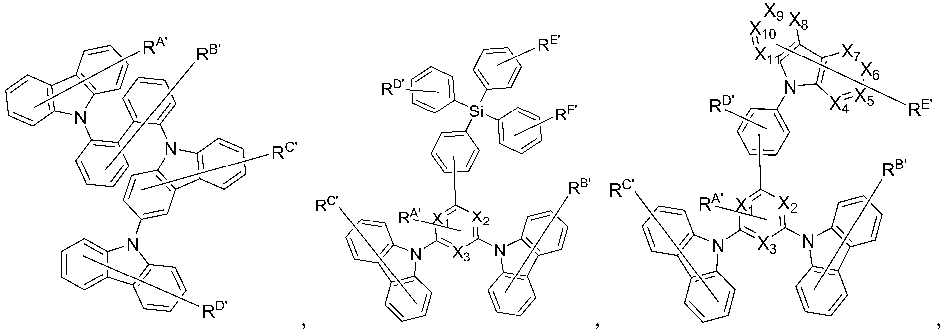 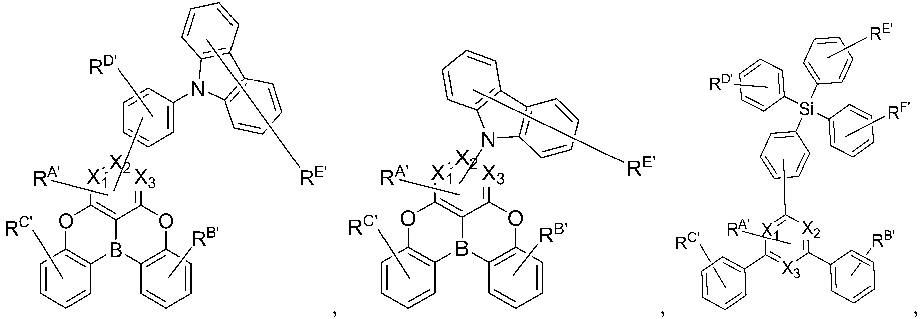 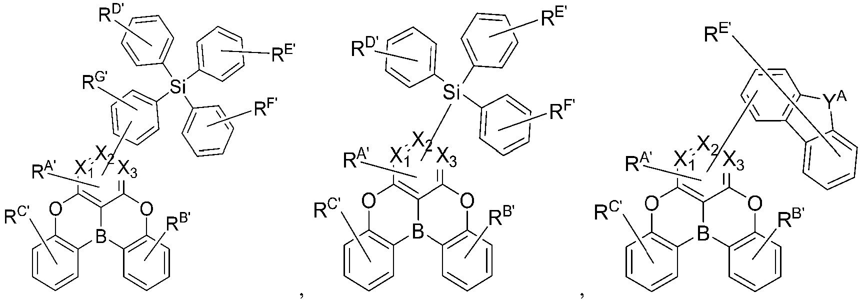 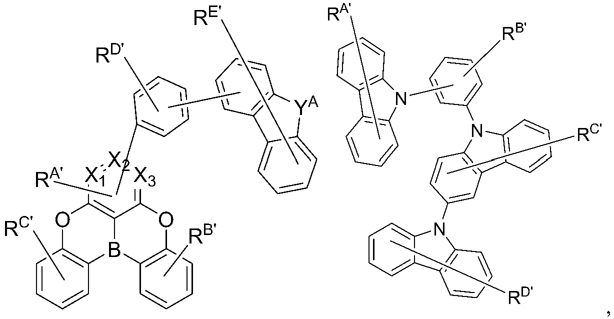 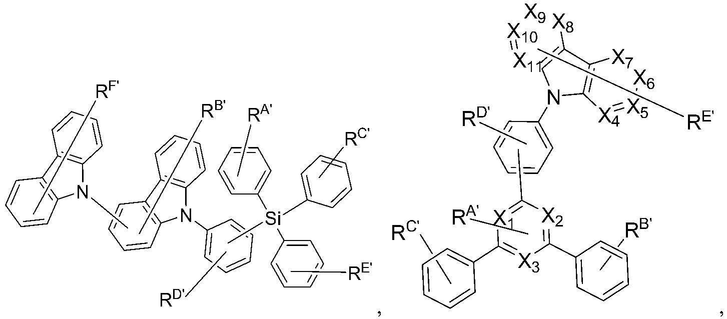 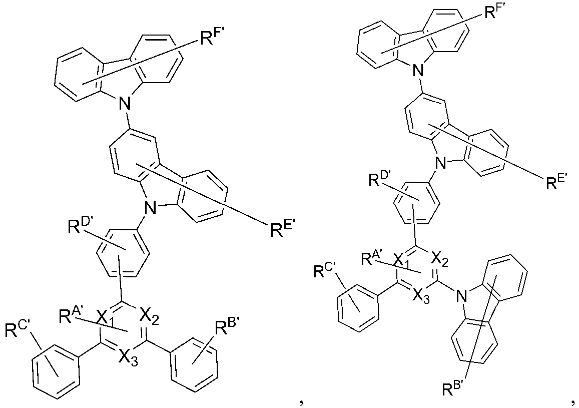 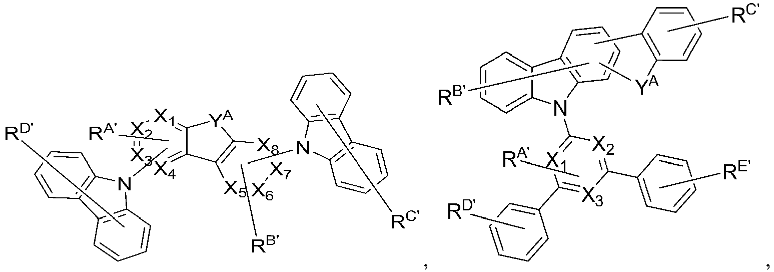 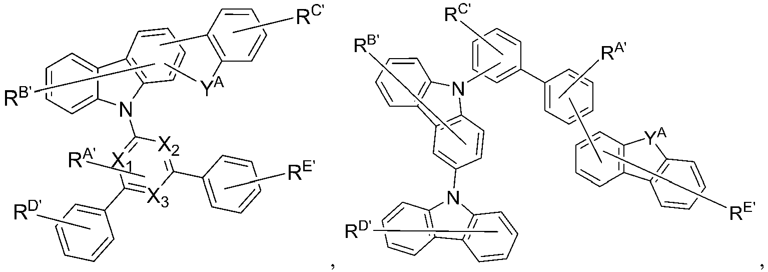 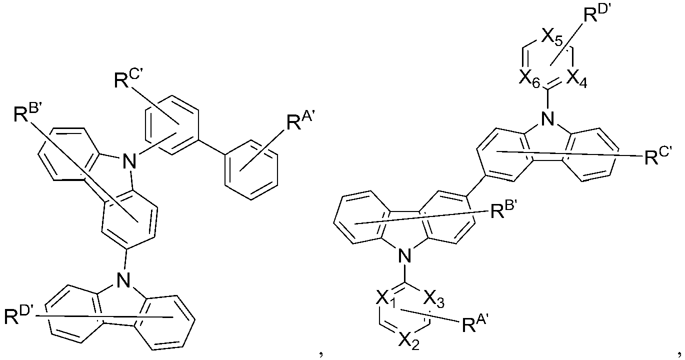 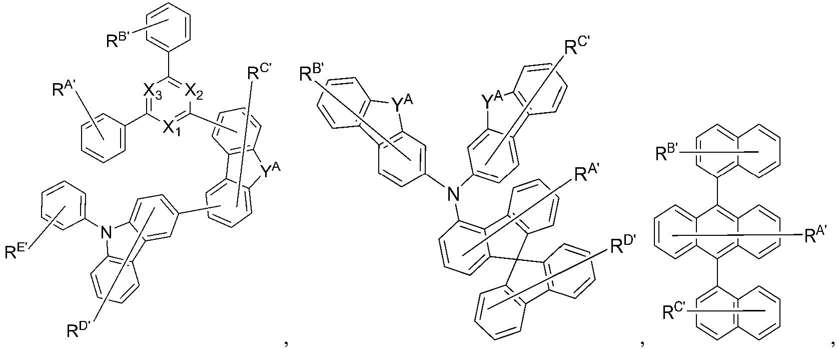 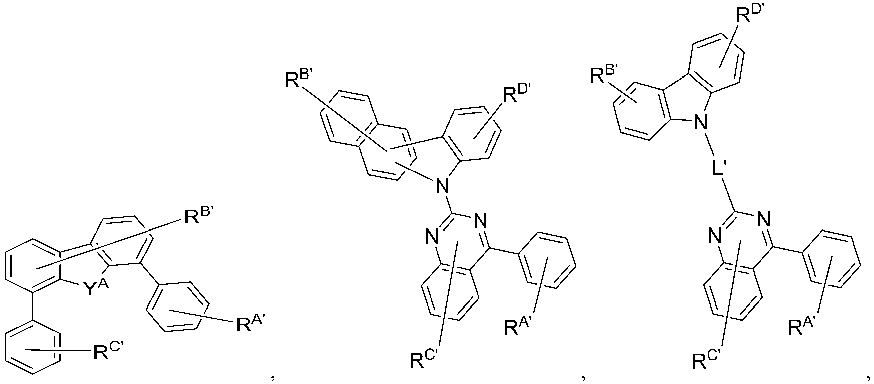 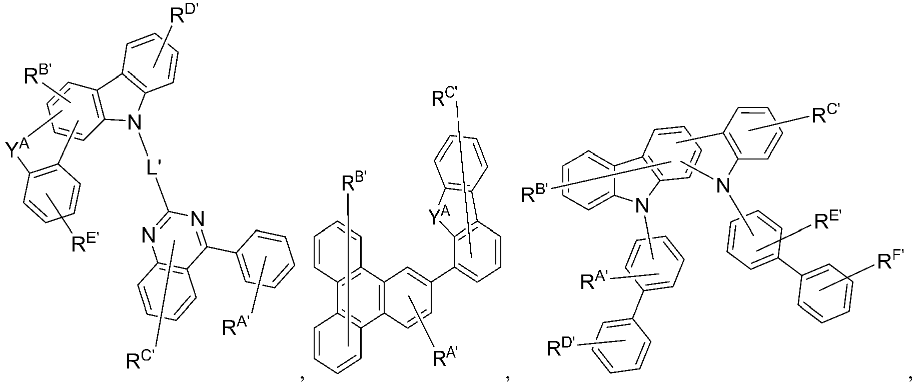 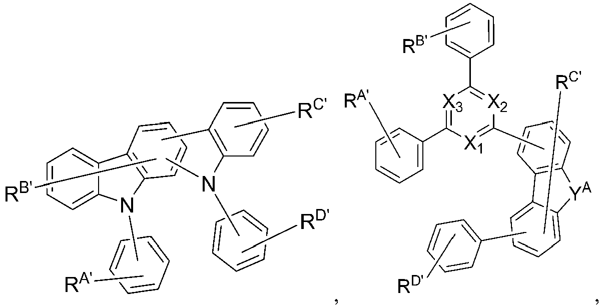 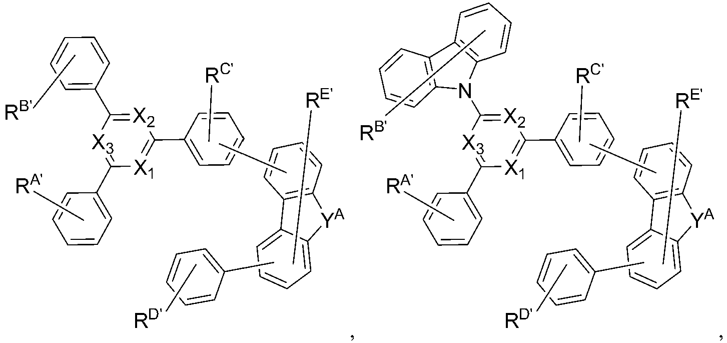 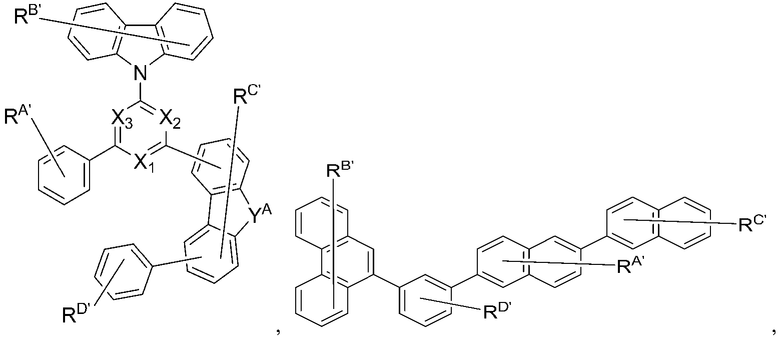 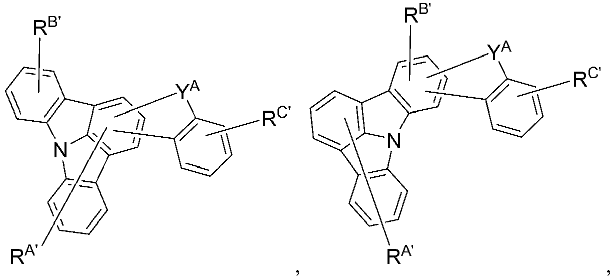 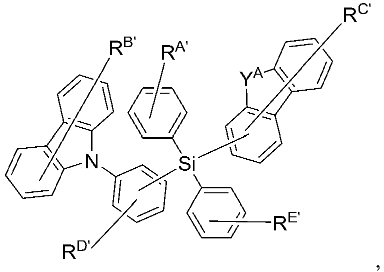 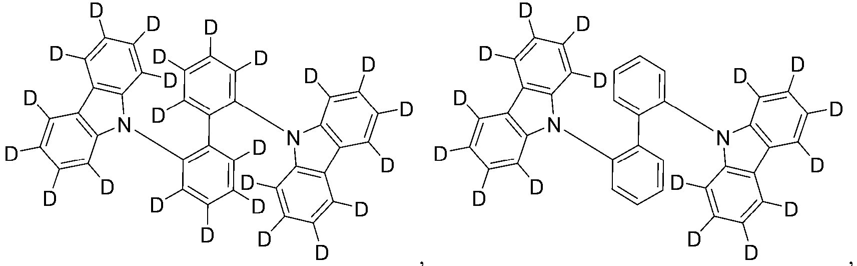 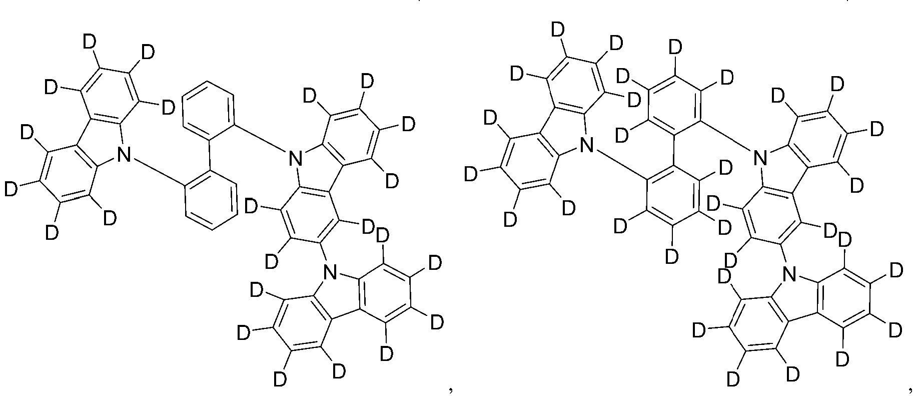 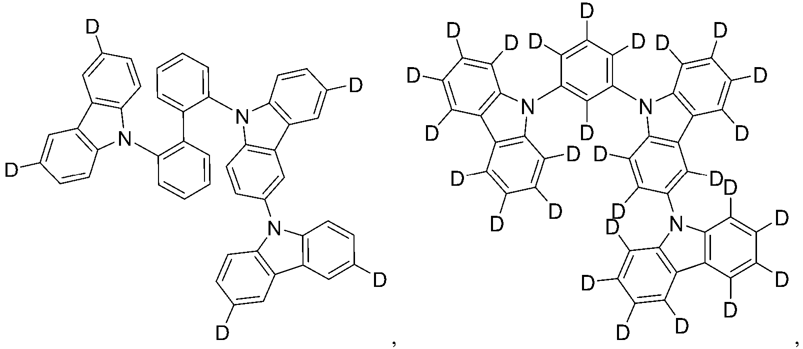 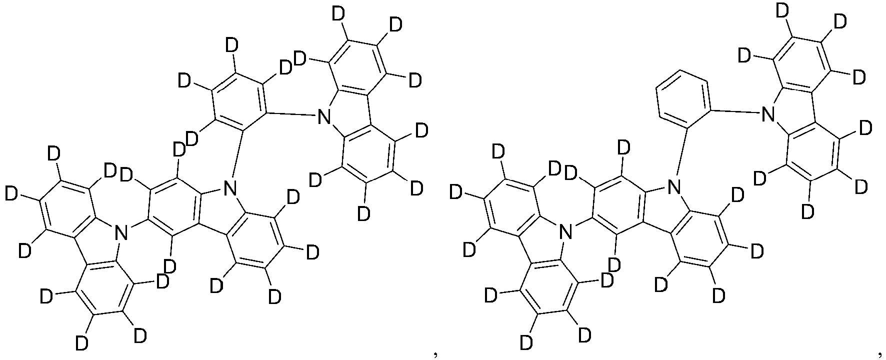 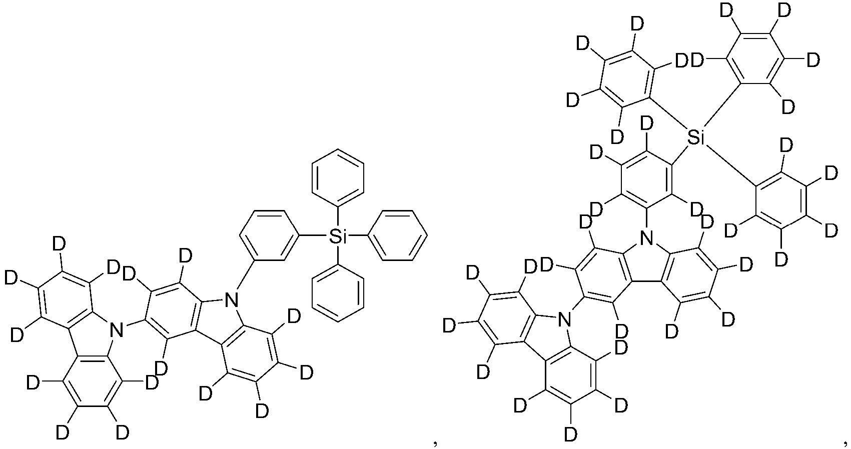 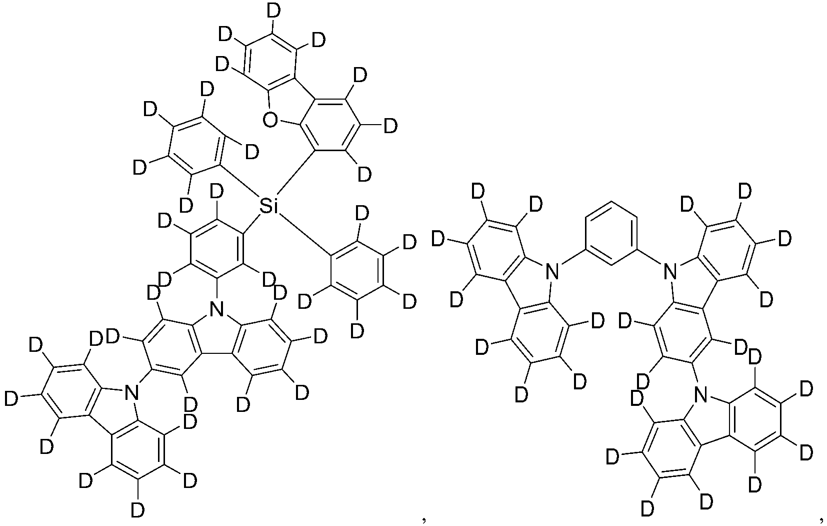 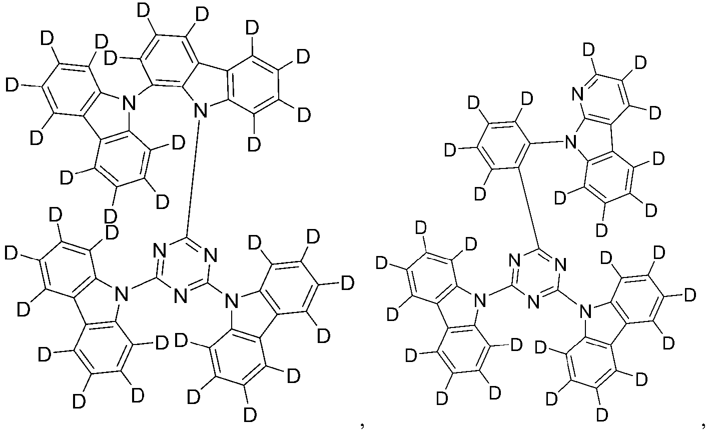 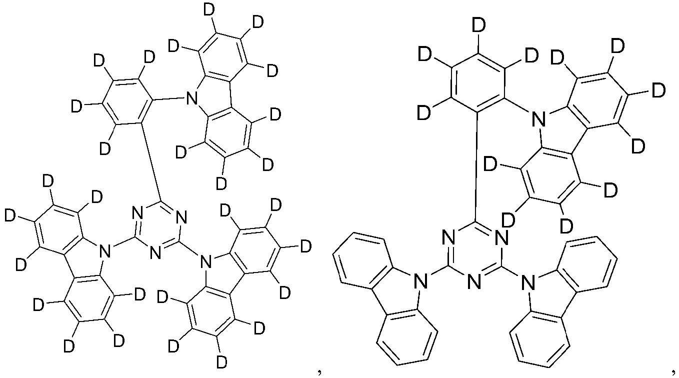 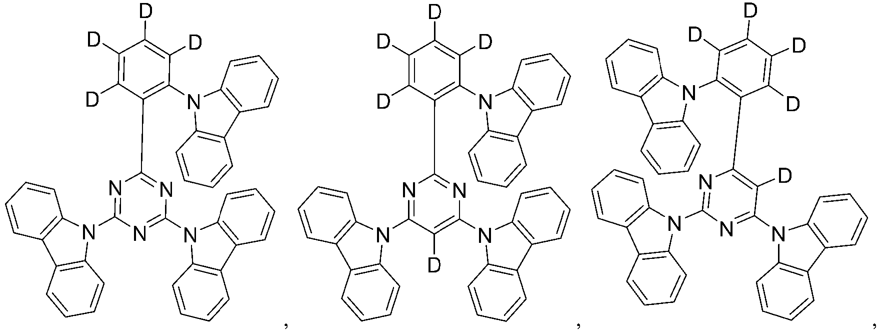 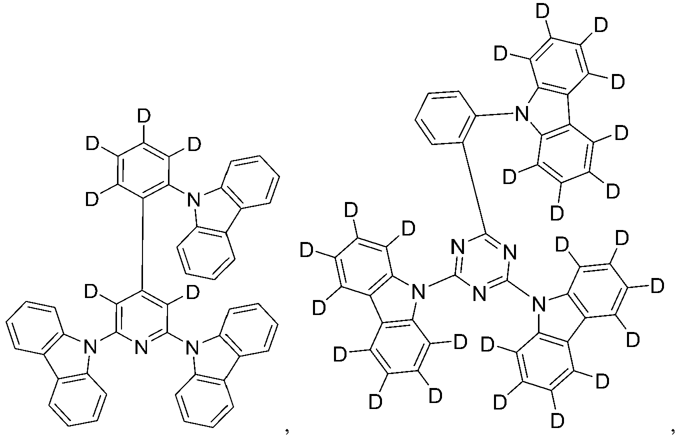 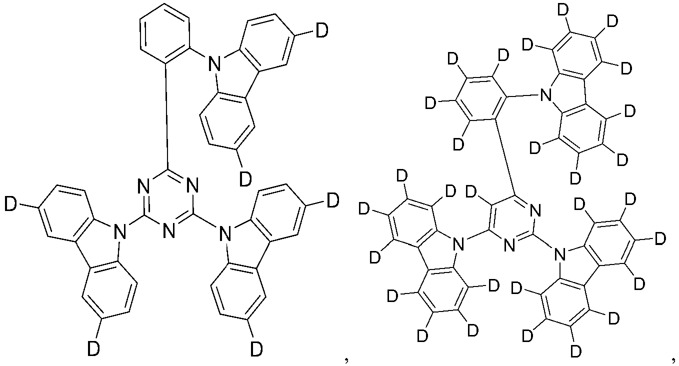 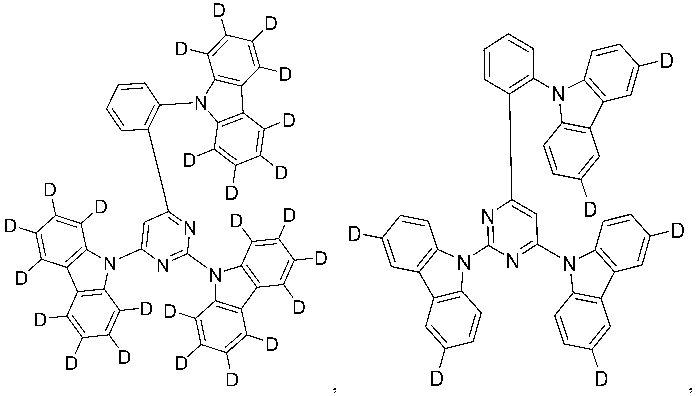 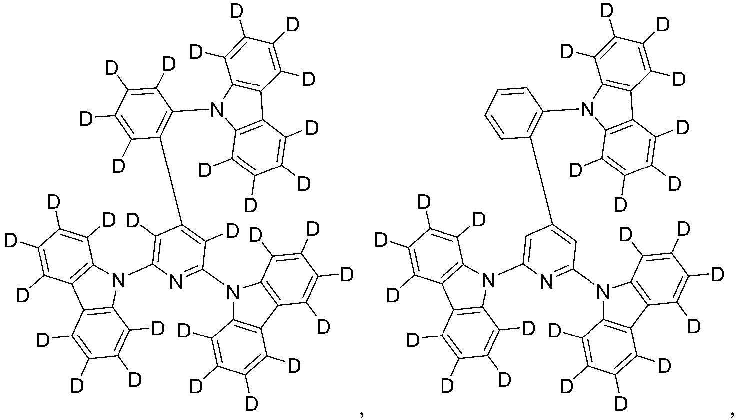 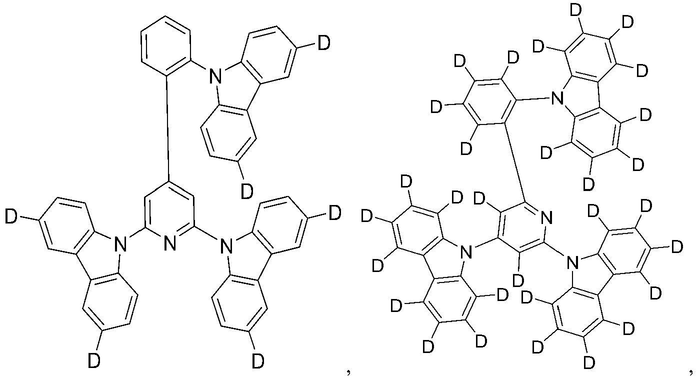 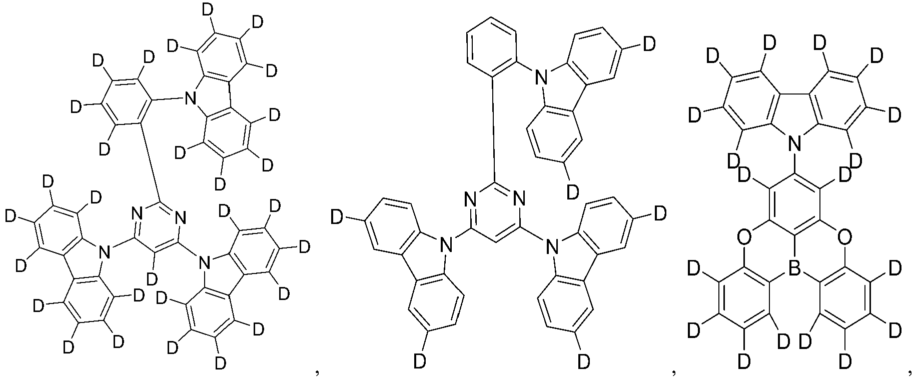 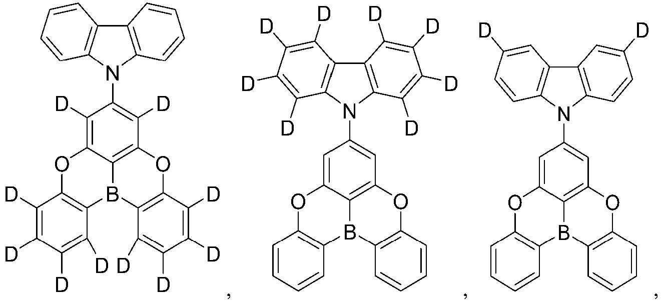 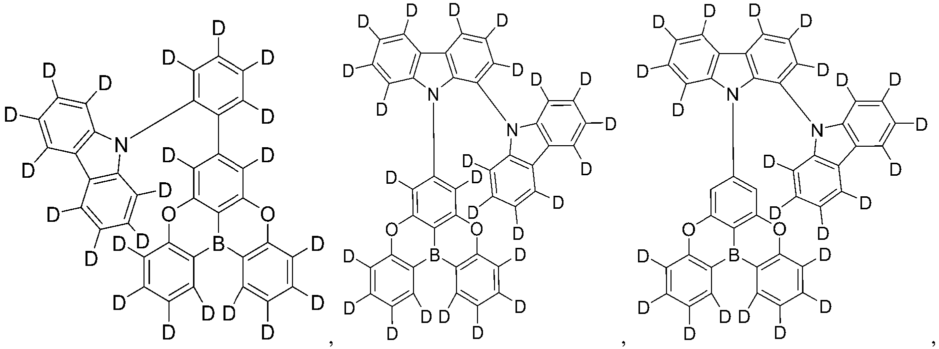 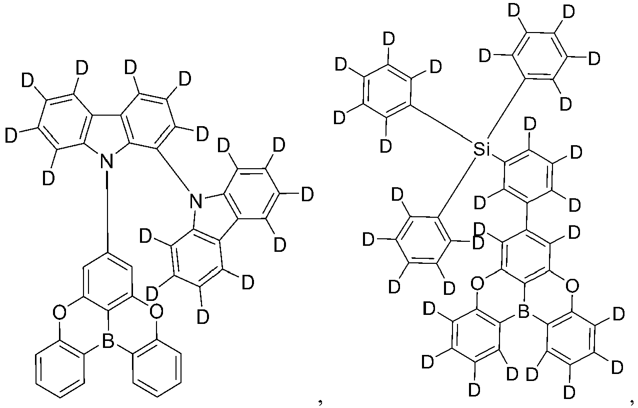 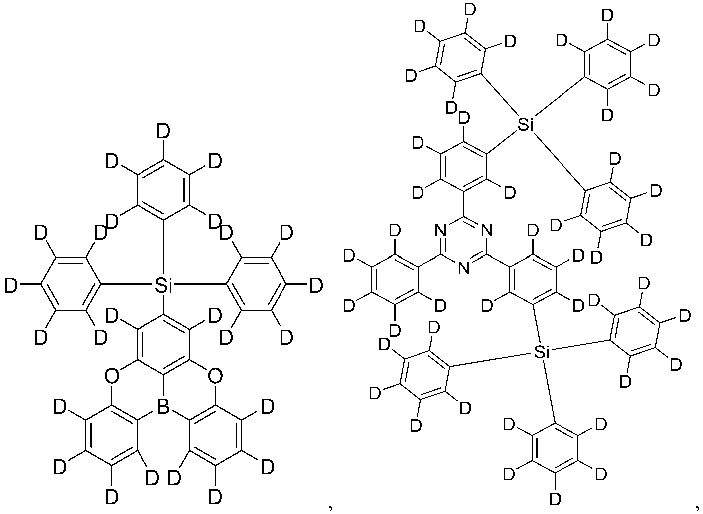 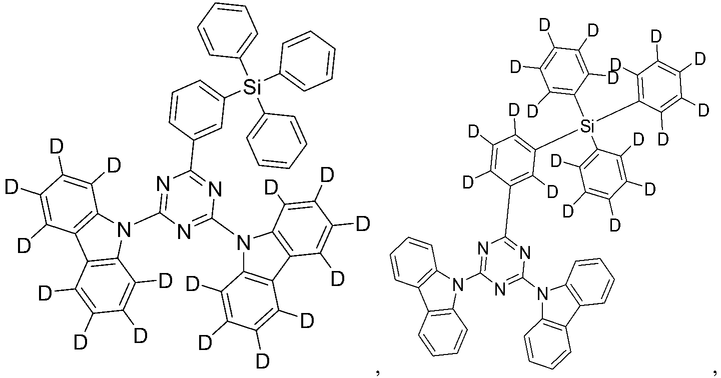 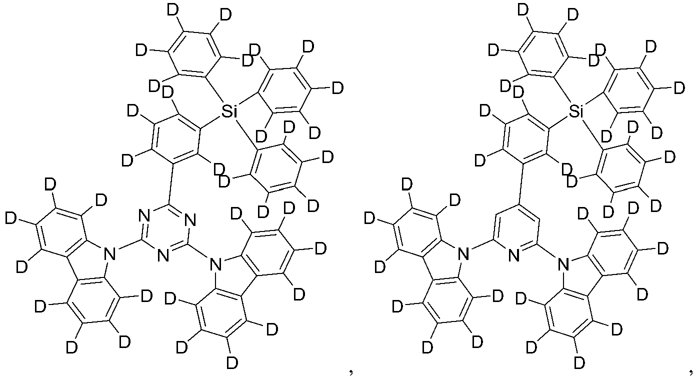 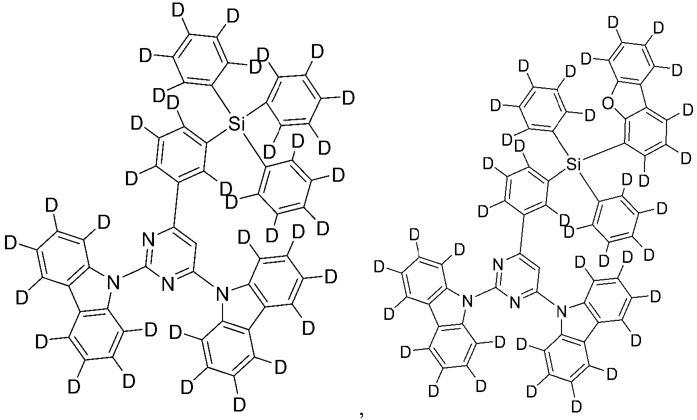 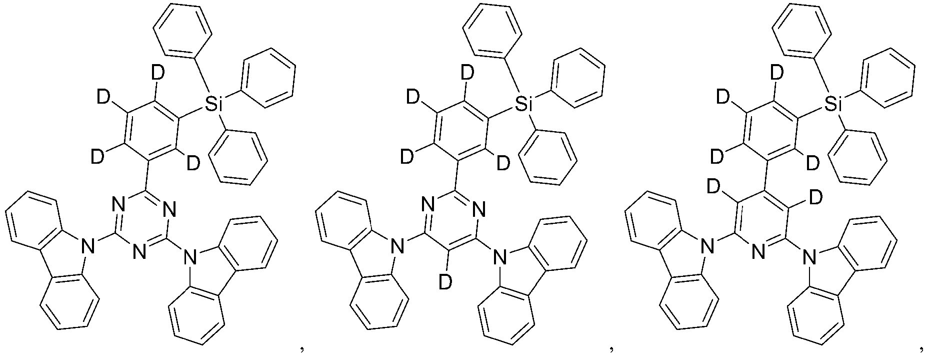 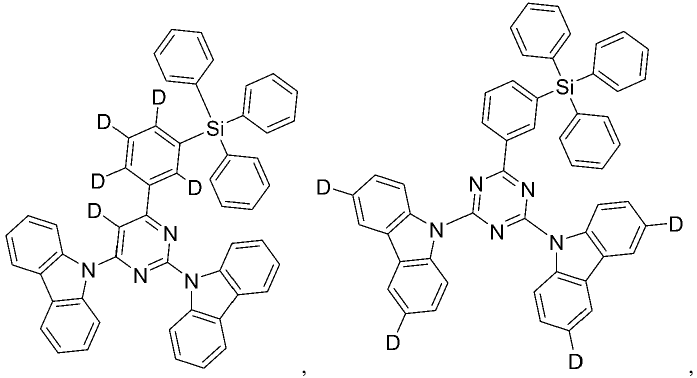 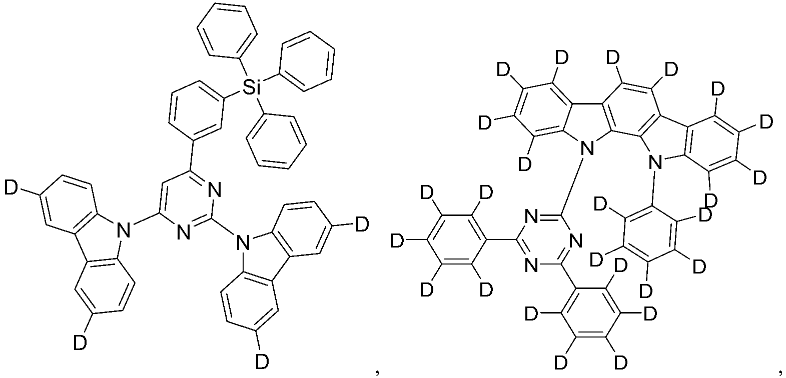 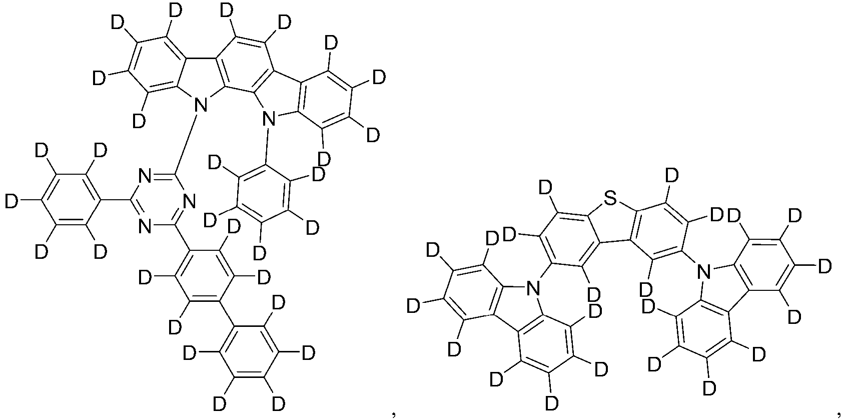 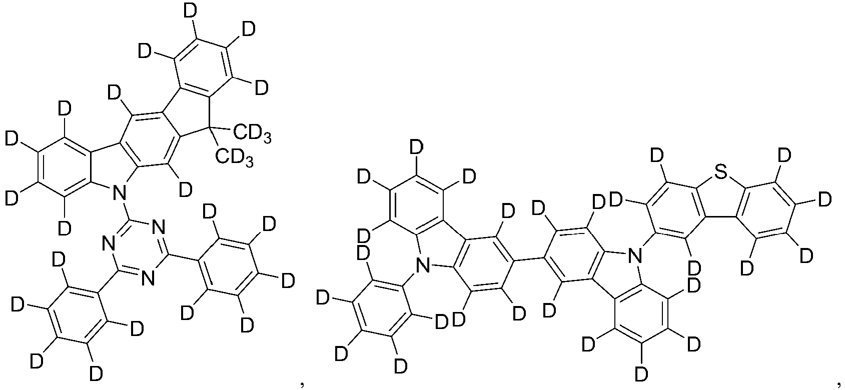 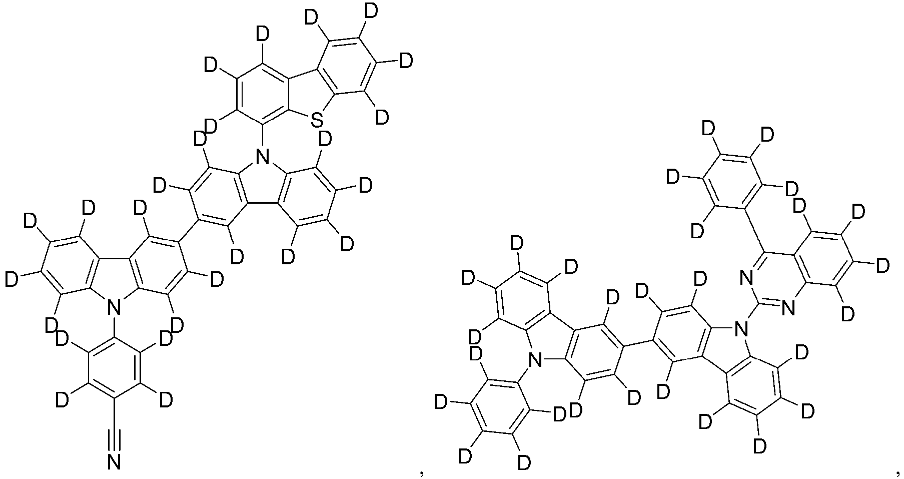 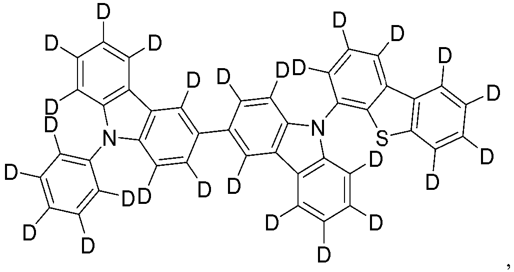 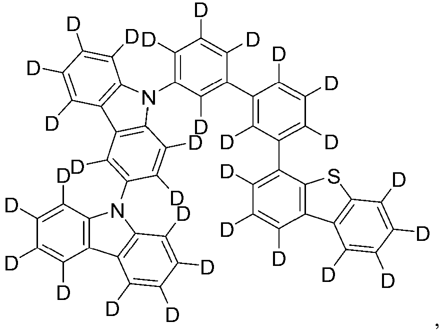 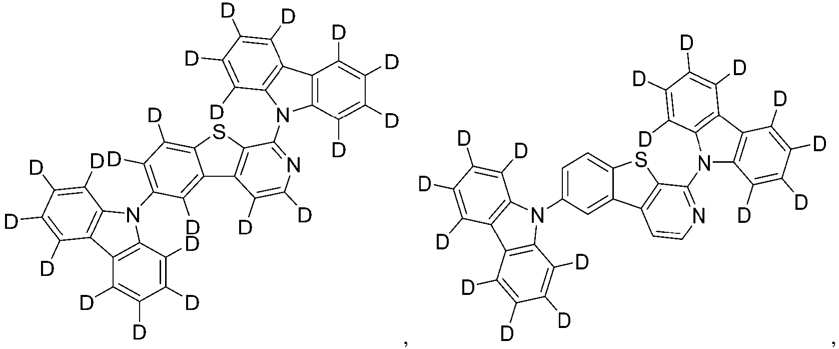 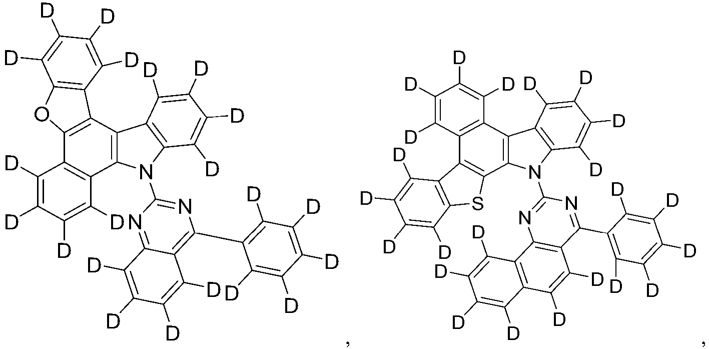 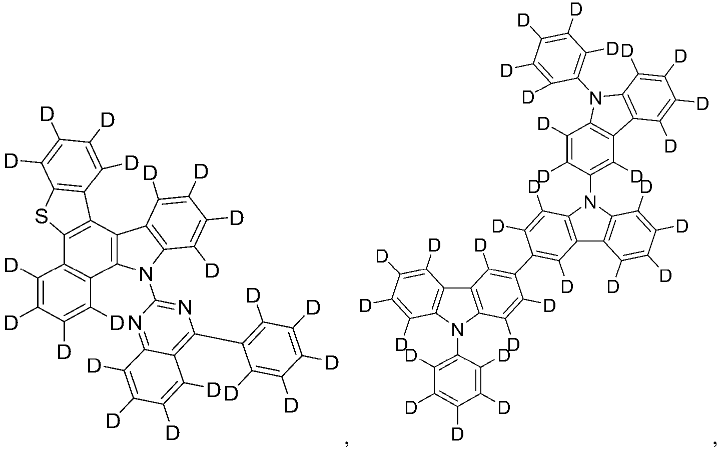 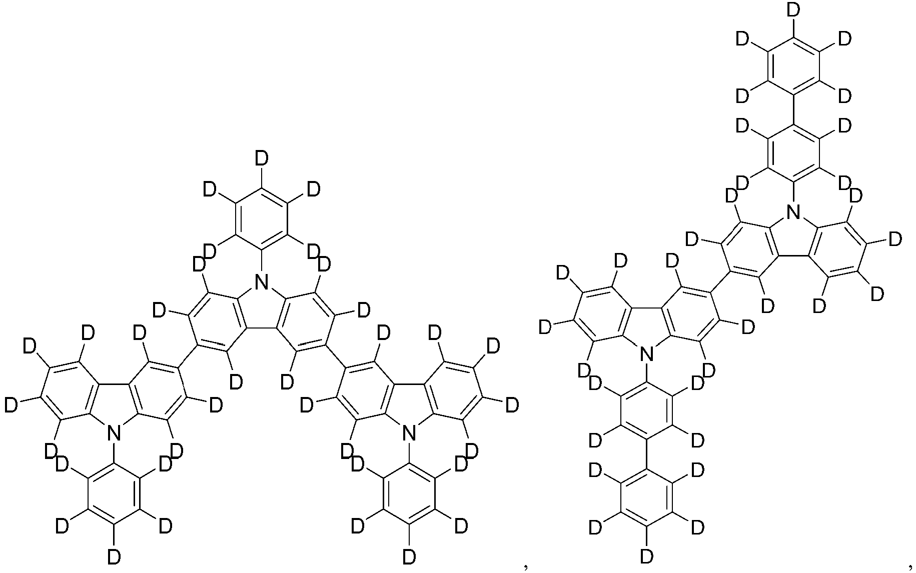 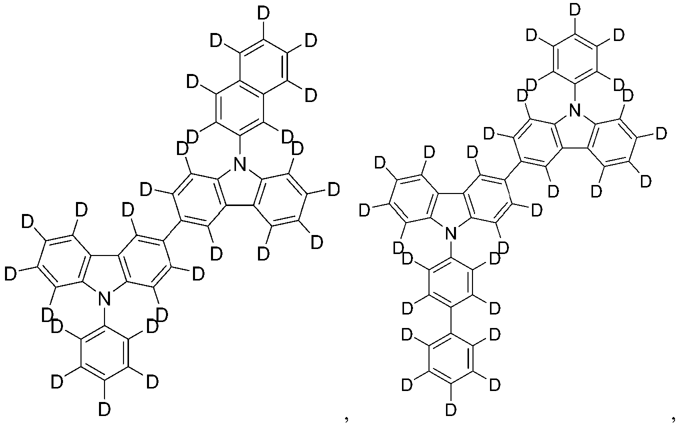 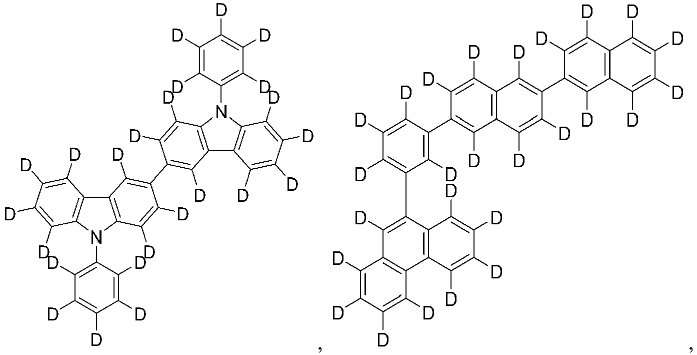 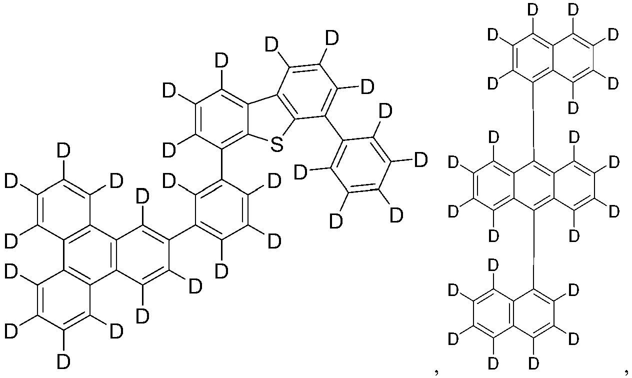 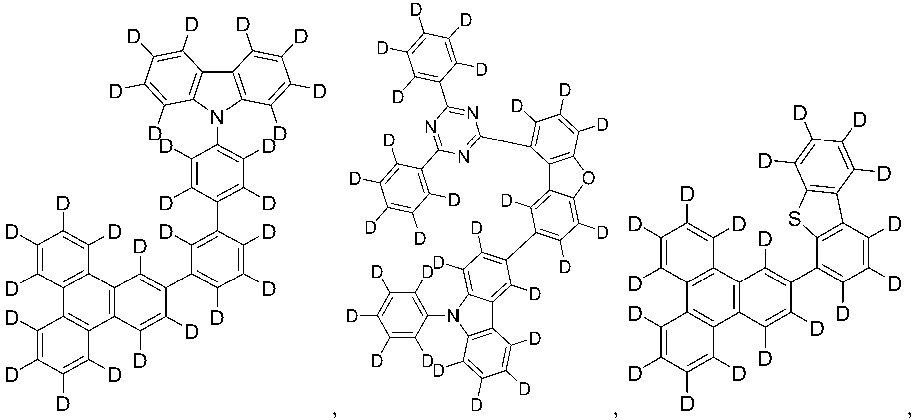 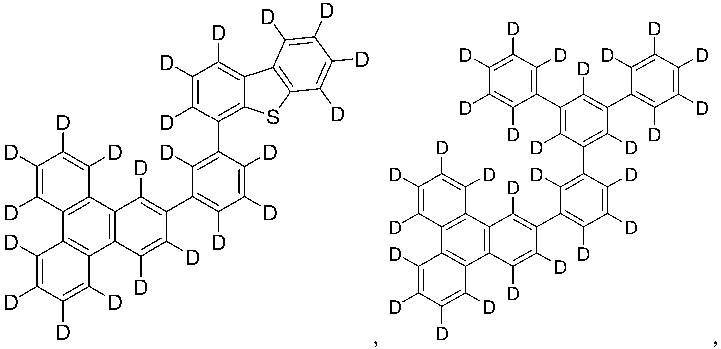 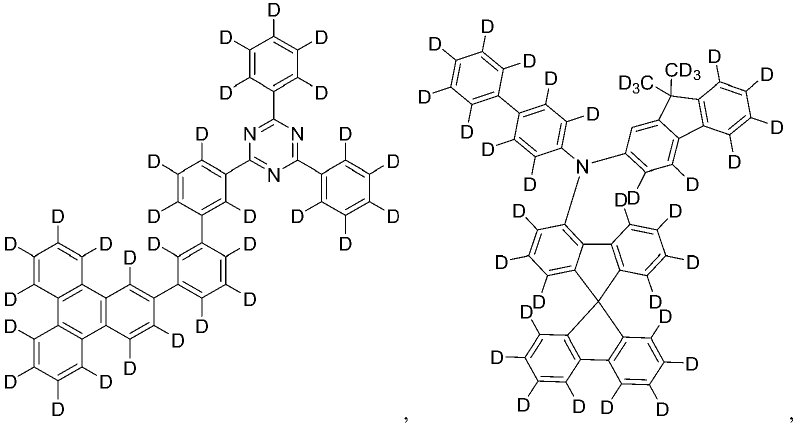 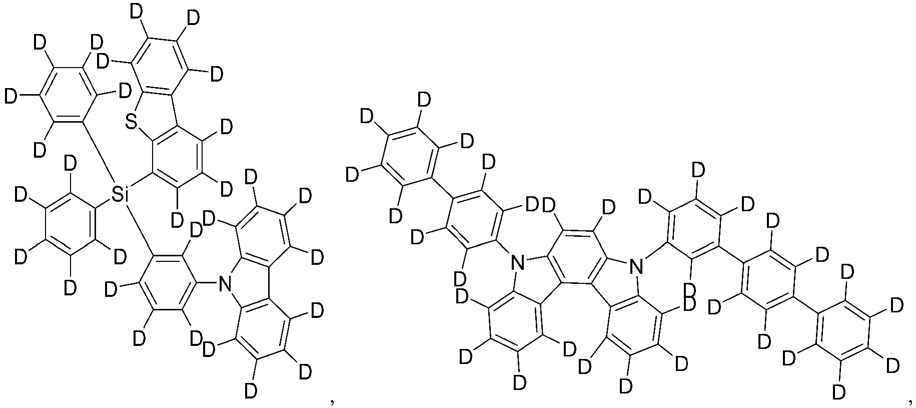 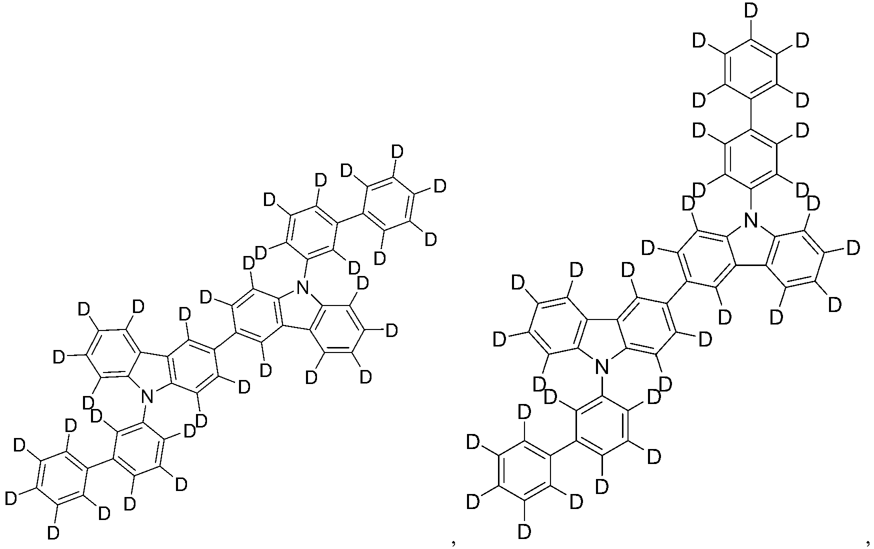 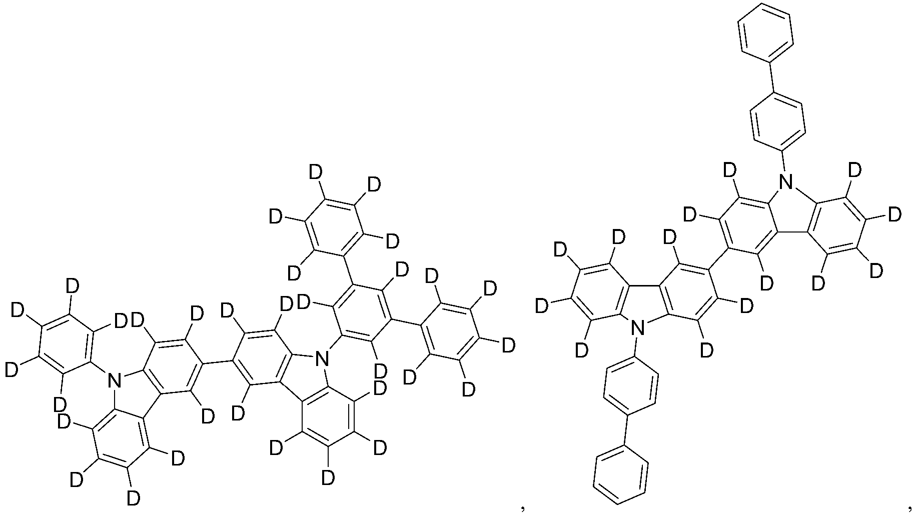 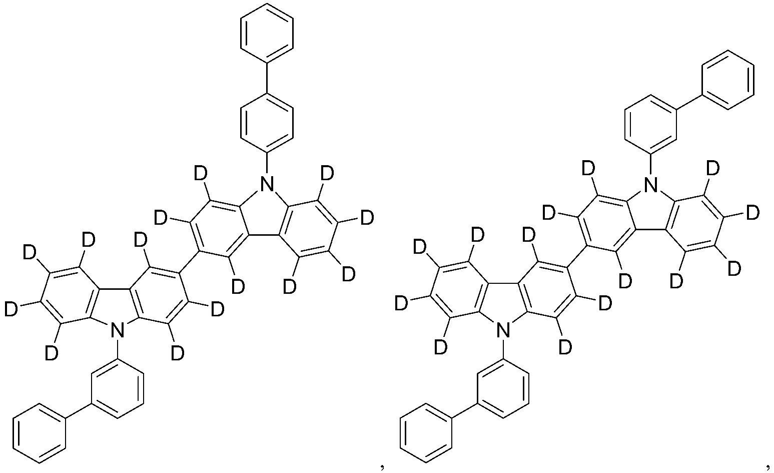 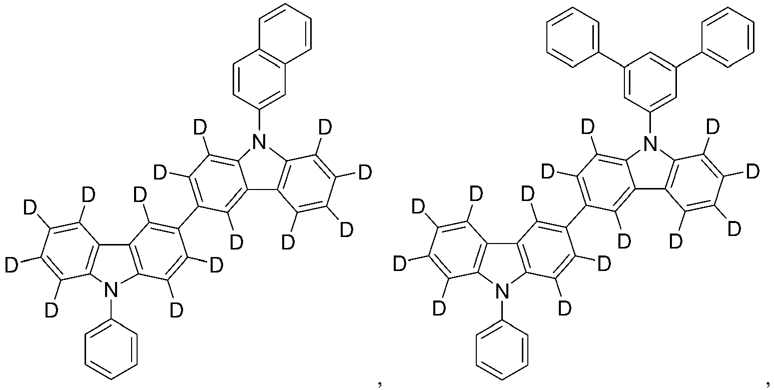 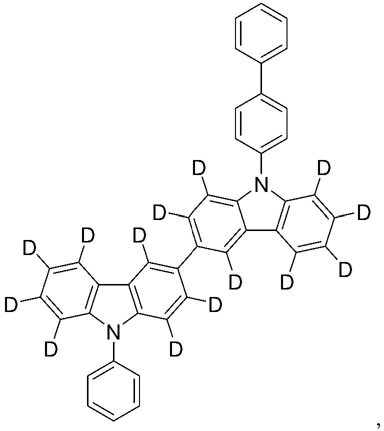 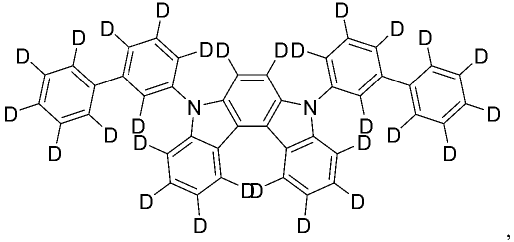 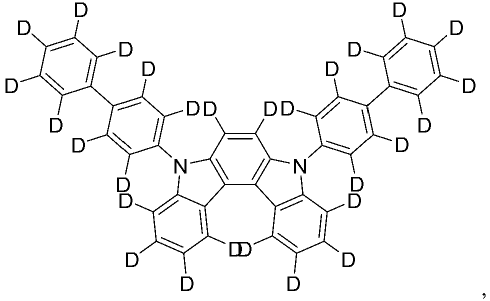 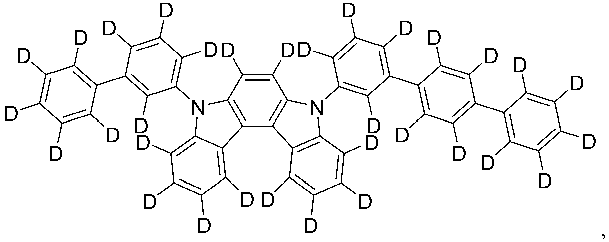 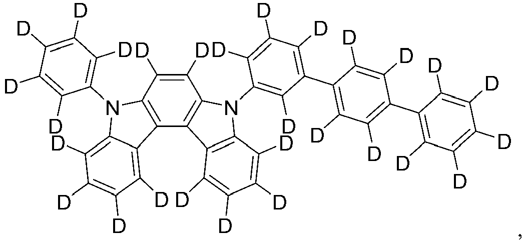 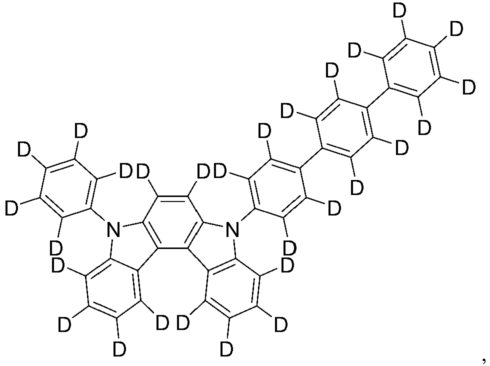 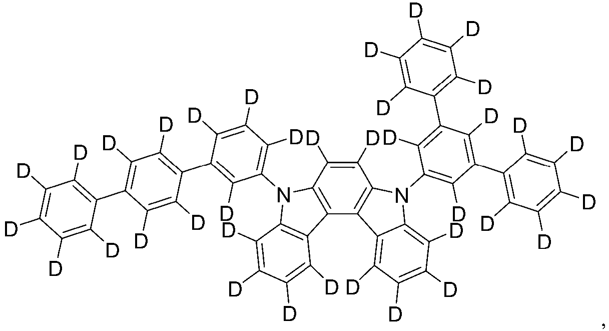 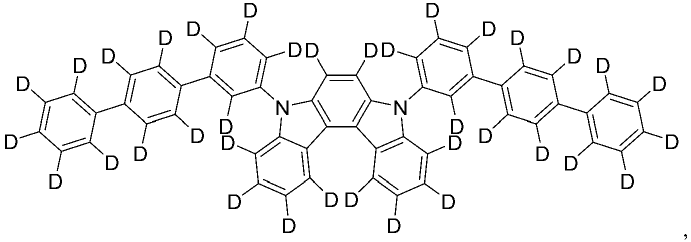 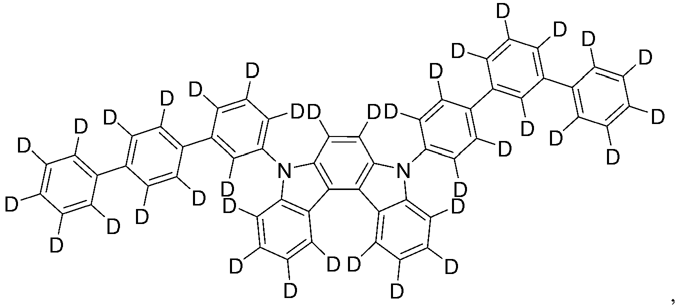 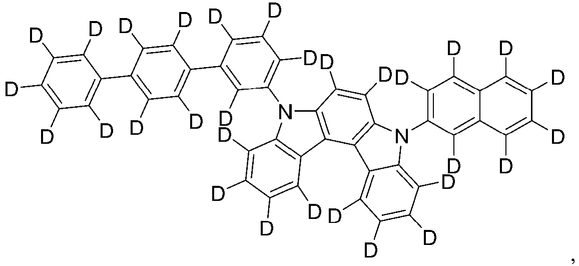 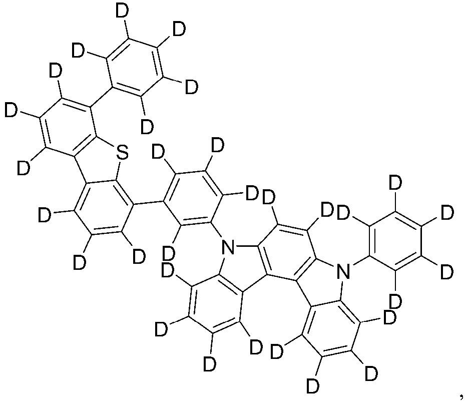 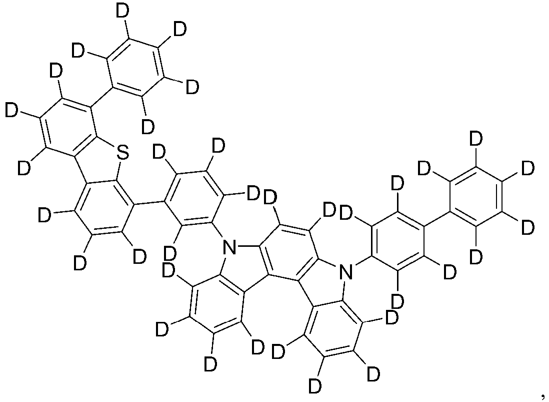 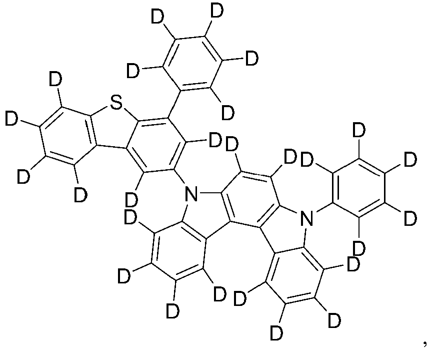 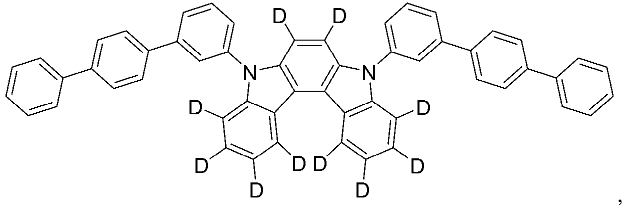 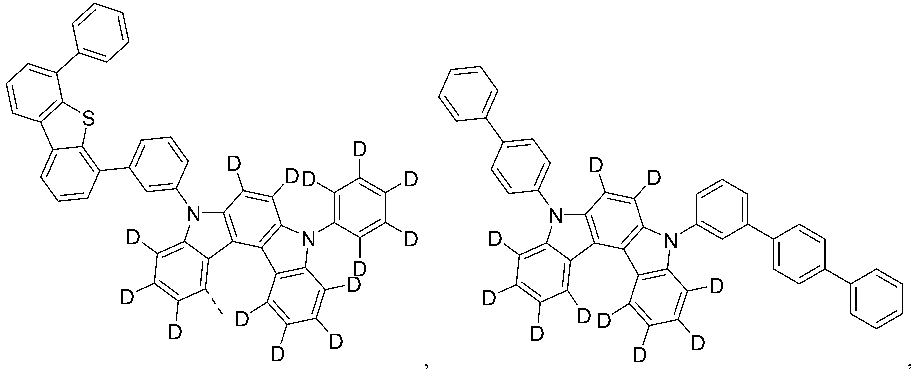 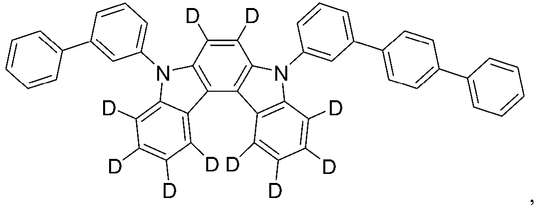 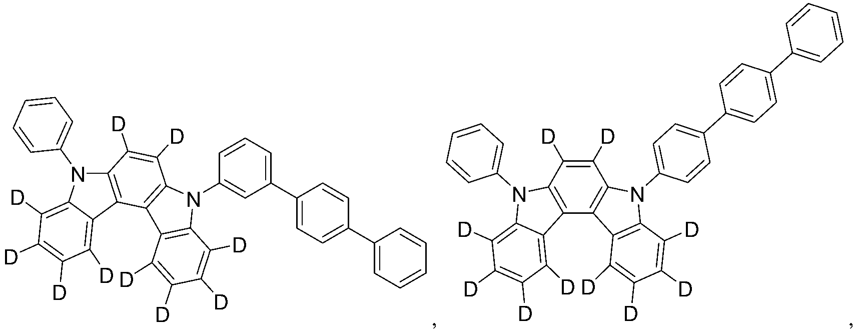 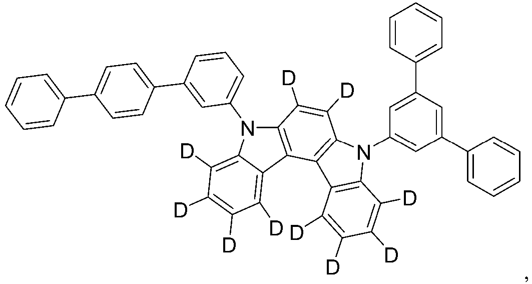 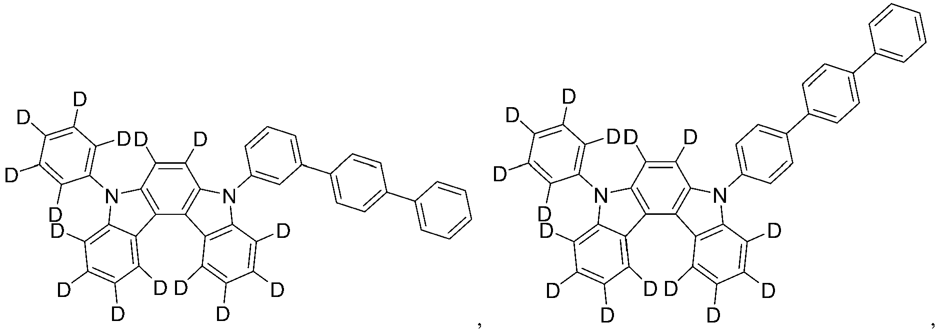 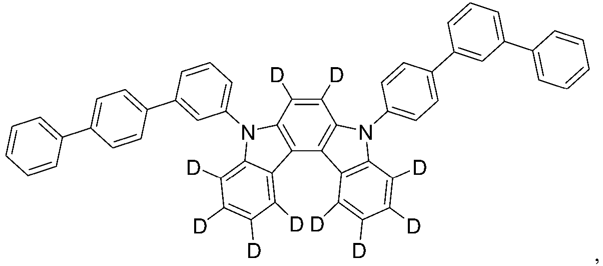 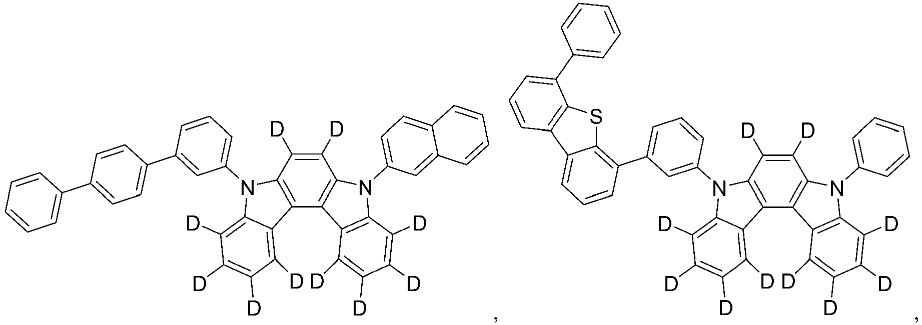 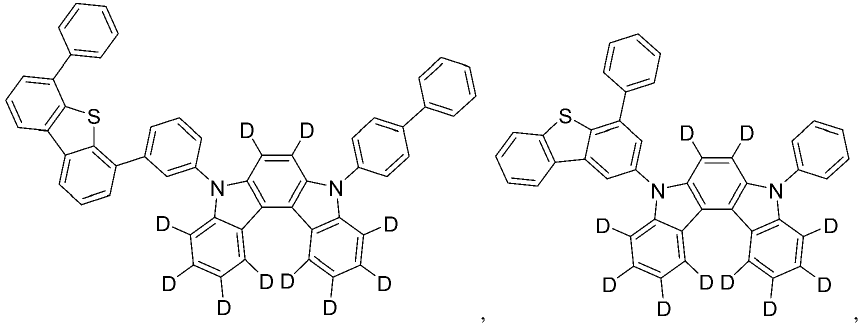 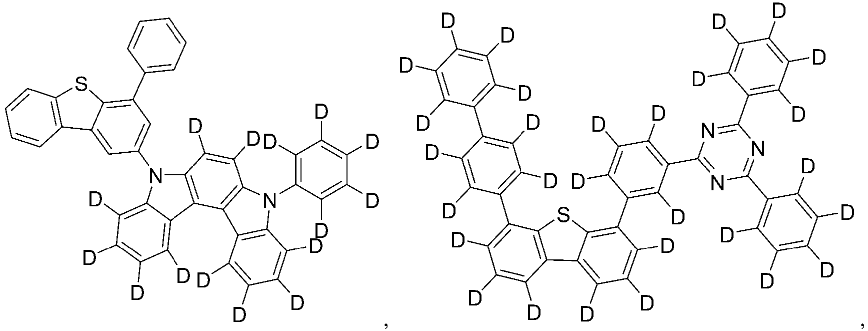 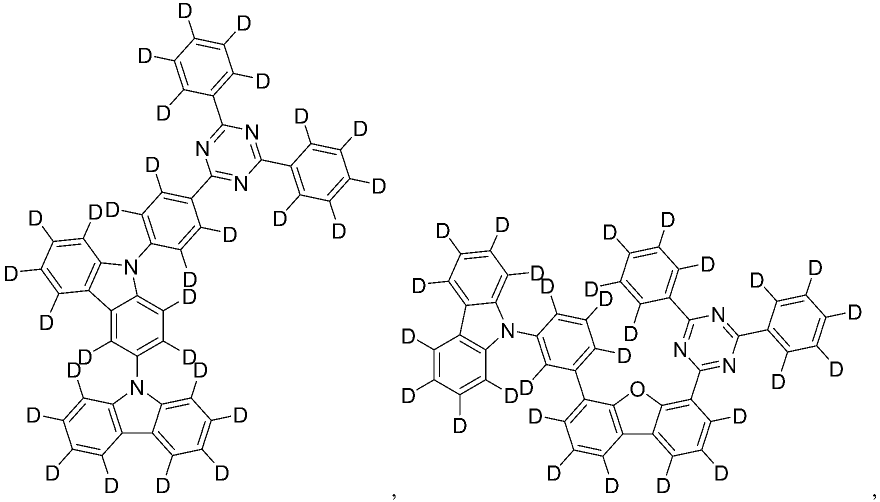 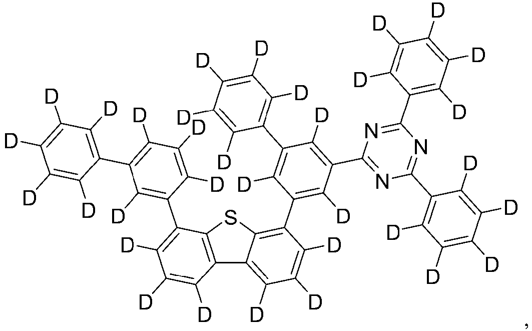 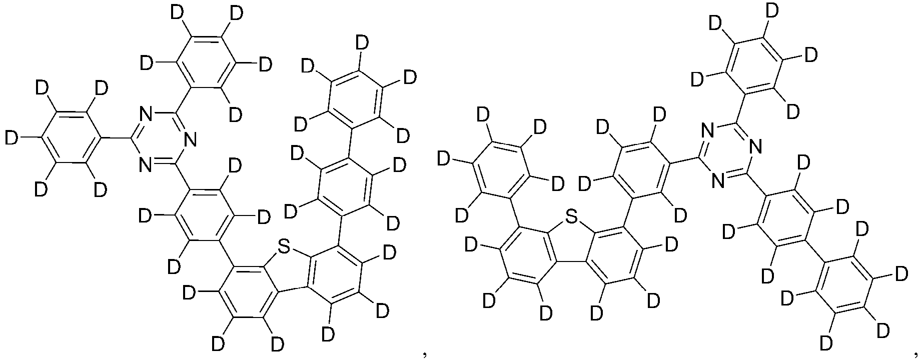 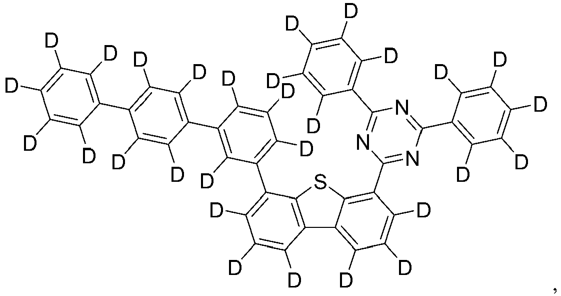 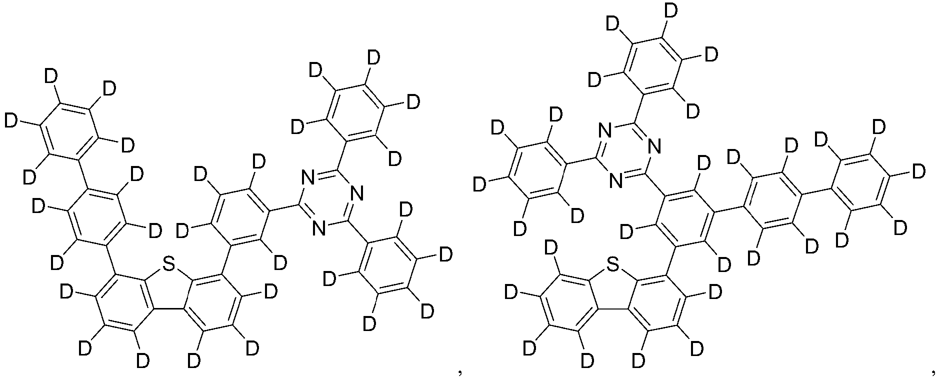 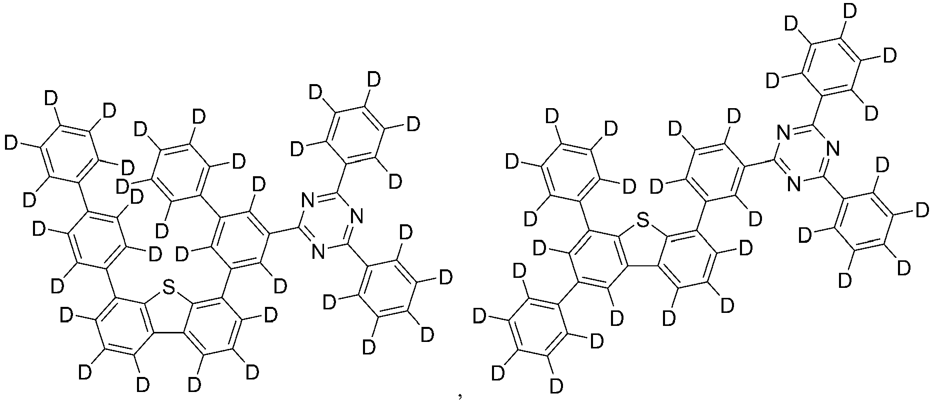 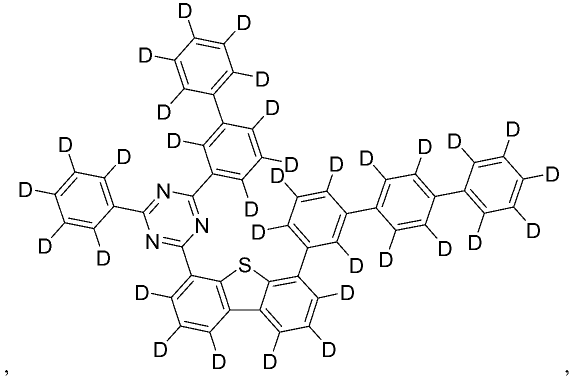 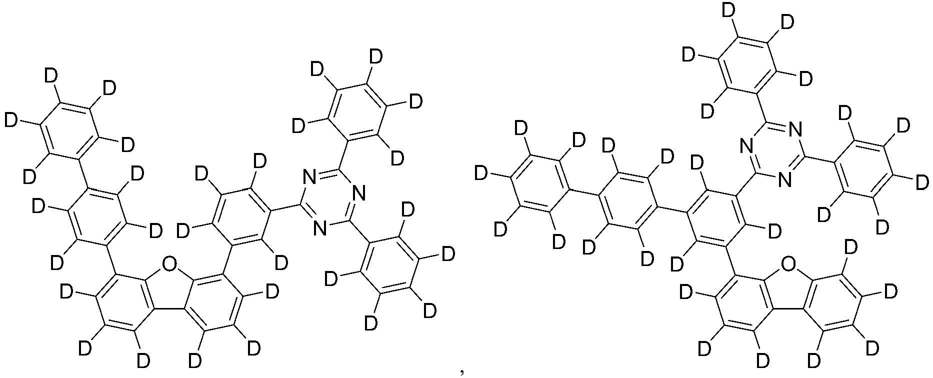 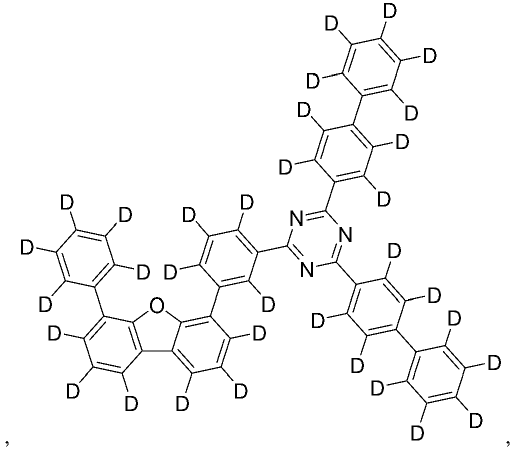 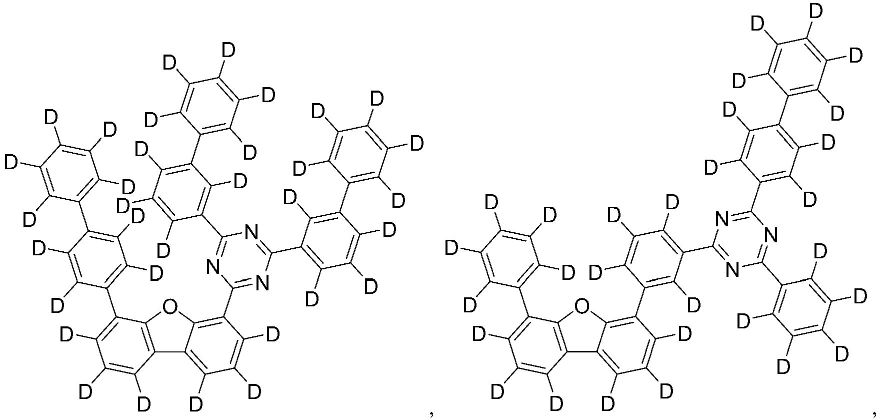 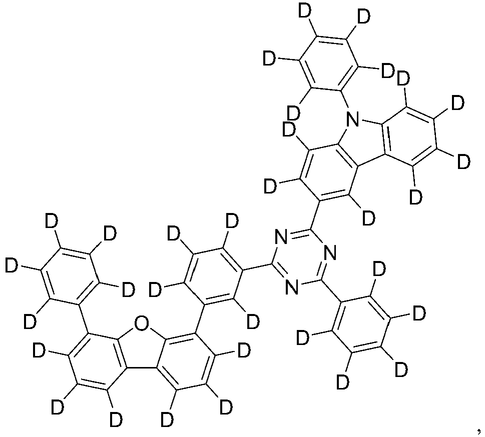 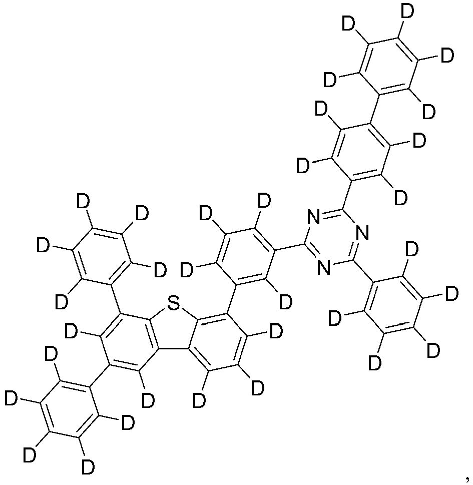 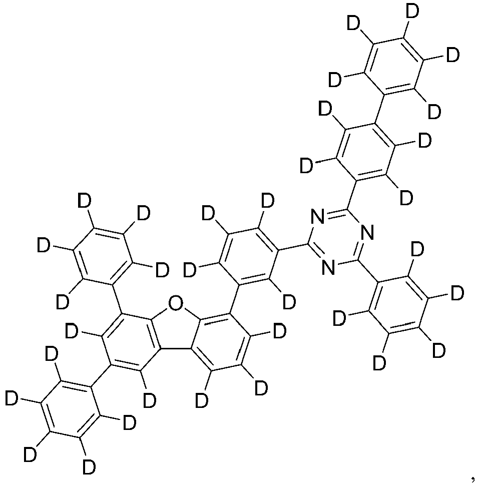 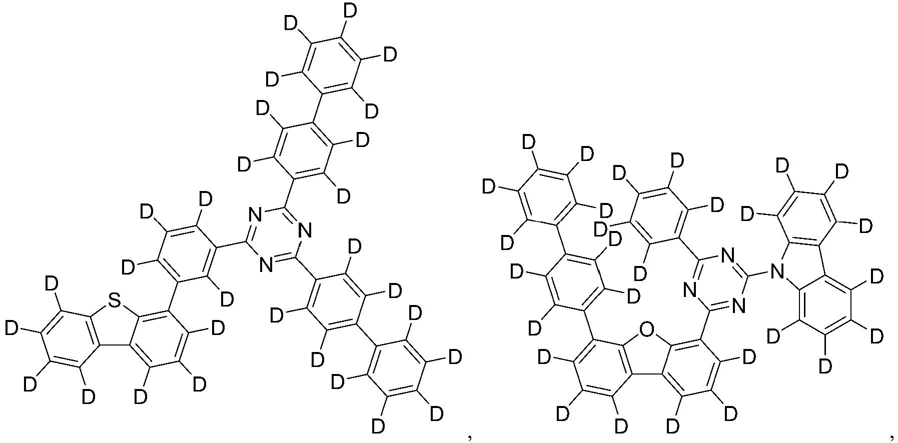 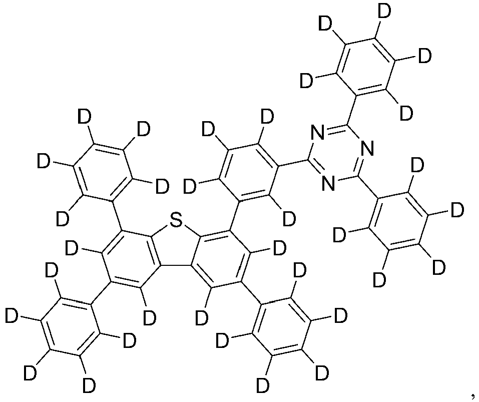 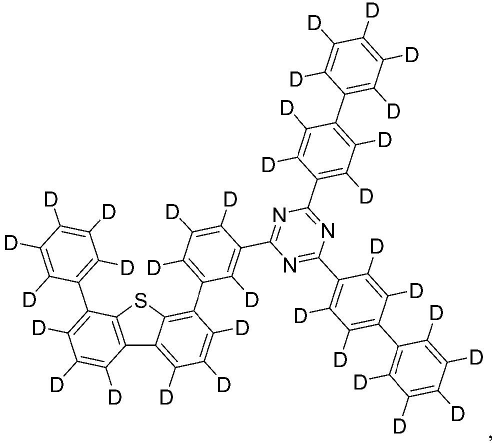 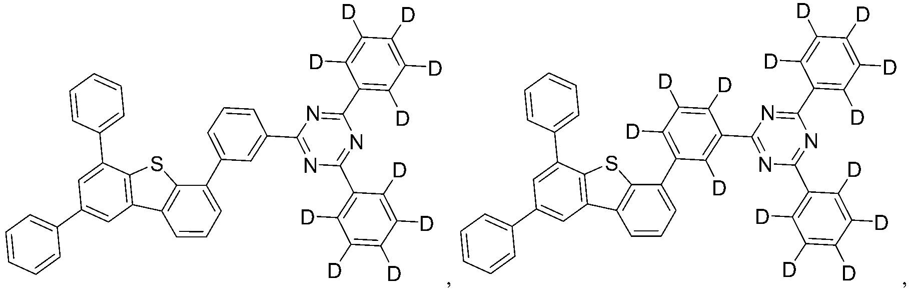 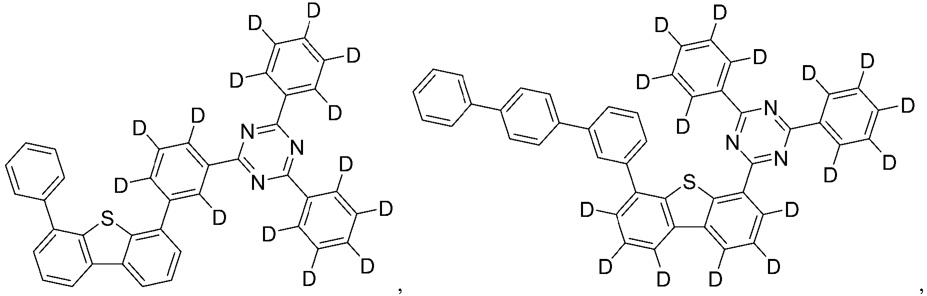 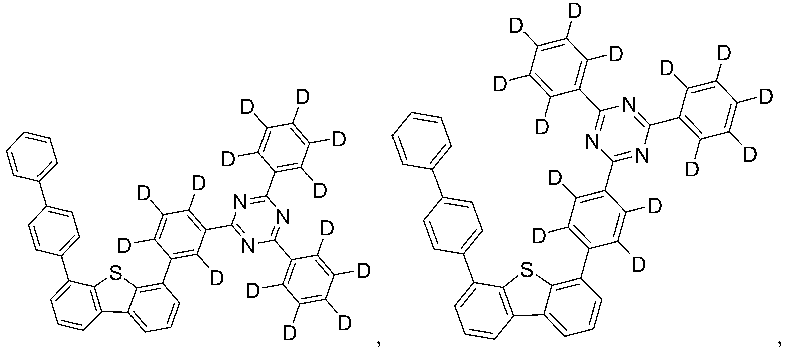 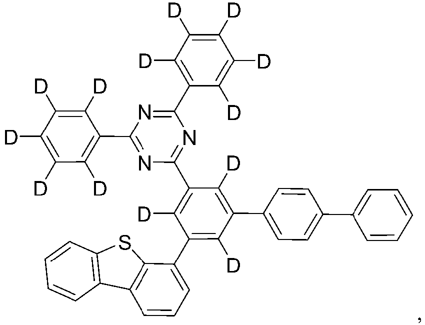 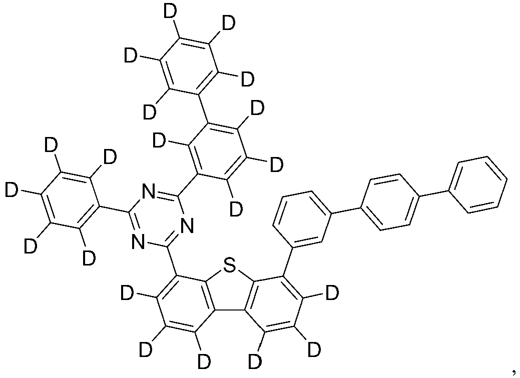 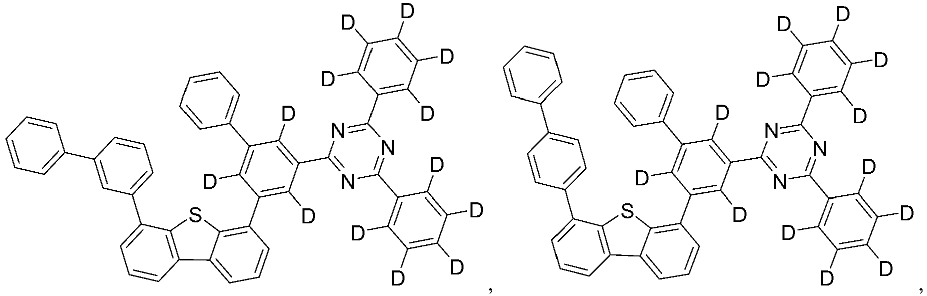 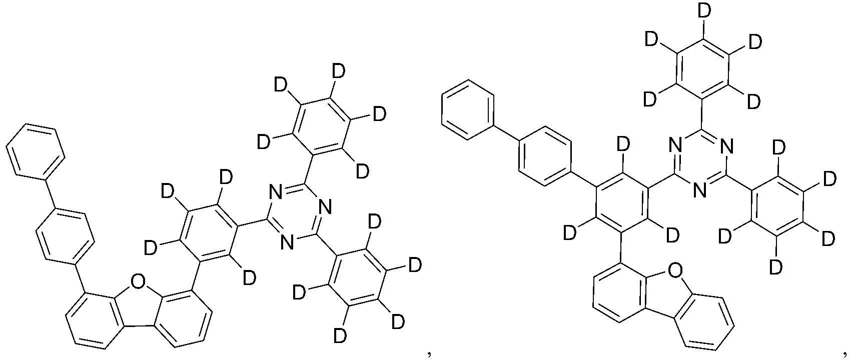 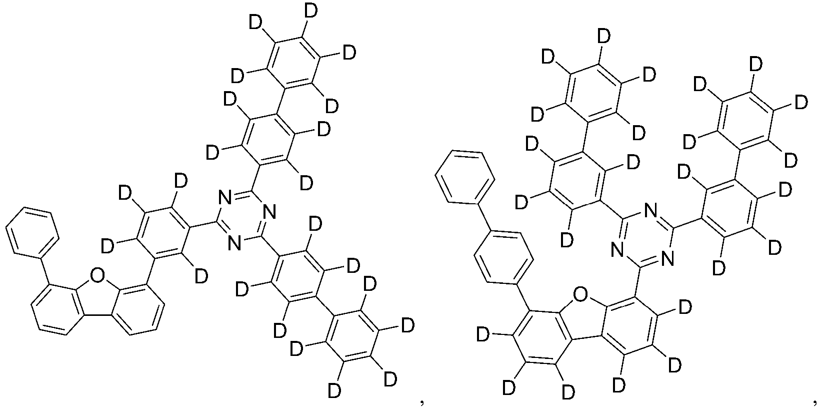 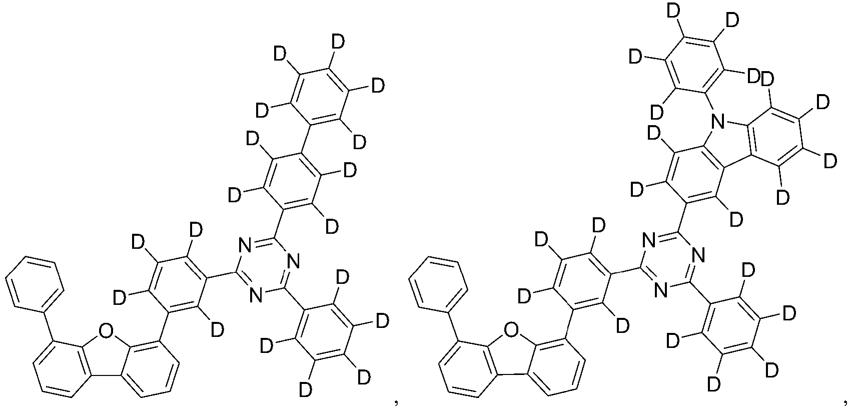 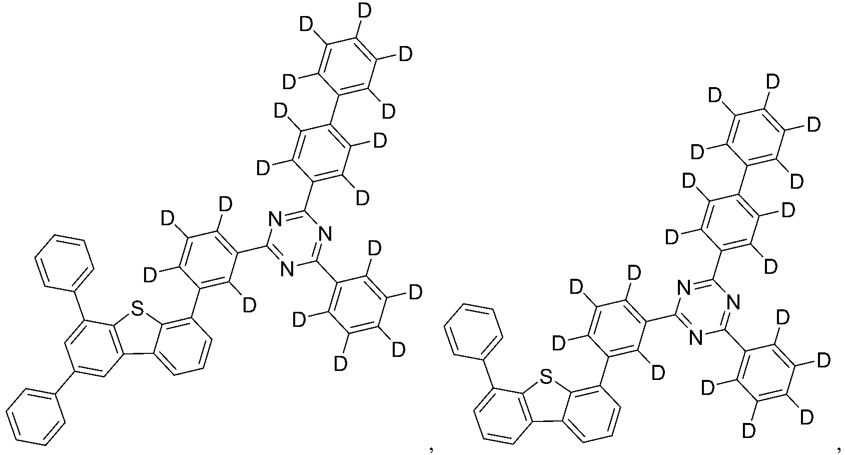 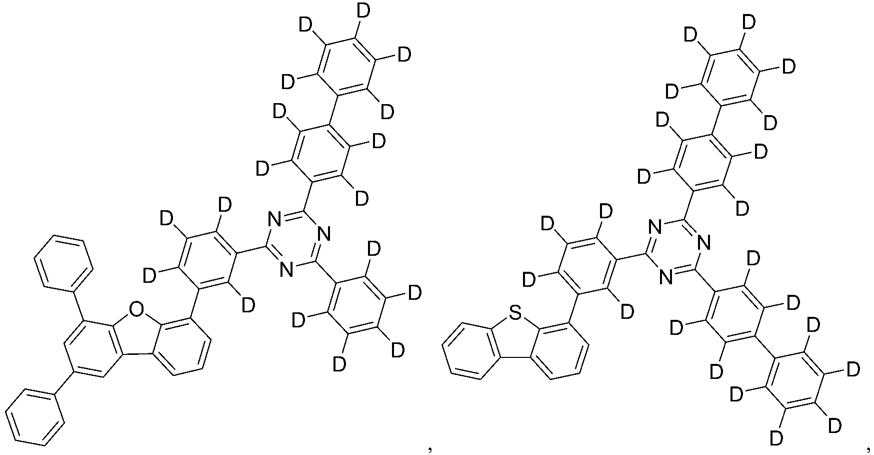 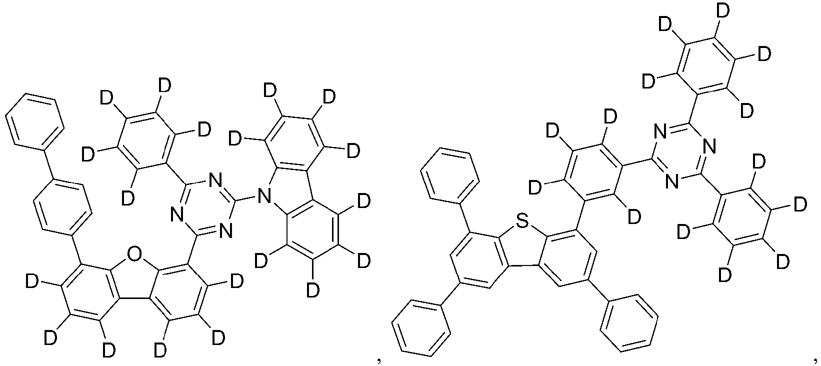 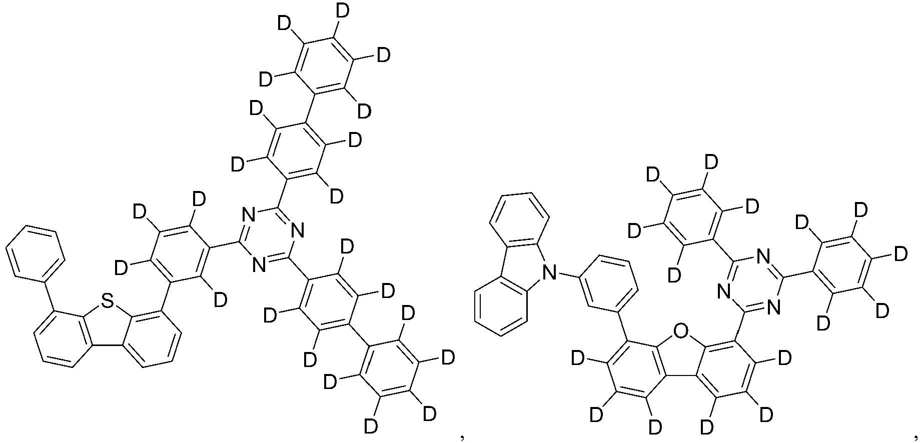 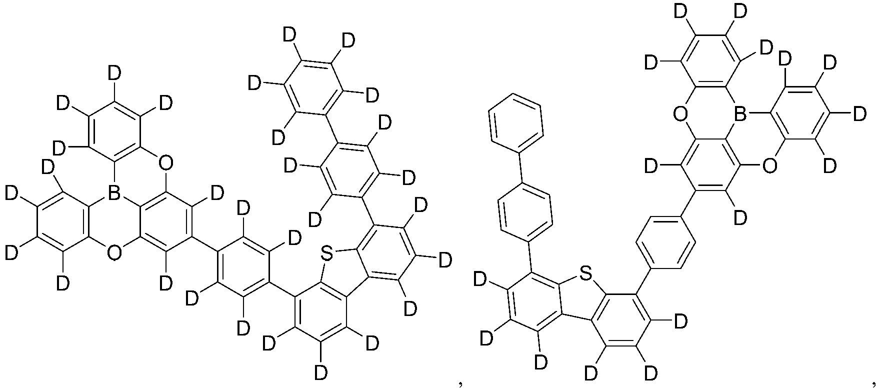 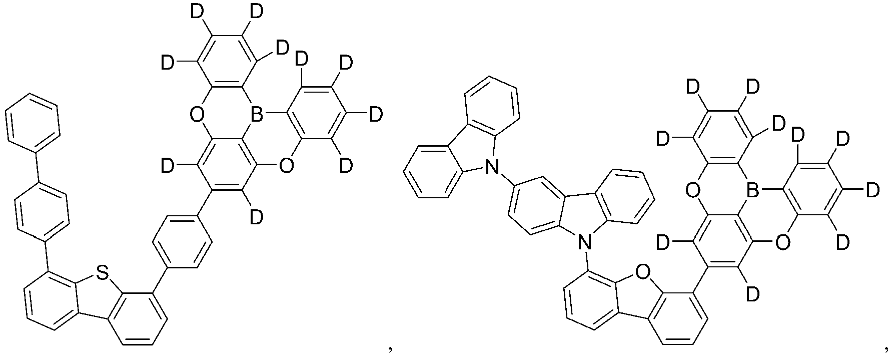 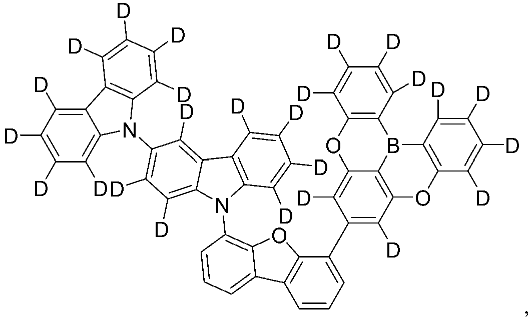 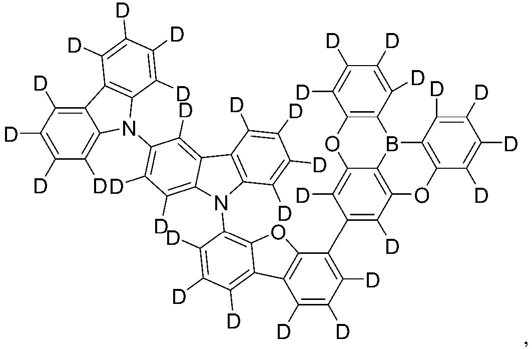 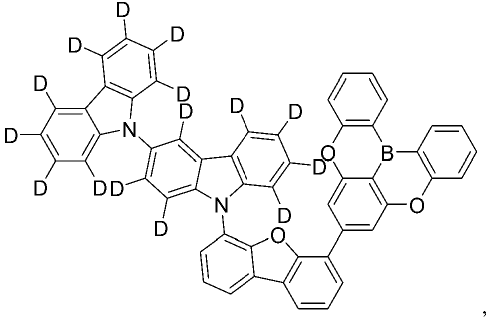 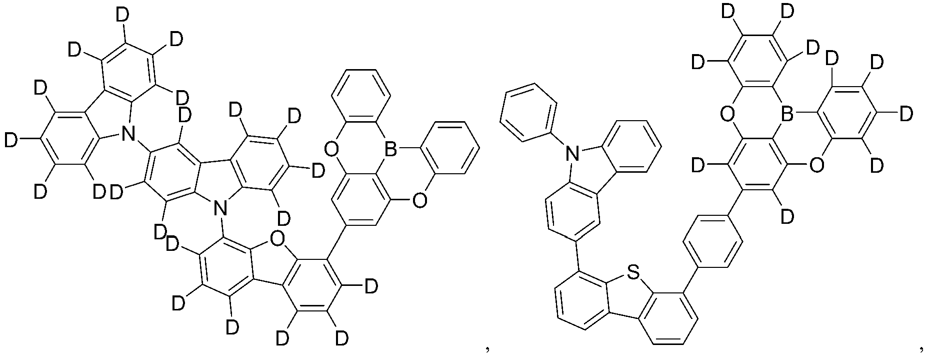 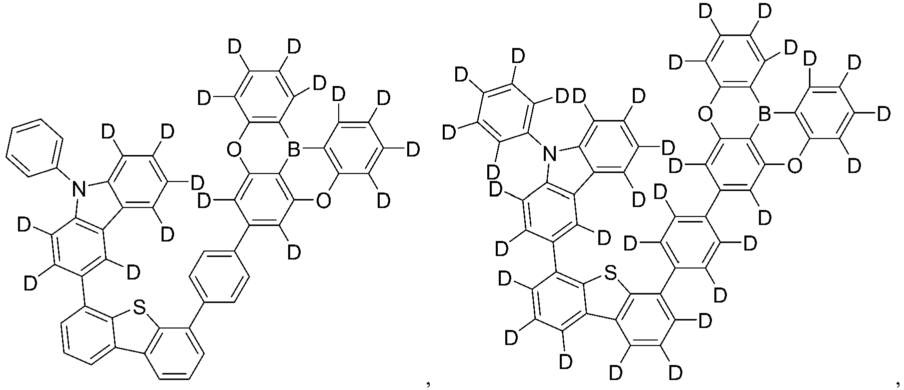 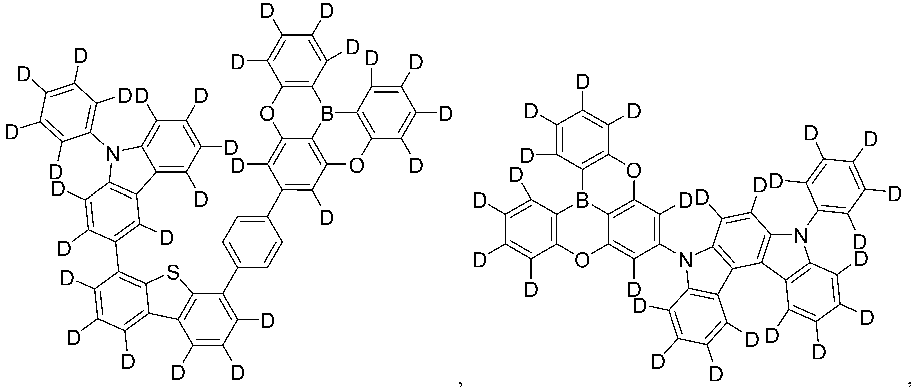 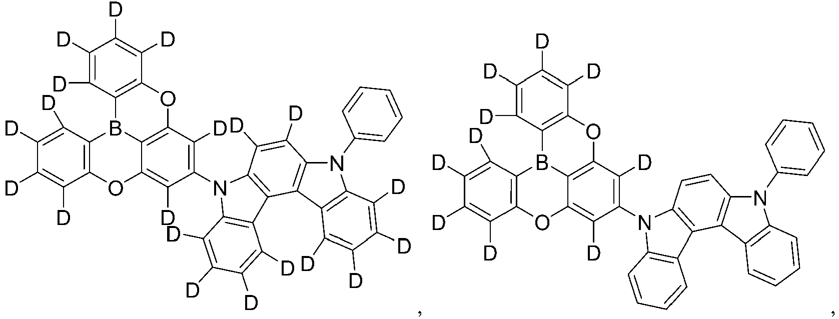 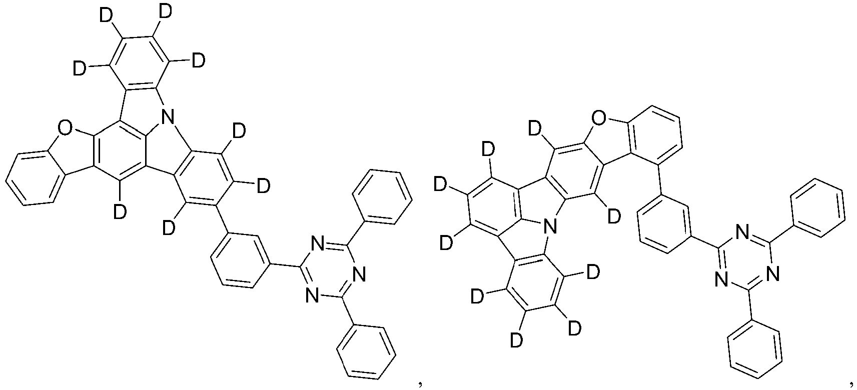 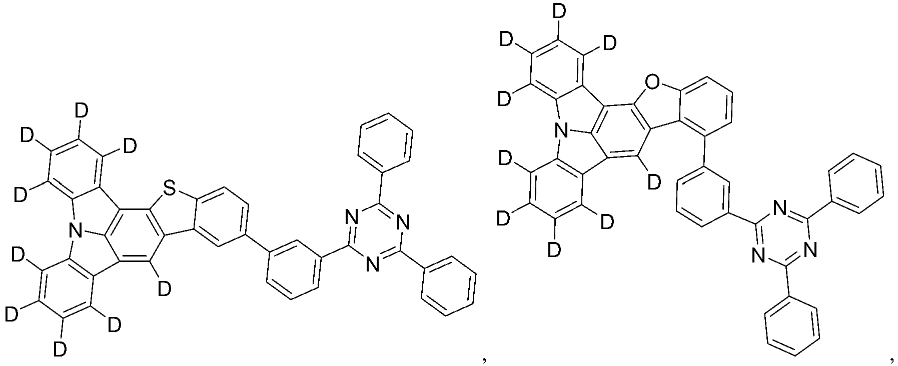 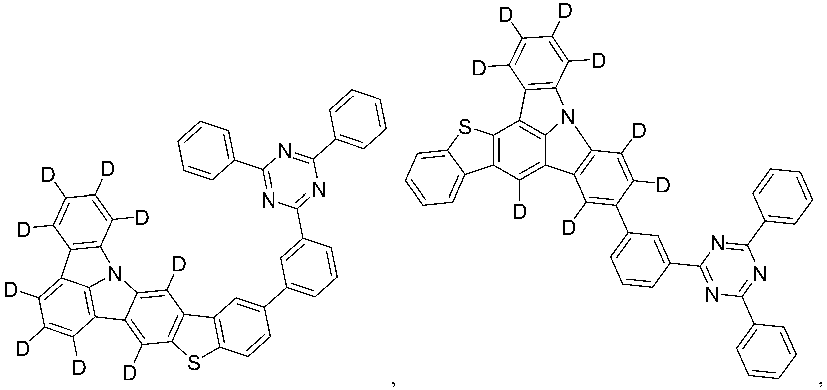 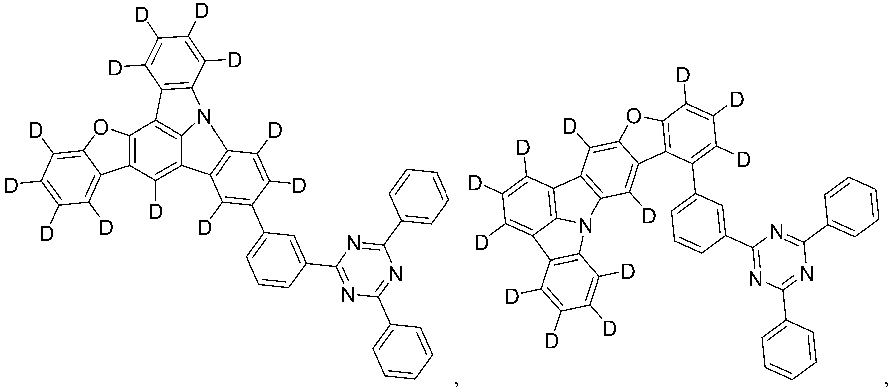 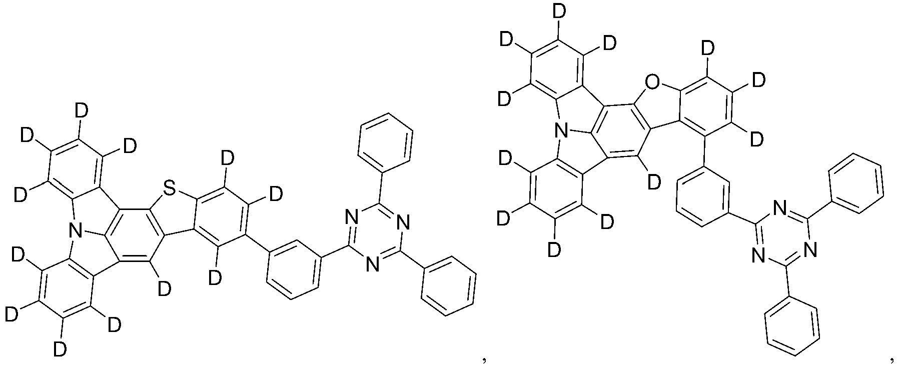 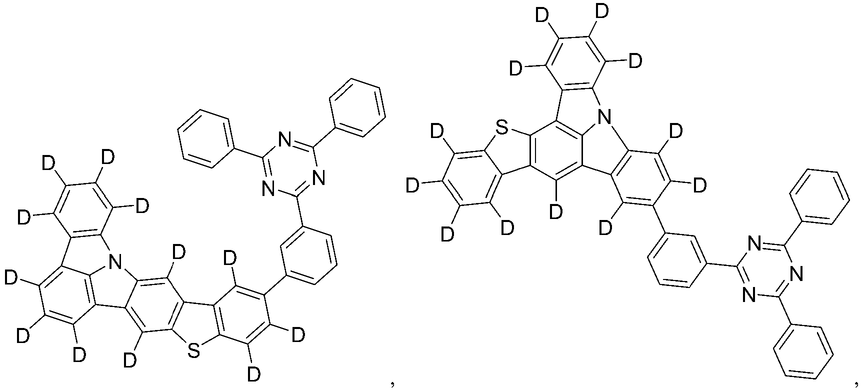 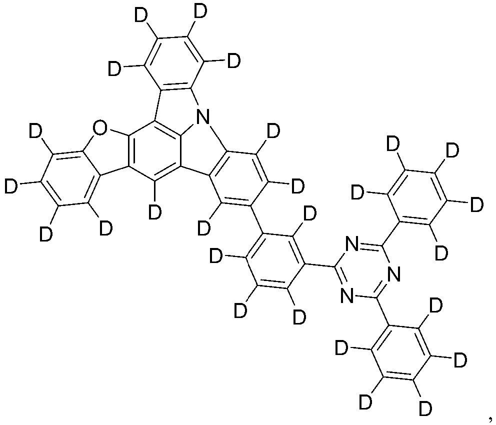 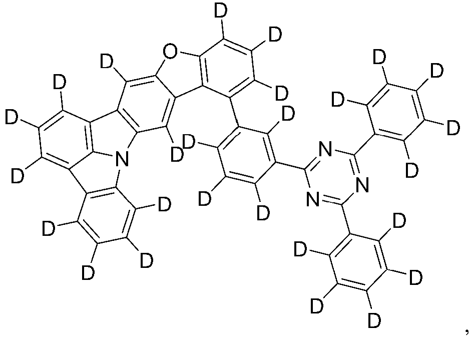 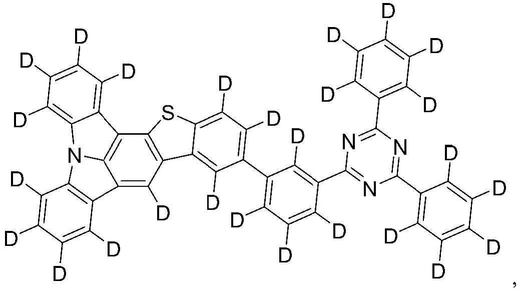 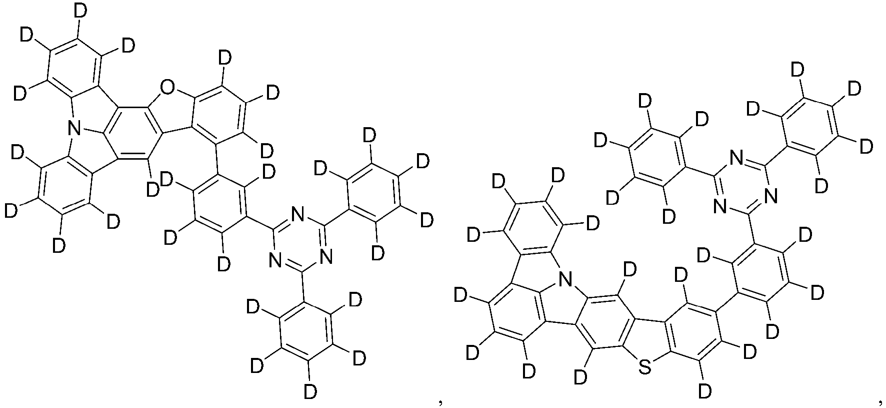 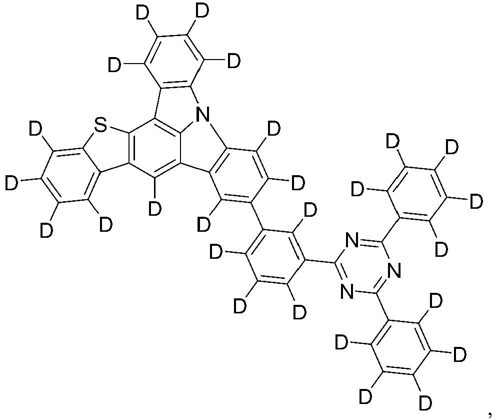 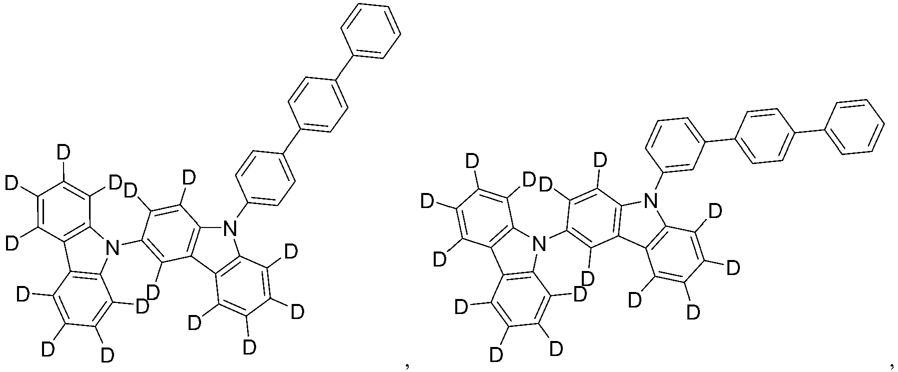 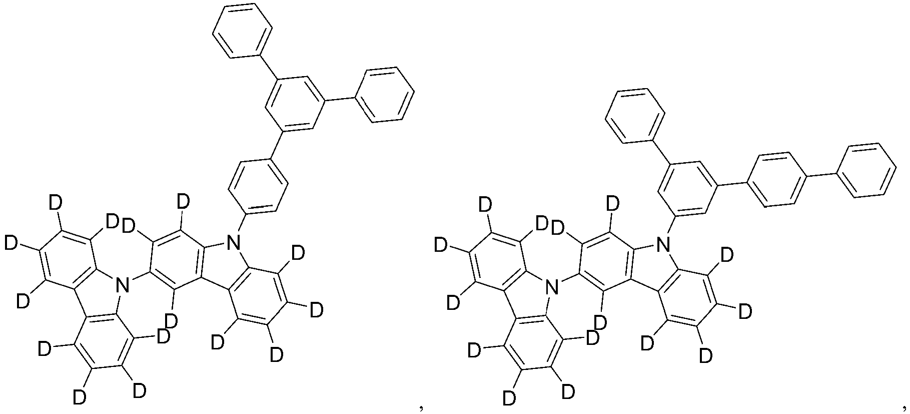 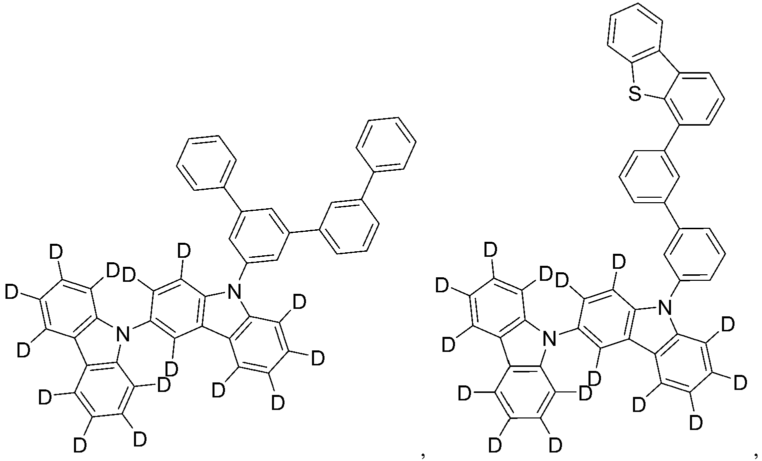 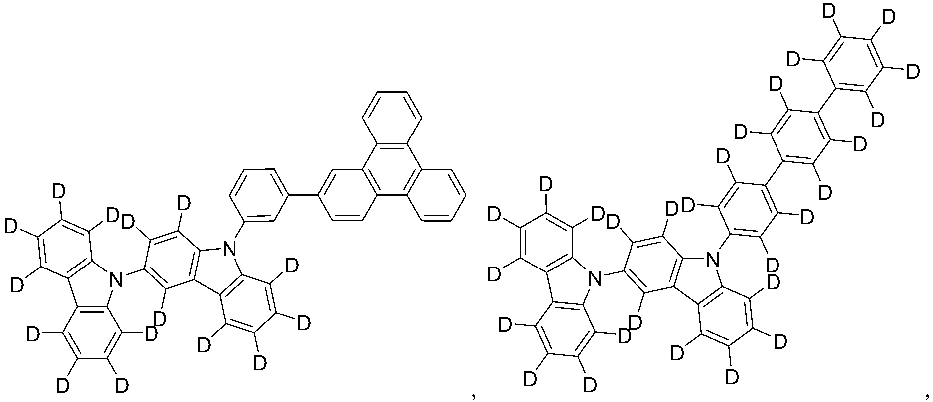 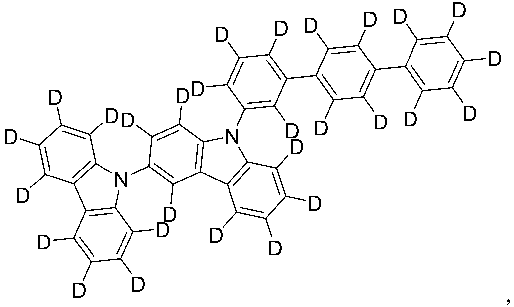 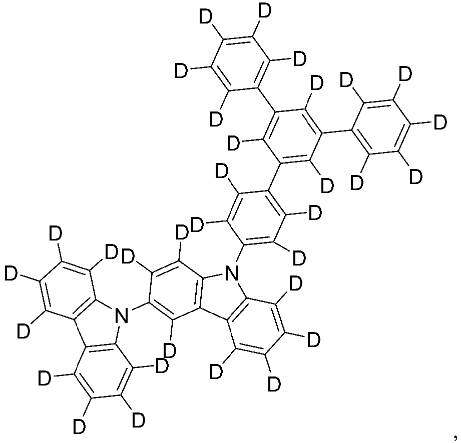 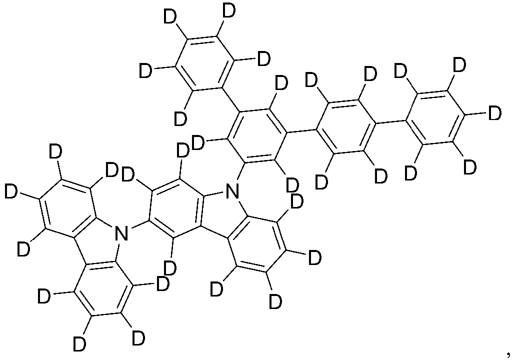 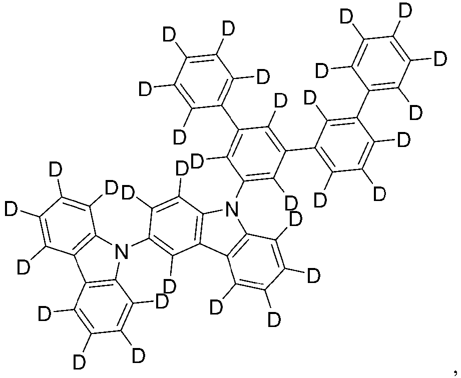 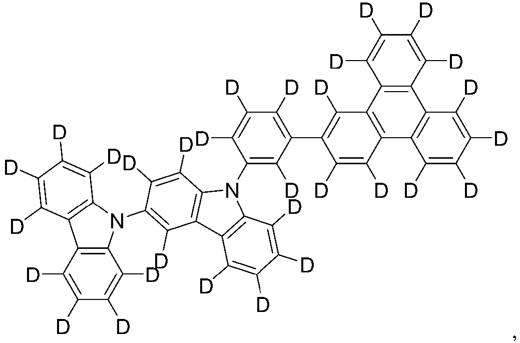 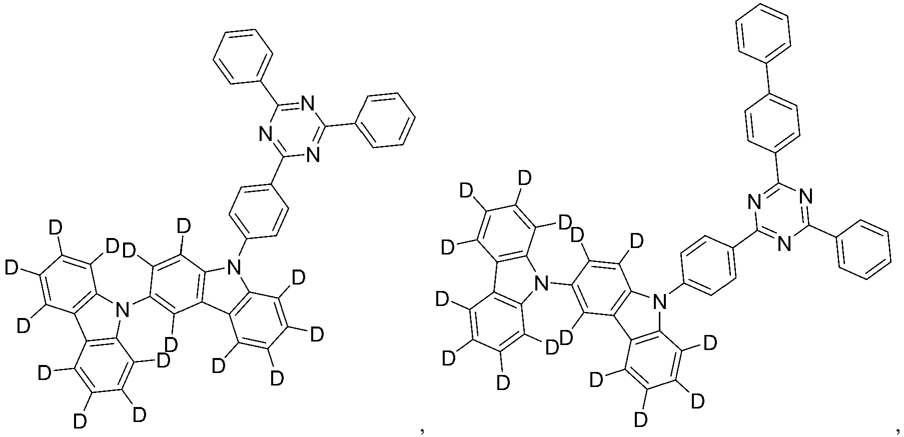 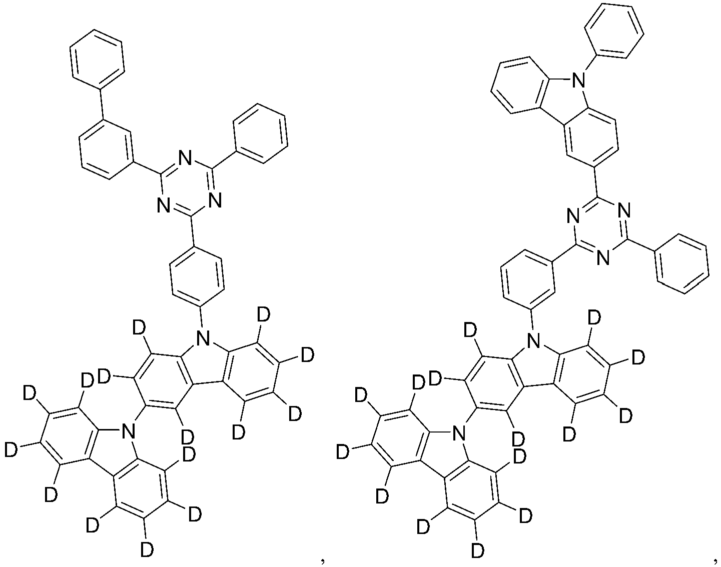 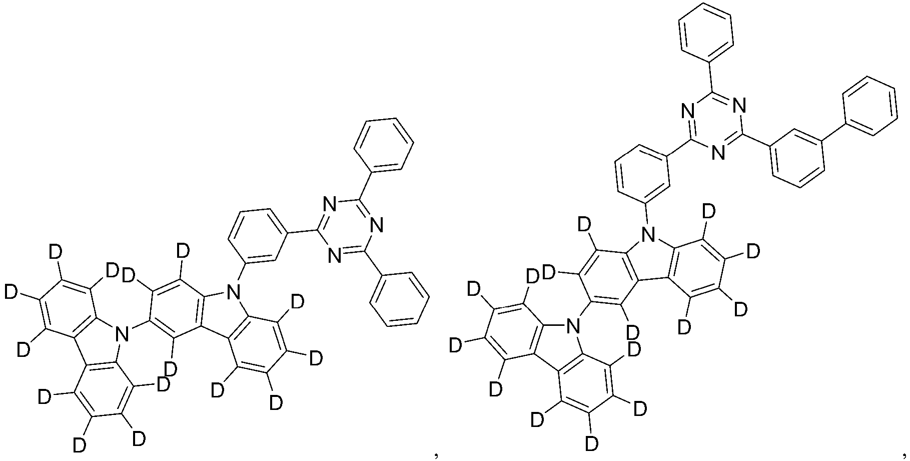 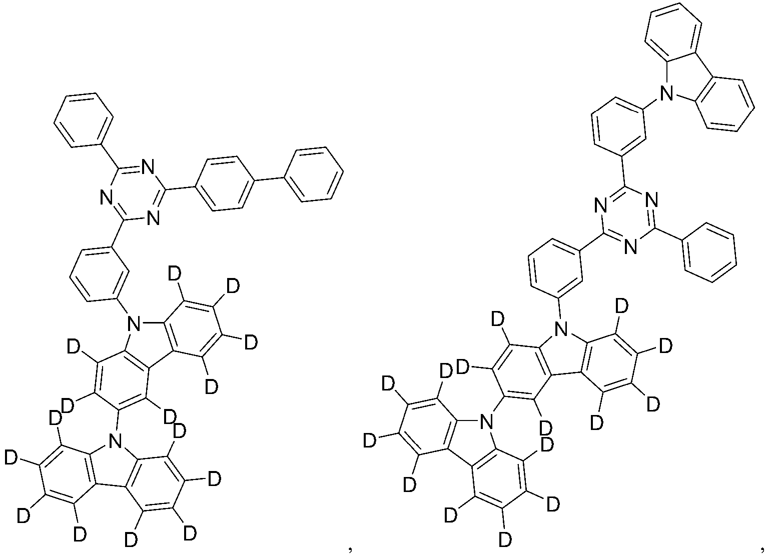 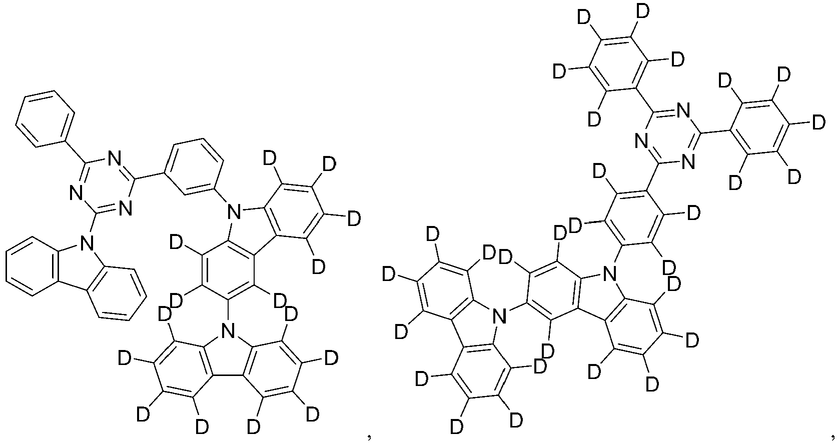 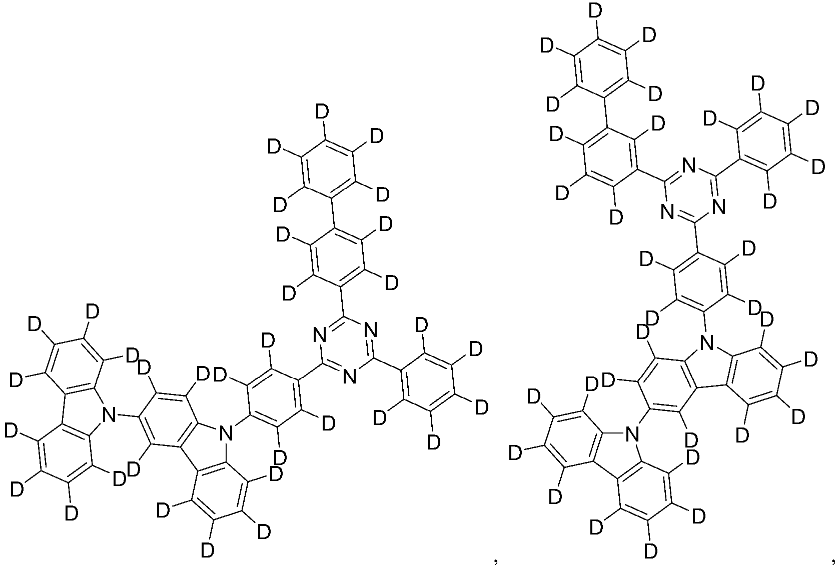 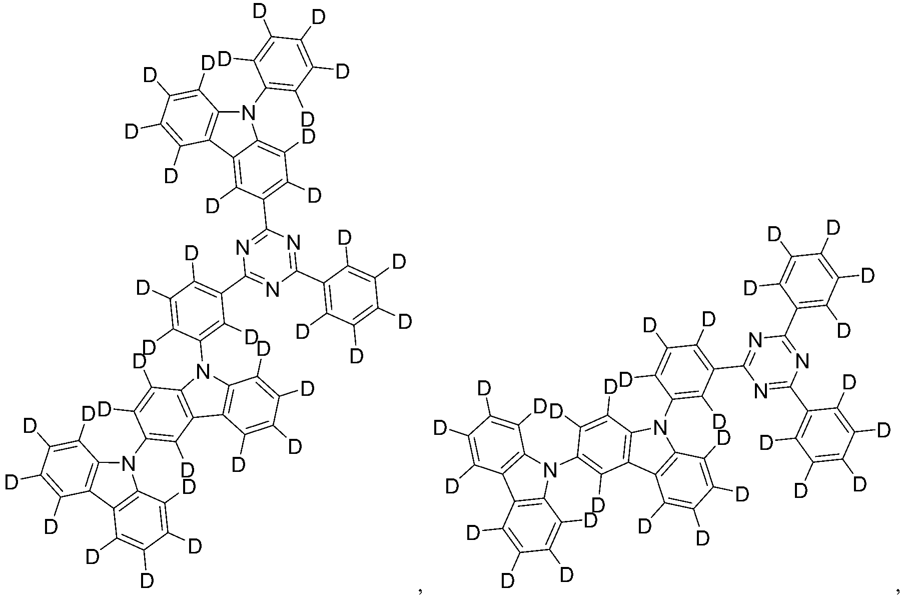 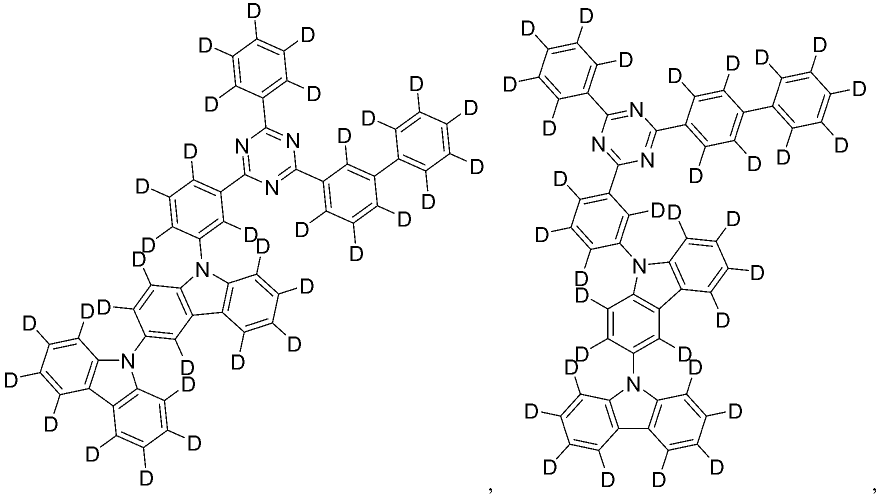 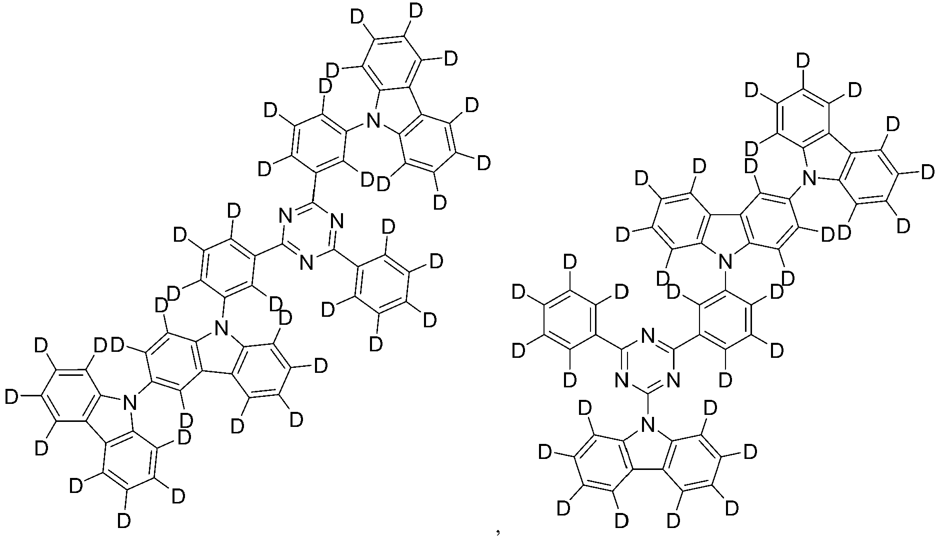 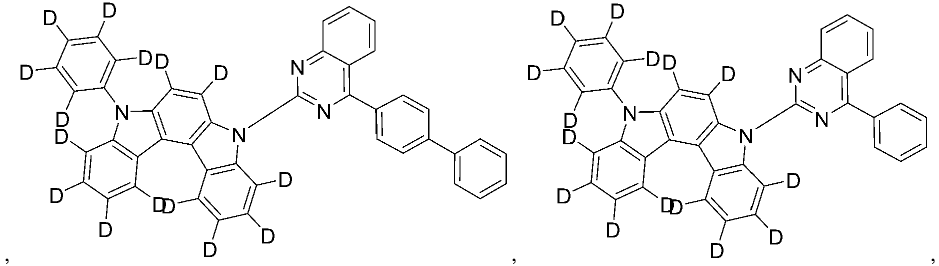 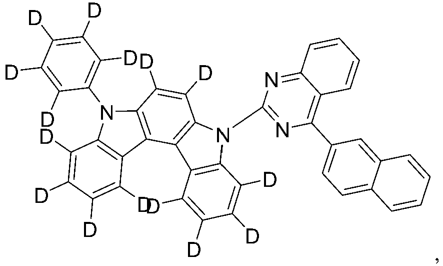 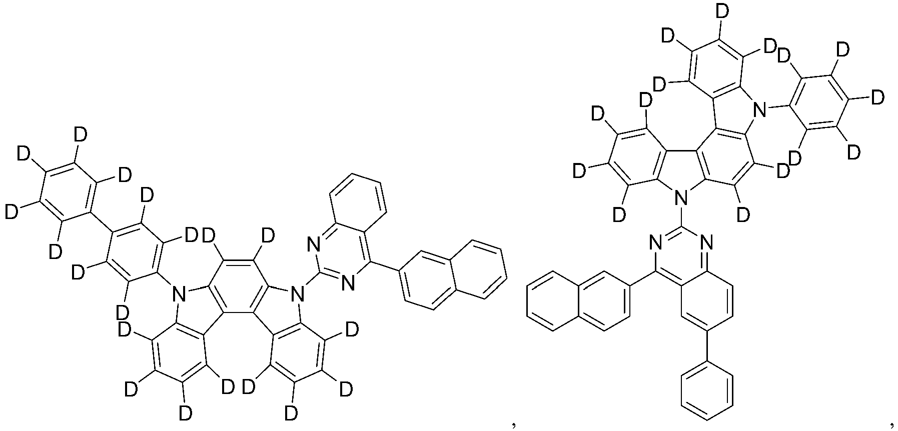 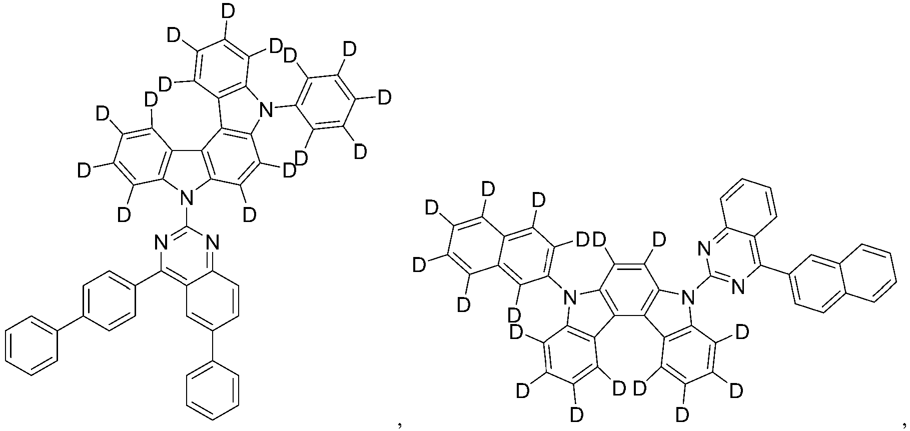 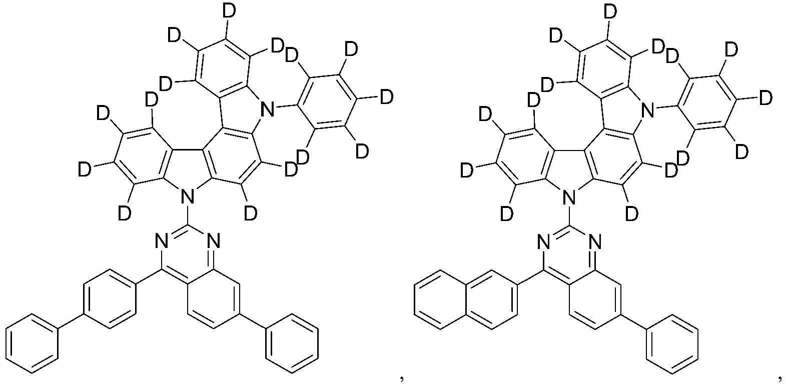 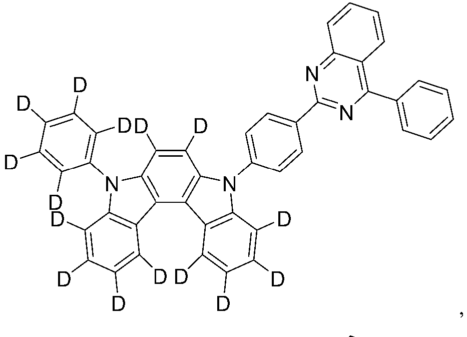 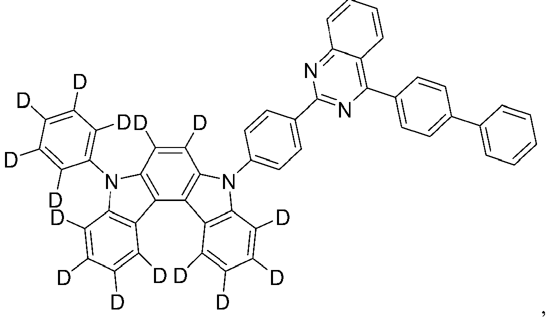 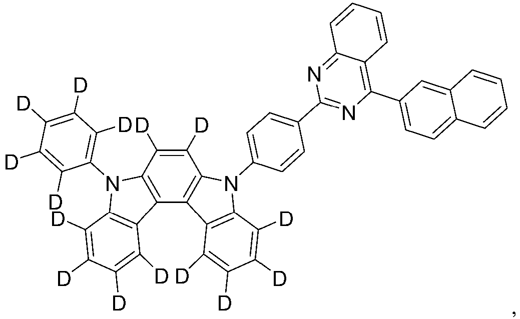 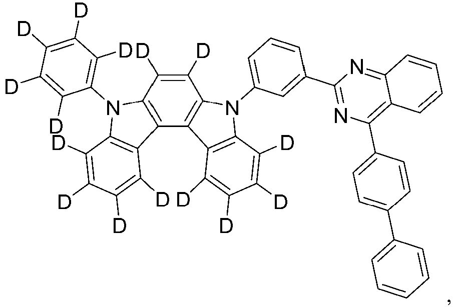 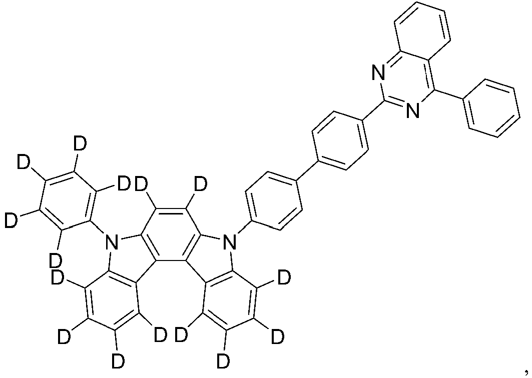 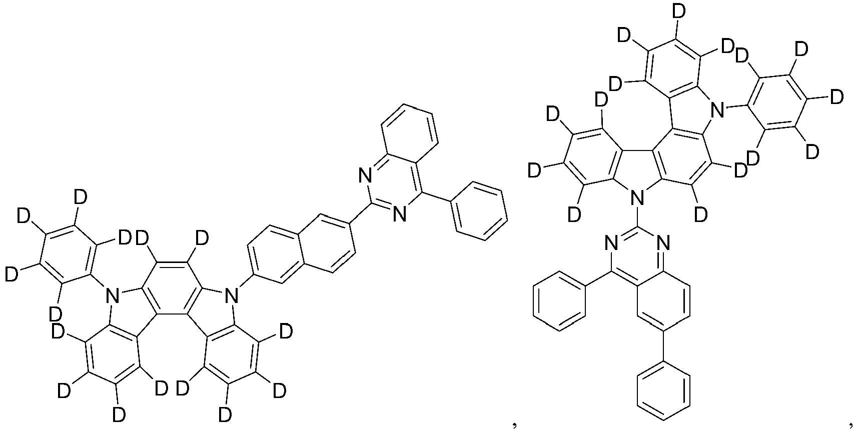 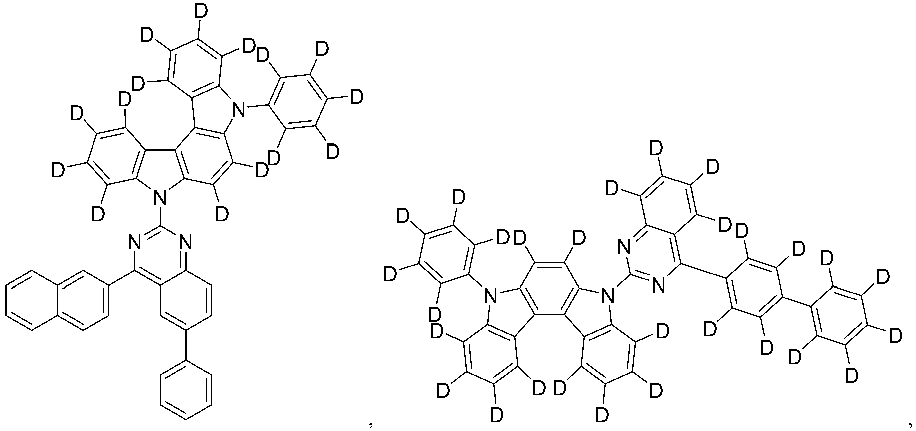 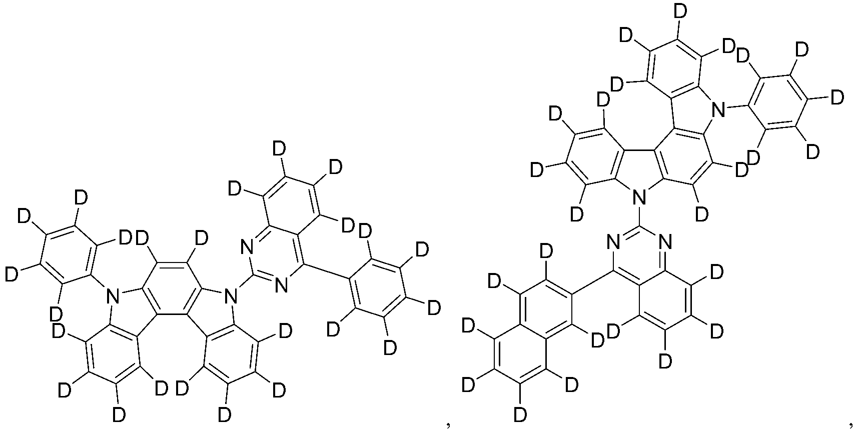 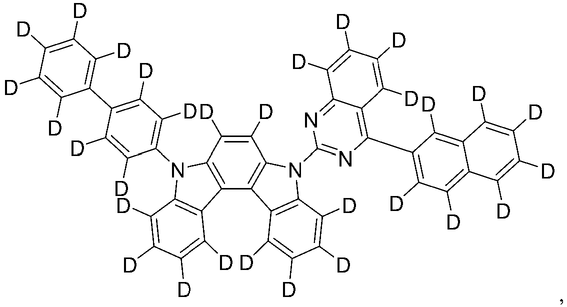 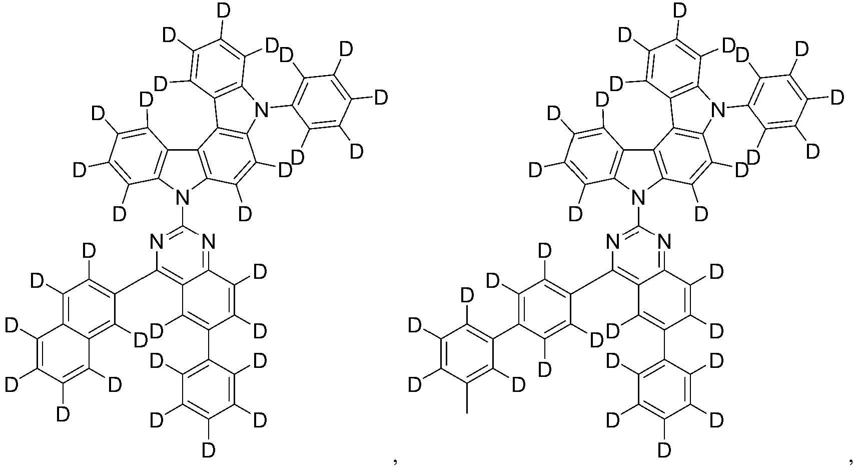 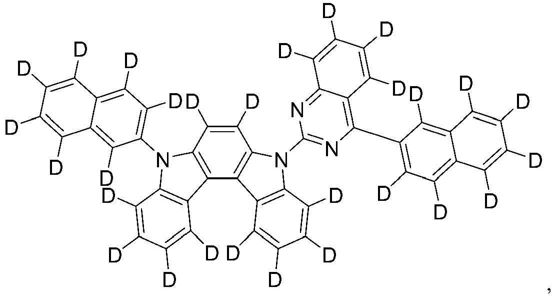 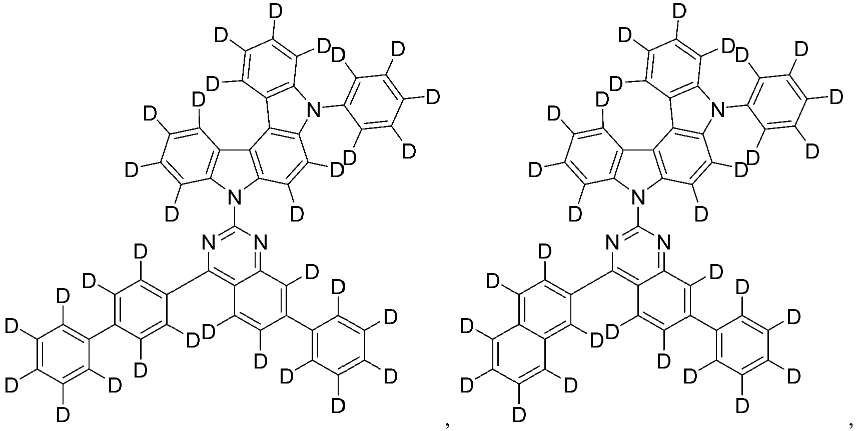 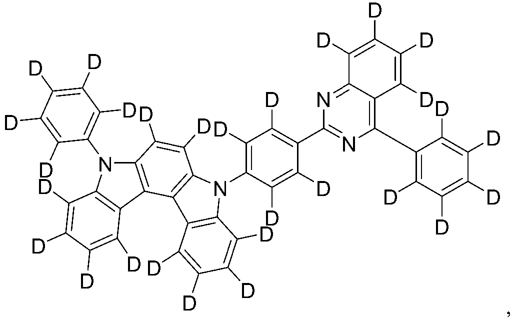 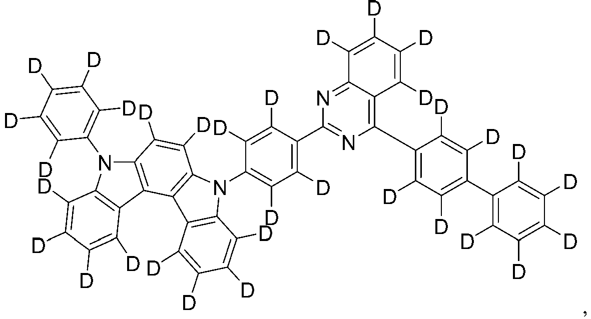 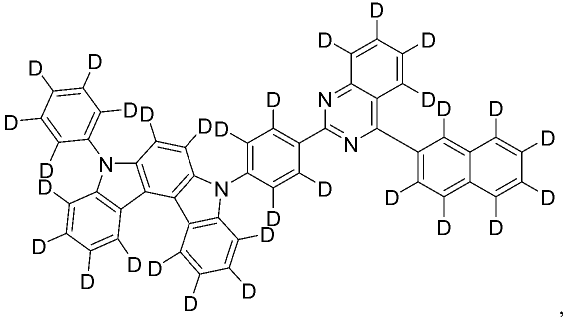 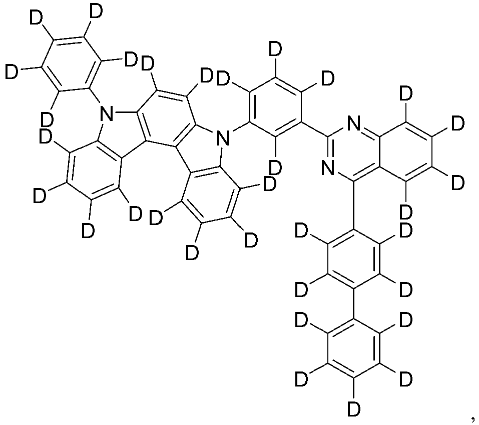 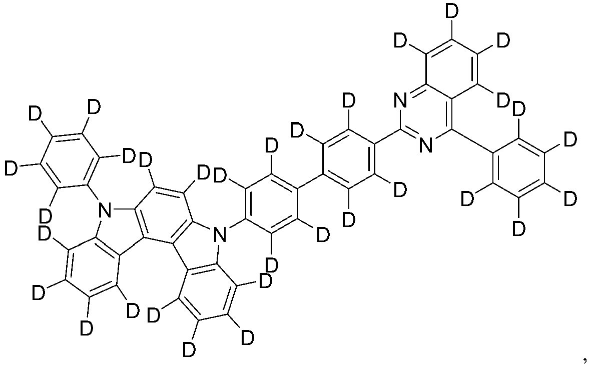 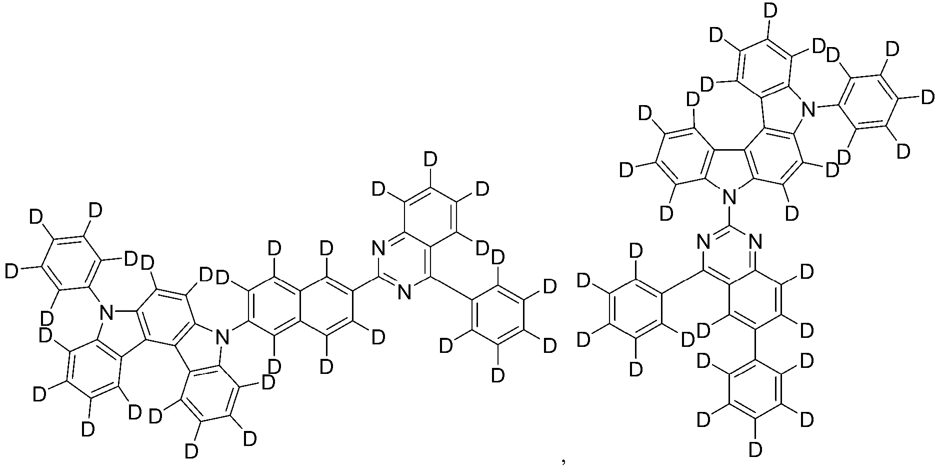 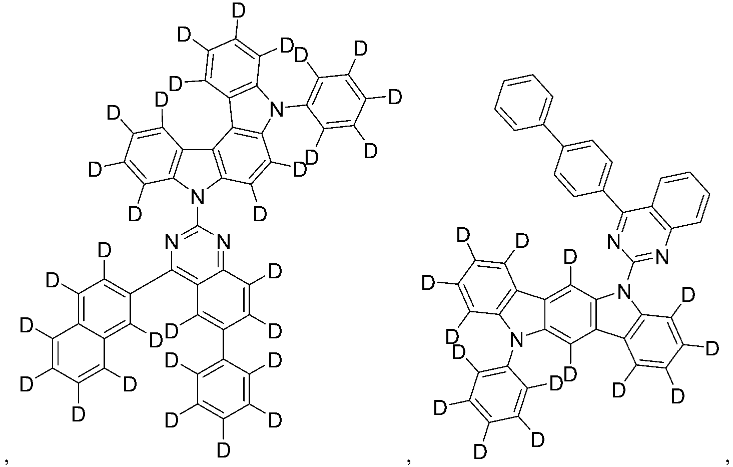 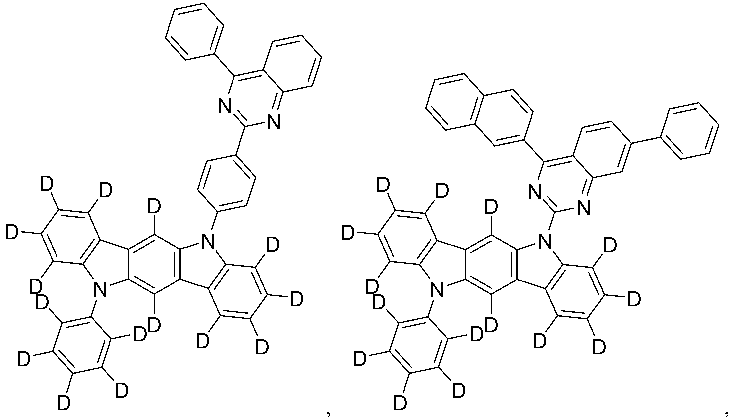 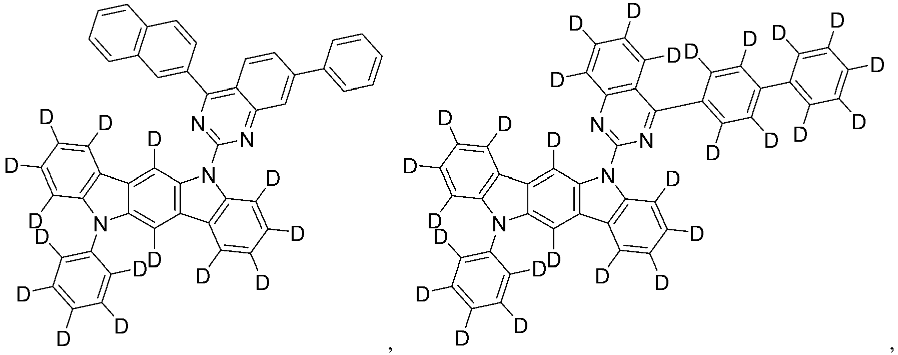 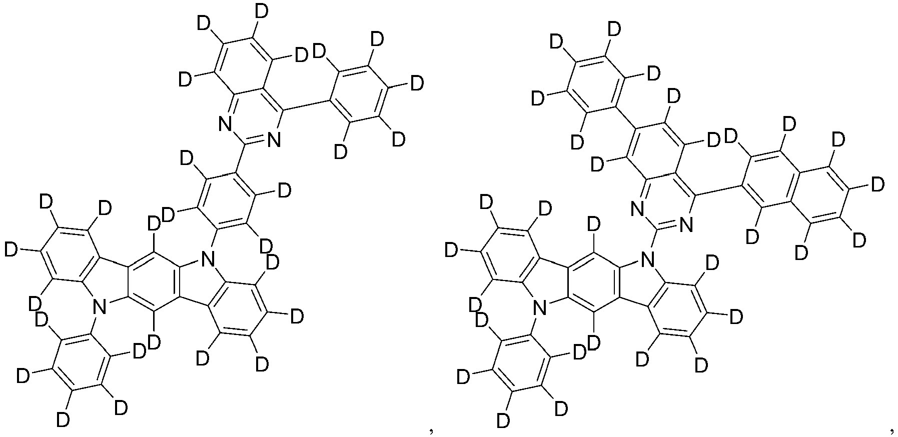 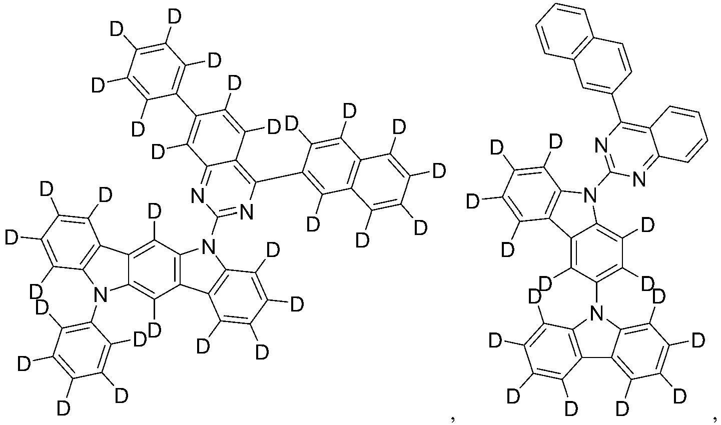 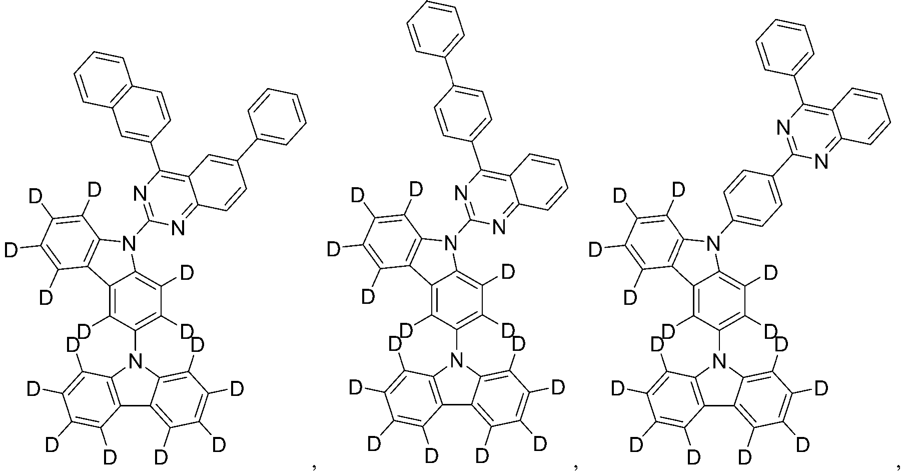 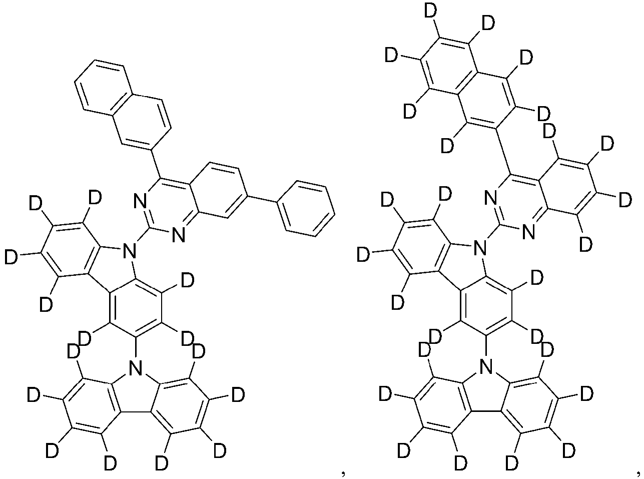 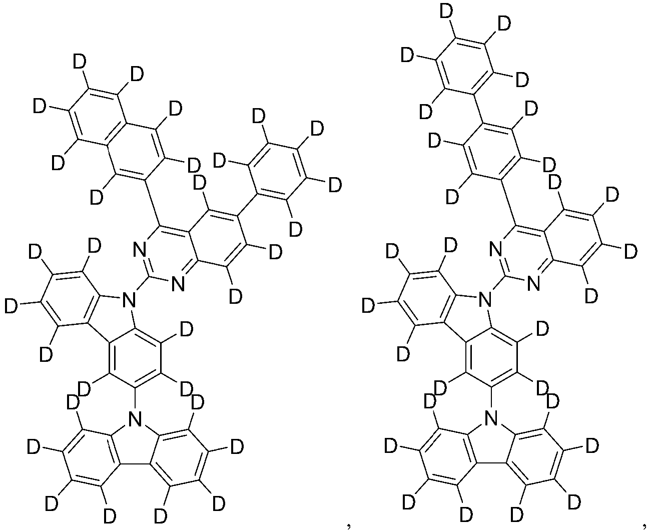 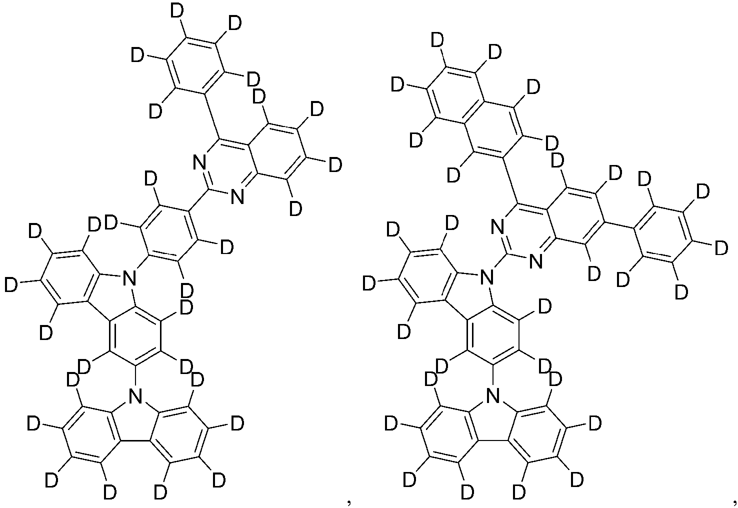 et 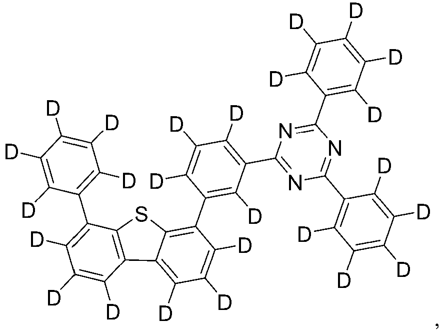 dans lesquels :
chacun de X₁ à X₁₁ est indépendamment C ou N ;
chaque Y^{A} est indépendamment absent ou, lorsqu'il est présent, est choisi dans le groupe constitué de O, S, Se, CRR', SiRR', NR, BR, BRR' ;
chacun de R^{A'}, R^{B'}, R^{C'}, R^{D'}, R^{E'}, R^{F'}, et R^{G'} représente indépendamment une mono-substitution, jusqu'au nombre maximal de substitutions, ou aucune substitution ;
chacun de R, R', R^{A'}, R^{B'}, R^{C'}, R^{D'}, R^{E'}, R^{F'}, et R^{G'} est indépendamment un hydrogène ou un substituant choisi dans le groupe constitué des Substituants Généraux définis ici ; et
au moins un R, R', R^{A'}, R^{B'}, R^{C'}, R^{D'}, R^{E'}, R^{F'}, ou R^{G'} comprend du deutérium.
